# EUROPÄISCHE PATENTSCHRIFT

(11) **EP 3 752 512 B1**
(45) Veröffentlichungstag und Bekanntmachung des Hinweises auf die Patenterteilung: **01.03.2023**
(21) Anmeldenummer: 19702926.7
(22) Anmeldetag: 11.02.2019
(51) Int. Cl.: C07F 15/00, C09K 11/06, H01L 51/00, H01L 51/50

(54) **METALLKOMPLEXE**
METAL COMPLEXES
COMPLEXES MÉTALLIQUES

(30) Priorität: 13.02.2018 EP 18156388
(43) Veröffentlichungstag der Anmeldung: 23.12.2020
(73) Patentinhaber: Merck Patent GmbH, 64293 Darmstadt (DE)
(72) Erfinder: STOESSEL, Philipp, 60389 FRANKFURT AM MAIN (DE); AUCH, Armin, 64293 Darmstadt (DE)
(86) Internationale Anmeldenummer: PCT/EP2019/053231
(87) Internationale Veröffentlichungsnummer: WO 2019/158453

(56) Entgegenhaltungen:
- WO-A1-2017/032439
- WO-A1-2018/019688
- WO-A1-2018/178001
- US-A1- 2018 026 208
- Schmidt A: "Ringsysteme", RÖMPP [Online], 1 January 2007 (2007-01-01), pages 1-2, XP055932005, Stuttgart, Georg Thieme Verlag Retrieved from the Internet: URL:https://roempp.thieme.de/lexicon/RD-18 -01473 [retrieved on 2022-06-16]

## Beschreibung

Die vorliegende Erfindung betrifft Iridiumkomplexe, welche sich für den Einsatz in organischen Elektrolumineszenzvorrichtungen, insbesondere als Emitter, eignen.

Gemäß dem Stand der Technik werden in phosphoreszierenden organischen Elektrolumineszenzvorrichtungen (OLEDs) als Triplettemitter vor allem bis- und tris-ortho-metallierte Irdiumkomplexe mit aromatischen Liganden eingesetzt, wobei die Liganden über ein negativ geladenes Kohlenstoffatom und ein neutrales Stickstoffatom oder über ein negativ geladenes Kohlenstoffatom und ein neutrales Carben-Kohlenstoffatom an das Metall binden. Beispiele für solche Komplexe sind Tris(phenylpyridyl)-iridium(III) und Derivate davon, sowie eine Vielzahl verwandter Komplexe, beispielsweise mit 1- oder 3-Phenylisochinolinliganden, mit 2-Phenylchinolinliganden oder mit Phenyl-carbenliganden, wobei diese Komplexe auch Acetylacetonat als Hilfsliganden aufweisen können. Derartige Komplexe sind auch mit polypodalen Liganden bekannt, wie beispielsweise in US 7,332,232 und WO 2016/124304 beschrieben. Auch wenn diese Komplexe mit polypodalen Liganden Vorteile gegenüber den Komplexen zeigen, die ansonsten die gleiche Ligandenstruktur aufweisen, deren einzelne Liganden nicht polypodal verbrückt sind, gibt es auch noch Verbesserungsbedarf, beispielsweise im Hinblick auf Effizienz, Lebensdauer, Sublimierbarkeit und Löslichkeit. Aus WO 2018/019688, WO 2017/032439 und US 2018/0026208 sind weitere Komplexe mit polypodalen Liganden für die Verwendung in OLEDs bekannt.

Aufgabe der vorliegenden Erfindung ist daher die Bereitstellung neuer und insbesondere verbesserter Metallkomplexe, welche sich als Emitter für die Verwendung in OLEDs eignen.

Überraschend wurde gefunden, dass Metallkomplexe mit einem hexadentaten tripodalen Liganden, der die nachfolgend beschriebene Struktur aufweist, diese Aufgabe lösen und sich sehr gut für die Verwendung in einer organischen Elektrolumineszenzvorrichtung eignen. Diese Metallkomplexe und organische Elektrolumineszenzvorrichtungen, welche diese Komplexe enthalten, sind daher der Gegenstand der vorliegenden Erfindung.

Gegenstand der Erfindung ist somit eine Verbindung der Formel (1), 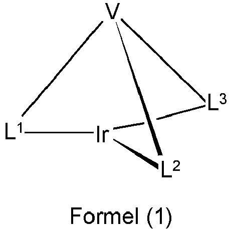 wobei für die verwendeten Symbole gilt:
- L¹, L², L³: sind gleich oder verschieden bei jedem Auftreten jeweils ein bidentater, monoanionischer Teilligand, der über ein Kohlenstoffatom und ein Stickstoffatom, über zwei Kohlenstoffatome, über zwei Stickstoffatome, über zwei Sauerstoffatome oder über ein Sauerstoffatom und ein Stickstoffatom an das Iridium koordiniert;
- V: ist eine Gruppe der Formel (2), 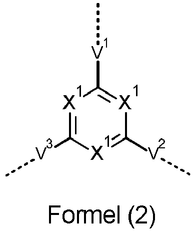 wobei die gestrichelten Bindungen jeweils die Position der Verknüpfung der Teilliganden L¹, L² und L³ darstellen;
- V¹: ist eine Gruppe der folgenden Formel (3), 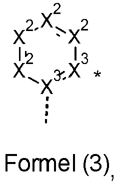 wobei die gestrichelte Bindung die Bindung an L¹ darstellt und * die Bindung an den zentralen Cyclus in Formel (2) darstellt;
- V²: ist ausgewählt aus der Gruppe bestehend aus -CR₂-CR₂- oder -CR₂-O-, wobei diese Gruppe an L² und an den zentralen Cyclus in Formel (2) gebunden ist;
- V³: ist gleich oder verschieden V¹ oder V², wobei diese Gruppe an L³ und an den zentralen Cyclus in Formel (2) gebunden ist;
- X¹: ist bei jedem Auftreten gleich oder verschieden CR oder N;
- X²: ist bei jedem Auftreten gleich oder verschieden CR oder N, oder zwei benachbarte Gruppen X² stehen zusammen für NR, O oder S, so dass ein Fünfring entsteht; oder zwei benachbarte Gruppen X² stehen zusammen für CR oder N, wenn in dem Cyclus eine der Gruppen X³ für N steht, so dass ein Fünfring entsteht; mit der Maßgabe, dass maximal zwei benachbarte Gruppen X² in jedem Ring für N stehen;
- X³: ist bei jedem Auftreten in demselben Cyclus C oder eine Gruppe X³ steht für N und die andere Gruppe X³ in demselben Cyclus steht für C, wobei die Gruppen X³ unabhängig voneinander gewählt werden können, wenn V mehr als eine Gruppe der Formel (3) enthält; mit der Maßgabe, dass zwei benachbarte Gruppen X² zusammen für CR oder N stehen, wenn in dem Cyclus eine der Gruppen X³ für N steht;
- R: ist bei jedem Auftreten gleich oder verschieden H, D, F, Cl, Br, I, N(R¹)₂, CN, eine geradkettige Alkylgruppe mit 1 bis 10 C-Atomen oder eine Alkenylgruppe mit 2 bis 10 C-Atomen oder eine verzweigte oder cyclische Alkylgruppe mit 3 bis 10 C-Atomen, wobei die Alkyl- oder Alkenylgruppe jeweils mit einem oder mehreren Resten R¹ substituiert sein kann, oder ein aromatisches oder heteroaromatisches Ringsystem mit 5 bis 30 aromatischen Ringatomen, das jeweils durch einen oder mehrere Reste R¹ substituiert sein kann; dabei können zwei Reste R auch miteinander ein Ringsystem bilden;
- R¹: ist bei jedem Auftreten gleich oder verschieden H, D, F, N(R²)₂, CN, eine geradkettige Alkylgruppe mit 1 bis 10 C-Atomen oder eine Alkenylgruppe mit 2 bis 10 C-Atomen oder eine verzweigte oder cyclische Alkylgruppe mit 3 bis 30 C-Atomen, wobei die Alkyl- oder Alkenylgruppe jeweils mit einem oder mehreren Resten R² substituiert sein kann, oder ein aromatisches oder heteroaromatisches Ringsystem mit 5 bis 24 aromatischen Ringatomen, das jeweils durch einen oder mehrere Reste R² substituiert sein kann; dabei können zwei oder mehrere Reste R¹ miteinander ein Ringsystem bilden;
- R²: ist bei jedem Auftreten gleich oder verschieden H, D, F oder ein aliphatischer, aromatischer und/oder heteroaromatischer organischer Rest, insbesondere ein Kohlenwasserstoffrest, mit 1 bis 20 C-Atomen, in dem auch ein oder mehrere H-Atome durch F ersetzt sein können;
dabei können die drei bidentaten Liganden L¹, L² und L³ außer durch die Brücke V auch noch durch eine weitere Brücke zu einem Kryptat geschlossen sein.

Bei dem Liganden handelt es sich somit um einen hexadentaten, tripodalen Liganden mit den drei bidentaten Teilliganden L¹, L² und L³. Dabei bedeutet bidentat, dass der jeweilige Teilligand im Komplex über zwei Koordinationsstellen an das Iridium koordiniert bzw. bindet. Tripodal bedeutet, dass der Ligand drei Teilliganden aufweist, die an die Brücke V bzw. die Brücke der Formel (2) gebunden sind. Da der Ligand drei bidentate Teilliganden aufweist, ergibt sich insgesamt ein hexadentater Ligand, also ein Ligand, der über sechs Koordinationsstellen an das Iridium koordiniert bzw. bindet. Der Begriff "bidentater Teilligand" bedeutet im Sinne dieser Anmeldung, dass es sich bei L¹, L² bzw. L³ jeweils um einen bidentaten Liganden handeln würde, wenn die Brücke V bzw. die Brücke der Formel (2) nicht vorhanden wäre. Durch die formale Abstraktion eines Wasserstoffatoms von diesem bidentaten Liganden und die Anknüpfung an die Brücke V bzw. die Brücke der Formel (2) ist dieser jedoch kein separater Ligand mehr, sondern ein Teil des so entstehenden hexadentaten Liganden, so dass hierfür der Begriff "Teilligand" verwendet wird.

Der Ligand der erfindungsgemäßen Verbindung weist somit für V² = -CR₂-CR₂- eine der folgenden Strukturen (LIG-1) oder (LIG-2) auf:

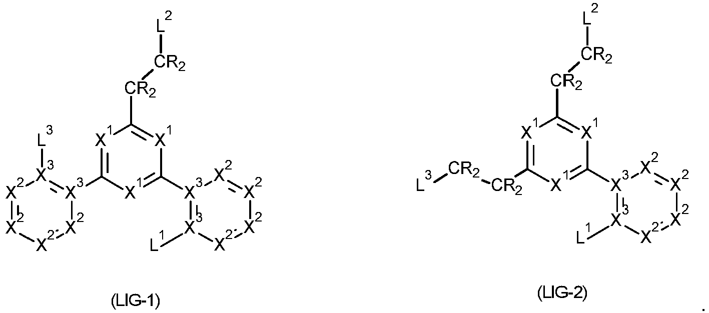

Analoges gilt für V² = -CR₂-O-, wobei in diesem Fall der Sauerstoff entweder an den zentralen Cyclus oder an den bidentaten Teilliganden bindet.

Die Bindung des Liganden an das Iridium kann sowohl eine Koordinationsbindung als auch eine kovalente Bindung sein bzw. der kovalente Anteil an der Bindung kann je nach Ligand variieren. Wenn in der vorliegenden Anmeldung die Rede davon ist, dass der Ligand bzw. der Teilligand an das Iridium koordiniert oder bindet, so bezeichnet dies im Sinne der vorliegenden Anmeldung jede Art der Bindung von dem Liganden bzw. Teilliganden an das Iridium, unabhängig vom kovalenten Anteil der Bindung.

Wenn zwei Reste R bzw. R¹ miteinander ein Ringsystem bilden, so kann dieses mono- oder polycyclisch, aliphatisch, heteroaliphatisch, aromatisch oder heteroaromatisch sein. Dabei können diese Reste, die miteinander ein Ringsystem bilden, benachbart sein, d. h. dass diese Reste an dasselbe Kohlenstoffatom oder an Kohlenstoffatome, die direkt aneinander gebunden sind, gebunden sind, oder sie können weiter voneinander entfernt sein. So ist beispielsweise auch die Ringbildung eines Restes R, der an der Gruppe X² gebunden ist, mit einem Rest R, der an der Gruppe X¹ gebunden ist, möglich.

Unter der Formulierung, dass zwei oder mehr Reste miteinander einen Ring bilden können, soll im Rahmen der vorliegenden Beschreibung unter anderem verstanden werden, dass die beiden Reste miteinander durch eine chemische Bindung unter formaler Abspaltung von zwei Wasserstoffatomen verknüpft sind. Dies wird durch das folgende Schema verdeutlicht.

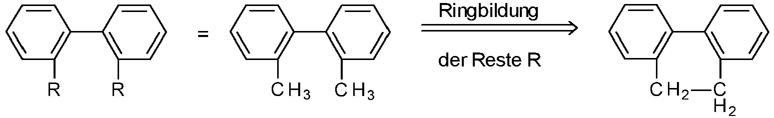

Weiterhin soll unter der oben genannten Formulierung aber auch verstanden werden, dass für den Fall, dass einer der beiden Reste Wasserstoff darstellt, der zweite Rest unter Bildung eines Rings an die Position, an die das Wasserstoffatom gebunden war, bindet. Dies soll durch das folgende Schema verdeutlicht werden:

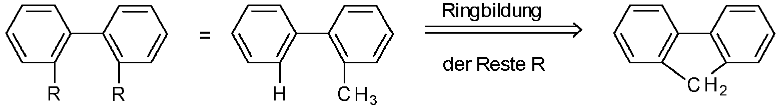

Wie oben beschrieben, kann diese Ringbildung an Resten erfolgen, die an direkt aneinander gebundene Kohlenstoffatome gebunden sind, oder an Resten, die an weiter entfernt liegende Kohlenstoffatome gebunden sind. Bevorzugt ist eine solche Ringbildung bei Resten, die an direkt aneinander gebundene Kohlenstoffatome gebunden sind.

Eine Arylgruppe im Sinne dieser Erfindung enthält 6 bis 40 C-Atome; eine Heteroarylgruppe im Sinne dieser Erfindung enthält 2 bis 40 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei enthält die Heteroarylgruppe bevorzugt maximal drei Heteroatome. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe, beispielsweise Naphthalin, Anthracen, Phenanthren, Chinolin, Isochinolin, etc., verstanden.

Ein aromatisches Ringsystem im Sinne dieser Erfindung enthält 6 bis 40 C-Atome im Ringsystem. Ein heteroaromatisches Ringsystem im Sinne dieser Erfindung enthält 1 bis 40 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein C-, N- oder O-Atom oder eine Carbonylgruppe, unterbrochen sein können. So sollen beispielsweise auch Systeme wie 9,9`-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkylgruppe oder durch eine Silylgruppe unterbrochen sind. Weiterhin sollen Systeme, in denen zwei oder mehrere Aryl- oder Heteroarylgruppen direkt aneinander gebunden sind, wie z. B. Biphenyl, Terphenyl, Quaterphenyl oder Bipyridin, ebenfalls als aromatisches bzw. heteroaromatisches Ringsystem verstanden werden.

Unter einer cyclischen Alkyl-, Alkoxy- oder Thioalkoxygruppe im Sinne dieser Erfindung wird eine monocyclische, eine bicyclische oder eine polycyclische Gruppe verstanden.

Im Rahmen der vorliegenden Erfindung werden unter einer C₁- bis C₂₀-Alkylgruppe, in der auch einzelne H-Atome oder CH₂-Gruppen durch die oben genannten Gruppen substituiert sein können, beispielsweise die Reste Methyl, Ethyl, n-Propyl, i-Propyl, Cyclopropyl, n-Butyl, i-Butyl, s-Butyl, t-Butyl, Cyclobutyl, 2-Methylbutyl, n-Pentyl, s-Pentyl, t-Pentyl, 2-Pentyl, neo-Pentyl, Cyclopentyl, n-Hexyl, s-Hexyl, t-Hexyl, 2-Hexyl, 3-Hexyl, neo-Hexyl, Cyclohexyl, 1-Methylcyclopentyl, 2-Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]-octyl, 2-(2,6-Dimethyl)octyl, 3-(3,7-Dimethyl)octyl, Adamantyl, Trifluormethyl, Pentafluorethyl, 2,2,2-Trifluorethyl, 1,1-Dimethyl-n-hex-1-yl-, 1,1-Dimethyl-n-hept-1-yl-, 1,1-Dimethyl-n-oct-1-yl-, 1,1-Dimethyl-n-dec-1-yl-, 1,1-Dimethyl-n-dodec-1-yl-, 1,1-Dimethyl-n-tetradec-1-yl-, 1,1-Dimethyl-n-hexadec-1-yl-, 1,1-Dimethyl-n-octadec-1-yl-, 1,1-Diethyl-n-hex-1-yl-, 1,1-Diethyl-n-hept-1-yl-, 1,1-Diethyl-n-oct-1-yl-, 1,1-Diethyl-n-dec-1-yl-, 1,1-Diethyl-n-dodec-1-yl-, 1,1-Diethyl-n-tetradec-1-yl-, 1,1-Diethyln-n-hexadec-1-yl-, 1,1-Diethyl-n-octadec-1-yl-, 1-(n-Propyl)-cyclohex-1-yl-, 1-(n-Butyl)-cyclohex-1-yl-, 1-(n-Hexyl)-cyclohex-1-yl-, 1-(n-Octyl)-cyclohex-1-yl- und 1-(n-Decyl)-cyclohex-1-yl- verstanden. Unter einer Alkenylgruppe werden beispielsweise Ethenyl, Propenyl, Butenyl, Pentenyl, Cyclopentenyl, Hexenyl, Cyclohexenyl, Heptenyl, Cycloheptenyl, Octenyl, Cyclooctenyl oder Cyclooctadienyl verstanden. Unter einer Alkinylgruppe werden beispielsweise Ethinyl, Propinyl, Butinyl, Pentinyl, Hexinyl, Heptinyl oder Octinyl verstanden. Unter einer Gruppe OR¹ werden beispielsweise Methoxy, Trifluormethoxy, Ethoxy, n-Propoxy, i-Propoxy, n-Butoxy, i-Butoxy, s-Butoxy, t-Butoxy oder 2-Methylbutoxy verstanden.

Unter einem aromatischen oder heteroaromatischen Ringsystem mit 5 - 40 aromatischen Ringatomen, welches noch jeweils mit den oben genannten Resten substituiert sein kann und welches über beliebige Positionen am Aromaten bzw. Heteroaromaten verknüpft sein kann, werden beispielsweise Gruppen verstanden, die abgeleitet sind von Benzol, Naphthalin, Anthracen, Benzanthracen, Phenanthren, Benzophenanthren, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Im Folgenden werden bevorzugte Ausführungsformen des Brückenkopfes V, also der Struktur der Formel (2) ausgeführt.

In einer bevorzugten Ausführungsform der Erfindung stehen alle Gruppen X¹ in der Gruppe der Formel (2) für CR, so dass der zentrale trivalente Cyclus der Formel (2) ein Benzol darstellt. Besonders bevorzugt stehen alle Gruppen X¹ für CH oder CD, insbesondere für CH. In einer weiteren bevorzugten Ausführungsform der Erfindung stehen alle Gruppen X¹ für ein Stickstoffatom, so dass der zentrale trivalente Cyclus der Formel (2) ein Triazin darstellt.

Bevorzugte Ausführungsformen der Gruppe der Formel (2) sind die Strukturen der folgenden Formeln (4) oder (5), 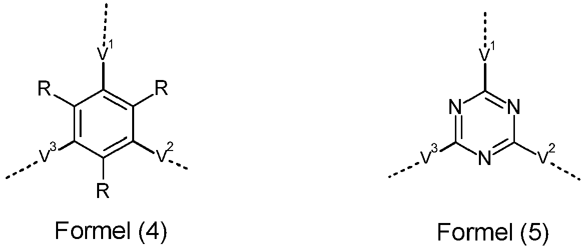 wobei die verwendeten Symbole die oben genannten Bedeutungen aufweisen.

Für bevorzugte Reste R am trivalenten zentralen Benzolring der Formel (4) gilt:
- R: ist bei jedem Auftreten gleich oder verschieden H, D, F, CN, OR¹, eine geradkettige Alkylgruppe mit 1 bis 10 C-Atomen, bevorzugt mit 1 bis 4 C-Atomen, oder eine Alkenylgruppe mit 2 bis 10 C-Atomen oder eine verzweigte oder cyclische Alkylgruppe mit 3 bis 10 C-Atomen, bevorzugt mit 3 bis 6 C-Atomen, die jeweils mit einem oder mehreren Resten R¹ substituiert sein kann, bevorzugt aber unsubstituiert ist, oder ein aromatisches oder heteroaromatisches Ring-system mit 5 bis 24 aromatischen Ringatomen, bevorzugt mit 6 bis 12 aromatischen Ringatomen, das jeweils durch einen oder mehrere Reste R¹ substituiert sein kann; dabei kann der Rest R auch mit einem Rest R an X² ein Ringsystem bilden;
- R¹: ist bei jedem Auftreten gleich oder verschieden H, D, F, CN, eine geradkettige Alkylgruppe mit 1 bis 10 C-Atomen, bevorzugt mit 1 bis 4 C-Atomen, oder eine Alkenylgruppe mit 2 bis 10 C-Atomen oder eine verzweigte oder cyclische Alkylgruppe mit 3 bis 10 C-Atomen, bevorzugt mit 3 bis 6 C-Atomen, die jeweils mit einem oder mehreren Resten R² substituiert sein kann, bevorzugt aber unsubstituiert ist, oder ein aromatisches oder heteroaromatisches Ringsystem mit 5 bis 24 aromatischen Ringatomen, bevorzugt mit 6 bis 12 aromatischen Ringatomen, das jeweils durch einen oder mehrere Reste R² substituiert sein kann; dabei können zwei oder mehrere benachbarte Reste R¹ miteinander ein Ringsystem bilden;
- R²: ist bei jedem Auftreten gleich oder verschieden H, D, F oder ein aliphatischer, aromatischer und/oder heteroaromatischer organischer Rest mit 1 bis 20 C-Atomen, in dem auch ein oder mehrere H-Atome durch F ersetzt sein können, bevorzugt ein aliphatischer oder aromatischer Kohlenwasserstoffrest mit 1 bis 12 C-Atomen.

Besonders bevorzugt ist dieser Rest R = H oder D, insbesondere = H. Besonders bevorzugt ist die Gruppe der Formel (4) eine Struktur der folgenden Formel (4`), 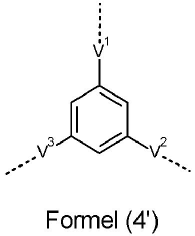 wobei die verwendeten Symbole die oben genannten Bedeutungen aufweisen.

Im Folgenden werden bevorzugte bivalente Arylen- bzw. Heteroaryleneinheiten V¹ bzw. die Gruppen der Formel (3) beschrieben, wie sie in der Gruppe der Formeln (2), (4) und (5) vorkommen. Wenn V³ für eine Gruppe der Formel (3) steht, gelten auch für diese Gruppe die nachfolgenden Bevorzugungen. Wie aus den Strukturen der Formeln (2), (4) und (5) ersichtlich, enthalten diese Strukturen eine oder zwei ortho-verknüpfte bivalente Arylen- bzw. Heteroaryleneinheiten, je nachdem ob V³ für eine Gruppe der Formel (3) steht oder für eine Gruppe ausgewählt aus -CR₂-CR₂- oder -CR₂-O-.

In einer bevorzugten Ausführungsform der Erfindung steht das Symbol X³ in der Gruppe der Formel (3) für C, so dass die Gruppe der Formel (3) durch die folgende Formel (3a) dargestellt wird: 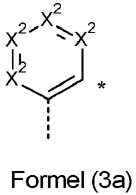 wobei die Symbole die oben aufgeführten Bedeutungen aufweisen.

Die Gruppe der Formel (3) kann einen heteroaromatischen Fünfring oder einen aromatischen oder heteroaromatischen Sechsring darstellen. In einer bevorzugten Ausführungsform der Erfindung enthält die Gruppe der Formel (3) maximal zwei Heteroatome in der Aryl- bzw. Heteroarylgruppe, besonders bevorzugt maximal ein Heteroatom. Dies schließt nicht aus, dass Substituenten, die gegebenenfalls an dieser Gruppe gebunden sind, auch Heteroatome enthalten können. Weiterhin schließt diese Definition nicht aus, dass durch die Ringbildung von Substituenten kondensierte aromatische oder heteroaromatische Strukturen entstehen, wie beispielsweise Naphthalin, Benzimidazol, etc.. Beispiele für geeignete Gruppen der Formel (3) sind Benzol, Pyridin, Pyrimidin, Pyrazin, Pyridazin, Pyrrol, Furan, Thiophen, Pyrazol, Imidazol, Oxazol und Thiazol.

Wenn beide Gruppen X³ in einem Cyclus für Kohlenstoffatome stehen, sind bevorzugte Ausführungsformen der Gruppe der Formel (3) die Strukturen der folgenden Formeln (6) bis (22), 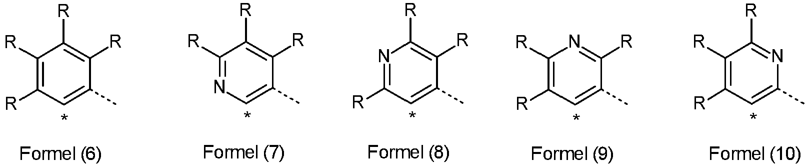 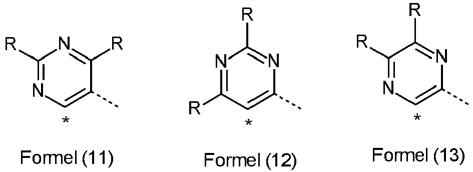 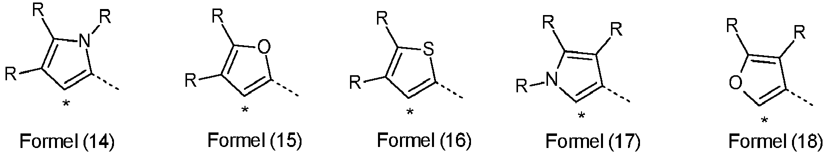 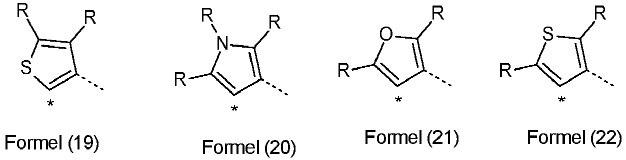 wobei die verwendeten Symbole die oben genannten Bedeutungen aufweisen.

Wenn eine Gruppe X³ in einem Cyclus für ein Kohlenstoffatom und die andere Gruppe X³ in demselben Cyclus für ein Stickstoffatom steht, sind bevorzugte Ausführungsformen der Gruppe der Formel (3) die Strukturen der folgenden Formeln (23) bis (30), 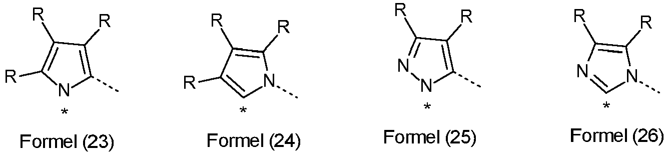 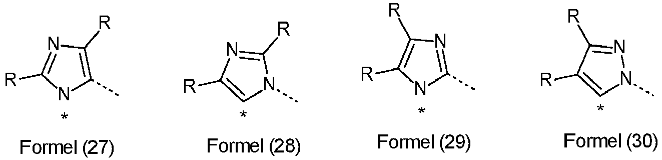 wobei die verwendeten Symbole die oben genannten Bedeutungen aufweisen.

Besonders bevorzugt sind die gegebenenfalls substituierten Sechsring-Aromaten und Sechsring-Heteroaromaten der oben abgebildeten Formeln (6) bis (10) sowie die Fünfring-Heteroaromaten der Formeln (23) und (29) . Ganz besonders bevorzugt ist ortho-Phenylen, also eine Gruppe der oben genannten Formel (6), sowie die Gruppen der Formeln (23) und (29).

Dabei können, wie auch oben bei der Beschreibung des Substituenten beschrieben, auch benachbarte Substituenten miteinander ein Ringsystem bilden, so dass kondensierte Strukturen, auch kondensierte Aryl- und Heteroarylgruppen, wie beispielsweise Naphthalin, Chinolin, Benzimidazol, Carbazol, Dibenzofuran, Dibenzothiophen, Phenanthren oder Triphenylen, entstehen können.

Wenn zwei Gruppen der Formel (3) vorhanden sind, d. h. wenn V³ ebenfalls für eine Gruppe der Formel (3) steht, können diese gleich oder verschieden sein. In einer bevorzugten Ausführungsform der Erfindung sind, wenn zwei Gruppen der Formel (3) vorhanden sind, beide Gruppen gleich und sind auch gleich substituiert.

Wenn V² bzw. V³ für eine Gruppe -CR₂-O- steht, dann kann das Sauerstoffatom entweder an den zentralen Cyclus der Gruppe der Formel (2) gebunden sein, oder es kann an den Teilliganden L² bzw. L³ gebunden sein. In einer bevorzugten Ausführungsform steht V² für -CR₂-CR₂-. Wenn V³ auch für -CR₂-CR₂- steht, können diese beiden Gruppen gleich oder verschieden sein. Bevorzugt sind sie gleich. Bevorzugte Reste R an der Gruppe -CR₂-CR₂- bzw. -CR₂-O- sind gewählt aus der Gruppe bestehend aus H, D, F und einer Alkylgruppe mit 1 bis 5 C-Atomen, wobei auch H-Atome durch D oder F ersetzt sein können und wobei benachbarte R miteinander ein Ringsystem bilden können. Besonders bevorzugte Reste R an diesen Gruppen sind gewählt aus H, D, CH₃ oder CD₃, oder zwei Reste R, die an dasselbe Kohlenstoffatom binden, bilden zusammen mit dem Kohlenstoffatom, an das sie binden, einen Cyclopentan- oder Cyclohexanring.

Besonders bevorzugt sind die Strukturen der Formel (4) und (5) ausgewählt aus den Strukturen der folgenden Formeln (4a) bis (5b), 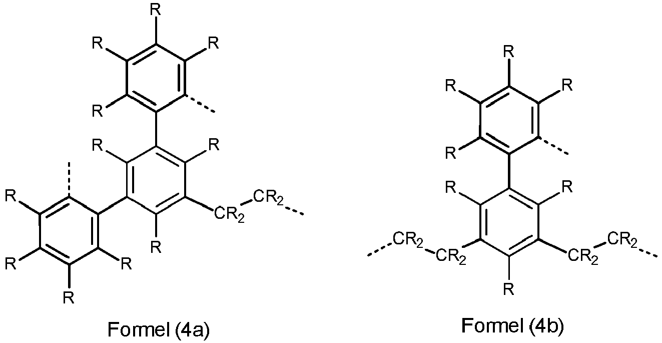 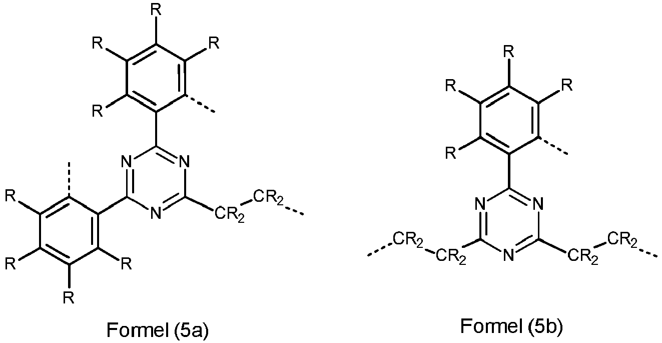 wobei die verwendeten Symbole die oben genannten Bedeutungen aufweisen. Dabei sind die Formeln (4b) und (5b) besonders bevorzugt, insbesondere die Formel (4b).

Eine bevorzugte Ausführungsform der Formeln (4a) und (4b) sind die Strukturen der folgenden Formeln (4a`) und (4b`), 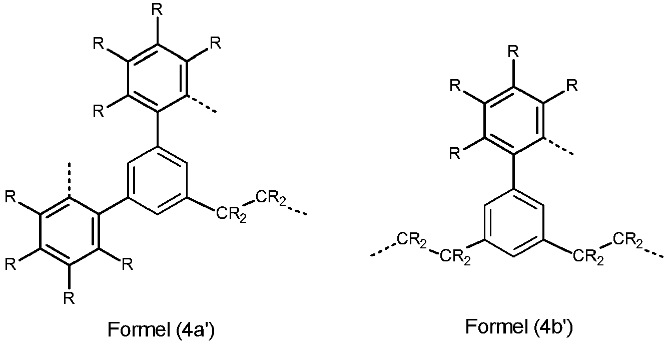 wobei die verwendeten Symbole die oben genannten Bedeutungen aufweisen.

Besonders bevorzugt sind die Gruppen R in den Formeln (3) bis (5) bei jedem Auftreten gleich oder verschieden H, D oder eine Alkylgruppe mit 1 bis 4 C-Atomen. Ganz besonders bevorzugt ist R = H oder D, insbesondere H. Besonders bevorzugte Ausführungsformen der Formel (2) sind daher die Strukturen der folgenden Formeln (4c), (4d), (4e), (4f), (5c), (5d), (5e) bzw. (5f), 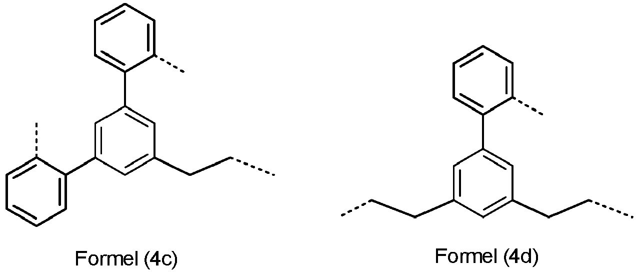 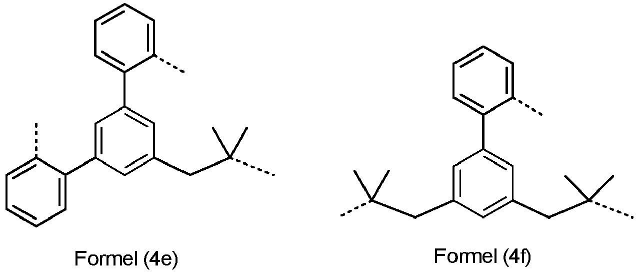 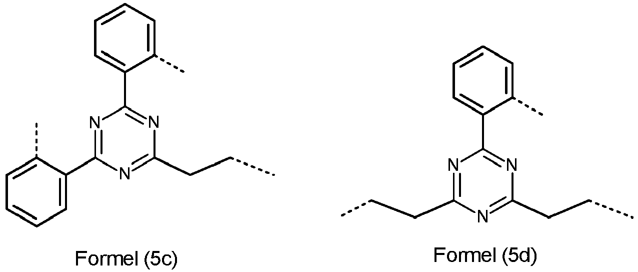 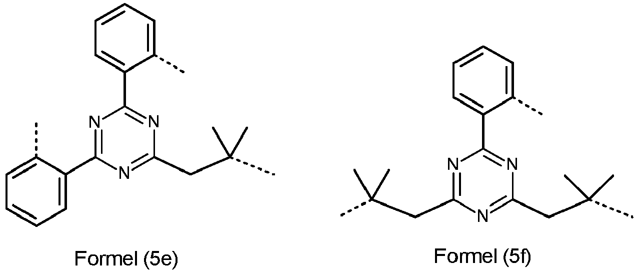 wobei die verwendeten Symbole die oben genannten Bedeutungen aufweisen.

Im Folgenden werden die bidentaten Teilliganden L¹, L² und L³ beschrieben. Wie oben beschrieben, koordinieren L¹, L² und L³ an das Iridium über ein Kohlenstoffatom und ein Stickstoffatom, über zwei Kohlenstoffatome, über zwei Stickstoffatome, über zwei Sauerstoffatome oder über ein Stickstoffatom und ein Sauerstoffatom. In einer bevorzugten Ausführungsform koordiniert mindestens einer der Teilliganden L¹, L² und L³, besonders bevorzugt mindestens zwei der Teilliganden L¹, L² und L³ an das Iridium über ein Kohlenstoffatom und ein Stickstoffatom oder über zwei Kohlenstoffatome, insbesondere über ein Kohlenstoffatom und ein Stickstoffatom. Ganz besonders bevorzugt weisen alle drei Teilliganden L¹, L² und L³ jeweils ein Kohlenstoffatom und ein Stickstoffatom als koordinierende Atome auf.

Es ist weiterhin bevorzugt, wenn es sich bei dem Metallacyclus, der aus dem Iridium und dem Teilliganden L¹, L² bzw. L³ aufgespannt wird, um einen Fünfring handelt. Dies gilt insbesondere, wenn die koordinierenden Atome Kohlenstoff und Stickstoff oder zweimal Kohlenstoff oder Stickstoff und Sauerstoff sind. Sind beide koordinierenden Atome Stickstoff oder Sauerstoff, kann auch die Bildung eines Sechsrings bevorzugt sein. Die Bildung eines Fünfrings wird im Folgenden schematisch dargestellt: 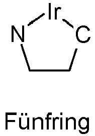 wobei N ein koordinierendes Stickstoffatom und C ein koordinierendes Kohlenstoffatom darstellen und die eingezeichneten Kohlenstoffatome Atome des Teilliganden L¹, L² bzw. L³ darstellen.

In einer bevorzugten Ausführungsform der Erfindung steht mindestens einer der Teilliganden L¹, L² bzw. L³, besonders bevorzugt mindestens zwei Teilliganden L¹, L² und L³ und ganz besonders bevorzugt alle drei Teilliganden L¹, L² und L³ gleich oder verschieden bei jedem Auftreten für eine Struktur gemäß einer der folgenden Formeln (L-1) oder (L-2), 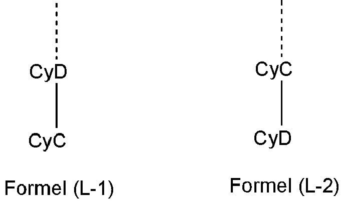 wobei die gestrichelte Bindung die Bindung des Teilliganden an V bzw. an die Brücke der Formel (2) darstellt und für die weiteren verwendeten Symbole gilt:
- CyC: ist gleich oder verschieden bei jedem Auftreten eine substituierte oder unsubstituierte Aryl- oder Heteroarylgruppe mit 5 bis 14 aromatischen Ringatomen, welche jeweils über ein Kohlenstoffatom an das Metall koordiniert und welche über eine kovalente Bindung mit CyD verbunden ist;
- CyD: ist gleich oder verschieden bei jedem Auftreten eine substituierte oder unsubstituierte Heteroarylgruppe mit 5 bis 14 aromatischen Ringatomen, welche über ein Stickstoffatom oder über ein Carben-Kohlenstoffatom an das Metall koordiniert und welche über eine kovalente Bindung mit CyC verbunden ist;
dabei können mehrere der optionalen Substituenten miteinander ein Ringsystem bilden; die optionalen Reste sind bevorzugt ausgewählt aus den oben genannten Resten R.

Dabei koordiniert CyD bevorzugt über ein neutrales Stickstoffatom oder über ein Carben-Kohlenstoffatom. Weiterhin koordiniert CyC über ein anionisches Kohlenstoffatom.

Wenn mehrere der Substituenten, insbesondere mehrere Reste R, miteinander ein Ringsystem bilden, so ist die Bildung eines Ringsystems aus Substituenten, die an direkt benachbarten Kohlenstoffatomen gebunden sind, möglich. Weiterhin ist es auch möglich, dass die Substituenten an CyC und CyD miteinander einen Ring bilden, wodurch CyC und CyD auch zusammen eine einzige kondensierte Aryl- bzw. Heteroarylgruppe als bidentaten Teilliganden bilden können.

Dabei können alle Teilliganden L¹, L² und L³ eine Struktur der Formel (L-1) aufweisen, so dass ein pseudofacialer Komplex entsteht, oder alle Teilliganden L¹, L² und L³ können eine Struktur der Formel (L-2) aufweisen, so dass ein pseudofacialer Komplex entsteht, oder ein oder zwei der Teilliganden L¹, L² und L³ weisen eine Struktur der Formel (L-1), und die anderen der Teillliganden weisen eine Struktur der Formel (L-2) auf, so dass ein pseudomeridionaler Komplex entsteht.

In einer bevorzugten Ausführungsform der vorliegenden Erfindung ist CyC eine Aryl- oder Heteroarylgruppe mit 6 bis 13 aromatischen Ringatomen, besonders bevorzugt mit 6 bis 10 aromatischen Ringatomen, ganz besonders bevorzugt mit 6 aromatischen Ringatomen, welche über ein Kohlenstoffatom an das Metall koordiniert, welche mit einem oder mehreren Resten R substituiert sein kann und welche über eine kovalente Bindung mit CyD verbunden ist.

Bevorzugte Ausführungsformen der Gruppe CyC sind die Strukturen der folgenden Formeln (CyC-1) bis (CyC-20), wobei die Gruppe CyC jeweils an der durch # gekennzeichneten Position an CyD bindet und an der durch * gekennzeichneten Position an das Iridium koordiniert, 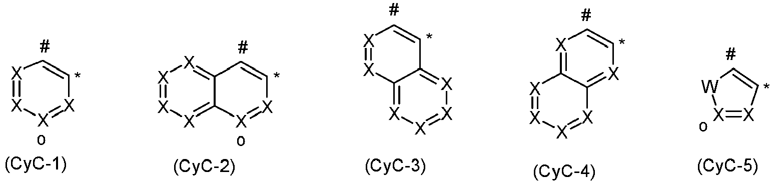 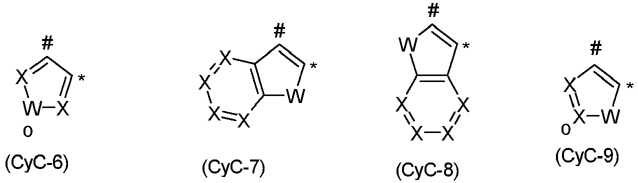 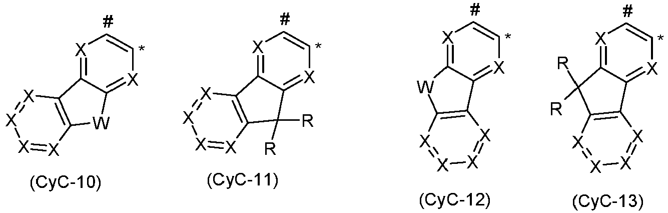 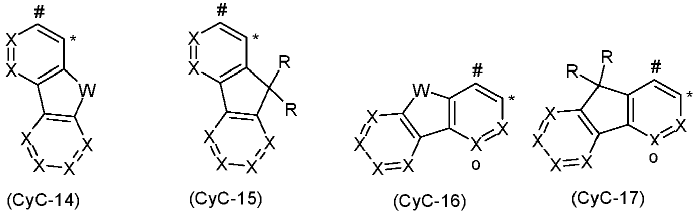 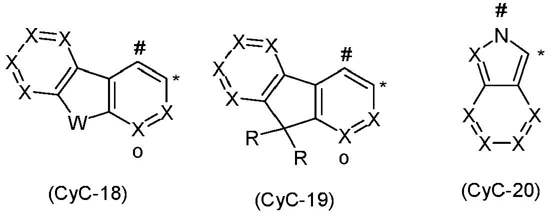 wobei R die oben genannten Bedeutungen aufweist und für die weiteren verwendeten Symbole gilt:
- X: ist bei jedem Auftreten gleich oder verschieden CR oder N mit der Maßgabe, dass maximal zwei Symbole X pro Cyclus für N stehen;
- W: ist bei jedem Auftreten gleich oder verschieden NR, O oder S;
mit der Maßgabe, dass, wenn die Brücke V bzw. die Brücke der Formel (2) an CyC gebunden ist, ein Symbol X für C steht und die Brücke der Formel (2) an dieses Kohlenstoffatom gebunden ist. Wenn die Gruppe CyC an die Brücke V bzw. die Brücke der Formel (2) gebunden ist, so erfolgt die Bindung bevorzugt über die mit "o" markierte Position der oben abgebildeten Formeln, so dass dann bevorzugt das mit "o" markierte Symbol X für C steht. Die oben abgebildeten Strukturen, die kein mit "o" markiertes Symbol X enthalten, sind bevorzugt nicht direkt an die Brücke der Formel (2) gebunden, da eine solche Bindung an die Brücke aus sterischen Gründen nicht vorteilhaft ist.

Bevorzugt stehen insgesamt maximal zwei Symbole X in CyC für N, besonders bevorzugt steht maximal ein Symbol X in CyC für N, ganz besonders bevorzugt stehen alle Symbole X für CR, mit der Maßgabe, dass, wenn die Brücke V bzw. die Brücke der Formel (2) an CyC gebunden ist, ein Symbol X für C steht und die Brücke V bzw. die Brücke der Formel (2) an dieses Kohlenstoffatom gebunden ist.

Besonders bevorzugte Gruppen CyC sind die Gruppen der folgenden Formeln (CyC-1a) bis (CyC-20a), 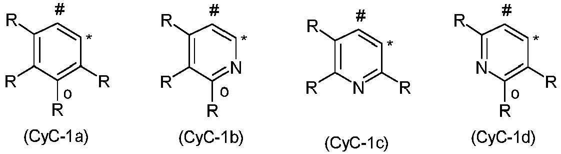 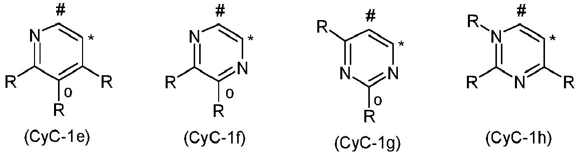 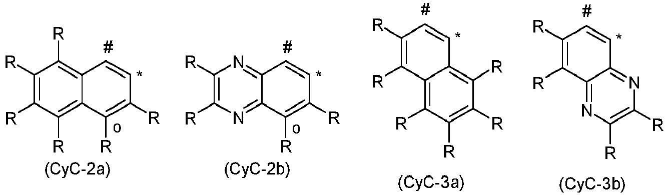 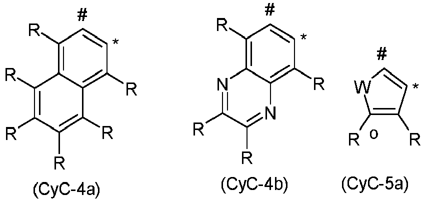 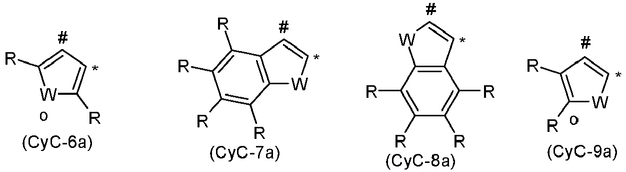 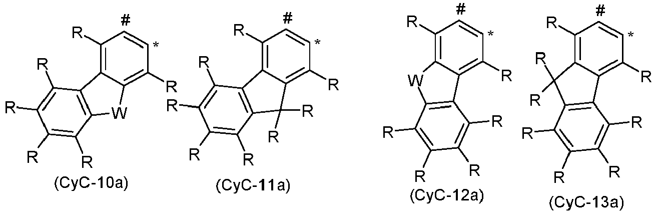 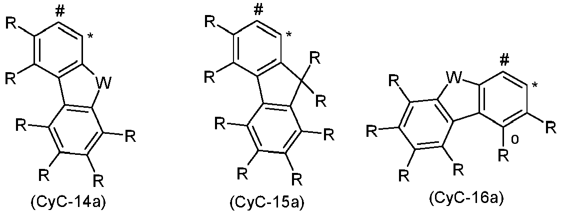 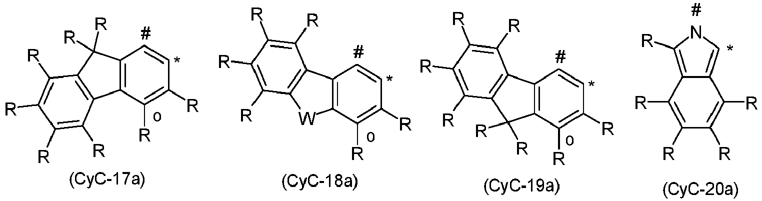 wobei die verwendeten Symbole die oben genannten Bedeutungen aufweisen und, wenn die Brücke V bzw. die Brücke der Formel (2) an CyC gebunden ist, ein Rest R nicht vorhanden ist und die Brücke V bzw. die Brücke der Formel (2) an das entsprechende Kohlenstoffatom gebunden ist. Wenn die Gruppe CyC an die Brücke V bzw. die Brücke der Formel (2) gebunden ist, so erfolgt die Bindung bevorzugt über die mit "o" markierte Position der oben abgebildeten Formeln, so dass dann bevorzugt in dieser Position der Rest R nicht vorhanden ist. Die oben abgebildeten Strukturen, die kein mit "o" markiertes Kohlenstoffatom enthalten, sind bevorzugt nicht direkt an die Brücke V bzw. die Brücke der Formel (2) gebunden.

Bevorzugte Gruppen unter den Gruppen (CyC-1) bis (CyC-20) sind die Gruppen (CyC-1), (CyC-3), (CyC-8), (CyC-10), (CyC-12), (CyC-13) und (CyC-16), und besonders bevorzugt sind die Gruppen (CyC-1a), (CyC-3a), (CyC-8a), (CyC-10a), (CyC-12a), (CyC-13a) und (CyC-16a).

In einer weiteren bevorzugten Ausführungsform der Erfindung ist CyD eine Heteroarylgruppe 5 bis 13 aromatischen Ringatomen, besonders bevorzugt mit 6 bis 10 aromatischen Ringatomen, welche über ein neutrales Stickstoffatom oder über ein Carben-Kohlenstoffatom an das Metall koordiniert und welche mit einem oder mehreren Resten R substituiert sein kann und welche über eine kovalente Bindung mit CyC verbunden ist.

Bevorzugte Ausführungsformen der Gruppe CyD sind die Strukturen der folgenden Formeln (CyD-1) bis (CyD-12), wobei die Gruppe CyD jeweils an der durch # gekennzeichneten Position an CyC bindet und an der durch * gekennzeichneten Position an das Iridium koordiniert, 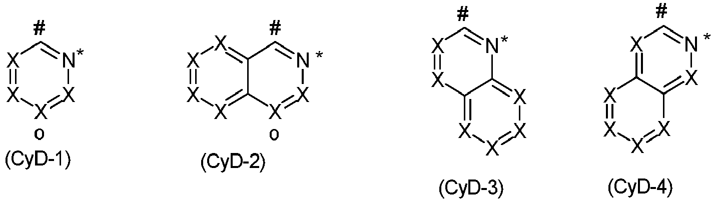 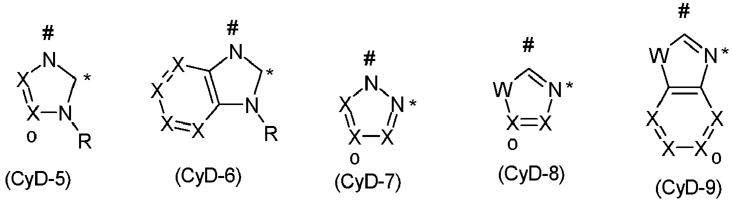 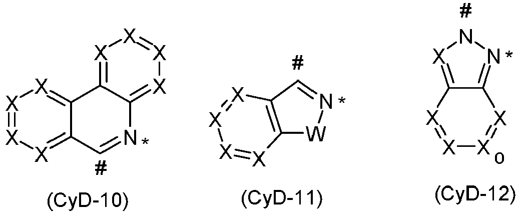 wobei X, W und R die oben genannten Bedeutungen aufweisen, mit der Maßgabe, dass, wenn die Brücke V bzw. die Brücke der Formel (2) an CyD gebunden ist, ein Symbol X für C steht und die Brücke V bzw. die Brücke der Formel (2) an dieses Kohlenstoffatom gebunden ist. Wenn die Gruppe CyD an die Brücke V bzw. die Brücke der Formel (2) gebunden ist, so erfolgt die Bindung bevorzugt über die mit "o" markierte Position der oben abgebildeten Formeln, so dass dann bevorzugt das mit "o" markierte Symbol X für C steht. Die oben abgebildeten Strukturen, die kein mit "o" markiertes Symbol X enthalten, sind bevorzugt nicht direkt an die Brücke V bzw. die Brücke der Formel (2) gebunden, da eine solche Bindung an die Brücke aus sterischen Gründen nicht vorteilhaft ist.

Dabei koordinieren die Gruppen (CyD-1) bis (CyD-4) und (CyD-7) bis (CyD-12) über ein neutrales Stickstoffatom und (CyD-5) und (CyD-6) über ein Carben-Kohlenstoffatom an das Metall.

Bevorzugt stehen insgesamt maximal zwei Symbole X in CyD für N, besonders bevorzugt steht maximal ein Symbol X in CyD für N, insbesondere bevorzugt stehen alle Symbole X für CR, mit der Maßgabe, dass, wenn die Brücke V bzw. die Brücke der Formel (2) an CyD gebunden ist, ein Symbol X für C steht und die Brücke V bzw. die Brücke der Formel (2) an dieses Kohlenstoffatom gebunden ist.

Besonders bevorzugte Gruppen CyD sind die Gruppen der folgenden Formeln (CyD-1a) bis (CyD-12b), 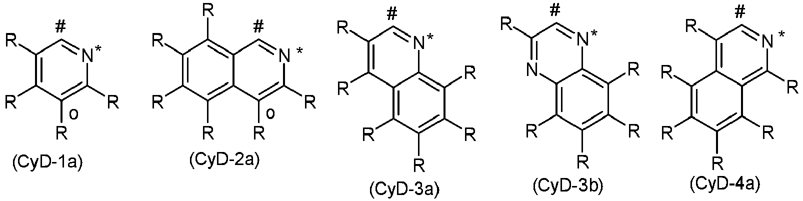 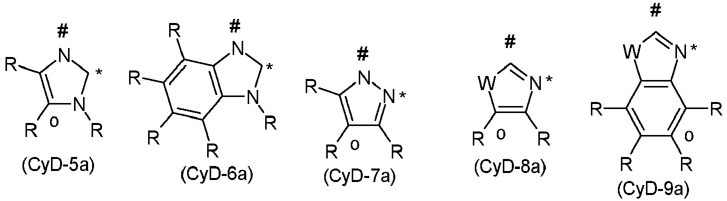 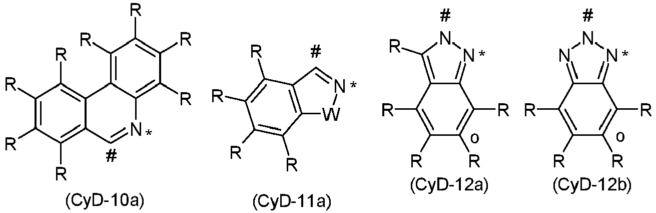 wobei die verwendeten Symbole die oben genannten Bedeutungen aufweisen und, wenn die Brücke V bzw. die Brücke der Formel (2) an CyD gebunden ist, ein Rest R nicht vorhanden ist und die Brücke V bzw. die Brücke der Formel (2) an das entsprechende Kohlenstoffatom gebunden ist. Wenn die Gruppe CyD an die Brücke V bzw. die Brücke der Formel (2) gebunden ist, so erfolgt die Bindung bevorzugt über die mit "o" markierte Position der oben abgebildeten Formeln, so dass dann bevorzugt in dieser Position der Rest R nicht vorhanden ist. Die oben abgebildeten Strukturen, die kein mit "o" markiertes Kohlenstoffatom enthalten, sind bevorzugt nicht direkt an die Brücke V bzw. die Brücke der Formel (2) gebunden.

Bevorzugte Gruppen unter den Gruppen (CyD-1) bis (CyD-12) sind die Gruppen (CyD-1), (CyD-2), (CyD-3), (CyD-4), (CyD-5) und (CyD-6), insbesondere (CyD-1), (CyD-2) und (CyD-3), und besonders bevorzugt sind die Gruppen (CyD-1a), (CyD-2a), (CyD-3a), (CyD-4a), (CyD-5a) und (CyD-6a), insbesondere (CyD-1a), (CyD-2a) und (CyD-3a).

In einer bevorzugten Ausführungsform der Erfindung ist CyC eine Aryl- oder Heteroarylgruppe mit 6 bis 13 aromatischen Ringatomen, und gleichzeitig ist CyD eine Heteroarylgruppe mit 5 bis 13 aromatischen Ringatomen. Besonders bevorzugt ist CyC eine Aryl- oder Heteroarylgruppe mit 6 bis 10 aromatischen Ringatomen, und gleichzeitig ist CyD eine Heteroarylgruppe mit 5 bis 10 aromatischen Ringatomen. Ganz besonders bevorzugt ist CyC eine Aryl- oder Heteroarylgruppe mit 6 aromatischen Ringatomen und CyD eine Heteroarylgruppe mit 6 bis 10 aromatischen Ringatomen. Dabei können CyC und CyD mit einem oder mehreren Resten R substituiert sein.

Die oben genannten bevorzugten Gruppen (CyC-1) bis (CyC-20) und (CyD-1) bis (CyD-12) können beliebig miteinander kombiniert werden, sofern mindestens eine der Gruppen CyC bzw. CyD eine geeignete Anknüpfungsstelle an die Brücke V bzw. eine Brücke der Formel (2) aufweist, wobei geeignete Anknüpfungsstellen in den oben genannten Formeln mit "o" gekennzeichnet sind.

Insbesondere bevorzugt ist es, wenn die oben als besonders bevorzugt genannten Gruppen CyC und CyD, also die Gruppen der Formeln (CyC-1a) bis (CyC-20a) und die Gruppen der Formeln (CyD1-a) bis (CyD-14b) miteinander kombiniert werden, sofern mindestens eine der bevorzugten Gruppen CyC bzw. CyD eine geeignete Anknüpfungsstelle an die Brücke V bzw. die Brücke der Formel (2) aufweist, wobei geeignete Anknüpfungsstellen in den oben genannten Formeln mit "o" gekennzeichnet sind. Kombinationen, in denen weder CyC noch CyD eine solche geeignete Anknüpfungsstelle für die Brücke V bzw. die Brücke der Formel (2) aufweist, sind daher nicht bevorzugt.

Ganz besonders bevorzugt ist es, wenn eine der Gruppen (CyC-1), (CyC-3), (CyC-8), (CyC-10), (CyC-12), (CyC-13) und (CyC-16), und insbesondere die Gruppen (CyC-1a), (CyC-3a), (CyC-8a), (CyC-10a), (CyC-12a), (CyC-13a) und (CyC-16a), mit einer der Gruppen (CyD-1), (CyD-2) und (CyD-3), und insbesondere mit einer der Gruppen (CyD-1a), (CyD-2a) und (CyD-3a), kombiniert wird.

Bevorzugte Teilliganden (L-1) sind die Strukturen der Formeln (L-1-1) und (L-1-2), und bevorzugte Teilliganden (L-2) sind die Strukturen der Formeln (L-2-1) bis (L-2-4), 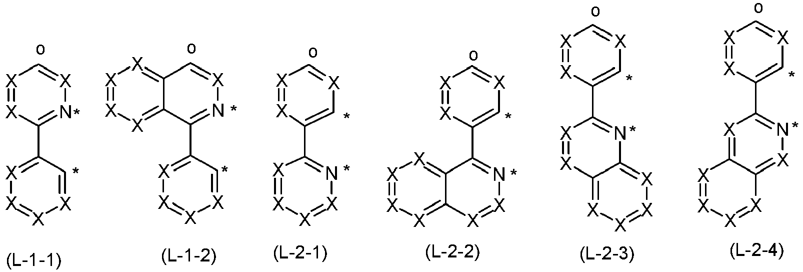 wobei die verwendeten Symbole die oben genannten Bedeutungen aufweisen und "o" die Position der Bindung an die Brücke V bzw. die Brücke der Formel (2) darstellt.

Besonders bevorzugte Teilliganden (L-1) sind die Strukturen der Formeln (L-1-1a) und (L-1-2b), und besonders bevorzugte Teilliganden (L-2) sind die Strukturen der Formeln (L-2-1a) bis (L-2-4a), 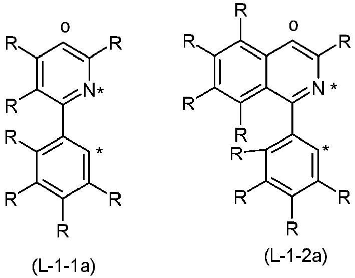 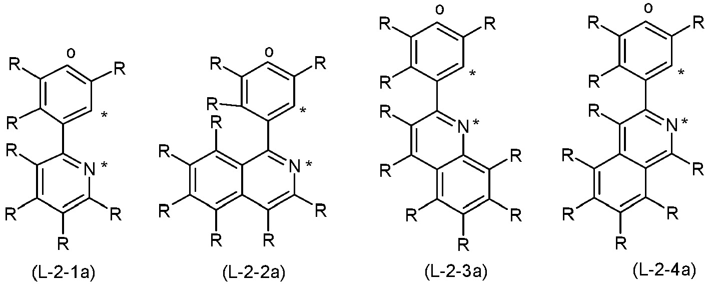 wobei die verwendeten Symbole die oben genannten Bedeutungen aufweisen und "o" die Position der Bindung an die Brücke V bzw. die Brücke der Formel (2) darstellt.

Wenn zwei Reste R, von denen einer an CyC und der andere an CyD gebunden sind, miteinander ein aromatisches Ringsystem bilden, können sich überbrückte Teilliganden und beispielsweise auch Teilliganden ergeben, die insgesamt eine einzige größere Heteroarylgruppe darstellen, wie beispielsweise Benzo[h]chinolin, etc.. Die Ringbildung zwischen den Substituenten an CyC und CyD erfolgt dabei bevorzugt durch eine Gruppe gemäß einer der folgenden Formeln (31) bis (40), 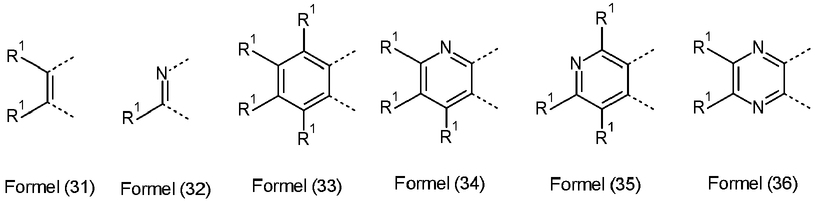 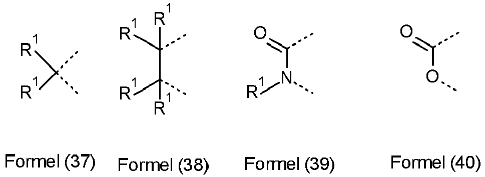 wobei R¹ die oben genannten Bedeutungen aufweist und die gestrichelten Bindungen die Bindungen an CyC bzw. CyD andeuten. Dabei können die unsymmetrischen der oben genannten Gruppen in jeder der beiden Möglichkeiten eingebaut werden, beispielsweise kann bei der Gruppe der Formel (40) das Sauerstoffatom an die Gruppe CyC und die Carbonylgruppe an die Gruppe CyD binden, oder das Sauerstoffatom kann an die Gruppe CyD und die Carbonylgruppe an die Gruppe CyC binden.

Dabei ist die Gruppe der Formel (37) besonders dann bevorzugt, wenn sich dadurch die Ringbildung zu einem Sechsring ergibt, wie beispielsweise unten durch die Formeln (L-21) und (L-22) dargestellt.

Bevorzugte Liganden, die durch Ringbildung zweier Reste R an den unterschiedlichen Cyclen entstehen, sind die im Folgenden aufgeführten Strukturen der Formeln (L-3) bis (L-30), 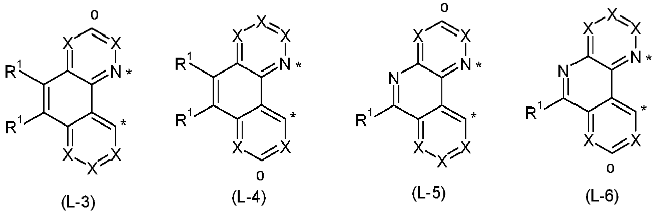 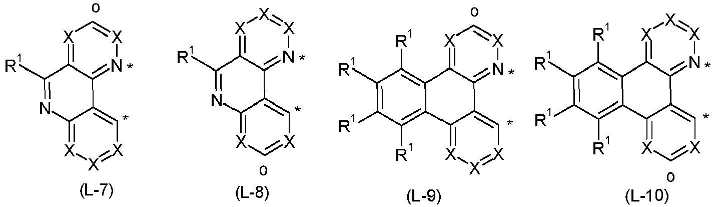 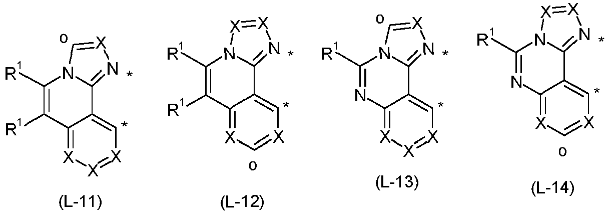 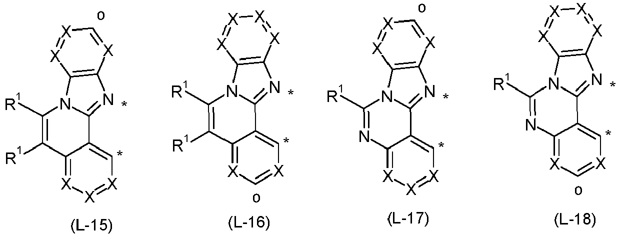 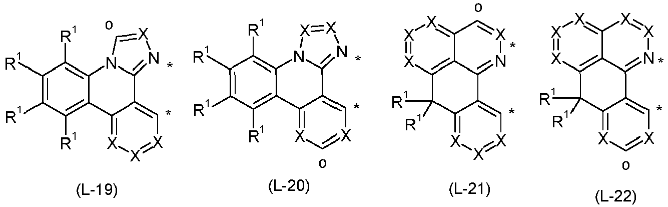 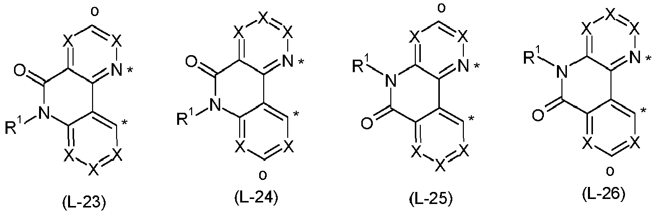 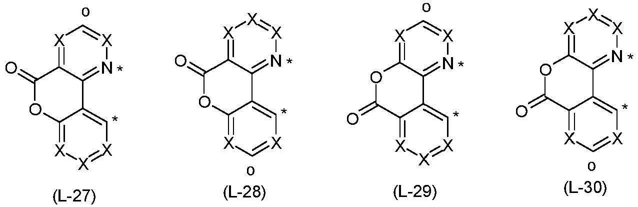 wobei die verwendeten Symbole die oben genannten Bedeutungen aufweisen und "o" die Position angibt, an denen dieser Teilligand mit der Brücke V bzw. der Brücke der Formel (2) verknüpft ist.

In einer bevorzugten Ausführungsform der Teilliganden der Formeln (L-3) bis (L-32) steht insgesamt ein Symbol X für N und die anderen Symbole X stehen für CR, oder alle Symbole X stehen für CR.

In einer weiteren Ausführungsform der Erfindung ist es bevorzugt, falls in den Gruppen (CyC-1) bis (CyC-20) oder (CyD-1) bis (CyD-14) oder in den Teilliganden (L-3) bis (L-32) eines der Atome X für N steht, wenn benachbart zu diesem Stickstoffatom eine Gruppe R als Substituent gebunden ist, welche ungleich Wasserstoff oder Deuterium ist. Dies gilt analog für die bevorzugten Strukturen (CyC-1a) bis (CyC-20a) oder (CyD-1a) bis (CyD-14b), in denen bevorzugt benachbart zu einem nicht koordinierenden Stickstoffatom eine Gruppe R als Substituent gebunden ist, welche ungleich Wasserstoff oder Deuterium ist. Dabei ist dieser Substituent R bevorzugt eine Gruppe, ausgewählt aus CF₃, Alkylgruppen mit 1 bis 10 C-Atomen, insbesondere verzweigten oder cyclischen Alkylgruppen mit 3 bis 10 C-Atomen, einer Dialkylaminogruppe mit 2 bis 10 C-Atomen, aromatischen bzw. heteroaromatischen Ringsystemen oder Aralkyl- bzw. Heteroaralkylgruppen. Es handelt sich bei diesen Gruppen um sterisch anspruchsvolle Gruppen. Weiterhin bevorzugt kann dieser Rest R auch mit einem benachbarten Rest R einen Cyclus bilden.

Ein weiterer geeigneter bidentater Teilligand ist eine Struktur der folgenden Formel (L-31) oder (L-32), 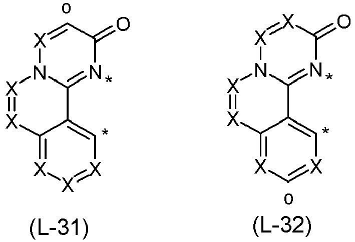 wobei R die oben genannten Bedeutungen aufweist, * die Position der Koordination an das Metall darstellt, "o" die Position der Verknüpfung des Teilliganden mit der Brücke V bzw. der Brücke der Formel (2) darstellt und für die weiteren verwendeten Symbole gilt:
- X: ist bei jedem Auftreten gleich oder verschieden CR oder N mit der Maßgabe, dass maximal ein Symbol X pro Cyclus für N steht.

Wenn zwei Reste R, die in den Teilliganden (L-31) bzw. (L-32) an benachbarten Kohlenstoffatomen gebunden sind, miteinander einen aromatischen Cyclus bilden, so ist dieser zusammen mit den beiden benachbarten Kohlenstoffatomen bevorzugt eine Struktur der Formel (41), 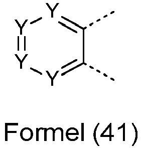 wobei die gestrichelten Bindungen die Verknüpfung dieser Gruppe im Teilliganden symbolisieren und Y gleich oder verschieden bei jedem Auftreten für CR¹ oder N steht und bevorzugt maximal ein Symbol Y für N steht.

In einer bevorzugten Ausführungsform des Teilliganden (L-31) bzw. (L-32) ist maximal eine Gruppe der Formel (41) vorhanden. Es handelt sich also bevorzugt um Teilliganden der folgenden Formeln (L-33) bis (L-38), 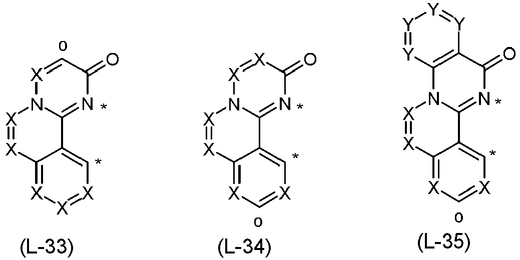 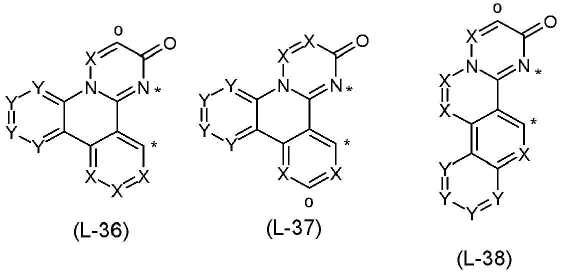 wobei X bei jedem Auftreten gleich oder verschieden für CR oder N steht, jedoch die Reste R nicht miteinander ein aromatisches oder heteroaromatisches Ringsystem bilden und die weiteren Symbole die oben genannten Bedeutungen aufweisen.

In einer bevorzugten Ausführungsform der Erfindung stehen im Teilliganden der Formel (L-31) bis (L-38) insgesamt 0, 1 oder 2 der Symbole X und, falls vorhanden, Y für N. Besonders bevorzugt stehen insgesamt 0 oder 1 der Symbole X und, falls vorhanden, Y für N.

Bevorzugte Ausführungsformen der Formeln (L-33) bis (L-38) sind die Strukturen der folgenden Formeln (L-33a) bis (L-38f), 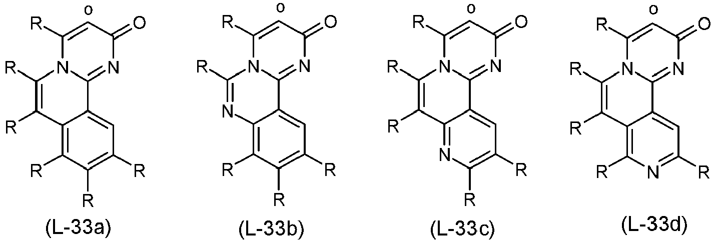 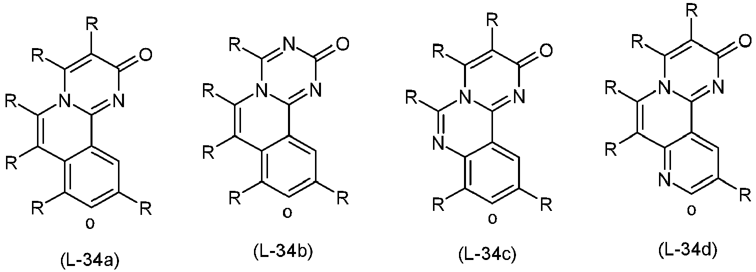 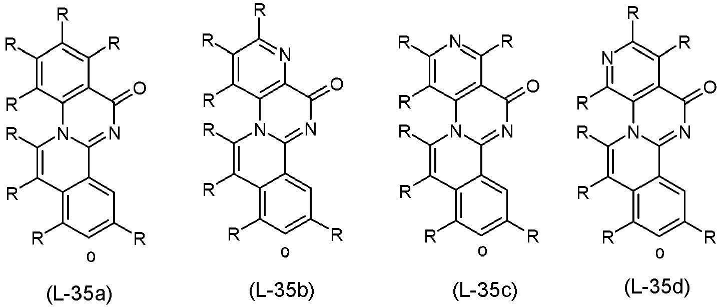 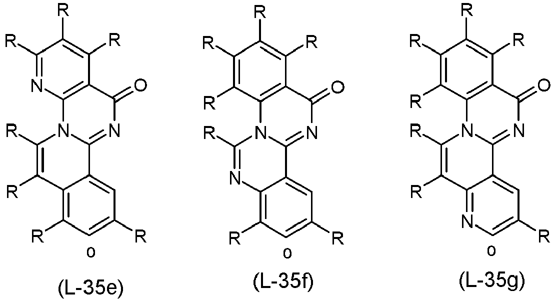 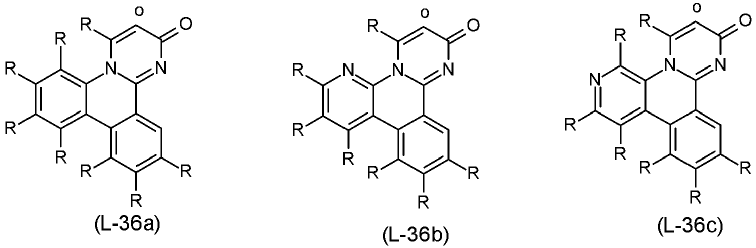 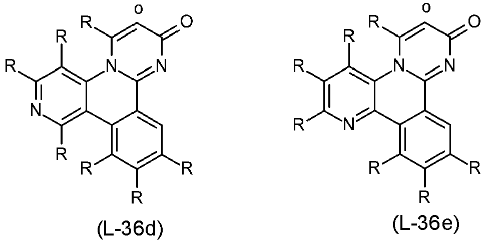 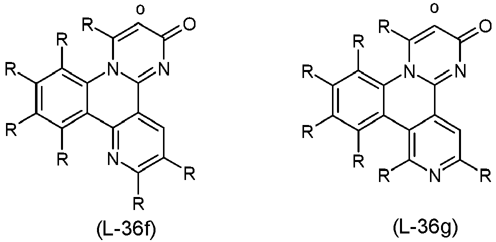 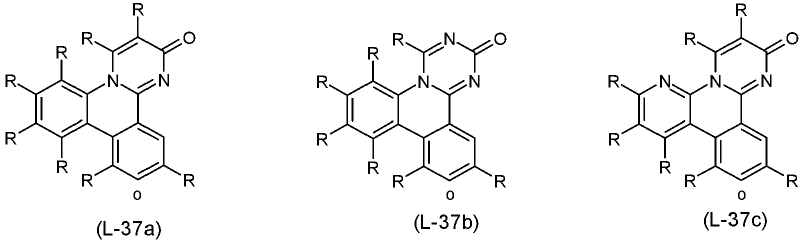 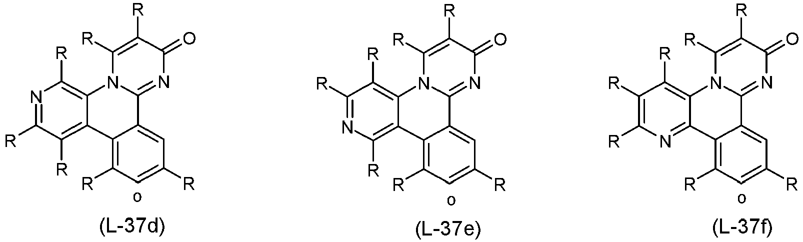 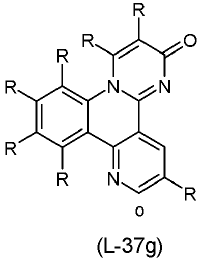 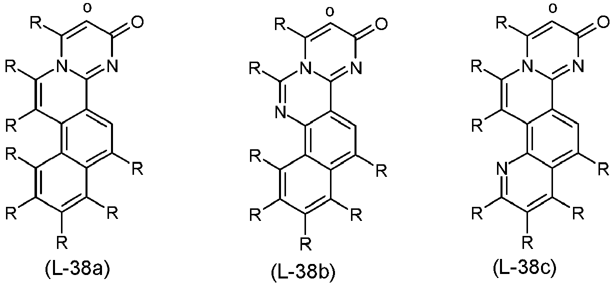 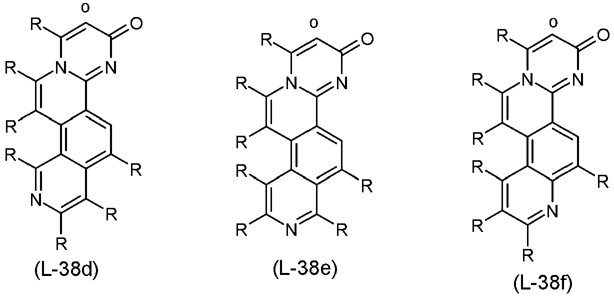 wobei die verwendeten Symbole die oben genannten Bedeutungen aufweisen und "o" die Position der Verknüpfung mit der Brücke V bzw. der Brücke der Formel (2) anzeigt.

In einer bevorzugten Ausführungsform der Erfindung steht die Gruppe X, die in ortho-Position zur Koordination an das Metall vorliegt, für CR. Dabei ist in dieser Rest R, der in ortho-Position zur Koordination an das Metall gebunden ist, bevorzugt ausgewählt aus der Gruppe bestehend aus H, D, F und Methyl.

In einer weiteren Ausführungsform der Erfindung ist es bevorzugt, falls eines der Atome X oder, wenn vorhanden, Y für N steht, wenn benachbart zu diesem Stickstoffatom eine Gruppe R als Substituent gebunden ist, welche ungleich Wasserstoff oder Deuterium ist. Dabei ist dieser Substituent R bevorzugt eine Gruppe, ausgewählt aus CF₃, Alkylgruppen mit 1 bis 10 C-Atomen, insbesondere verzweigten oder cyclischen Alkylgruppen mit 3 bis 10 C-Atomen, einer Dialkylaminogruppe mit 2 bis 10 C-Atomen, aromatischen bzw. heteroaromatischen Ringsystemen oder Aralkyl- bzw. Heteroaralkylgruppen. Es handelt sich bei diesen Gruppen um sterisch anspruchsvolle Gruppen. Weiterhin bevorzugt kann dieser Rest R auch mit einem benachbarten Rest R einen Cyclus bilden.

Wenn einer oder mehrere der Teilliganden L¹, L² bzw. L³ über zwei Stickstoffatome an das Iridium koordinieren, dann handelt es sich bevorzugt gleich oder verschieden um einen Teilliganden gemäß einer der folgenden Formel (L-39), (L-40) und (L-41), 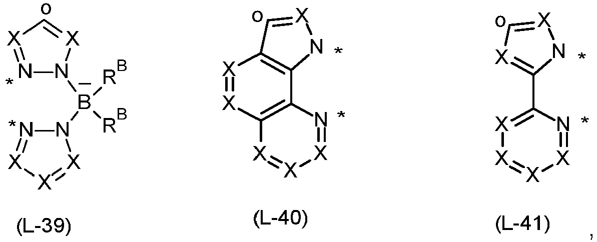 wobei X die oben genannten Bedeutungen aufweist, wobei maximal eine Gruppe X pro Ring für N steht, "o" die Position der Verknüpfung mit der Brücke V bzw. der Brücke der Formel (2) anzeigt und R^{B} bei jedem Auftreten gleich oder verschieden ausgewählt ist aus der Gruppe bestehend aus F, OR¹, einer geradkettigen Alkylgruppe mit 1 bis 10 C-Atomen oder einer verzweigten oder cyclischen Alkylgruppe mit 3 bis 10 C-Atomen, wobei die Alkylgruppe jeweils mit einem oder mehreren Resten R¹ substituiert sein kann, oder einem aromatischen oder heteroaromatischen Ringsystem mit 5 bis 24 aromatischen Ringatomen, das jeweils durch einen oder mehrere Reste R¹ substituiert sein kann; dabei können die beiden Reste R^{B} auch miteinander ein Ringsystem bilden. Dabei koordinieren die Teilliganden über die beiden mit * markierten N-Atomen an das Iridium.

Wenn einer oder mehrere der Teilliganden L¹, L² bzw. L³ über zwei Sauerstoffatome an das Iridium koordinieren, dann handelt es sich bevorzugt um einen Teilliganden der folgenden Formel (L-42), 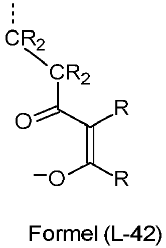 wobei R die oben genannten Bedeutungen aufweist, der Teilligand über die beiden Sauerstoffatome an das Iridium koordiniert und die gestrichelte Bindung die Verknüpfung an die Brücke V bzw. die Brücke der Formel (2) anzeigt. Dabei ist dieser Teilligand bevorzugt an eine Gruppe der Formel (3) gebunden und nicht an eine Gruppe -CR₂-CR₂-.

Wenn einer oder mehrere der Teilliganden L¹, L² bzw. L³ über Sauerstoffatom und ein Stickstoffatom an das Iridium koordinieren, dann handelt es sich bevorzugt um einen Teilliganden der folgenden Formel (L-43), 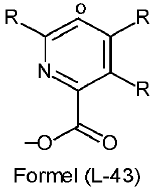 wobei R die oben genannten Bedeutungen aufweist und bevorzugt für H steht, der Teilligand über ein Sauerstoffatom und das Stickstoffatom an das Iridium koordiniert und "o" die Position der Verknüpfung an die Brücke V bzw. die Brücke der Formel (2) anzeigt.

Im Folgenden werden bevorzugte Substituenten beschrieben, wie sie an den oben beschriebenen Teilliganden L¹, L² und L³, aber auch an der bivalenten Arylen- oder Heteroarylengruppe in den Strukturen der Formeln (3) bis (5) vorliegen können.

In einer bevorzugten Ausführungsform der Erfindung enthält der erfindungsgemäße Metallkomplex zwei Substituenten R oder zwei Substituenten R¹, die an benachbarte Kohlenstoffatome gebunden sind und die miteinander einen aliphatischen Ring gemäß einer der nachfolgend beschriebenen Formeln bilden. Dabei können die beiden Substituenten R, die diesen aliphatischen Ring bilden, an der Brücke V bzw. die Brücke der Formel (2) vorliegen und/oder an einem oder mehreren der bidentaten Teilliganden vorliegen. Der aliphatische Ring, der durch die Ringbildung von zwei Substituenten R miteinander oder von zwei Substituenten R¹ miteinander gebildet wird, wird bevorzugt durch eine der folgenden Formeln (42) bis (48) beschrieben, 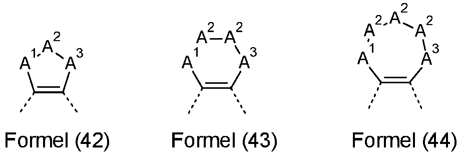 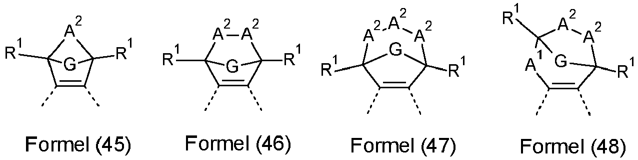 wobei R¹ und R² die oben genannten Bedeutungen aufweisen, die gestrichelten Bindungen die Verknüpfung der beiden Kohlenstoffatome im Liganden andeuten und weiterhin gilt:
- A¹, A³: ist gleich oder verschieden bei jedem Auftreten C(R³)₂, NR³ oder C(=O);
- A²: ist C(R¹)₂, NR³ oder C(=O);
- G: ist eine Alkylengruppe mit 1, 2 oder 3 C-Atomen, welche mit einem oder mehreren Resten R² substituiert sein kann, -CR²=CR²- oder eine ortho-verknüpfte Arylen- oder Heteroarylengruppe mit 5 bis 14 aromatischen Ringatomen, welche durch einen oder mehrere Reste R² substituiert sein kann;
- R³: ist gleich oder verschieden bei jedem Auftreten H, F, eine geradkettige Alkylgruppe mit 1 bis 10 C-Atomen, eine verzweigte oder cyclische Alkylgruppe mit 3 bis 10 C-Atomen, wobei die Alkylgruppe jeweils mit einem oder mehreren Resten R² substituiert sein kann, oder ein aromatisches oder heteroaromatisches Ringsystem mit 5 bis 24 aromatischen Ringatomen, das jeweils durch einen oder mehrere Reste R² substituiert sein kann; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden;
mit der Maßgabe, dass in diesen Gruppen nicht zwei Heteroatome direkt aneinander gebunden sind und nicht zwei Gruppen C=O direkt aneinander gebunden sind.

In den oben abgebildeten Strukturen der Formeln (42) bis (48) sowie den weiteren als bevorzugt genannten Ausführungsformen dieser Strukturen wird formal eine Doppelbindung zwischen den zwei Kohlenstoffatomen abgebildet. Dies stellt eine Vereinfachung der chemischen Struktur dar, wenn diese beiden Kohlenstoffatome in ein aromatisches oder heteroaromatisches System eingebunden sind und somit die Bindung zwischen diesen beiden Kohlenstoffatomen formal zwischen dem Bindungsgrad einer Einfachbindung und dem einer Doppelbindung liegt. Das Einzeichnen der formalen Doppelbindung ist somit nicht limitierend für die Struktur auszulegen, sondern es ist für den Fachmann offensichtlich, dass es sich hier um eine aromatische Bindung handelt.

Wenn benachbarte Reste in den erfindungsgemäßen Strukturen ein aliphatisches Ringsystem bilden, dann ist es bevorzugt, wenn dieses keine aziden benzylischen Protonen aufweist. Unter benzylischen Protonen werden Protonen verstanden, die an ein Kohlenstoffatom binden, welches direkt an den Liganden gebunden sind. Dies kann dadurch erreicht werden, dass die Kohlenstoffatome des aliphatischen Ringsystems, die direkt an eine Aryl- oder Heteroarylgruppe binden, vollständig substituiert sind und keine Wasserstoffatome gebunden enthalten. So wird die Abwesenheit von aziden benzylischen Protonen in den Formeln (42) bis (44) dadurch erreicht, dass A¹ und A³, wenn diese für C(R³)₂ stehen, so definiert sind, dass R³ ungleich Wasserstoff ist. Dies kann weiterhin auch dadurch erreicht werden, dass die Kohlenstoffatome des aliphatischen Ringsystems, die direkt an eine Aryl- oder Heteroarylgruppe binden, die Brückenköpfe einer bi- oder polycyclischen Struktur sind. Die an Brückenkopfkohlenstoffatome gebundenen Protonen sind aufgrund der räumlichen Struktur des Bi- oder Polycyclus wesentlich weniger azide als benzylische Protonen an Kohlenstoffatomen, die nicht in einer bi- oder polycyclischen Struktur gebunden sind, und werden im Sinne der vorliegenden Erfindung als nicht-azide Protonen angesehen. So wird die Abwesenheit von aziden benzylischen Protonen ist in Formeln (45) bis (48) dadurch erreicht, dass es sich dabei um eine bicyclische Struktur handelt, wodurch R¹, wenn es für H steht, deutlich weniger azide als benzylische Protonen, da das korrespondierende Anion der bicyclischen Struktur nicht mesomeriestabilisiert ist. Auch wenn R¹ in Formeln (45) bis (48) für H steht, handelt es sich dabei daher um ein nicht-azides Proton im Sinne der vorliegenden Anmeldung.

In einer bevorzugten Ausführungsform der Erfindung ist R³ ungleich H.

In einer bevorzugten Ausführungsform der Struktur gemäß Formel (42) bis (48) steht maximal eine der Gruppen A¹, A² und A³ für ein Heteroatom und die anderen Gruppen stehen für C(R³)₂ bzw. C(R¹)₂ oder A¹ und A³ stehen gleich oder verschieden bei jedem Auftreten für NR³ und A² steht für C(R¹)₂. In einer besonders bevorzugten Ausführungsform der Erfindung stehen A¹ und A³ gleich oder verschieden bei jedem Auftreten für C(R³)₂ und A² steht für C(R¹)₂ und besonders bevorzugt für C(R³)₂ oder CH₂.

Bevorzugte Ausführungsformen der Formel (42) sind somit die Strukturen der Formel (42-A), (42-B), (42-C) und (42-D), und eine besonders bevorzugte Ausführungsform der Formel (42-A) sind die Strukturen der Formel (42-E) und (42-F), 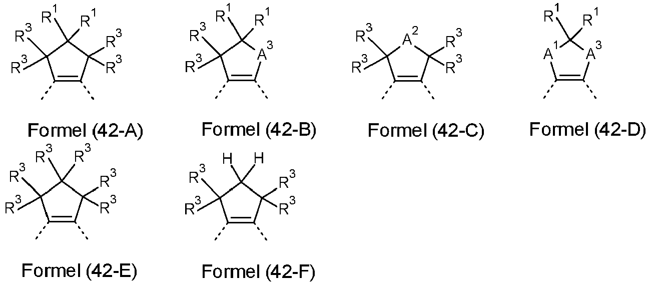 wobei R¹ und R³ die oben genannten Bedeutungen aufweisen und A¹, A² und A³ für NR³ steht.

Bevorzugte Ausführungsformen der Formel (43) sind die Strukturen der folgenden Formeln (43-A) bis (43-F), 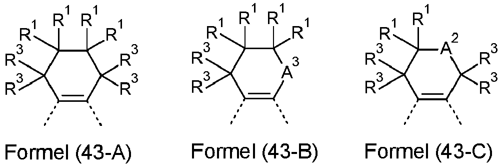 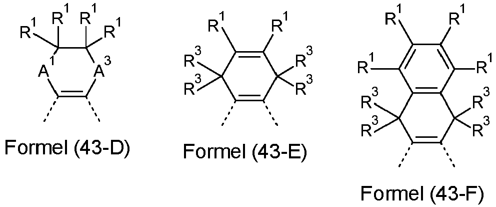 wobei R¹ und R³ die oben genannten Bedeutungen aufweisen und A¹, A² und A³ für NR³ steht.

Bevorzugte Ausführungsformen der Formel (46) sind die Strukturen der folgenden Formeln (44-A) bis (44-E), 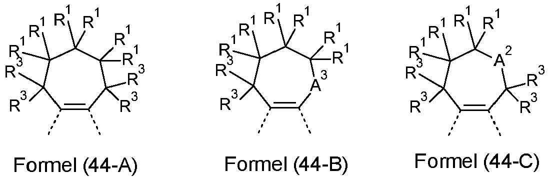 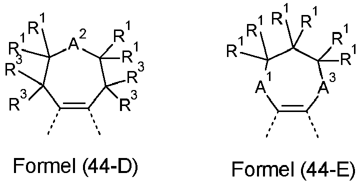 wobei R¹ und R³ die oben genannten Bedeutungen aufweisen und A¹, A² und A³ für NR³ steht.

In einer bevorzugten Ausführungsform der Struktur gemäß Formel (45) stehen die Reste R¹, die an den Brückenkopf gebunden sind, für H, D, F oder CH₃. Weiterhin bevorzugt steht A² für C(R¹)₂, und besonders bevorzugt für C(R³)₂. Bevorzugte Ausführungsformen der Formel (45) ist somit eine Struktur der Formel (45-A), und eine besonders bevorzugte Ausführungsform der Formel (45-A) ist eine Struktur der Formel (45-C), 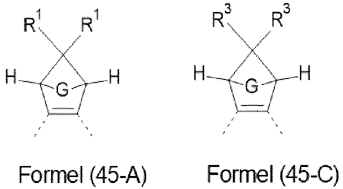 wobei die verwendeten Symbole die oben genannten Bedeutungen aufweisen.

In einer bevorzugten Ausführungsform der Strukturen gemäß den Formeln (46), (47) und (48) stehen die Reste R¹, die an den Brückenkopf gebunden sind, für H, D, F oder CH₃. Weiterhin bevorzugt steht A² für C(R¹)₂. Bevorzugte Ausführungsformen der Formel (46), (47) und (48) sind somit die Strukturen der Formeln (46-A), (47-A) und (48-A), 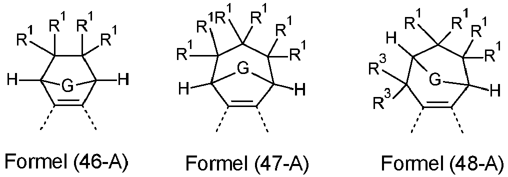 wobei die verwendeten Symbole die oben genannten Bedeutungen aufweisen.

Weiterhin bevorzugt steht die Gruppe G in den Formeln (45), (45-A), (45-B), (45-C), (46), (46-A), (47), (47-A), (48) und (48-A) für eine 1,2-Ethylengruppe, welche mit einem oder mehreren Resten R² substituiert sein kann, wobei R² bevorzugt gleich oder verschieden bei jedem Auftreten für H oder eine Alkylgruppe mit 1 bis 4 C-Atomen steht, oder eine ortho-Arylengruppe mit 6 bis 10 C-Atomen, welche mit einem oder mehreren Resten R² substituiert sein kann, bevorzugt aber unsubstituiert ist, insbesondere eine ortho-Phenylengruppe, welche mit einem oder mehreren Resten R² substituiert sein kann, bevorzugt aber unsubstituiert ist.

In einer weiteren bevorzugten Ausführungsform der Erfindung steht R³ in den Gruppen der Formel (42) bis (48) und in den bevorzugten Ausführungsformen gleich oder verschieden bei jedem Auftreten für F, eine geradkettige Alkylgruppe mit 1 bis 10 C-Atomen oder eine verzweigte oder cyclische Alkylgruppe mit 3 bis 20 C-Atomen, wobei jeweils eine oder mehrere nicht benachbarte CH₂-Gruppen durch R²C=CR² ersetzt sein können und ein oder mehrere H-Atome durch D oder F ersetzt sein können, oder ein aromatisches oder heteroaromatisches Ringsystem mit 5 bis 14 aromatischen Ringatomen, das jeweils durch einen oder mehrere Reste R² substituiert sein kann; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden.

In einer besonders bevorzugten Ausführungsform der Erfindung steht R³ in den Gruppen der Formeln (42) bis (48) und in den bevorzugten Ausführungsformen gleich oder verschieden bei jedem Auftreten für F, eine geradkettige Alkylgruppe mit 1 bis 3 C-Atomen, insbesondere Methyl, oder ein aromatisches oder heteroaromatisches Ringsystem mit 5 bis 12 aromatischen Ringatomen, das jeweils durch einen oder mehrere Reste R² substituiert sein kann, bevorzugt aber unsubstituiert ist; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden.

Beispiele für besonders geeignete Gruppen der Formel (42) sind die im Folgenden aufgeführten Strukturen:

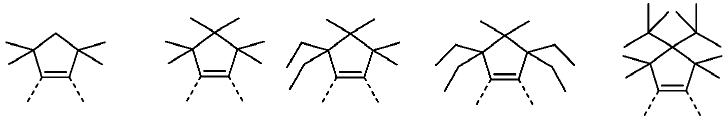

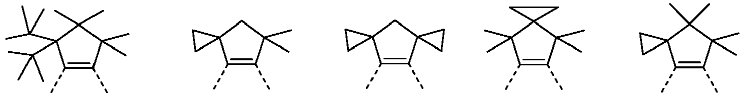

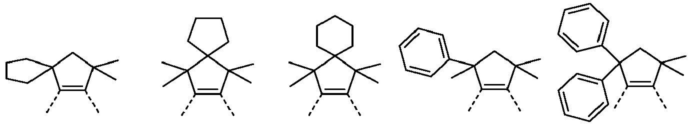

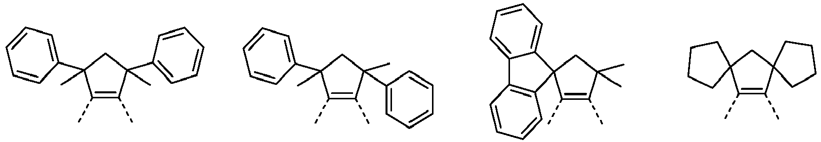

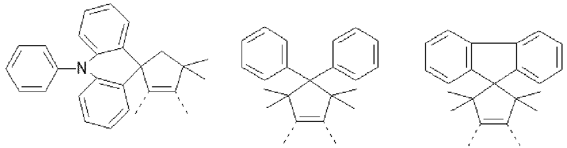

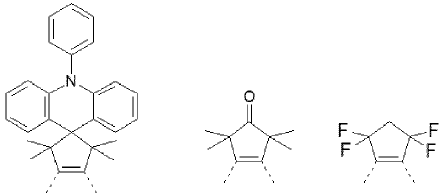

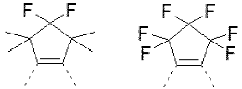

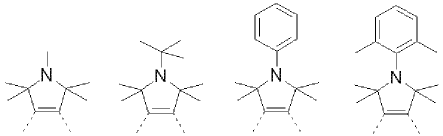

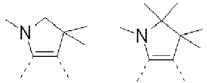

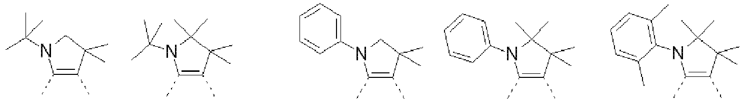

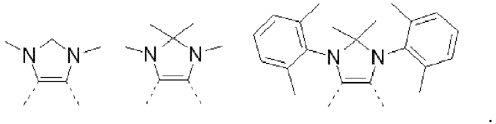

Beispiele für besonders geeignete Gruppen der Formel (43) sind die im Folgenden aufgeführten Strukturen:

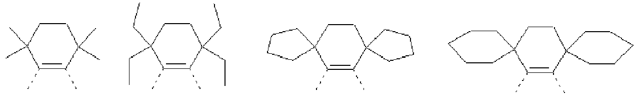

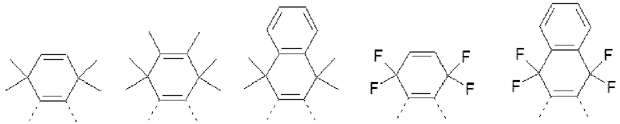

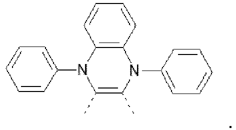

Beispiele für besonders geeignete Gruppen der Formel (44), (46) und (47) sind die im Folgenden aufgeführten Strukturen:

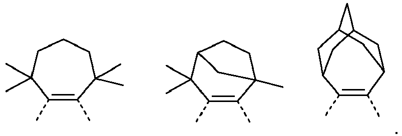

Beispiele für besonders geeignete Gruppen der Formel (45) sind die im Folgenden aufgeführten Strukturen:

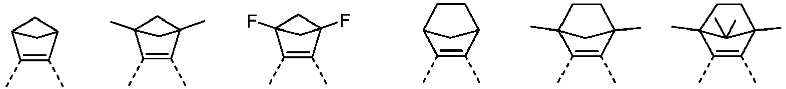

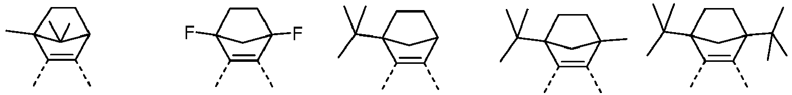

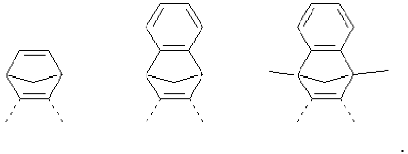

Beispiele für besonders geeignete Gruppen der Formel (46) sind die im Folgenden aufgeführten Strukturen:

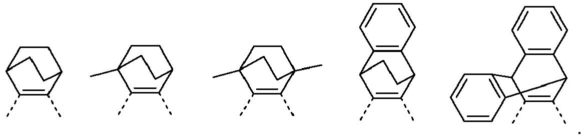

In einer weiteren bevorzugten Ausführungsform der Erfindung weist mindestens einer der Teilliganden L¹, L² bzw. L³, bevorzugt genau einer der Teilliganden L¹, L² bzw. L³ einen Substituenten gemäß einer der folgenden Formeln (49) oder (50) auf, 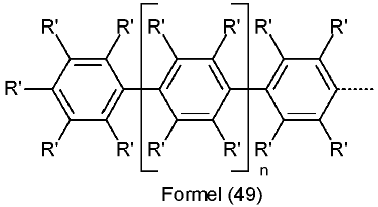 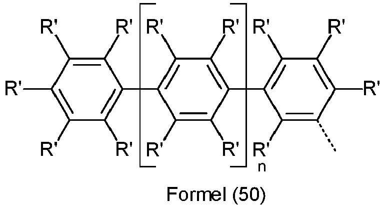 wobei die gestrichelte Bindung die Verknüpfung der Gruppe andeutet und weiterhin gilt:
- R`: ist gleich oder verschieden bei jedem Auftreten H, D, F, CN, eine geradkettige Alkylgruppe mit 1 bis 10 C-Atomen, in der auch ein oder mehrere H-Atome durch D oder F ersetzt sein können, oder eine verzweigte oder cyclische Alkylgruppe mit 3 bis 10 C-Atomen, in der auch ein oder mehrere H-Atome durch D oder F ersetzt sein können, oder eine Alkenylgruppe mit 2 bis 10 C-Atomen, in der auch ein oder mehrere H-Atome durch D oder F ersetzt sein können; dabei können auch zwei benachbarte Reste R` bzw. zwei Reste R` an benachbarten Phenylgruppen miteinander ein Ringsystem bilden; oder zwei R' an benachbarten Phenylgruppen stehen zusammen für eine Gruppe ausgewählt aus NR', O oder S, so dass die beiden Phenylringe zusammen mit der verbrückenden Gruppe für ein Dibenzofuran oder Dibenzothiophen stehen, und die weiteren R' sind wie vorstehend definiert;
- n: ist 0, 1, 2, 3, 4 oder 5.

Dabei ist der Rest R¹ am Stickstoff wie oben definiert und steht bevorzugt für eine Alkylgruppe mit 1 bis 10 C-Atomen oder ein aromatisches oder heteroaromatisches Ringsystem mit 6 bis 24 aromatischen Ringatomen, welches durch einen oder mehrere Reste R² substituiert sein kann, besonders bevorzugt für ein aromatisches oder heteroaromatisches Ringsystem mit 6 bis 18 aromatischen Ringatomen, welches durch einen oder mehrere Reste R² substituiert sein kann, bevorzugt aber unsubstituiert ist.

In einer bevorzugten Ausführungsform der Erfindung ist n = 0, 1 oder 2, bevorzugt 0 oder 1 und ganz besonders bevorzugt 0.

In einer weiteren bevorzugten Ausführungsform der Erfindung sind beide Substituenten R', welche in den ortho-Positionen zu dem Kohlenstoffatom gebunden sind, mit dem die Gruppe der Formel (49) bzw. (50) an den Teilliganden L¹, L² bzw. L³ gebunden ist, gleich oder verschieden H oder D.

Bevorzugte Ausführungsformen der Struktur der Formel (49) sind die Strukturen der Formeln (49a) bis (49h), und bevorzugte Ausführungsformen der Struktur der Formel (50) sind die Strukturen der Formeln (50a) bis (50h), 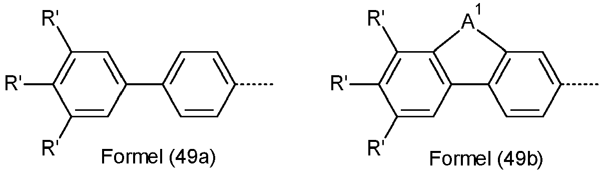 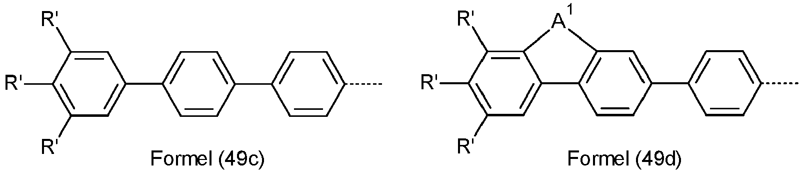 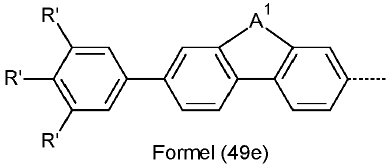 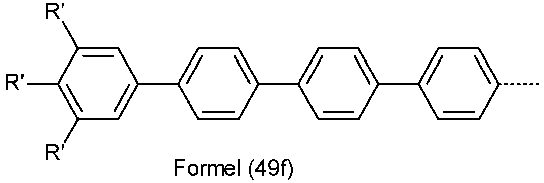 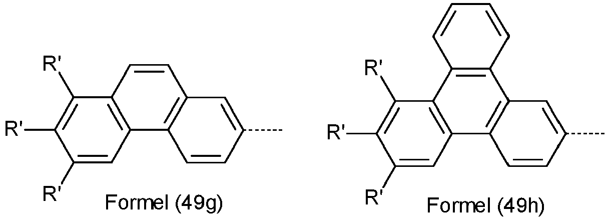 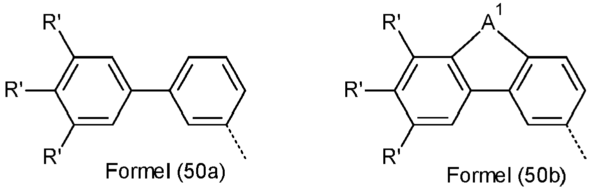 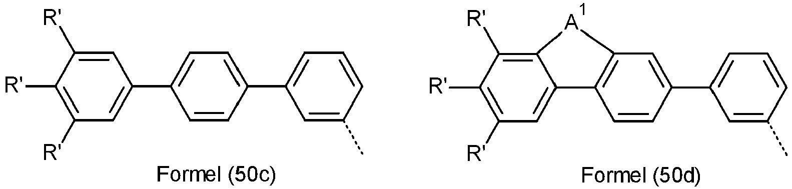 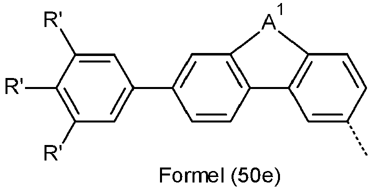 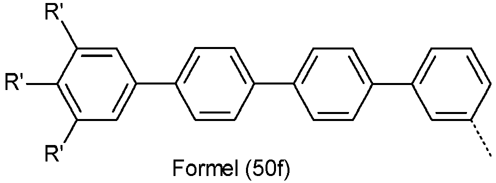 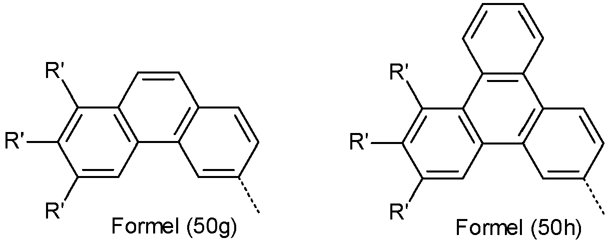 wobei A¹ für O, S, C(R¹)₂ oder NR¹ steht und die weiteren verwendeten Symbole die oben genannten Bedeutungen aufweisen. Dabei steht R¹ für A¹ = NR¹ bevorzugt für ein aromatisches oder heteroaromatisches Ringsystem mit 6 bis 18 aromatischen Ringatomen, welches durch einen oder mehrere Reste R² substituiert sein kann, bevorzugt aber unsubstituiert ist. Weiterhin steht R¹ für A¹ = C(R¹)₂ bevorzugt gleich oder verschieden bei jedem Auftreten für eine Alkylgruppe mit 1 bis 6 C-Atomen, bevorzugt mit 1 bis 4 C-Atomen, besonders bevorzugt Methylgruppen.

Bevorzugte Substituenten R' an den Gruppen der Formel (49) bzw. (50) bzw. den bevorzugten Ausführungsformen sind gewählt aus der Gruppe bestehend aus der Gruppe bestehend aus H, D, CN und einer Alkylgruppe mit 1 bis 4 C-Atomen, besonders bevorzugt H, D, Methyl, Cyclopentyl, 1-Methylcyclopentyl, Cyclohexyl oder 1-Methylcyclohexyl, insbesondere H, D oder Methyl.

Bevorzugt weist keiner der Teilliganden außer der Gruppe der Formel (49) bzw. (50) weitere aromatische oder heteroaromatische Substituenten mit mehr als 10 aromatischen Ringatomen auf.

In einer bevorzugten Ausführungsform der Erfindung ist der Substituent der Formel (49) bzw. (50) in para-Position zur Koordination an das Iridium gebunden, besonders bevorzugt an CyD. Wenn L¹, L² und L³ nicht alle gleich gewählt sind, ist es bevorzugt, wenn der Substituent der Formel (49) bzw. (50) an den Teilliganden gebunden ist, der bei Koordination an das Iridium zu der weitesten rot verschobenen Emission führt. Welcher Teilligand das ist, lässt sich durch quantenchemische Berechnung entsprechender Komplexe bestimmen, die jeweils drei gleiche Teilliganden enthalten und drei gleiche Einheiten V¹, V² und V³ aufweisen.

Dabei ist es bevorzugt, wenn die Gruppe der Formel (49) bzw. (50) an den Liganden L¹ gebunden ist, also an den Liganden, der über eine Gruppe der Formel (3) mit dem zentralen Cyclus des Brückenkopfes verknüpft ist. Dies gilt insbesondere, wenn die Gruppe V³ gleich der Gruppe V² ist, wenn der Brückenkopf also zwei Gruppen -CR₂-CR₂- bzw. der anderen Alternativen von V² aufweist, und wenn die drei Teilliganden L¹, L² und L³ die gleiche Grundstruktur aufweisen. Durch die Verknüpfung von L¹ mit der ortho-Arylengruppe bzw. ortho-Heteroarylengruppe der Formel (3) weist dieser Teil des Komplexes eine geringere Triplettenergie auf als die Teilliganden L² und L³, so dass die Emission des Komplexes überwiegend aus der Teilstruktur L¹-Ir kommt. Die Substitution des Teilliganden L¹ mit einer Gruppe der Formel (49) bzw. (50) führt dann zu einer deutlichen Verbesserung der Effizienz.

Ganz besonders bevorzugt sind Verbindungen, in denen V² und V³ für -CR₂-CR₂- stehen und der Teilligand L¹ eine Struktur der Formel (L-1-1) bzw. (L-2-1) aufweist, wobei die Gruppe der Formel (49) oder (50) in para-Position zum Iridium an den Sechsring gebunden ist, der über ein Stickstoffatom an das Iridium bindet. Bevorzugt ist die Emission der Einheiten V²-L² und V³-L³ blau verschoben gegenüber der Emission von V¹-L¹.

Bevorzugt sind die Reste R bei jedem Auftreten gleich oder verschieden ausgewählt aus der Gruppe bestehend aus H, D, F, N(R¹)₂, einer geradkettigen Alkylgruppe mit 1 bis 6 C-Atomen oder einer verzweigten oder cyclischen Alkylgruppe mit 3 bis 10 C-Atomen, wobei ein oder mehrere H-Atome durch D oder F ersetzt sein können, oder einem aromatischen oder heteroaromatischen Ringsystem mit 5 bis 24 aromatischen Ringatomen, das jeweils durch einen oder mehrere Reste R¹ substituiert sein kann; dabei können zwei benachbarte Reste R oder R mit R¹ auch miteinander ein mono- oder polycyclisches, aliphatisches oder aromatisches Ringsystem bilden.

Bevorzugte Reste R¹, die an R gebunden sind, sind bei jedem Auftreten gleich oder verschieden H, F, CN, eine geradkettige Alkylgruppe mit 1 bis 5 C-Atomen oder eine verzweigte oder cyclische Alkylgruppe mit 3 bis 5 C-Atomen, die jeweils mit einem oder mehreren Resten R² substituiert sein kann, oder ein aromatisches oder heteroaromatisches Ringsystem mit 5 bis 13 aromatischen Ringatomen, das jeweils durch einen oder mehrere Reste R² substituiert sein kann; dabei können zwei oder mehrere benachbarte Reste R¹ miteinander ein mono- oder polycyclisches, aliphatisches Ringsystem bilden.

Bevorzugte Reste R² sind bei jedem Auftreten gleich oder verschieden H, F oder ein aliphatischer Kohlenwasserstoffrest mit 1 bis 5 C-Atomen oder ein aromatischer Kohlenwasserstoffrest mit 6 bis 12 C-Atomen; dabei können zwei oder mehrere Substituenten R² auch miteinander ein mono- oder polycyclisches, aliphatisches Ringsystem bilden.

Die oben genannten bevorzugten Ausführungsformen sind beliebig miteinander kombinierbar. In einer besonders bevorzugten Ausführungsform der Erfindung gelten die oben genannten bevorzugten Ausführungsformen gleichzeitig.

Beispiele für geeignete erfindungsgemäße Strukturen sind die nachfolgend abgebildeten Verbindungen.

| | |
|---|---|
| 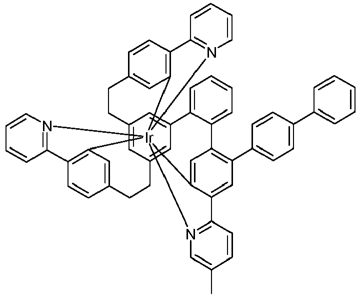 | 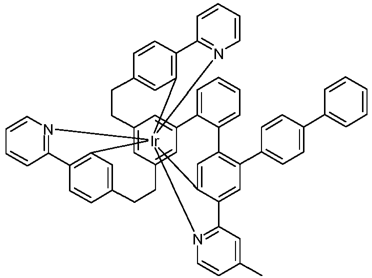 |
| 1 | 2 |
| 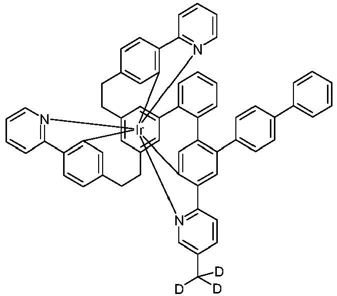 | 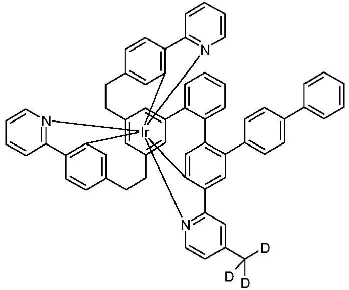 |
| 3 | 4 |
| 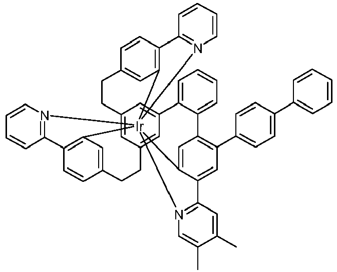 | 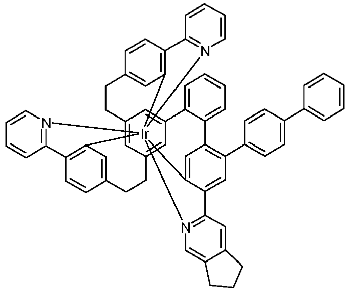 |
| 5 | 6 |
| 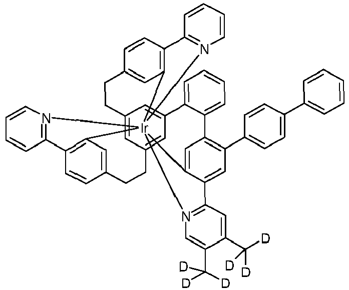 | 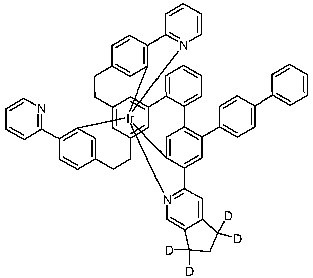 |
| 7 | 8 |
| 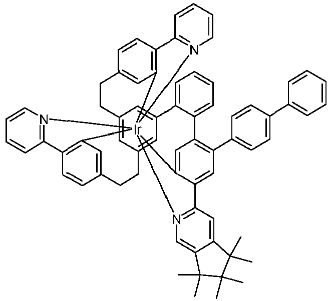 | 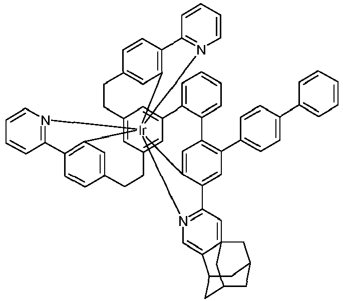 |
| 9 | 10 |
| 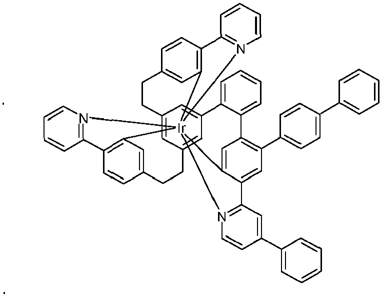 | 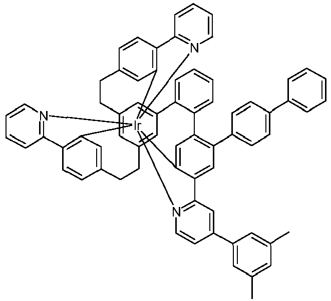 |
| 11 | 12 |
| 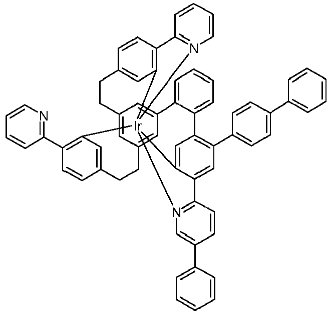 | 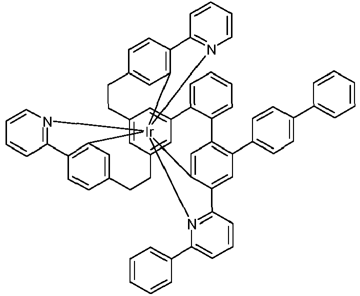 |
| 13 | 14 |
| 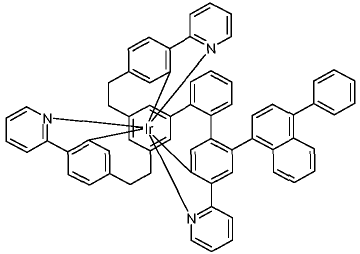 | 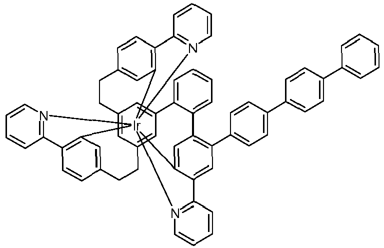 |
| 15 | 16 |
| 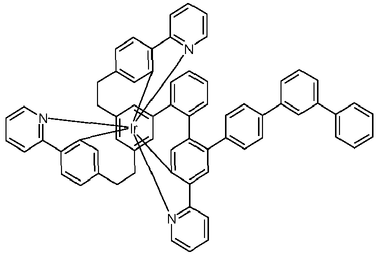 | 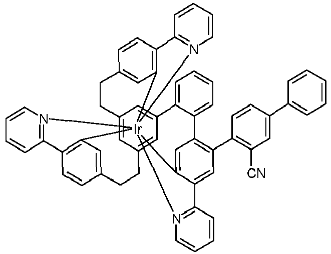 |
| 17 | 18 |
| 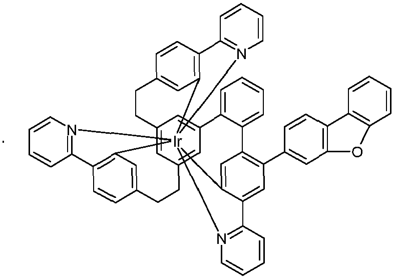 | 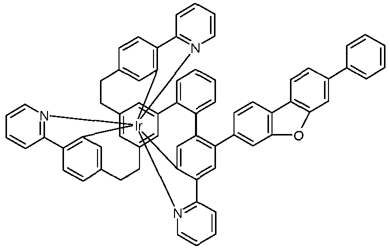 |
| 19 | 20 |
| 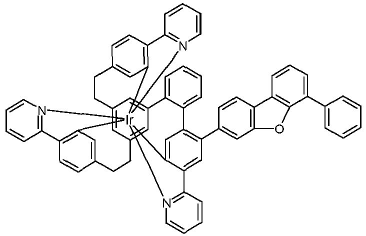 | 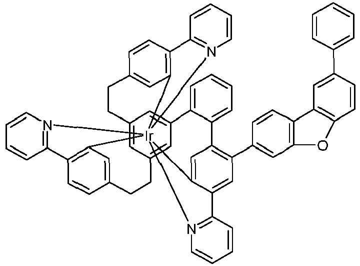 |
| 21 | 22 |
| 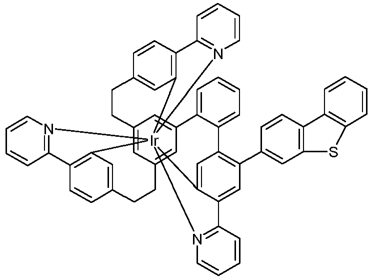 | 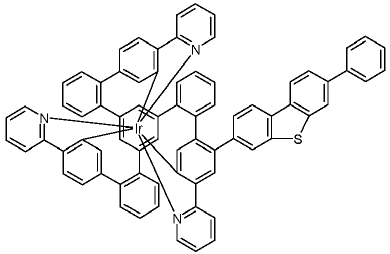 |
| 23 | 24 |
| 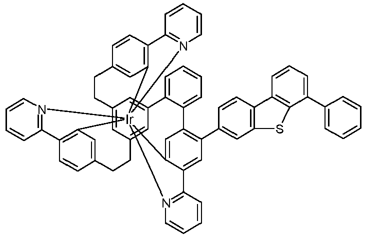 | 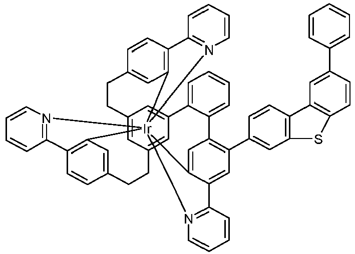 |
| 25 | 26 |
| 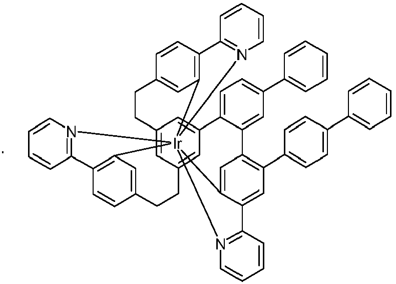 | 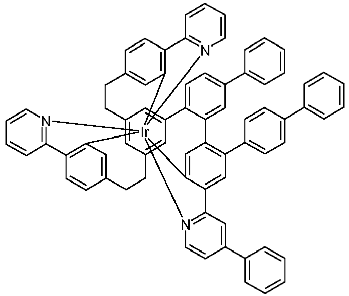 |
| 27 | 28 |
| 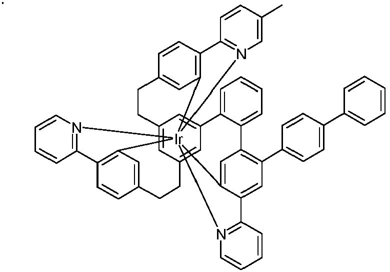 | 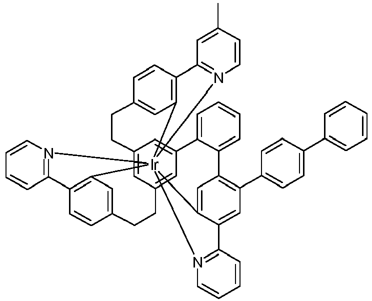 |
| 29 | 30 |
| 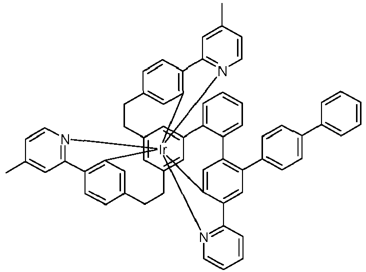 | 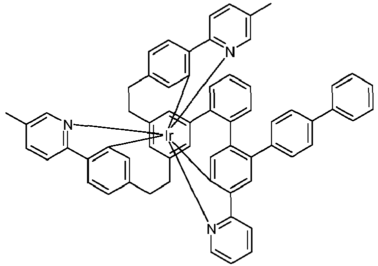 |
| 31 | 32 |
| 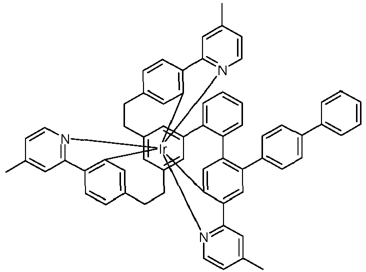 | 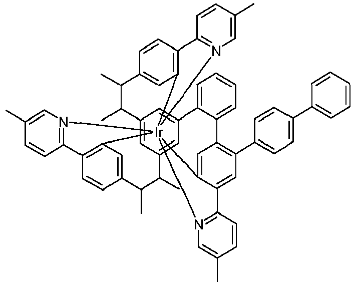 |
| 33 | 34 |
| 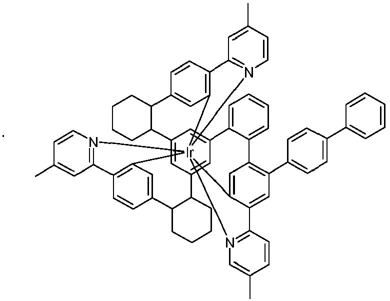 | 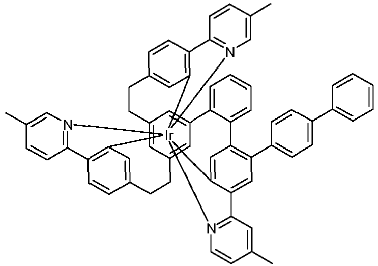 |
| 35 | 36 |
| 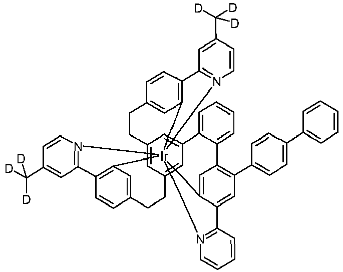 | 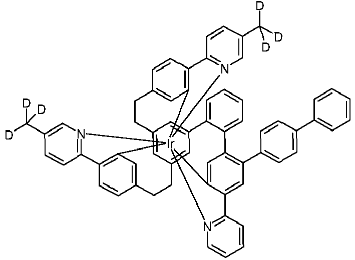 |
| 37 | 38 |
| 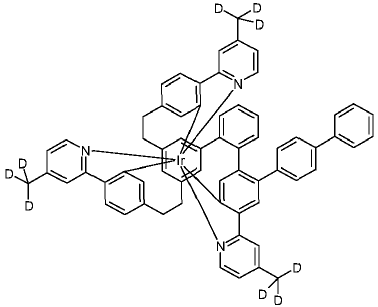 | 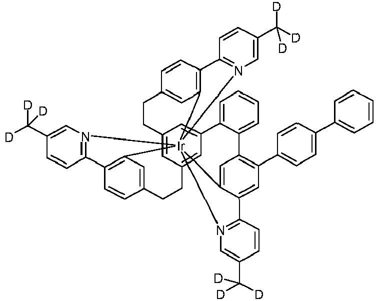 |
| 39 | 40 |
| 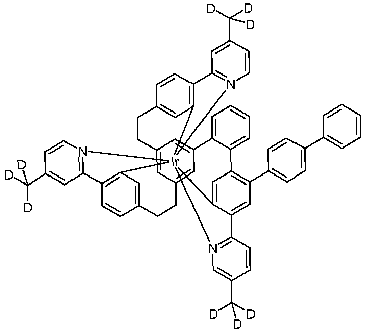 | 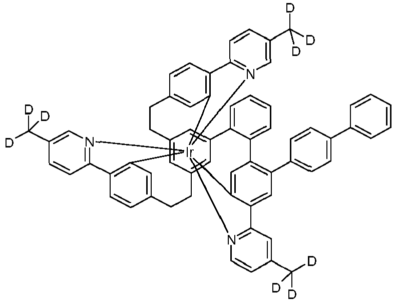 |
| 41 | 42 |
| 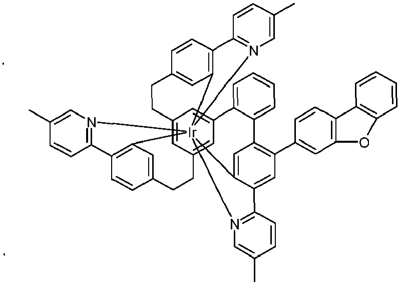 | 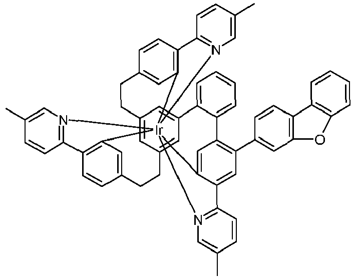 |
| 43 | 44 |
| 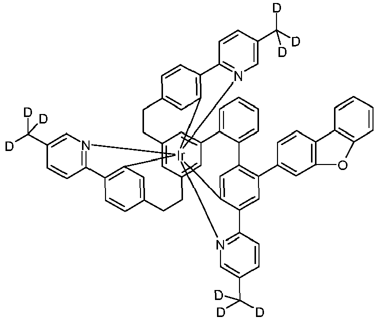 | 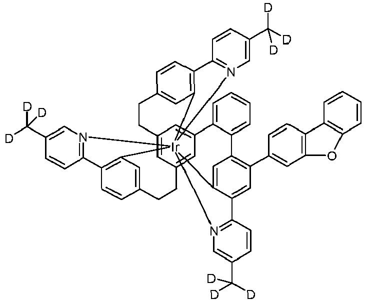 |
| 45 | 46 |
| 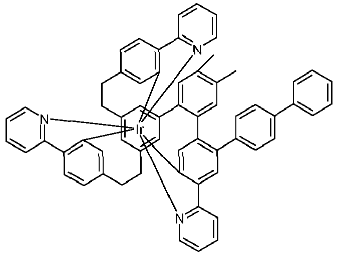 | 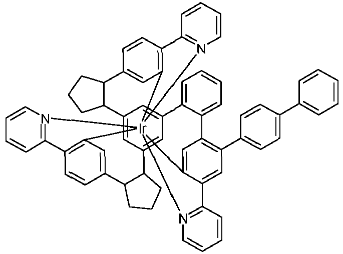 |
| 47 | 48 |
| 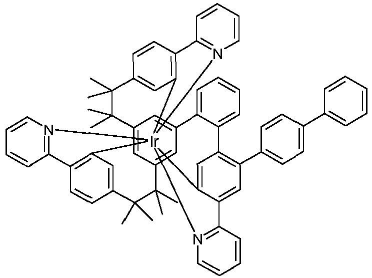 | 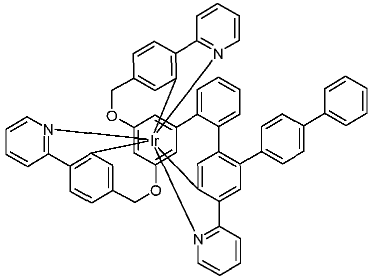 |
| 49 | 50 |
| 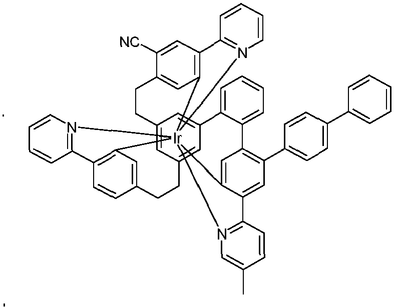 | 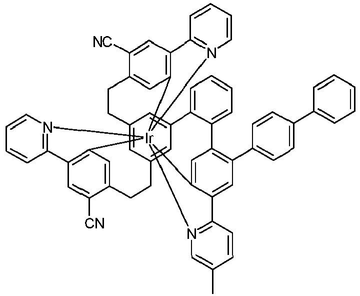 |
| 51 | 52 |
| 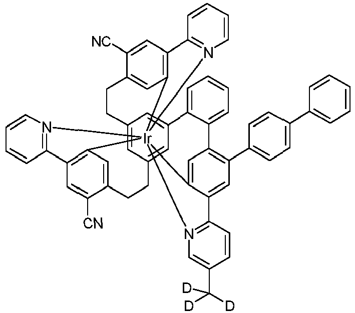 | 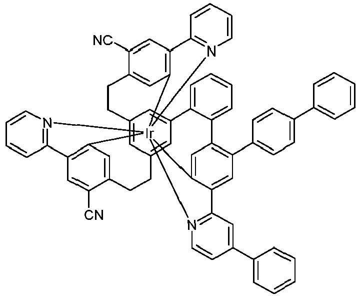 |
| 53 | 54 |
| 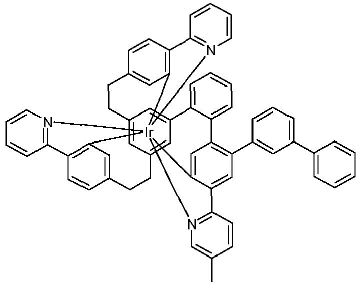 | 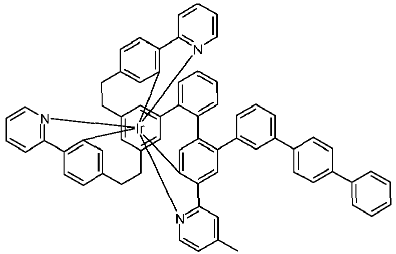 |
| 55 | 56 |
| 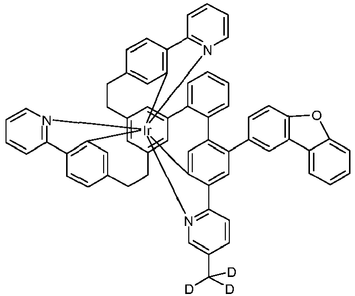 | 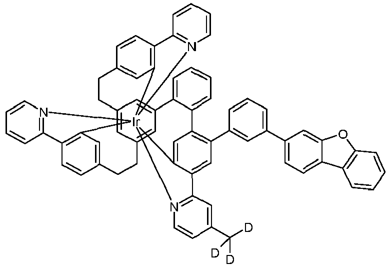 |
| 57 | 58 |
| 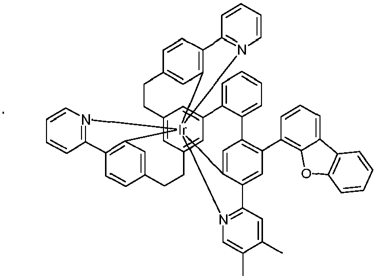 | 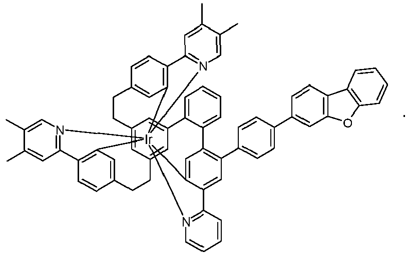 |
| 59 | 60 |
| 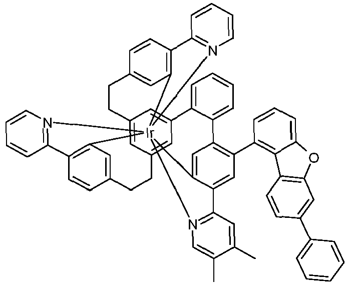 | 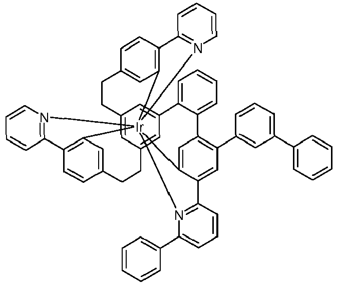 |
| 61 | 62 |
| 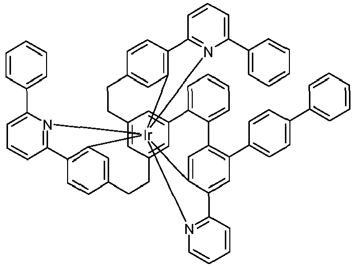 | 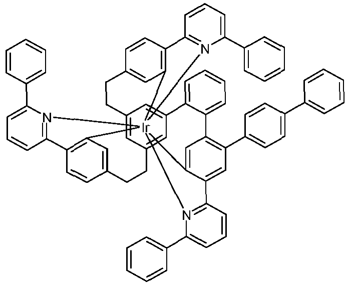 |
| 63 | 64 |
| 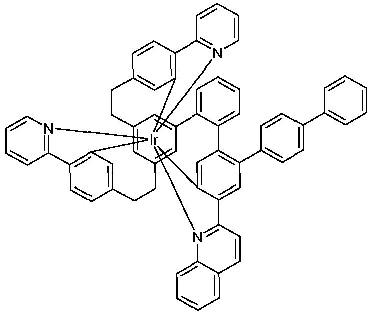 | 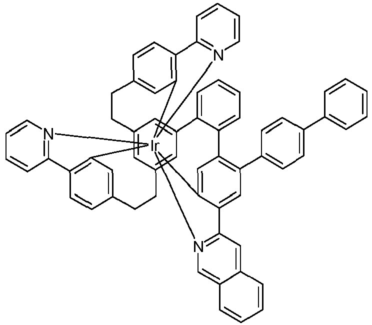 |
| 65 | 66 |
| 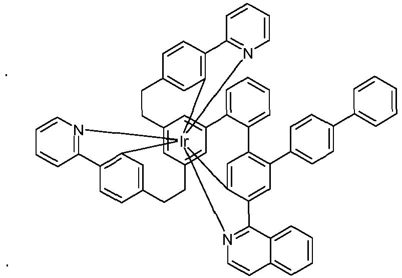 | 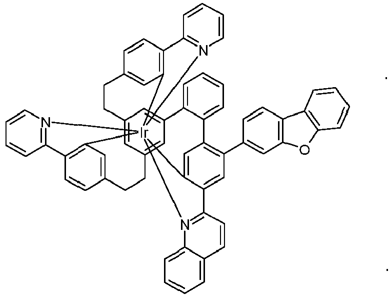 |
| 67 | 68 |
| 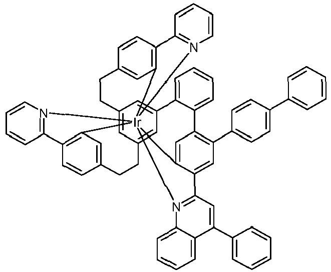 | 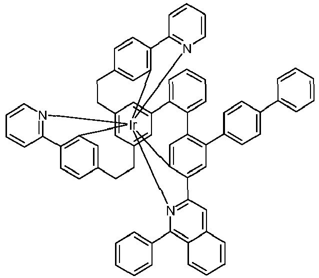 |
| 69 | 70 |
| 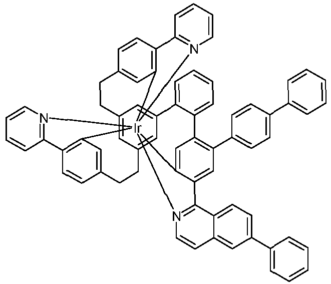 | 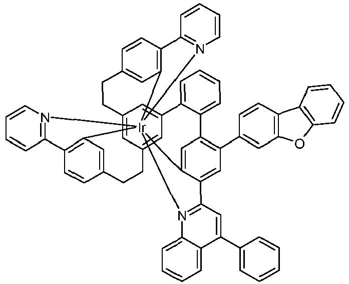 |
| 71 | 72 |
| 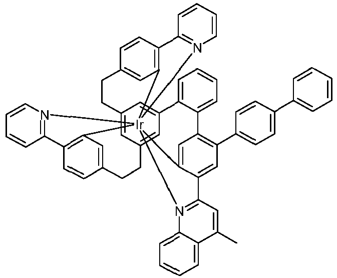 | 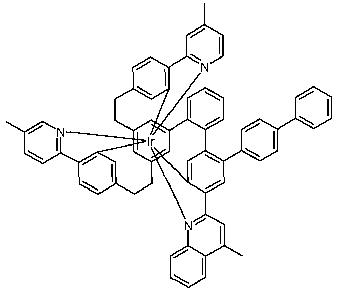 |
| 73 | 74 |
| 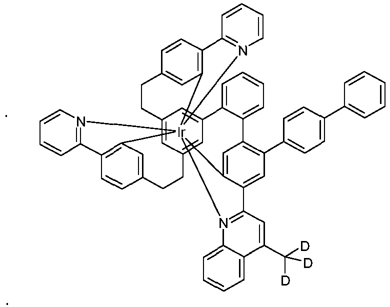 | 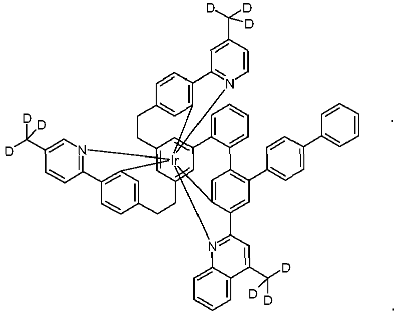 |
| 75 | 76 |
| 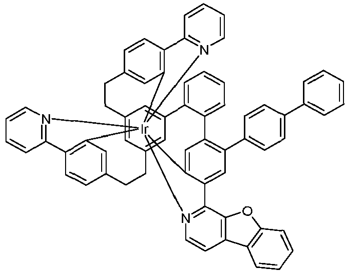 | 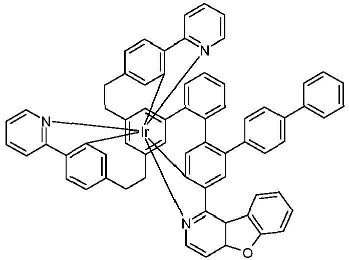 |
| 77 | 78 |
| 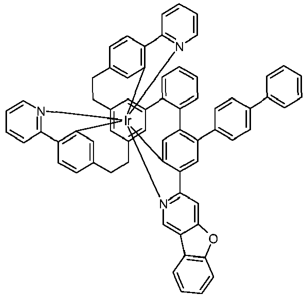 | 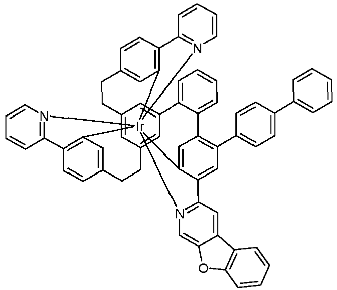 |
| 79 | 80 |
| 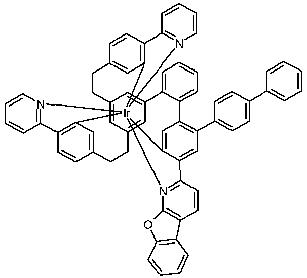 | 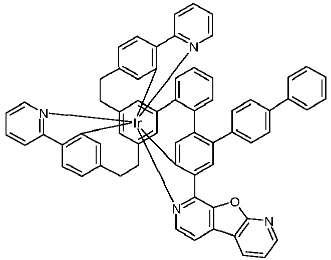 |
| 81 | 82 |
| 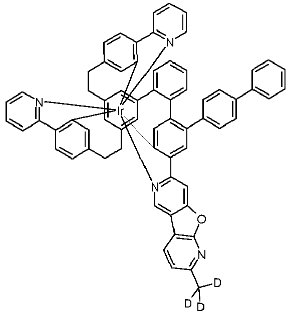 | 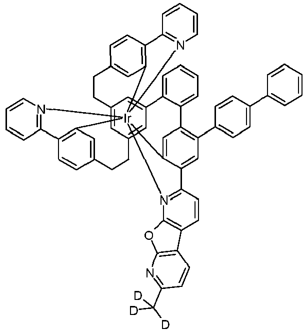 |
| 83 | 84 |
| 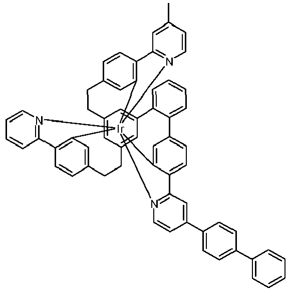 | 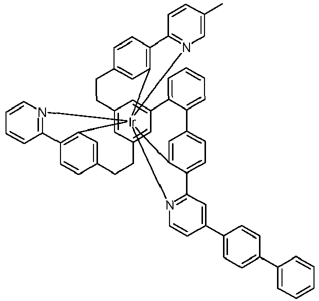 |
| 84 | 86 |
| 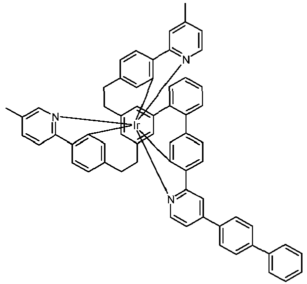 | 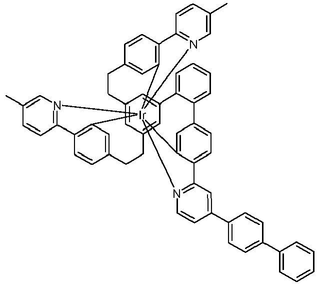 |
| 87 | 88 |
| 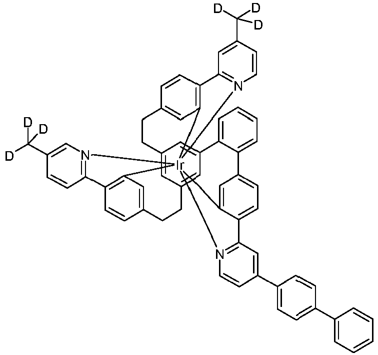 | 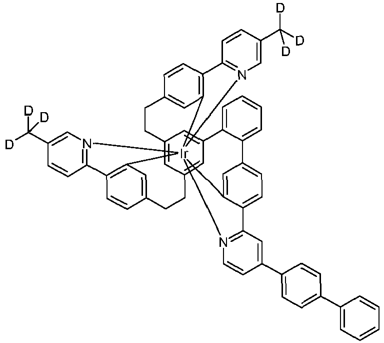 |
| 89 | 90 |
| 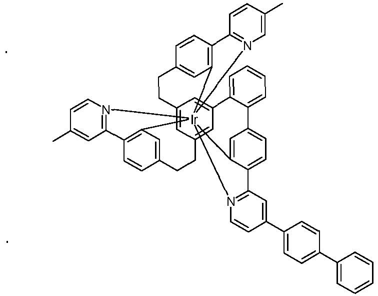 | 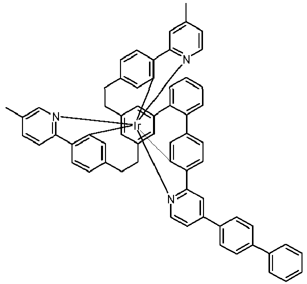 |
| 91 | 92 |
| 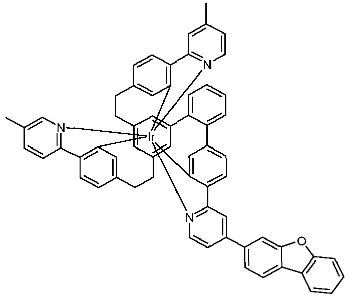 | 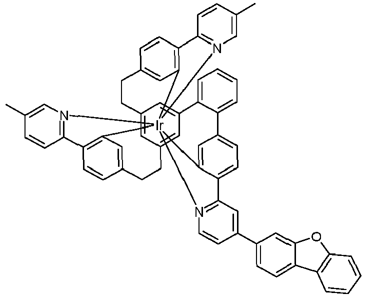 |
| 93 | 94 |
| 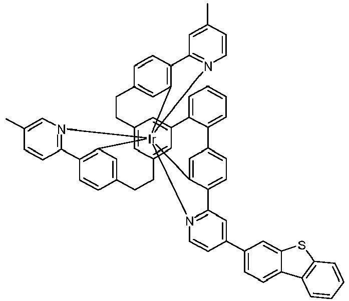 | 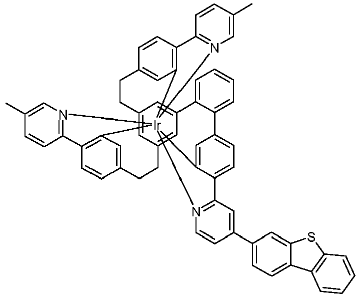 |
| 95 | 96 |
| 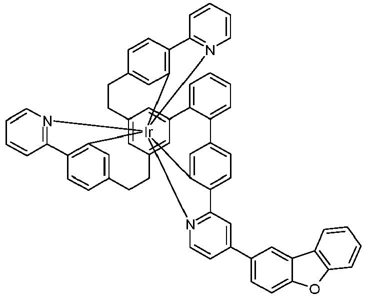 | 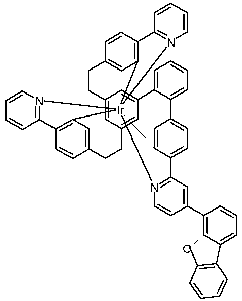 |
| 97 | 98 |
| 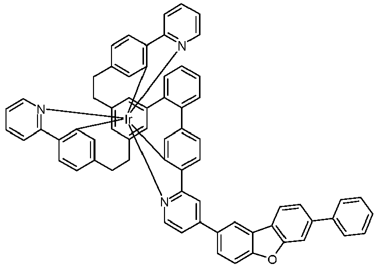 | 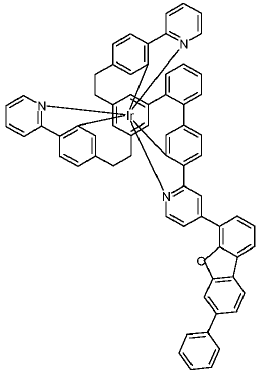 |
| 99 | 100 |
| 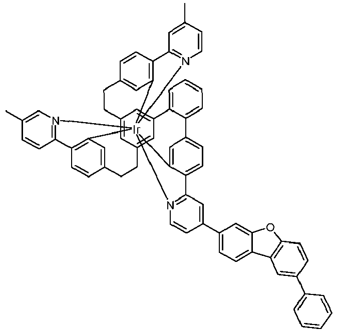 | 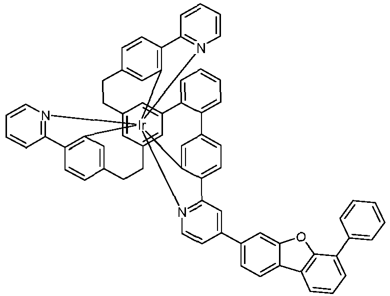 |
| 101 | 102 |
| 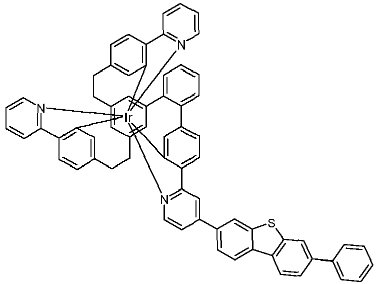 | 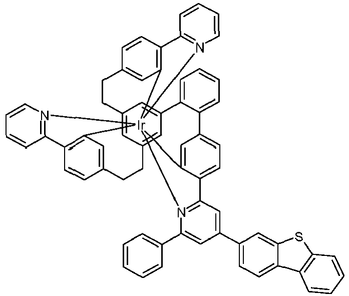 |
| 103 | 104 |
| 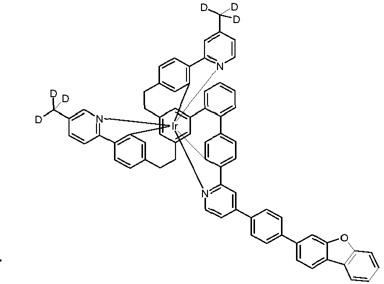 | 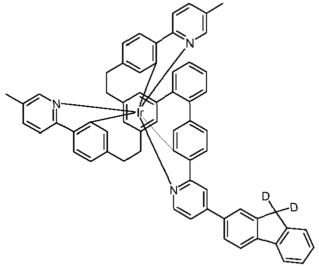 |
| 105 | 106 |
| 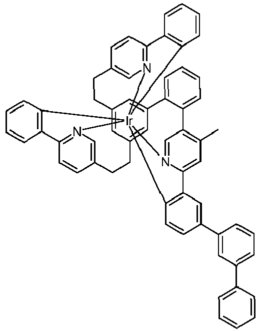 | 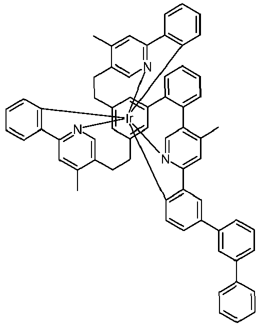 |
| 107 | 108 |
| 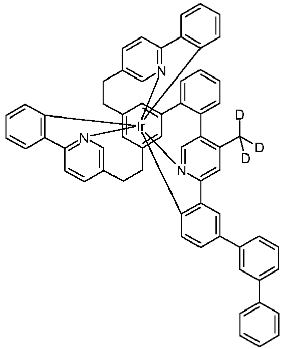 | 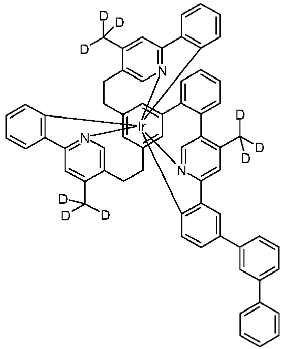 |
| 109 | 110 |
| 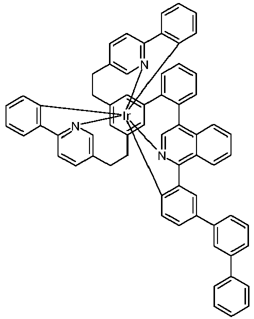 | 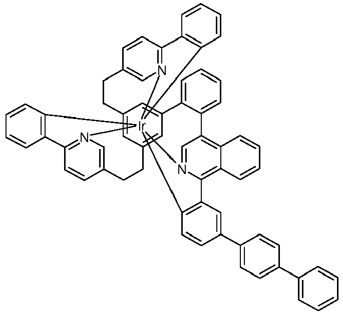 |
| 111 | 112 |
| 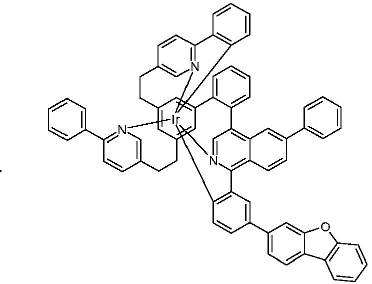 | 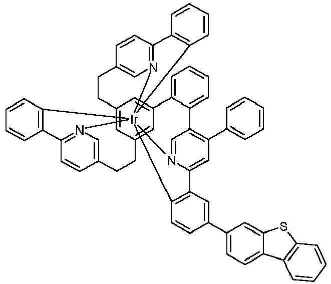 |
| 113 | 114 |
| 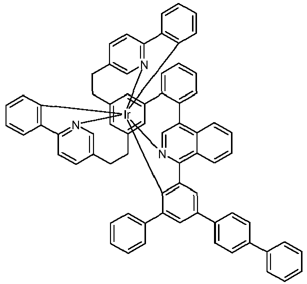 | 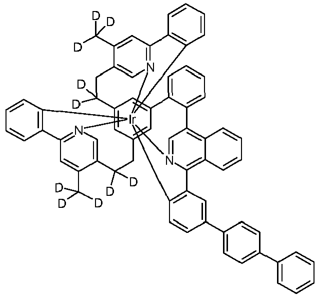 |
| 115 | 116 |
| 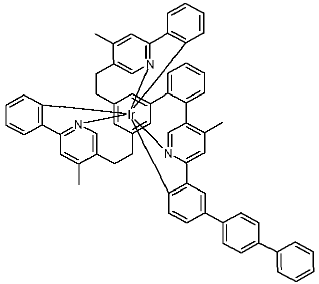 | 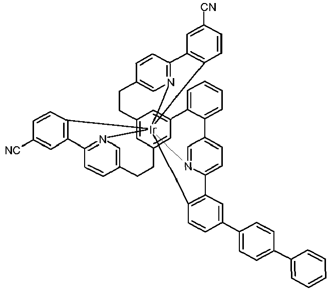 |
| 117 | 118 |
| 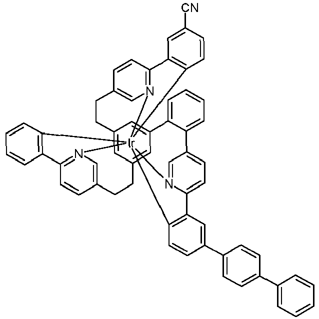 | 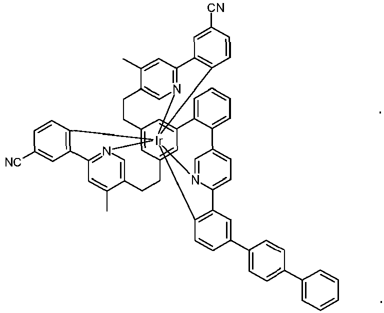 |
| 119 | 120 |
| 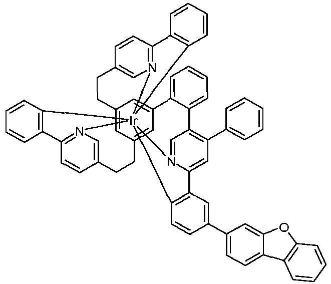 | 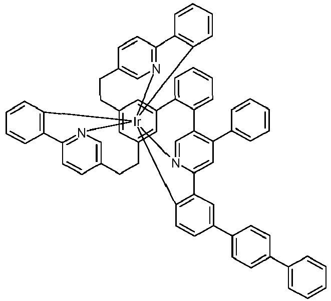 |
| 121 | 122 |
| 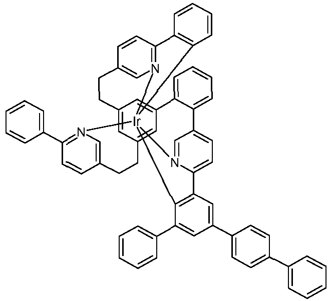 | 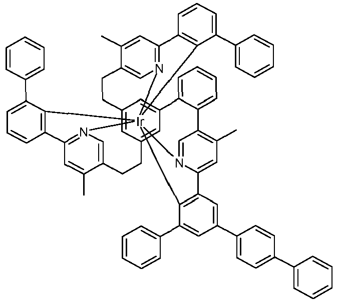 |
| 123 | 124 |
| 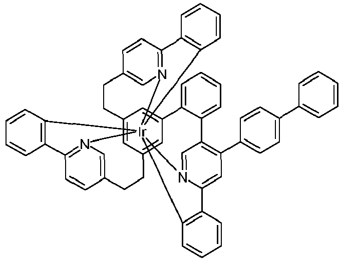 | 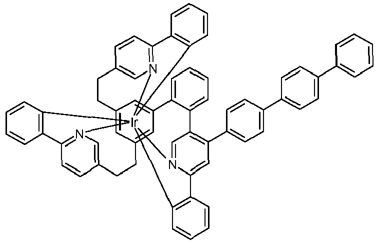 |
| 125 | 126 |
| 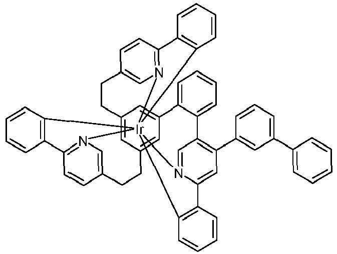 | 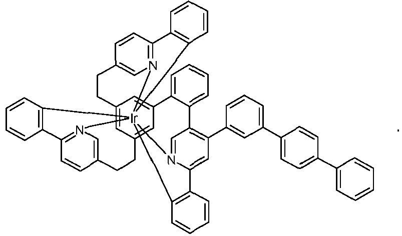 |
| 127 | 128 |
| 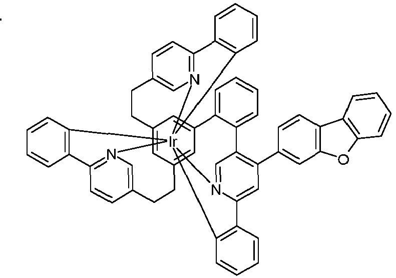 | 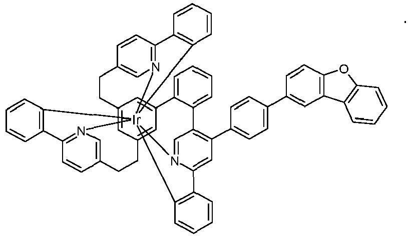 |
| 129 | 130 |
| 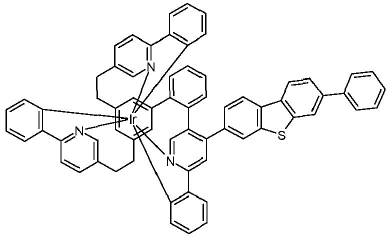 | 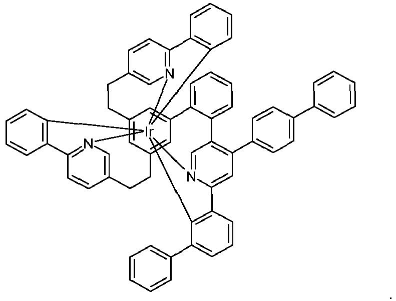 |
| 131 | 132 |
| 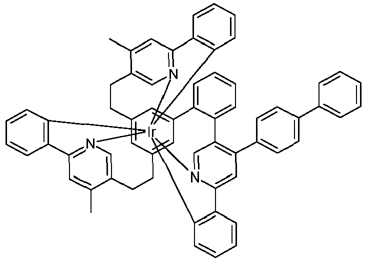 | 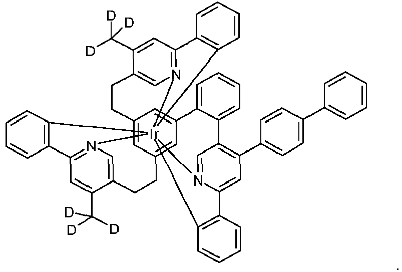 |
| 133 | 134 |
| 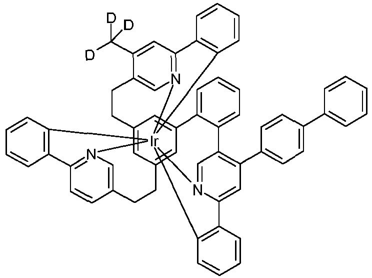 | 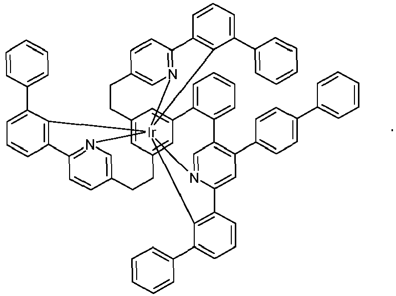 |
| 135 | 136 |
| 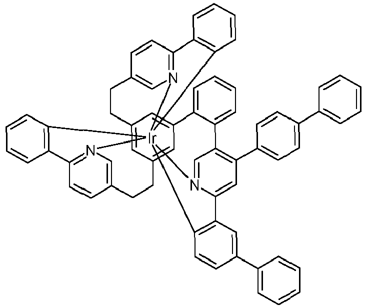 | 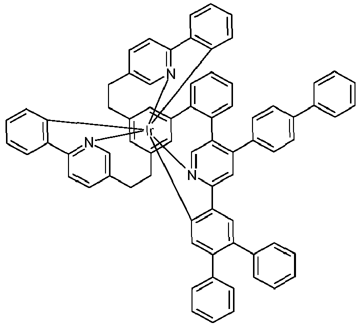 |
| 137 | 138 |
| 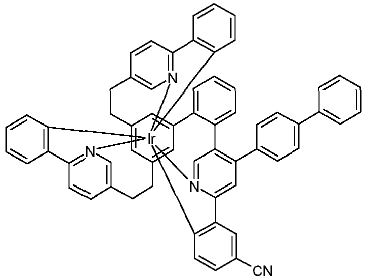 | 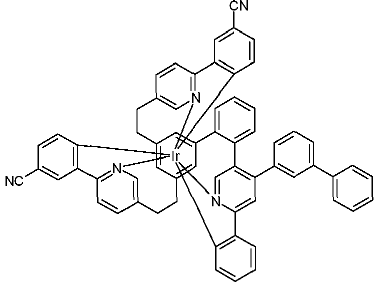 |
| 139 | 140 |
| 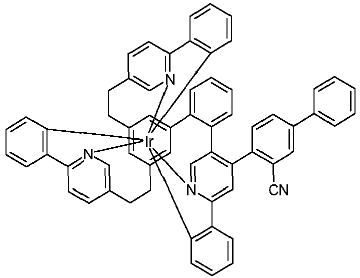 | 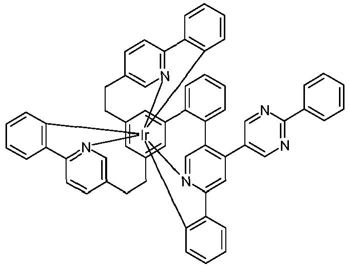 |
| 141 | 142 |
| 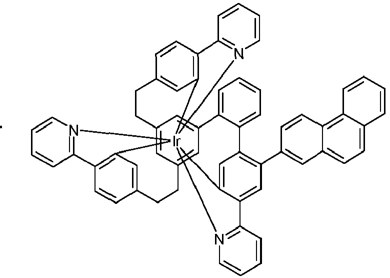 | 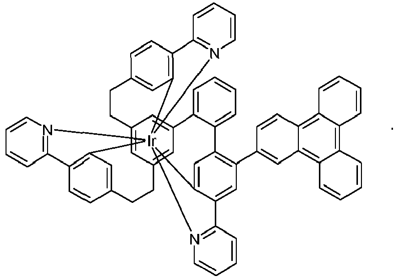 |
| 143 | 144 |
| 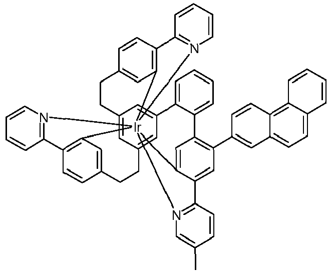 | 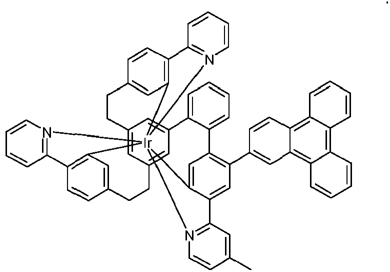 |
| 145 | 146 |
| 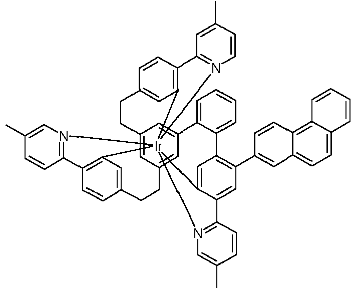 | 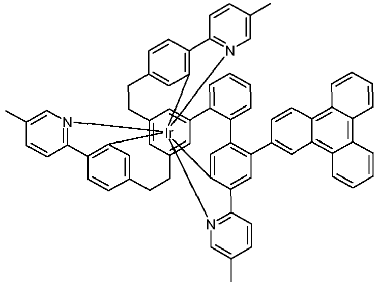 |
| 147 | 148 |
| 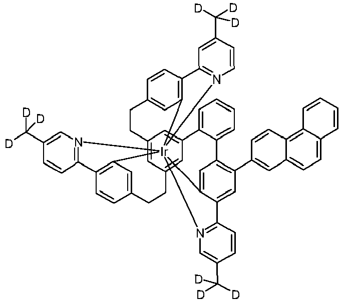 | 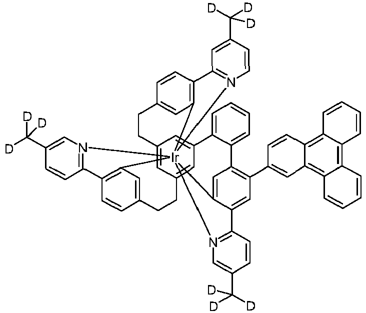 |
| 149 | 150 |
| 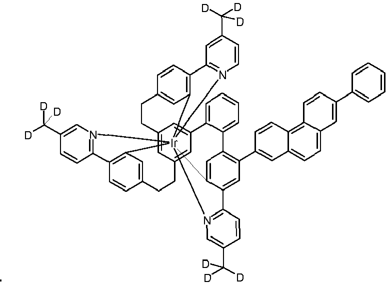 | 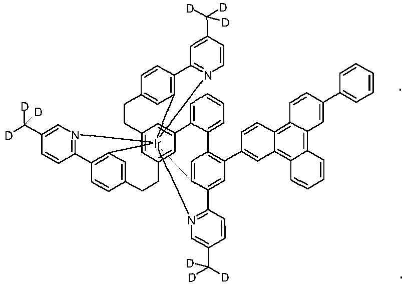 |
| 151 | 152 |
| 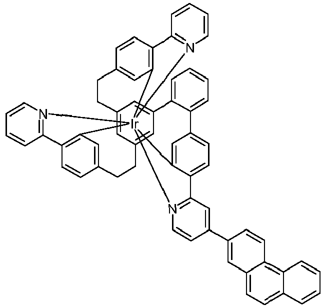 | 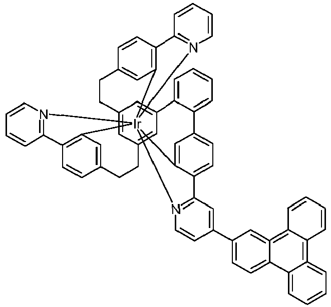 |
| 153 | 154 |
| 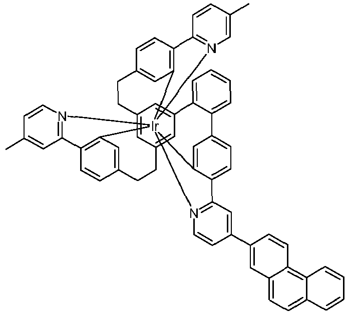 | 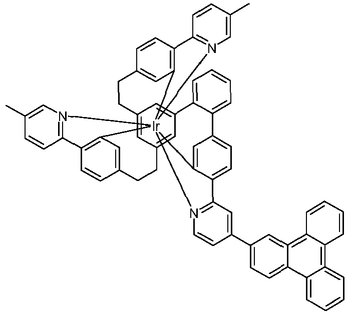 |
| 155 | 156 |
| 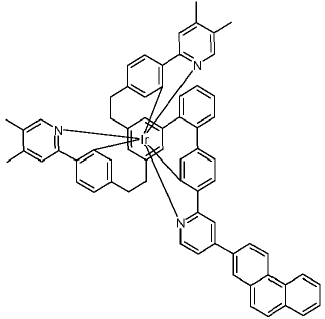 | 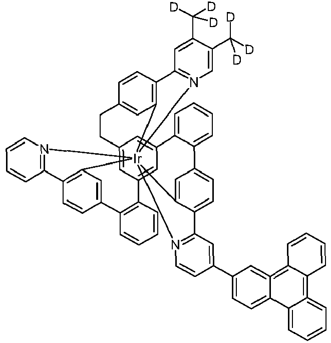 |
| 157 | 158 |
| 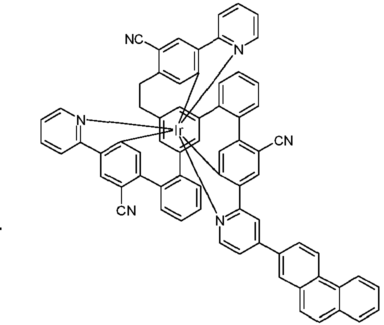 | 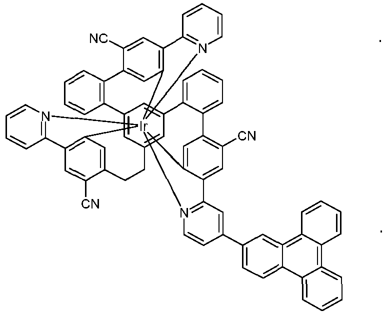 |
| 159 | 160 |
| 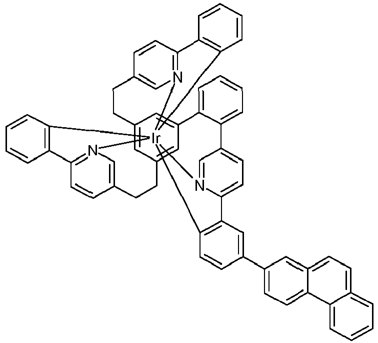 | 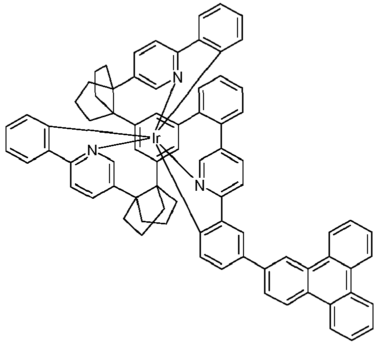 |
| 161 | 162 |
| 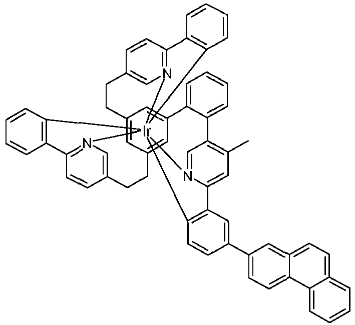 | 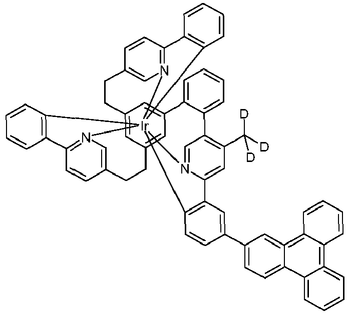 |
| 163 | 164 |
| 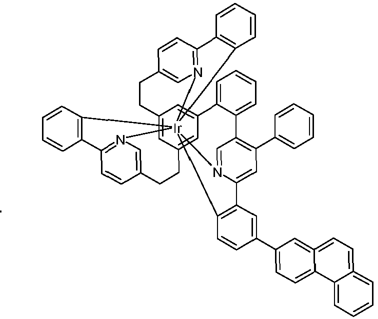 | 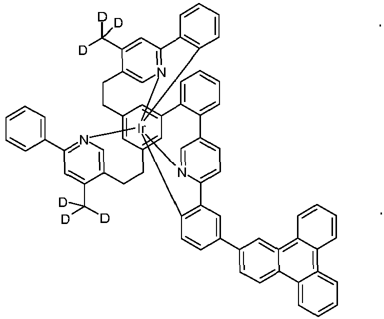 |
| 165 | 166 |
| 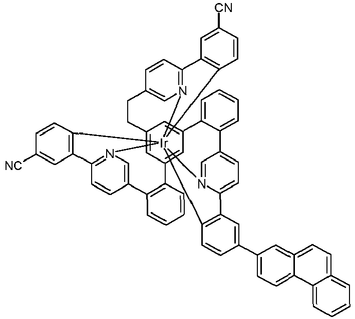 | 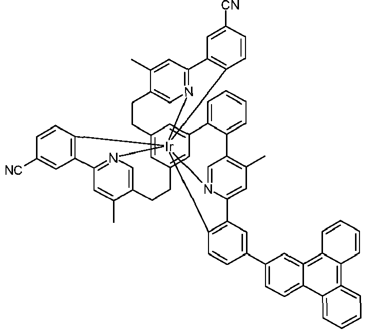 |
| 167 | 168 |
| 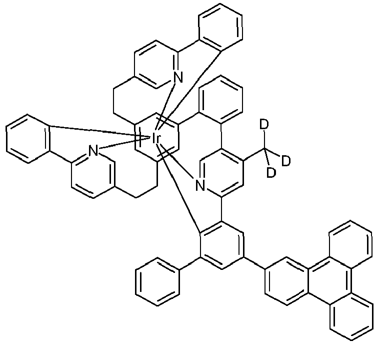 | 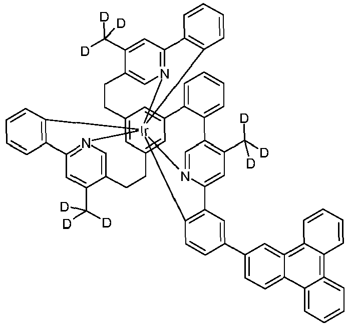 |
| 169 | 170 |
| 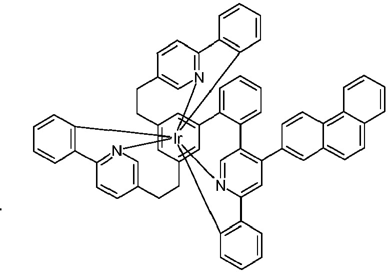 | 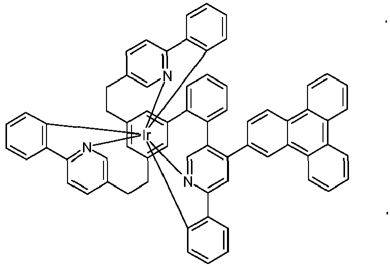 |
| 171 | 172 |
| 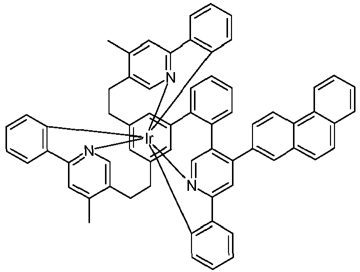 | 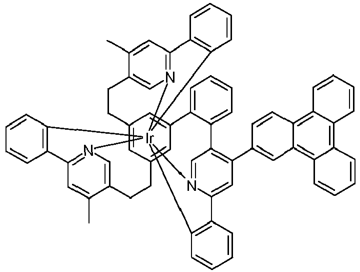 |
| 173 | 174 |
| 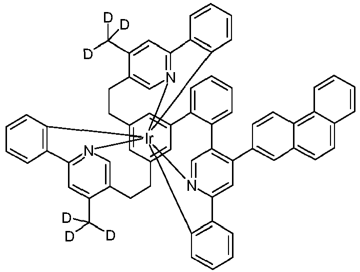 | 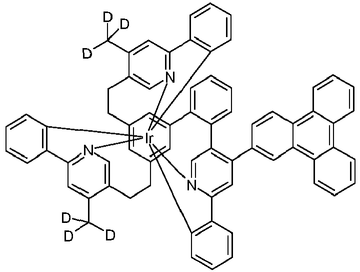 |
| 175 | 176 |
| 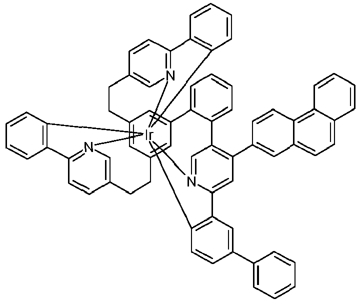 | 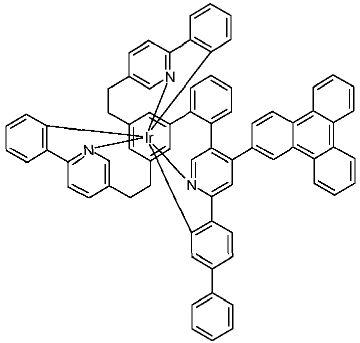 |
| 177 | 178 |
| 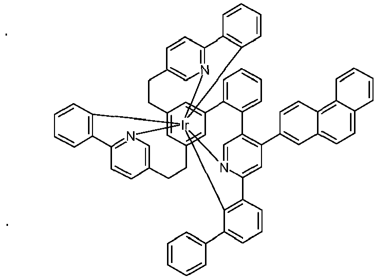 | 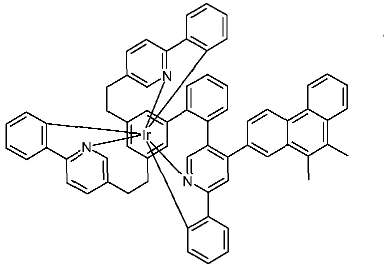 |
| 179 | 180 |
| 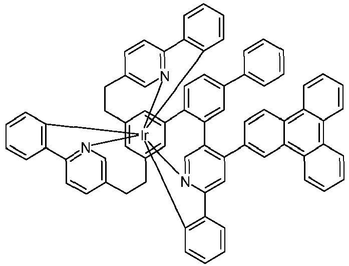 | 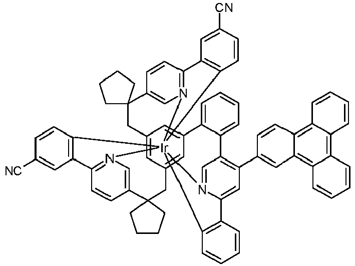 |
| 181 | 182 |
| 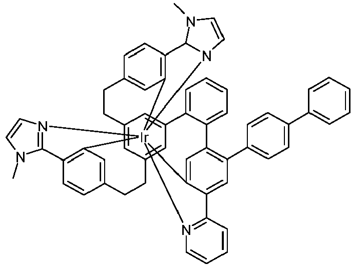 | 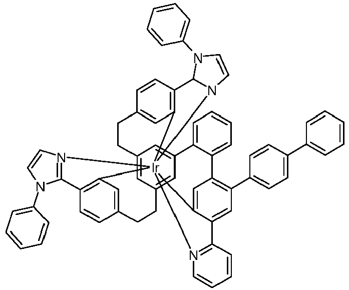 |
| 183 | 184 |
| 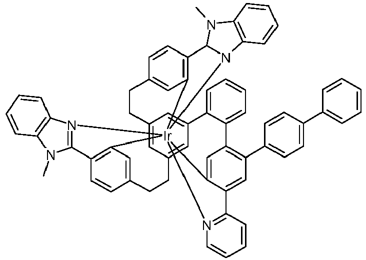 | 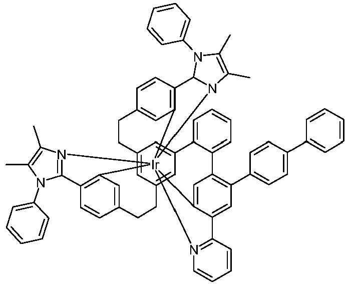 |
| 185 | 186 |
| 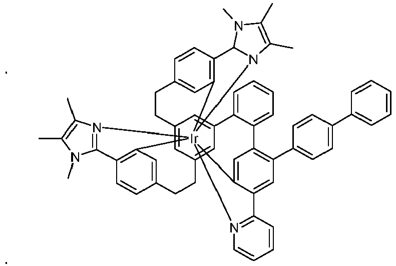 | 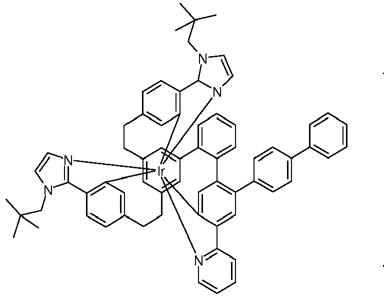 |
| 187 | 188 |
| 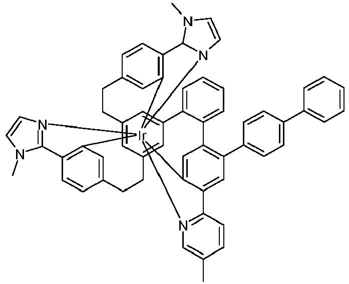 | 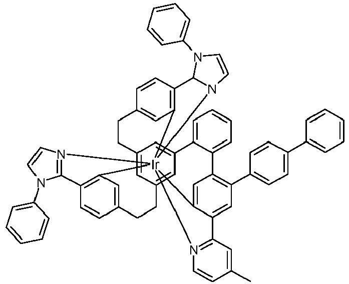 |
| 189 | 190 |
| 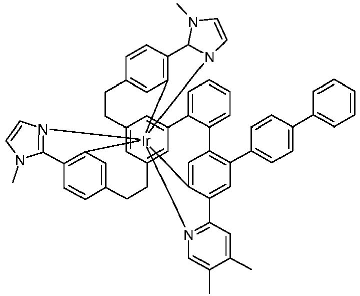 | 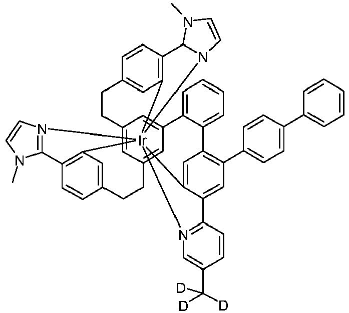 |
| 192 | 192 |
| 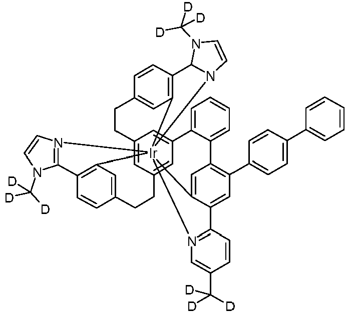 | 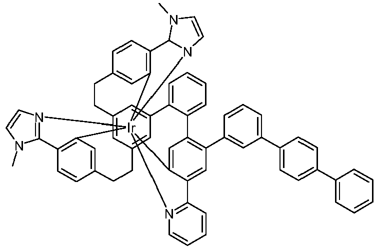 |
| 193 | 194 |
| 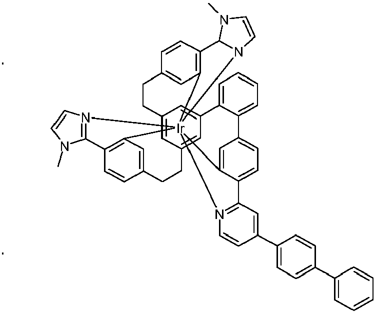 | 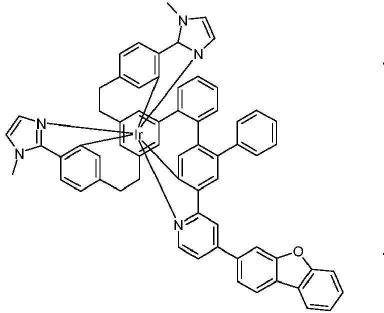 |
| 194 | 196 |
| 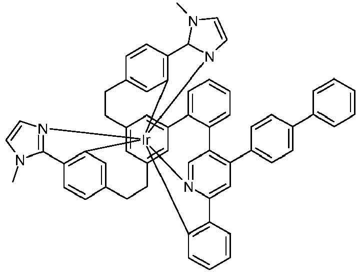 | 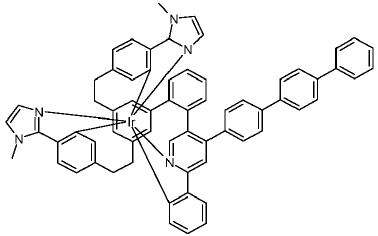 |
| 197 | 198 |
| 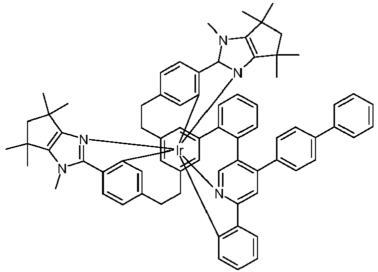 | 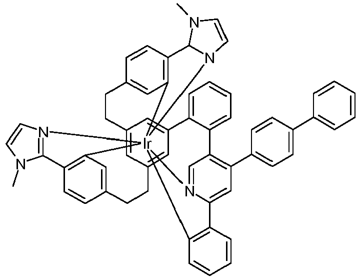 |
| 199 | 200 |
| 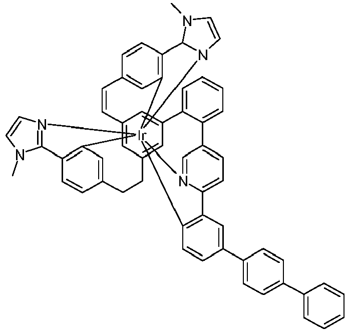 | 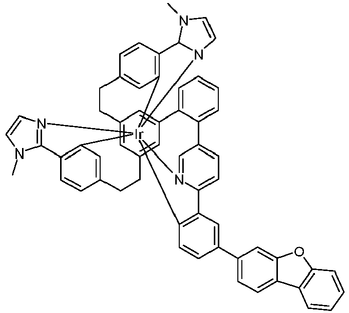 |
| 201 | 202 |
| 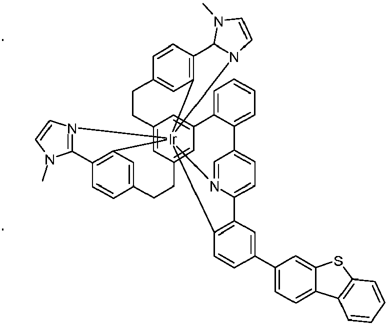 | 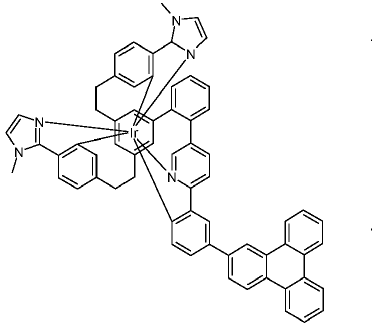 |
| 203 | 204 |
| 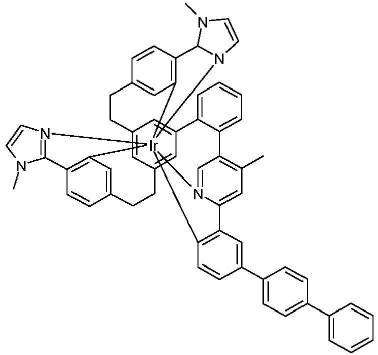 | 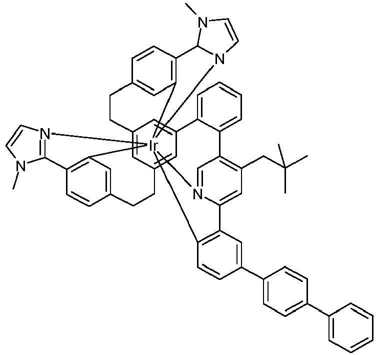 |
| 205 | 206 |
| 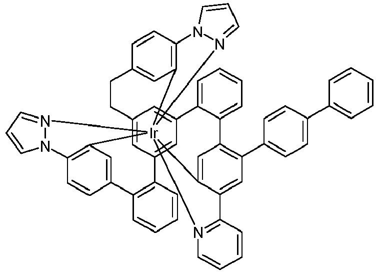 | 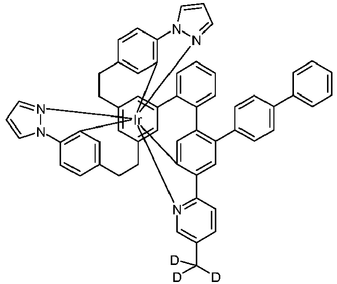 |
| 207 | 208 |
| 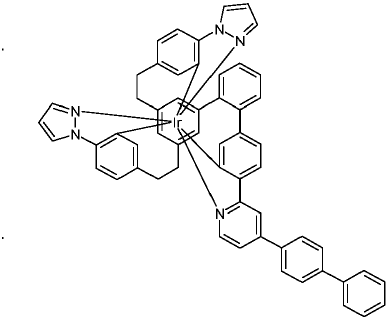 | 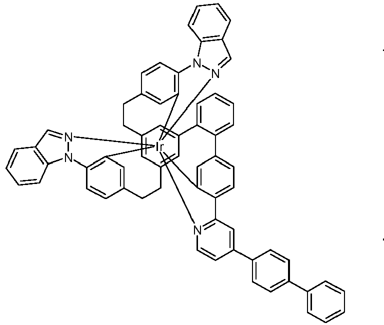 |
| 209 | 210 |
| 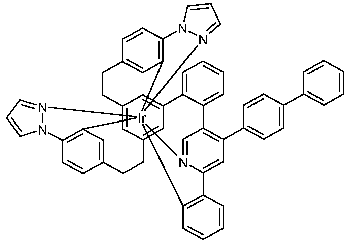 | |
| 211 | |
| 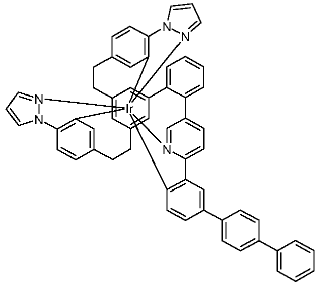 | 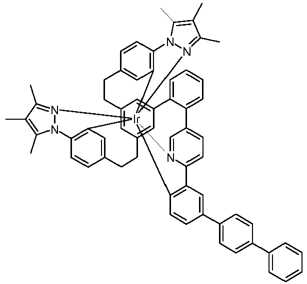 |
| 213 | 214 |
| 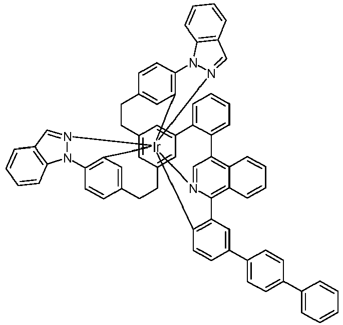 | 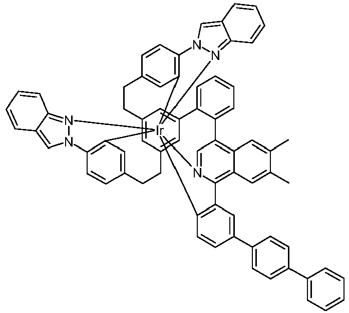 |
| 215 | 216 |
| 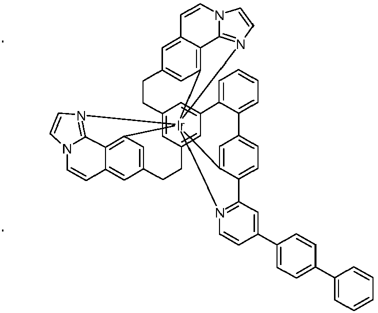 | 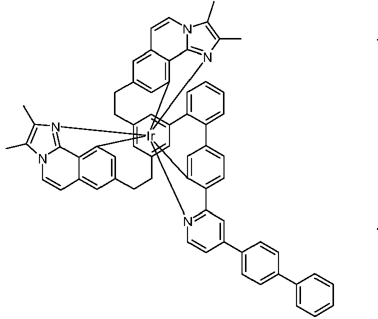 |
| 217 | 218 |
| 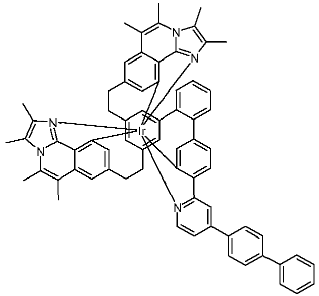 | 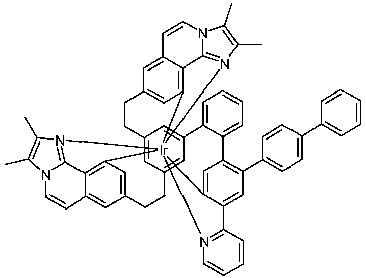 |
| 219 | 220 |
| 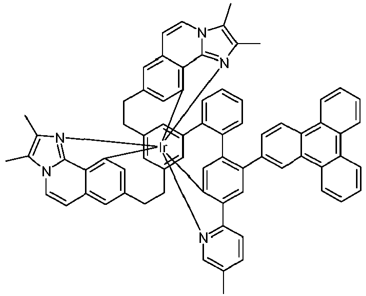 | 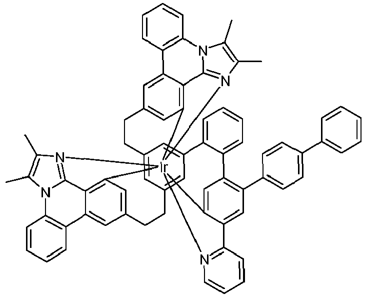 |
| 221 | 222 |
| 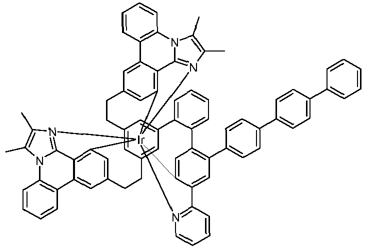 | 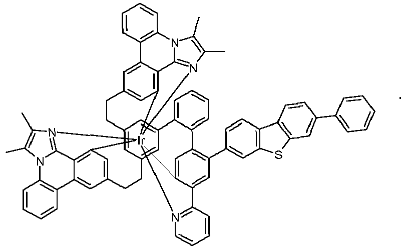 |
| 223 | 224 |
| 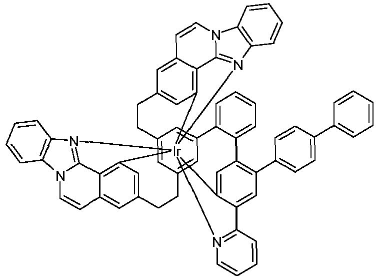 | 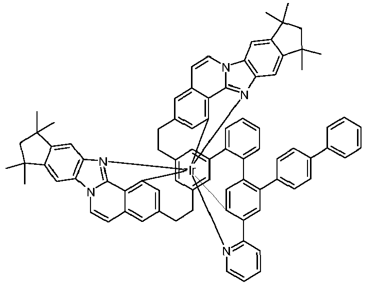 |
| 225 | 226 |
| 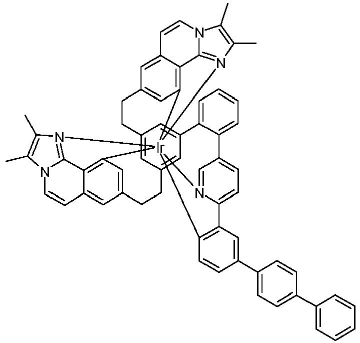 | 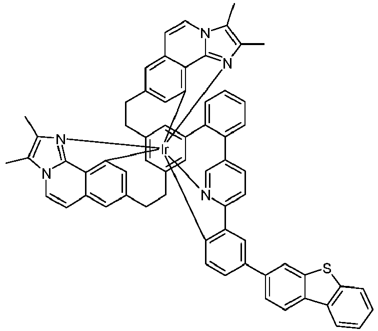 |
| 227 | 228 |
| 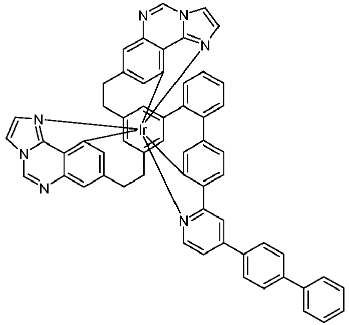 | 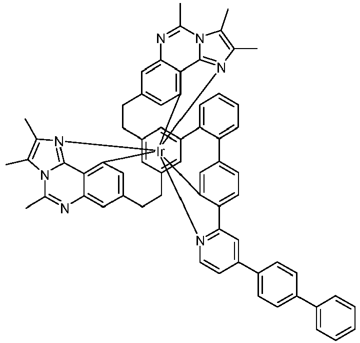 |
| 229 | 230 |
| 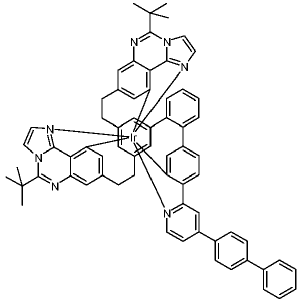 | 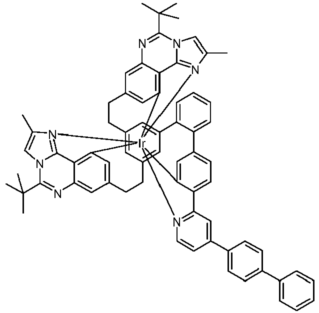 |
| 231 | 232 |
| 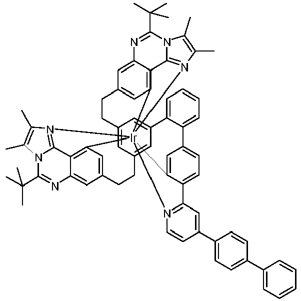 | 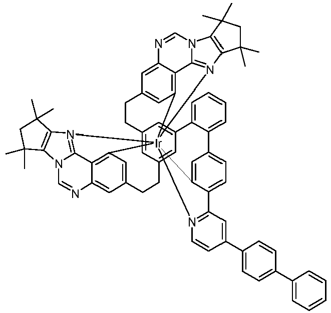 |
| 233 | 234 |
| 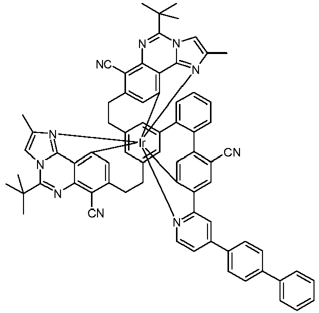 | 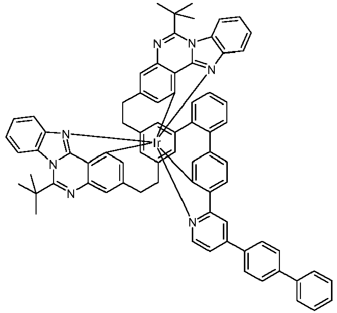 |
| 235 | 236 |
| 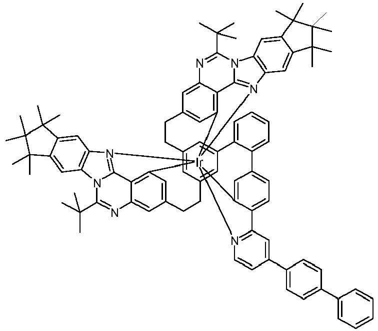 | 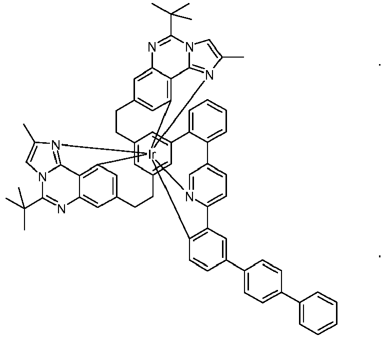 |
| 237 | 238 |
| 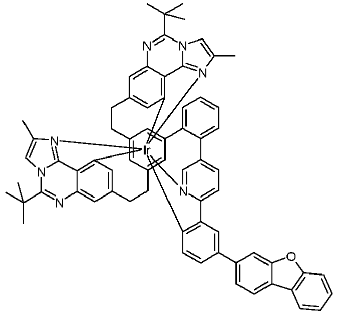 | 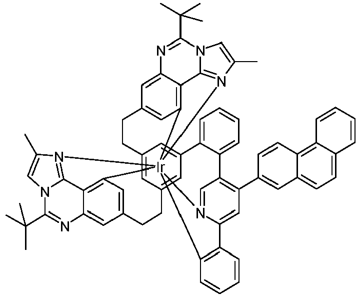 |
| 239 | 240 |
| 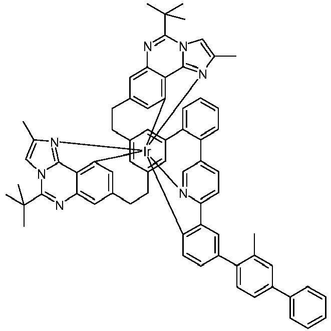 | 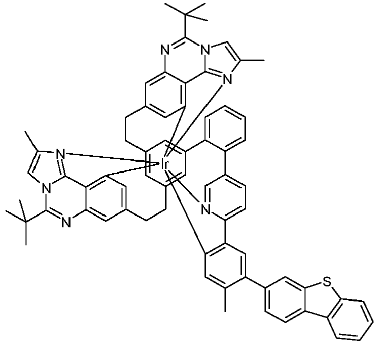 |
| 241 | 242 |
| 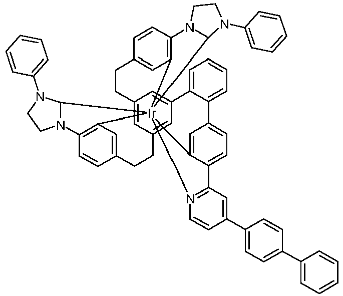 | 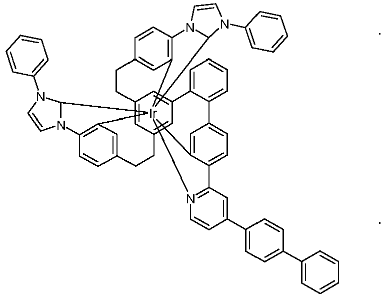 |
| 243 | 244 |
| 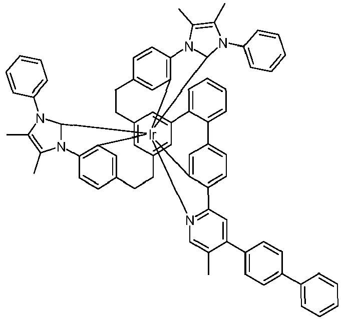 | |
| 245 | |
| 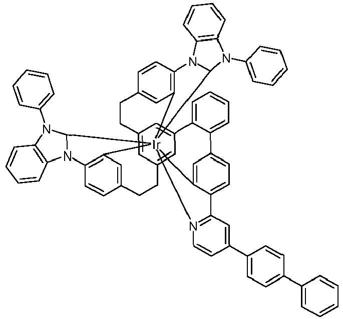 | 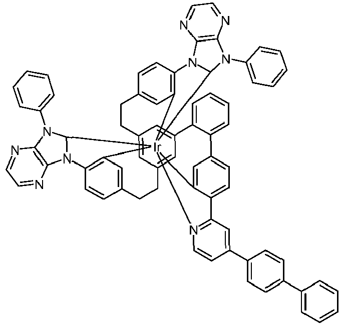 |
| 247 | 248 |
| 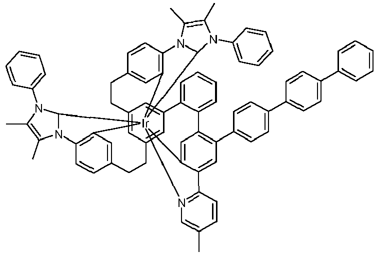 | 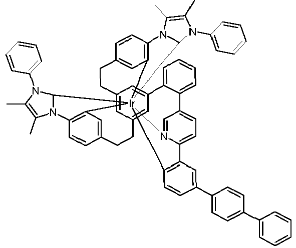 |
| 249 | 250 |
| 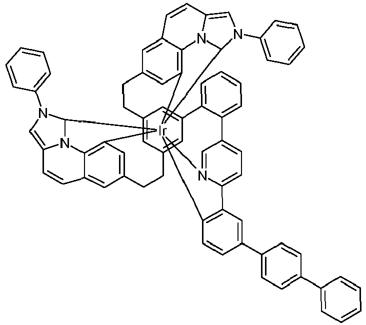 | 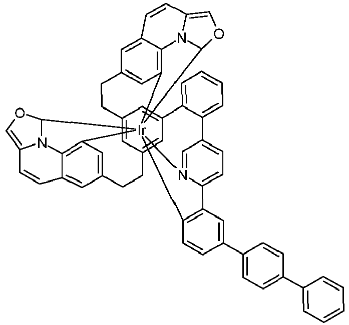 |
| 251 | 252 |
| 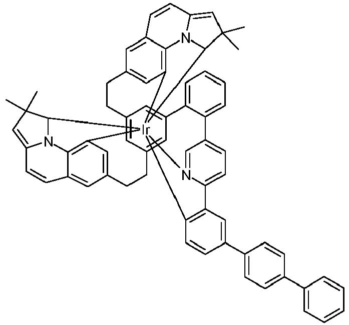 | 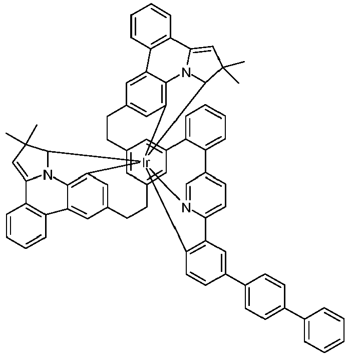 |
| 253 | 254 |
| 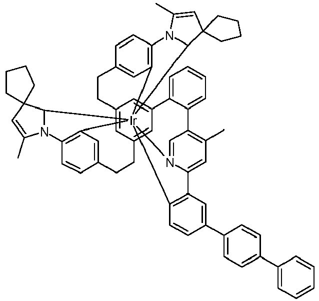 | 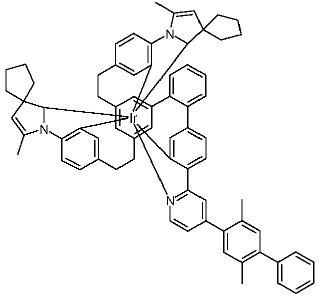 |
| 255 | 256 |
| 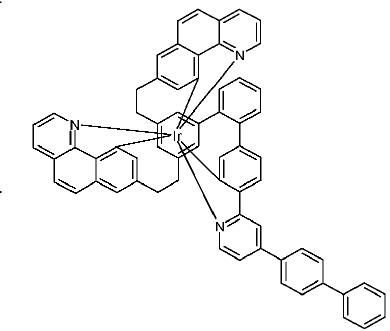 | 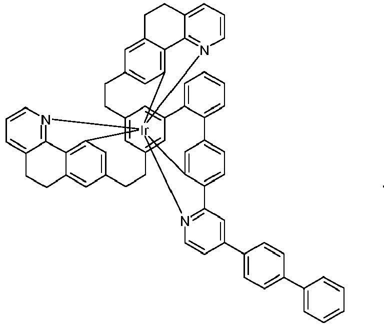 |
| 257 | 258 |
| 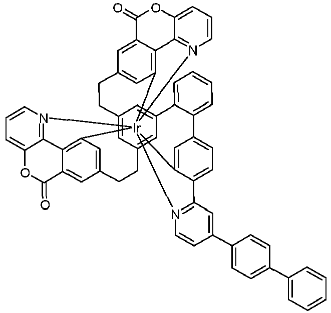 | 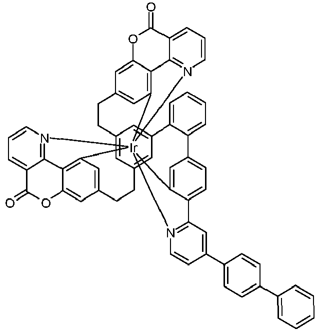 |
| 259 | 260 |
| 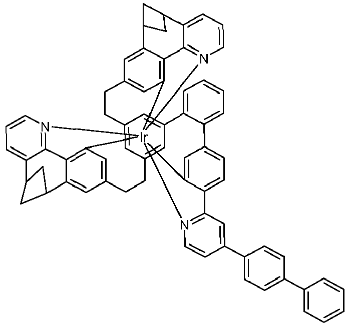 | 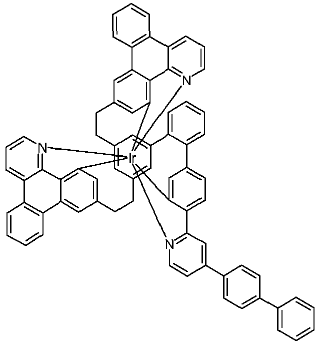 |
| 261 | 262 |
| 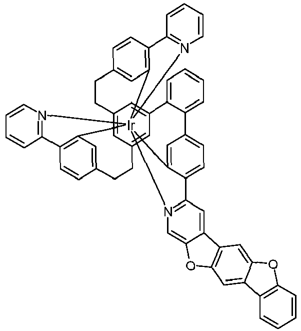 | 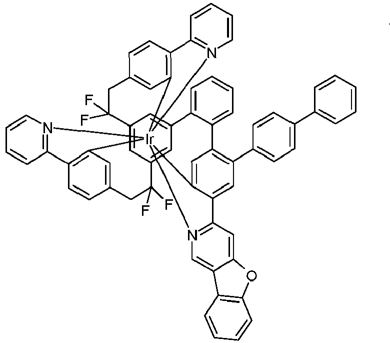 |
| 263 | 264 |
| 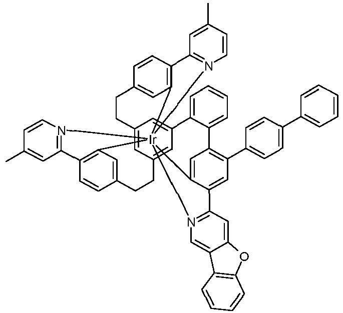 | 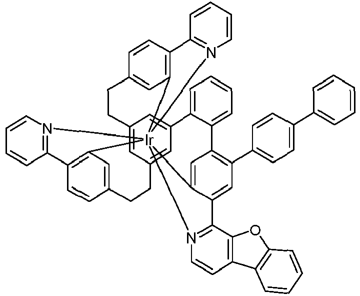 |
| 265 | 266 |
| 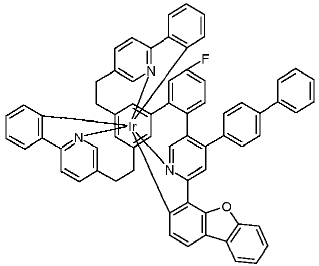 | 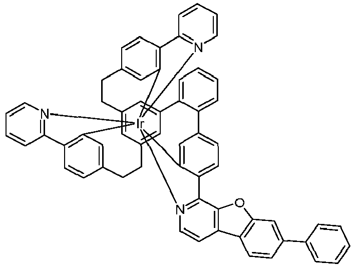 |
| 267 | 268 |
| 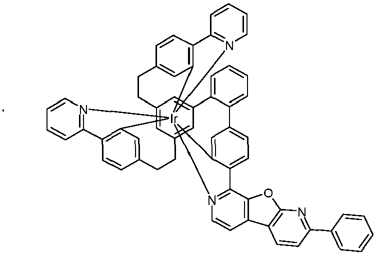 | 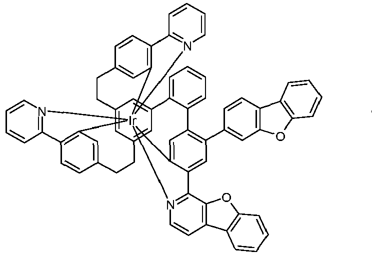 |
| 269 | 270 |
| 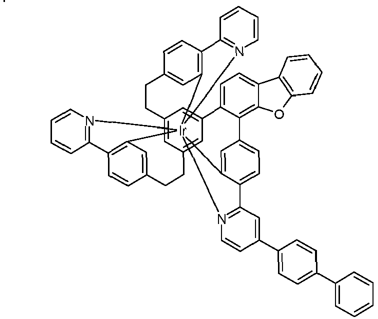 | 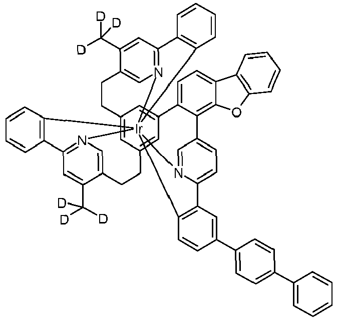 |
| 271 | 272 |
| 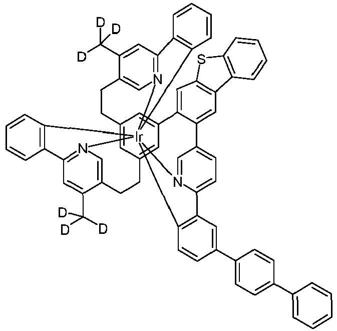 | 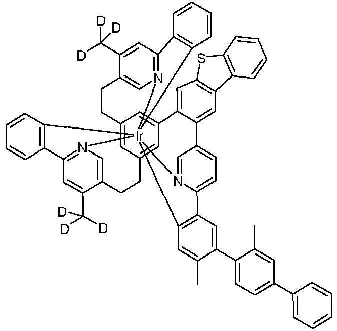 |
| 973 | 274 |
| 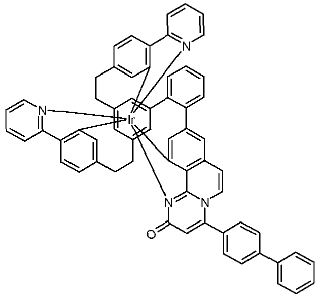 | 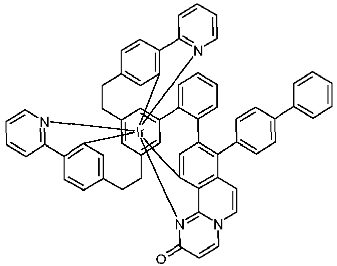 |
| 275 | 276 |
| 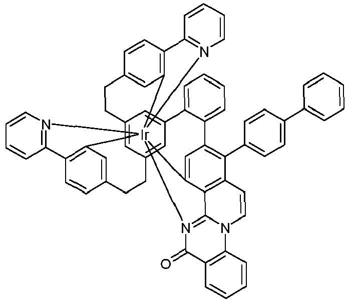 | 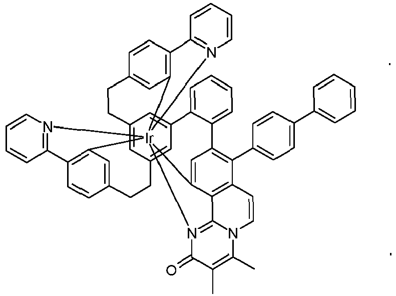 |
| 277 | 278 |
| 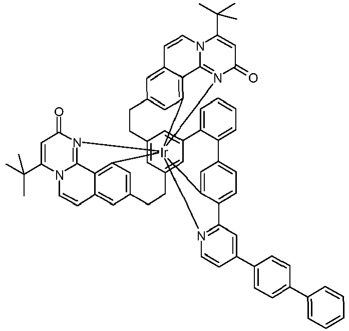 | 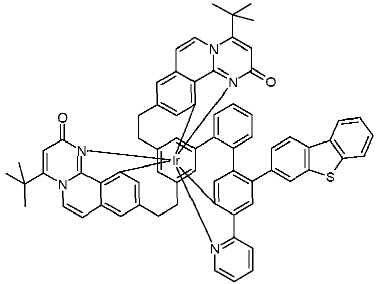 |
| 279 | 280 |
| 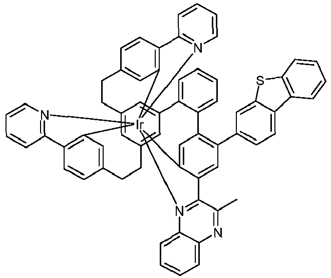 | 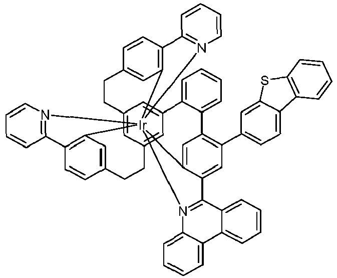 |
| 281 | 282 |
| 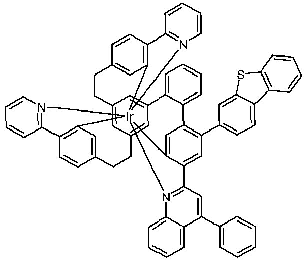 | 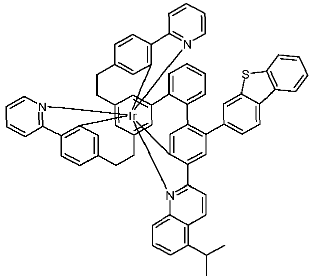 |
| 283 | 284 |
| 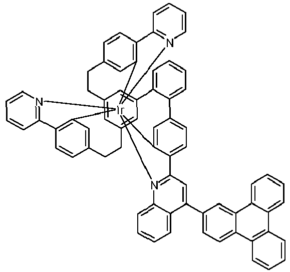 | 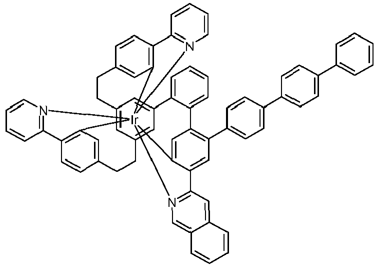 |
| 285 | 286 |
| 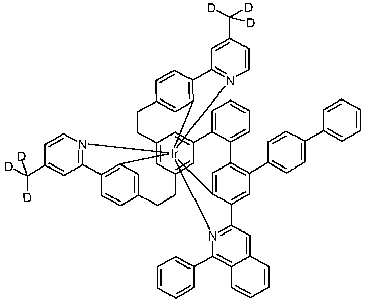 | 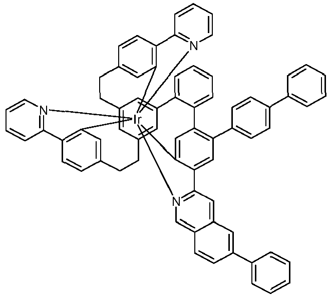 |
| 287 | 288 |
| 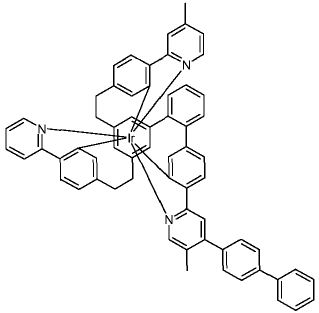 | 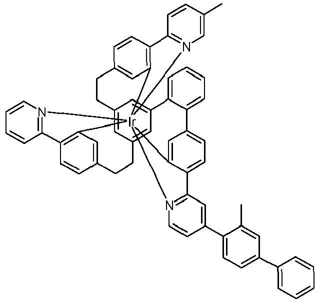 |
| 289 | 290 |
| 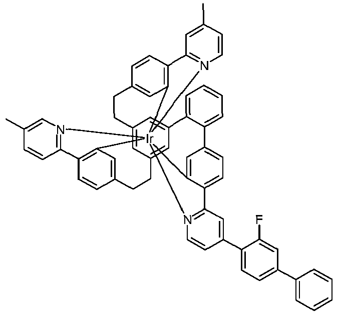 | 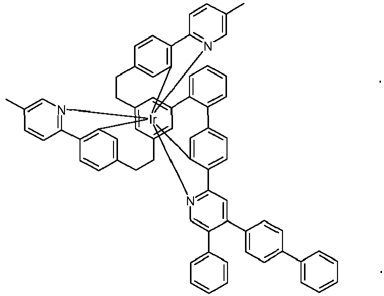 |
| 291 | 292 |
| 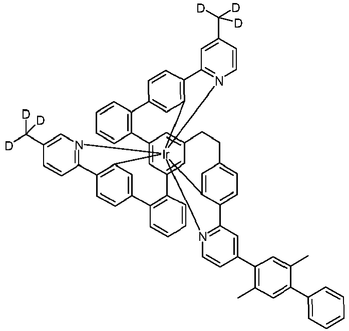 | 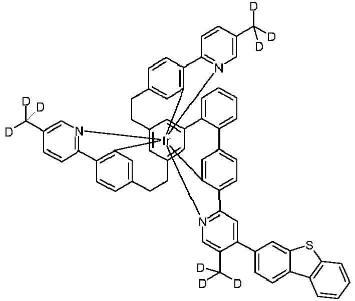 |
| 293 | 294 |
| 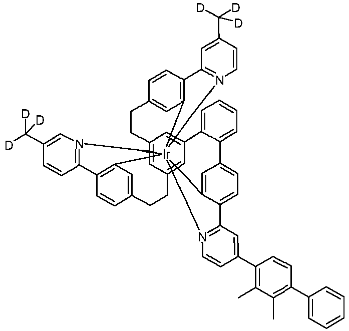 | 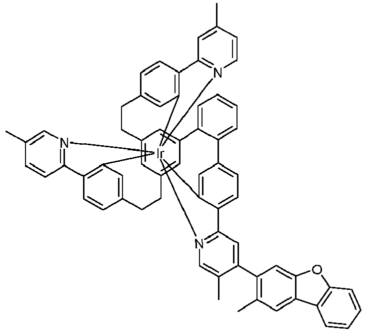 |
| 295 | 296 |
| 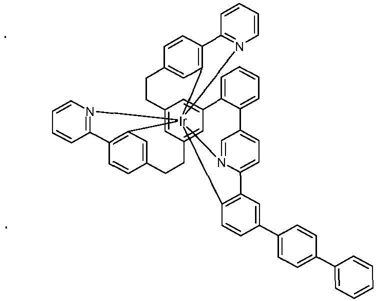 | |
| 297 | |
| 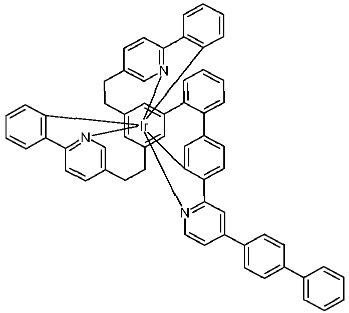 | 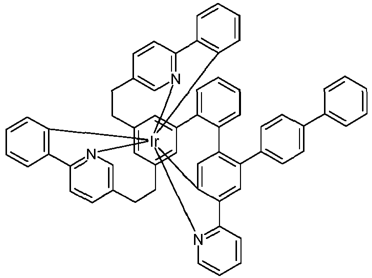 |
| 299 | 300 |
| 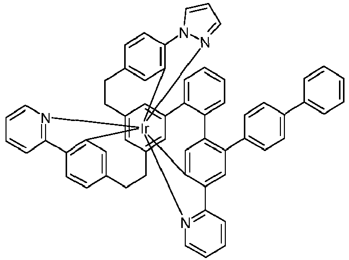 | 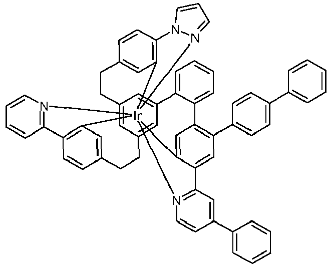 |
| 301 | 302 |
| 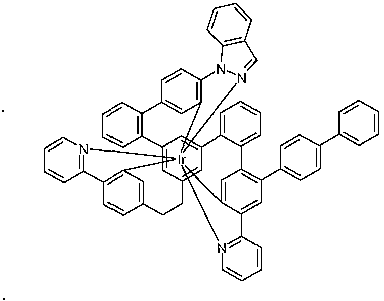 | 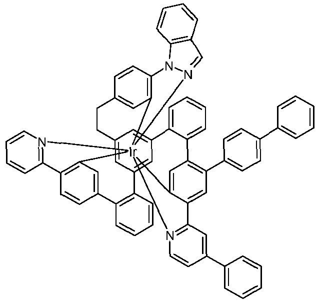 |
| 303 | 304 |
| 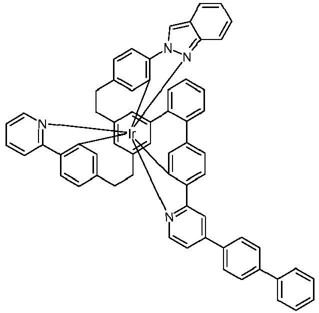 | 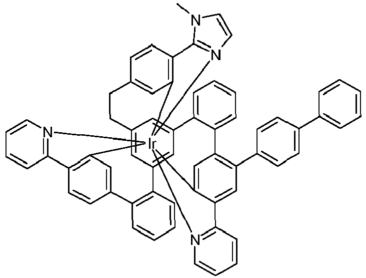 |
| 305 | 306 |
| 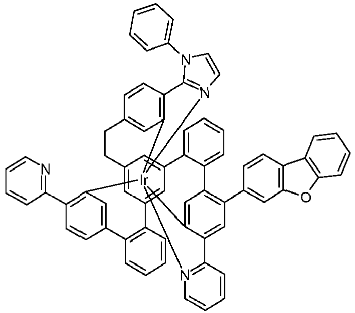 | 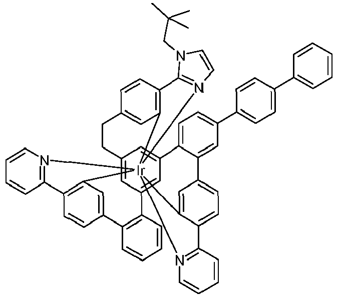 |
| 307 | 308 |
| 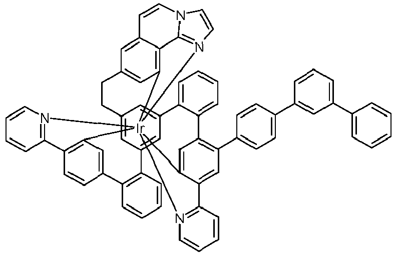 | 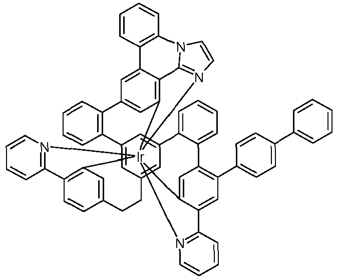 |
| 309 | 310 |
| 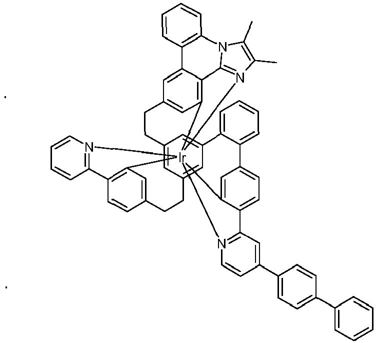 | 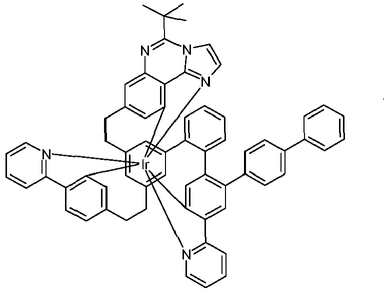 |
| 311 | 312 |
| 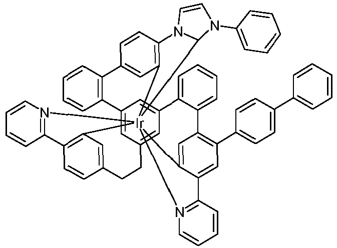 | 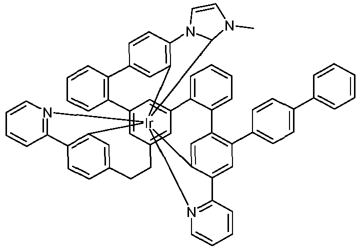 |
| 313 | 314 |
| 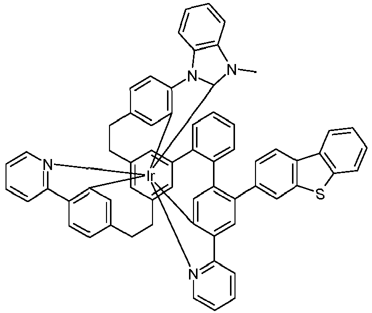 | 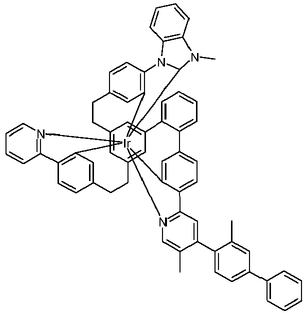 |
| 315 | 316 |
| 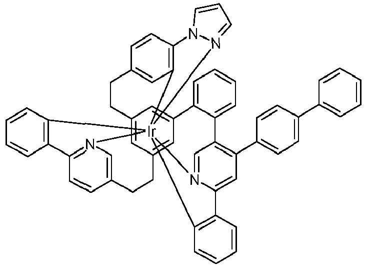 | 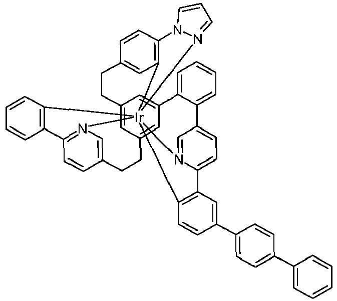 |
| 317 | 318 |
| 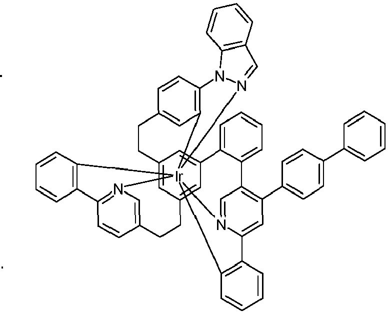 | 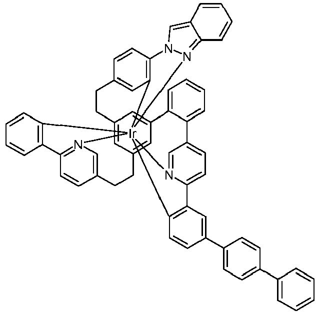 |
| 319 | 320 |
| 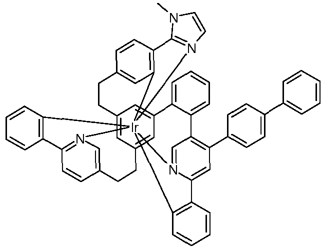 | 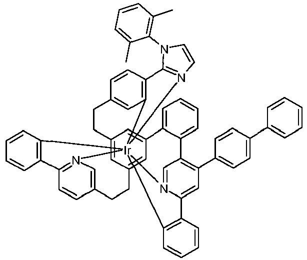 |
| 321 | 322 |
| 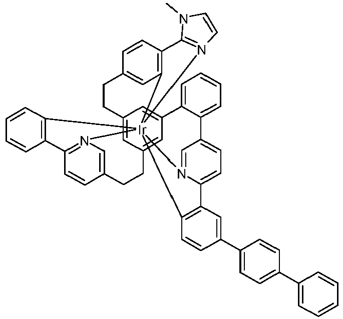 | 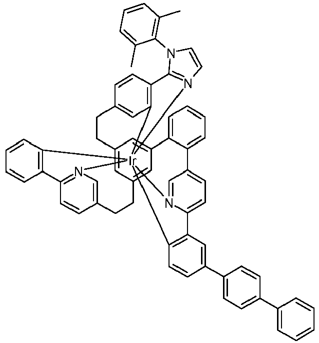 |
| 323 | 324 |
| 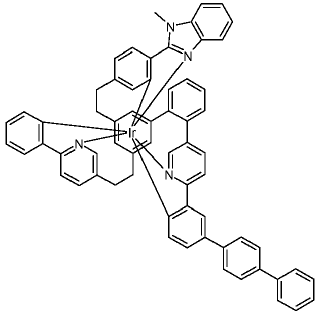 | 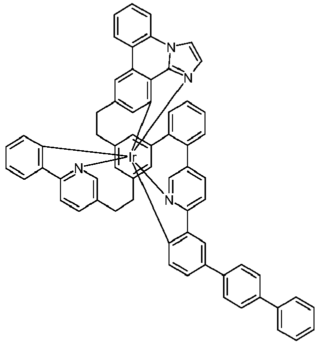 |
| 325 | 326 |
| 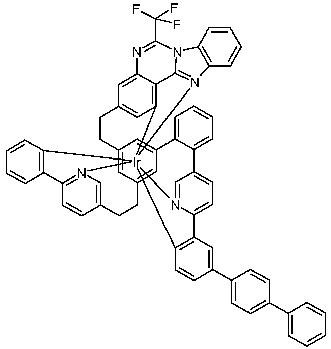 | 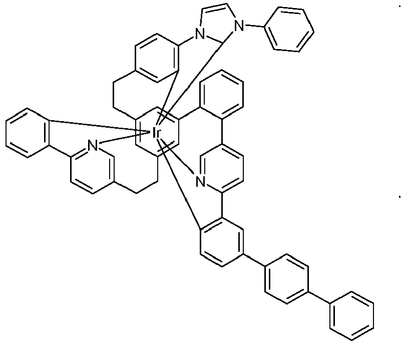 |
| 327 | 328 |
| 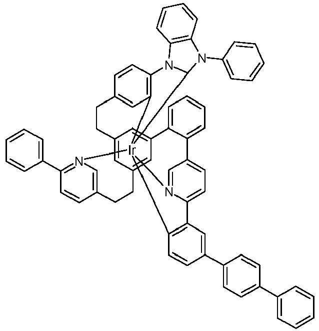 | 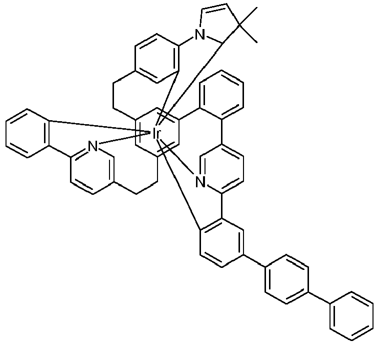 |
| 329 | 330 |
| 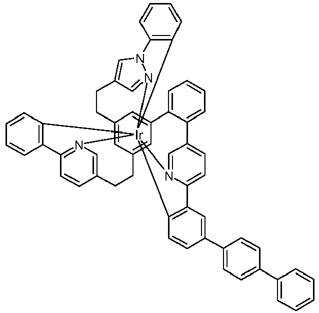 | 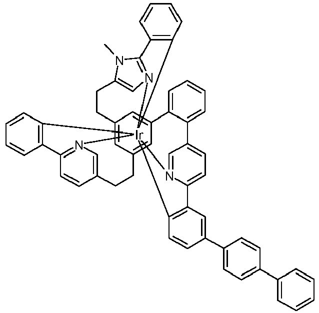 |
| 331 | 332 |
| 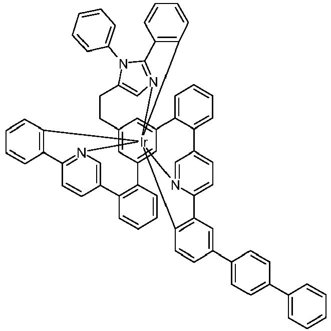 | 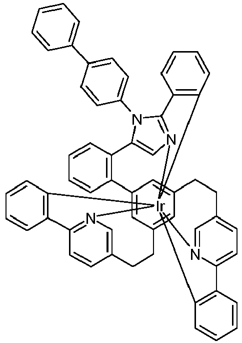 |
| 333 | 334 |
| 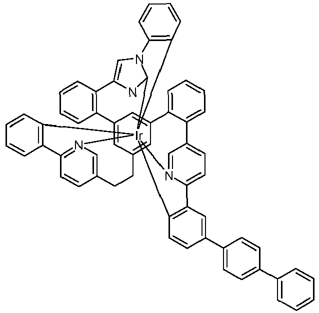 | 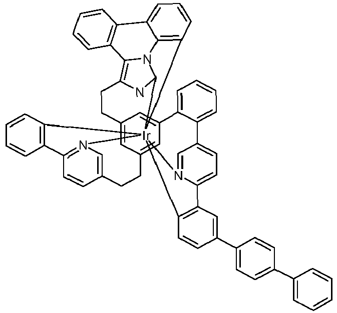 |
| 335 | 336 |
| 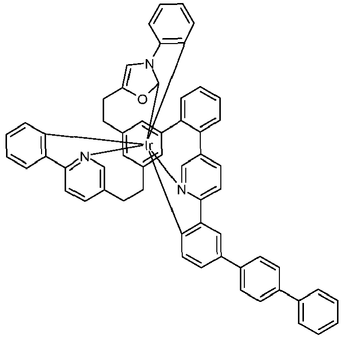 | 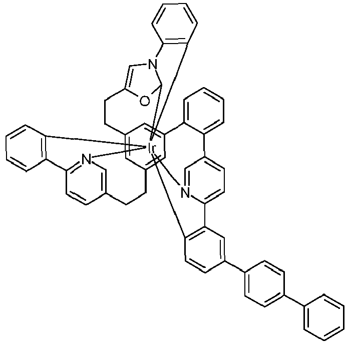 |
| 337 | 338 |
| 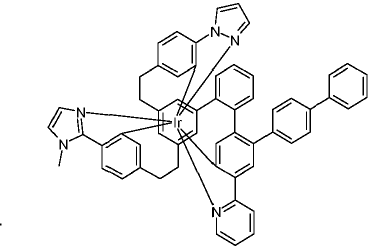 | 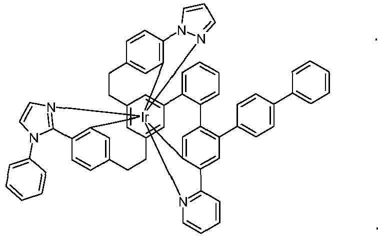 |
| 339 | 340 |
| 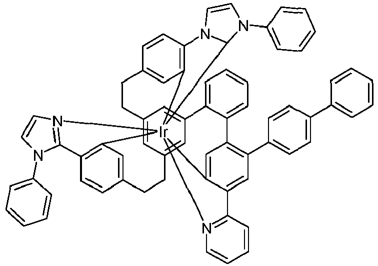 | 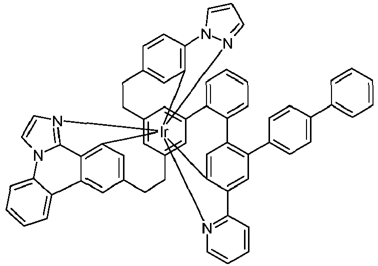 |
| 341 | 342 |
| 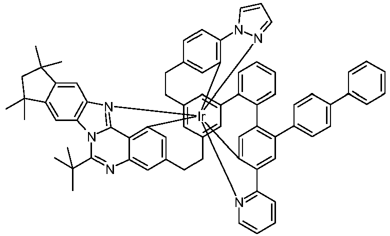 | 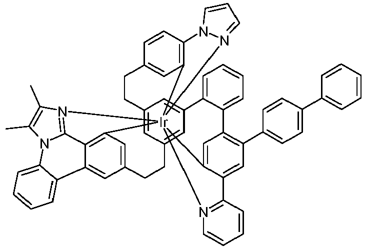 |
| 343 | 344 |
| 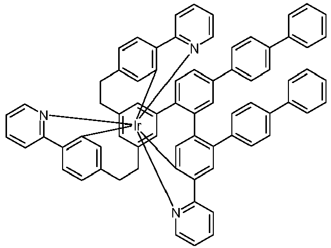 | 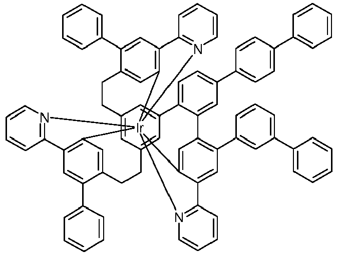 |
| 345 | 346 |
| 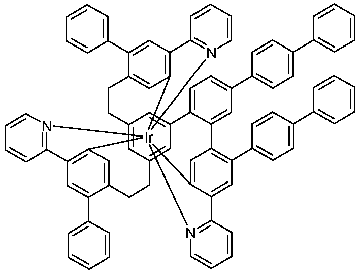 | 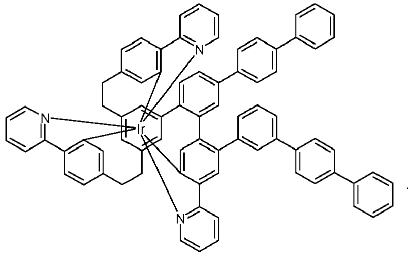 |
| 347 | 348 |
| 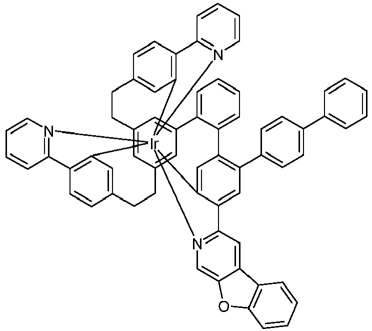 | 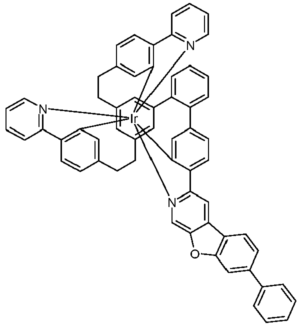 |
| 349 | 350 |
| 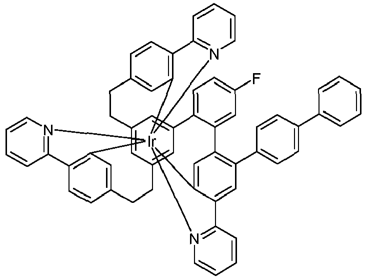 | 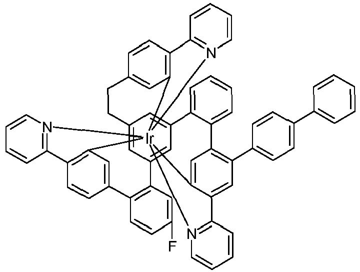 |
| 351 | 352 |
| 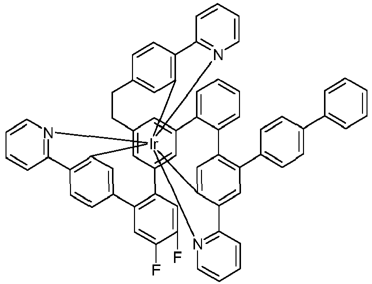 | 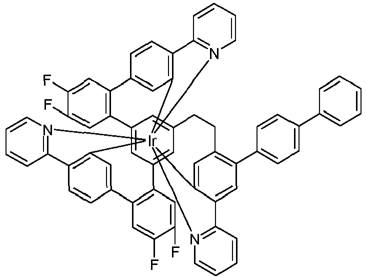 |
| 355 | 356 |
| 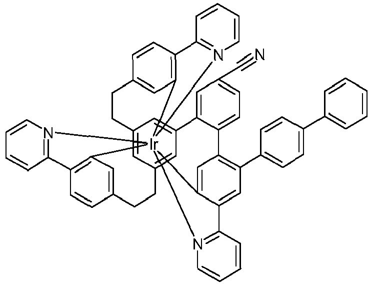 | 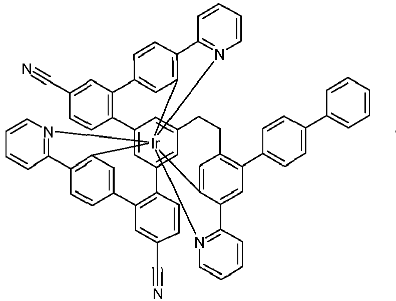 |
| 357 | 358 |
| 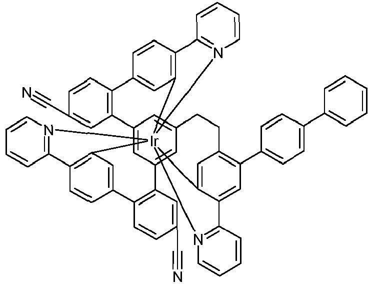 | 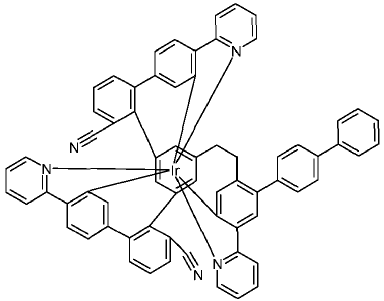 |
| 359 | 360 |
| 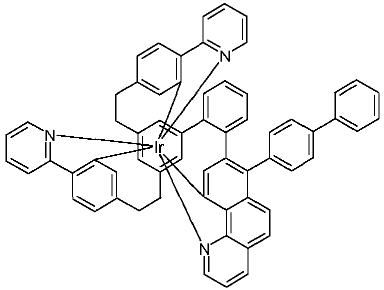 | 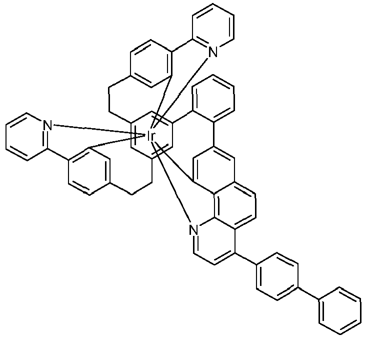 |
| 361 | 362 |
| 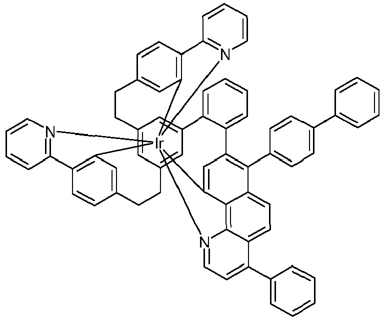 | 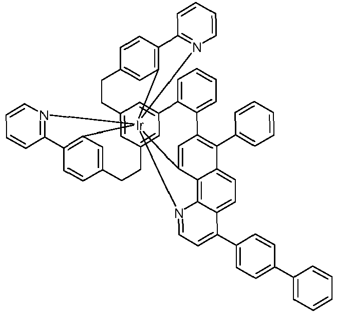 |
| 363 | 364 |
| 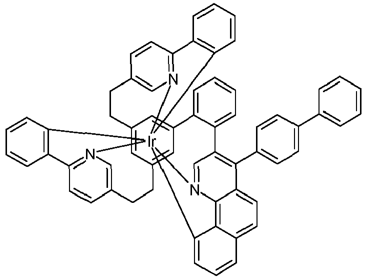 | 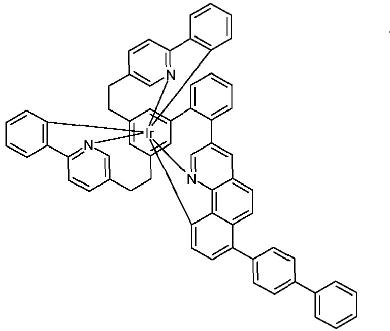 |
| 365 | 366 |
| 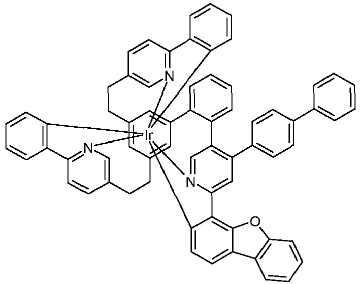 | 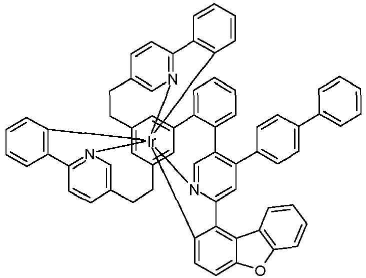 |
| 367 | 368 |
| 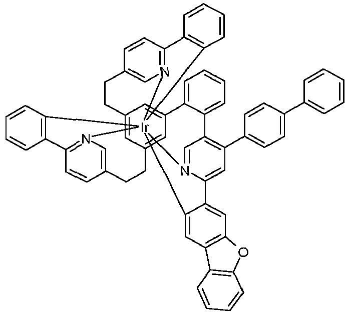 | 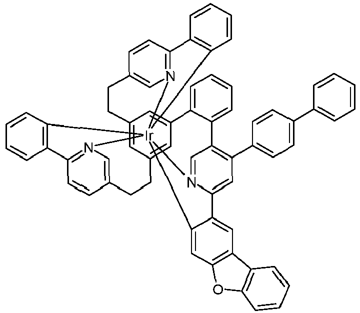 |
| 369 | 370 |
| 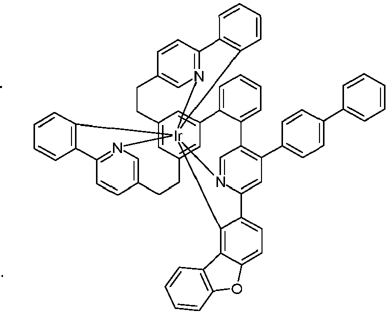 | 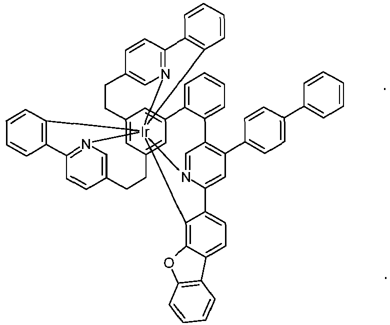 |
| 371 | 372 |
| 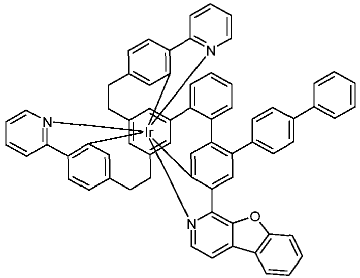 | 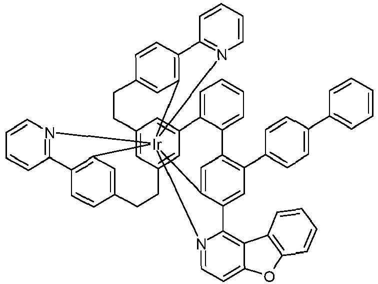 |
| 373 | 374 |
| 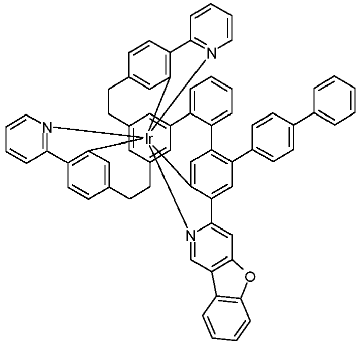 | 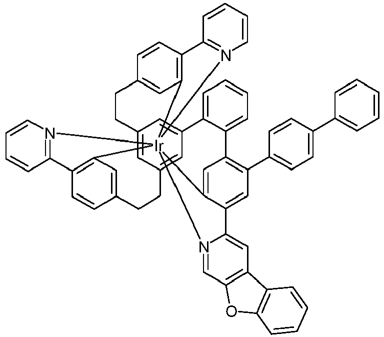 |
| 375 | 376 |
| 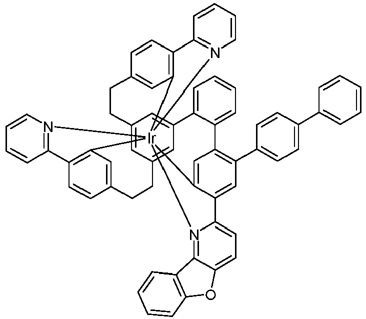 | 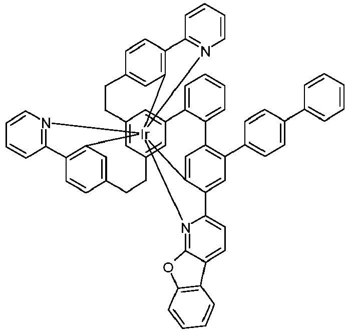 |
| 377 | 378 |
| 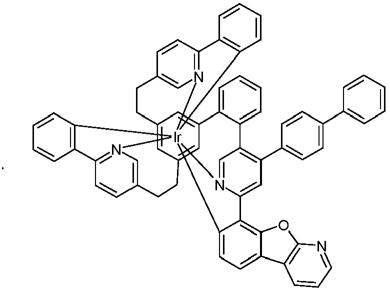 | 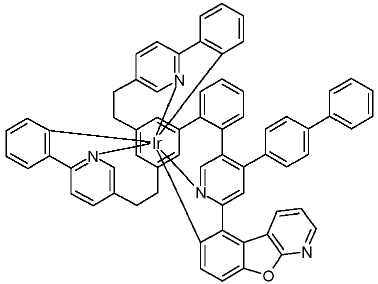 |
| 379 | 380 |
| 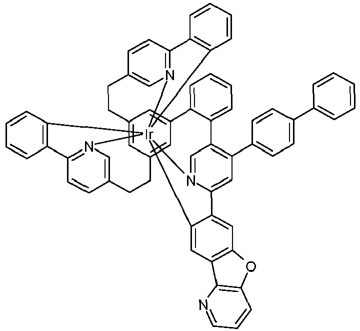 | 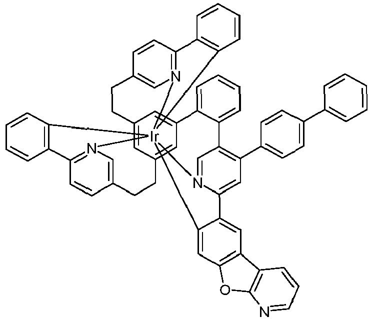 |
| 381 | 382 |
| 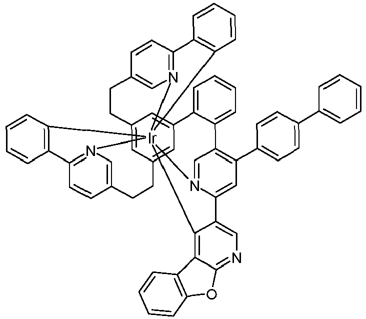 | 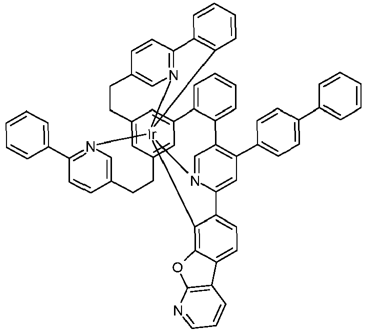 |
| 383 | 384 |
| 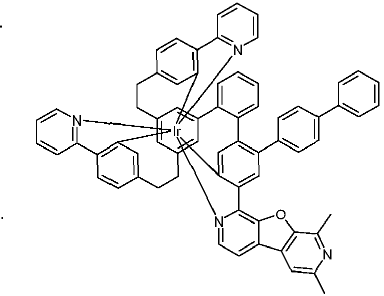 | 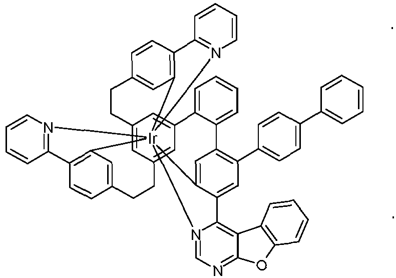 |
| 385 | 386 |
| 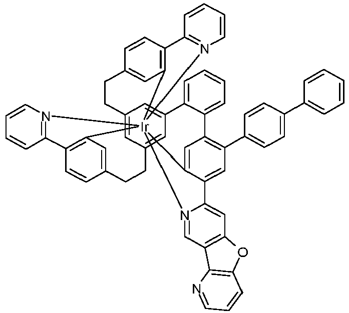 | 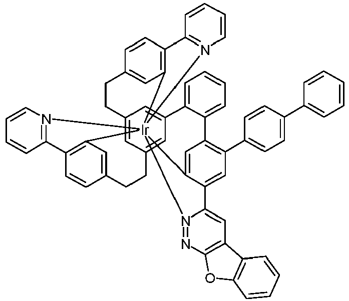 |
| 387 | 388 |
| 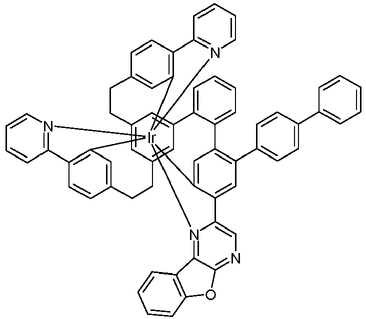 | 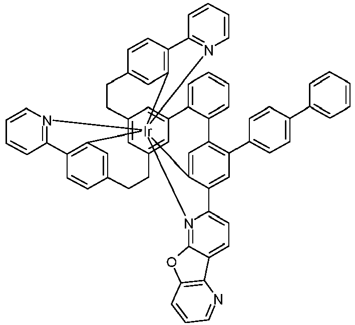 |
| 389 | 390 |
| 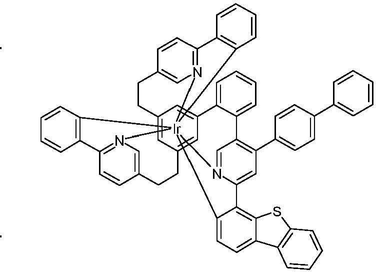 | 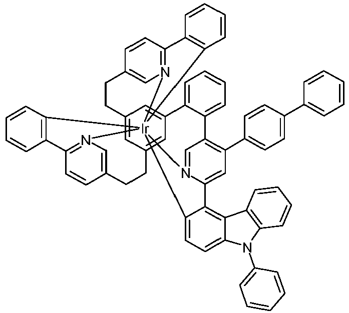 |
| 391 | 392 |
| 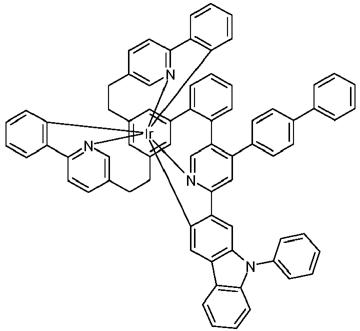 | 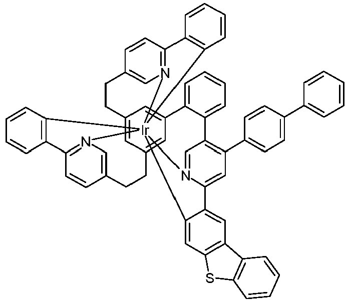 |
| 393 | 394 |
| 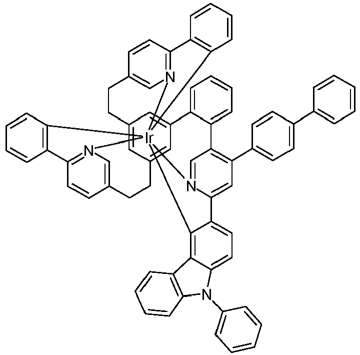 | 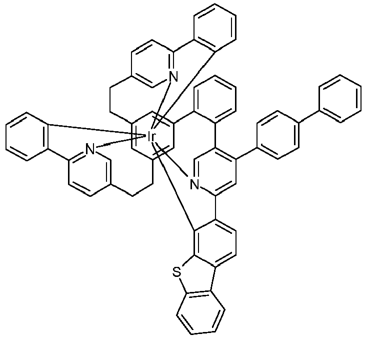 |
| 395 | 396 |
| 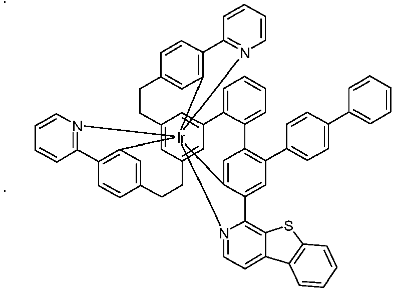 | 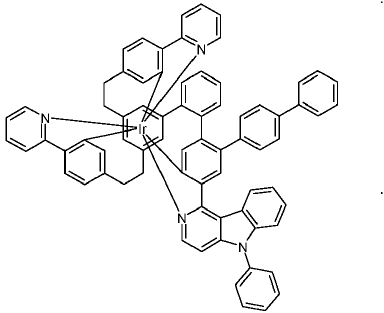 |
| 397 | 398 |
| 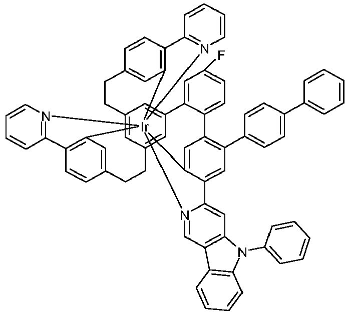 | 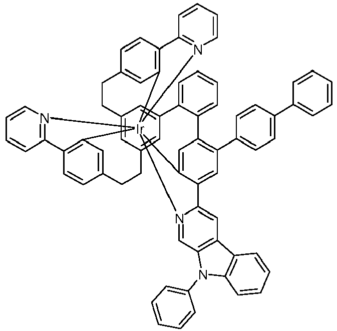 |
| 399 | 400 |
| 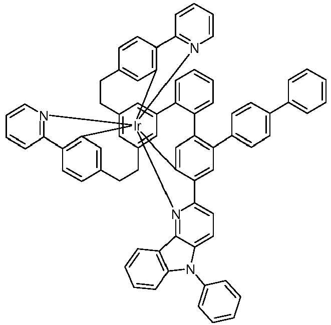 | 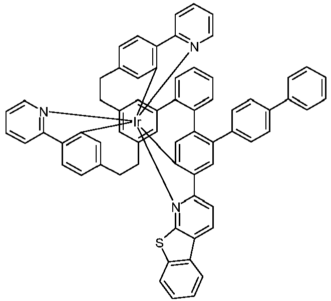 |
| 401 | 402 |
| 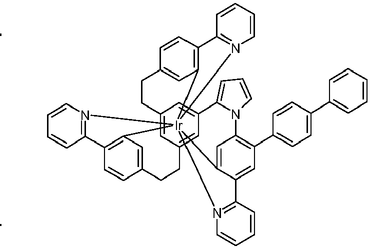 | 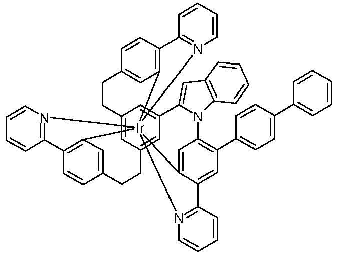 |
| 403 | 404 |
| 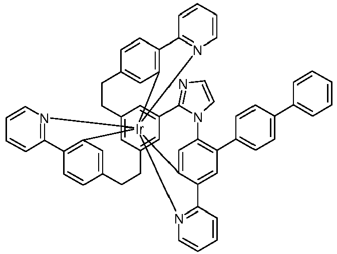 | 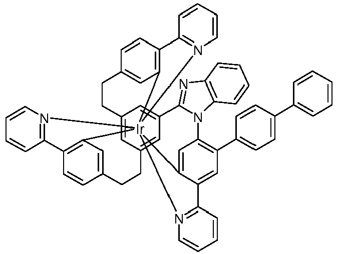 |
| 405 | 406 |
| 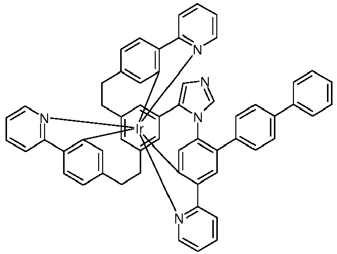 | 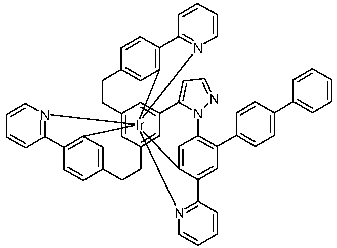 |
| 407 | 408 |
| 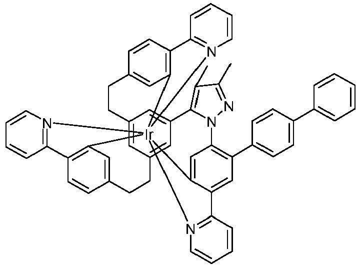 | 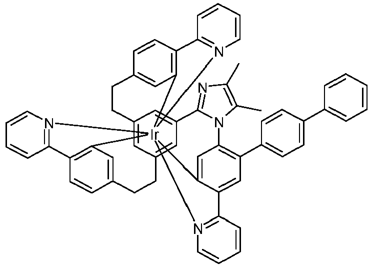 |
| 409 | 410 |
| 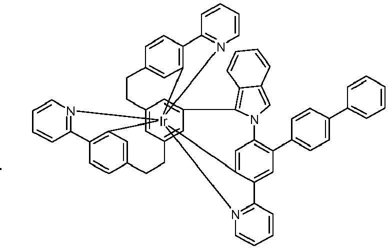 | 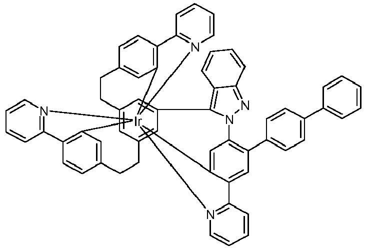 |
| 411 | 412 |
| 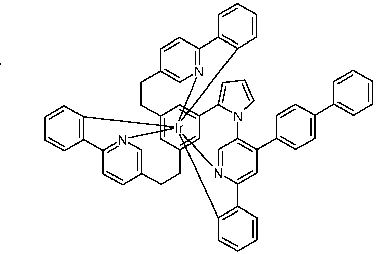 | 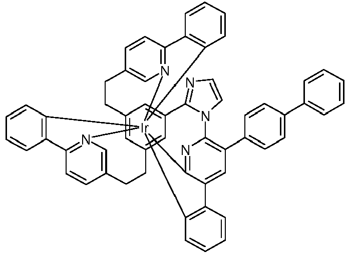 |
| 413 | 414 |
| 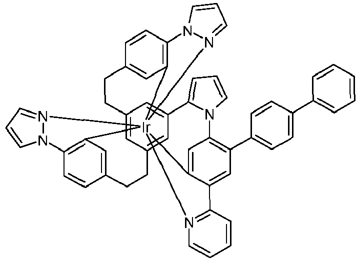 | 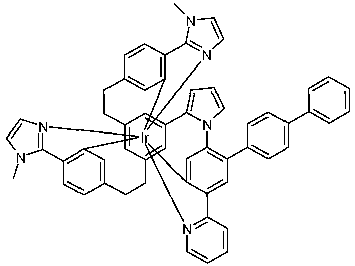 |
| 415 | 416 |
| 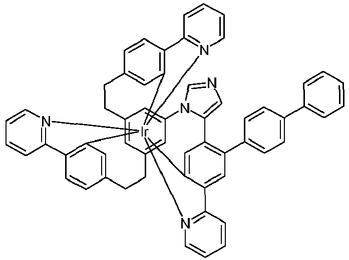 | 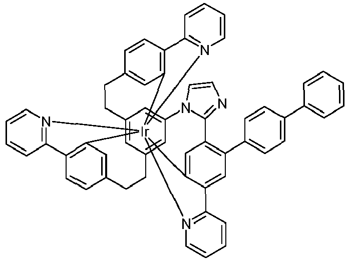 |
| 417 | 418 |
| 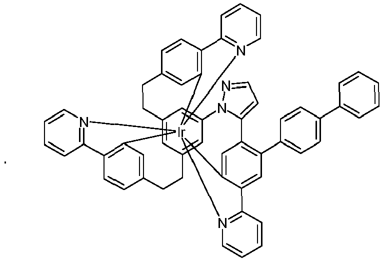 | 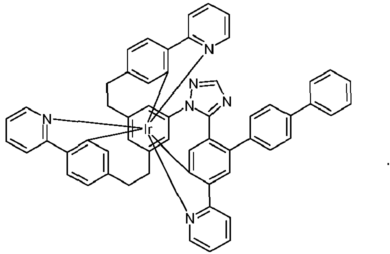 |
| 419 | 420 |
| 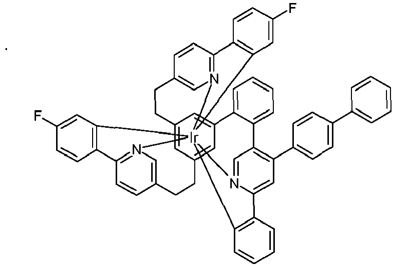 | 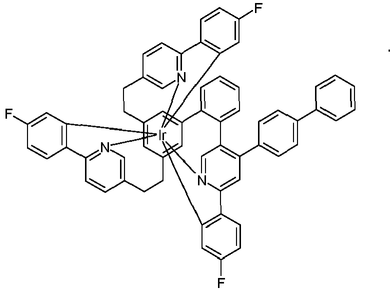 |
| 421 | 422 |
| 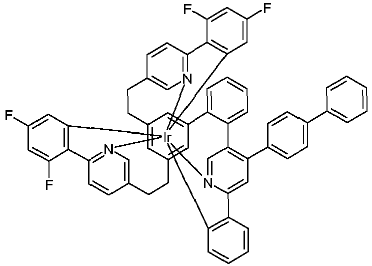 | 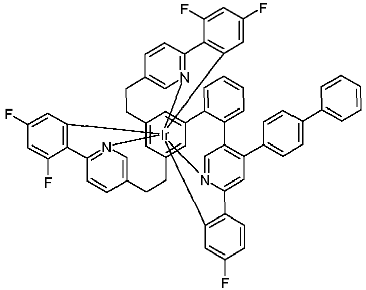 |
| 423 | 424 |
| 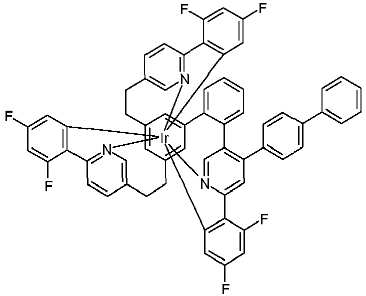 | 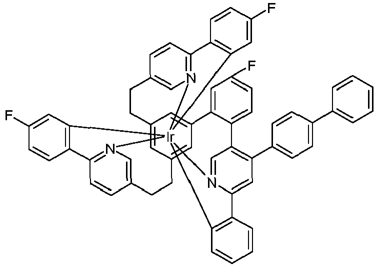 |
| 425 | 426 |
| 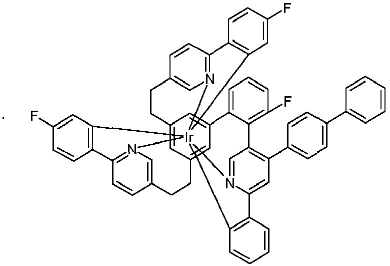 | 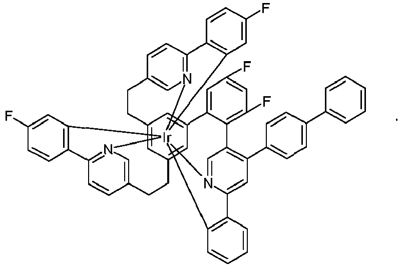 |
| 427 | 428 |
| 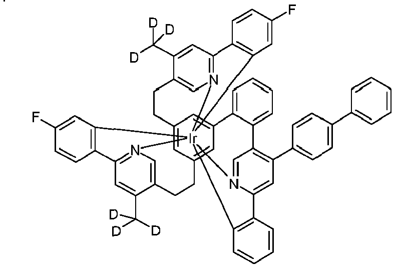 | 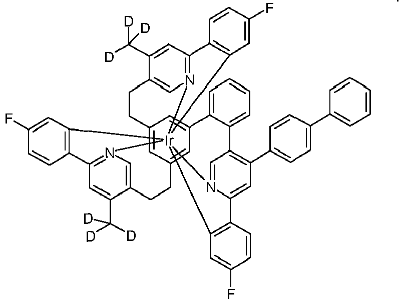 |
| 429 | 430 |
| 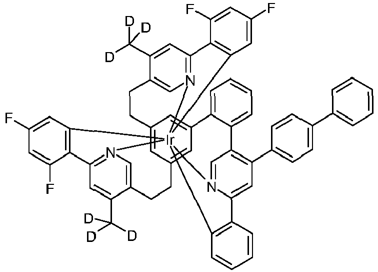 | 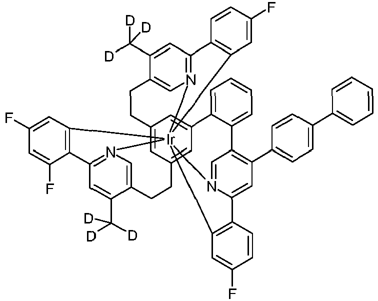 |
| 431 | 432 |
| 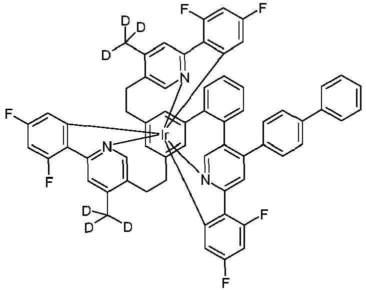 | 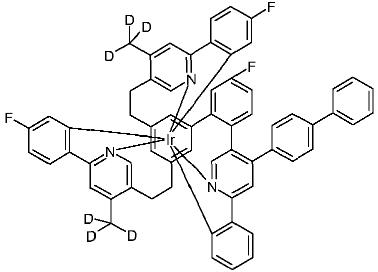 |
| 433 | 434 |
| 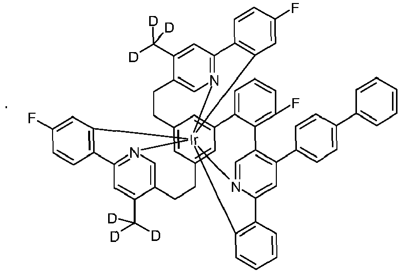 | 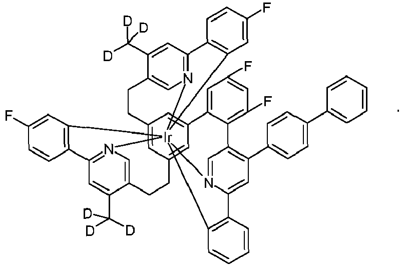 |
| 435 | 436 |
| 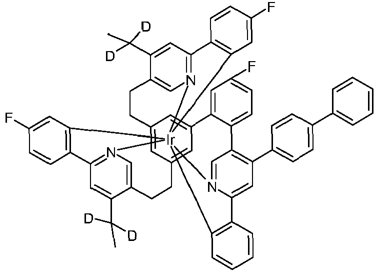 | 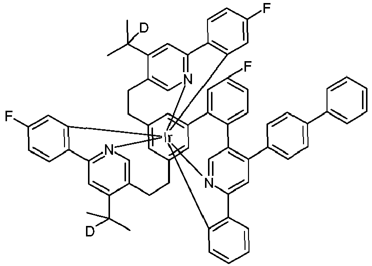 |
| 437 | 438 |
| 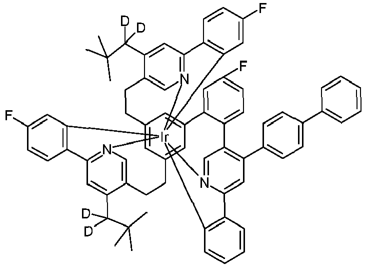 | 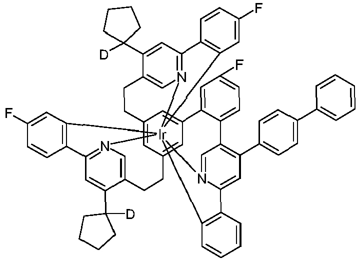 |
| 439 | 440 |
| 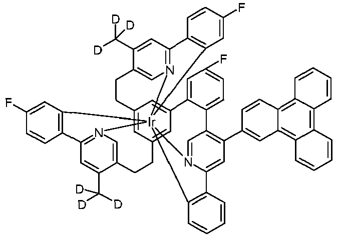 | 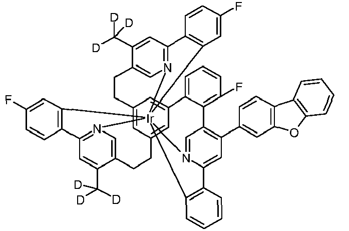 |
| 441 | 442 |
| 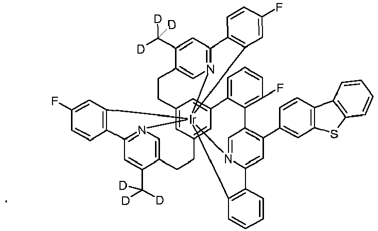 | 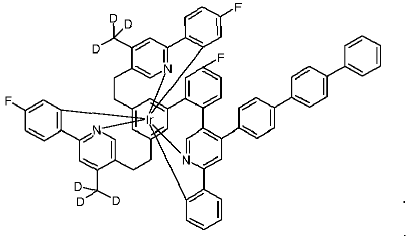 |
| 443 | 444 |
| 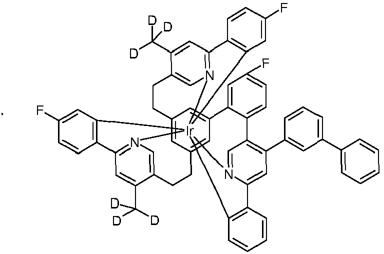 | 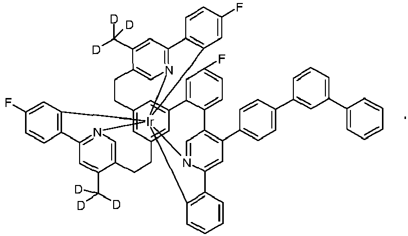 |
| 445 | 446 |
| 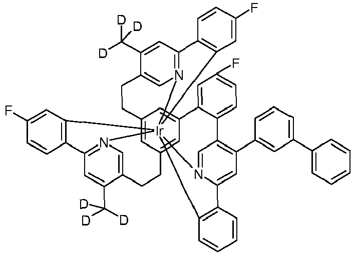 | 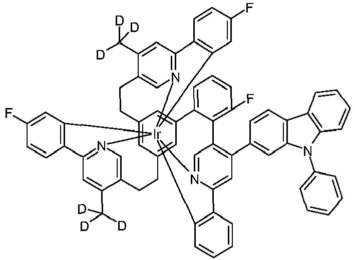 |
| 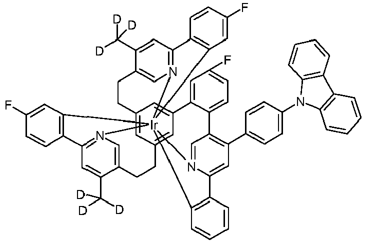 | 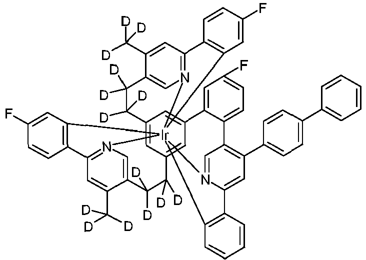 |
| 447 | 448 |
| 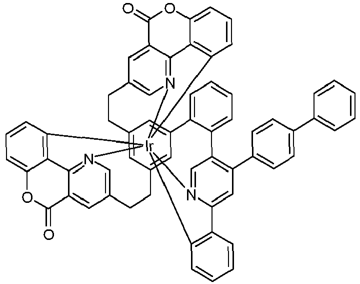 | 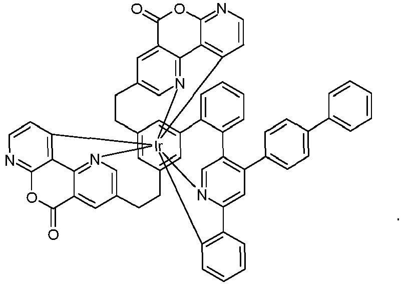 |
| 449 | 450 |
| 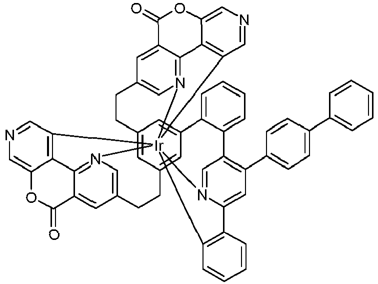 | 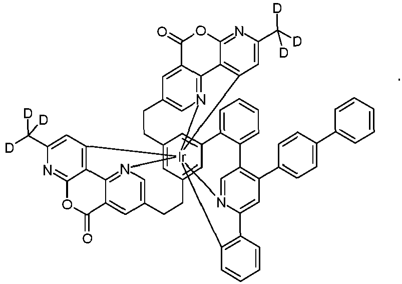 |
| 451 | 452 |
| 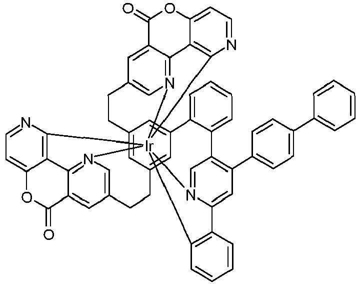 | 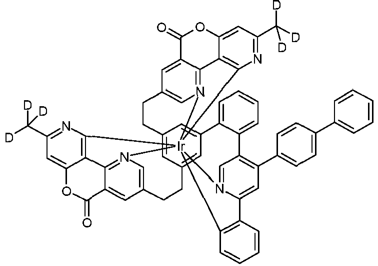 |
| 453 | 454 |
| 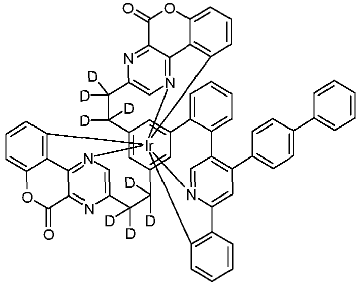 | 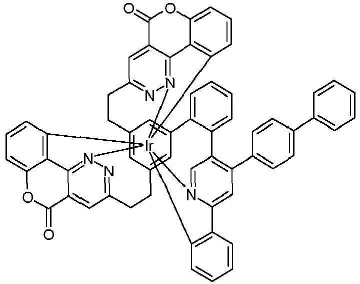 |
| 455 | 456 |
| 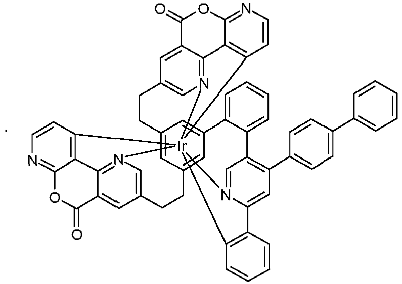 | 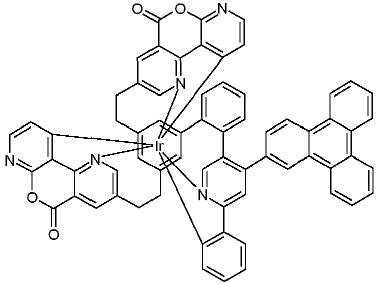 |
| 457 | 458 |
| 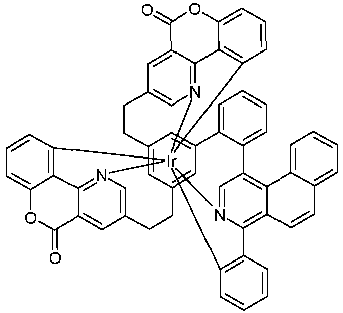 | 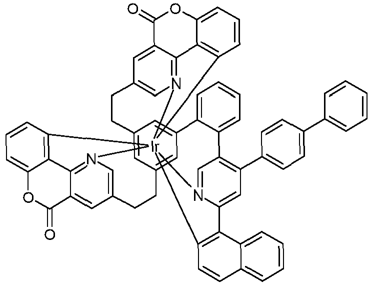 |
| 459 | 460 |
| 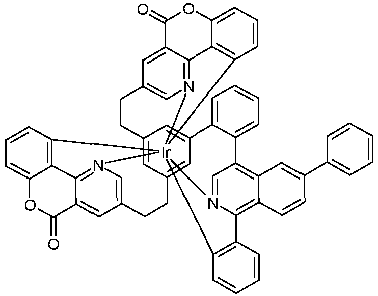 | 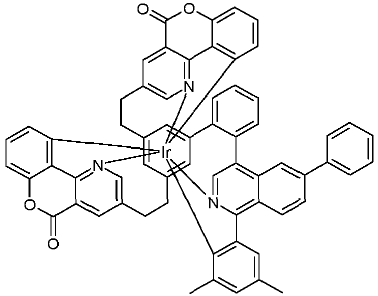 |
| 461 | 462 |
| 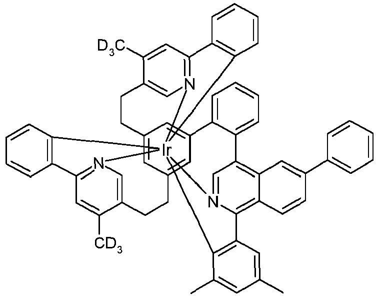 | 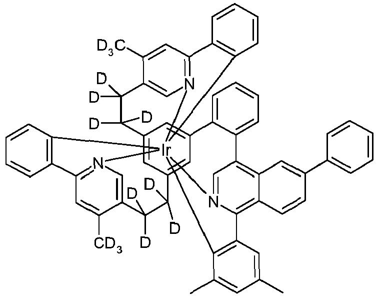 |
| 463 | 464 |
| 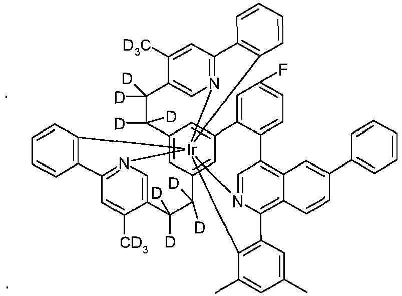 | 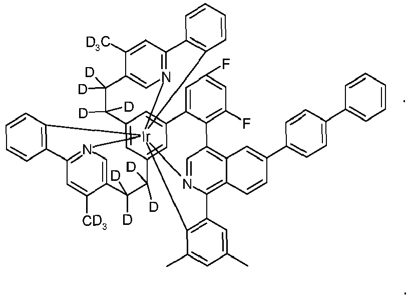 |
| 465 | 466 |
| 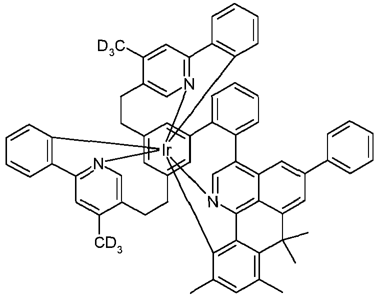 | 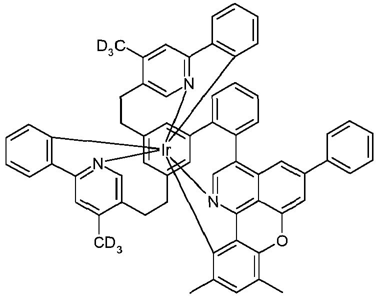 |
| 467 | 468 |
| 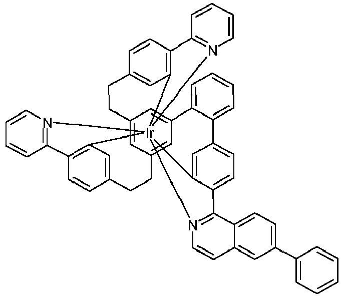 | 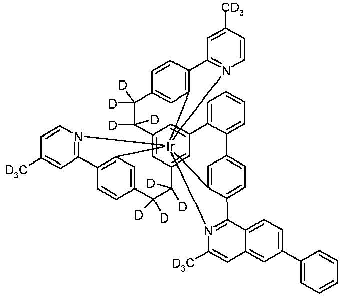 |
| 469 | 470 |
| 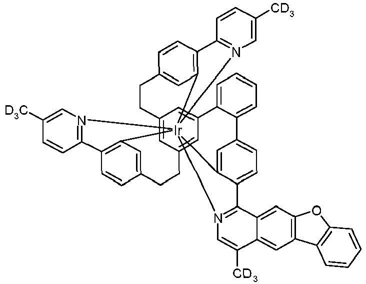 | 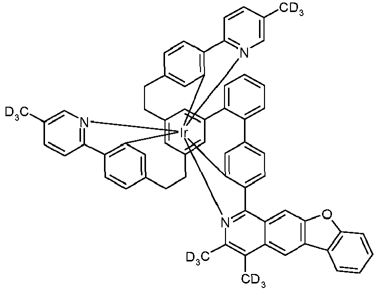 |
| 471 | 472 |
| 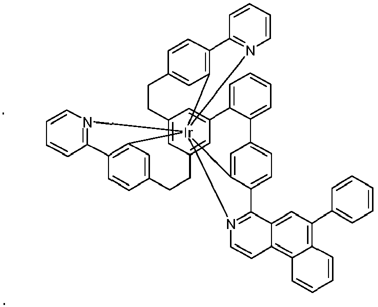 | 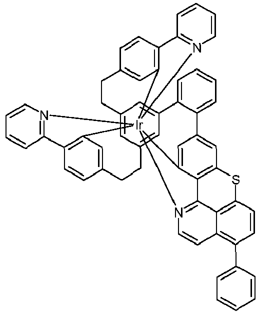 |
| 473 | 474 |
| 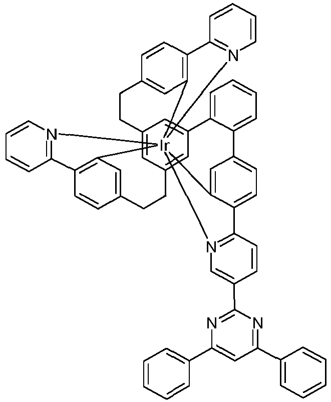 | 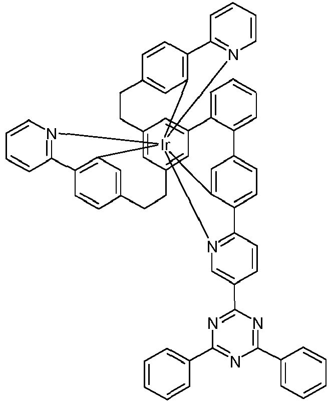 |
| 475 | 476 |
| 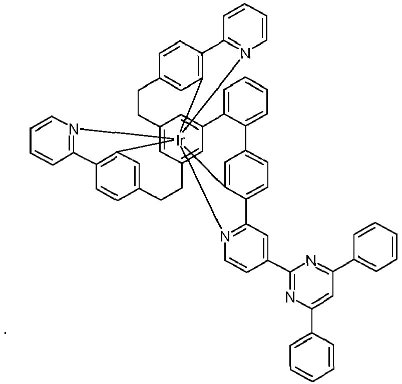 | 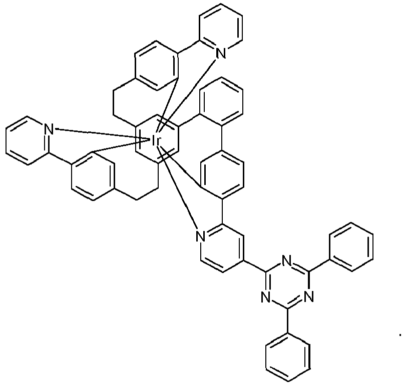 |
| 477 | 478 |
| 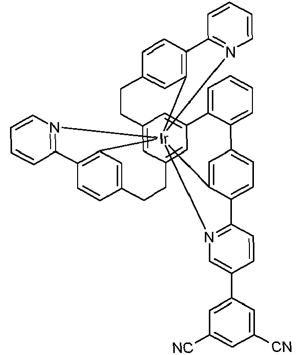 | 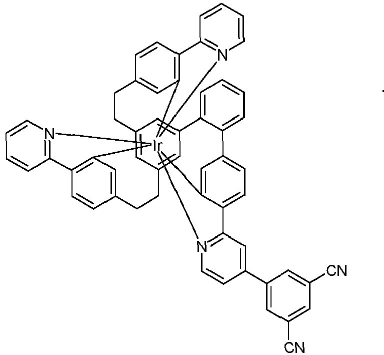 |
| 479 | 480 |
| 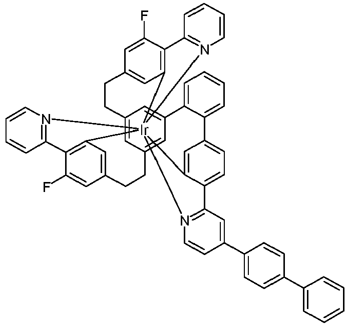 | 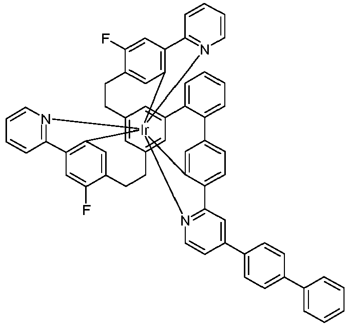 |
| 481 | 482 |
| 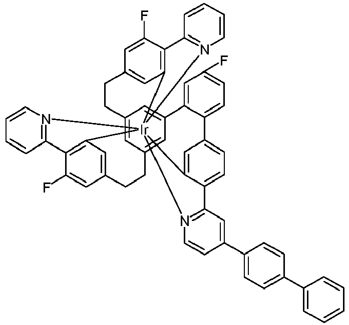 | 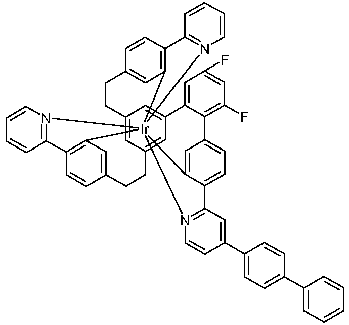 |
| 483 | 484 |
| 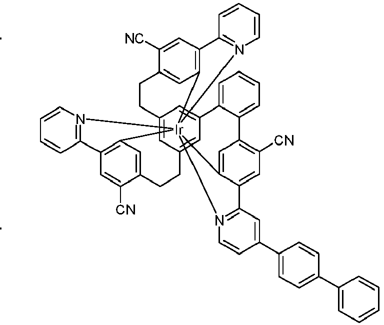 | 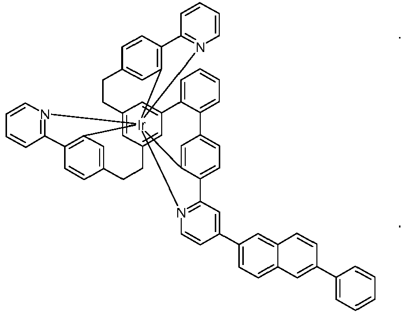 |
| 485 | 486 |
| 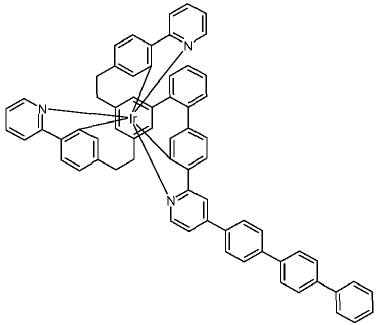 | 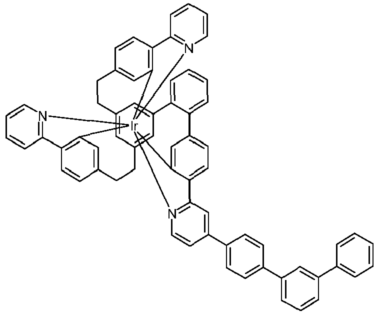 |
| 487 | 488 |
| 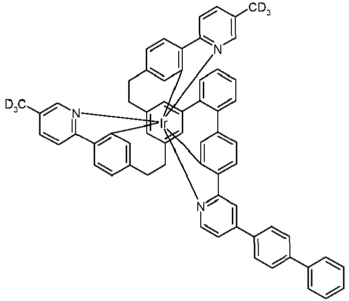 | 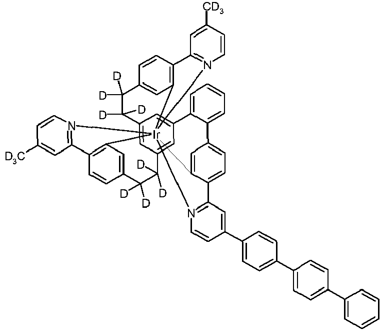 |
| 489 | 490 |
| 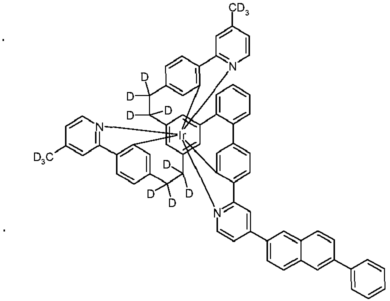 | 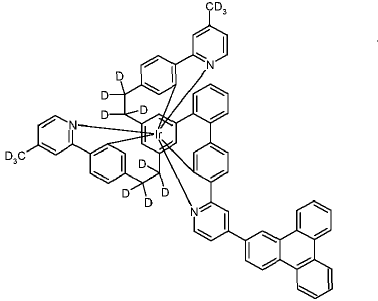 |
| 491 | 492 |
| 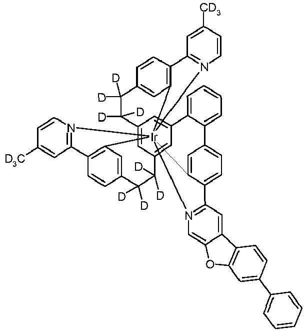 | 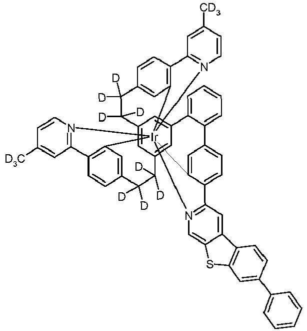 |
| 493 | 494 |
| 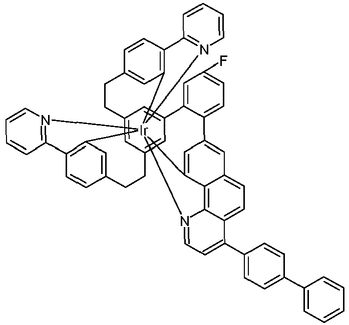 | 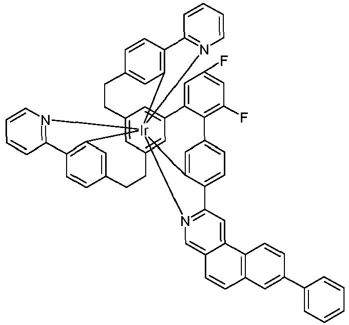 |
| 495 | 496 |
| 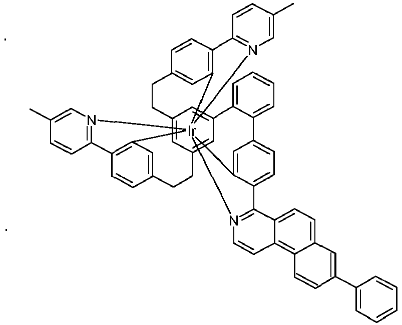 | 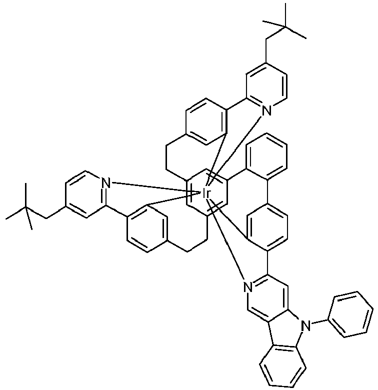 |
| 497 | 498 |
| 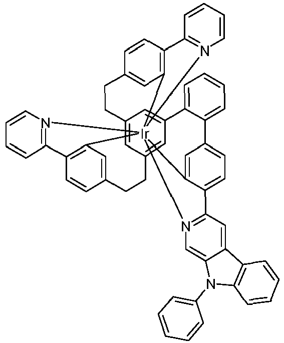 | 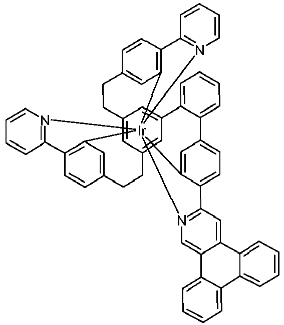 |
| 499 | 500 |
| 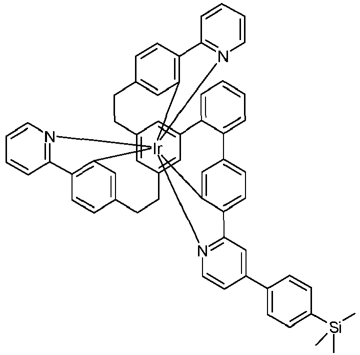 | 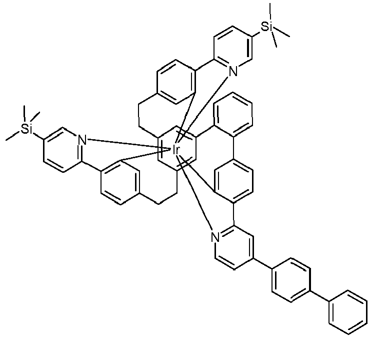 |
| 501 | 502 |
| 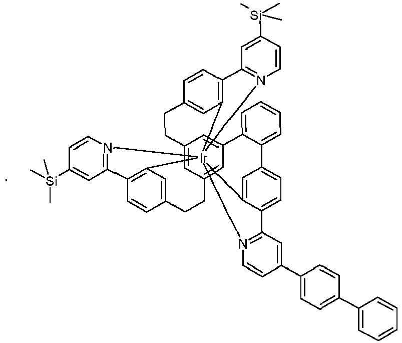 | 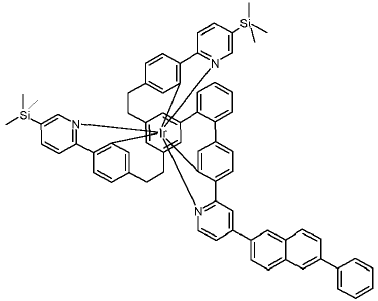 |
| 503 | 504 |
| 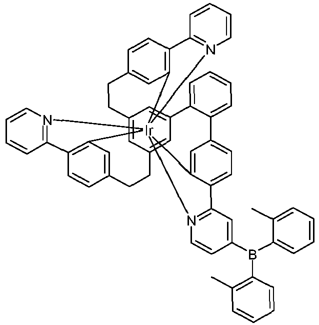 | 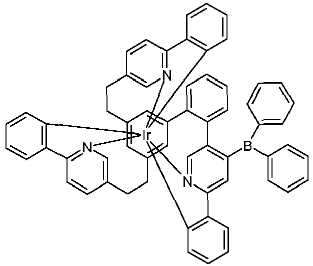 |
| 505 | 506 |
| 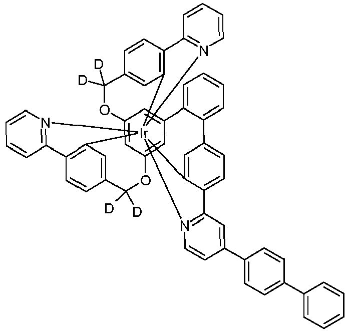 | 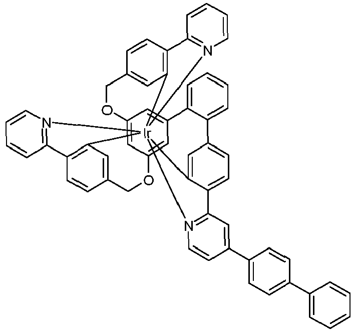 |
| 507 | 508 |
| 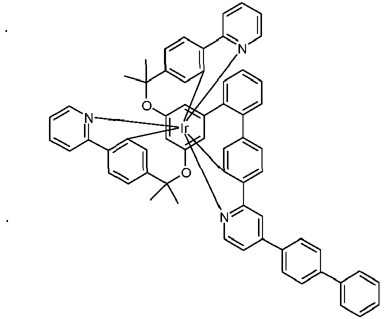 | 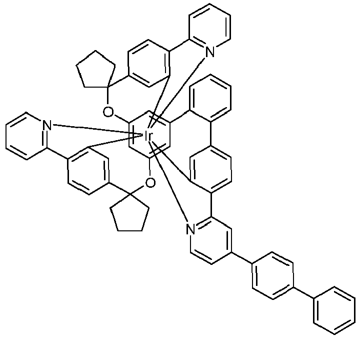 |
| 509 | 510 |
| 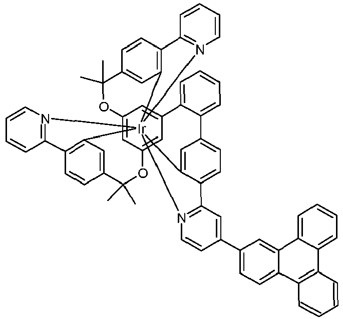 | 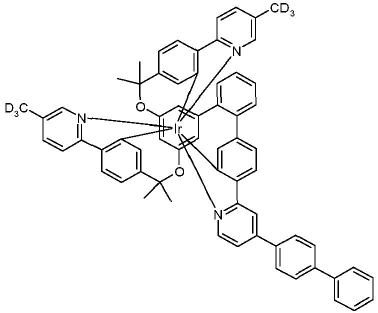 |
| 511 | 512 |
| 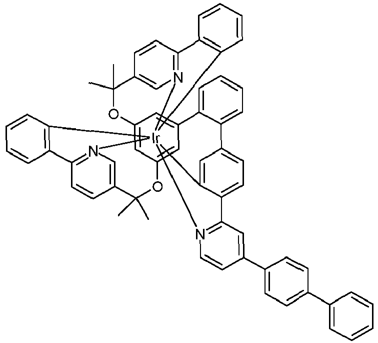 | 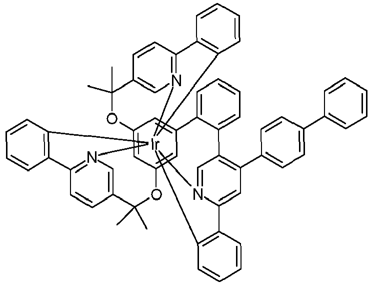 |
| 513 | 514 |
| 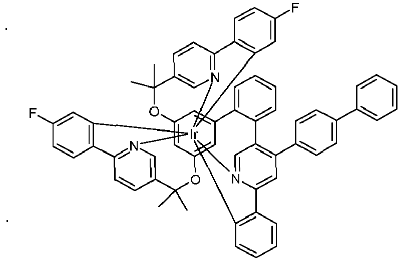 | 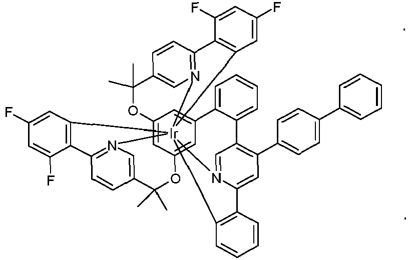 |
| 515 | 516 |
| 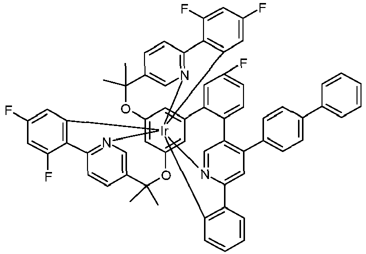 | 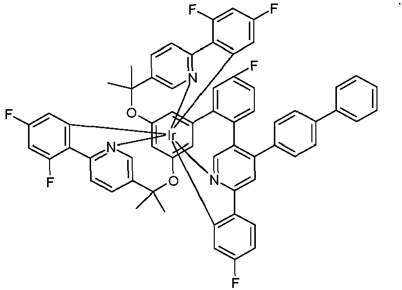 |
| 517 | 518 |
| 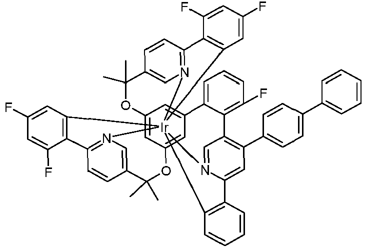 | 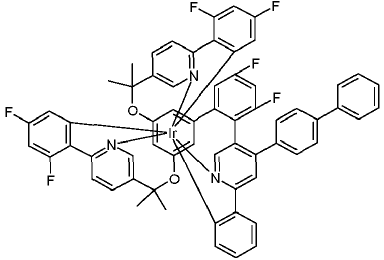 |
| 519 | 520 |
| 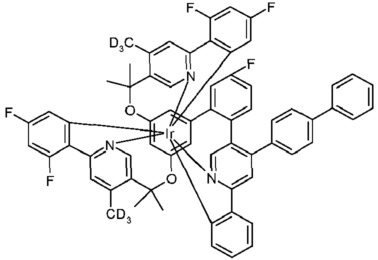 | 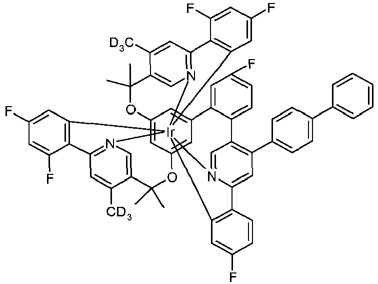 |
| 521 | 522 |
| 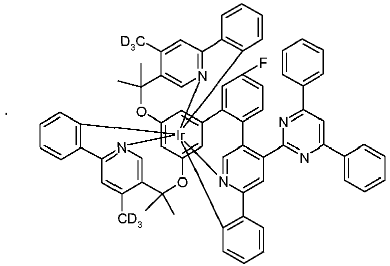 | 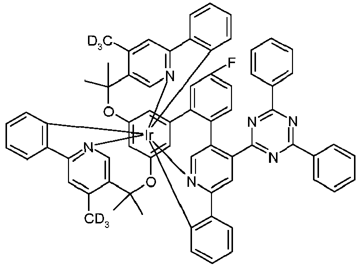 |
| 523 | 524 |
| 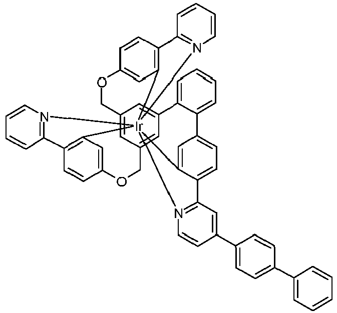 | 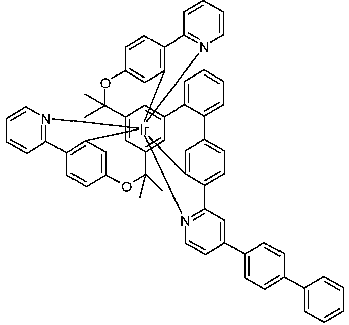 |
| 525 | 526 |
| 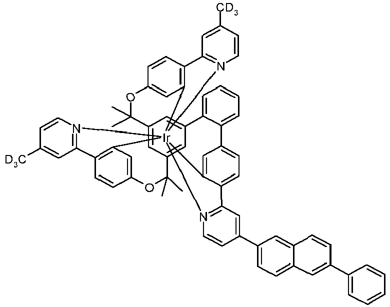 | 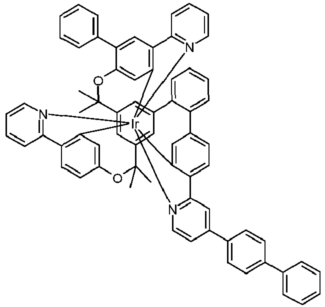 |
| 527 | 528 |
| 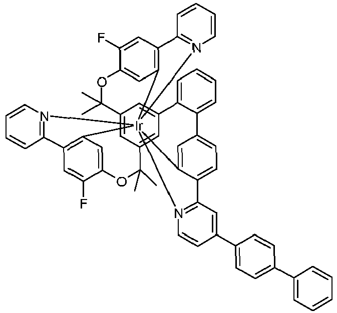 | 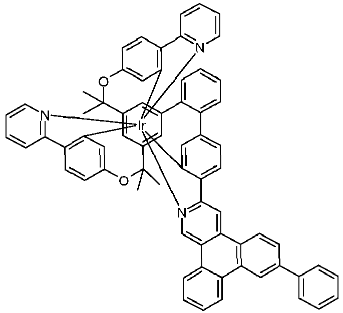 |
| 529 | 530 |
| 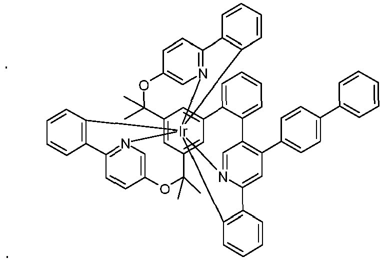 | 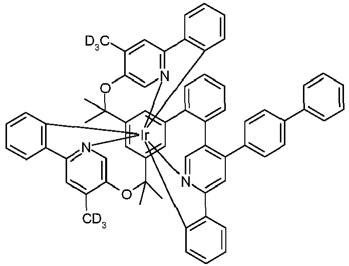 |
| 531 | 532 |
| 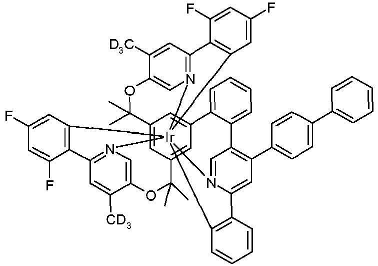 | 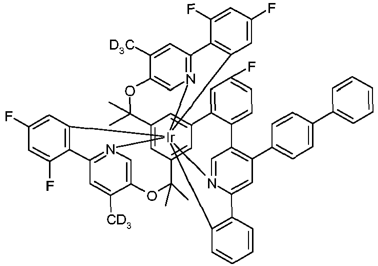 |
| 533 | 534 |
| 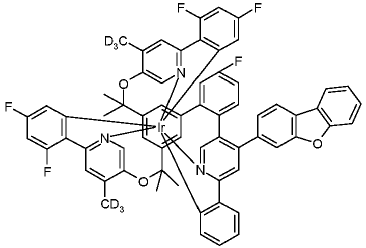 | 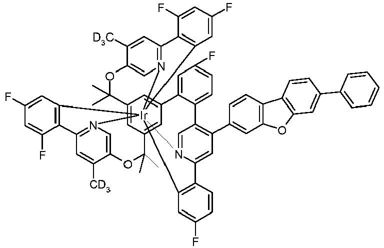 |
| 535 | 536 |
| 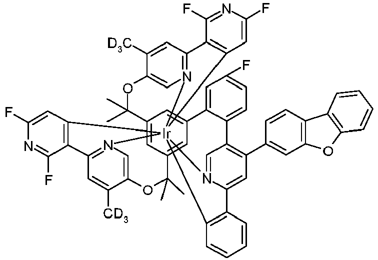 | 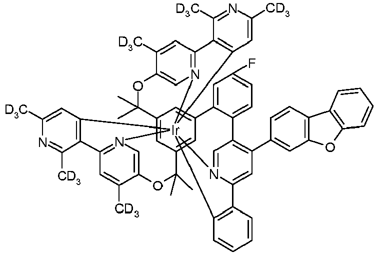 |
| 537 | 538 |
| 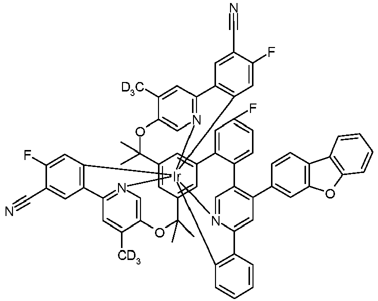 | 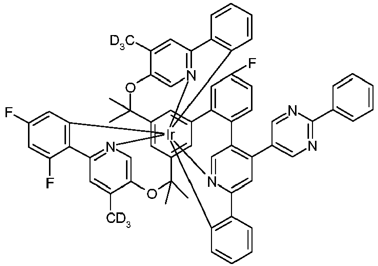 |
| 539 | 540 |
| 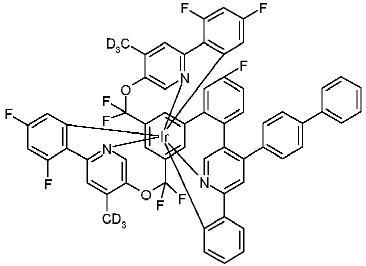 | 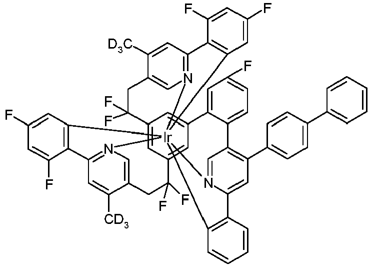 |
| 541 | 542 |
| 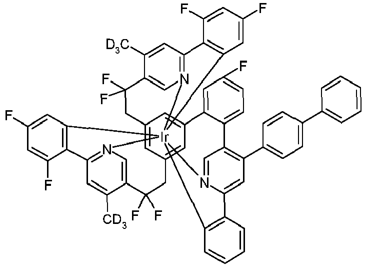 | 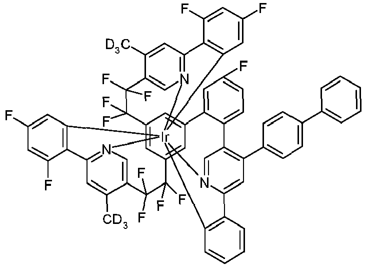 |
| 543 | 544 |
| 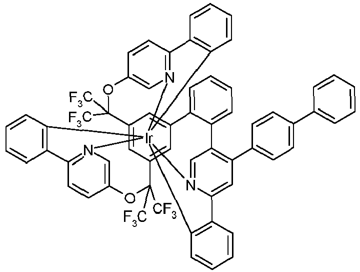 | 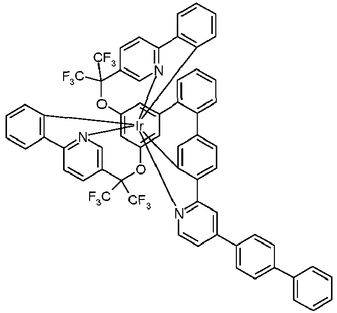 |
| 545 | 546 |
| 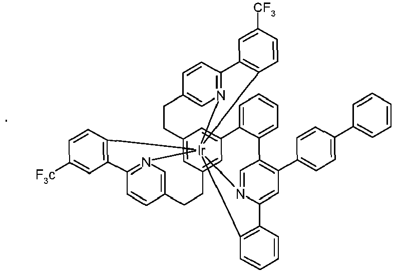 | 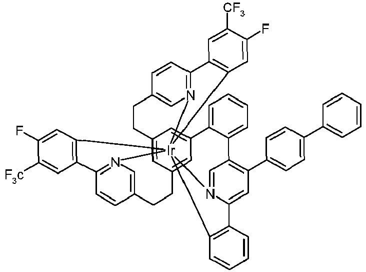 |
| 547 | 548 |
| 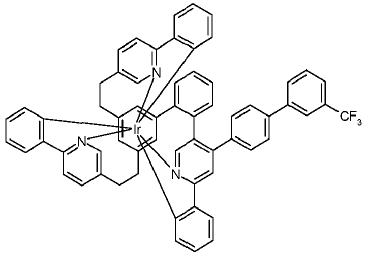 | 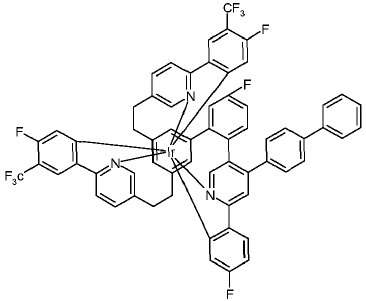 |
| 549 | 550 |
| 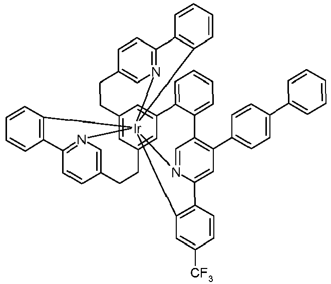 | 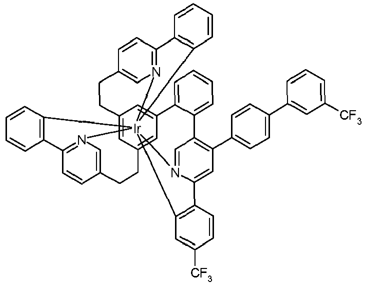 |
| 551 | 552 |
| 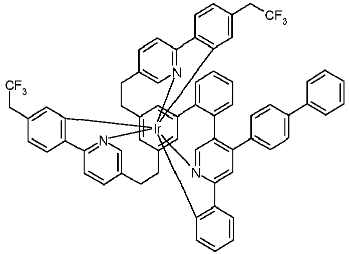 | 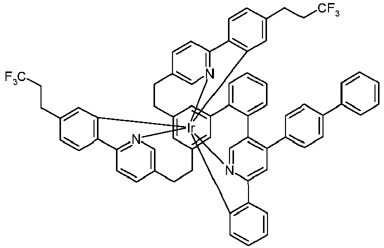 |
| 553 | 554 |
| 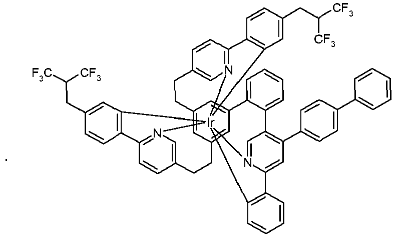 | 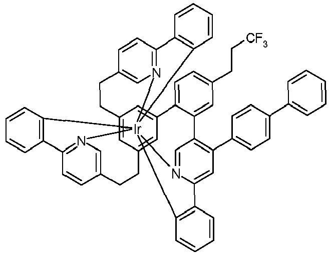 |
| 555 | 556 |
| 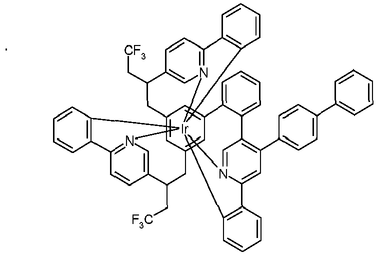 | 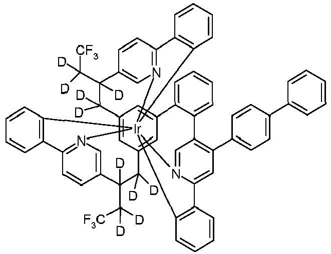 |
| 557 | 558 |
| 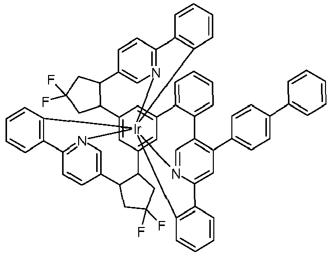 | 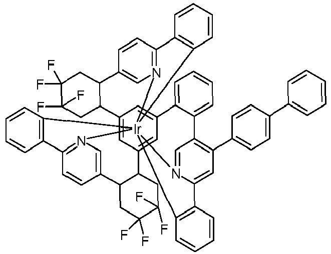 |
| 559 | 560 |
| 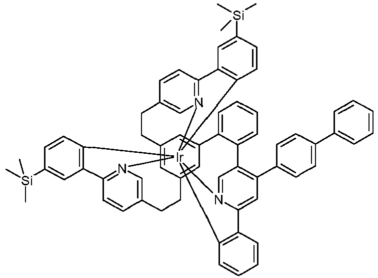 | 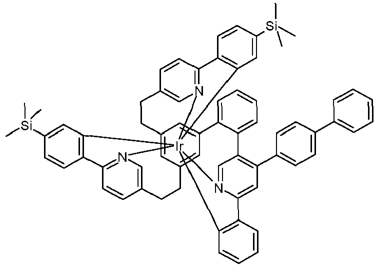 |
| 561 | 562 |
| 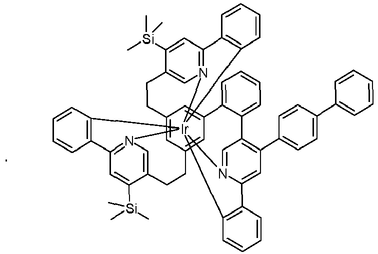 | |
| 563 | |
| 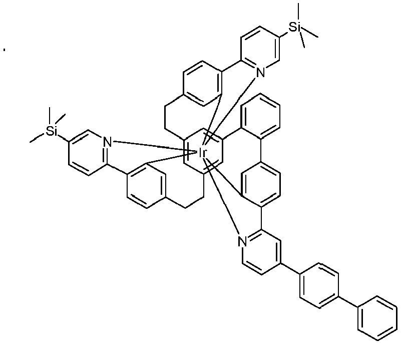 | 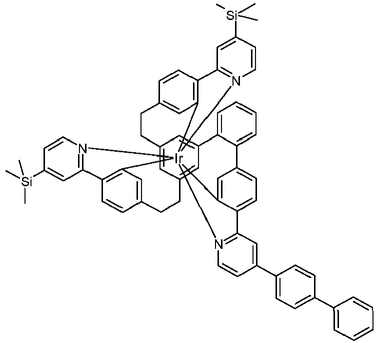 |
| 565 | 566 |
| 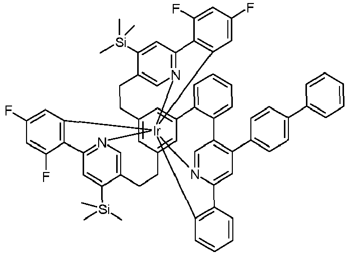 | 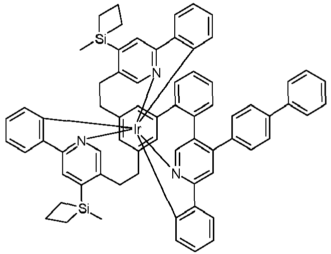 |
| 567 | 568 |
| 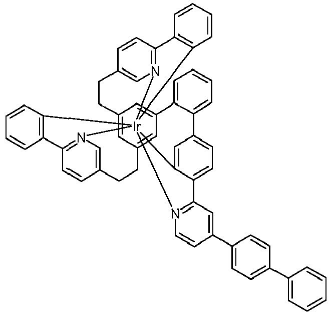 | 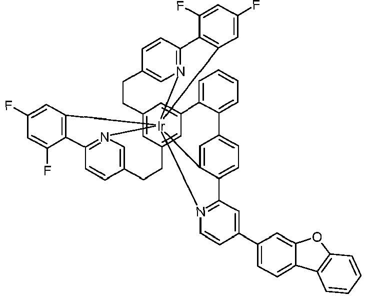 |
| 569 | 570 |
| 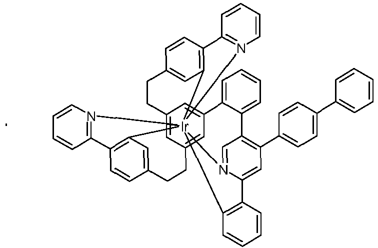 | 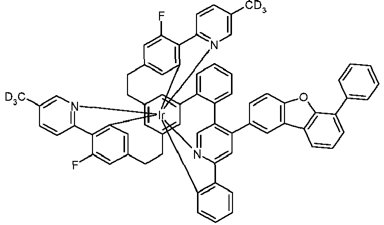 |
| 571 | 572 |
| 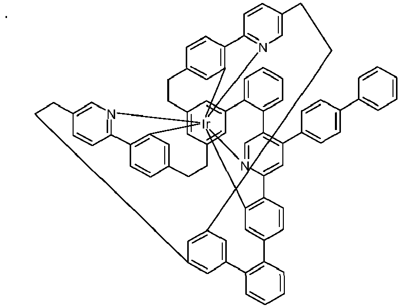 | 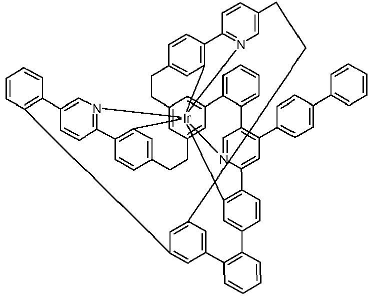 |
| 573 | 574 |
| 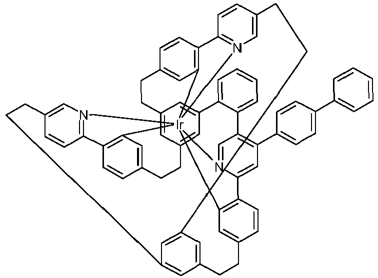 | 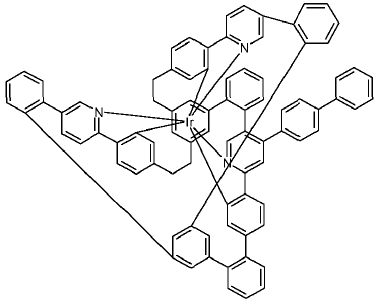 |
| 575 | 576 |
| 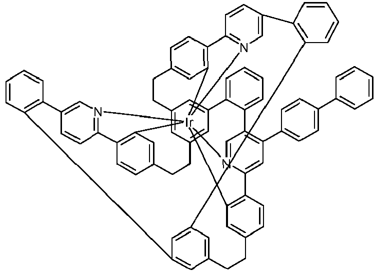 | 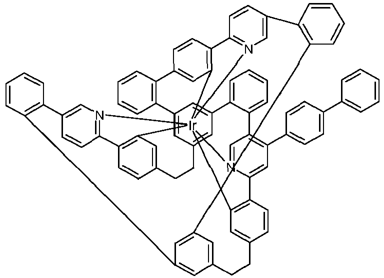 |
| 577 | 578 |
| 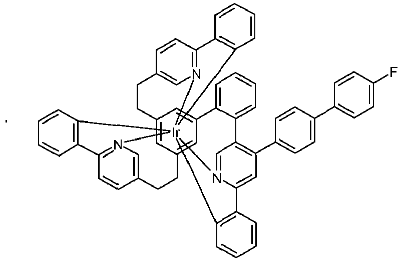 | 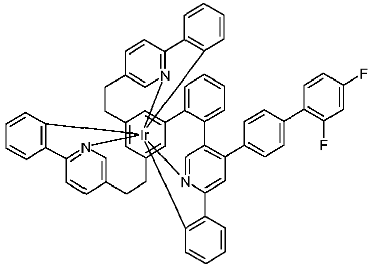 |
| 579 | 580 |
| 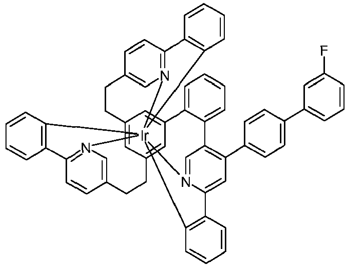 | 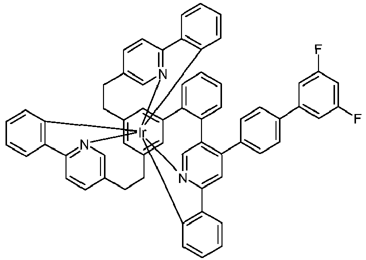 |
| 581 | 582 |
| 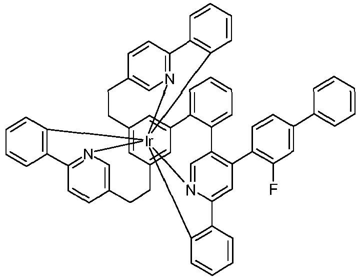 | 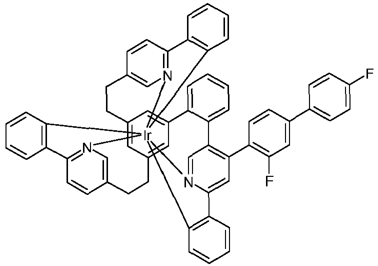 |
| 583 | 584 |
| 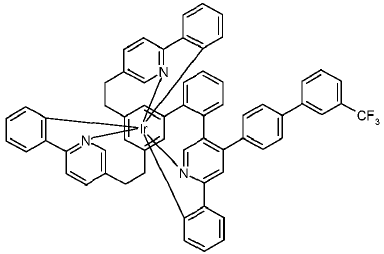 | 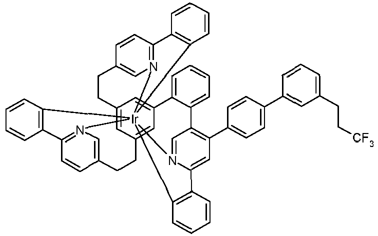 |
| 585 | 586 |
| 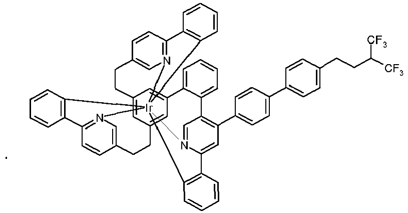 | 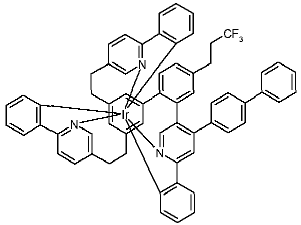 |
| 587 | 588 |
| 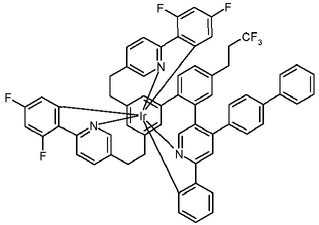 | 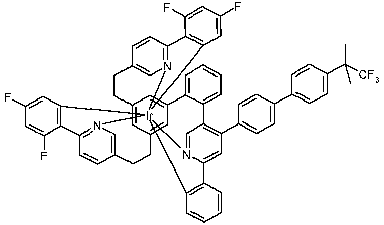 |
| 589 | 590 |
| 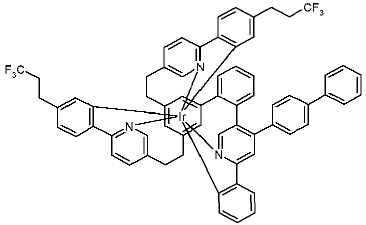 | 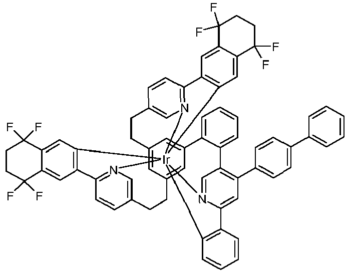 |
| 591 | 592 |
| 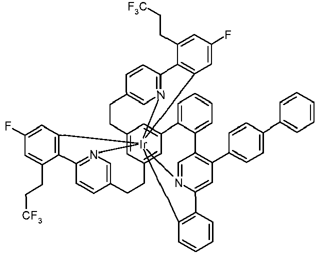 | 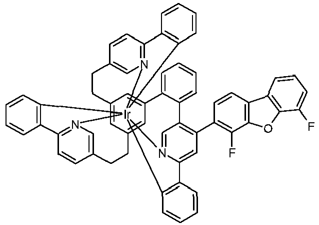 |
| 593 | 594 |
| 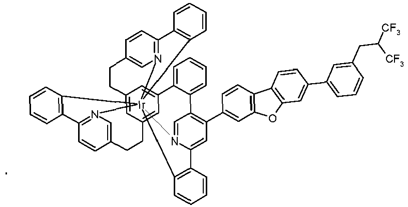 | 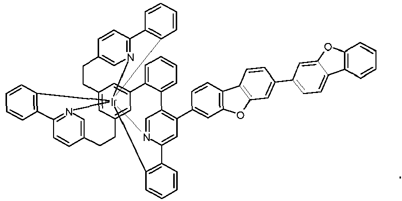 |
| 595 | 596 |
| 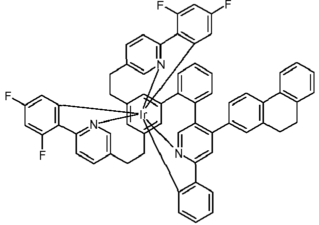 | 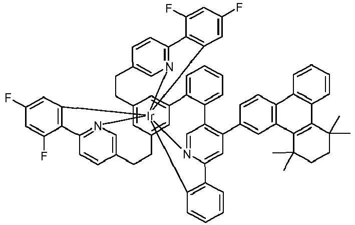 |
| 597 | 598 |
| 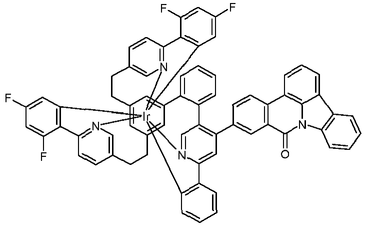 | 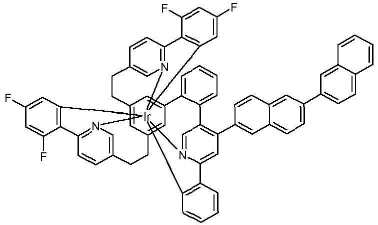 |
| 599 | 600 |
| 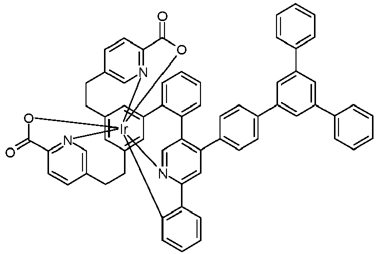 | 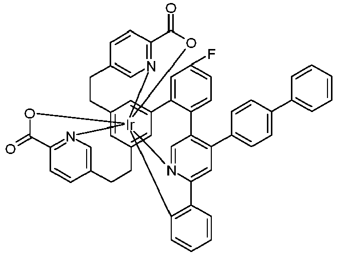 |
| 601 | 602 |
| 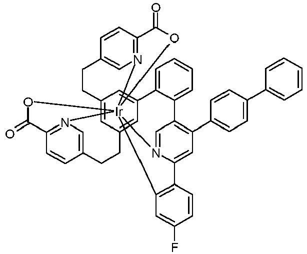 | 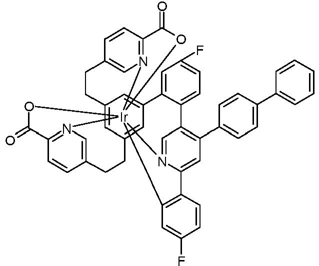 |
| 603 | 604 |
| 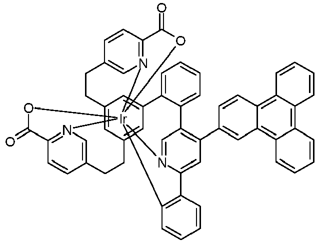 | 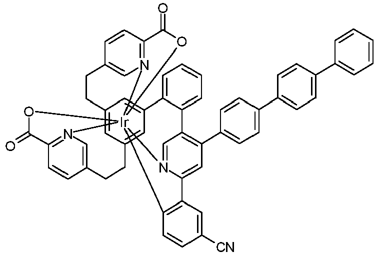 |
| 605 | 606 |
| 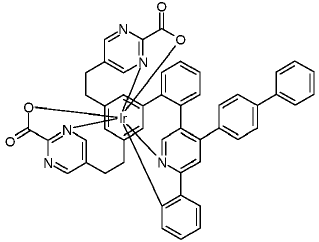 | 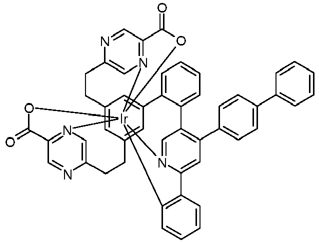 |
| 607 | 608 |
| 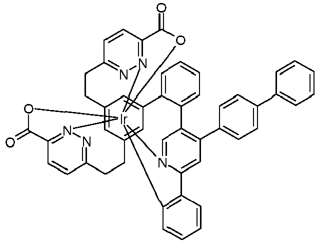 | 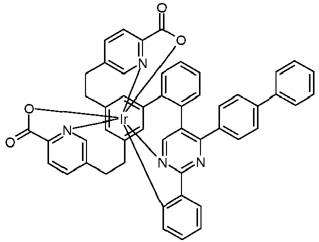 |
| 609 | 610 |
| 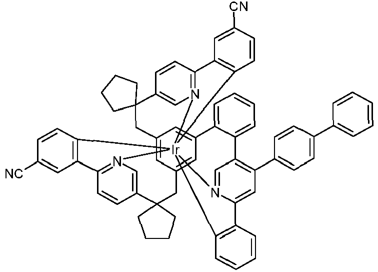 | 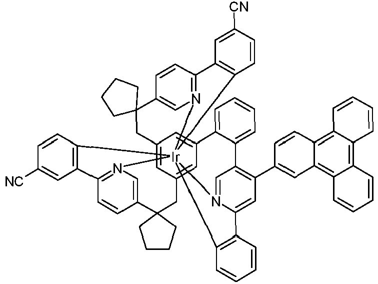 |
| 611 | 612 |
| 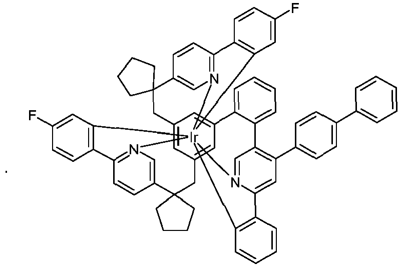 | 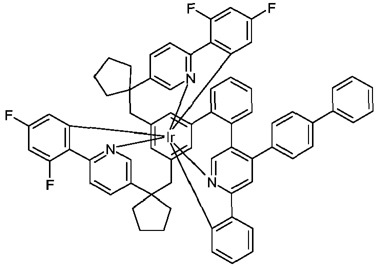 |
| 613 | 614 |
| 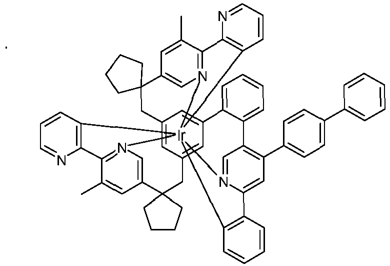 | 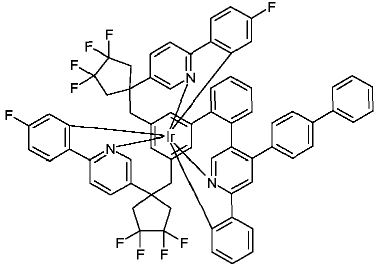 |
| 615 | 616 |
| 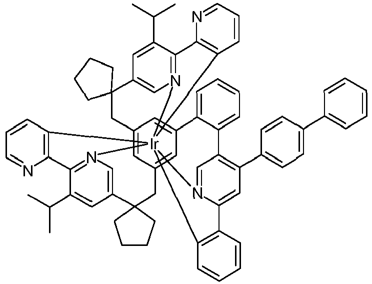 | 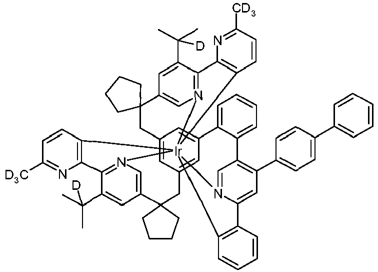 |
| 617 | 618 |
| 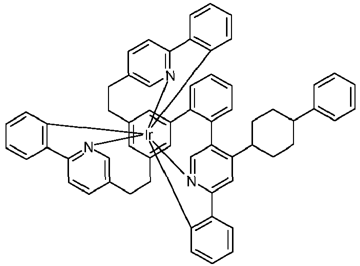 | 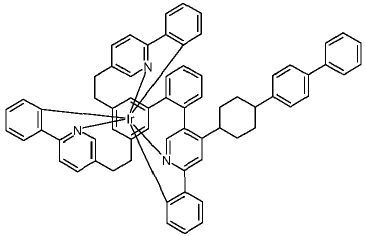 |
| 619 | 620 |
| 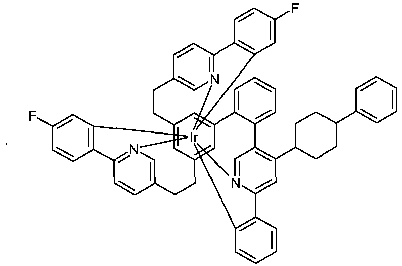 | 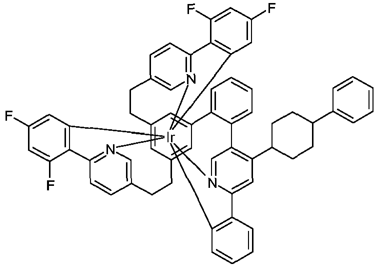 |
| 622 | 623 |
| 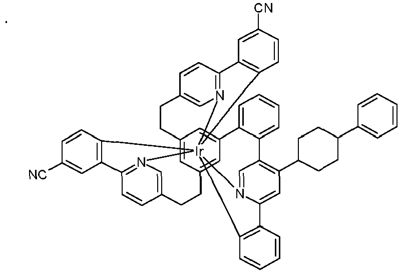 | 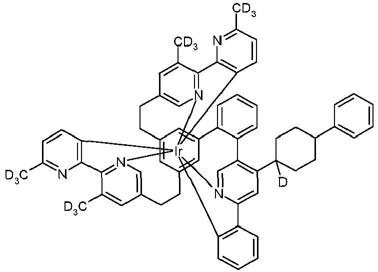 |
| 624 | 625 |
| 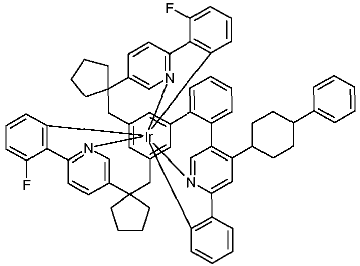 | 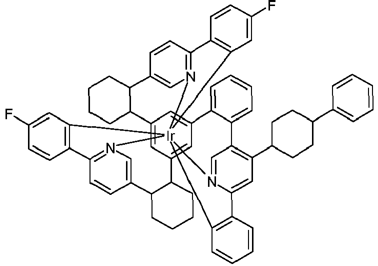 |
| 626 | 627 |
| 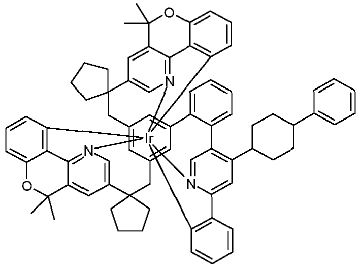 | 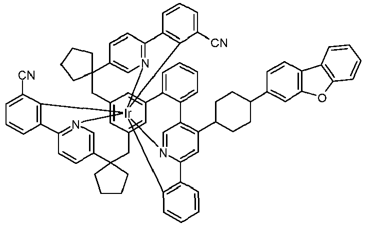 |
| 628 | 629 |
| 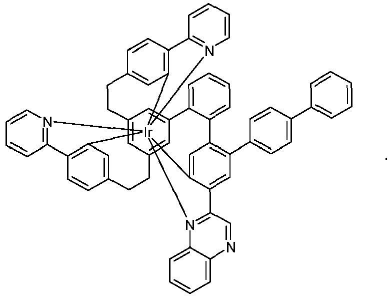 | 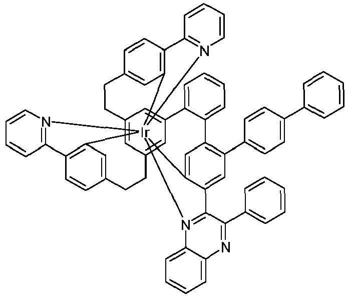 |
| 630 | 631 |
| | |
| 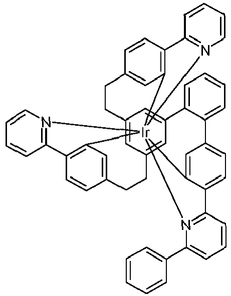 | 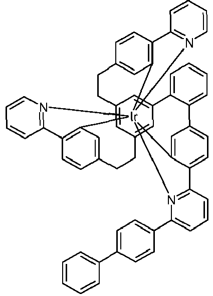 |
| 632 | 633 |
| 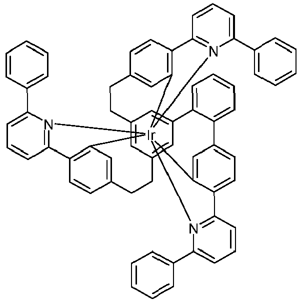 | 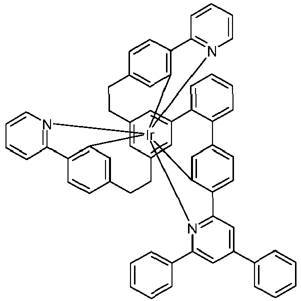 |
| 634 | 635 |
| 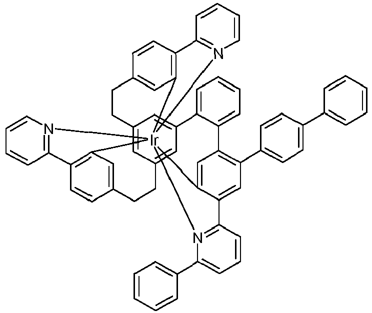 | 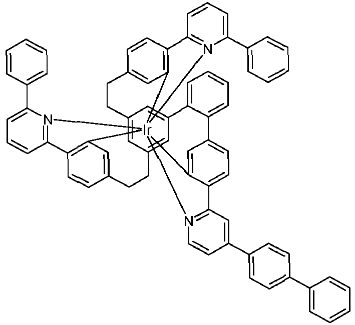 |
| 636 | 637 |
| 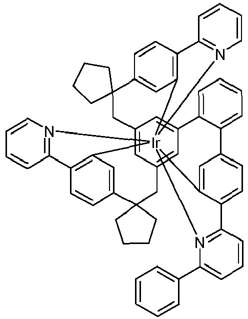 | 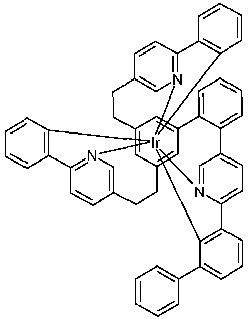 |
| 638 | 639 |
| 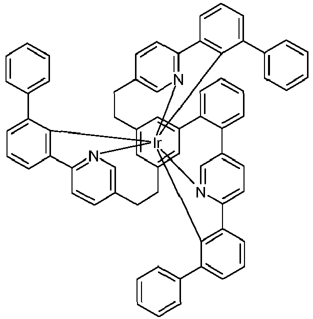 | 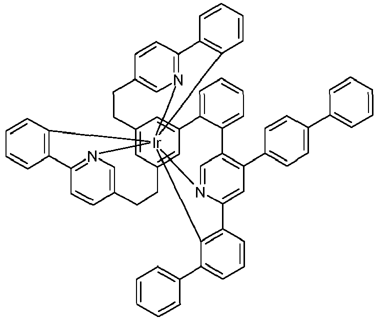 |
| 640 | 641 |
| 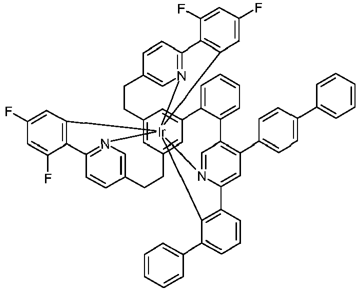 | 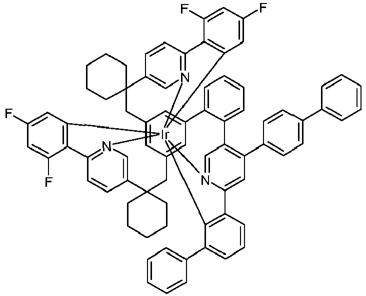 |
| 642 | 643 |
| 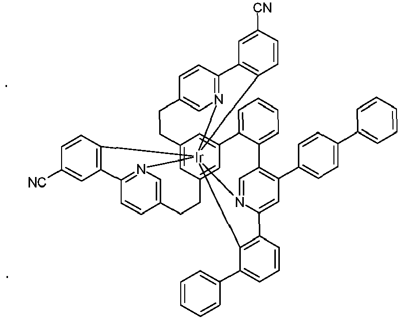 | 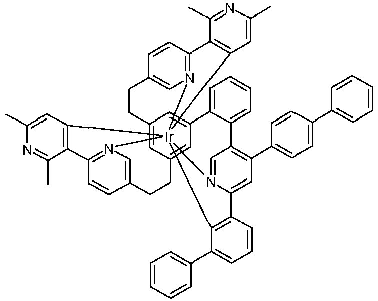 |
| 654 | 646 |
| 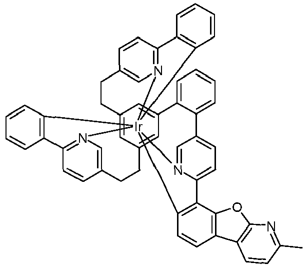 | 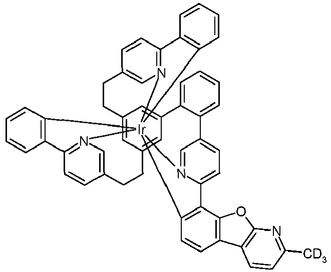 |
| 647 | 648 |
| 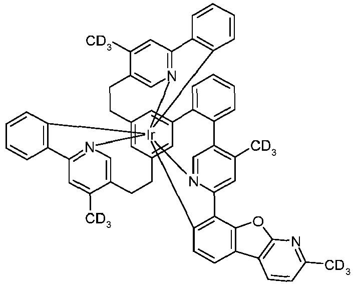 | 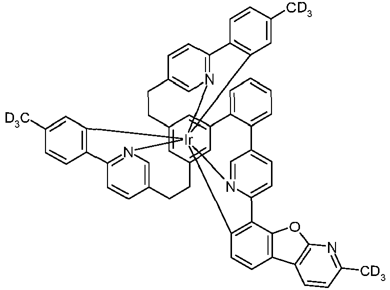 |
| 649 | 650 |
| 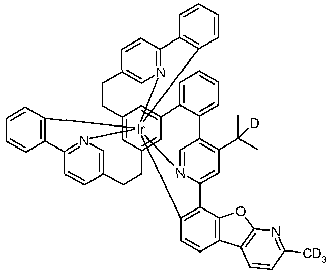 | 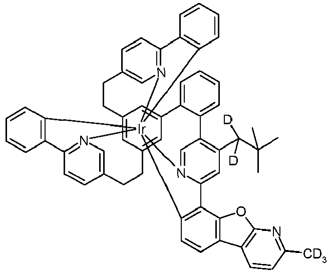 |
| 651 | 652 |
| 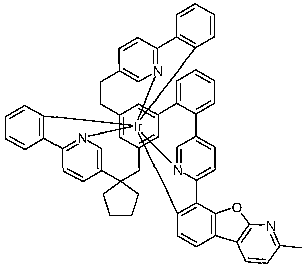 | 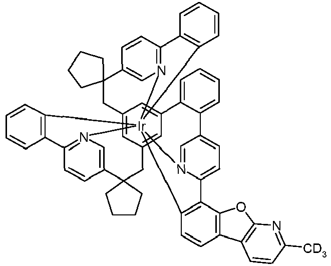 |
| 653 | 654 |
| 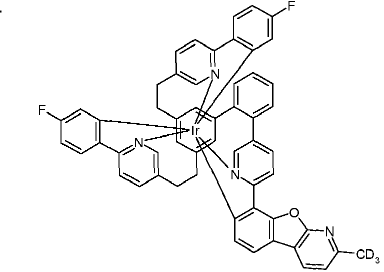 | 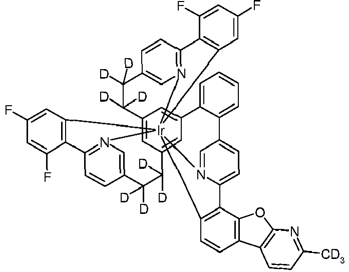 |
| 655 | 656 |
| 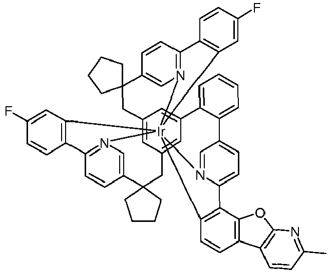 | 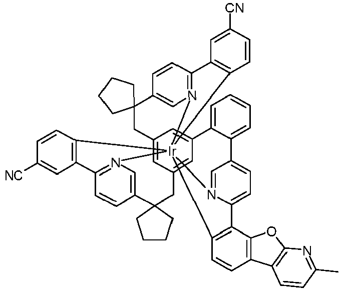 |
| 657 | 658 |
| 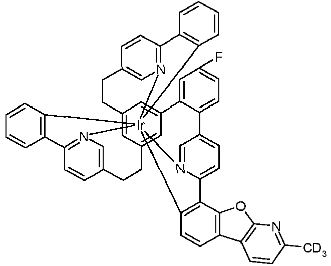 | 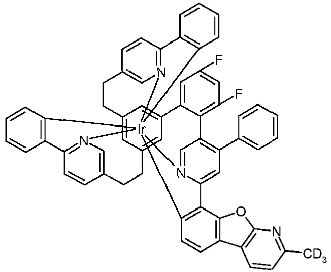 |
| 659 | 660 |
| 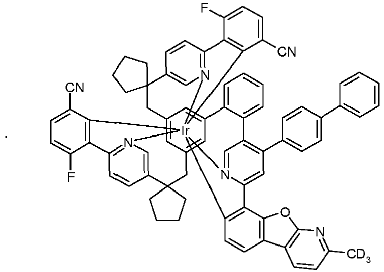 | 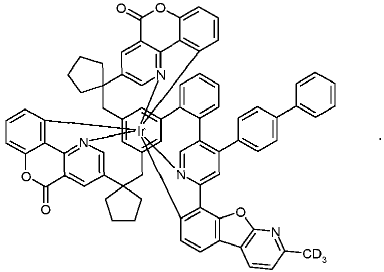 |
| 661 | 662 |
| 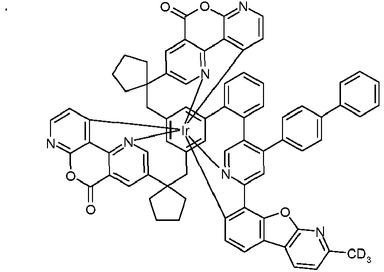 | 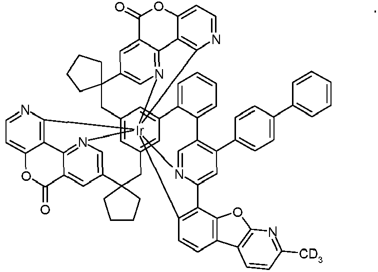 |
| 663 | 664 |
| 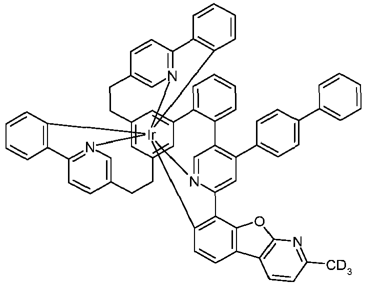 | 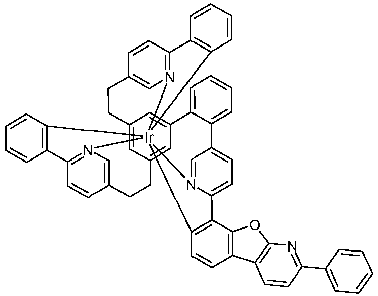 |
| 665 | 666 |
| 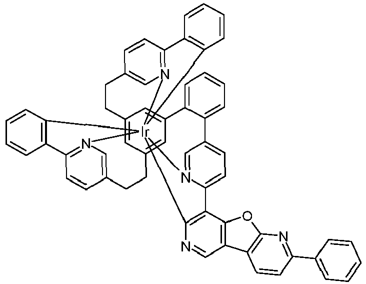 | 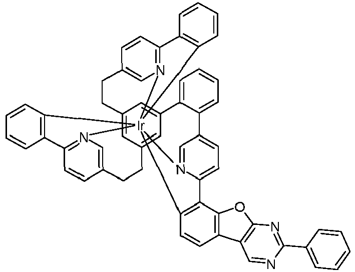 |
| 667 | 668 |
| 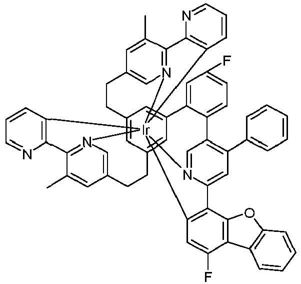 | 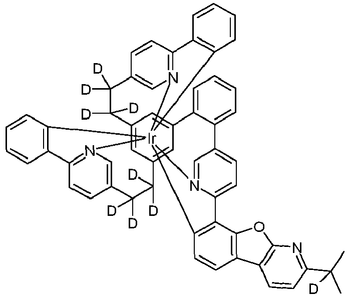 |
| 669 | 670 |
| 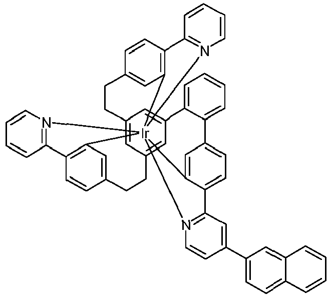 | 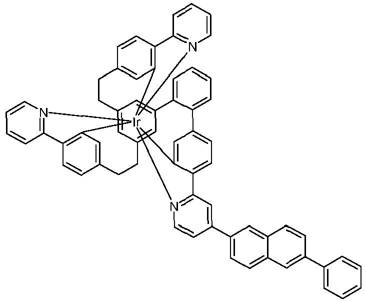 |
| 671 | 672 |
| 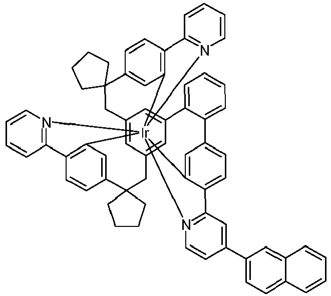 | 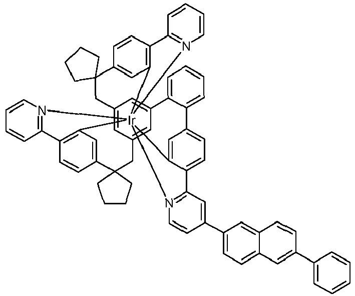 |
| 673 | 674 |
| 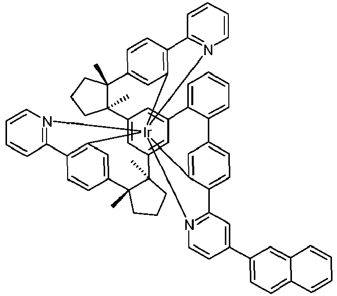 | 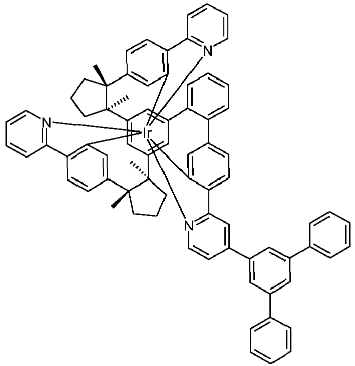 |
| 675 | 676 |
| 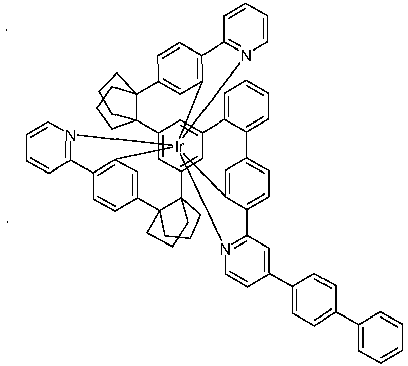 | 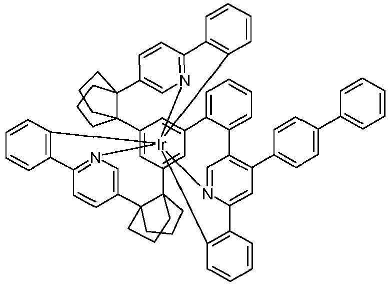 |
| 677 | 678 |
| 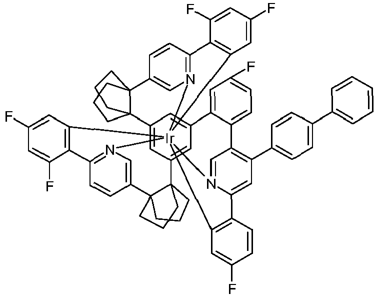 | 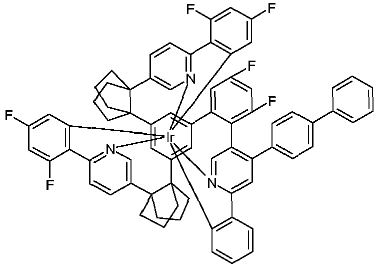 |
| 679 | 680 |
| 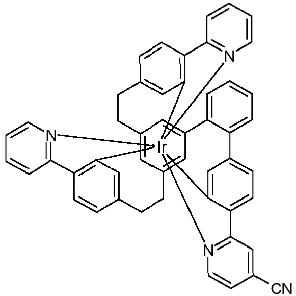 | 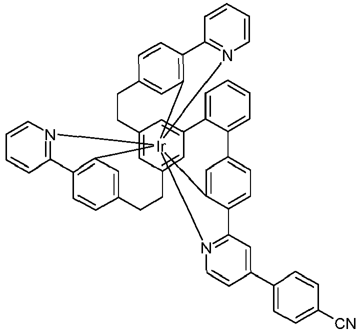 |
| 681 | 682 |
| 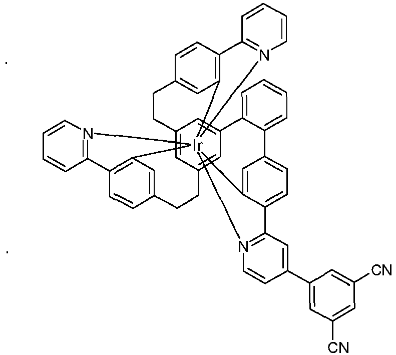 | 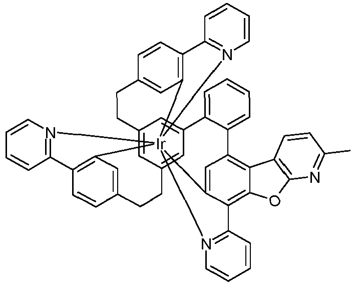 |
| 683 | 684 |
| 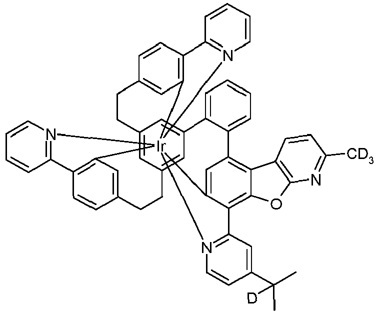 | 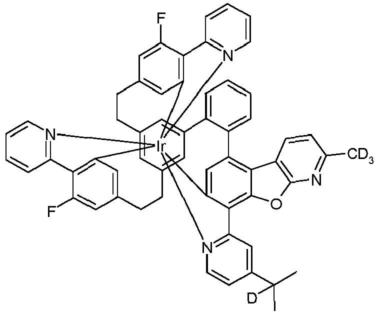 |
| 685 | 686 |
| 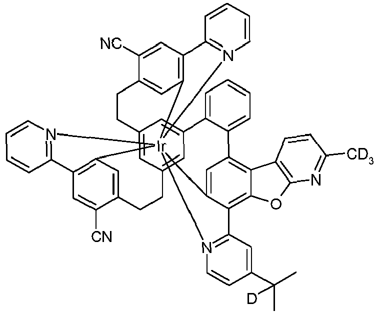 | 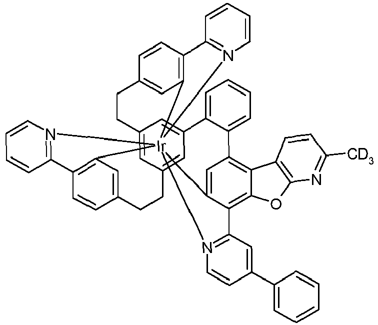 |
| 687 | 688 |
| 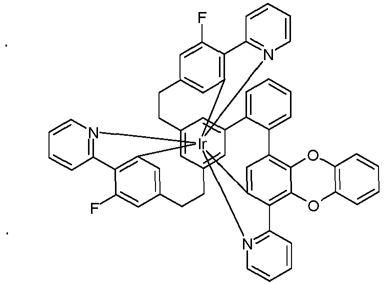 | 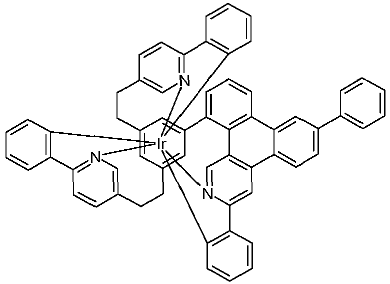 |
| 689 | 690 |
| 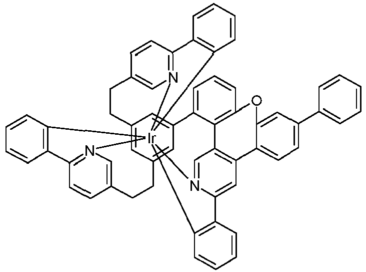 | 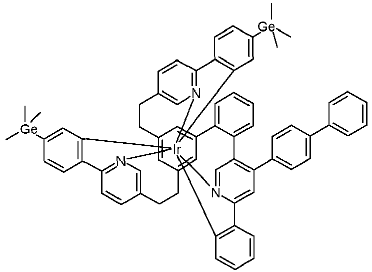 |
| 691 | 692 |
| 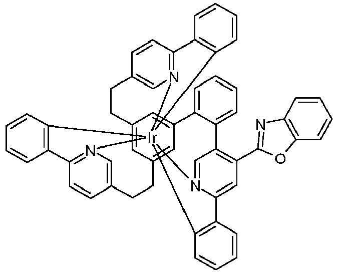 | 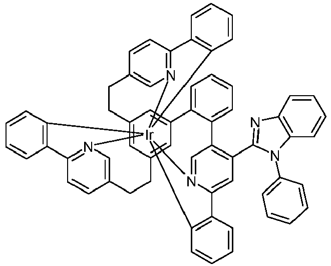 |
| 693 | 694 |
| 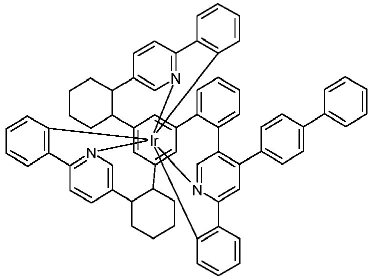 | 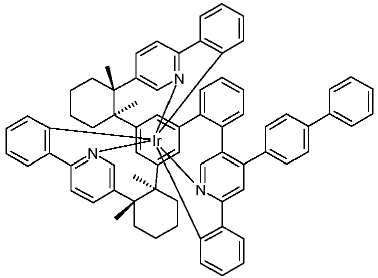 |
| 695 | 696 |

Bei den erfindungsgemäßen Iridiumkomplexen handelt es sich um chirale Strukturen. Wenn zusätzlich auch der tripodale Ligand der Komplexe chiral ist, ist die Bildung von Diastereomeren und mehreren Enantiomerenpaaren möglich. Die erfindungsgemäßen Komplexe umfassen dann sowohl die Mischungen der verschiedenen Diastereomere bzw. die entsprechenden Racemate wie auch die einzelnen isolierten Diastereomere bzw. Enantiomere.

Werden in der ortho-Metallierung Liganden mit zwei identischen Teilliganden eingesetzt, fällt üblicherweise ein racemisches Gemisch der C₁-symmetrischen Komplexe, also des Δ- und des A-Enantiomers, an. Diese können durch gängige Methoden (Chromatographie an chiralen Materialien / Säulen oder Racemattrennung durch Kristallisation) getrennt werden.

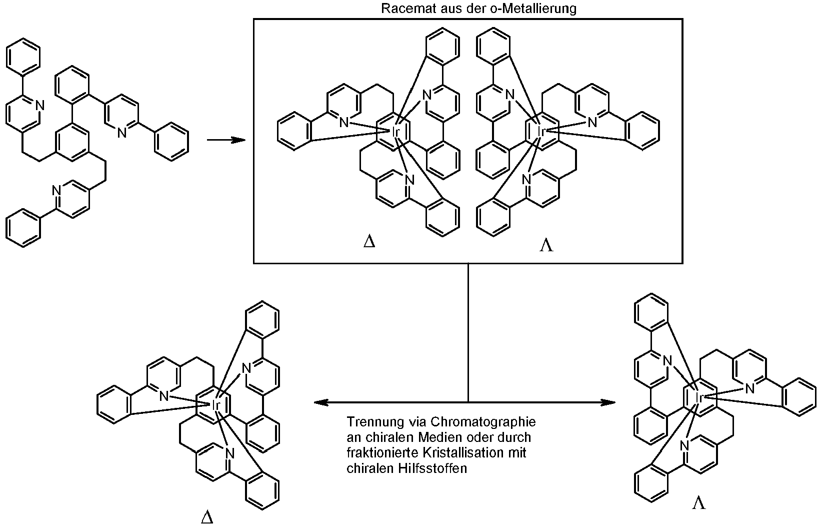

Die Racemattrennung via fraktionierter Kristallisation von diastereomeren Salzpaaren kann nach üblichen Methoden erfolgen. Hierzu bietet es sich an, die neutralen Ir(III)-Komplexe zu oxidieren (z. B. mit Peroxiden, H₂O₂ oder elektrochemisch), die so erzeugten kationischen Ir(IV)-Komplexe mit dem Salz einer enantiomerenreinen, monoanionischen Base (chirale Base) zu versetzen, die so erzeugten diasteromeren Salze durch fraktionierte Kristallisation zu trennen und diese dann mit Hilfe eines Reduktionsmittels (z. B. Zink, Hydrazinhydrat, Ascorbinsäure, etc.) zu den enantiomerenreinen neutralen Komplex zu reduzieren, wie im Folgenden schematisch dargestellt.

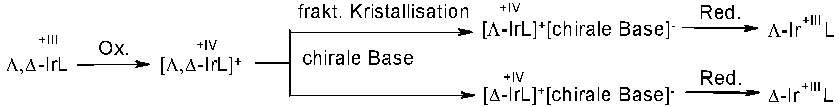

Daneben ist eine enantiomerenreine bzw. enantiomerenanreichernde Synthese durch Komplexierung in einem chiralen Medium (z. B. R- oder S-1,1 -Binaphthol) möglich.

Werden in der Komplexierung Liganden mit drei unterschiedlichen Teilliganden eingesetzt, fällt üblicherweise ein Diastereomerengemisch der Komplexe an, das durch gängige Methoden (Chromatographie, Kristallisation, etc.) getrennt werden kann.

Enantiomerenreine C₁-symmetrische Komplexe können auch gezielt synthetisiert werden, wie im folgenden Schema dargestellt. Dazu wird ein enantiomerenreiner, C₁-symmetrischer Ligand dargestellt, komplexiert, das erhaltene Diasteroemerengemisch wird getrennt und anschließend wird die chirale Gruppe abgespalten.

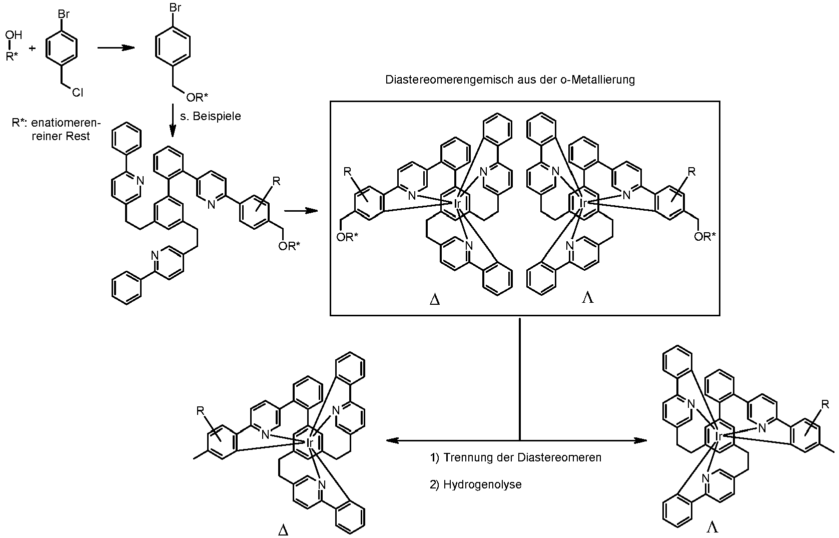

Die erfindungsgemäßen Verbindungen sind prinzipiell durch verschiedene Verfahren darstellbar. Generell wird hierzu ein Iridiumsalz mit dem entsprechenden freien Liganden umgesetzt.

Daher ist ein weiterer Gegenstand der vorliegenden Erfindung ein Verfahren zur Herstellung der erfindungsgemäßen Verbindungen durch Umsetzung der entsprechenden freien Liganden mit Iridiumalkoholaten der Formel (51), mit Iridiumketoketonaten der Formel (52), mit Iridiumhalogeniden der Formel (53) oder mit Iridiumcarboxylaten der Formel (54),

Ir(OR)₃ Formel (51)

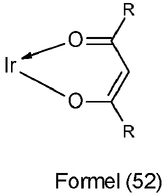

IrHaI₃ Formel (53)

Ir(OOCR)₃ Formel (54)

wobei R die oben angegebenen Bedeutungen hat, Hal = F, Cl, Br oder I ist und die Iridiumedukte auch als die entsprechenden Hydrate vorliegen können. Dabei steht R bevorzugt für eine Alkylgruppe mit 1 bis 4 C-Atomen.

Es können ebenfalls Iridiumverbindungen, die sowohl Alkoholat- und/oder Halogenid- und/oder Hydroxy- wie auch Ketoketonatreste tragen, verwendet werden. Diese Verbindungen können auch geladen sein. Entsprechende Iridiumverbindungen, die als Edukte besonders geeignet sind, sind in WO 2004/085449 offenbart. Besonders geeignet sind [IrCl₂(acac)₂]⁻, beispielsweise Na[IrCl₂(acac)₂], Metallkomplexe mit Acetylacetonat-Derivaten als Ligand, beispielsweise Ir(acac)₃ oder Tris(2,2,6,6-Tetramethylheptan-3,5-dionato)iridium, und IrCl₃·xH₂O, wobei x üblicherweise für eine Zahl zwischen 2 und 4 steht.

Die Synthese der Komplexe wird bevorzugt durchgeführt wie in WO 2002/060910 und in WO 2004/085449 beschrieben. Dabei kann die Synthese beispielsweise auch thermisch, photochemisch und/oder durch Mikrowellenstrahlung aktiviert werden. Weiterhin kann die Synthese auch im Autoklaven bei erhöhtem Druck und/oder erhöhter Temperatur durchgeführt werden.

Die Reaktionen können ohne Zusatz von Lösemitteln oder Schmelzhilfen in einer Schmelze der entsprechenden zu o-metallierenden Liganden durchgeführt werden. Gegebenenfalls können auch Lösemittel oder Schmelzhilfen zugesetzt werden. Geeignete Lösemittel sind protische oder aprotische Lösemittel, wie aliphatische und / oder aromatische Alkohle (Methanol, Ethanol, iso-Propanol, t-Butanol, etc.), Oligo- und Polyalkohole (Ethylenglykol, 1,2-Propandiol, Glycerin, etc.), Alkoholether (Ethoxyethanol, Diethylenglykol, Triethylenglycol, Polyethylenglykol, etc.), Ether (Di- und Triethylenglykoldimethylether, Diphenylether, etc.), aromatische, heteroaromatische und oder aliphatische Kohlenwasserstoffe (Toluol, Xylol, Mesitylen, Chlorbenzol, Pyridin, Lutidin, Chinolin, Isochinolin, Tridecan, Hexadecan, etc.), Amide (DMF, DMAC, etc.), Lactame (NMP), Sulfoxide (DMSO) oder Sulfone (Dimethylsulfon, Sulfolan, etc.). Geeignete Schmelzhilfen sind Verbindungen, die bei Rautemperatur fest vorliegen, jedoch beim Erwärmen der Reaktionsmischung schmelzen und die Reaktanden lösen, so dass eine homogene Schmelze entsteht. Besonders geeignet sind Biphenyl, m-Terphenyl, Triphenylen, R- oder S-Binaphthol oder auch das entsprechende Racemat, 1,2-, 1,3-, 1,4-Bis-phenoxybenzol, Triphenylphosphinoxid, 18-Krone-6, Phenol, 1-Naphthol, Hydrochinon, etc.. Dabei ist die Verwendung von Hydrochinon besonders bevorzugt.

Durch diese Verfahren, gegebenenfalls gefolgt von Aufreinigung, wie z. B. Umkristallisation oder Sublimation, lassen sich die erfindungsgemäßen Verbindungen gemäß Formel (1) in hoher Reinheit, bevorzugt mehr als 99 % (bestimmt mittels ¹H-NMR und/oder HPLC) erhalten.

Die erfindungsgemäßen Verbindungen können auch durch geeignete Substitution, beispielsweise durch längere Alkylgruppen (ca. 4 bis 20 C-Atome), insbesondere verzweigte Alkylgruppen, oder gegebenenfalls substituierte Arylgruppen, beispielsweise Xylyl-, Mesityl- oder verzweigte Terphenyl- oder Quaterphenylgruppen, löslich gemacht werden. Insbesondere auch die Verwendung von ankondensierten aliphatischen Gruppen, wie sie beispielsweise durch die oben offenbarten Formeln (44) bis (50) dargestellt werden, führt zu einer deutlichen Verbesserung der Löslichkeit der Metallkomplexe. Solche Verbindungen sind dann in gängigen organischen Lösemitteln, wie beispielsweise Toluol oder Xylol bei Raumtemperatur in ausreichender Konzentration löslich, um die Komplexe aus Lösung verarbeiten zu können. Diese löslichen Verbindungen eignen sich besonders gut für die Verarbeitung aus Lösung, beispielsweise durch Druckverfahren.

Für die Verarbeitung der erfindungsgemäßen Iridiumkomplexe aus flüssiger Phase, beispielsweise durch Spin-Coating oder durch Druckverfahren, sind Formulierungen der erfindungsgemäßen Iridiumkomplexe erforderlich. Diese Formulierungen können beispielsweise Lösungen, Dispersionen oder Emulsionen sein. Es kann bevorzugt sein, hierfür Mischungen aus zwei oder mehr Lösemitteln zu verwenden. Geeignete und bevorzugte Lösemittel sind beispielsweise Toluol, Anisol, o-, m- oder p-Xylol, Methylbenzoat, Mesitylen, Tetralin, Veratrol, THF, Methyl-THF, THP, Chlorbenzol, Dioxan, Phenoxytoluol, insbesondere 3-Phenoxytoluol, (-)-Fenchon, 1,2,3,5-Tetramethylbenzol, 1,2,4,5-Tetramethylbenzol, 1-Methylnaphthalin, 2-Methylbenzothiazol, 2-Phenoxyethanol, 2-Pyrrolidinon, 3-Methylanisol, 4-Methylanisol, 3,4-Dimethylanisol, 3,5-Dimethylanisol, Acetophenon, α-Terpineol, Benzothiazol, Butylbenzoat, Cumol, Cyclohexanol, Cyclohexanon, Cyclohexylbenzol, Decalin, Dodecylbenzol, Ethylbenzoat, Indan, NMP, p-Cymol, Phenetol, 1,4-Diisopropylbenzol, Dibenzylether, Diethylenglycolbutylmethylether, Triethylenglycolbutylmethylether, Diethylenglycoldibutylether, Triethylenglycoldimethylether, Diethylenglycolmonobutylether, Tripropylenglycoldimethylether, Tetraethylenglycoldimethylether, 2-Isopropylnaphthalin, Pentylbenzol, Hexylbenzol, Heptylbenzol, Octylbenzol, 1,1-Bis(3,4-dimethylphenyl)ethan, Hexamethylindan, 2-Methylbiphenyl, 3-Methylbiphenyl, 1-Methylnaphthalin, 1-Ethylnaphthalin, Ethyloctanoat, Sebacinsäure-diethylester, Octyloctanoat, Heptylbenzol, Menthyl-isovalerat, Cyclohexylhexanoat oder Mischungen dieser Lösemittel.

Ein weiterer Gegenstand der vorliegenden Erfindung ist daher eine Formulierung, enthaltend mindestens eine erfindungsgemäßen Verbindung und mindestens eine weitere Verbindung. Die weitere Verbindung kann beispielsweise ein Lösemittel sein, insbesondere eines der oben genannten Lösemittel oder eine Mischung dieser Lösemittel. Die weitere Verbindung kann aber auch eine weitere organische oder anorganische Verbindung sein, die ebenfalls in der elektronischen Vorrichtung eingesetzt wird, beispielsweise ein Matrixmaterial. Diese weitere Verbindung kann auch polymer sein.

Die erfindungsgemäße Verbindung kann in der elektronischen Vorrichtung als aktive Komponente, bevorzugt als Emitter in der emissiven Schicht oder als Loch- oder Elektronentransportmaterial in einer loch- bzw. elektronentransportierenden Schicht, oder als Sauerstoff-Sensibilisatoren oder als Photoinitiator oder Photokatalysator verwendet werden. Ein weiterer Gegenstand der vorliegenden Erfindung ist somit die Verwendung einer erfindungsgemäßen Verbindung in einer elektronischen Vorrichtung oder als Sauerstoff-Sensibilisator oder als Photoinitiator oder Photokatalysator. Enantiomerenreine erfindungsgemäße Iridiumkomplexe eignen sich als Photokatalysatoren für chirale photoinduzierte Synthesen.

Nochmals ein weiterer Gegenstand der vorliegenden Erfindung ist eine elektronische Vorrichtung enthaltend mindestens eine erfindungsgemäße Verbindung.

Unter einer elektronischen Vorrichtung wird eine Vorrichtung verstanden, welche Anode, Kathode und mindestens eine Schicht enthält, wobei diese Schicht mindestens eine organische bzw. metallorganische Verbindung enthält. Die erfindungsgemäße elektronische Vorrichtung enthält also Anode, Kathode und mindestens eine Schicht, welche mindestens einen erfindungsgemäßen Iridiumkomplex enthält. Dabei sind bevorzugte elektronische Vorrichtungen ausgewählt aus der Gruppe bestehend aus organischen Elektrolumineszenzvorrichtungen (OLEDs, PLEDs), organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), wobei hierunter sowohl rein organische Solarzellen wie auch farbstoffsensibilisierte Solarzellen verstanden werden, organischen optischen Detektoren, organischen Photorezeptoren, organischen Feld-Quench-Devices (O-FQDs), lichtemittierenden elektrochemischen Zellen (LECs), Sauerstoff-Sensoren oder organischen Laserdioden (O-Laser), enthaltend in mindestens einer Schicht mindestens eine erfindungsgemäße Verbindung. Verbindungen, die im Infraroten emittieren, eignen sich für den Einsatz in organischen Infrarot-Elektrolumineszenzvorrichtungen und InfrarotSensoren. Besonders bevorzugt sind organische Elektrolumineszenzvorrichtungen. Aktive Komponenten sind generell die organischen oder anorganischen Materialien, welche zwischen Anode und Kathode eingebracht sind, beispielsweise Ladungsinjektions-, Ladungstransport- oder Ladungsblockiermaterialien, insbesondere aber Emissionsmaterialien und Matrixmaterialien. Die erfindungsgemäßen Verbindungen zeigen besonders gute Eigenschaften als Emissionsmaterial in organischen Elektrolumineszenzvorrichtungen. Eine bevorzugte Ausführungsform der Erfindung sind daher organische Elektrolumineszenzvorrichtungen. Weiterhin können die erfindungsgemäßen Verbindungen zur Erzeugung von Singulett-Sauerstoff oder in der Photokatalyse eingesetzt werden.

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten, Ladungserzeugungsschichten und/oder organische oder anorganische p/n-Übergänge. Dabei ist es möglich, dass eine oder mehrere Lochtransportschichten p-dotiert sind, beispielsweise mit Metalloxiden, wie MoOs oder WO₃, oder mit (per)fluorierten elektronenarmen Aromaten oder mit elektronenarmen Cyano-substituieren Heteroaromaten (z. B. gemäß JP 4747558, JP 2006-135145, US 2006/0289882, WO 2012/095143), oder mit chinoiden Systemen (z. B. gemäß EP1336208) oder mit LewisSäuren, oder mit Boranen (z. B. gemäß US 2003/0006411, WO 2002/051850, WO 2015/049030) oder mit Carboxylaten der Elemente der 3. , 4. oder 5. Hauptgruppe (WO 2015/018539) und/oder dass eine oder mehrere Elektronentransportschichten n-dotiert sind.

Ebenso können zwischen zwei emittierende Schichten Interlayers eingebracht sein, welche beispielsweise eine Exzitonen-blockierende Funktion aufweisen und/oder die Ladungsbalance in der Elektrolumineszenzvorrichtung steuern und/oder Ladungen erzeugen (Charge-Generation-Layer, z. B. in Schichtsystemen mit mehreren emittierenden Schichten, z. B. in weiß emittierenden OLED-Bauteilen) . Es sei aber darauf hingewiesen, dass nicht notwendigerweise jede dieser Schichten vorhanden sein muss.

Dabei kann die organische Elektrolumineszenzvorrichtung eine emittierende Schicht enthalten, oder sie kann mehrere emittierende Schichten enthalten. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Insbesondere bevorzugt sind Dreischichtsysteme, wobei die drei Schichten blaue, grüne und orange oder rote Emission zeigen (für den prinzipiellen Aufbau siehe z. B. WO 2005/011013) bzw. Systeme, welche mehr als drei emittierende Schichten aufweisen. Es kann sich auch um ein Hybrid-System handeln, wobei eine oder mehrere Schichten fluoreszieren und eine oder mehrere andere Schichten phosphoreszieren. Eine bevorzugte Ausführungsform sind Tandem-OLEDs. Weiß emittierende organische Elektrolumineszenzvorrichtungen können für Beleuchtungsanwendungen oder mit Farbfilter auch für Vollfarb-Displays verwendet werden.

In einer bevorzugten Ausführungsform der Erfindung enthält die organische Elektrolumineszenzvorrichtung den erfindungsgemäßen Iridiumkomplex als emittierende Verbindung in einer oder mehreren emittierenden Schichten.

Wenn der erfindungsgemäße Iridiumkomplex als emittierende Verbindung in einer emittierenden Schicht eingesetzt wird, wird er bevorzugt in Kombination mit einem oder mehreren Matrixmaterialien eingesetzt. Die Mischung aus dem erfindungsgemäßen Iridiumkomplex und dem Matrixmaterial enthält zwischen 0.1 und 99 Vol.-%, vorzugsweise zwischen 1 und 90 Vol.-%, besonders bevorzugt zwischen 3 und 40 Vol.-%, insbesondere zwischen 5 und 15 Vol.-% des erfindungsgemäßen Iridiumkomplexes bezogen auf die Gesamtmischung aus Emitter und Matrixmaterial. Entsprechend enthält die Mischung zwischen 99.9 und 1 Vol.-%, vorzugsweise zwischen 99 und 10 Vol.-%, besonders bevorzugt zwischen 97 und 60 Vol.-%, insbesondere zwischen 95 und 85 Vol.-% des Matrixmaterials bezogen auf die Gesamtmischung aus Emitter und Matrixmaterial.

Als Matrixmaterial können generell alle Materialien eingesetzt werden, die gemäß dem Stand der Technik hierfür bekannt sind. Bevorzugt ist das Triplett-Niveau des Matrixmaterials höher als das Triplett-Niveau des Emitters.

Geeignete Matrixmaterialien für die erfindungsgemäßen Verbindungen sind Ketone, Phosphinoxide, Sulfoxide und Sulfone, z. B. gemäß WO 2004/013080, WO 2004/093207, WO 2006/005627 oder WO 2010/006680, Triarylamine, Carbazolderivate, z. B. CBP (N,N-Bis-carbazolylbiphenyl), m-CBP oder die in WO 2005/039246, US 2005/0069729, JP 2004/288381, EP 1205527, WO 2008/086851 oder US 2009/0134784 offenbarten Carbazolderivate, Biscarbazolderivate, Indolocarbazolderivate, z. B. gemäß WO 2007/063754 oder WO 2008/056746, Indenocarbazolderivate, z. B. gemäß WO 2010/136109 oder WO 2011/000455, Azacarbazole, z. B. gemäß EP 1617710, EP 1617711, EP 1731584, JP 2005/347160, bipolare Matrixmaterialien, z. B. gemäß WO 2007/137725, Silane, z. B. gemäß WO 2005/111172, Azaborole oder Boronester, z. B. gemäß WO 2006/117052, Diazasilolderivate, z. B. gemäß WO 2010/054729, Diazaphospholderivate, z. B. gemäß WO 2010/054730, Triazinderivate, z. B. gemäß WO 2010/015306, WO 2007/063754 oder WO 2008/056746, Zinkkomplexe, z. B. gemäß EP 652273 oder WO 2009/062578, Dibenzofuranderivate, z. B. gemäß WO 2009/148015 oder WO 2015/169412, oder verbrückte Carbazolderivate, z. B. gemäß US 2009/0136779, WO 2010/050778, WO 2011/042107 oder WO 2011/088877. Für lösungsprozessierte OLEDs eignen sich als Matrixmaterialien auch Polymere, z. B. gemäß WO 2012/008550 oder WO 2012/048778, Oligomere oder Dendrimere, z. B. gemäß Journal of Luminescence 183 (2017), 150-158.

Es kann auch bevorzugt sein, mehrere verschiedene Matrixmaterialien als Mischung einzusetzen, insbesondere mindestens ein elektronenleitendes Matrixmaterial und mindestens ein lochleitendes Matrixmaterial. Eine bevorzugte Kombination ist beispielsweise die Verwendung eines aromatischen Ketons, eines Triazin-Derivats oder eines Phosphinoxid-Derivats mit einem Triarylamin-Derivat oder einem Carbazol-Derivat als gemischte Matrix für den erfindungsgemäßen Metallkomplex. Ebenso bevorzugt ist die Verwendung einer Mischung aus einem ladungstransportierenden Matrixmaterial und einem elektrisch inerten Matrixmaterial (so genannter "wide bandgap host"), welches nicht bzw. nicht in wesentlichem Maße am Ladungstransport beteiligt ist, wie z. B. in WO 2010/108579 oder WO 2016/184540 beschrieben. Ebenso bevorzugt ist die Verwendung von zwei elektronentransportierenden Matrixmaterialien, beispielsweise Triazinderivaten und Lactamderivaten, wie z. B. in WO 2014/094964 beschrieben.

Nachfolgend sind Beispiele für Verbindungen abgebildet, die sich als Matrixmaterialien für die erfindungsgemäßen Verbindungen eignen.

Beispiele für Triazine und Pyrimidine, welche als elektronentransportierende Matrixmaterialien eingesetzt werden können, sind die folgenden Strukturen:

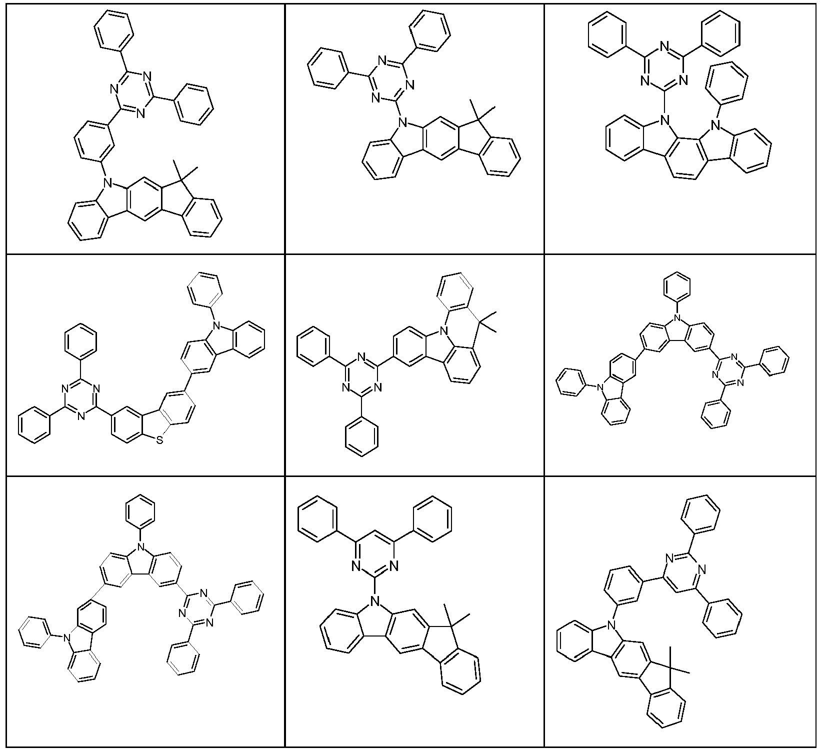

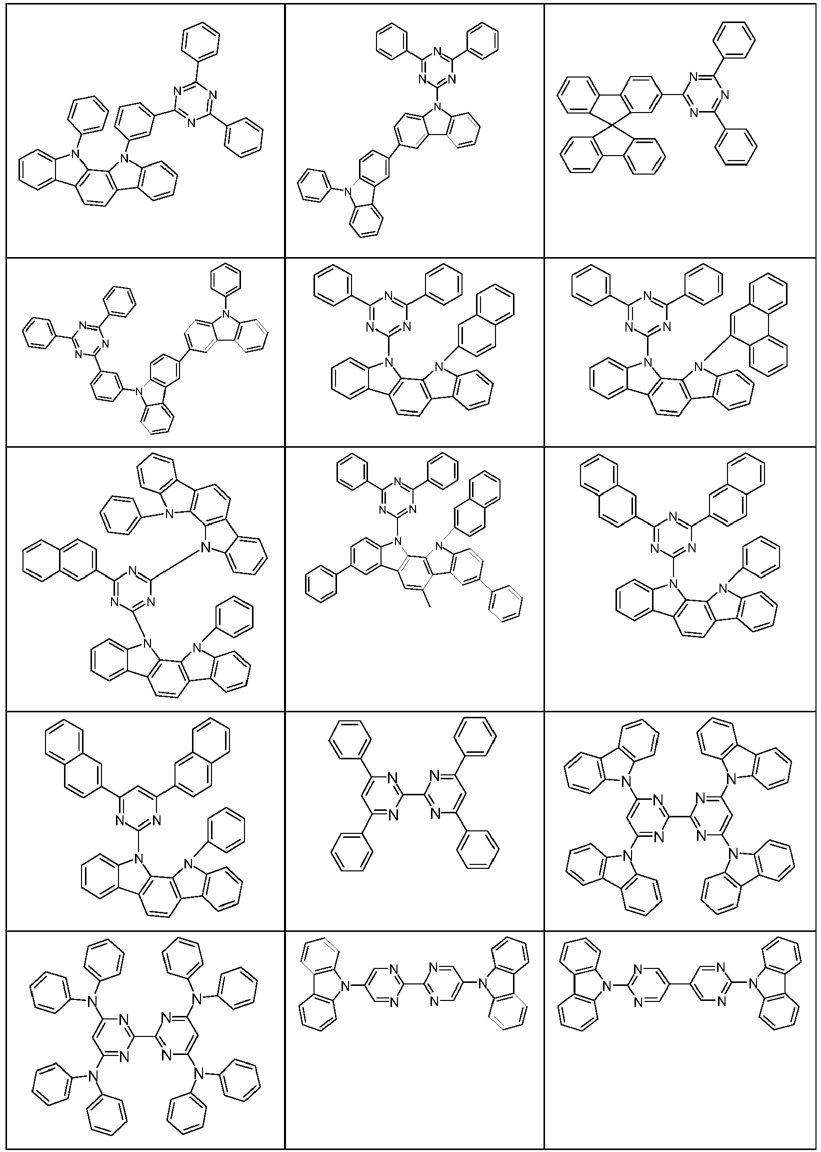

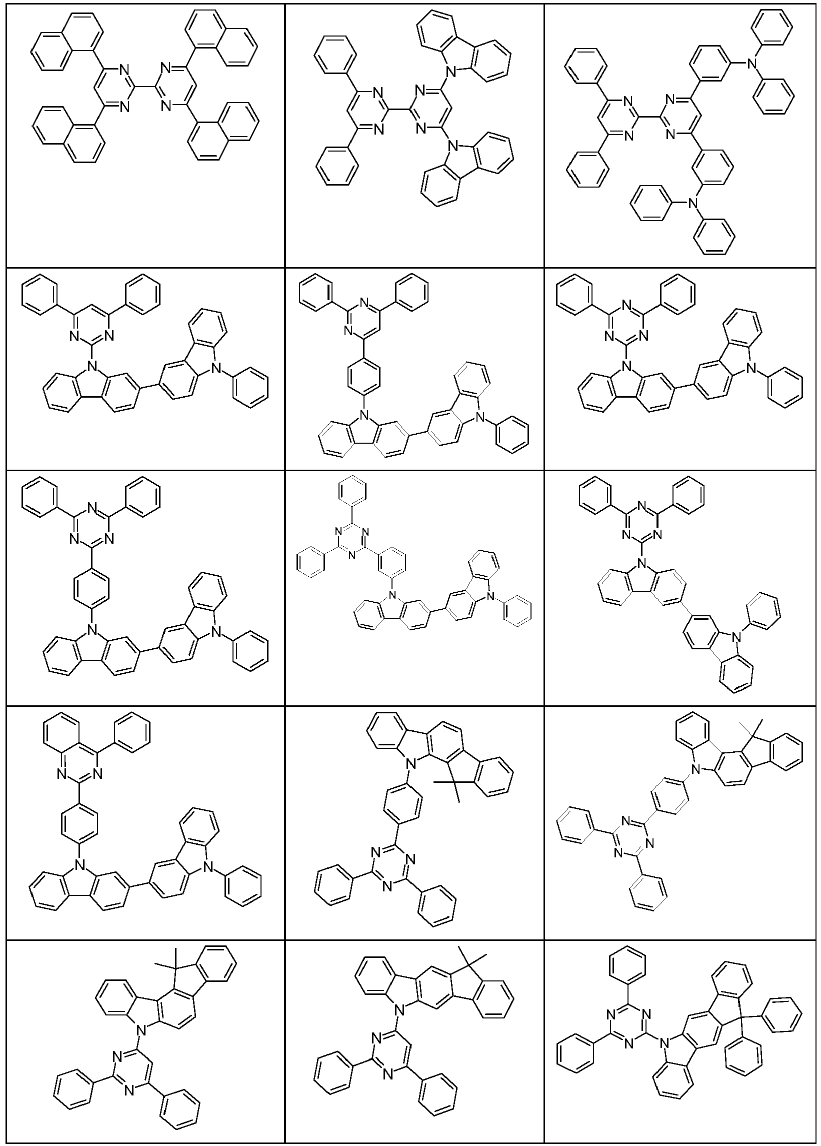

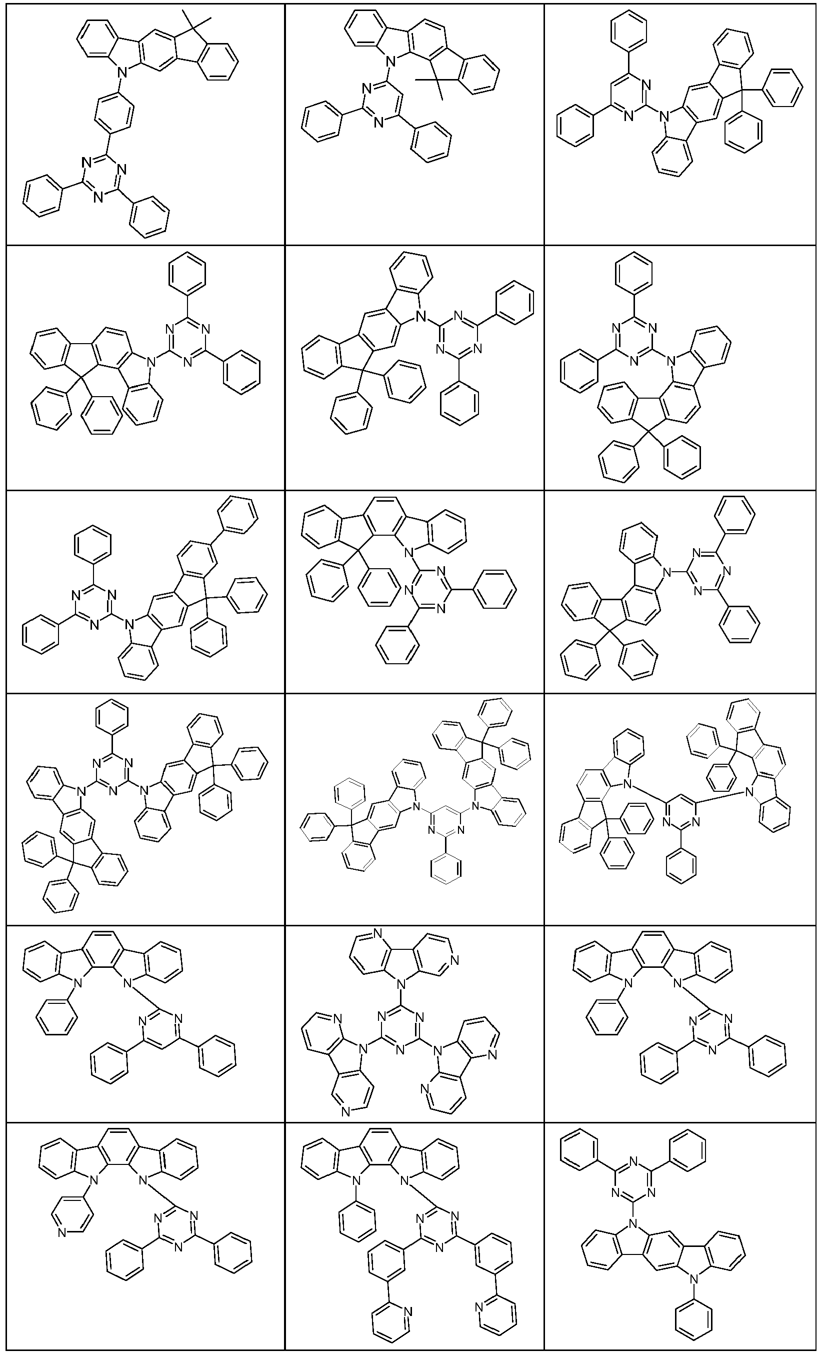

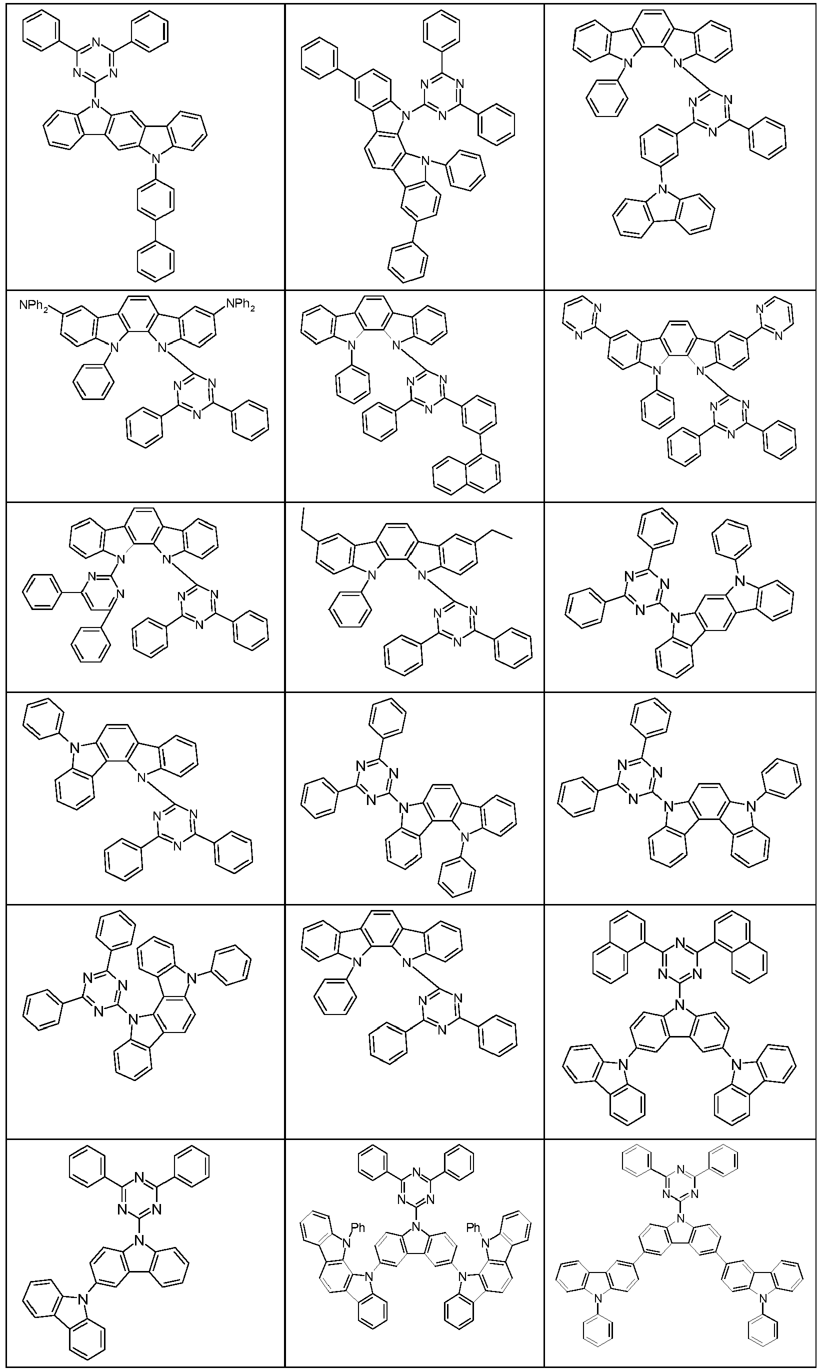

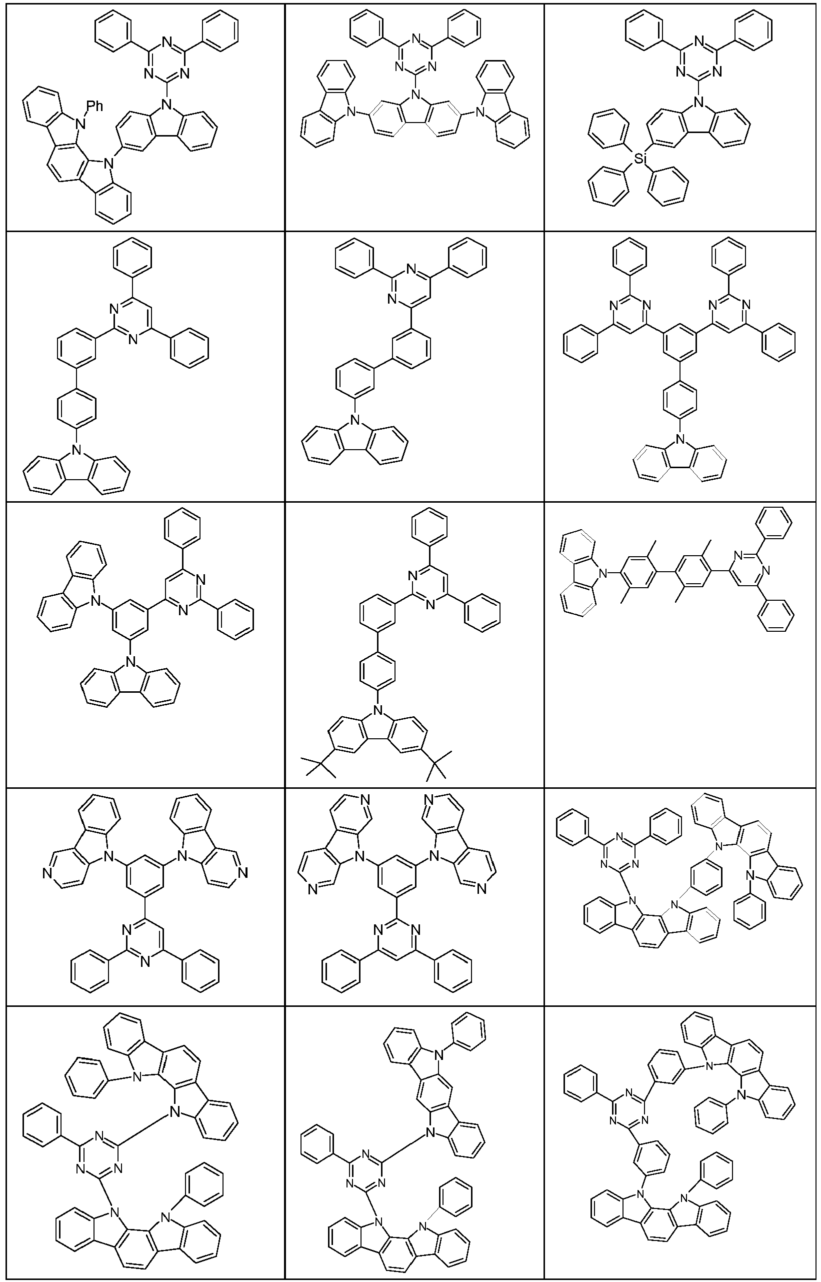

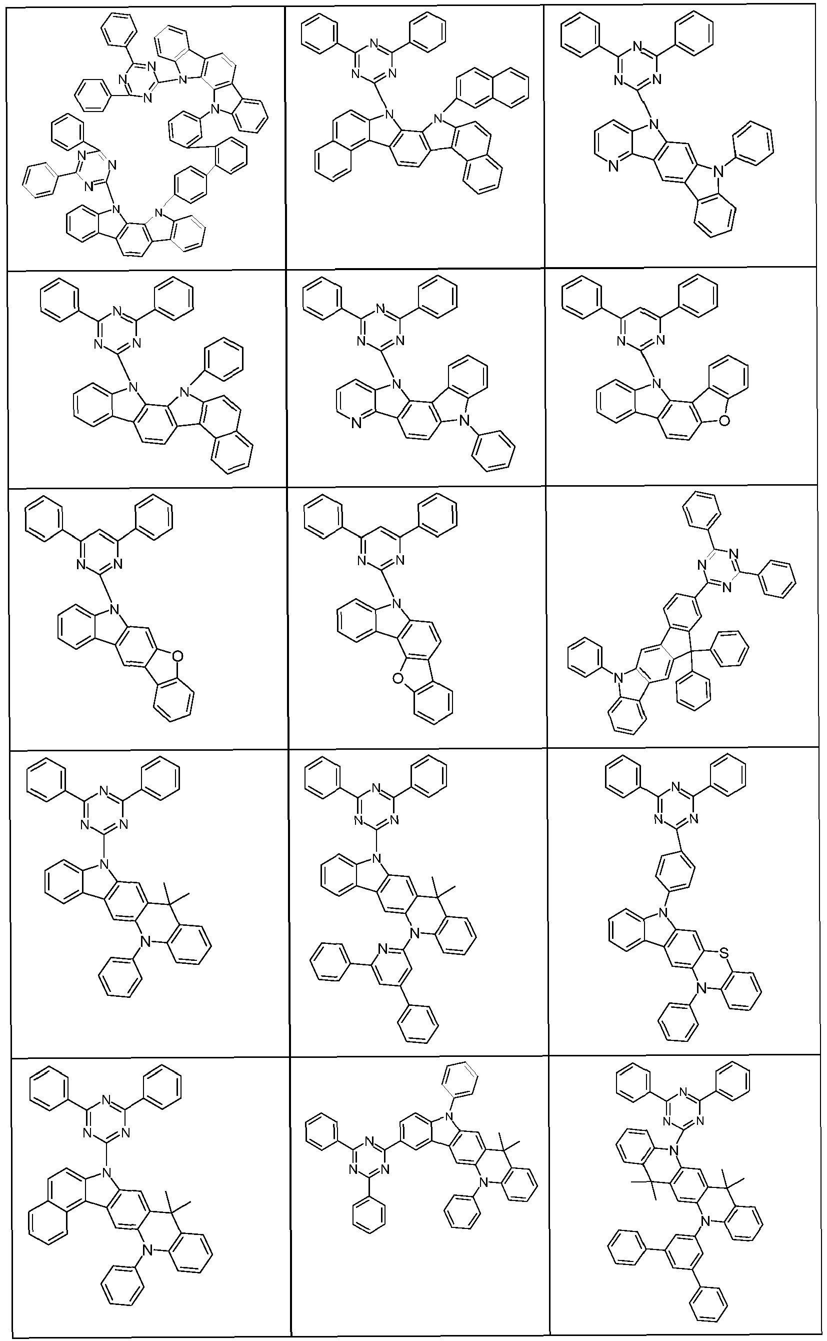

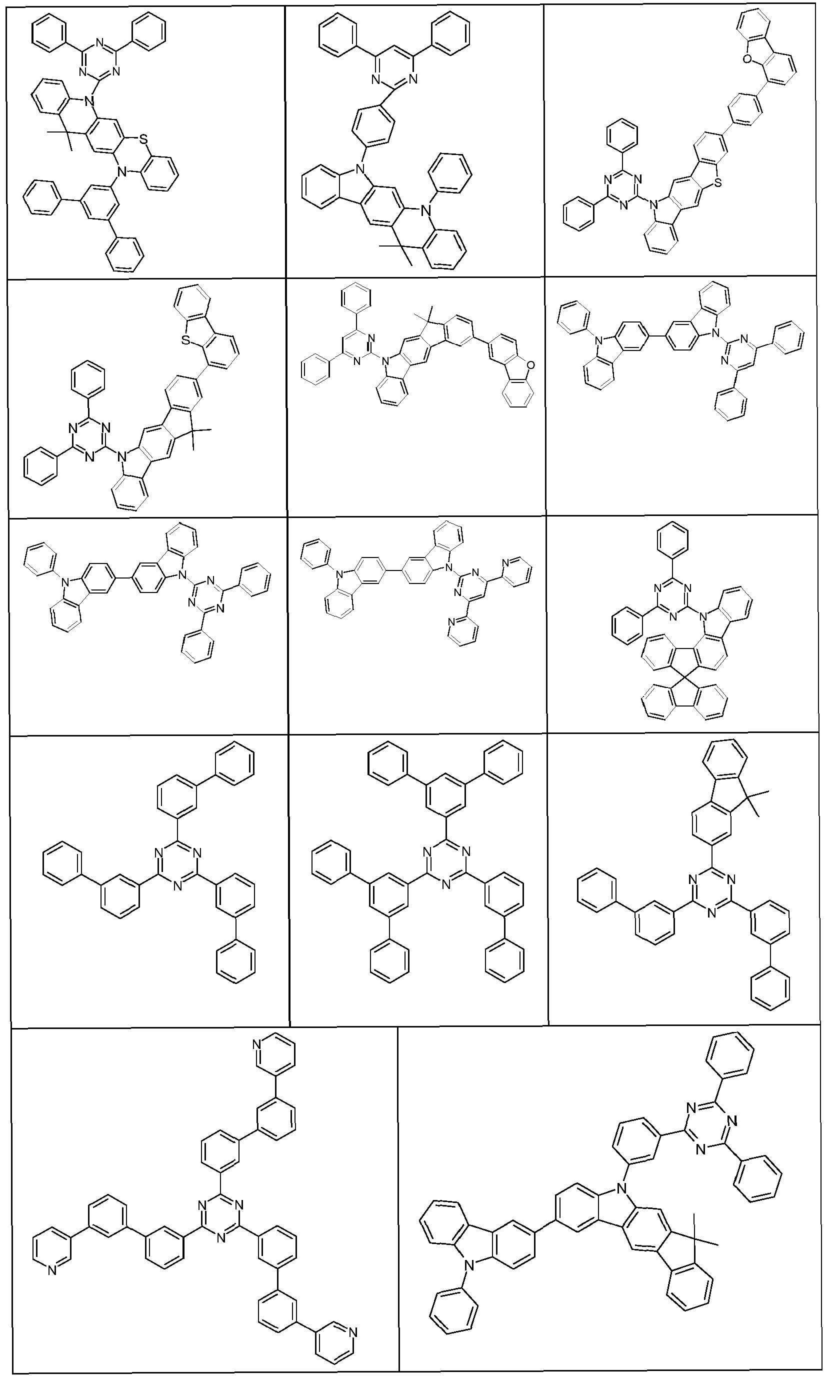

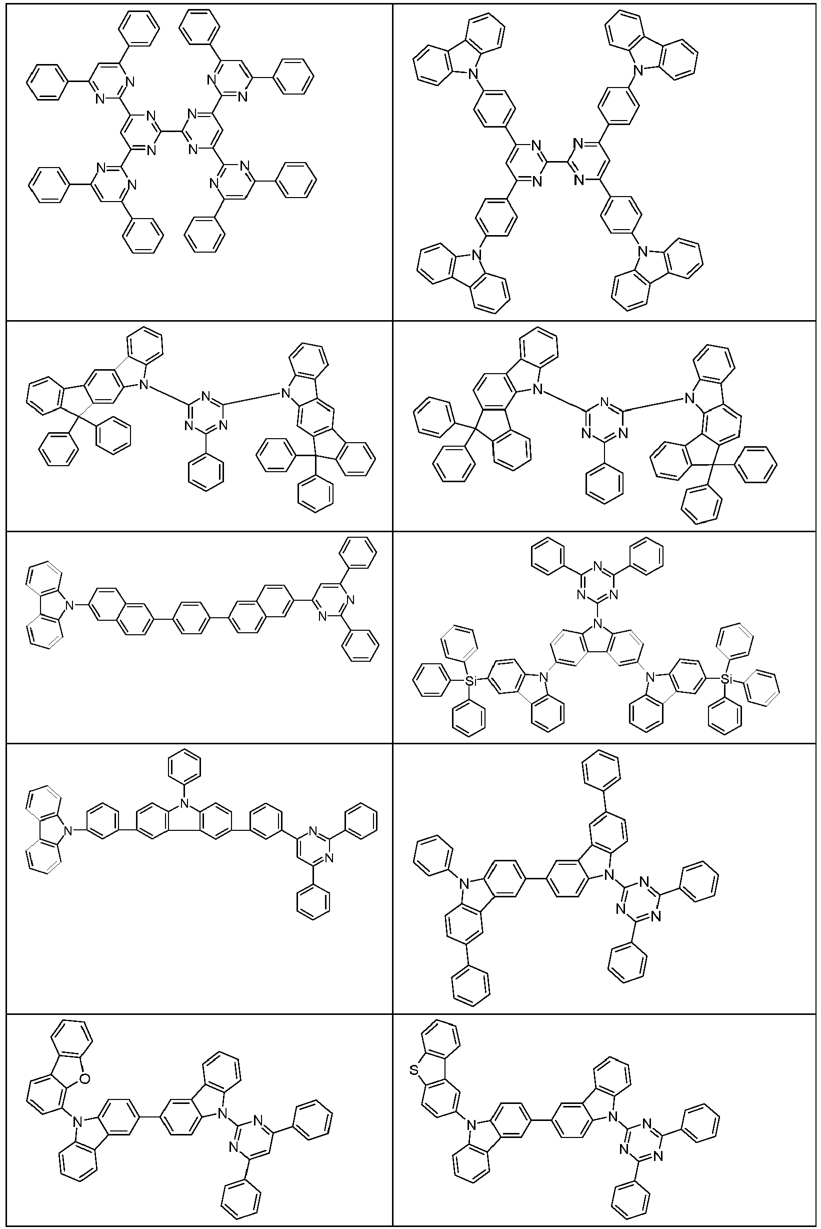

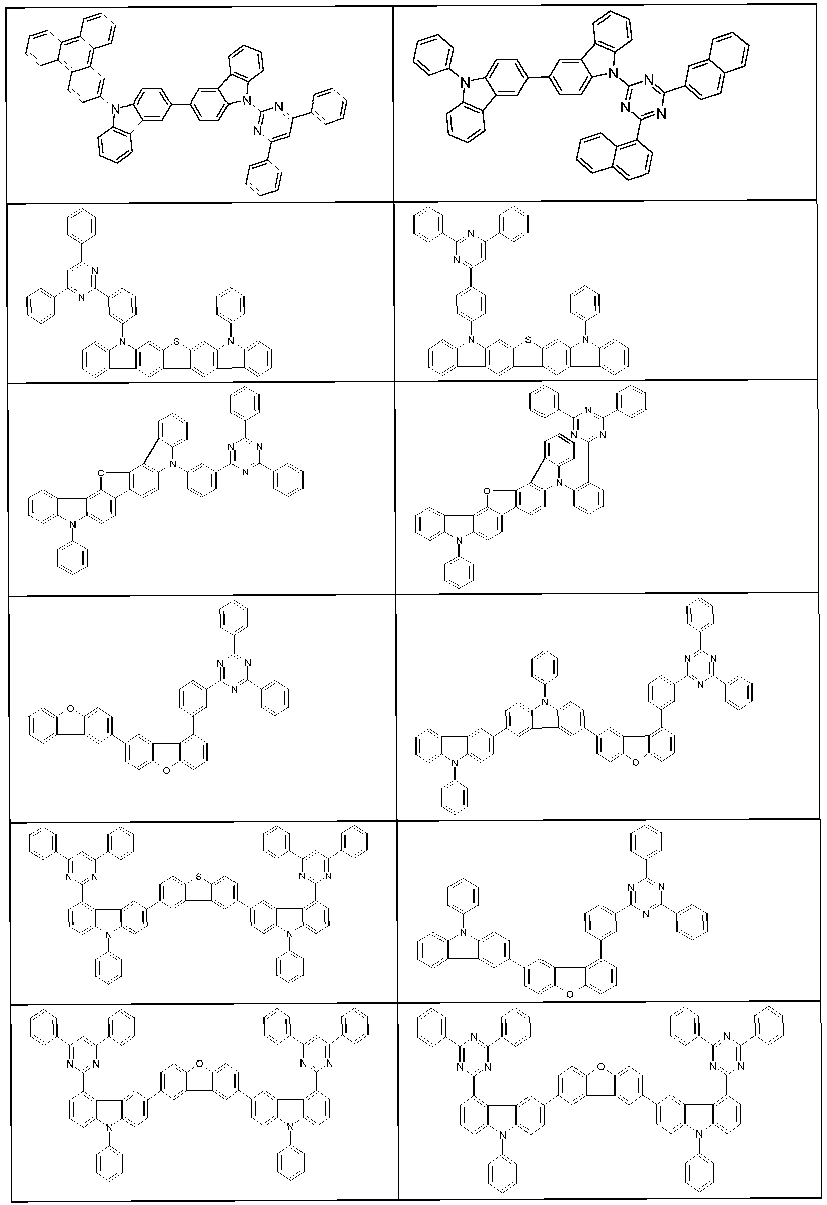

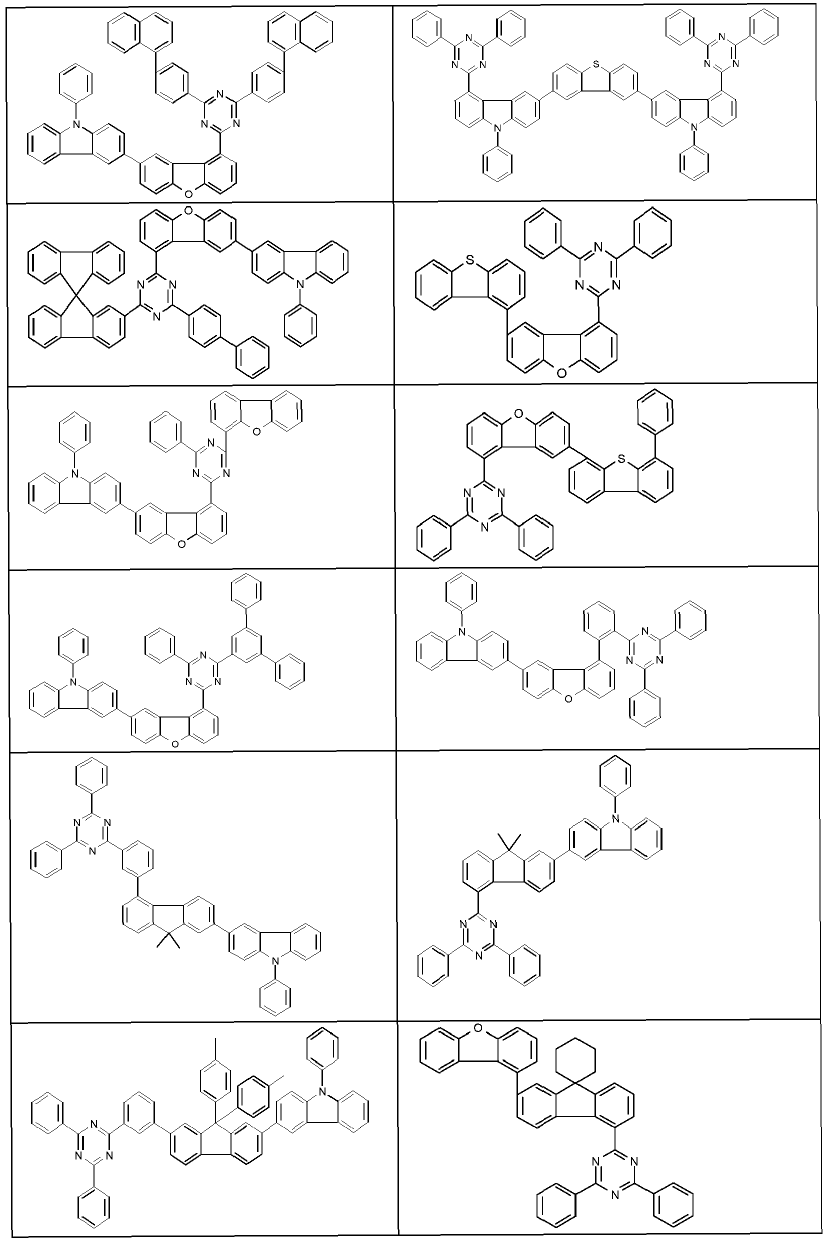

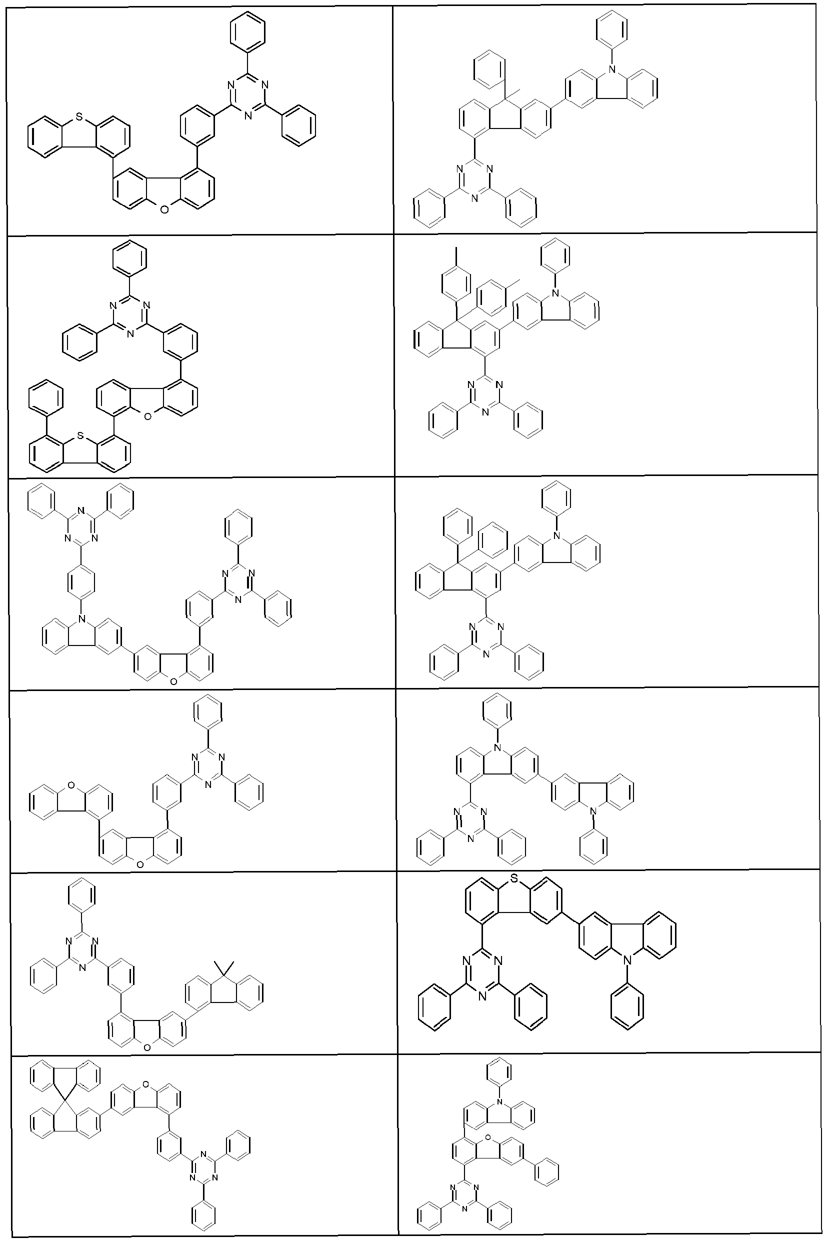

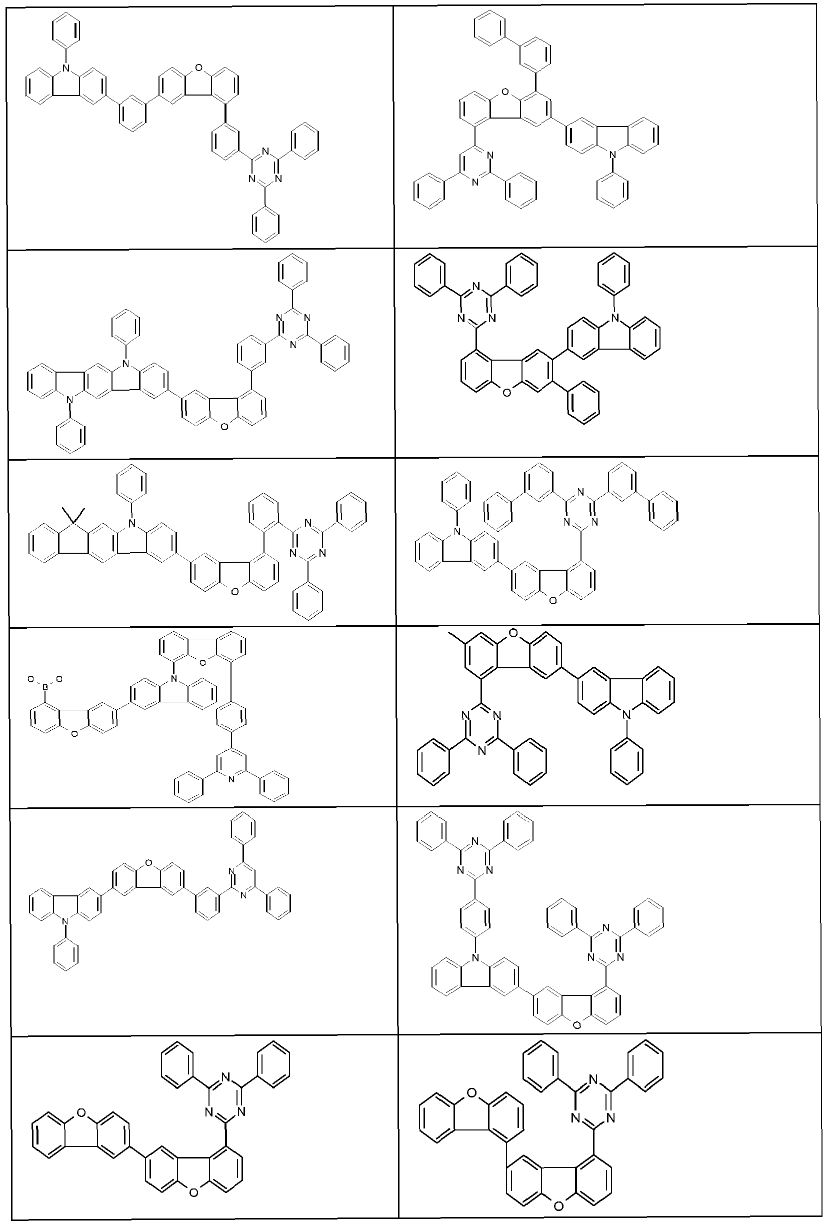

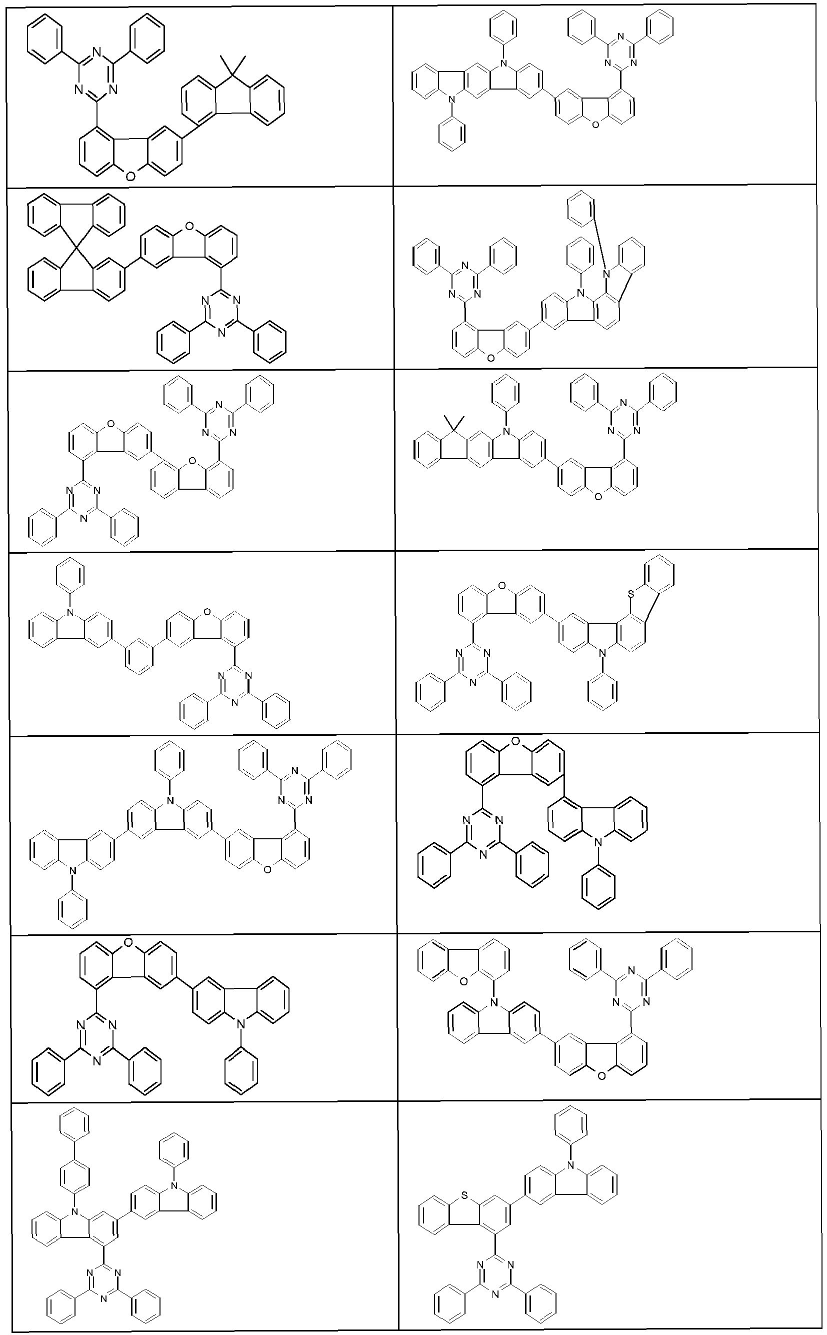

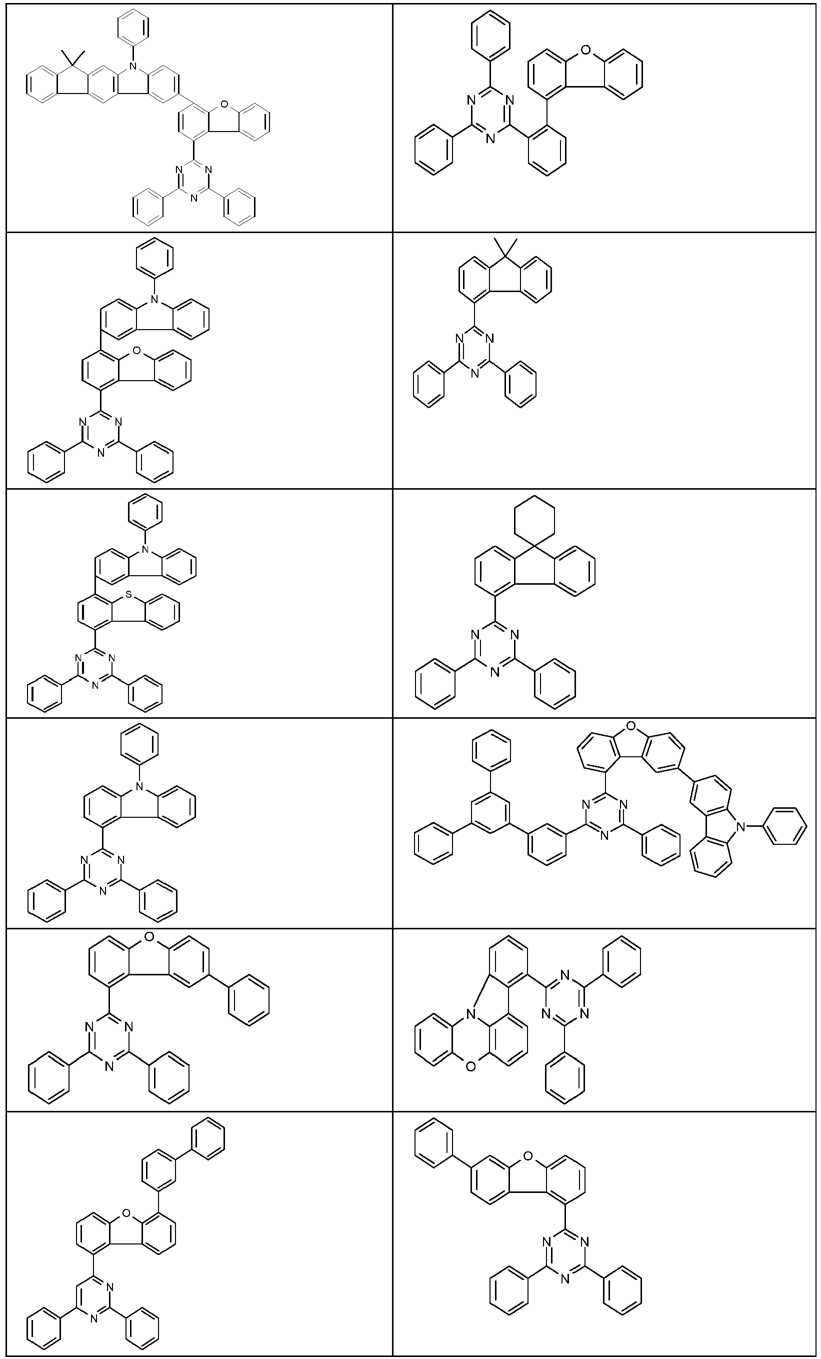

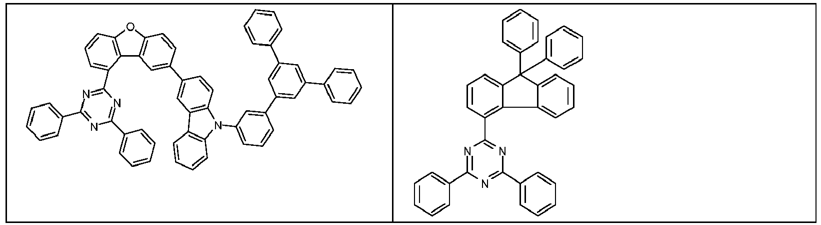

Beispiele für Lactame, welche als elektronentransportierende Matrixmaterialien eingesetzt werden können, sind die folgenden Strukturen:

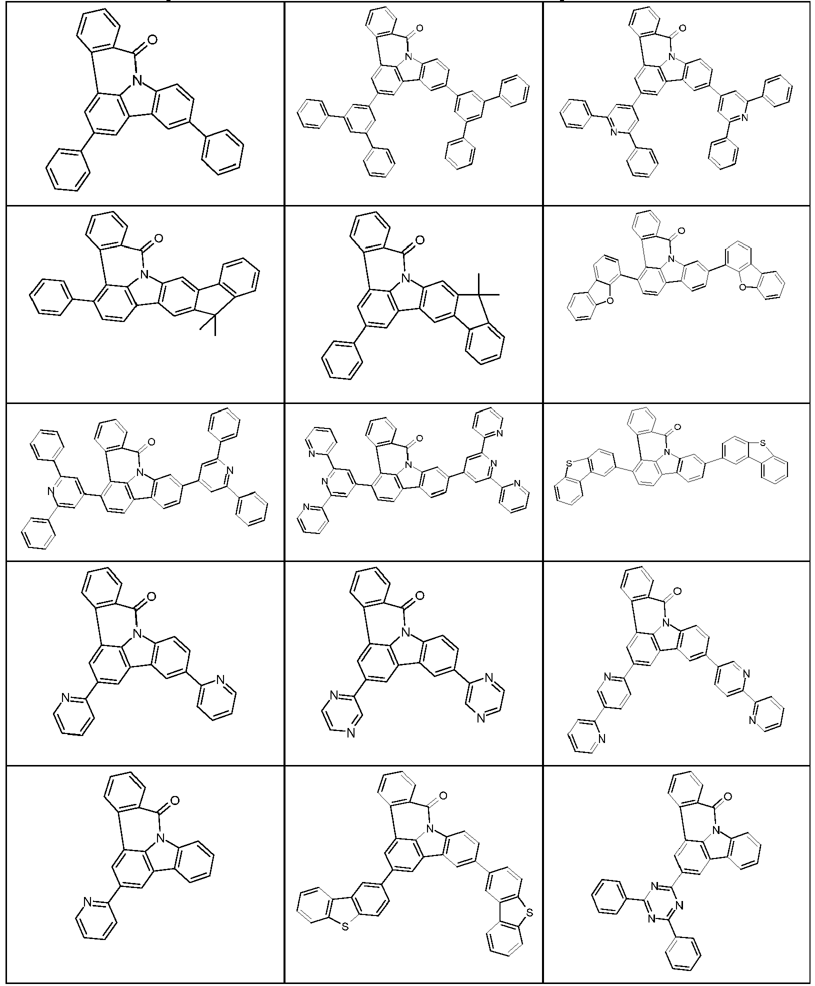

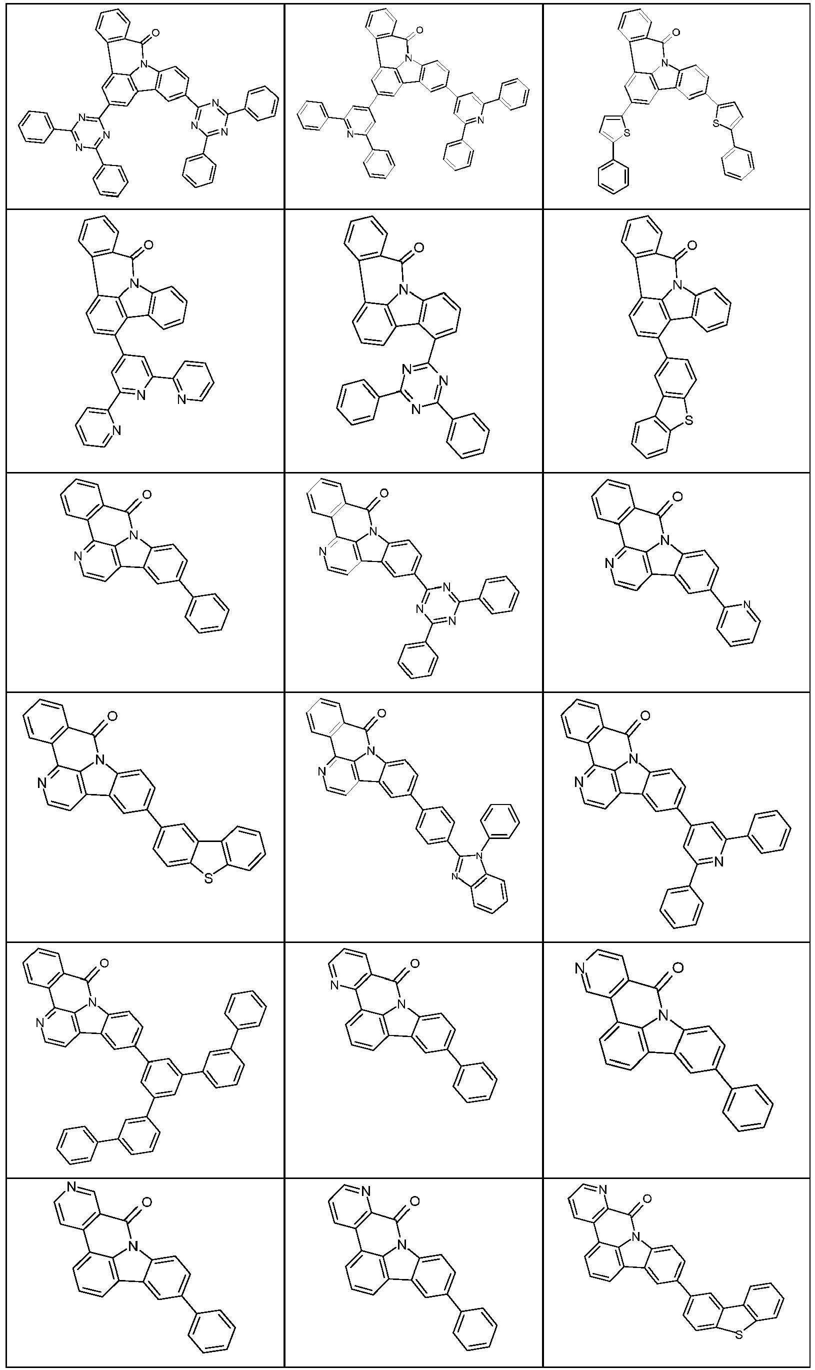

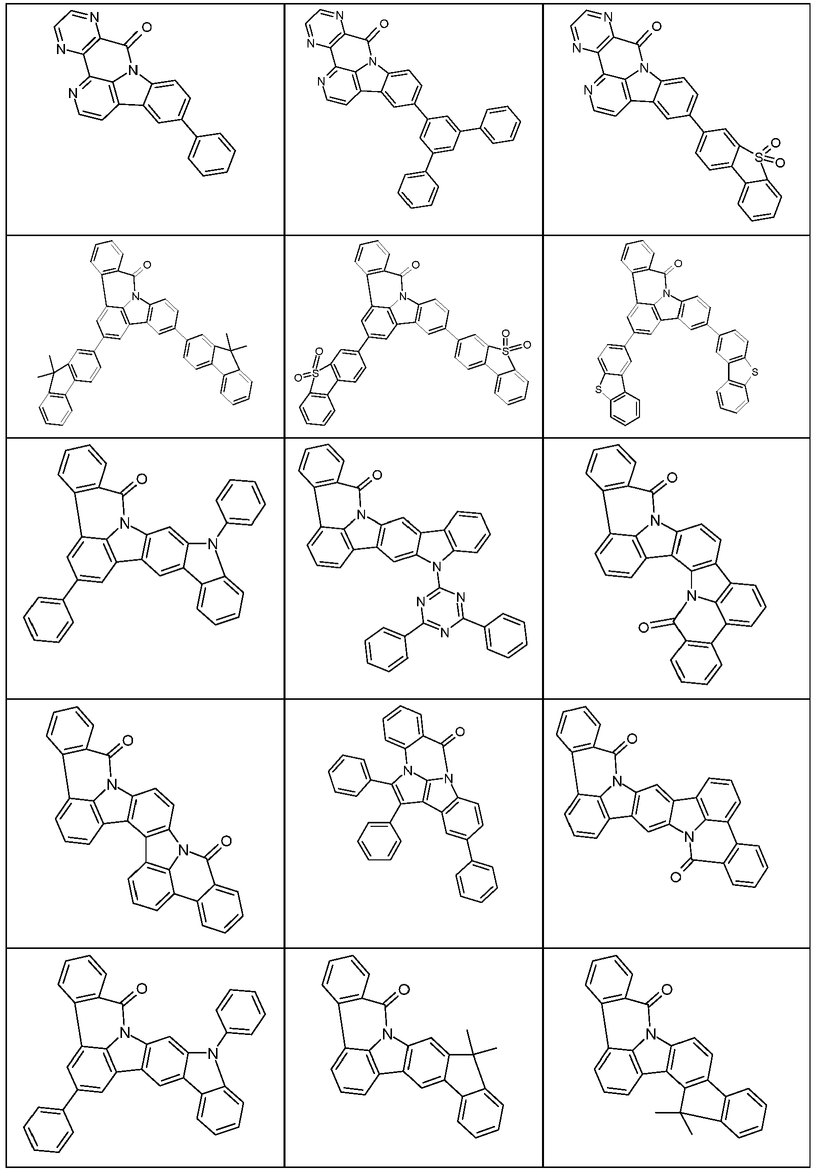

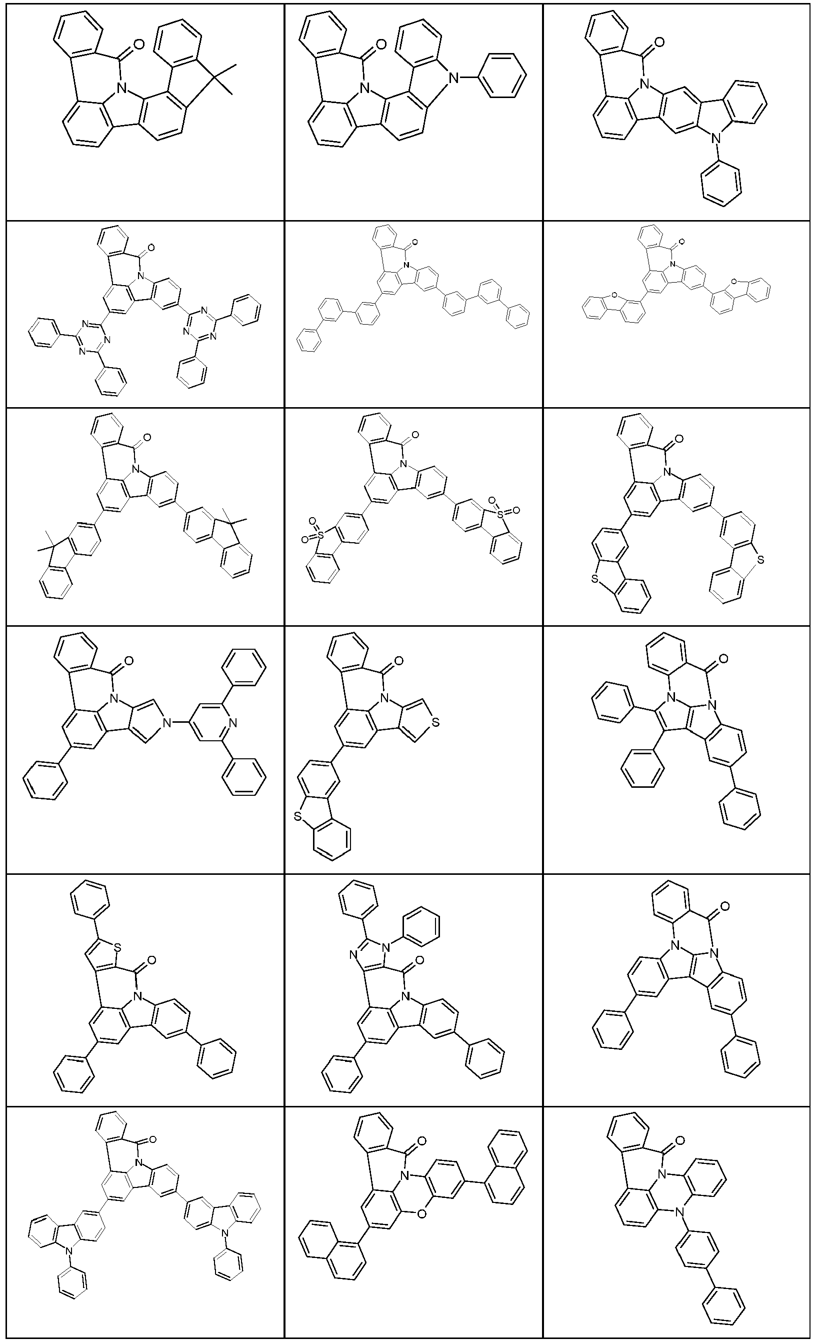

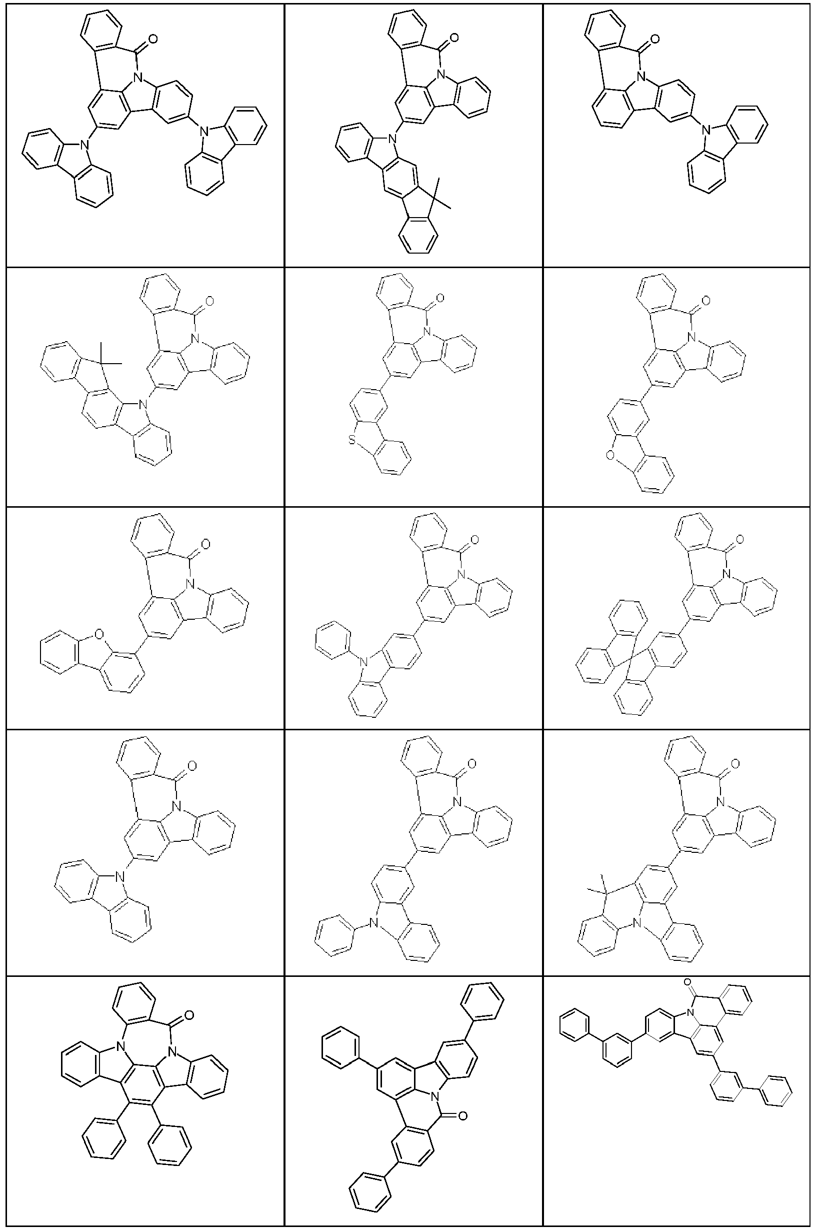

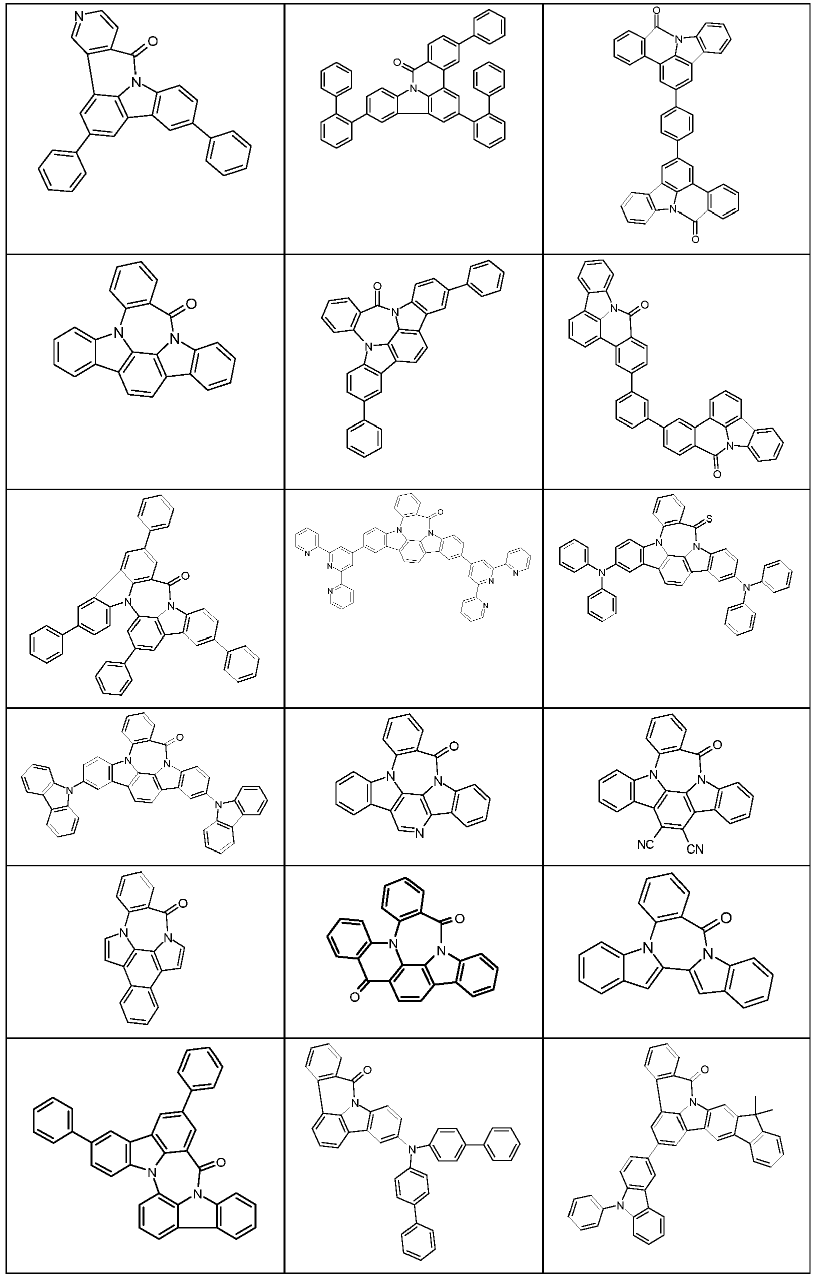

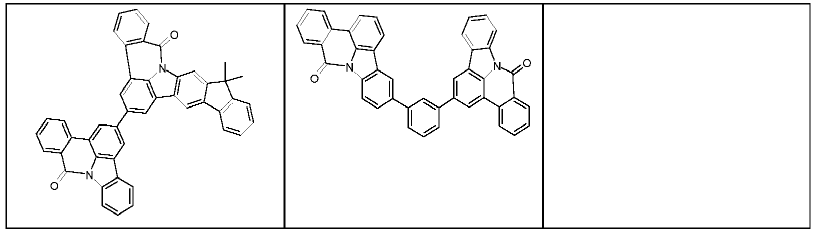

Beispiele für Indolo- und Indenocarbazolderivate im weitesten Sinn, welche je nach Substitutionsmuster als loch- oder elektronentransportierende Matrixmaterialien eingesetzt werden können, sind die folgenden Strukturen:

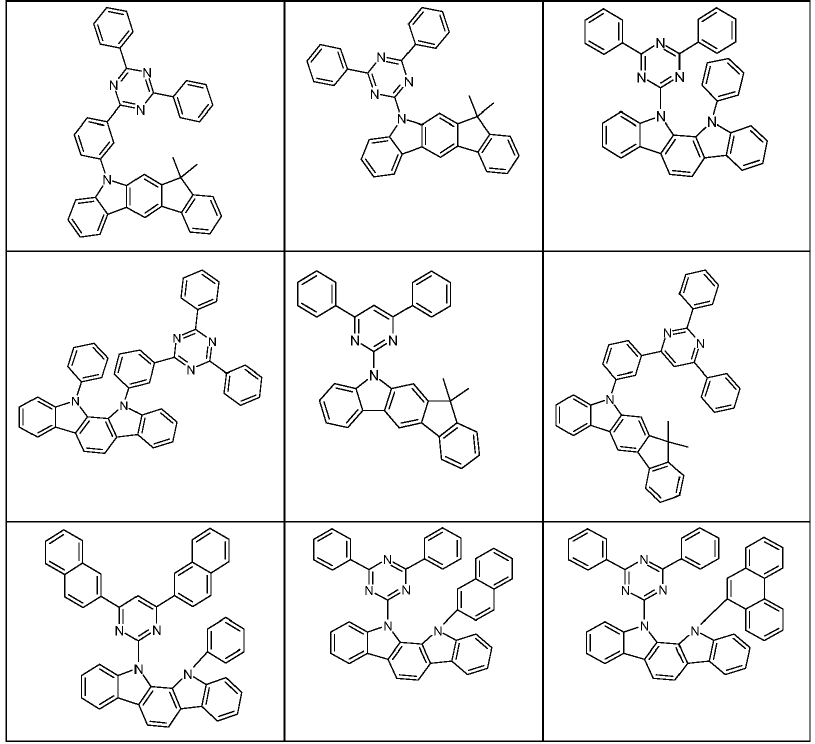

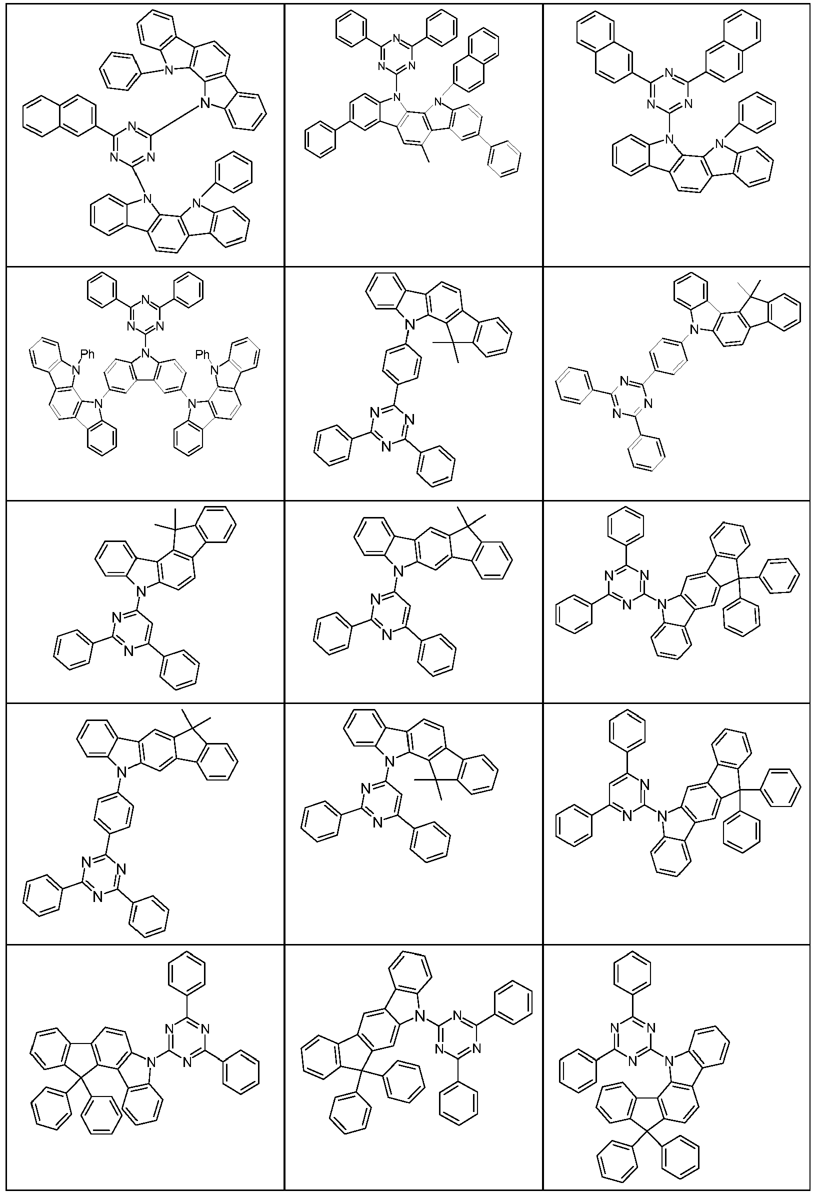

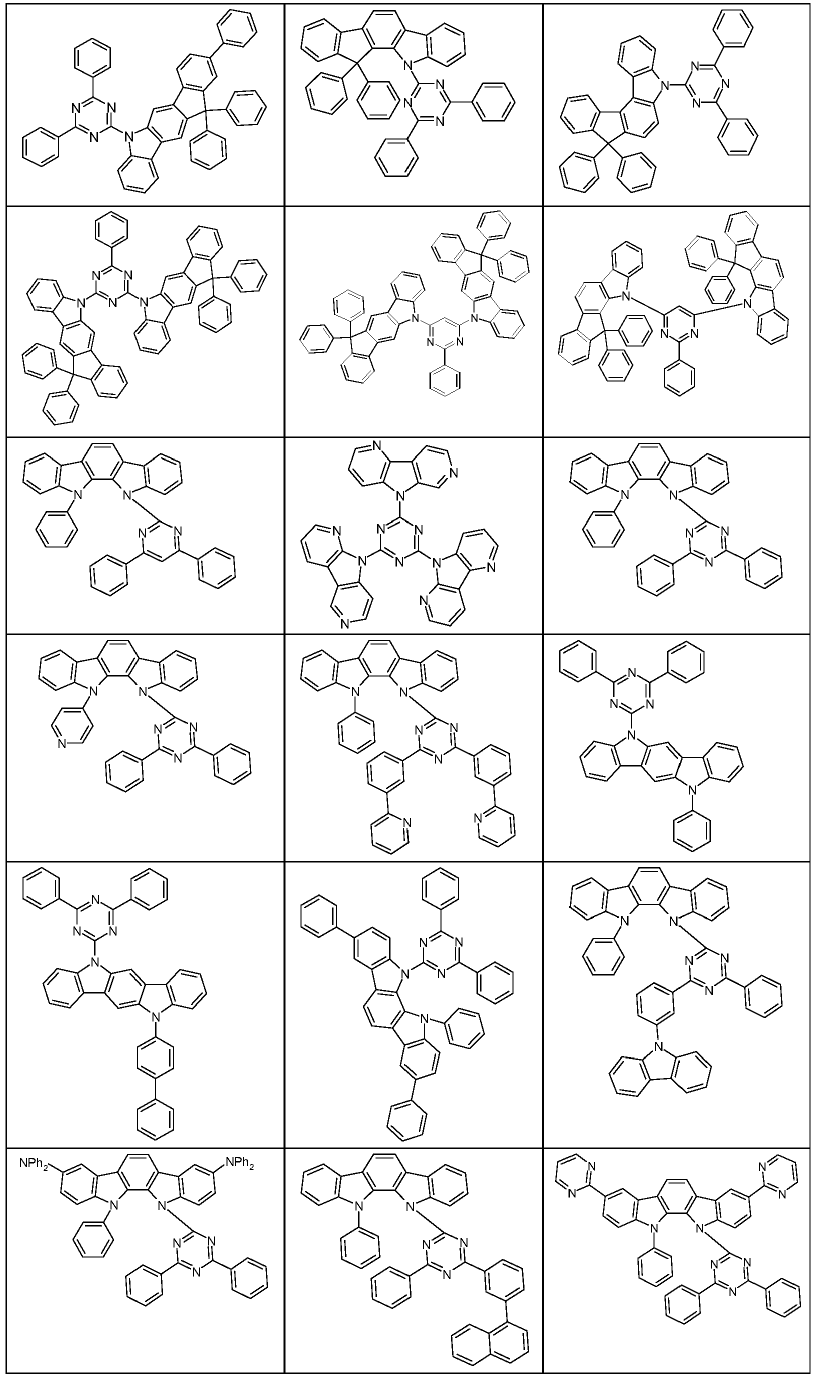

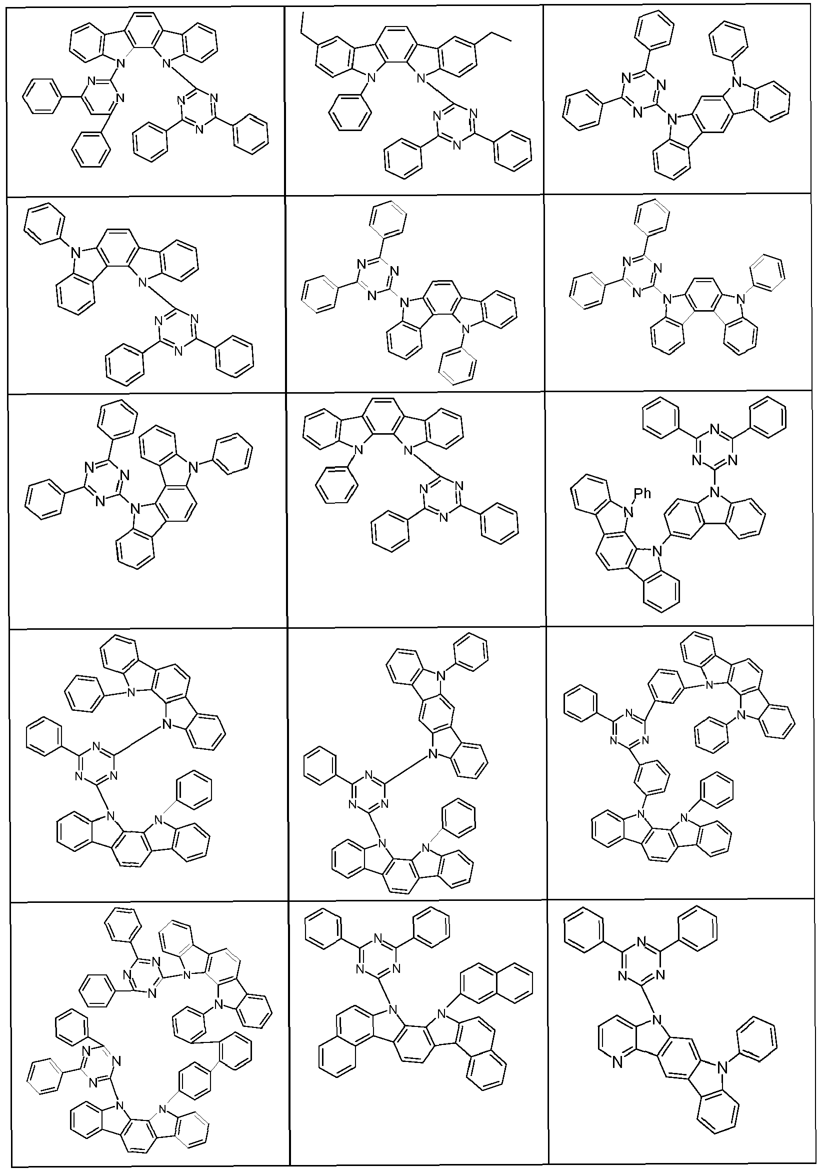

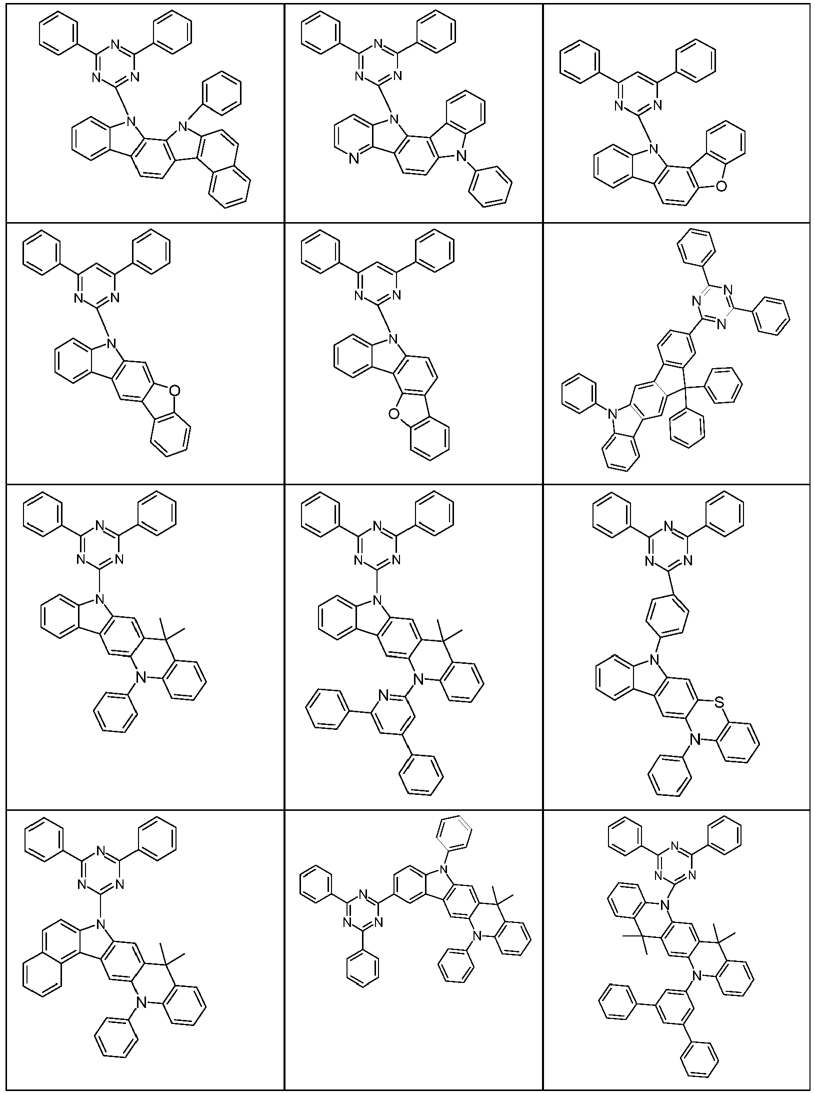

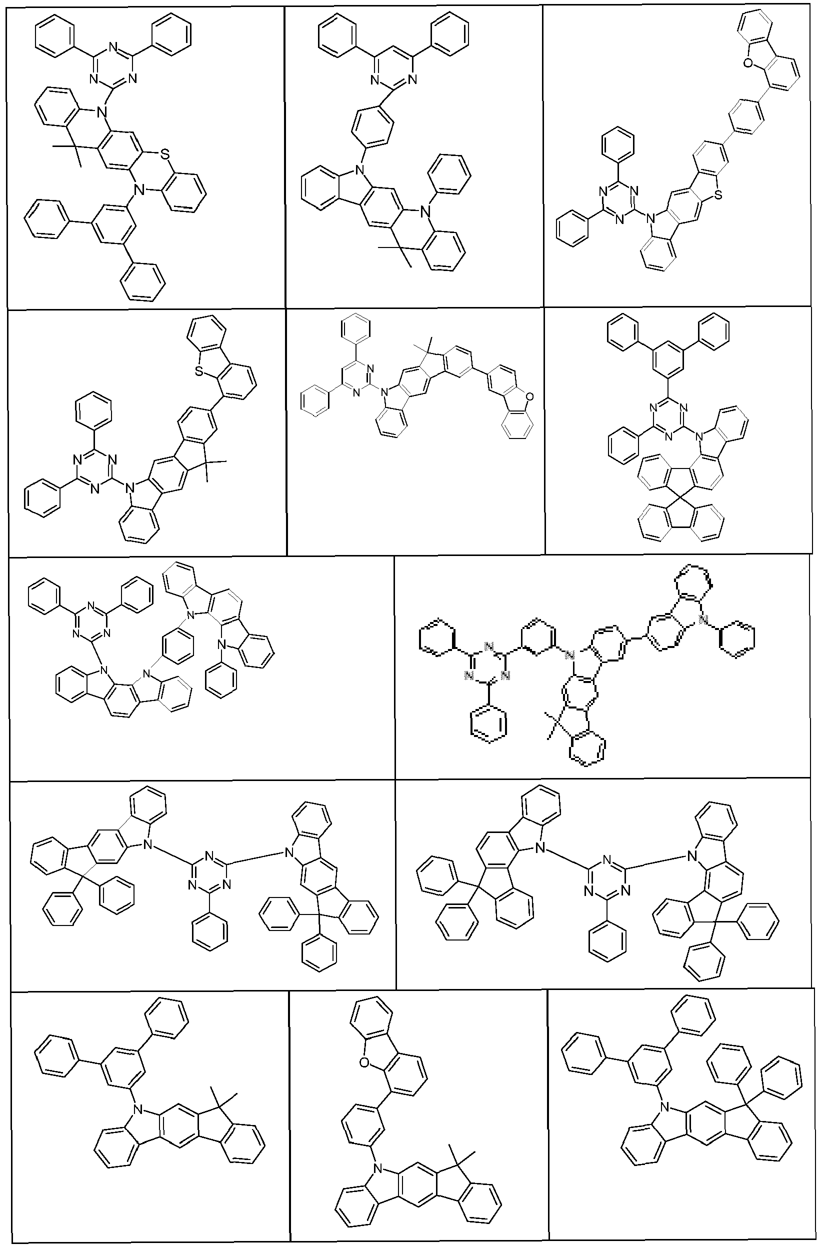

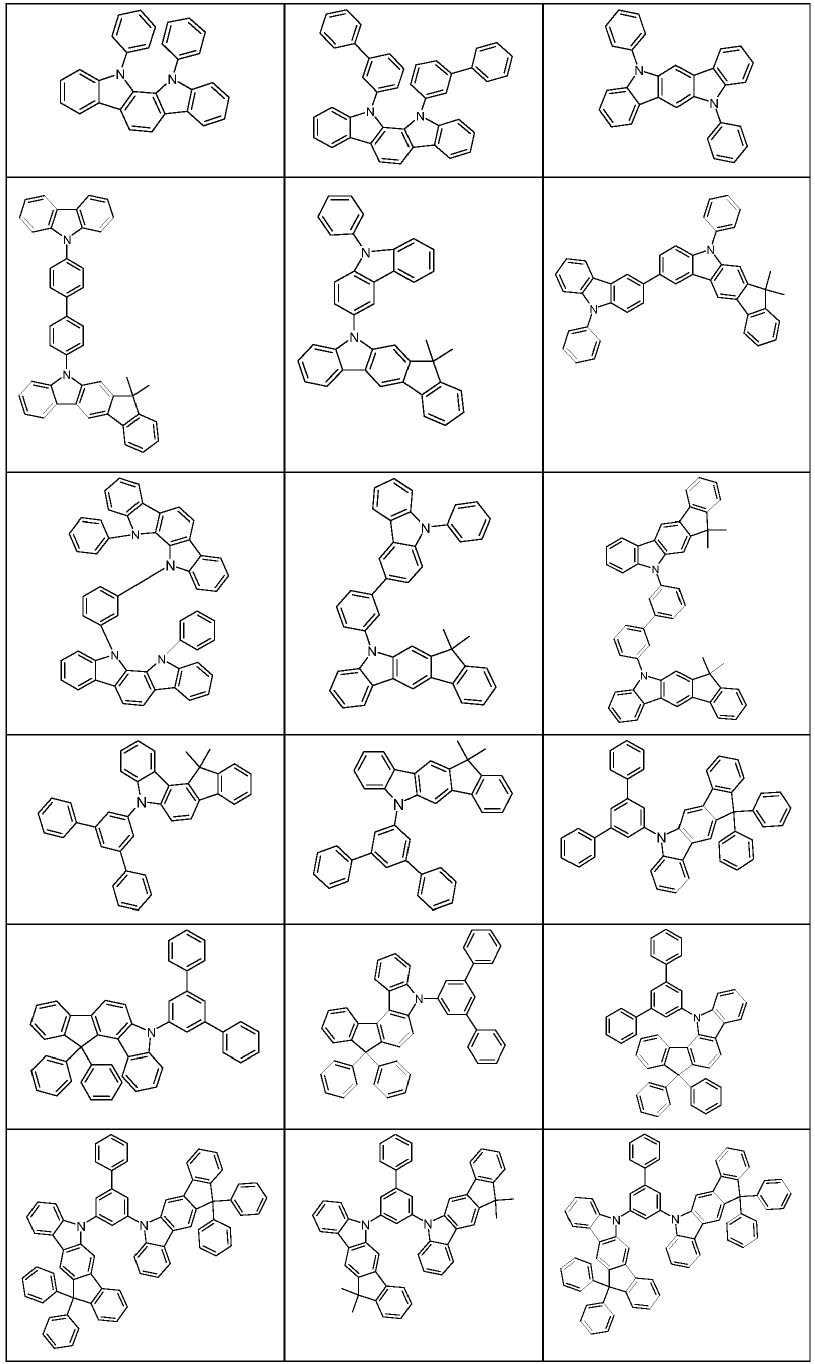

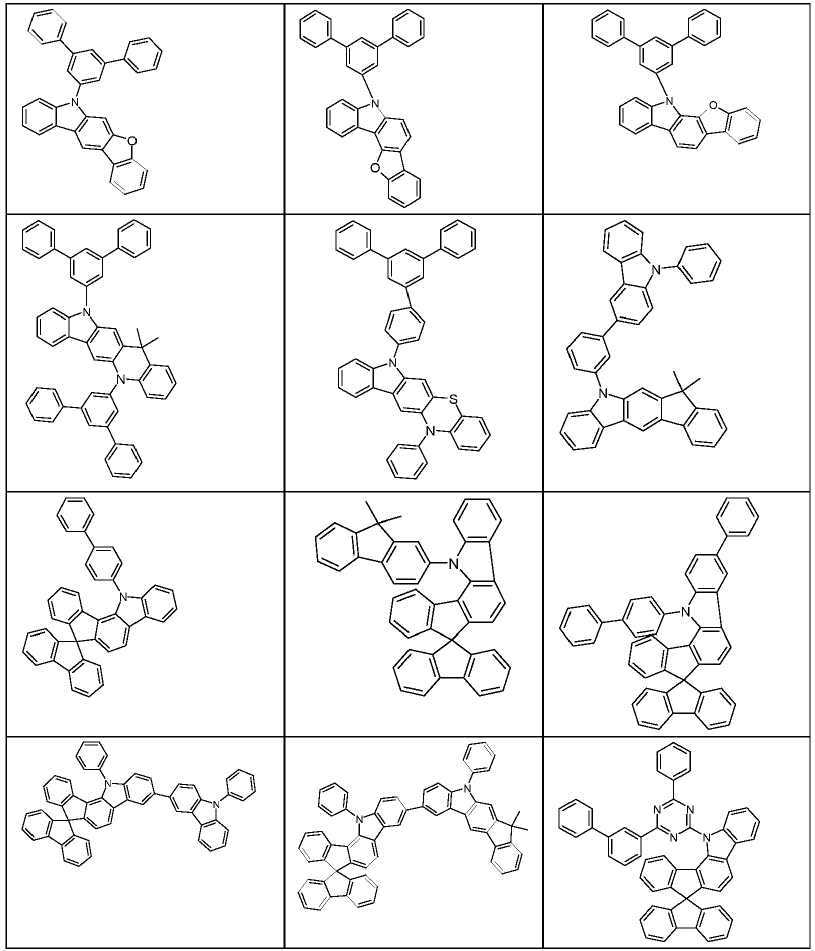

Beispiele für Carbazolderivate, welche je nach Substitutionsmuster als loch- oder elektronentransportierende Matrixmaterialien eingesetzt werden können, sind die folgenden Strukturen:

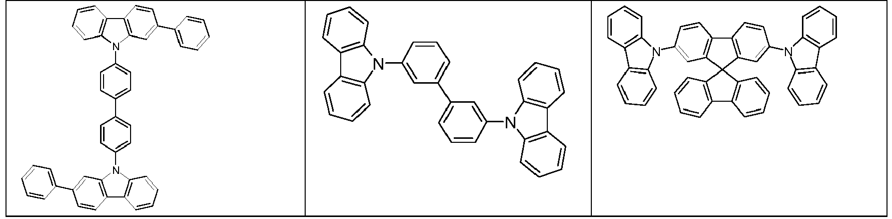

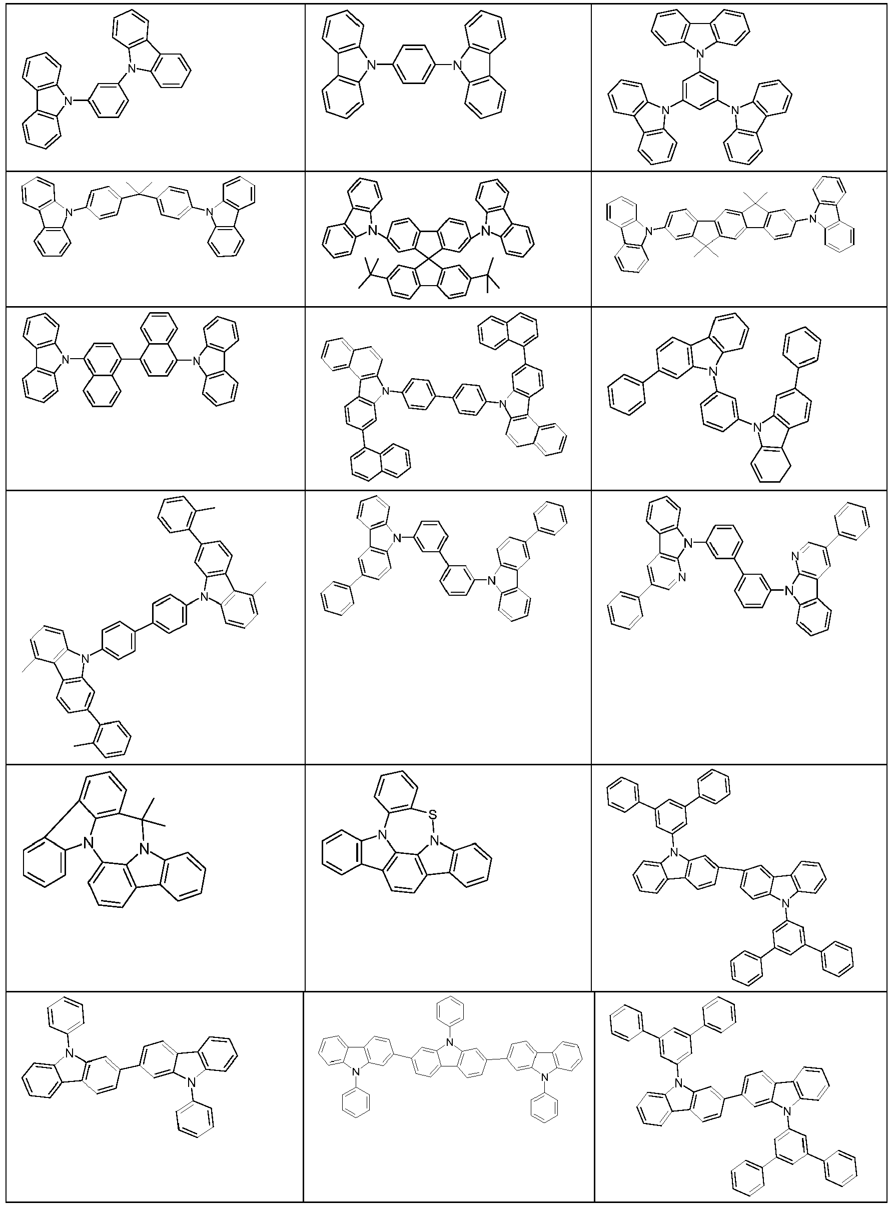

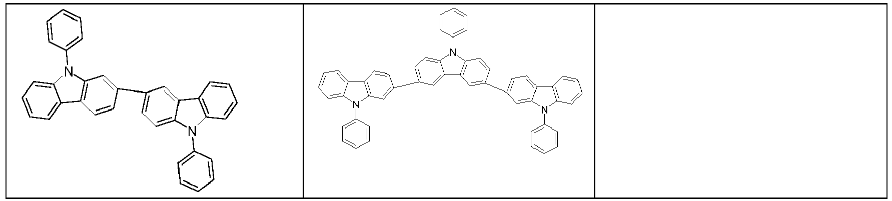

Beispiele für verbrückte Carbazolderivate, welche als lochtransportierende Matrixmaterialien eingesetzt werden können:

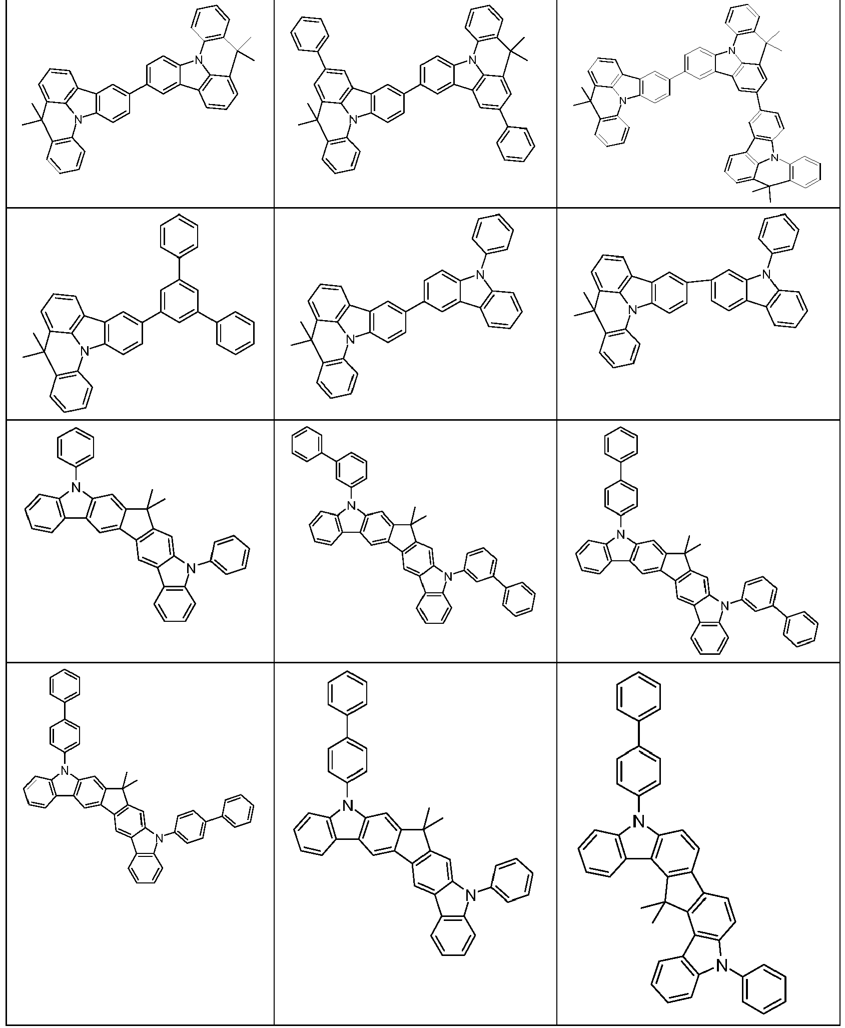

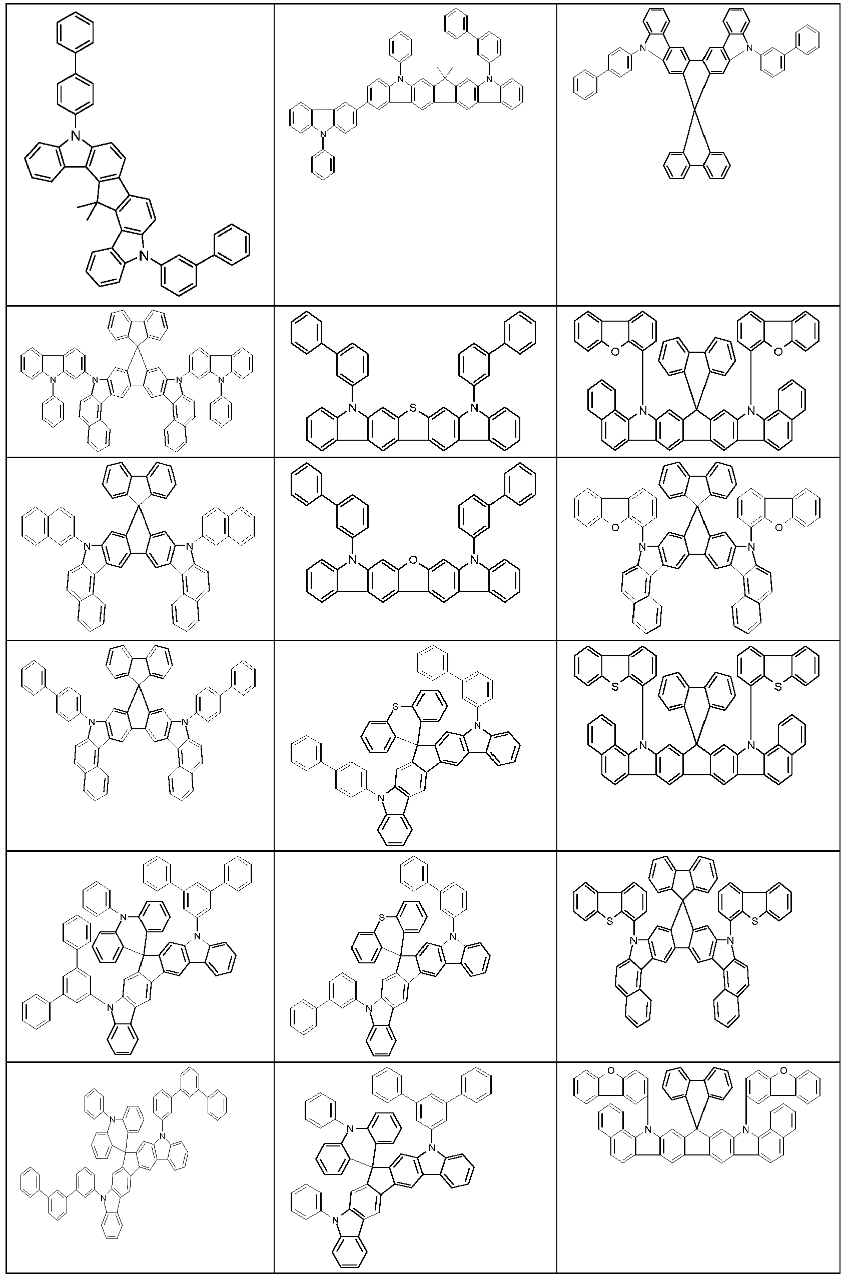

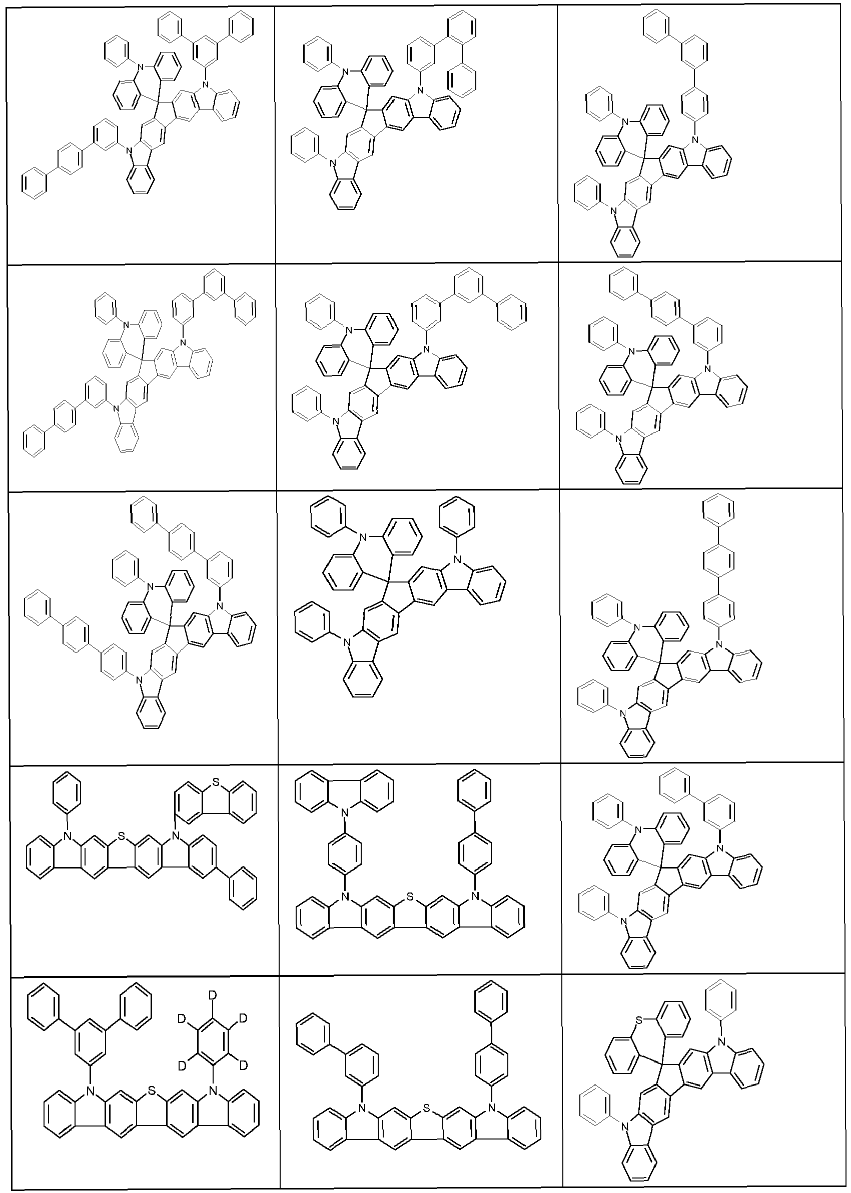

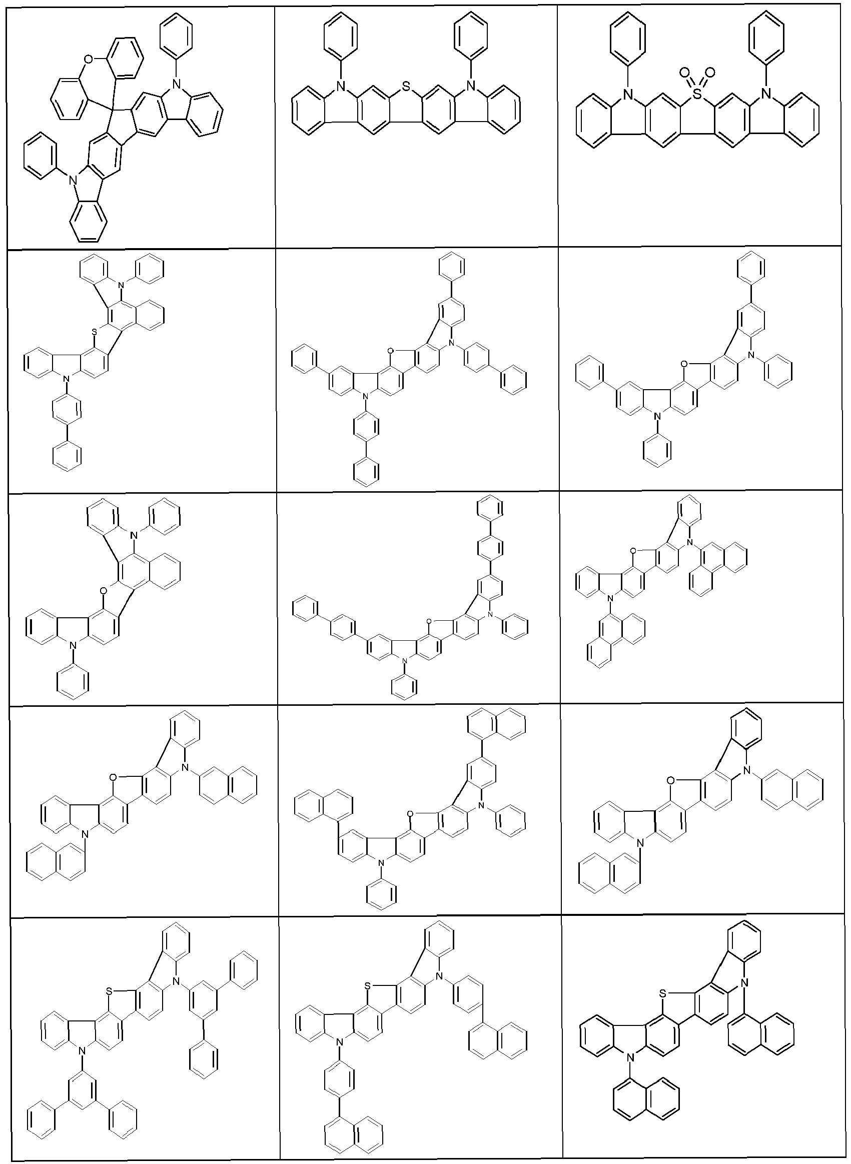

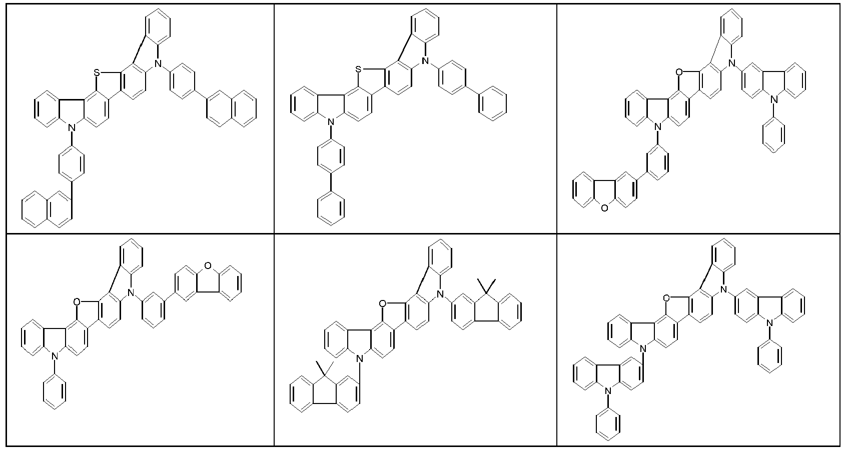

Beispiele für Biscarbazolderivate, welche als lochtransportierende Matrixmaterialien eingesetzt werden können:

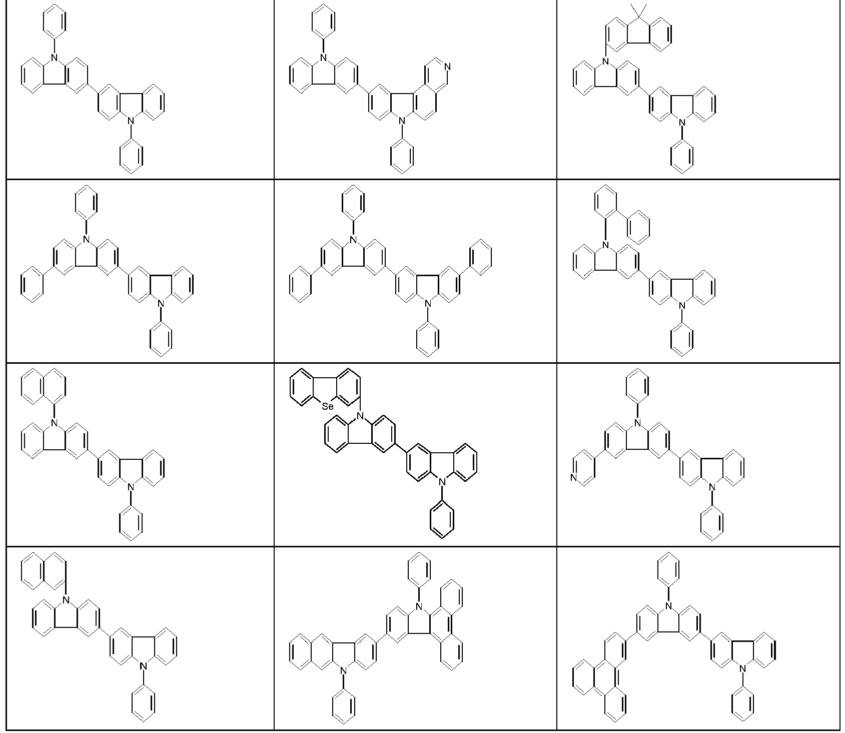

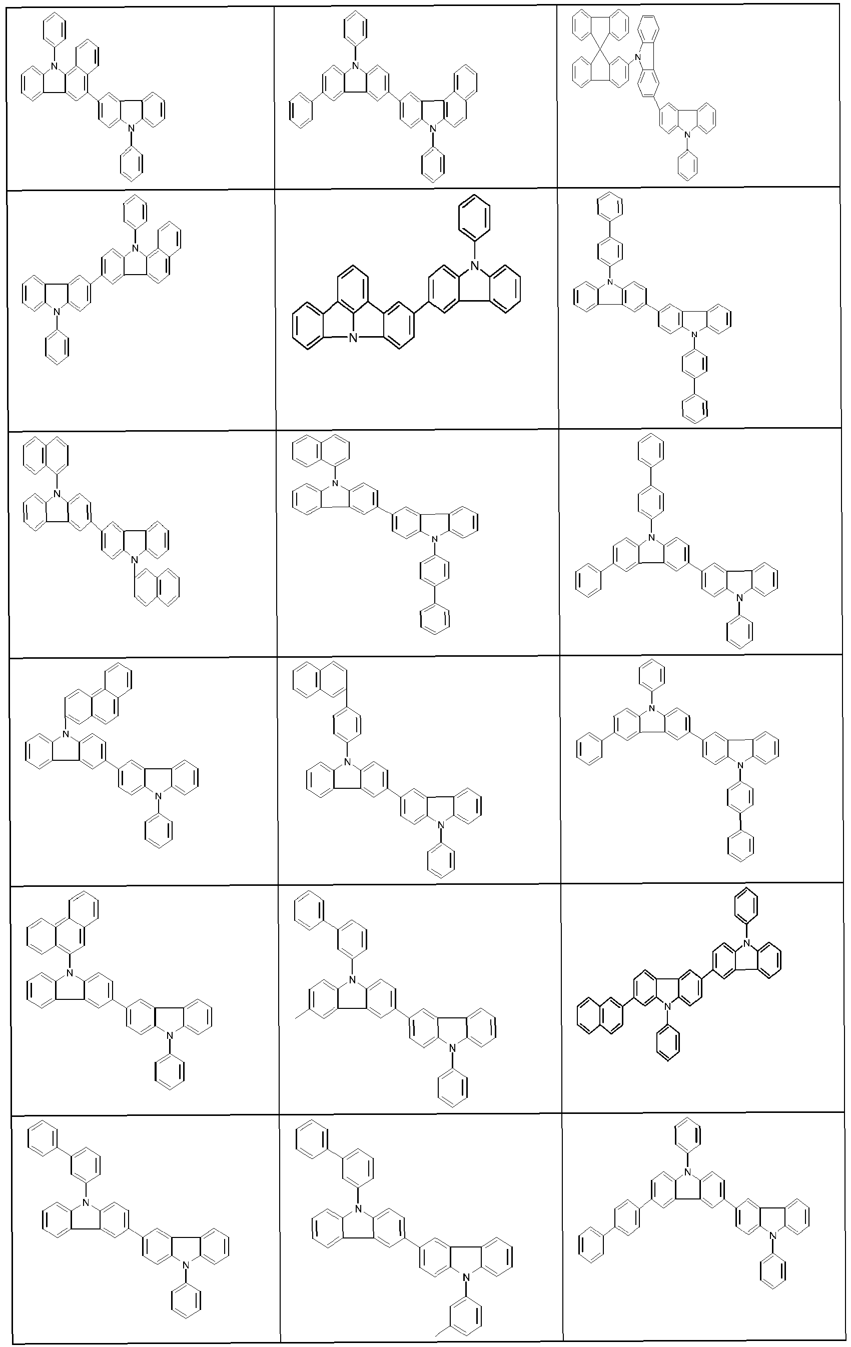

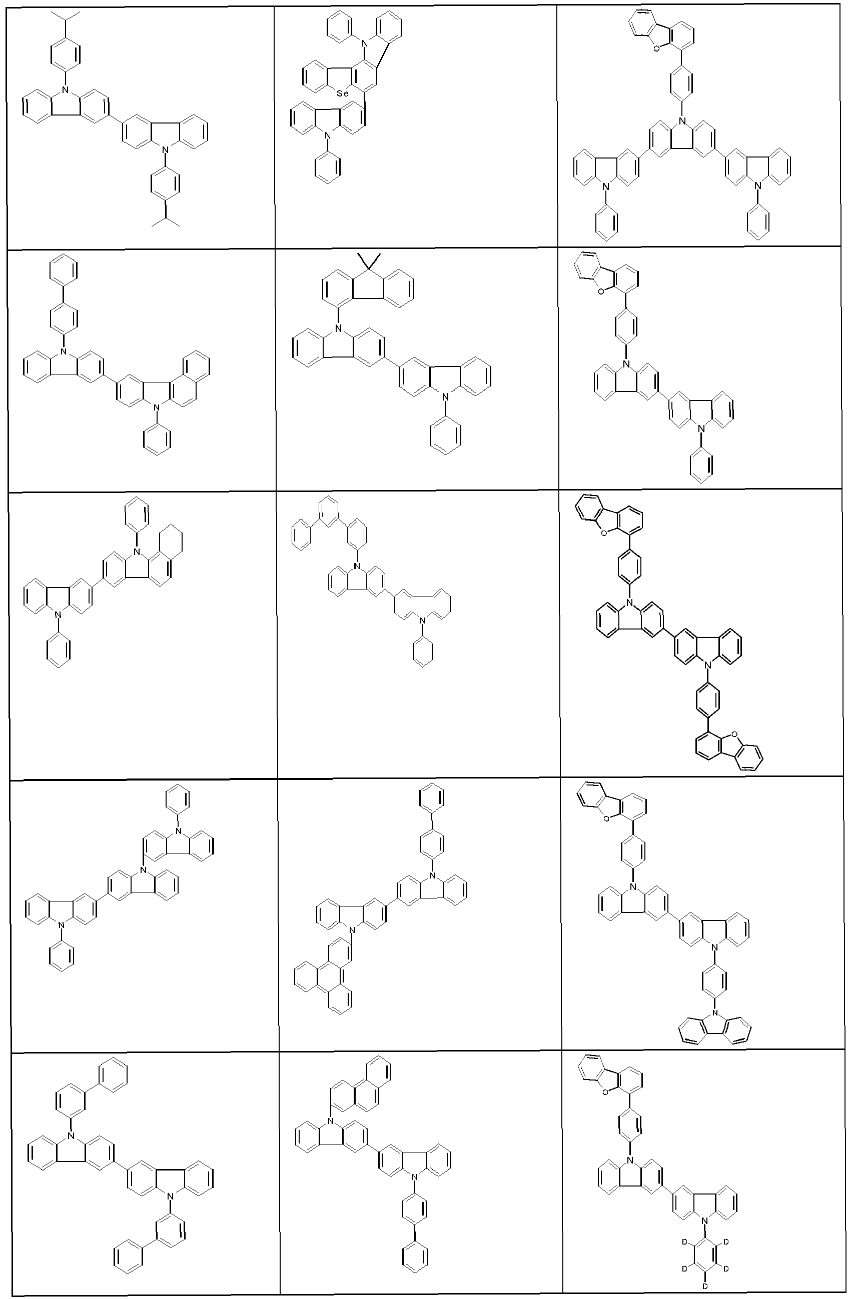

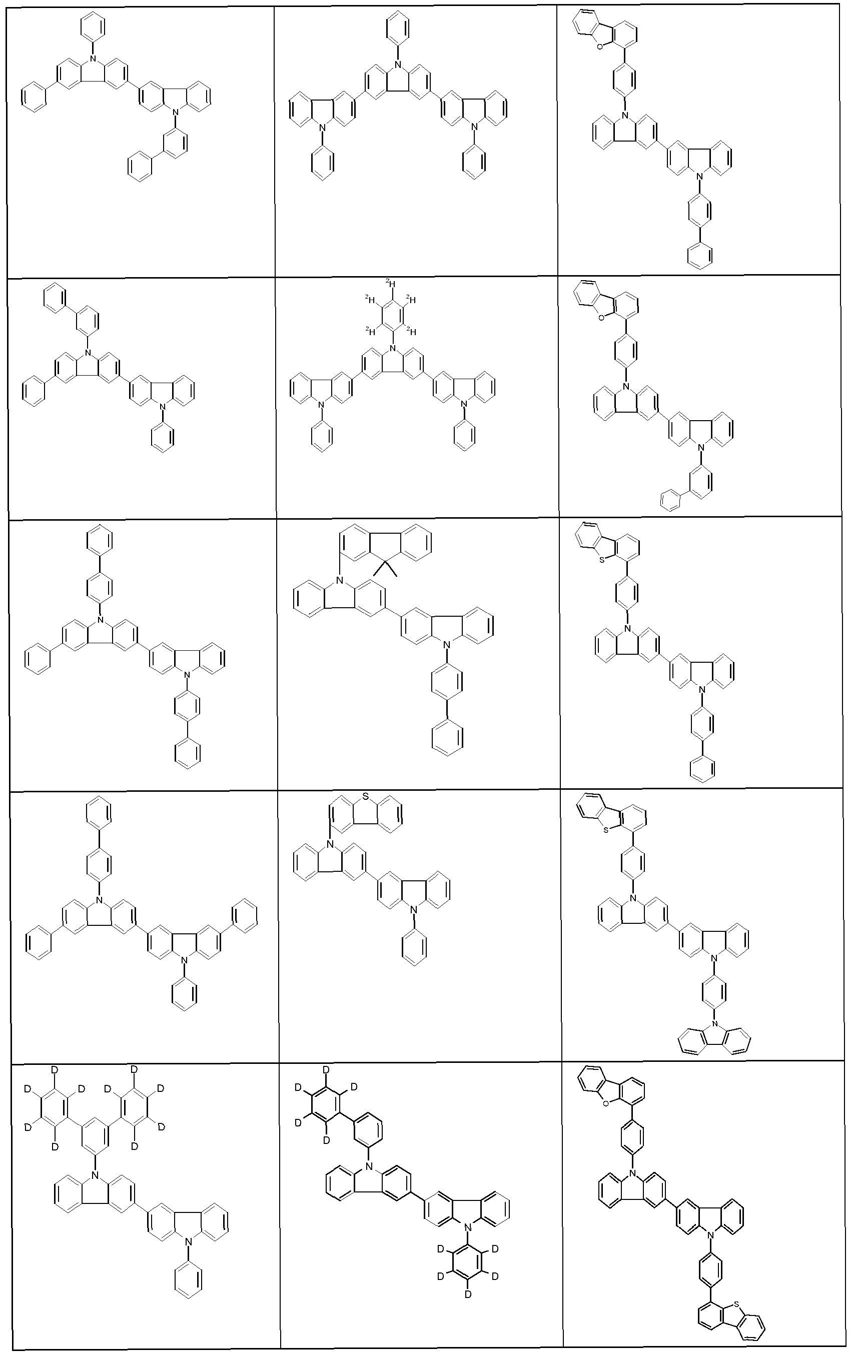

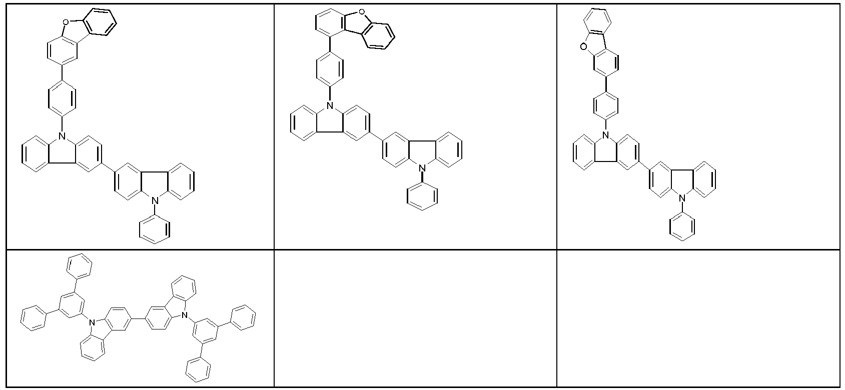

Beispiele für Amine, welche als lochtransportierende Matrixmaterialien einesetzt werden können:

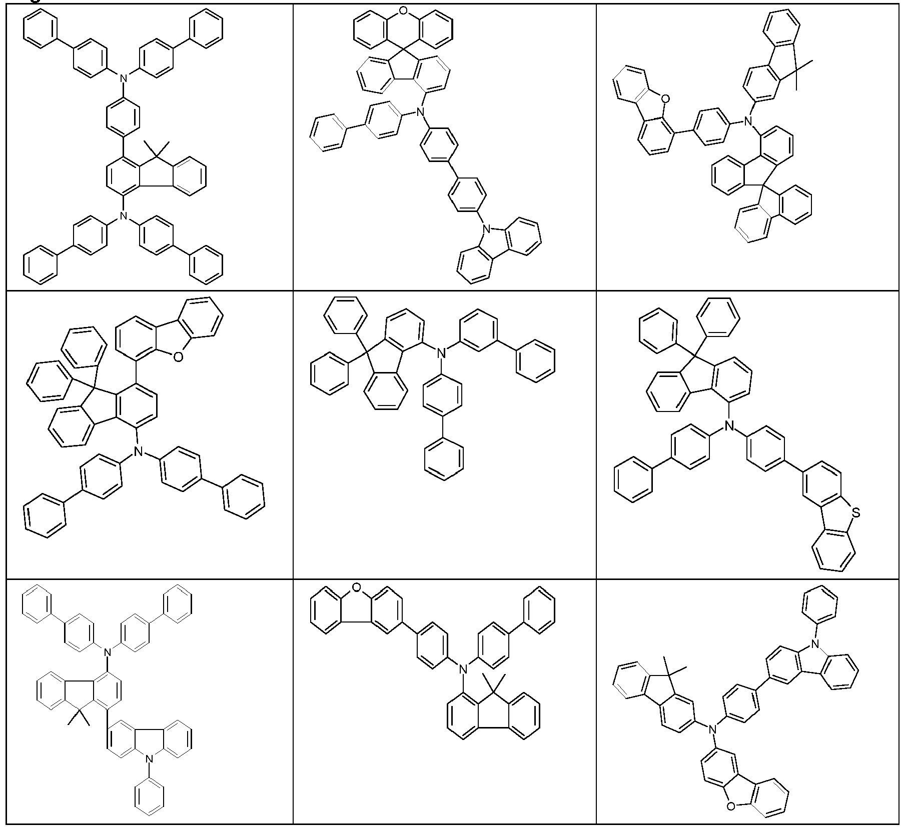

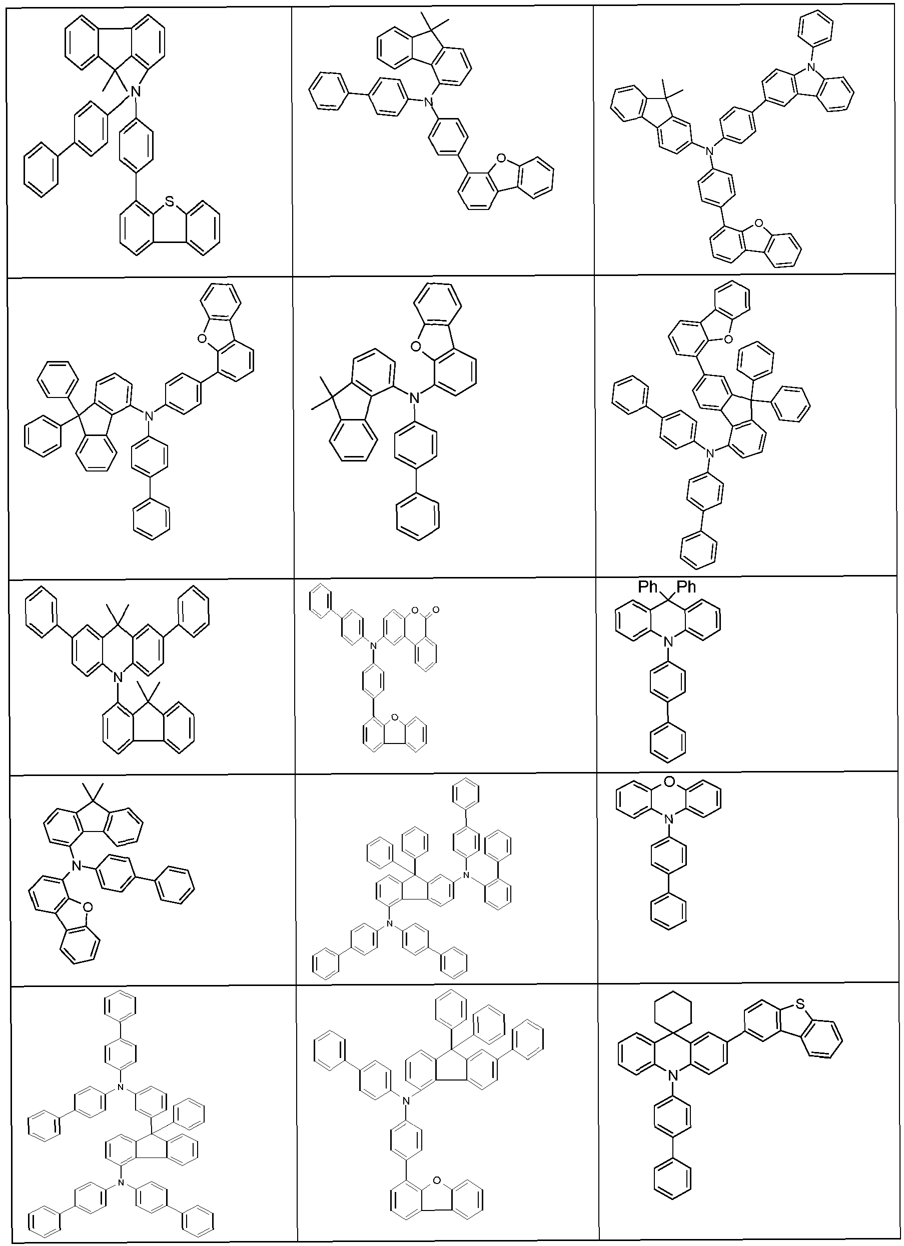

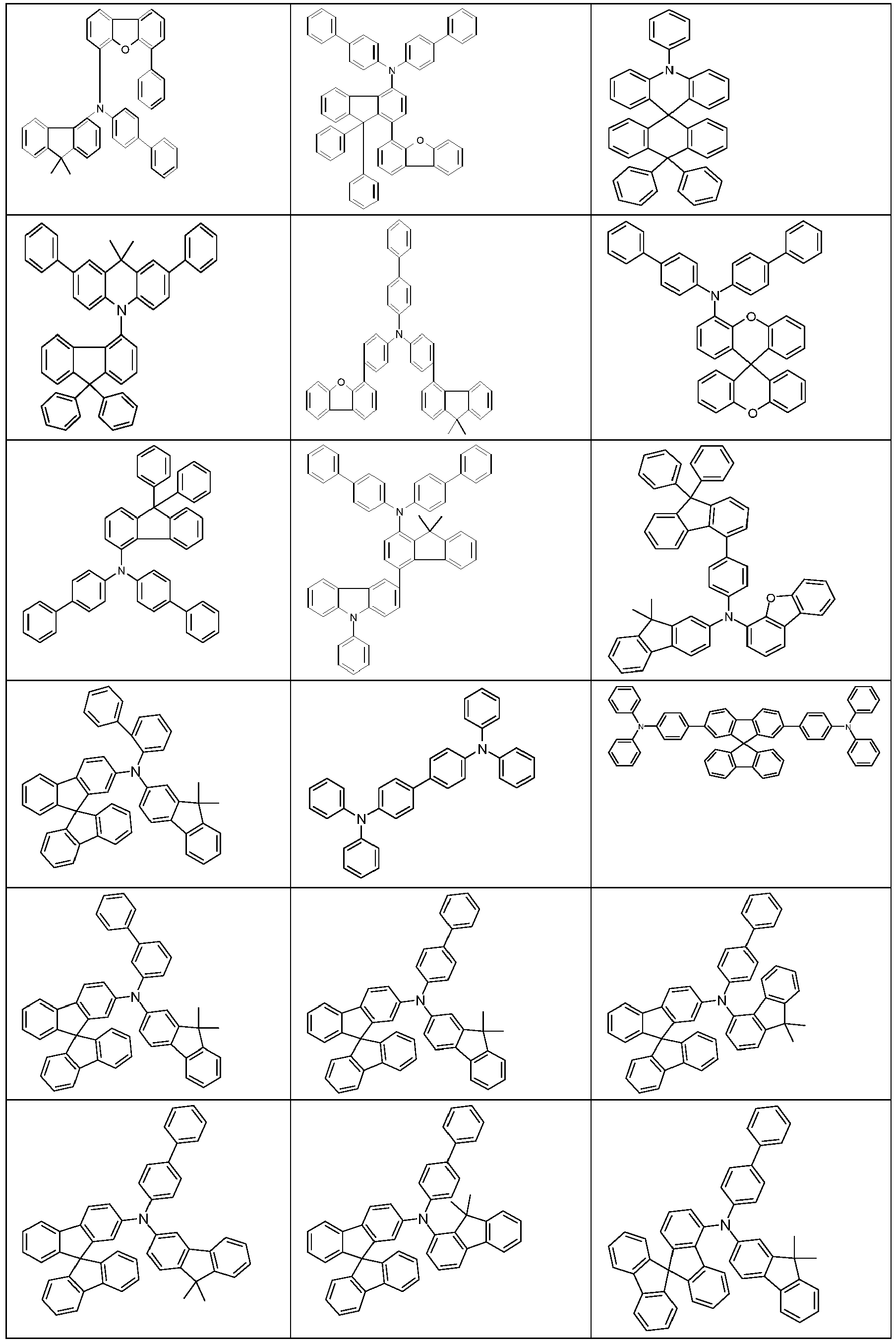

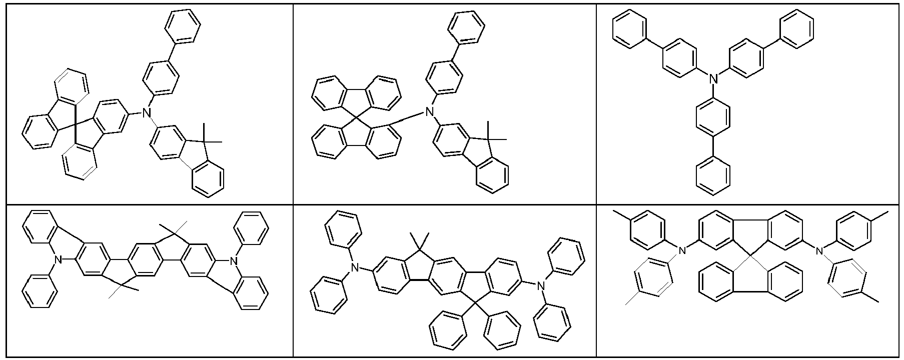

Beispiele für Materialien, welche als Wide Bandgap Matrixmaterialien eingesetzt werden können:

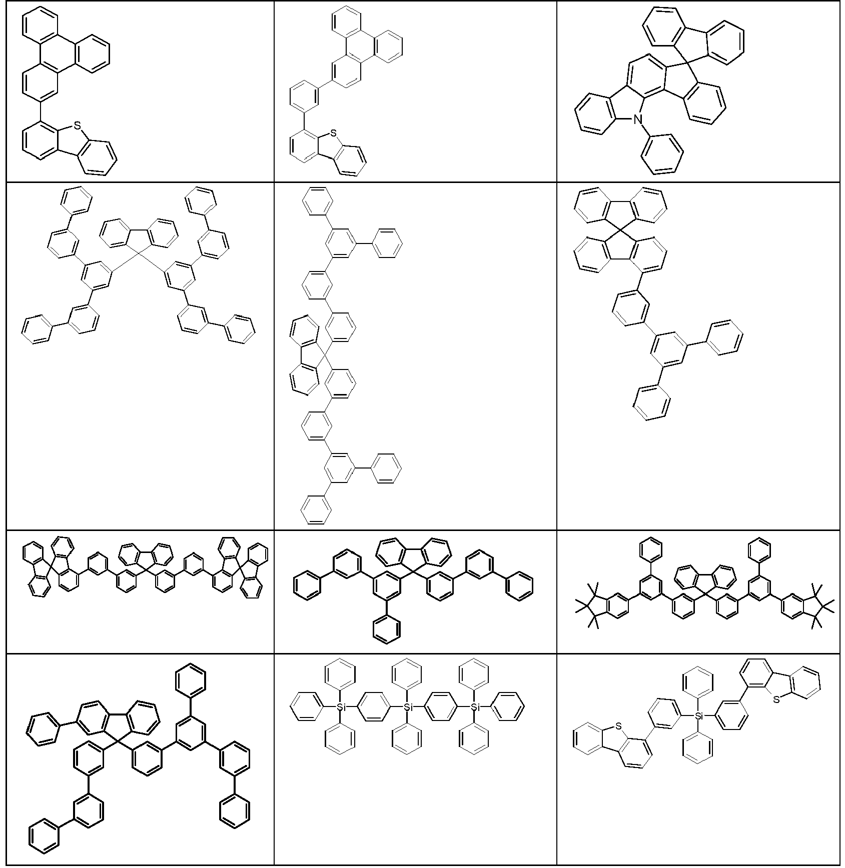

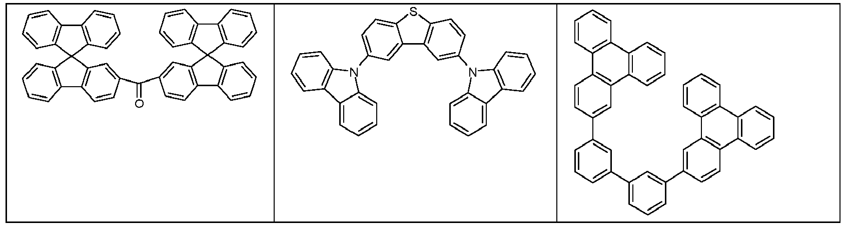

Weiterhin bevorzugt ist es, eine Mischung aus zwei oder mehr Triplett-Emittern, insbesondere zwei oder drei Triplettemittern, zusammen mit einem oder mehreren Matrixmaterialien einzusetzen. Dabei dient der Triplett-Emitter mit dem kürzerwelligen Emissionsspektrum als Co-Matrix für den Triplett-Emitter mit dem längerwelligen Emissionsspektrum. So können beispielsweise die erfindungsgemäßen Metallkomplexe mit einem kürzerwelligen, z.B. blau, grün oder gelb emittierenden, Metallkomplex als Co-Matrix kombiniert werden. Es können beispislweise auch erfindungsgemäße Metallkomplexe als Co-Matrix für längerwellig emittierende Triplettemitter, beispielsweise für rot emittierende Triplettemitter, eingesetzt werden. Dabei kann es auch bevorzugt sein, wenn sowohl der kürzerwellig wie auch der längerwellig emittierende Metallkomplex eine erfindungsgemäße Verbindung ist. Eine bevorzugte Ausführungsform bei Verwendung einer Mischung aus drei Triplett-Emittern ist, wenn zwei als Co-Host und einer als emittierendes Material eingesetzt werden. Dabei weisen diese Triplett-Emitter bevorzugt die Emissionsfarben Grün, Gelb und Rot oder Blau, Grün und Orange auf.

Eine bevorzugte Mischung in der emittierenden Schicht enthält ein elektronentransportierendes Hostmaterial, ein so genanntes "wide bandgap" Hostmaterial, das aufgrund seiner elektronischen Eigenschaften nicht oder nicht in wesentlichem Umfang am Ladungstransport in der Schicht beteiligt ist, einen Co-Dotanden, welcher ein Triplettemitter ist, welcher bei einer kürzeren Wellenlänge als die erfindungsgemäße Verbindung emittiert, sowie eine erfindungsgemäße Verbindung.

Eine weitere bevorzugte Mischung in der emittierenden Schicht enthält ein elektronentransportierendes Hostmaterial, ein so genanntes "wide band gap" Hostmaterial, das aufgrund seiner elektronischen Eigenschaften nicht oder nicht in wesentlichem Umfang am Ladungstransport in der Schicht beteiligt ist, ein lochtransportierendes Hostmaterial, einen Co-Dotanden, welcher ein Triplettemitter ist, welcher bei einer kürzeren Wellenlänge als die erfindungsgemäße Verbindung emittiert, sowie eine erfindungsgemäße Verbindung.

Die erfindungsgemäßen Verbindungen lassen sich auch in anderen Funktionen in der elektronischen Vorrichtung einsetzen, beispielsweise als Lochtransportmaterial in einer Lochinjektions- oder -transportschicht, als Ladungserzeugungsmaterial, als Elektronenblockiermaterial, als Lochblockiermaterial oder als Elektronentransportmaterial, beispielsweise in einer Elektronentransportschicht. Ebenso lassen sich die erfindungsgemäßen Verbindungen als Matrixmaterial für andere phosphoreszierende Metallkomplexe in einer emittierenden Schicht einsetzen.

Als Kathode sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z. B. Ca, Ba, Mg, Al, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Mg/Ag, Ca/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, Li₂O, BaF₂, MgO, NaF, CsF, Cs₂CO₃, etc.). Ebenso kommen hierfür organische Alkalimetallkomplexe in Frage, z. B. Liq (Lithiumchinolinat). Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z. B. Al/Ni/NiOₓ, Al/PtOₓ) bevorzugt sein. Für einige Anwendungen muss mindestens eine der Elektroden transparent oder teiltransparent sein, um entweder die Bestrahlung des organischen Materials (O-SC) oder die Auskopplung von Licht (OLED/PLED, O-LASER) zu ermöglichen. Bevorzugte Anodenmaterialien sind hier leitfähige gemischte Metalloxide. Besonders bevorzugt sind Indium-Zinn-Oxid (ITO) oder Indium-Zink-Oxid (IZO). Bevorzugt sind weiterhin leitfähige, dotierte organische Materialien, insbesondere leitfähige dotierte Polymere, z. B. PEDOT, PANI oder Derivate dieser Polymere. Bevorzugt ist weiterhin, wenn auf die Anode ein p-dotiertes Lochtransportmaterial als Lochinjektionsschicht aufgebracht wird, wobei sich als p-Dotanden Metalloxide, beispielsweise MoOs oder WO₃, oder (per)fluorierte elektronenarme Aromaten eignen. Weitere geeignete p-Dotanden sind HAT-CN (Hexacyano-hexaazatriphenylen) oder die Verbindung NPD9 von Novaled. Eine solche Schicht vereinfacht die Lochinjektion in Materialien mit einem tiefen HOMO, also einem betragsmäßig großen HOMO.

In den weiteren Schichten können generell alle Materialien verwendet werden, wie sie gemäß dem Stand der Technik für die Schichten verwendet werden, und der Fachmann kann ohne erfinderisches Zutun jedes dieser Materialien in einer elektronischen Vorrichtung mit den erfindungsgemäßen Materialien kombinieren.

Geeignete Ladungstransportmaterialien, wie sie in der Lochinjektions- bzw. Lochtransportschicht bzw. Elektronenblockierschicht oder in der Elektronentransportschicht der erfindungsgemäßen organischen Elektrolumineszenzvorrichtung verwendet werden können, sind beispielsweise die in Y. Shirota et al., Chem. Rev. 2007, 107(4), 953-1010 offenbarten Verbindungen oder andere Materialien, wie sie gemäß dem Stand der Technik in diesen Schichten eingesetzt werden. Bevorzugt sind als Lochtransportmaterialien, die in einer Lochtransport-, Lochinjektions- oder Elektronenblockierschicht in der erfindungsgemäßen Elektrolumineszenzvorrichtung verwendet werden können, Indenofluorenamin-Derivate (z. B. gemäß WO 06/122630 oder WO 06/100896), die in EP 1661888 offenbarten Aminderivate, Hexaazatriphenylenderivate (z. B. gemäß WO 01/049806), Aminderivate mit kondensierten Aromaten (z. B. gemäß US 5,061,569), die in WO 95/09147 offenbarten Aminderivate, Monobenzoindenofluorenamine (z. B. gemäß WO 08/006449), Dibenzoindenofluorenamine (z. B. gemäß WO 07/140847), Spirobifluoren-Amine (z. B. gemäß WO 2012/034627, WO2014/056565), Fluoren-Amine (z. B. gemäß EP 2875092, EP 2875699 und EP 2875004), Spiro-Dibenzopyran-Amine (z. B. EP 2780325) und Dihydroacridin-Derivate (z. B. gemäß WO 2012/150001).

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck von üblicherweise kleiner 10⁻⁵ mbar, bevorzugt kleiner 10⁻⁶ mbar aufgedampft. Es ist auch möglich, dass der Anfangsdruck noch geringer oder noch höher ist, beispielsweise kleiner 10⁻⁷ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold *et al., Appl. Phys. Lett.* **2008,** 92, 053301).

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck, Offsetdruck oder Nozzle-Printing, besonders bevorzugt aber LITI (Light Induced Thermal Imaging, Thermotransferdruck) oder Ink-Jet Druck (Tintenstrahldruck), hergestellt werden. Hierfür sind lösliche Verbindungen nötig, welche beispielsweise durch geeignete Substitution erhalten werden.

Die organische Elektrolumineszenzvorrichtung kann auch als Hybridsystem hergestellt werden, indem eine oder mehrere Schichten aus Lösung aufgebracht werden und eine oder mehrere andere Schichten aufgedampft werden. So ist es beispielsweise möglich, eine emittierende Schicht enthaltend einen erfindungsgemäßen Metallkomplex und ein Matrixmaterial aus Lösung aufzubringen und darauf eine Lochblockierschicht und/oder eine Elektronentransportschicht im Vakuum aufzudampfen.

Diese Verfahren sind dem Fachmann generell bekannt und können von ihm ohne Probleme auf organische Elektrolumineszenzvorrichtungen enthaltend Verbindungen gemäß Formel (1) bzw. die oben aufgeführten bevorzugten Ausführungsformen angewandt werden.

Die erfindungsgemäßen elektronischen Vorrichtungen, insbesondere organische Elektrolumineszenzvorrichtungen, zeichnen sich durch einen oder mehrere der folgenden überraschenden Vorteile gegenüber dem Stand der Technik aus:
1) Die Verbindungen weisen eine verbesserte Sublimierbarkeit auf gegenüber vergleichbaren Verbindungen, in denen alle drei Gruppen V' bis V³ für eine Gruppe der Formel (3) stehen oder in denen alle drei Gruppen V' bis V³ für eine Gruppe -CR₂-CR₂- stehen.
2) Die Verbindungen weisen eine verbesserte Löslichkeit auf gegenüber vergleichbaren Verbindungen, in denen alle drei Gruppen V' bis V³ für eine Gruppe der Formel (3) stehen oder in denen alle drei Gruppen V' bis V³ für eine Gruppe -CR₂-CR₂- stehen.
3) Die Verbindungen weisen bei Verwendung in einer OLED eine verbesserte Effizienz auf gegenüber vergleichbaren Verbindungen, in denen alle drei Gruppen V' bis V³ für eine Gruppe der Formel (3) stehen oder in denen alle drei Gruppen V' bis V³ für eine Gruppe -CR₂-CR₂- stehen.
4) Die Verbindungen weisen bei Verwendung in einer OLED eine verbesserte Lebensdauer auf gegenüber vergleichbaren Verbindungen, in denen alle drei Gruppen V' bis V³ für eine Gruppe der Formel (3) stehen oder in denen alle drei Gruppen V' bis V³ für eine Gruppe -CR₂-CR₂- stehen.

Diese oben genannten Vorteile gehen nicht mit einer Verschlechterung der weiteren elektronischen Eigenschaften einher.

Die Erfindung wird durch die nachfolgenden Beispiele näher erläutert, ohne sie dadurch einschränken zu wollen. Der Fachmann kann aus den Schilderungen ohne erfinderisches Zutun weitere erfindungsgemäße elektronische Vorrichtungen herstellen und somit die Erfindung im gesamten beanspruchten Bereich ausführen.

### Beispiele:

Die nachfolgenden Synthesen werden, sofern nicht anders angegeben, unter einer Schutzgasatmosphäre in getrockneten Lösungsmitteln durchgeführt. Die Metallkomplexe werden zusätzlich unter Ausschluss von Licht bzw. unter Gelblicht gehandhabt. Die Lösungsmittel und Reagenzien können z. B. von Sigma-ALDRICH bzw. ABCR bezogen werden. Die jeweiligen Angaben in eckigen Klammern bzw. die zu einzelnen Verbindungen angegebenen Nummern beziehen sich auf die CAS-Nummern der literaturbekannten Verbindungen. Bei Verbindungen, die mehrere tautomere, isomere, diastereomere und enantiomere Formen aufweisen können, wird stellvertretend eine Form gezeigt.

### A: Synthese der Synthone S:

### Beispiel S1:

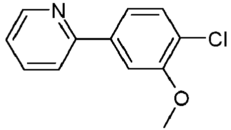

### Variante A: Kupplung der 2-Brompyridine, S1

Ein Gemisch aus 26.9 g (100 mmol) 2-(4-Chlor-3-methoxyphenyl)-4,4,5,5-tetramethyl-1,3,2-dioxaborolan [627525-96-6], 19.0 g (120 mmol) 2-Brompyridin, 21.2 g (200 mmol) Natriumcarbonat, 200 ml Toluol, 50 ml Ethanol und 100 ml Wasser wird unter sehr gutem Rühren mit 1.2 g (1 mmol) Tetrakis-triphenylphosphino-palladium(0) versetzt und dann 24 h unter Rückfluss erhitzt. Nach Erkalten trennt man die organische Phase ab, wäscht diese einmal mit 300 ml Wasser und einmal mit 300 ml gesättigter Kochsalzlösung und trocknet über Magnesiumsulfat. Man filtriert vom Trockenmittel ab, engt das Filtrat im Vakuum vollständig ein und unterzieht den Rückstand einer Kugelrohrdestillation (p ca. 10⁻² mbar, T ca. 200 °C). Ausbeute: 19.8 g (90 mmol), 90 %; Reinheit: ca. 95 %ig n. ¹H-NMR.

### Variante B: Kupplung der 2,5-Dibrompyridine, S7

Ein Gemisch aus 23.7 g (100 mmol) 2,5-Dibrompyridin [624-28-2], 23.4 g (100 mmol) 2-(3-Methoxyphenyl)-4,4,5,5-tetramethyl-1,3,2-dioxaborolan [325142-84-5], 27.6 g (200 mmol) Kaliumcarbonat, 50 g Glaskugeln (3 mm Durchmesser), 526 mg (2 mmol) Triphenylphosphin, 225 mg (1 mmol) Palladium(II)acetat, 200 ml Acetonitril und 100 ml Methanol wird unter gutem Rühren 16 h unter Rückfluss erhitzt. Nach Erkalten entfernt man das Lösungsmittel weitgehend im Vakuum, nimmt den Rückstand in 500 ml Ethylacetat auf, wäscht dreimal mit je 200 ml Wasser und einmal mit 300 ml gesättigter Kochsalzlösung und trocknet über Magnesiumsulfat. Man filtriert vom Trockenmittel ab, engt das Filtrat zur Trockene ein und kristallisiert den Feststoff aus Acetonitril um. Ausbeute: 18.3 g (68 mmol), 68 %; Reinheit: ca. 95 %ig n. ¹H-NMR.

Analog können folgende Verbindungen dargestellt werden.

| Bsp. | Edukte Variante | Produkt | Ausbeute |
|---|---|---|---|
| S2 | 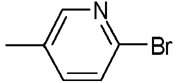 | 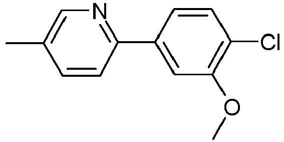 | 83% |
| | 3510-66-5 | | |
| | 627525-96-6 | | |
| | A | | |
| S3 | 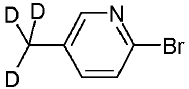 | 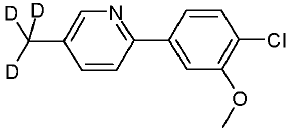 | 85% |
| | 1185306-03-9 | | |
| | 627525-96-6 | | |
| | A | | |
| S4 | 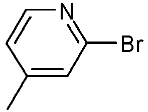 | 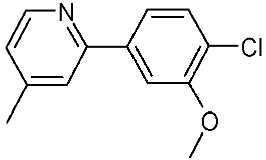 | 88% |
| | 4926-28-7 | | |
| | 627525-96-6 | | |
| | A | | |
| S5 | 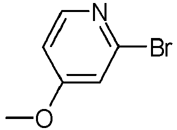 | 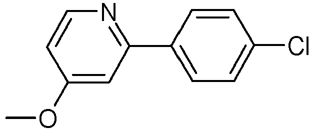 | 74% |
| | 89488-29-9 | | |
| | 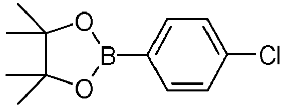 | | |
| | 195062-61-4 | | |
| | A | | |
| S6 | 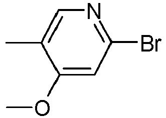 | 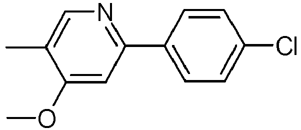 | 70% |
| | 1227574-33-5 | | |
| | 195062-61-4 | | |
| | A | | |
| S7 | 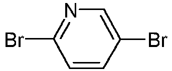 | 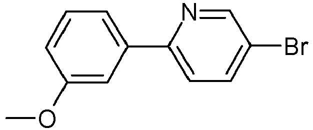 | 65% |
| | 624-28-2 | | |
| | 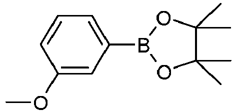 | | |
| | 325142-84-5 | | |
| | B | | |
| S8 | 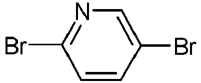 | 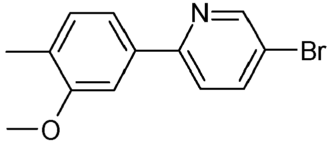 | 69% |
| | 624-28-2 | | |
| | 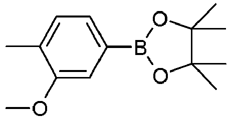 | | |
| | 1417036-28-2 | | |
| | B | | |
| S9 | 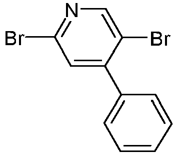 | 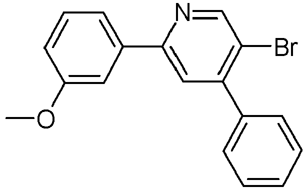 | 67% |
| | 1381937-40-1 | | |
| | 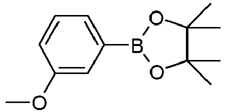 | | |
| | 325142-84-5 | | |
| | B | | |
| S10 | 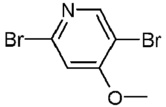 | 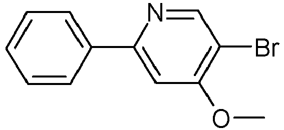 | 65% |
| | 1211520-71-6 | | |
| | 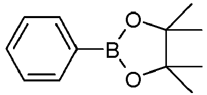 | | |
| | 24388-23-6 | | |
| | B | | |
| S11 | 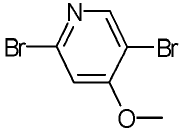 | 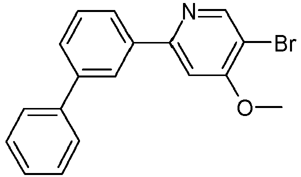 | 70% |
| | 1211520-71-6 | | |
| | 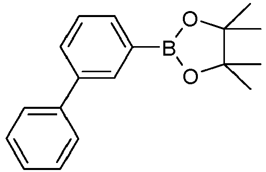 | | |
| | 912844-88-3 | | |
| | B | | |
| S12 | 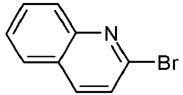 | 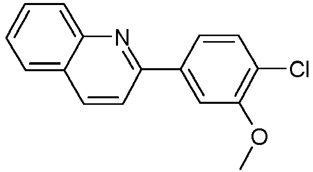 | 73% |
| | 2005-43-8 | | |
| | 627525-96-6 | | |
| | A | | |
| S13 | 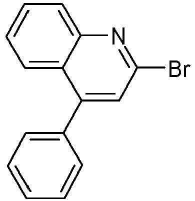 | 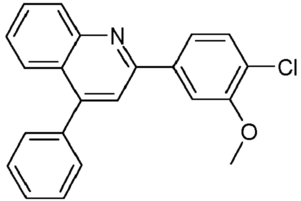 | 77% |
| | 857206-12-3S | | |
| | 627525-96-6 | | |
| | A | | |
| S14 | 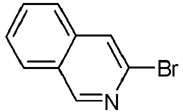 | 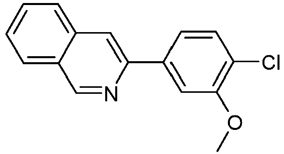 | 77% |
| | 34784-02-6 | | |
| | 627525-96-6 | | |
| | A | | |
| S15 | 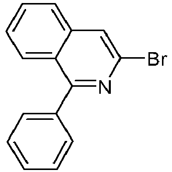 | 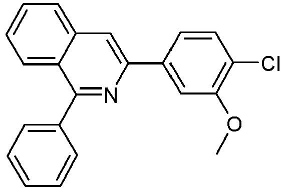 | 77% |
| | 2073111-76-7 | | |
| | 627525-96-6 | | |
| | A | | |
| S16 | 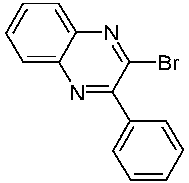 | 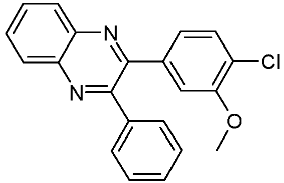 | 73% |
| | 1195563-58-6 | | |
| | 627525-96-6 | | |
| | A | | |
| S17 | 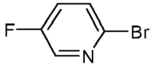 | 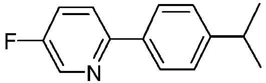 | 81% |
| | 41404-58-4 | | |
| | 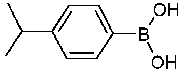 | | |
| | 16152-51-5 | | |
| | B | | |

### Beispiel S50:

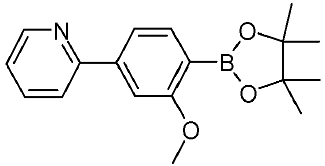

### Variante A:

Ein Gemisch aus 22.0 g (100 mmol) S1, 26.7 g (105 mmol) Bis(pinaco-lato)diboran, 29.4 g (300 mmol) Kaliumacetat (wasserfrei), 50 g Glaskugeln (3 mm Durchmesser) und 300 ml THF wird unter gutem Rühren mit 821 mg (2 mmol) SPhos und dann mit 225 mg (1 mmol) Palladium(II)-acetat versetzt und 16 h unter Rückfluss erhitzt. Nach Erkalten saugt man von den Salzen und Glaskugeln über ein mit THF vorgeschlämmtes Celite-Bett ab, wäscht dieses mit etwas THF nach und engt das Filtrat zur Trockene ein. Man nimmt den Rückstand in 100 ml MeOH auf, rührt warm aus, saugt vom auskristallisierten Produkt ab, wäscht zweimal mit je 30 ml Methanol nach und trocknet im Vakuum. Ausbeute: 27.4 g (88 mmol), 88 %; Reinheit: ca. 95 %ig n. ¹H-NMR.

### Variante B:

Durchführung analog zu Variante A, jedoch wird das SPhos durch Tricyclohexylphosphin ersetzt.

Analog können folgende Verbindungen dargestellt werden.

| Bsp. | Edukt Variante | Produkt | Ausbeute |
|---|---|---|---|
| S51 | S2 | 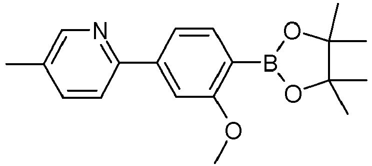 | 90% |
| | A | | |
| S52 | S3 | 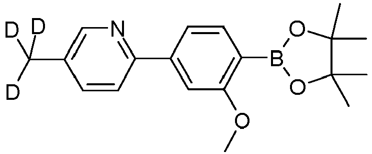 | 89% |
| | A | | |
| S53 | S4 | 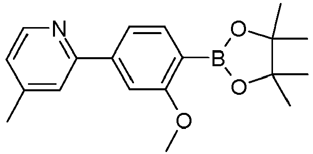 | 87% |
| | A | | |
| S54 | S5 | 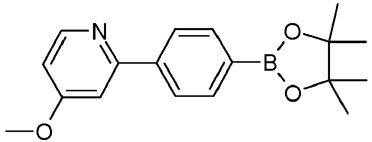 | 90% |
| | A | | |
| S55 | S6 | 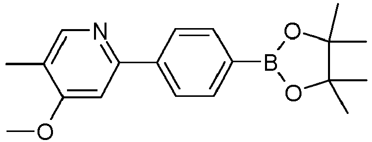 | 87% |
| | A | | |
| S56 | S7 | 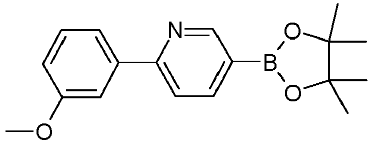 | 84% |
| | A | | |
| S57 | S8 | 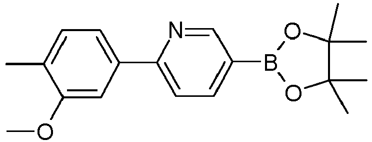 | 88% |
| | A | | |
| S58 | S9 | 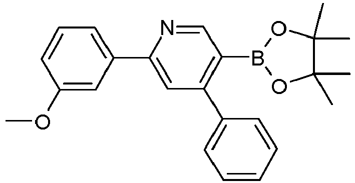 | 85% |
| | B | | |
| S59 | S10 | 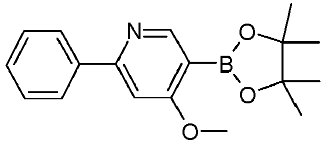 | 87% |
| | A | | |
| S60 | S11 | 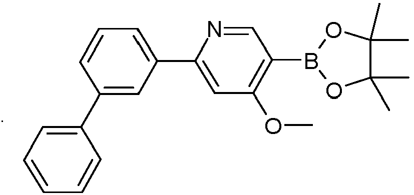 | 90% |
| | A | | |
| S61 | S12 | 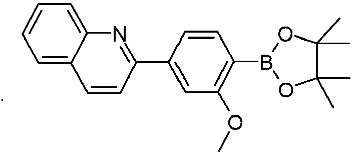 | 94% |
| | A | | |
| S62 | S13 | 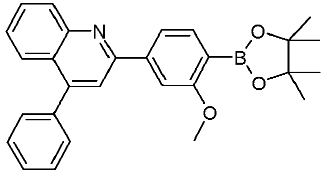 | 91% |
| | A | | |
| S63 | S14 | 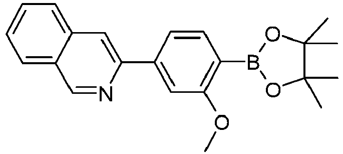 | 90% |
| | A | | |
| S64 | S15 | 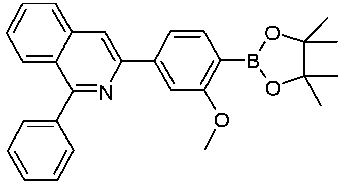 | 90% |
| | A | | |
| S65 | S16 | 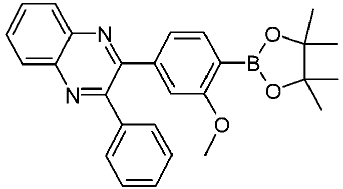 | 90% |
| | A | | |
| S66 | 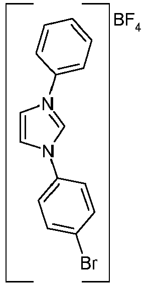 | 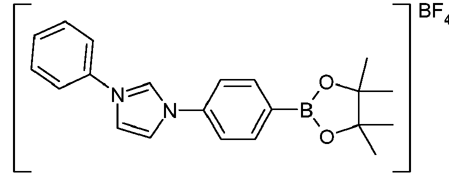 | 55% |
| | | Ausrühren mit Acetonitril | |
| | 1434057-17-6 | | |
| | A | | |

### Beispiel S100:

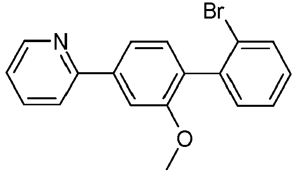

Ein Gemisch aus 31.1 g (100 mmol) S50, 28.3 g (100mol) 1-Brom-2-iodbenzol [583-55-1], 31.8 g (300 mmol) Natriumcarbonat, 200 ml Toluol, 70 ml Ethanol und 200 ml Wasser wird unter sehr gutem Rühren mit 788 mg (3 mmol) Triphenylphosphin und dann mit 225 mg (1 mmol) Palladium(II)acetat versetzt und 48 h unter Rückfluss erhitzt. Nach Erkalten trennt man die organische Phase ab, wäscht diese einmal mit 300 ml Wasser und einmal mit 300 ml gesättigter Kochsalzlösung und trocknet über Magnesiumsulfat. Man filtriert vom Trockenmittel ab und engt das Filtrat um Vakuum vollständig ein. Der Rückstand wird Flashchromatographiert (Säulenautomat Torrent der Fa. A. Semrau). Ausbeute: 32.3 g (95 mmol), 95 %; Reinheit: ca. 97 %ig n. ¹H-NMR.

Analog können folgende Verbindungen dargestellt werden.

| Bsp. | Edukt | Produkt | Ausbeute |
|---|---|---|---|
| S101 | S51 | 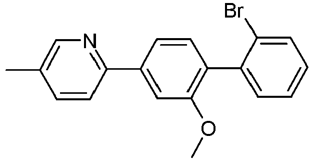 | 90% |
| S102 | S52 | 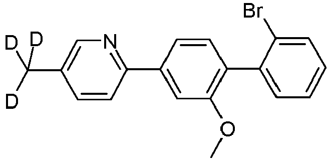 | 87% |
| S103 | S53 | 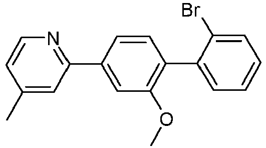 | 91% |
| S104 | S54 | 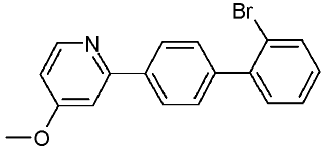 | 86% |
| S105 | S55 | 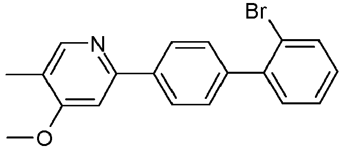 | 93% |
| S106 | S56 | 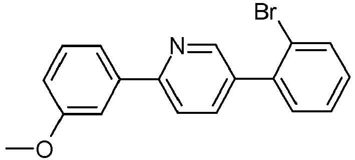 | 86% |
| S107 | S57 | 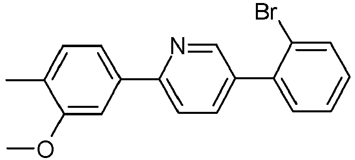 | 86% |
| S108 | S58 | 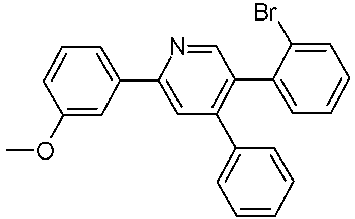 | 89% |
| S109 | S59 | 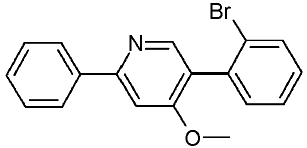 | 87% |
| S110 | S60 | 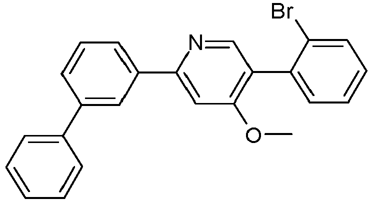 | 90% |
| S111 | S61 | 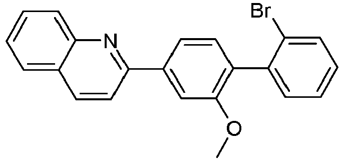 | 88% |
| S112 | S62 | 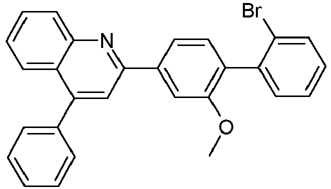 | 85% |
| S113 | S63 | 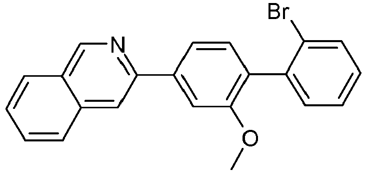 | 8β% |
| S114 | S64 | 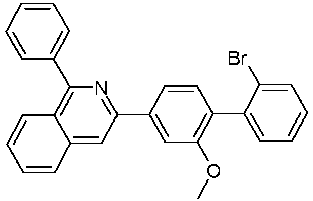 | 80% |
| S115 | S65 | 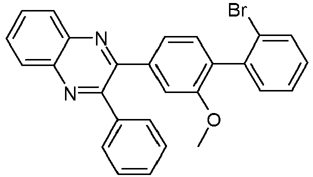 | 76% |
| S116 | 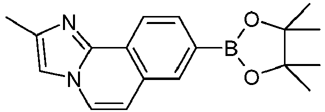 | 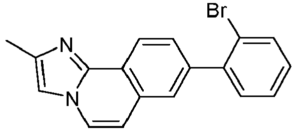 | 80% |
| | 1989597-11-6 | | |
| S117 | 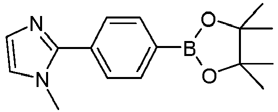 | 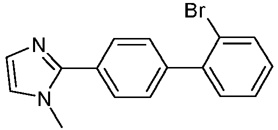 | 89% |
| | 1394374-23-2 | | |
| S118 | 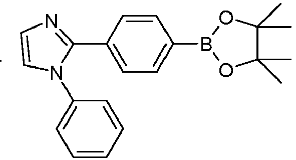 | 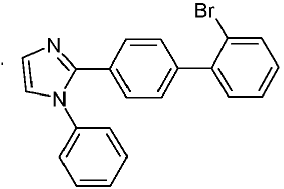 | 86% |
| | 1621467-82-0 | | |
| S119 | 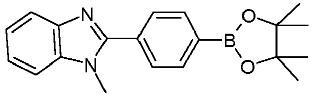 | 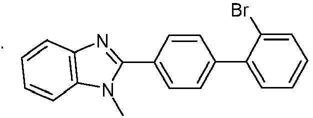 | 85% |
| | 1466412-09-8 | | |
| S120 | 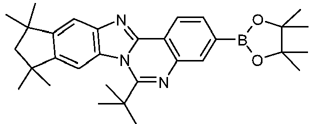 | 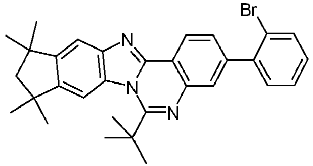 | 77% |
| | 1989597-13-8 | | |
| S121 | 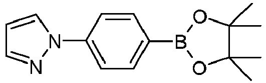 | 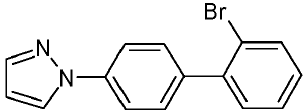 | 80% |
| | 1312478-63-9 | | |
| S122 | S66 | 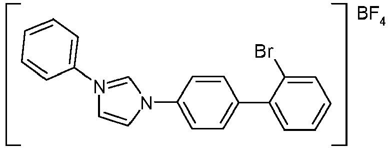 | 67% |
| | | Extraktion der Wasserphase mit Dichlormethan / Umkristallisation der Rohprodukts aus Acetonitril / MeOH | |
| S123 | 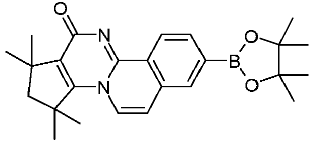 | 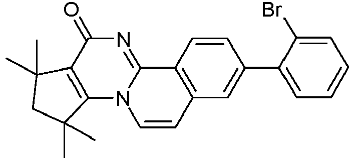 | 85% |
| | 1989597-91-2 | | |
| S124 | S554 | 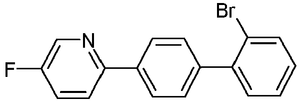 | 76% |

### Beispiel S150:

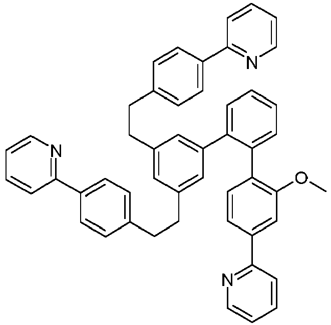

Ein Gemisch aus 56.7 g (100 mmol) S358, 34.0 g (100 mmol) S100, 63.7 g (300 mmol) Trikaliumphosphat, 300 ml Toluol, 150 ml Dioxan und 300 ml Wasser wird unter gutem Rühren mit 1.64 g (4 mmol) SPhos und dann mit 449 mg (2 mmol) Palladium(II)acetat versetzt und anschließend 24 h unter Rückfluss erhitzt. Nach Erkalten trennt man die organische Phase ab, wäscht diese zweimal mit je 300 ml Wasser und einmal mit 300 ml gesättigter Kochsalzlösung und trocknet über Magnesiumsulfat. Man filtriert vom Trockenmittel ab, engt das Filtrat im Vakuum zur Trockene ein und kristallisiert das glasartige Rohprodukt in der Siedehitze aus Acetonitril (-150 ml) und dann ein zweites Mal aus Acetonitril/Ethylacetat um. Ausbeute: 51.8 g (74 mmol), 74 %; Reinheit: ca. 95 %ig n. ¹H-NMR.

Analog können folgende Verbindungen dargestellt werden.

| Bsp. | Edukte | Produkt | Ausbeute |
|---|---|---|---|
| S151 | S358 | 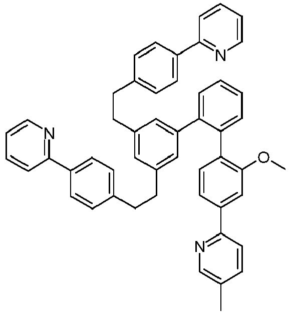 | 71% |
| | S101 | | |
| S152 | S358 | 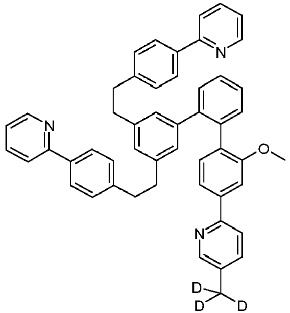 | 75% |
| | S102 | | |
| S153 | S358 | 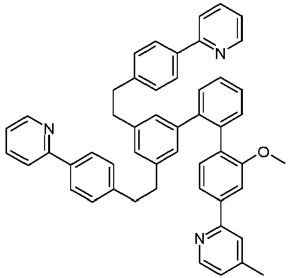 | 70% |
| | S103 | | |
| S154 | S359 | 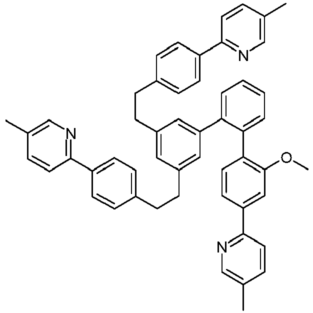 | 68% |
| | S101 | | |
| S155 | S360 | 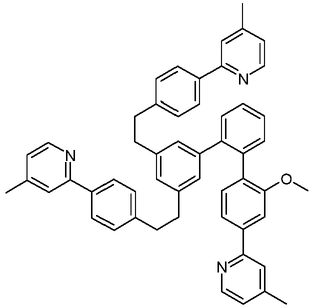 | 70% |
| | S103 | | |
| S156 | S361 | 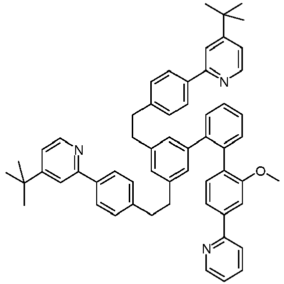 | 73% |
| | S100 | | |
| S157 | S358 | 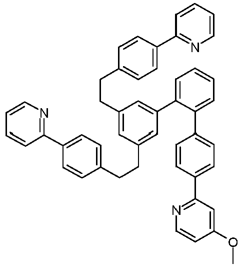 | 71% |
| | S104 | | |
| S158 | S358 | 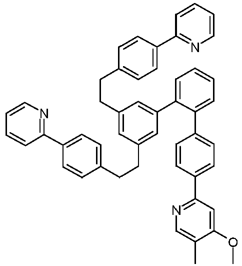 | 71% |
| | S105 | | |
| S159 | S359 | 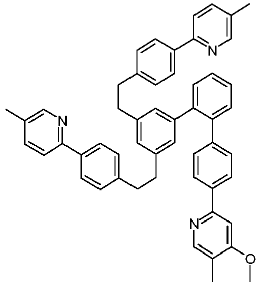 | 76% |
| | S105 | | |
| S160 | S362 | 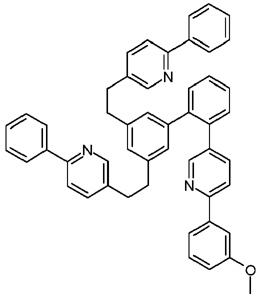 | 70% |
| | S106 | | |
| S161 | S362 | 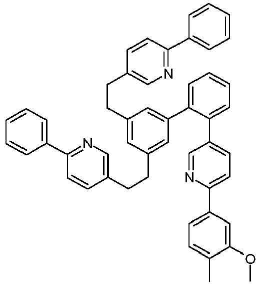 | 69% |
| | S107 | | |
| S162 | S362 | 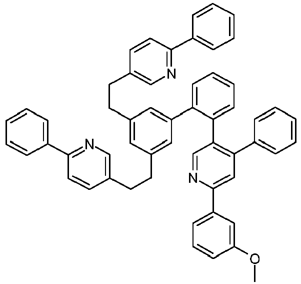 | 74% |
| | S108 | | |
| S163 | S363 | 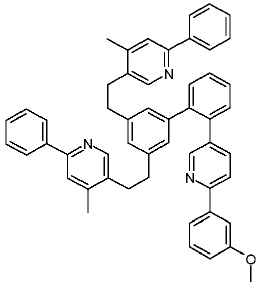 | 69% |
| | S106 | | |
| S164 | S364 | 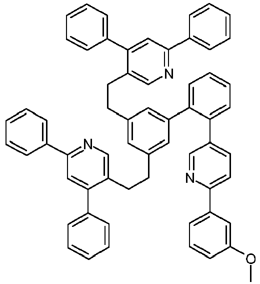 | 70% |
| | S106 | | |
| S165 | S362 | 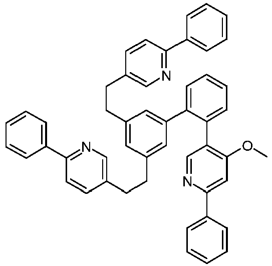 | 75% |
| | S109 | | |
| S166 | S362 | 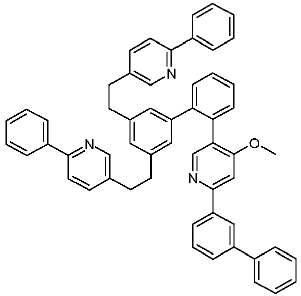 | 72% |
| | S110 | | |
| S167 | S363 | 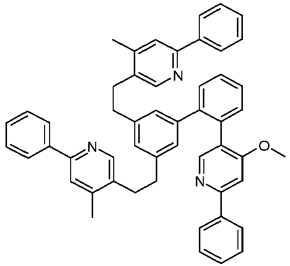 | 71% |
| | S109 | | |
| S168 | S358 | 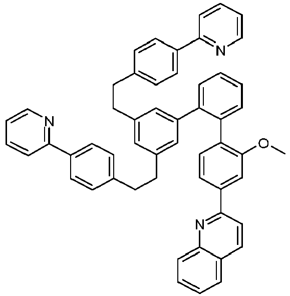 | 70% |
| | S111 | | |
| S169 | S359 | 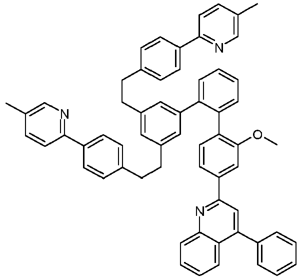 | 73% |
| | S112 | | |
| S170 | S360 | 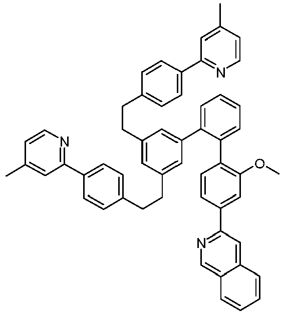 | 80% |
| | S113 | | |
| S171 | S358 | 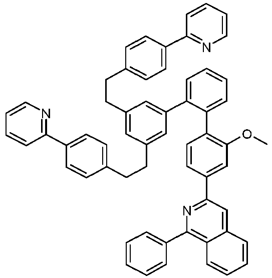 | 78% |
| | S114 | | |
| S172 | S358 | 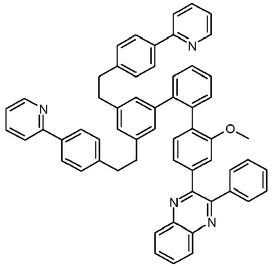 | 65% |
| | S115 | | |
| S173 | S350 | 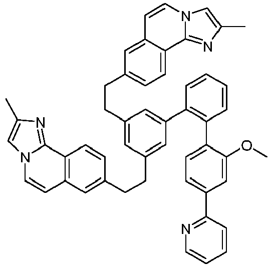 | 74% |
| | S100 | | |
| S174 | S350 | 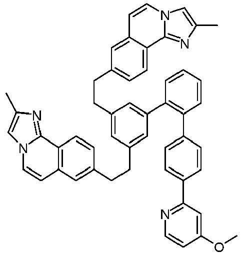 | 76% |
| | S104 | | |
| S175 | S351 | 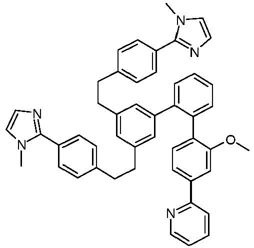 | 73% |
| | S100 | | |
| S176 | S351 | 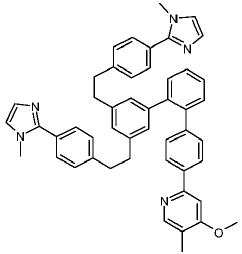 | 69% |
| | S105 | | |
| S177 | S352 | 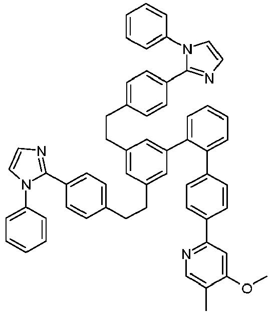 | 74% |
| | S105 | | |
| S178 | S353 | 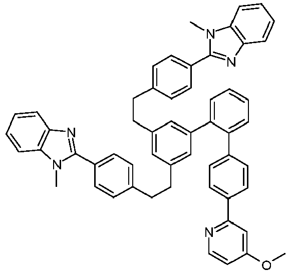 | 75% |
| | S104 | | |
| S179 | S354 | 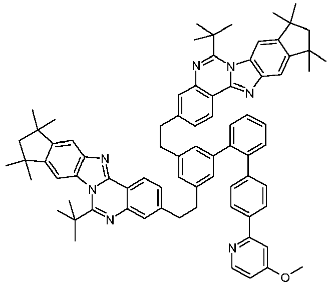 | 66% |
| | S104 | | |
| S180 | S355 | 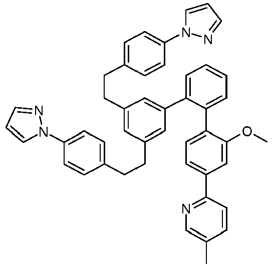 | 77% |
| | S101 | | |
| S181 | S355 | 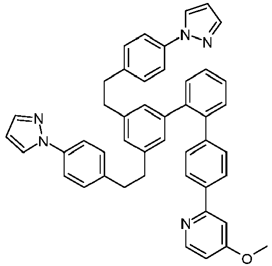 | 75% |
| | S104 | | |
| S182 | S355 | 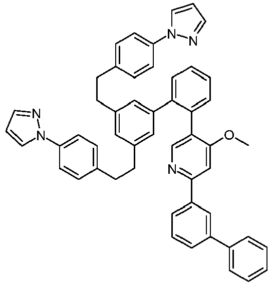 | 75% |
| | S110 | | |
| S183 | S356 | 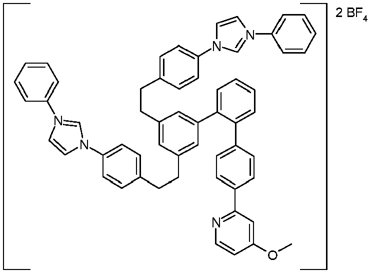 | 51% |
| | S104 | | |
| | | Extraktion der Wasserphase mit DCM | |
| S184 | S357 | 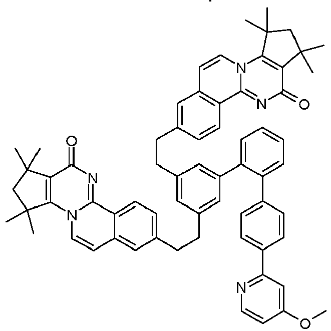 | 69% |
| | S104 | | |

### Beispiel S200:

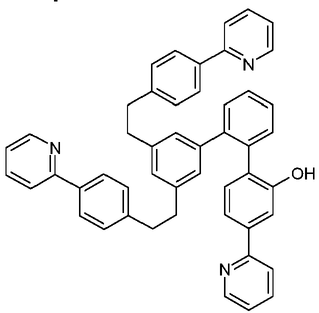

Ein Gemisch aus 70.0 g (100 mmol) S150 und 115.6 g (1 mol) Pyridinium-Hydrochlorid wird am Wasserabscheider 4 h auf 220 °C (Heizschale) erhitzt, wobei das Destillat von Zeit zu Zeit abgelassen wird. Man lässt die Reaktionsmischung abkühlen, gibt ab ~150 °C tropfenweise 500 ml Wasser zu (Vorsicht: Siedeverzüge) und rührt über Nacht nach. Man saugt vom beigen Feststoff ab, suspendiert diesen in 700 ml MeOH, stellt unter Rühren durch Zugabe von Triethylamin neutral, rührt weitere 5 h nach und gibt gegebenenfalls erneut Triethylamin bis zur neutralen Reaktion zu. Man saugt vom Feststoff ab, wäscht diesen dreimal mit je 100 ml MeOH und trocknet im Vakuum. Ausbeute: 62.5 g (91 mmol), 91 %; Reinheit: ca. 95 %ig n. ¹H-NMR.

Analog können folgende Verbindungen dargestellt werden.

| Bsp. | Edukte | Produkt | Ausbeute |
|---|---|---|---|
| S201 | S151 | 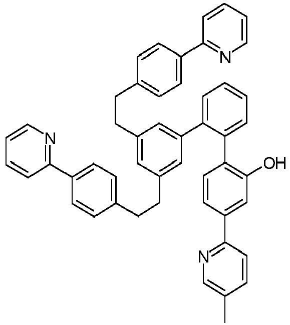 | 85% |
| S202 | S152 | 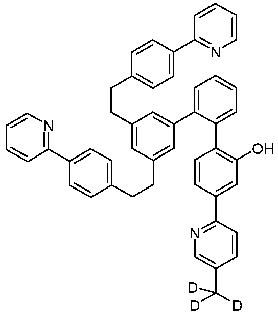 | 90% |
| S203 | S153 | 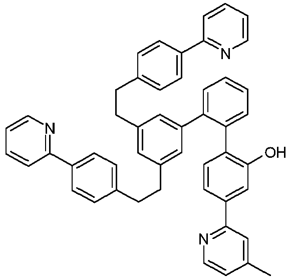 | 87% |
| S204 | S154 | 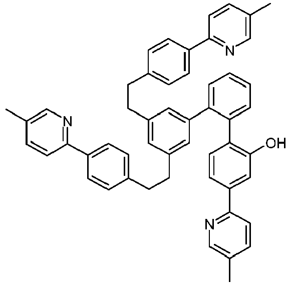 | 86% |
| S205 | S155 | 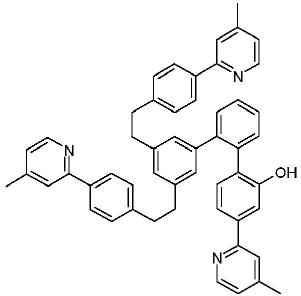 | 85% |
| S206 | S156 | 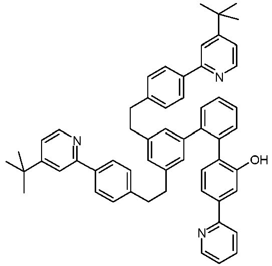 | 90% |
| S207 | S157 | 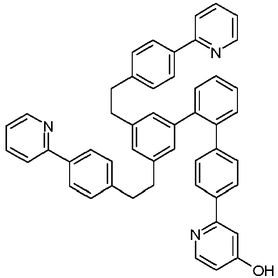 | 89% |
| S208 | S158 | 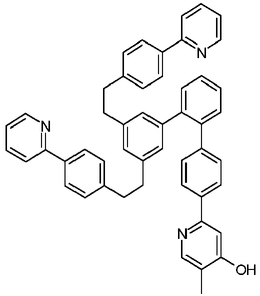 | 90% |
| S209 | S159 | 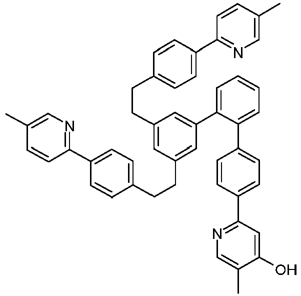 | 83% |
| S210 | S160 | 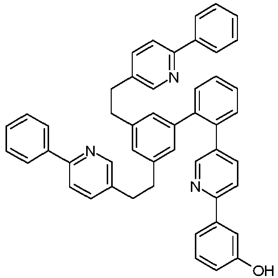 | 81% |
| S211 | S161 | 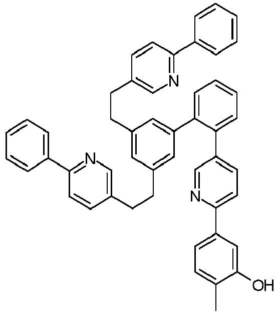 | 84% |
| S212 | S162 | 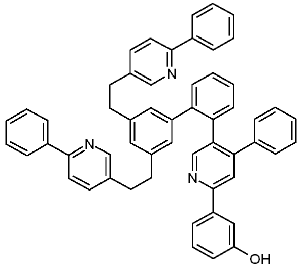 | 85% |
| S213 | S163 | 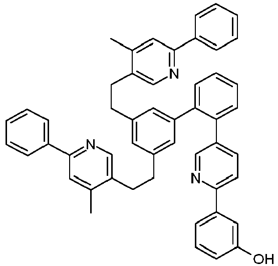 | 85% |
| S214 | S164 | 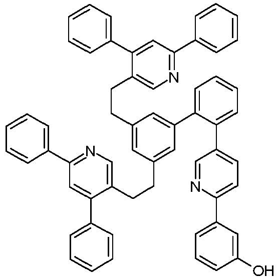 | 82% |
| S215 | S165 | 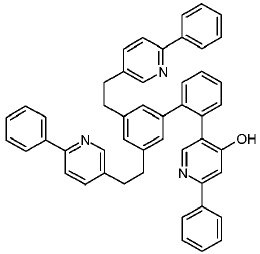 | 83% |
| S216 | S166 | 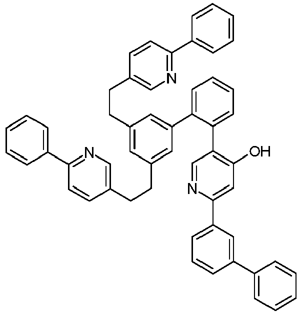 | 85% |
| S217 | S167 | 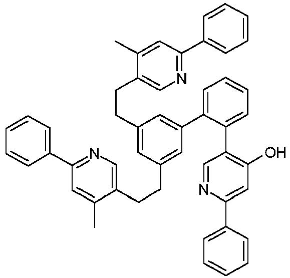 | 81% |
| S218 | S168 | 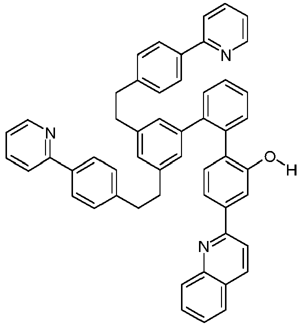 | 84% |
| S219 | S169 | 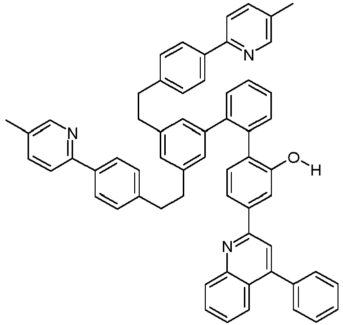 | 84% |
| S220 | S170 | 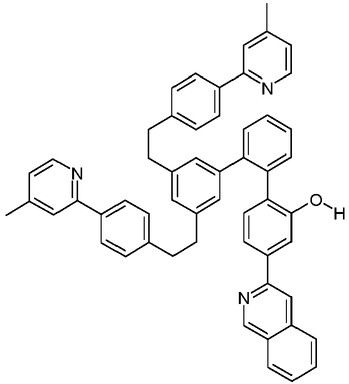 | 90% |
| S221 | S171 | 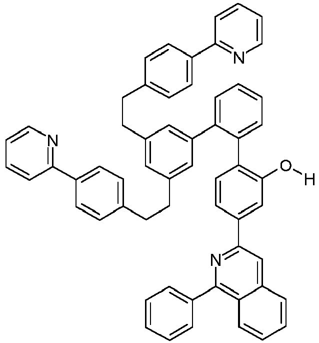 | 85% |
| S222 | S172 | 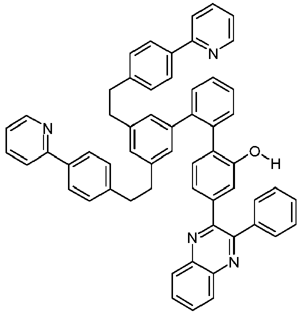 | 86% |
| S223 | S173 | 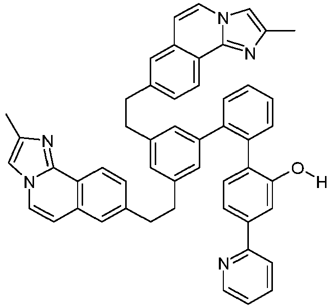 | 85% |
| S224 | S174 | 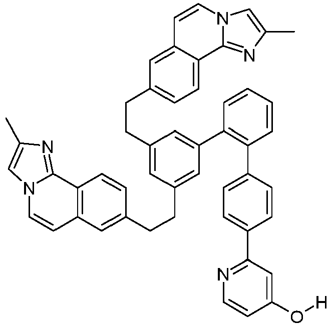 | 80% |
| S225 | S175 | 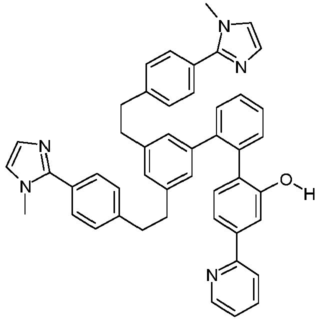 | 83% |
| S226 | S176 | 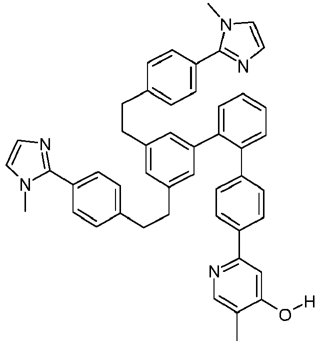 | 81% |
| S227 | S177 | 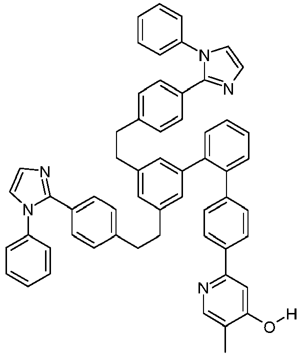 | 80% |
| S228 | S178 | 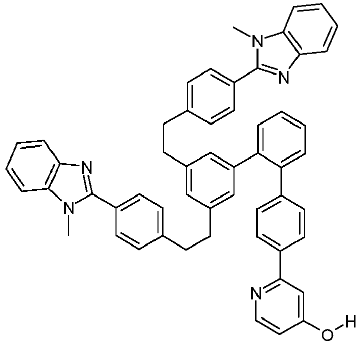 | 85% |
| S229 | S179 | 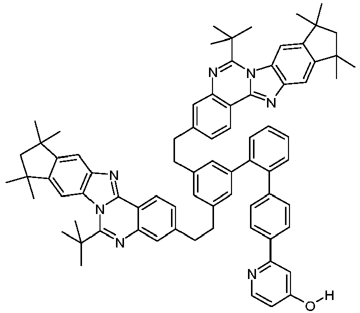 | 78% |
| S230 | S180 | 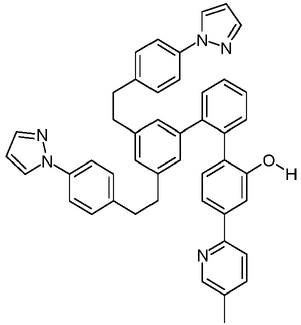 | 80% |
| S231 | S181 | 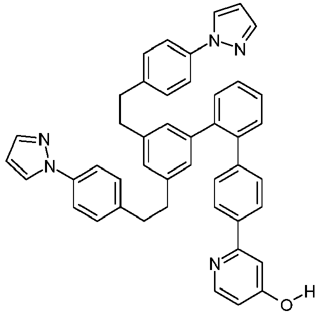 | 85% |
| S232 | S182 | 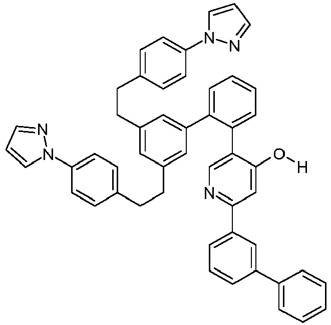 | 84% |
| S233 | S183 | 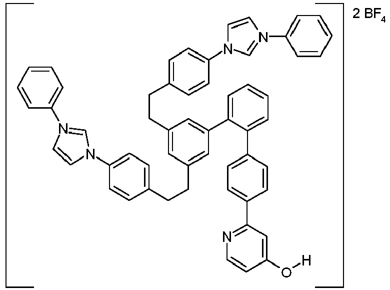 | 55% |
| S234 | S184 | 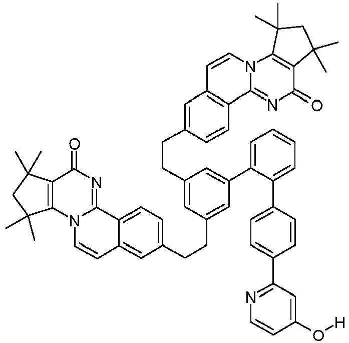 | 83% |
| S235 | L211 | 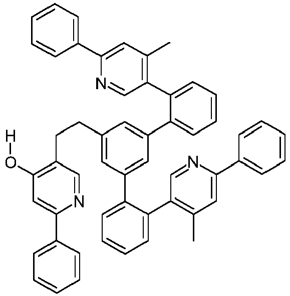 | 86% |

### Beispiel S250:

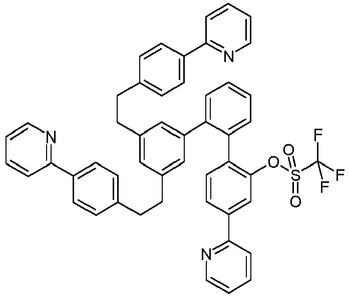

Eine Suspension von 68.6 g (100 mmol) S200 in 1000 ml DCM wird unter Eiskühlung bei 0 °C und gutem Rühren mit 23.7 ml (300 mmol) Pyridin und dann tropfenweise mit 33.6 ml (200 mmol) Trifluormethansulfonsäureanhydrid versetzt. Man rührt 1 h bei 0 °C und dann 4 h bei Raumtemperatur nach. Man gießt die Reaktionslösung auf 3 L Eiswasser, rührt 15 min. nach, trennt die organische Phase ab, wäscht diese einmal mit 300 ml Eiswasser und einmal mit 300 ml gesättigter Kochsalzlösung, trocknet über Magnesiumsulfat, filtriert vom Trockenmittel ab, engt das Filtrat zur Trockene und kristallisiert den Schaum aus Ethylacetat in der Siedehitze um. Ausbeute: 57.3 g (70 mmol), 70 %; Reinheit: ca. 95 %ig n. ¹H-NMR.

Analog können folgende Verbindungen dargestellt werden.

| Bsp. | Edukt | Produkt | Ausbeute |
|---|---|---|---|
| S251 | S201 | 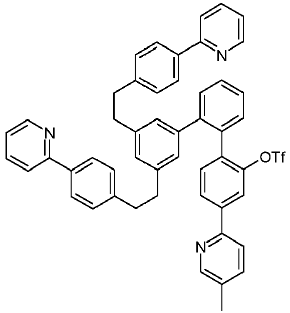 | 68% |
| S252 | S202 | 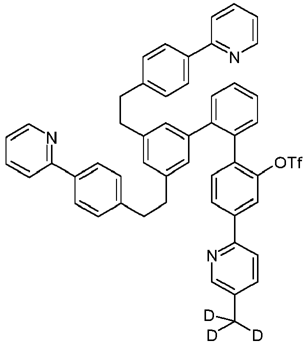 | 65% |
| S253 | S203 | 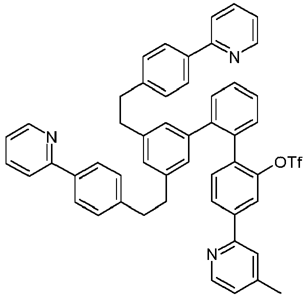 | 707% |
| S254 | S204 | 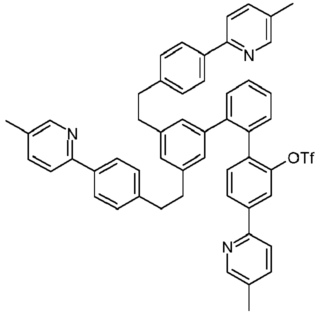 | 71% |
| S255 | S205 | 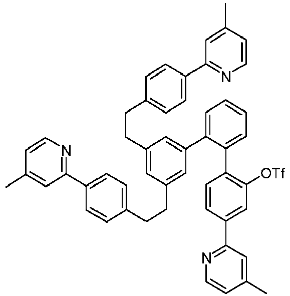 | 68% |
| S256 | S206 | 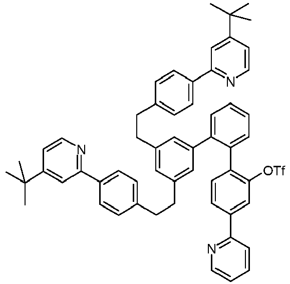 | 67% |
| S257 | S207 | 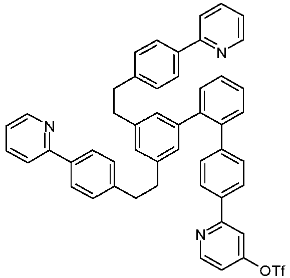 | 69% |
| S258 | S208 | 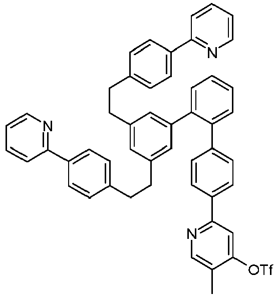 | 70% |
| S259 | S209 | 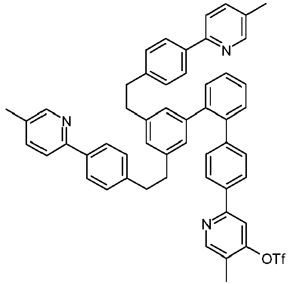 | 68% |
| S260 | S210 | 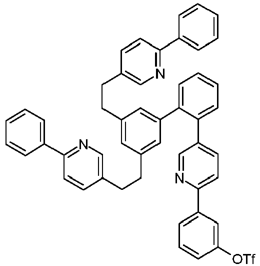 | 70% |
| S261 | S211 | 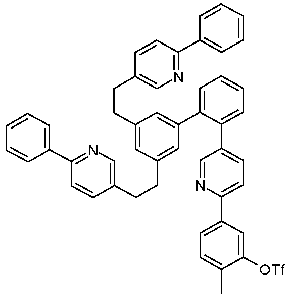 | 64% |
| S262 | S212 | 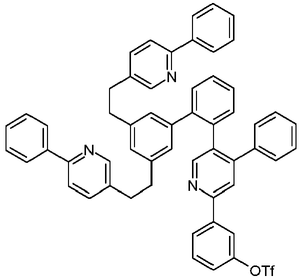 | 66% |
| S263 | S213 | 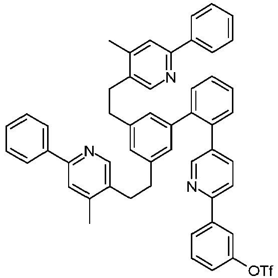 | 69% |
| S264 | S214 | 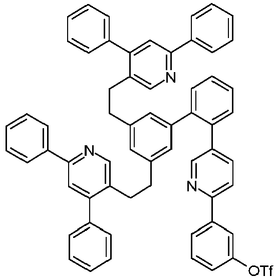 | 67% |
| S265 | S215 | 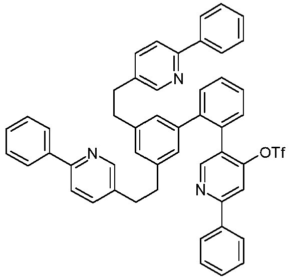 | 70% |
| S266 | S216 | 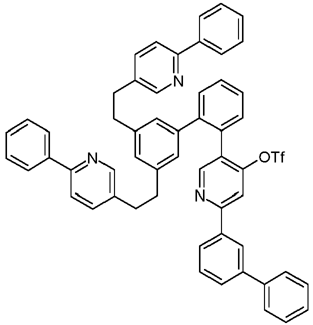 | 70% |
| S267 | S217 | 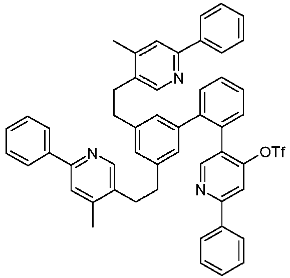 | 68% |
| S268 | S218 | 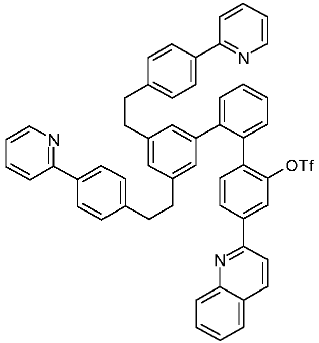 | 65% |
| S269 | S219 | 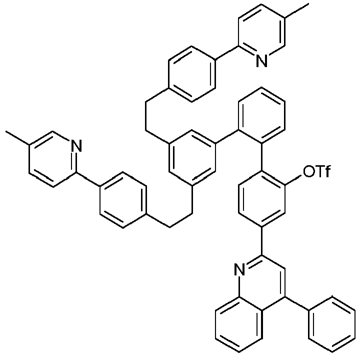 | 64% |
| S270 | S220 | 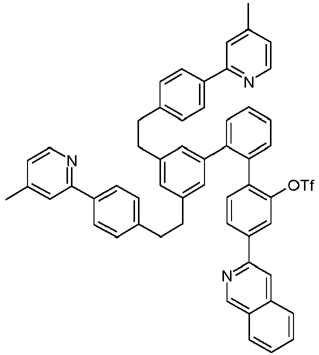 | 69% |
| S271 | S221 | 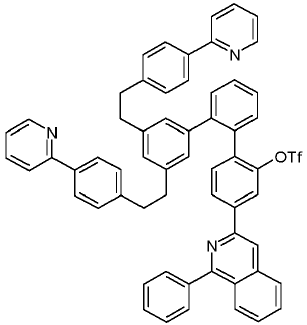 | 65% |
| S272 | S222 | 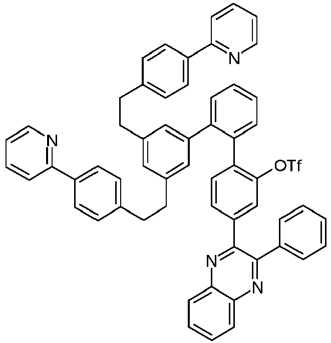 | 70% |
| S273 | S223 | 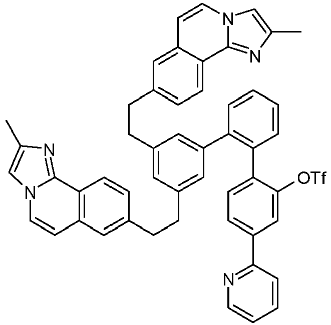 | 73% |
| S274 | S224 | 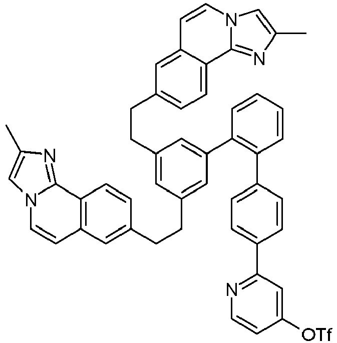 | 69% |
| S275 | S225 | 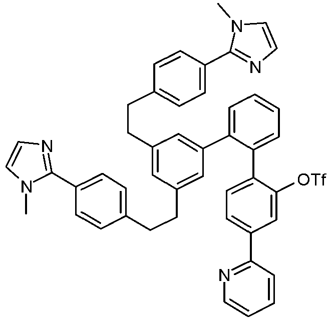 | 68% |
| S276 | S226 | 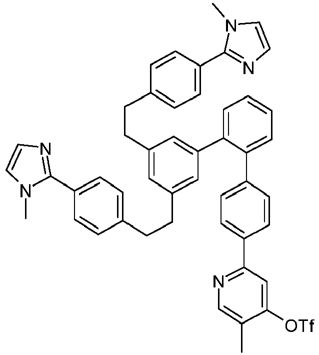 | 72% |
| S277 | S227 | 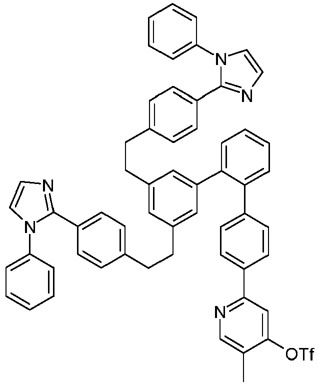 | 70% |
| S278 | S228 | 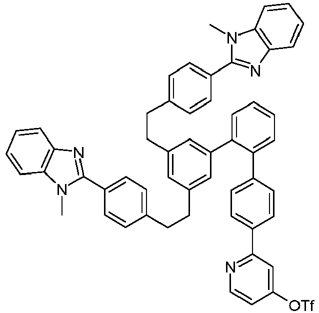 | 65% |
| S279 | S229 | 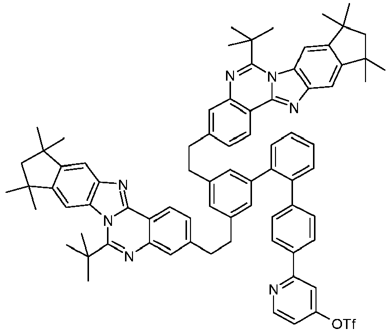 | 65% |
| S280 | S230 | 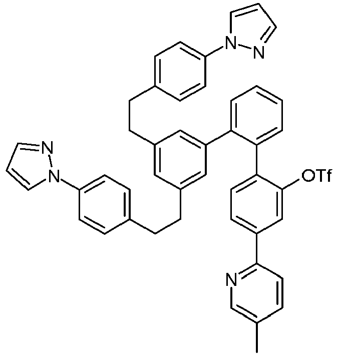 | 68% |
| S281 | S231 | 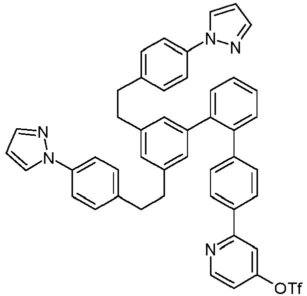 | 67% |
| S282 | S232 | 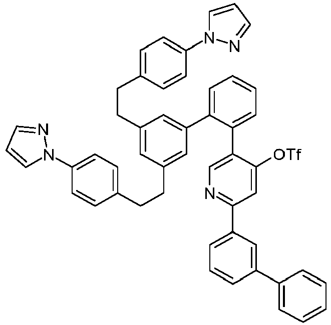 | 90% |
| S283 | S233 | 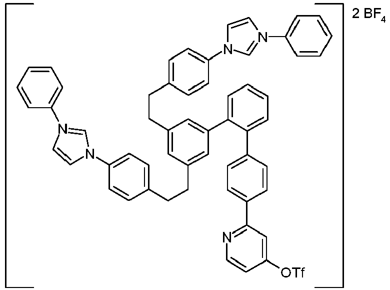 | 60% |
| S284 | S234 | 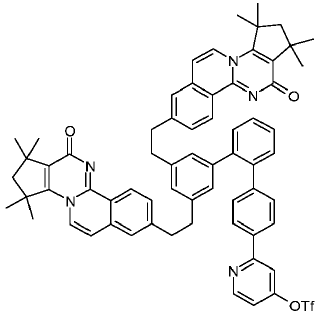 | 63% |
| S285 | S235 | 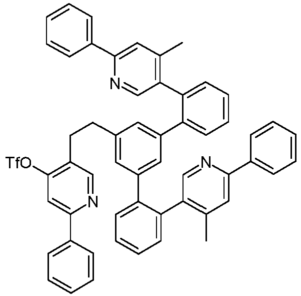 | 70% |

### Beispiel S300:

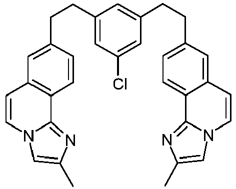

Ein gut gerührtes Gemisch aus 52.2 g (200 mmol) S400, 16.1 g (100 mmol) 1-Chlor-3,5-ethinyl-benzol [1378482-52-0], 56 ml (400 mmol) Triethylamin, 3.8 g (20 mmol) Kupfer(I)iodid, 898 mg (4 mmol) Tetrakistriphenyphosphino-palladium(0) und 500 ml DMF wird 8 h bei 70 °C gerührt. Man saugt noch warm vom gebildeten Triethylammoniumhydrobromid ab und wäscht dieses einmal mit 50 ml DMF. Das Filtrat wird zur Trockene eingeengt, der Rückstand in 1000 ml Ethylacetat aufgenommen, die organische Phase dreimal mit je 200 ml 20 Gew.-%iger Ammoniaklösung, dreimal mit je 200 ml Wasser und einmal mit 200 ml gesättigter Kochsalzlösung gewaschen und über Magnesiumsulfat getrocknet. Man filtriert über ein mit Ethylacetat vorgeschlämmtes Celite-Bett ab und entfernt das Lösungsmittel im Vakuum. Der so erhaltene Feststoff wird einmal mit 150 ml Methanol ausgerührt und dann im Vakuum getrocknet. Der Festsoff wird in einem Gemisch aus 300 ml THF und 300 ml MeOH untere Zugabe von 3 g Palladium (5%) auf Kohle und 16.1 g (300 mmol) NH₄Cl bei 40 °C unter 3 bar Wasserstoff-Atmosphäre bis zur beendeten Wasserstoffaufnahme (ca. 12 h) hydriert. Man filtriert vom Katalysator über ein mit THF vorgeschlämmtes Celite-Bett ab, entfernt das Lösungsmittel im Vakuum und flash-chromatographiert den Rückstand an einem Säulenautomaten (CombiFlashTorrent der Fa. A Semrau). Ausbeute: 36.1 g (68 mmol), 68 %; Reinheit: ca. 97 %ig n. ¹H-NMR.

Die Hydrierung des Bisalkins kann auch nach S. P. Cummings et al., J. Am. Chem. Soc., 138, 6107, 2016 erfolgen.

Analog kann auch die Deuterierung des intermediären Bisalkins unter Verwendung von Deuterium, H₃COD und ND₄Cl erfolgen, wobei anstelle der -CH₂-CH₂- Brücken -CD₂-CD₂- Brücken erhalten werden.

Analog können folgende Verbindungen dargestellt werden:

| Bsp. | Edukt | Produkt | Ausbeute |
|---|---|---|---|
| S301 | S401 | 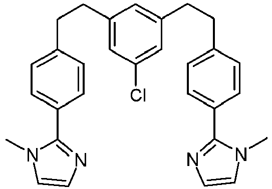 | 63% |
| S302 | S402 | 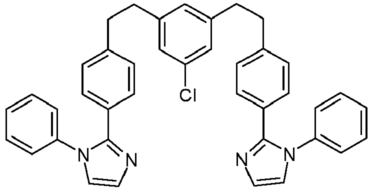 | 66% |
| S303 | S403 | 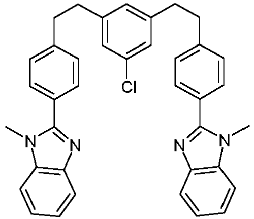 | 56% |
| S304 | S404 | 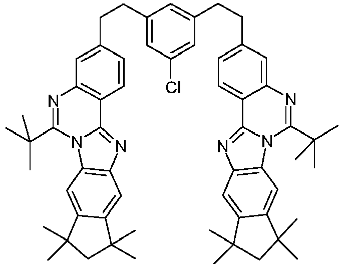 | 59% |
| S305 | S405 | 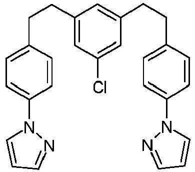 | 67% |
| S306 | S406 | 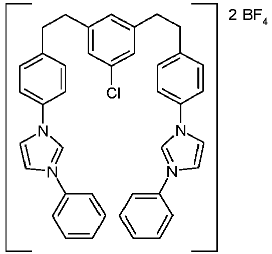 | 27% |
| S307 | S407 | 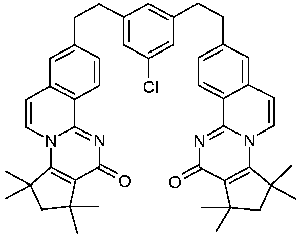 | 55% |
| S308 | 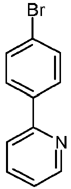 | 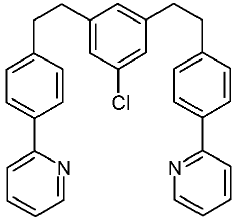 | 60% |
| | [63996-36-1] | | |
| S309 | 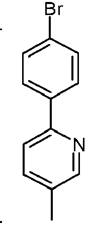 | 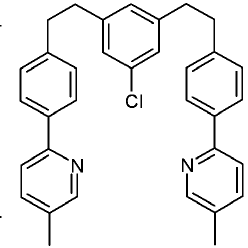 | 63% |
| | [113744-24-4] | | |
| S310 | 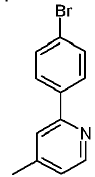 | 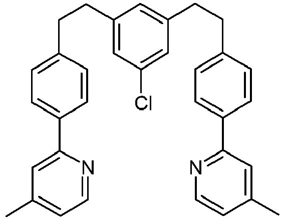 | 67% |
| | [656257-50-0] | | |
| S311 | 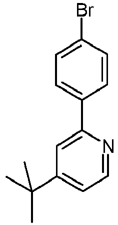 | 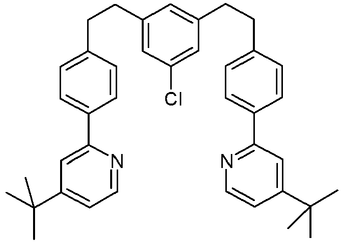 | 63% |
| | [1246851-70-6] | | |
| S312 | 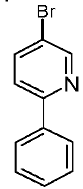 | 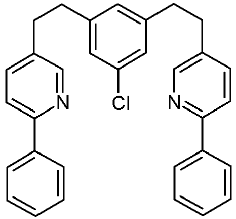 | 64% |
| | [27012-25-5] | | |
| S312-D8 | 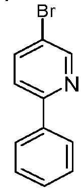 | 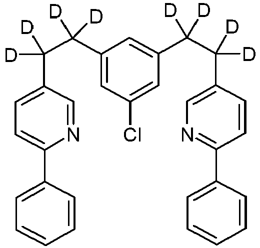 | 70% |
| | [27012-25-5] | | |
| S313 | 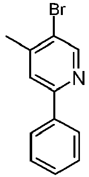 | 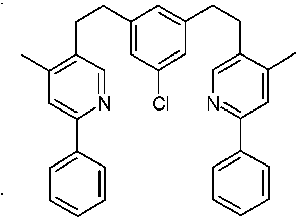 | 51% |
| | [31686-64-3] | | |
| S313-D8 | 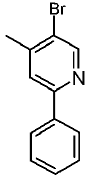 | 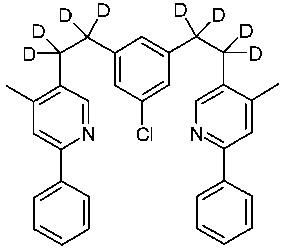 | 55% |
| | [31686-64-3] | | |
| S314 | 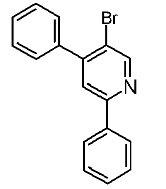 | 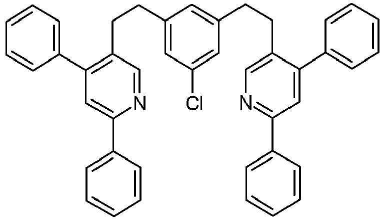 | 46% |
| | [1989596-06-6] | | |
| S315 | S408 | 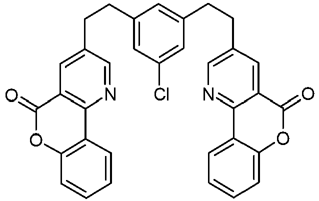 | 28% |
| S315-D8 | S408 | 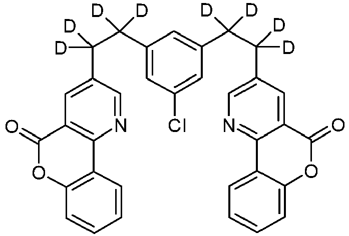 | 32% |
| S316 | S409 | 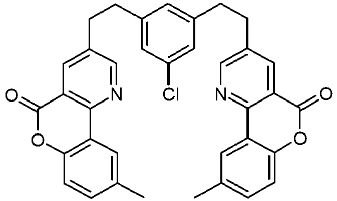 | 33% |
| S317 | S410 | 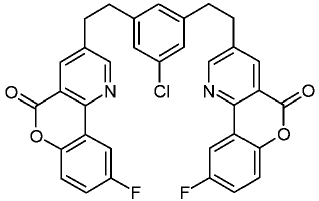 | 35% |
| S318 | S411 | 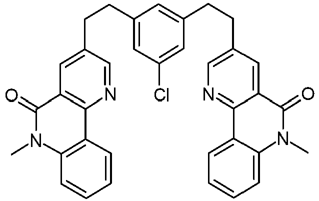 | 31% |
| S319 | S570 | 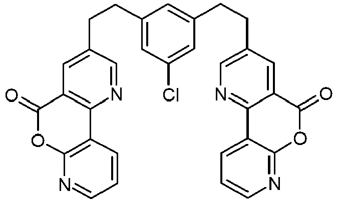 | 35% |
| S319-D8 | S570 | 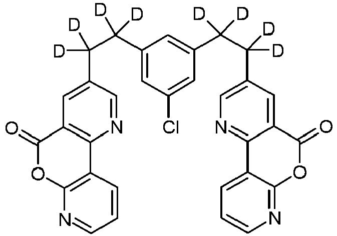 | 30% |
| S320 | S571 | 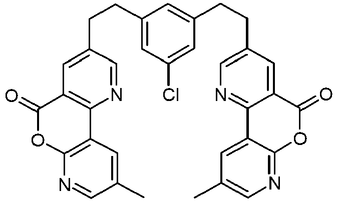 | 39% |
| S321 | S572 | 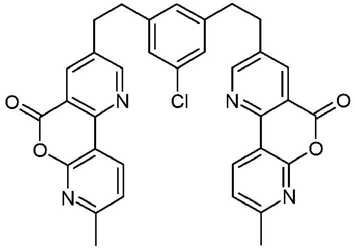 | 30% |
| S322 | 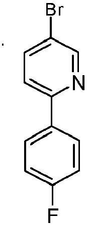 | 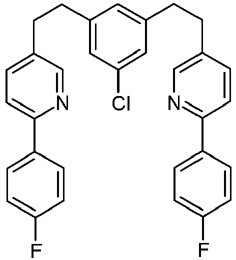 | 68% |
| | 463336-07-4 | | |
| S323 | 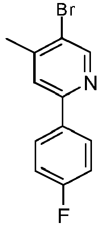 | 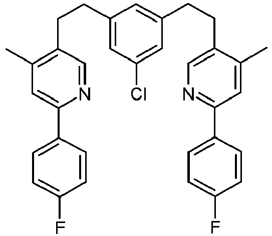 | 66% |
| | 2059970-61-3 | | |
| S324 | 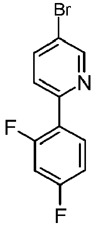 | 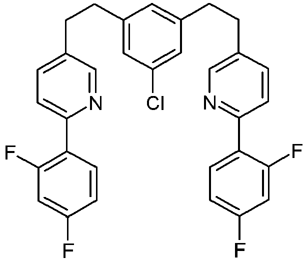 | 70% |
| | 453530-70-6 | | |
| S324 | 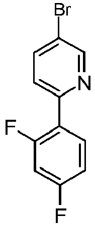 | 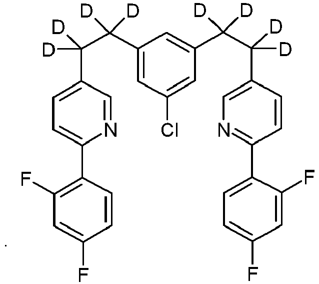 | 67% |
| | 453530-70-6 | | |
| S325 | 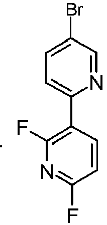 | 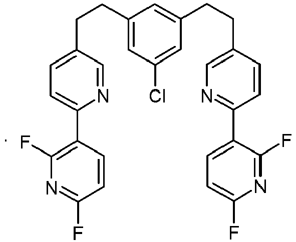 | 66% |
| | 2102327-97-7 | | |
| S326 | 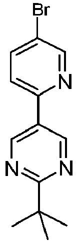 | 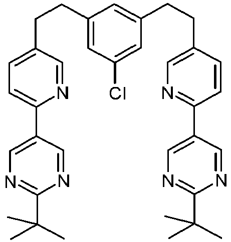 | 60% |
| | 1989596-22-6 | | |
| S327 | 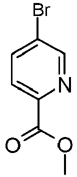 | 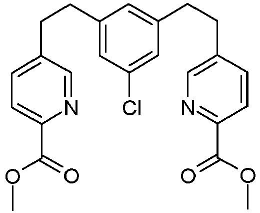 | 67% |
| | 29682-15-3 | | |

### Beispiel S350:

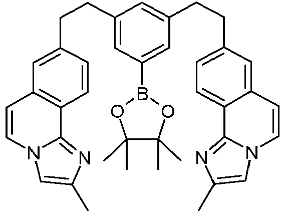

Darstellung analog zu Beispiel S50, Variante A. Einsatz von 52.9 g (100 mmol) S300. Ausbeute: 54.6 g (88 mmol) 88%; Reinheit: ca. 95 %ig n. ¹H-NMR.

Analog können folgende Verbindungen dargestellt werden:

| Bsp. | Edukt | Produkt | Ausbeute |
|---|---|---|---|
| S351 | S301 | 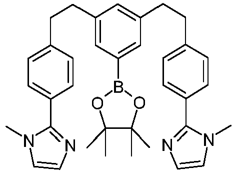 | 85% |
| S352 | S302 | 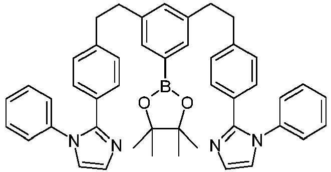 | 88% |
| S353 | S303 | 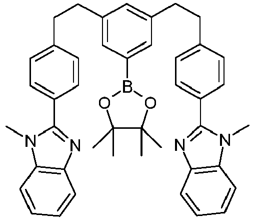 | 84% |
| S354 | S304 | 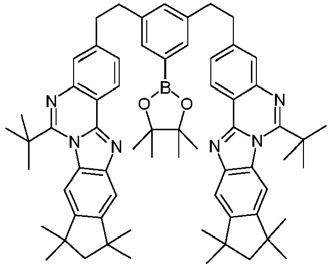 | 76% |
| S355 | S305 | 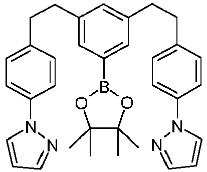 | 89% |
| S356 | S306 | 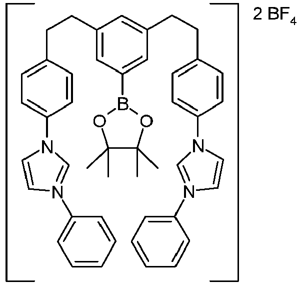 | 65% |
| S357 | S307 | 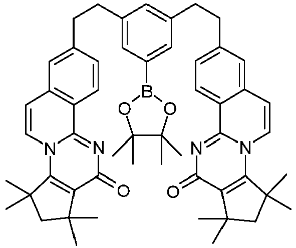 | 79% |
| S358 | S308 | 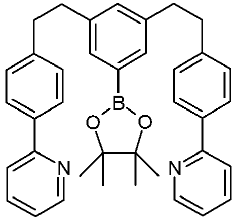 | 87% |
| S359 | S309 | 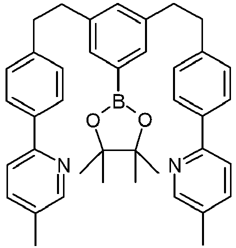 | 88% |
| S360 | S310 | 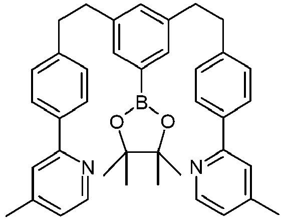 | 85% |
| S361 | S311 | 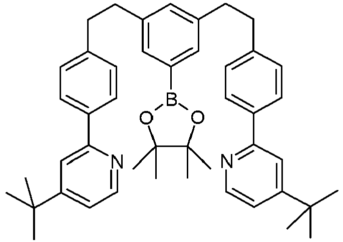 | 90% |
| S362 | S312 | 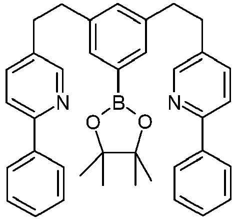 | 86% |
| S362-D8 | S312 | 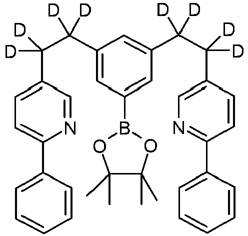 | 84% |
| S363 | S313 | 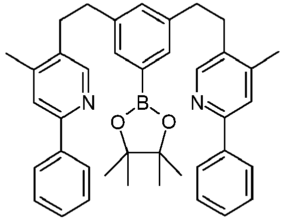 | 84% |
| S363-D8 | S313 | 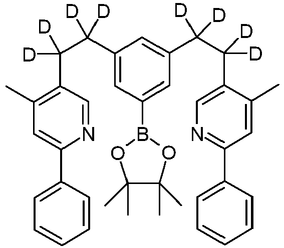 | 78% |
| S364 | S314 | 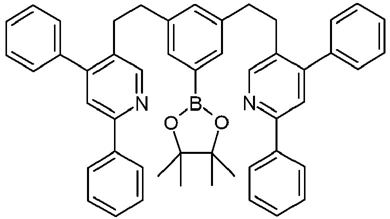 | 89% |
| S365 | S315 | 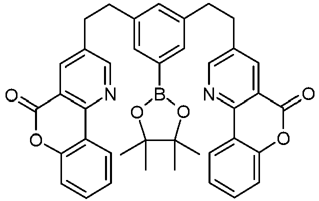 | 86% |
| S365-D8 | S315-D8 | 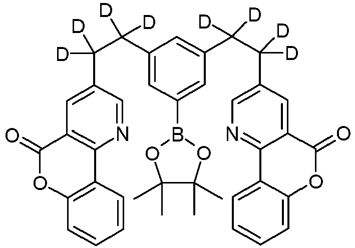 | 81% |
| S366 | S316 | 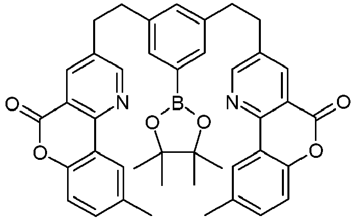 | 88% |
| S367 | S317 | 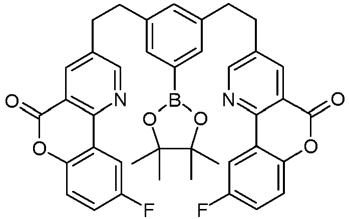 | 83% |
| S368 | S318 | 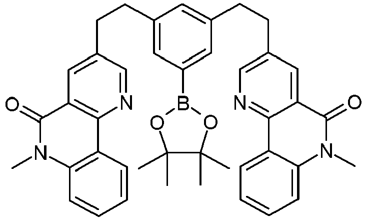 | 78% |
| S369 | S319 | 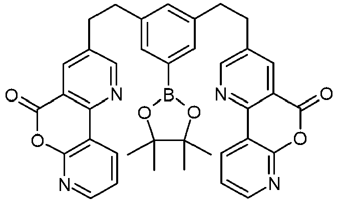 | 75% |
| S369-D8 | S319-D8 | 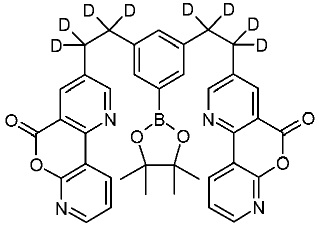 | 78% |
| S370 | S320 | 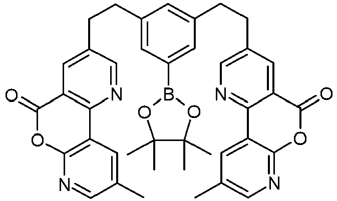 | 71% |
| S371 | S321 | 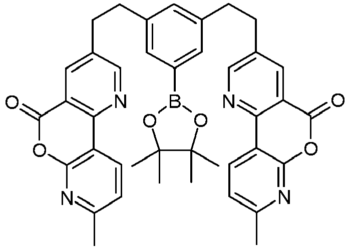 | 71% |
| S372 | S322 | 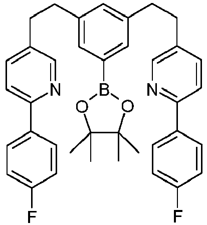 | 75% |
| S373 | S323 | 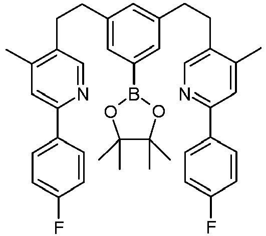 | 77% |
| S374 | S324 | 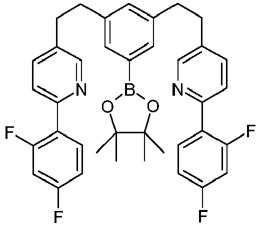 | 73% |
| S374-D8 | S324-D8 | 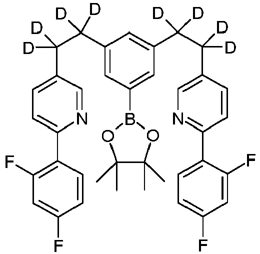 | 77% |
| S375 | S325 | 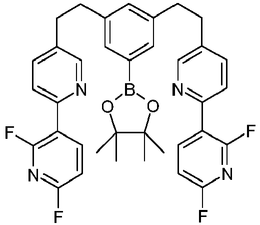 | 68% |
| S376 | S326 | 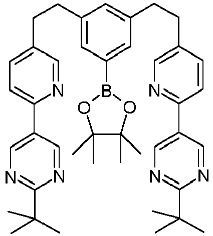 | 67% |
| S377 | S650 | 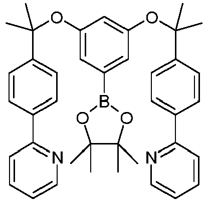 | 55% |
| S378 | S651 | 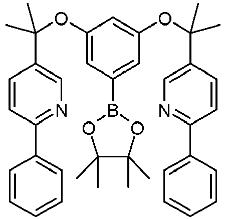 | 57% |
| S379 | S652 | 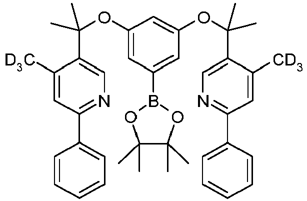 | 61% |
| S379 | S653 | 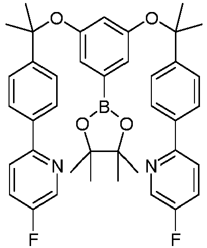 | 66% |
| S380 | S327 | 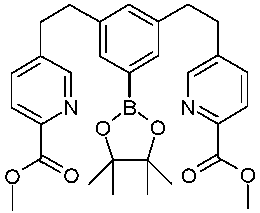 | 68% |

### Beispiel S400:

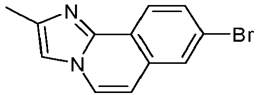

Ein Gemisch aus 30.8 g (100 mmol) 2-Methyl-8-(4,4,5,5-tetramethyl-1 ,3,2-dioxaborolan-2-yl)-imidazo[2,1-a]isochinolin [1989597-11-6], 67.0 g (300 mmol) Kupfer(II)bromid [7789-45-9], 1000 ml Methanol und 1000 ml Wasser wird im Rührautoklaven 10 h bei 80 °C gerührt. Anschließend engt man im Vakuum auf ca. 1000 ml ein, gibt 500 ml konzentrierte wässrige Ammoniaklösung zu und extrahiert dann dreimal mit 500 ml Dichlormethan. Man wäscht die organische Phase einmal mit 300 ml 10 %iger Ammoniaklösung und einmal mit 300 ml gesättigter Kochsalzlösung und entfernt dann das Lösungsmittel im Vakuum. Der Rückstand wird an einem Säulenautomaten (CombiFlash Torrent der Fa. A. Semrau) flash-chromatographiert. Ausbeute: 16.5 g (63 mmol), 63 %; Reinheit: > 98 %ig nach ¹H-NMR.

Analog können folgende Verbindungen dargestellt werden:

| | | | |
|---|---|---|---|
| S401 | 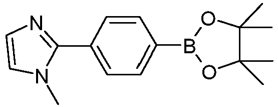 | 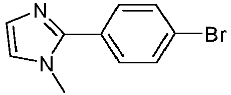 | 56% |
| | 1394374-23-2 | | |
| S402 | 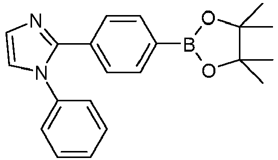 | 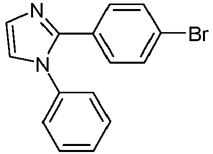 | 62% |
| | 1621467-82-0 | | |
| S403 | 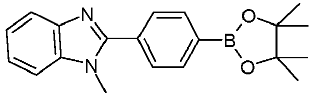 | 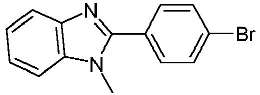 | 66% |
| | 1466412-09-8 | | |
| S404 | 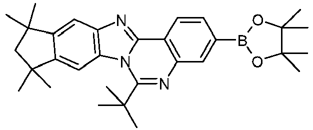 | 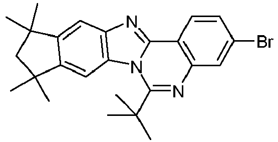 | 60% |
| | 1989597-13-8 | | |
| S405 | 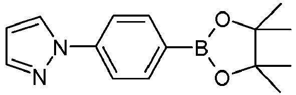 | 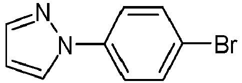 | 49% |
| | 1312478-63-9 | | |
| S406 | S66 | 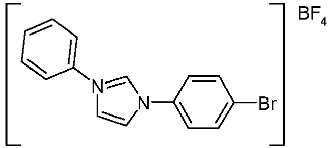 | 31% |
| | | Umkristallisation des Rohprodukts aus Acetonitril / MeOH | |
| S407 | 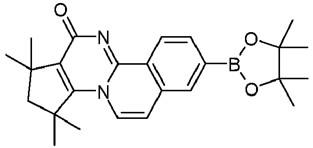 | 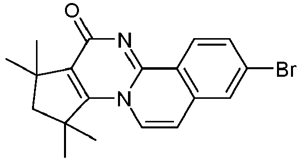 | 57% |
| | 1989597-91-2 | | |
| S408 | S550 | 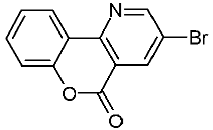 | 53% |
| S409 | S551 | 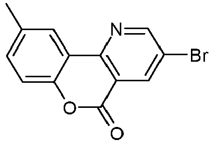 | 50% |
| S410 | S552 | 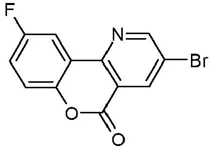 | 56% |
| S411 | S553 | 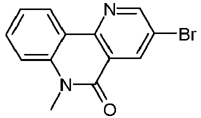 | 48% |

### Beispiel S450:

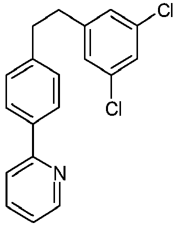

Ein gut gerührtes Gemisch aus 23.4 g (100 mmol) 2-(4-Bromphenyl)-pyridin, 17.1 g (100 mmol) 1,3-Dichlor-5-ethinyl-benzol [99254-90-7], 28 ml (200 mmol) Triethylamin, 1.9 g (10 mmol) Kupfer(I)iodid, 449 mg (2 mmol) Tetrakis-triphenylphosphino-palladium(0) und 500 ml DMF wird 8 h bei 70 °C gerührt. Man saugt noch warm vom gebildeten Triethylammoniumhydrobromid ab und wäscht dieses einmal mit 50 ml DMF. Das Filtrat wird zur Trockene eingeengt, der Rückstand wird in 1000 ml Ethylacetat aufgenommen, die organische Phase wird dreimal mit 200 ml 20 Gew.-%iger Ammoniaklösung, dreimal mit je 200 ml Wasser und einmal mit 200 ml gesättigter Kochsalzlösung gewaschen und über Magnesiumsulfat getrocknet. Man filtriert über ein mit Ethylacetat vorgeschlämmtes Celite-Bett ab und entfernt das Lösungsmittel im Vakuum. Der so erhaltene Feststoff wird einmal mit 100 ml Methanol ausgerührt und dann im Vakuum getrocknet. Der Feststoff wird in einem Gemisch aus 300 ml THF und 300 ml MeOH unter Zugabe von 1.5 g Palladium (5%) auf Kohle und 16.1 g (300 mmol) NH₄Cl bei 40 °C unter 3 bar Wasserstoff-Atmosphäre bis zur beendeten Wasserstoffaufnahme (ca. 12 h) hydriert. Man filtriert vom Katalysator über ein mit THF vorgeschlämmtes Celite-Bett ab, entfernt das Lösungsmittel im Vakuum und flash-chromatographiert an einem Säulenautomaten (CombiFlashTorrent der Fa. A Semrau). Ausbeute: 23.0 g (70 mmol), 70%; Reinheit: ca. 97 %ig n. ¹H-NMR.

Analog können folgende Verbindungen dargestellt werden:

| Bsp. | Edukt | Produkt | Ausbeut e |
|---|---|---|---|
| S45 1 | 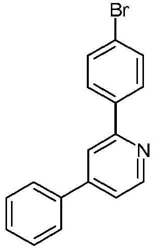 | 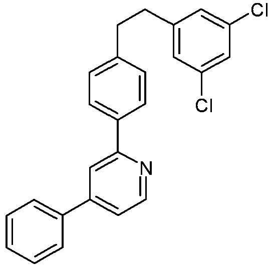 | 68% |
| | [504413-43-8] | | |
| S45 2 | 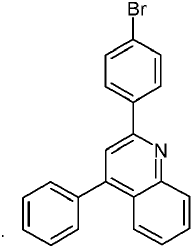 | 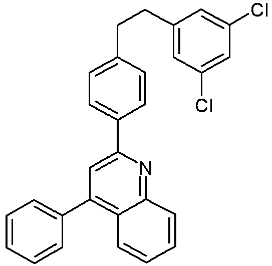 | 74% |
| | [73402-91-2] | | |
| S45 3 | 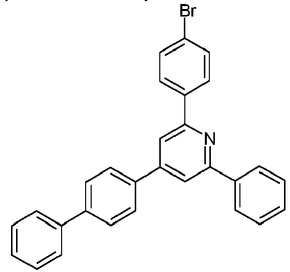 | 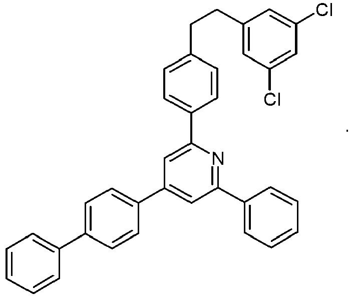 | 77% |
| | [1852499-57-0] | | |
| S45 4 | 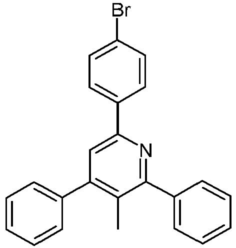 | 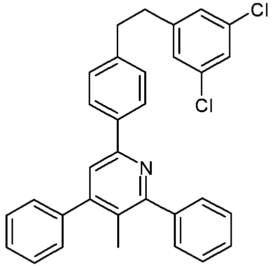 | 75% |
| | [89009-22-3] | | |
| S45 5 | 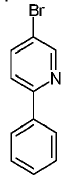 | 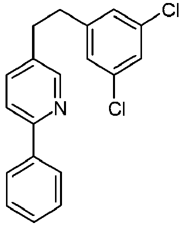 | 80% |
| | [27012-25-5] | | |
| S45 6 | 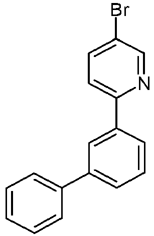 | 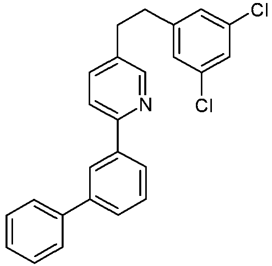 | 78% |
| | [875462-73-0] | | |
| S45 7 | 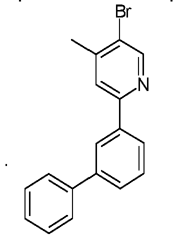 | 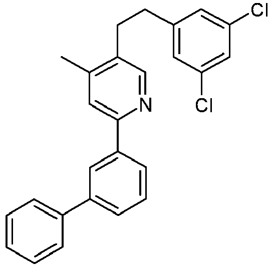 | 74% |
| | [1415352-89-8] | | |
| S45 8 | 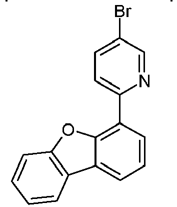 | 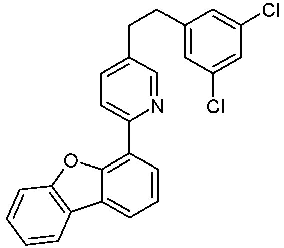 | 75% |
| | [1989596-02-2] | | |
| S45 9 | 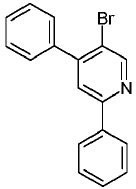 | 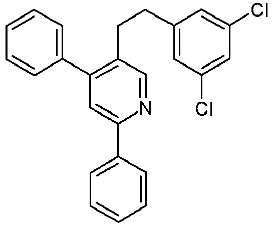 | 63% |
| | [1989596-06-6] | | |
| S46 0 | S10 | 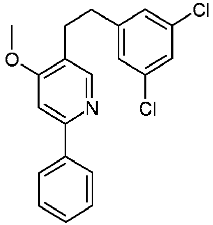 | 64% |

### Beispiel S500:

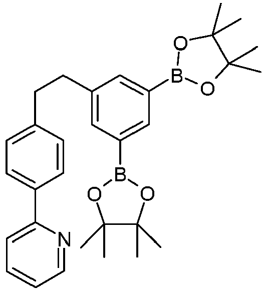

Darstellung analog zu Beispiel S50, Variante A. Einsatz von 16.4 g (50 mmol) S450. Ausbeute: 20.5 g (40 mmol) 80%; Reinheit: ca. 95 %ig n. ¹H-NMR.

Analog können folgende Verbindungen dargestellt werden:

| Bsp. | Edukt | Produkt | Ausbeute |
|---|---|---|---|
| S501 | S451 | 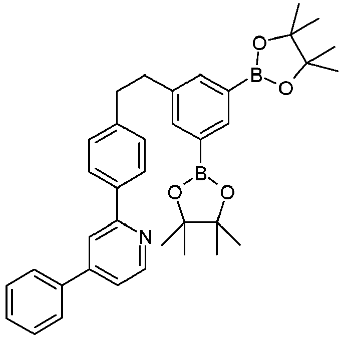 | 78% |
| S502 | S452 | 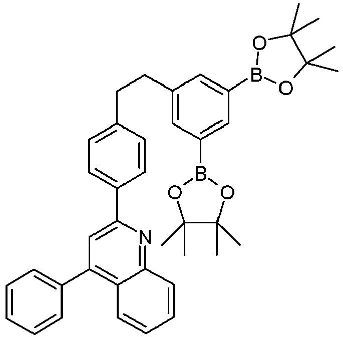 | 75% |
| S503 | S453 | 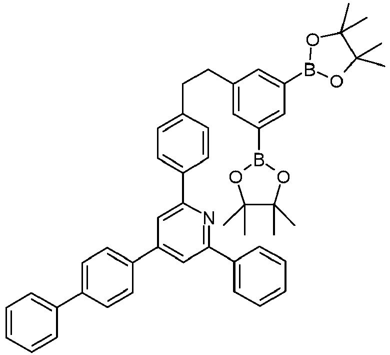 | 76% |
| S504 | S454 | 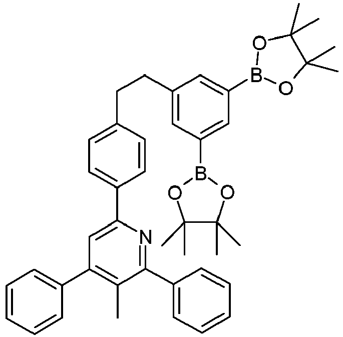 | 70% |
| S505 | S455 | 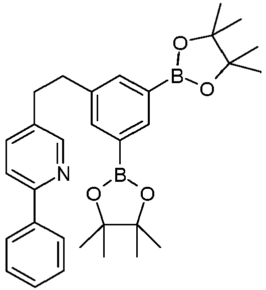 | 80% |
| S506 | S456 | 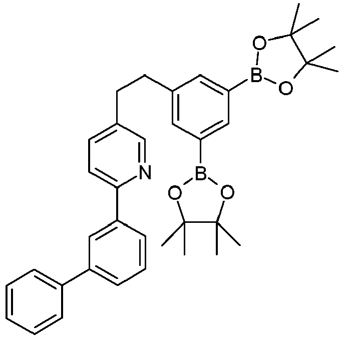 | 81% |
| S507 | S457 | 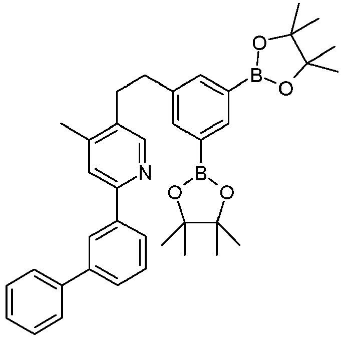 | 79% |
| S508 | S458 | 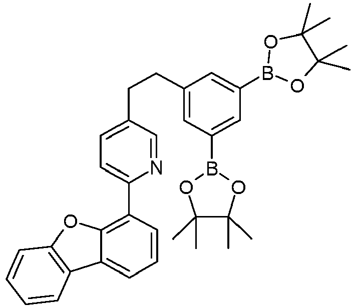 | 77% |
| S509 | S459 | 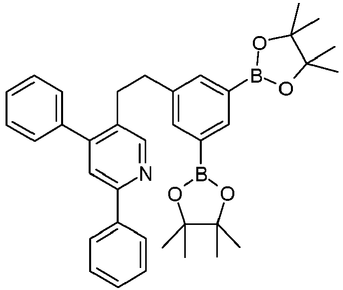 | 74% |
| S510 | S460 | 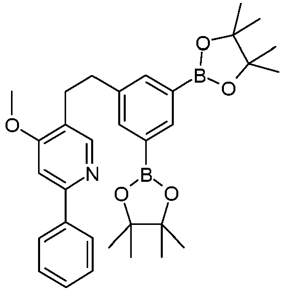 | 75% |

### Beispiel S550:

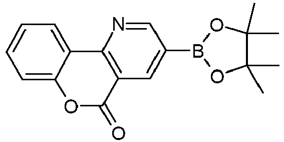

Ein Gemisch aus 19.7 g (100 mmol) 5H-[1]Benzopyrano[4,3-b]pyridine-5-one [85175-31-1], 26.7 g (105 mmol) Bis-(pinacolato)diboran [73183-34-3], 552 mg (2 mmol) 4,4'-Bis(1,1-dimethylethyl)-2,2'-bipyridin [72914-19-3] und 681 mg (1 mmol) (1,5-Cyclooctadien)(methoxy)iridium(I)dimer [12146-71-9] in 300 ml Methyl-tert-butylether wird 24 h bei Raumtemperatur gerührt. Man entfernt den Methyl-tert-butylether im Vakuum, nimmt den Rückstand in 150 ml warmem Methanol auf und rührt 2 h nach. Man saugt vom ausgefallenen Produkt ab, wäscht einmal mit 30 ml Methanol nach und kristallisiert dann aus Acetonitril unter Zugabe von etwas Ethylacetat um. Ausbeute: 24.3 g (75 mmol), 75 %; Reinheit: ca. 97 %ig n. ¹H-NMR.

Analog können folgende Verbindungen dargestellt werden.

| Bsp. | Edukt | Produkt | Ausbeute |
|---|---|---|---|
| S551 | 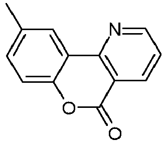 | 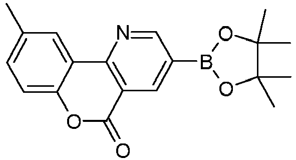 | 72% |
| | 1493784-12-5 | | |
| S552 | 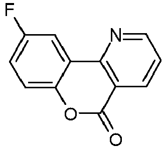 | 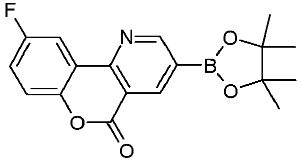 | 68% |
| | 1493784-11-4 | | |
| S553 | 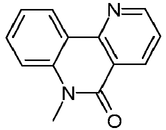 | 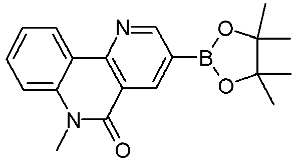 | 70% |
| | 327096-10-6 | | |
| S554 | 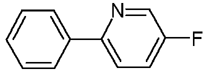 | 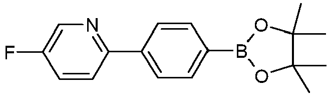 | 36% |
| | 512171-81-2 | | |
| | | Reinigung via Flash-Chromatographie | |

### Beispiel S570:

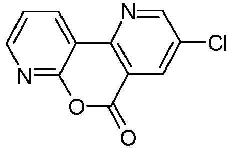

### A)

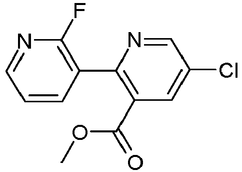

Durchführung analog zu S600 B), wobei 20.6 g (100 mmol) 2,5-Dichlorpyridin-3-carbonsäuremethylester [67754-03-4] und 15.5 g (110 mmol) (2-Fluorpyridin-3-yl)boronsäure [174669-73-9] eingesetzt wird. Ausbeute: 20.9 g (78 mmol), 78 %; Reinheit: ca. 95 %ig n. ¹H-NMR.

### B)

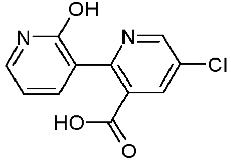

Ein Gemisch aus 26.7 g (100 mmol) A), 16.8 g (300 mmol) Kaliumhydroxid, 250 ml Ethanol und 75 ml Wasser wird 16 h bei 70 °C gerührt. Nach Erkalten säuert man durch Zugabe von 1 N Salzsäure auf pH ~ 5 an und rührt 1 h nach. Man saugt vom ausgefallenen Produkt ab, wäscht einmal mit 50 ml Wasser und einmal mit 50 ml Methanol nach und trocknet dann im Vakuum. Ausbeute: 23.8 g (95 mmol), 95 %; Reinheit: ca. 97 %ig n. ¹H-NMR.

### C) S570

Ein Gemisch aus 25.1 g (100 mmol) B) und 951 mg (5 mmol) p-Toluolsulfonsäure-Monohydrat in 500 ml Toluol wird 16 h am Wasserabscheider unter Rückfluss erhitzt. Nach Erkalten wird die Reaktionsmischung noch 1 h im Eis/Wasserbad nachgerührt, der Feststoff wird abgesaugt, mit 50 ml Toluol gewaschen und im Vakuum getrocknet. Der Feststoff wird dann mit 300 ml Wasser ausgerührt, abgesaugt und mit 100 ml Wasser gewaschen, um die p-Toluolsulfonsäure zu entfernen. Nach Absaugen und Trocknen im Vakuum erfolgt die finale Trocknung durch zweilmalige Azeotroptrockung mit Toluol. Ausbeute: 20.5 g (88 mmol), 88 %; Reinheit: ca. 97 %ig n. ¹H-NMR.

Analog können folgende Verbindungen dargestellt werden.

| Bsp. | Edukt | Produkt | Ausbeute |
|---|---|---|---|
| S571 | 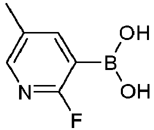 | 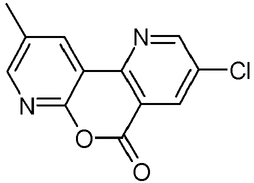 | 65% |
| | 1072952-45-4 | | |
| S572 | 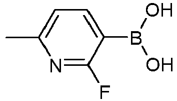 | 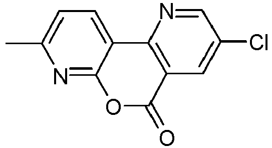 | 61% |
| | 906744-85-2 | | |

### Beispiel S600:

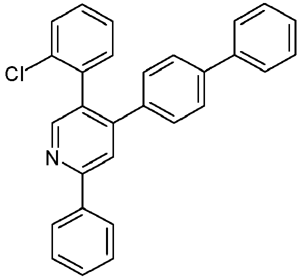

### A)

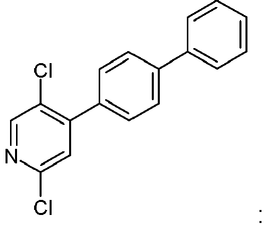

Ein Gemisch aus 27.4 g (100 mmol) 2,5-Dichlor-4-iodpyridin [796851-03-1], 19.8 g (100 mmol) 4-Biphenylboronsäure [5122-94-1], 41.4 g (300 mmol) Kaliumcarbonat, 702 mg (1 mmol) Bis(triphenylphosphino)-palladium(II)chlorid [13965-03-2], 300 ml Methanol und 300 ml Acetonitril wird 16 h unter Rückfluss erhitzt. Nach Erkalten rührt man die Reaktionsmischung in 3 L warmes Wasser ein, rührt 30 min. nach, saugt vom ausgefallenen Produkt ab, wäscht dieses dreimal mit je 50 ml Methanol, trocknet im Vakuum, nimmt in 500 ml DCM auf, filtriert über ein mit DCM vorgeschlämmtes Kieselgel-Bett und kristallisiert dann aus Acetonitril um. Ausbeute: 28.5 g (95 mmol), 95 %; Reinheit: ca. 97 %ig n. ¹H-NMR.

### B)

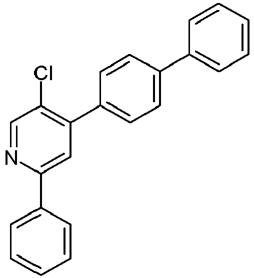

Variante 1:
Durchführung wie unter A) beschrieben, jedoch wird anstelle von 4-Biphenylboronsäure 12.2 g (100 mmol) Phenylboronsäure [98-80-6] verwendet. Ausbeute: 26.0 g (76 mmol), 76 %; Reinheit: ca. 97 %ig n. ¹H-NMR.

Variante 2:
Alternativ kann die Suzuki-Kupplung auch im zweiphasigen System Toluol/Dioxan/Wasser (2:1:2 vv) unter Verwendung von 3 Äquivalenten Tri-kalium-phosphat und 1 mol% Bis(triphenylphosphino)-palladium(II)-chlorid erfolgen.

### C) S600

Ein Gemisch aus 34.2 g (100 mmol) S600 Stufe B), 17.2 g (110 mmol) 2-Chlorphenylboronsäure [3900-89-8], 63.7 g (300 mmol) Trikaliumphosphat, 1.64 g (4 mmol) Sphos, 449 mg (2 mmol) Palladium(II)acetat, 600 ml THF und 200 ml Wasser wird 24 h unter Rückfluss erhitzt. Nach Erkalten trennt man die wässrige Phase ab, engt die organische Phase zur Trockene ein, nimmt den glasartigen Rücjstand in 200 ml Ethylacetat / DCM (4:1 vv) auf, filtriert über ein mit Ethylacetat / DCM (4:1 vv) vorgeschlämmtes Kieselgel-Bett (ca. 500 g Kieselgel) und schneidet die Kernfraktion heraus. Man engt die Kenfraktion auf ca. 100 ml ein, saugt vom auskristallisierten Produkt ab, wäscht zweimal mit je 50 ml Methanol nach und trocknet im Vakuum. Die weitere Reinigung erfolgt durch fraktionierte Kugelrohrdestillation im Vakuum (~ 10⁻³ - 10⁻⁴ mbar), wobei im Vorlauf noch etwas S600 Stufe B) abgetrennt wird und höhere Oligomere zurückbleiben. Ausbeute: 29.7 g (71 mmol), 71 %; Reinheit: ca. 95 %ig n. ¹H-NMR.

Analog können durch Einsatz der entsprechenden Boronsäuren /-ester in A), B) bzw. C) folgende Verbindungen dargestellt werden.

| Bsp. | Edukt Varanite 1 | Produkt | Ausbeute* |
|---|---|---|---|
| S601 | 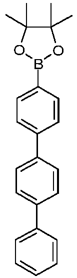 | 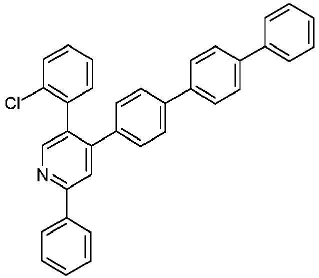 | 53% |
| | 1080632-76-3 | | |
| S602 | 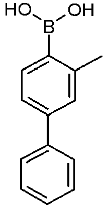 | 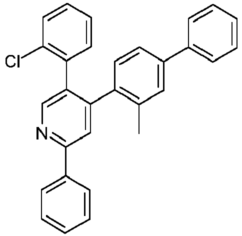 | 48% |
| | 1383628-42-9 | | |
| S603 | 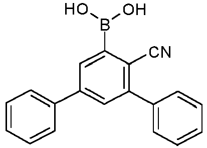 | 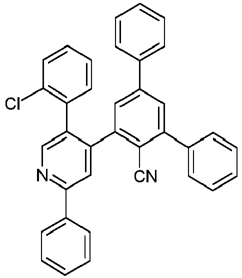 | 46% |
| | 2173324-06-4 | | |
| S604 | 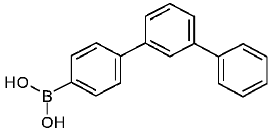 | 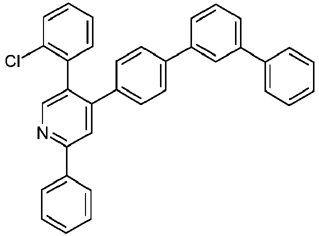 | 49% |
| | 1191061-81-0 | | |
| S605 | Variante 1 | 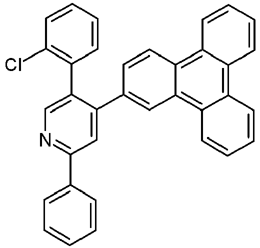 | 30% |
| | Variante 2 | | 58% |
| | 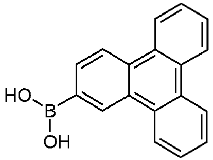 | | |
| | 654664-63-8 | | |
| S606 | 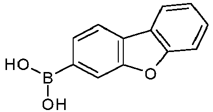 | 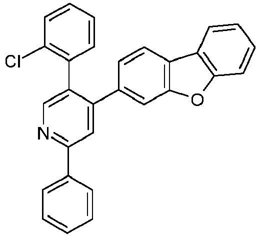 | 47% |
| | 395087-89-5 | | |
| S607 | 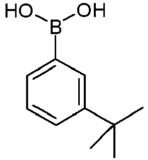 | 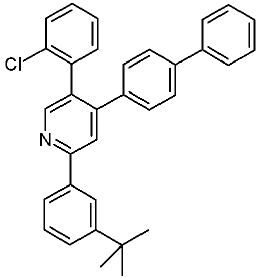 | 48% |
| S607 | 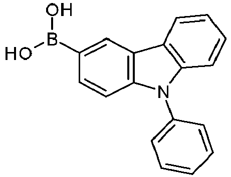 | 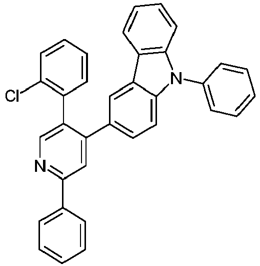 | 55% |
| | 854952-58-2 | | |
| S608 | Variante 1 | 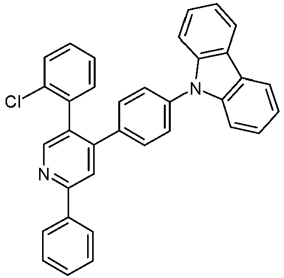 | 39% |
| | Variante 2 | | 60% |
| | 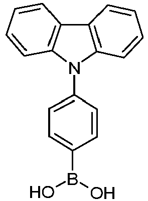 | | |
| | 419536-33-7 | | |
| S609 | 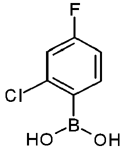 | 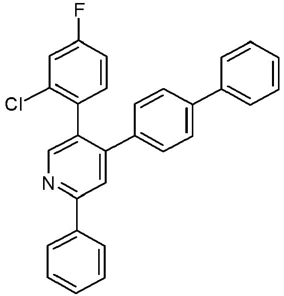 | 53% |

| | | | |
|---|---|---|---|
| * über drei Stufen | | | |

### Beispiel 650:

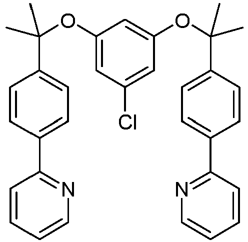

Durchführung analog T. K. Salvador et al., J. Am. Chem. Soc., 138, 1658, 2016. Ein Gemisch aus 60.2 g (300 mmol) 2-[4-(1-Methylethyl)phenyl]-pyridin [1314959-26-6], 22.9 g (100 mmol) 5-Chlor-1 ,3-benzoldiacetat [2096371-94-5], 36.6 g (250 mmol) tert-Butylperoxid [110-05-4], 5.2 g (10 mmol) [(MeO)₂NN]Cu(η²-Toluol) [2052927-86-1] und 50 ml t-Butanol wird in einem Autoklaven unter Rühren 30 h auf 90 °C erhitzt. Nach Erkalten entfernt man alle flüchtigen Bestandteile im Vakuum, nimmt den Rückstand in 50 ml DCM auf, filtriert über ein Alox-Bett (Alox, basisch Aktivitätsstufe 1 Fa. Woelm) ab und chromatographiert das so erhaltene Rohprodukt mit Ethylacetat:n-Heptan (1:1) an Kieselgel. Ausbeute: 24.1 g (45 mmol), 45 %; Reinheit: ca. 95 %ig n. ¹H-NMR.

Analog können folgende Verbindungen dargestellt werden.

| Bsp. | Edukte | Produkt | Ausbeute |
|---|---|---|---|
| S651 | 2096371-94-5 | 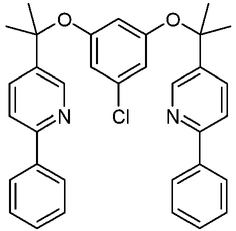 | 38% |
| | 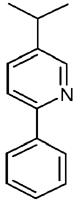 | | |
| | 85391-13-5 | | |
| S652 | 2096371-94-5 | 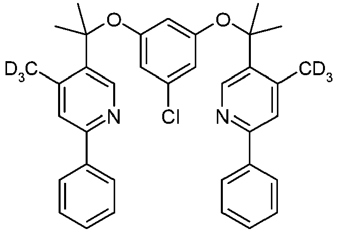 | 27% |
| | 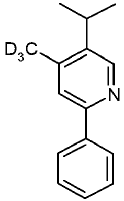 | | |
| | 1689568-10-2 | | |
| S653 | 2096371-94-5 | 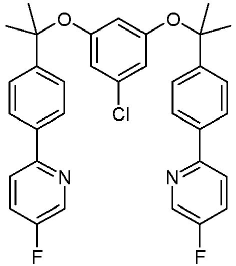 | 24% |
| | 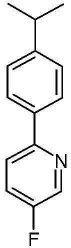 | | |
| | S17 | | |

### B: Synthese der Liganden L:

### Beispiel L1:

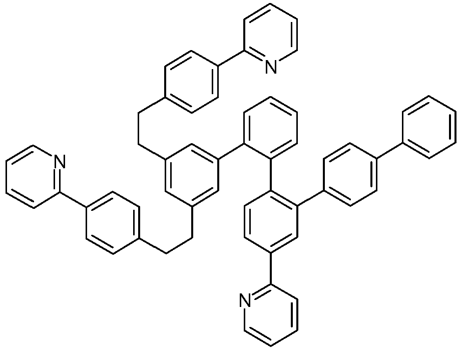

Ein Gemisch aus 81.8 g (100 mmol) S250, 30.6 g (110 mmol) 2-[1,1'-Biphenyl]-4-yl-4,4,5,5-tetramethyl-1,3,2-dioxaborolan [144432-80-4], 53.1 g (250 mmol) Trikaliumphosphat, 800 ml THF und 200 ml Wasser wird unter kräftigem Rühren mit 1.64 g (4 mmol) Sphos und dann mit 449 mg (2 mmol) Palladium(II)acetat versetzt und 16 h unter Rückfluss erhitzt. Nach Erkalten trennt man die wässrige Phase ab, engt die organische Phase weitgehend ein, nimmt den Rückstand in 500 ml Ethylacetat auf, wäscht die organische Phase zweimal mit je 300 ml Wasser, einmal mit 2%iger wässriger N-Acetylcystein-Lösung und einmal mit 300 ml gesättigter Kochsalzlösung und trocknet über Magnesiumsulfat. Man filtriert vom Trockenmittel über ein mit Ethylacetat vorgeschlämmtes Kieselgel-Bett ab, wäscht mit Ethylacetat nach, engt das Filtrat zur Trockene ein und kristallisiert den Rückstand aus ca. 200 ml Acetonitril in der Siedehitze um. Ausbeute: 60.0 g (73 mmol), 73 %; Reinheit: ca. 97 %ig n. ¹H-NMR.

Analog können folgende Verbindungen dargestellt werden.

| Bsp . | Edukt | Produkt | Ausbeute |
|---|---|---|---|
| L2 | S250 | 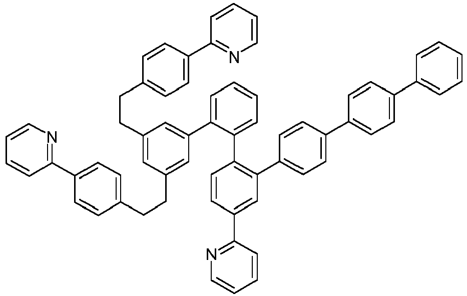 | 78% |
| | 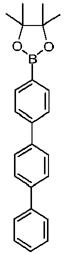 | | |
| | 1080632-76-3 | | |
| L3 | S250 | 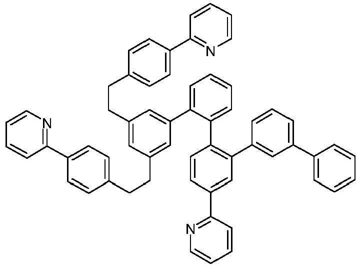 | 78% |
| | 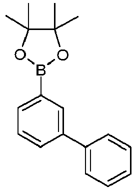 | | |
| | 912844-88-3 | | |
| L4 | S250 | 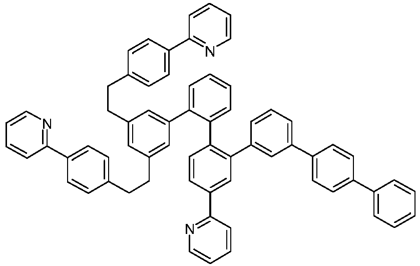 | 74% |
| | 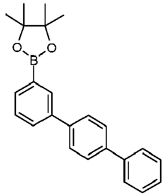 | | |
| | 1401577-23-8 | | |
| L5 | S250 | 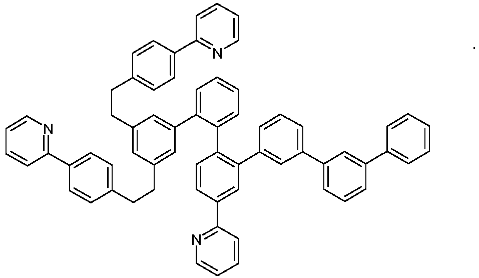 | 73% |
| | 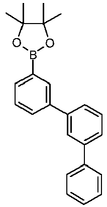 | | |
| | 1115023-84-1 | | |
| L6 | S250 | 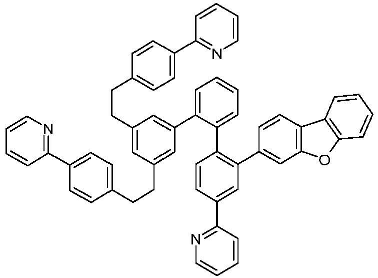 | 77% |
| | 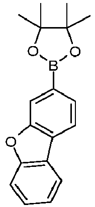 | | |
| | 1056113-50-8 | | |
| L7 | S250 | 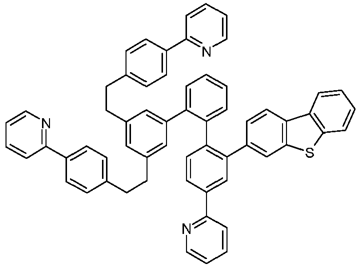 | 75% |
| | 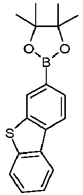 | | |
| | 1362691-15-3 | | |
| L8 | S251 | 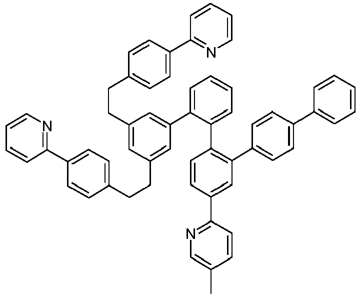 | 81% |
| | 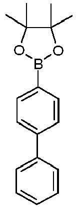 | | |
| | 144432-80-4 | | |
| L9 | S252 | 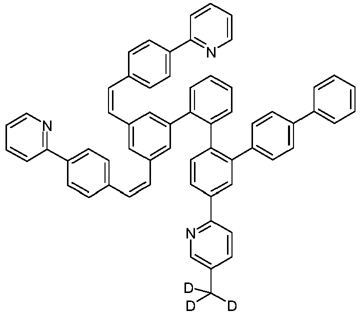 | 77% |
| | 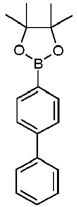 | | |
| | 144432-80-4 | | |
| L10 | S253 | 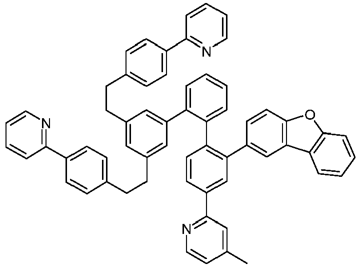 | 79% |
| | 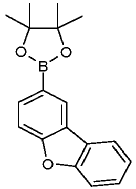 | | |
| | 197770-80-1 | | |
| L11 | S254 | 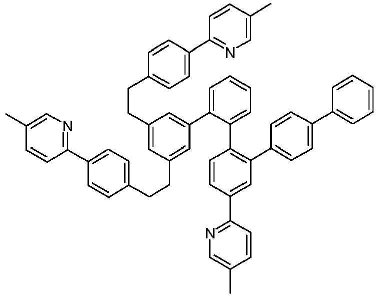 | 74% |
| | 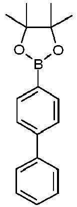 | | |
| | 144432-80-4 | | |
| L12 | S255 | 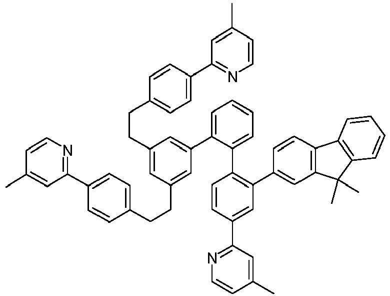 | 82% |
| | 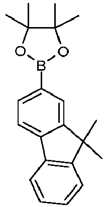 | | |
| | 569343-09-5 | | |
| L13 | S256 | 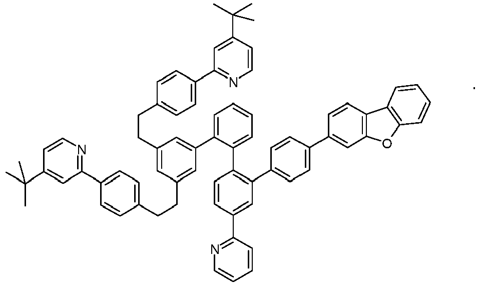 | 78% |
| | 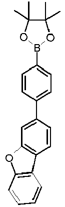 | | |
| | 2007912-69-6 | | |
| L14 | S257 | 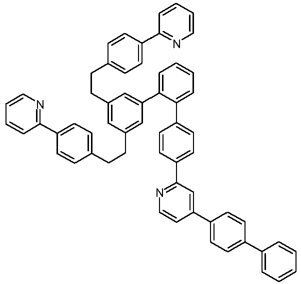 | 79% |
| | 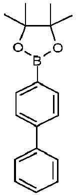 | | |
| | 144432-80-4 | | |
| L15 | S257 | 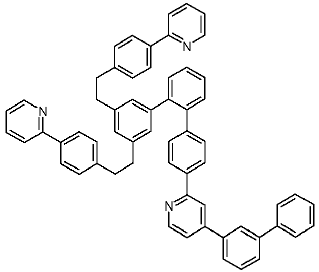 | 76% |
| | 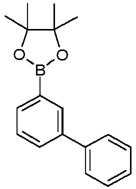 | | |
| | 912844-88-3 | | |
| L16 | S257 | 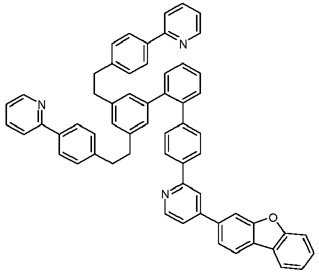 | 80% |
| | 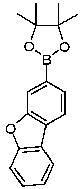 | | |
| | 1056113-50-8 | | |
| L17 | S258 | 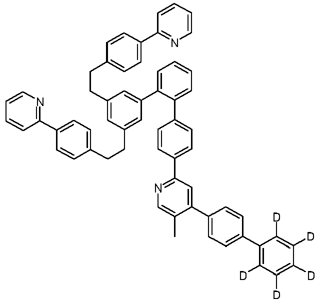 | 73% |
| | 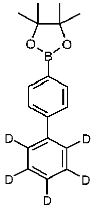 | | |
| | 1197180-12-3 | | |
| L18 | S259 | 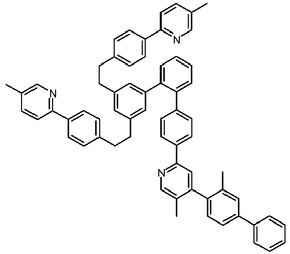 | 74% |
| | 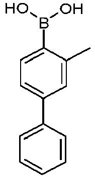 | | |
| | 1383628-42-9 | | |
| L19 | S260 | 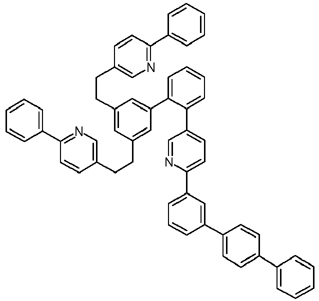 | 78% |
| | 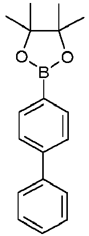 | | |
| | 144432-80-4 | | |
| L20 | S261 | 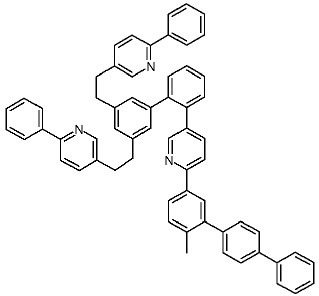 | 80% |
| | 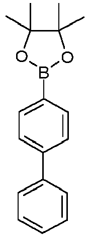 | | |
| | 144432-80-4 | | |
| L21 | S261 | 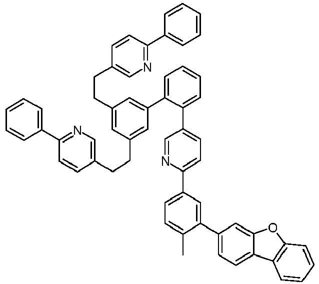 | 73% |
| | 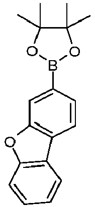 | | |
| | 1056113-50-8 | | |
| L22 | S262 | 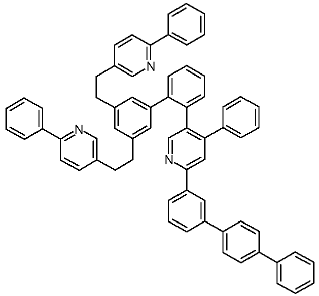 | 70% |
| | 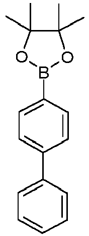 | | |
| | 144432-80-4 | | |
| L23 | S263 | 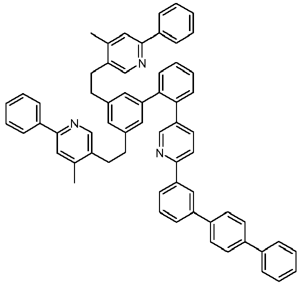 | 76% |
| | 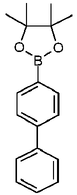 | | |
| | 144432-80-4 | | |
| L24 | S264 | 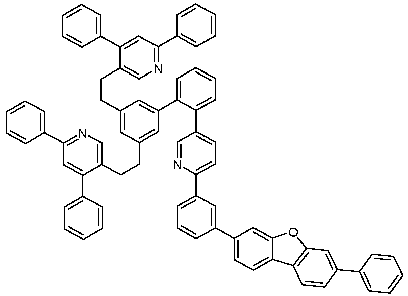 | 72% |
| | 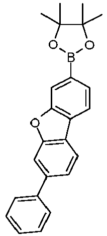 | | |
| | 1959608-16-2 | | |
| L25 | S265 | 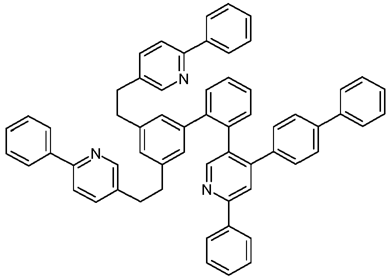 | 80% |
| | 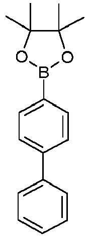 | | |
| | 144432-80-4 | | |
| L26 | S265 | 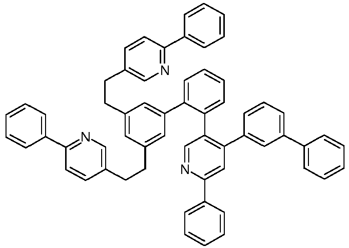 | 74% |
| | 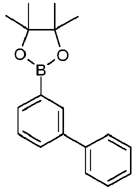 | | |
| | 912844-88-3 | | |
| L27 | S266 | 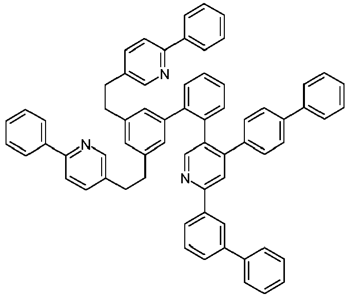 | 78% |
| | 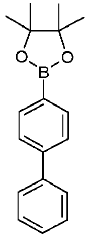 | | |
| | 144432-80-4 | | |
| L28 | S267 | 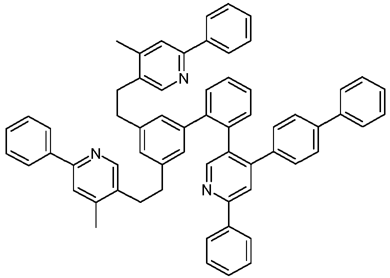 | 74% |
| | 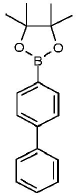 | | |
| | 144432-80-4 | | |
| L29 | S267 | 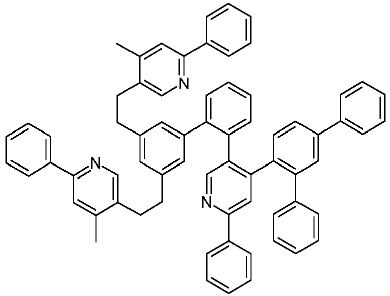 | 76% |
| | 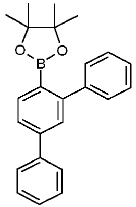 | | |
| | 583823-92-1 | | |
| L30 | S268 | 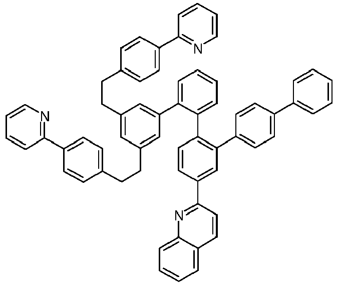 | 72% |
| | 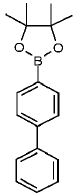 | | |
| | 144432-80-4 | | |
| L31 | S269 | 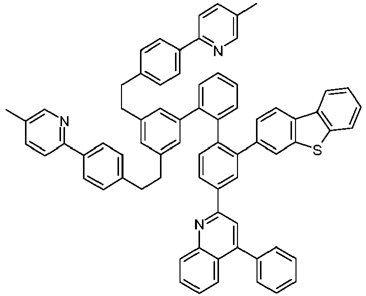 | 74% |
| | 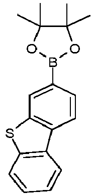 | | |
| | 1362691-15-3 | | |
| L32 | S270 | 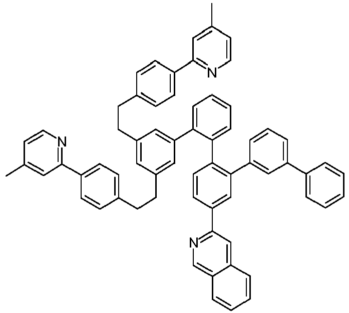 | 78% |
| | 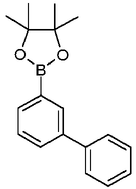 | | |
| | 912844-88-3 | | |
| L33 | S271 | 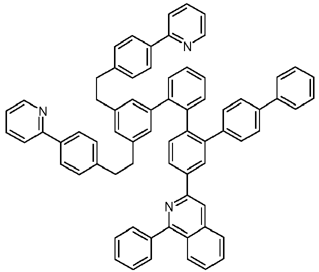 | 75% |
| | 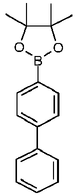 | | |
| | 144432-80-4 | | |
| L34 | S272 | 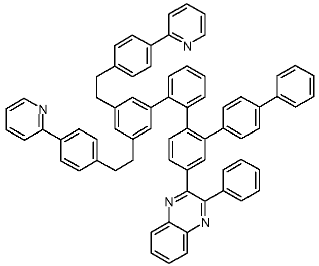 | 80% |
| | 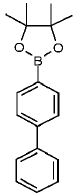 | | |
| | 144432-80-4 | | |
| L35 | S273 | 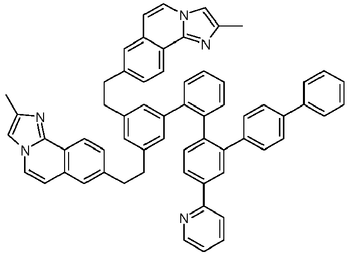 | 76% |
| | 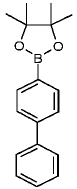 | | |
| | 144432-80-4 | | |
| L36 | S274 | 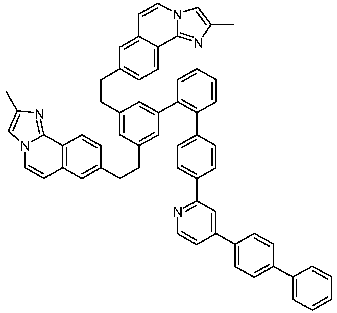 | 79% |
| | 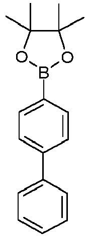 | | |
| | 144432-80-4 | | |
| L37 | S275 | 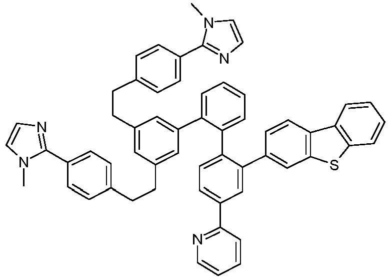 | 80% |
| | 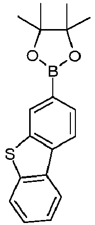 | | |
| | 1362691-15-3 | | |
| L38 | S276 | 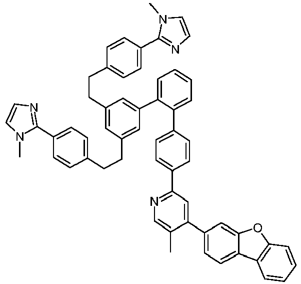 | 73% |
| | 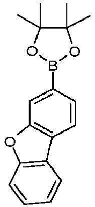 | | |
| | 1056113-50-8 | | |
| L39 | S277 | 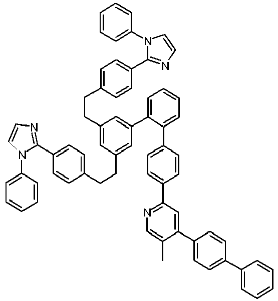 | 79% |
| | 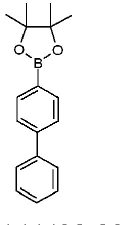 | | |
| | 144432-80-4 | | |
| L40 | S278 | 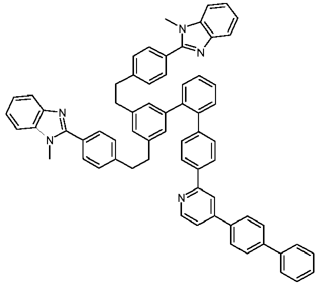 | 71% |
| | 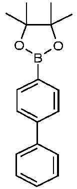 | | |
| | 144432-80-4 | | |
| L41 | S279 | 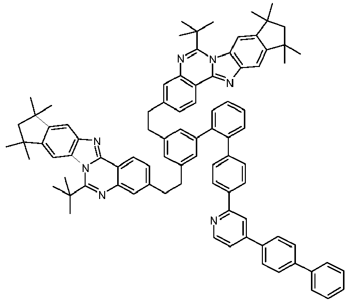 | 75% |
| | 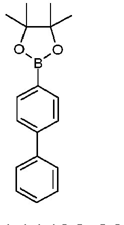 | | |
| | 144432-80-4 | | |
| L42 | S280 | 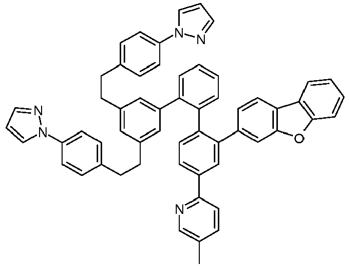 | 77% |
| | 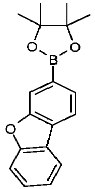 | | |
| | 1056113-50-8 | | |
| L43 | S281 | 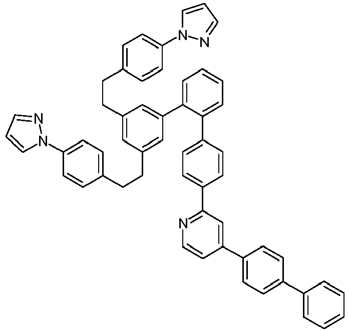 | 79% |
| | 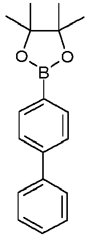 | | |
| | 144432-80-4 | | |
| L44 | S282 | 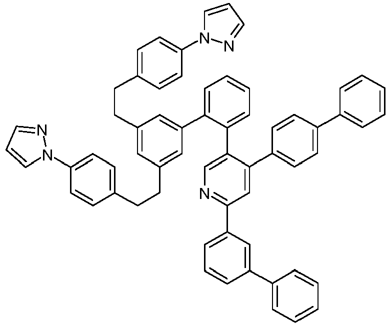 | 80% |
| | 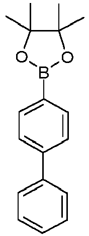 | | |
| | 144432-80-4 | | |
| L45 | S283 | 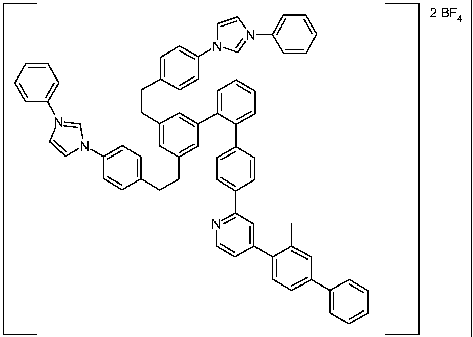 | 55% |
| | 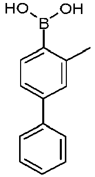 | | |
| | 1383628-42-9 | | |
| L46 | S284 | 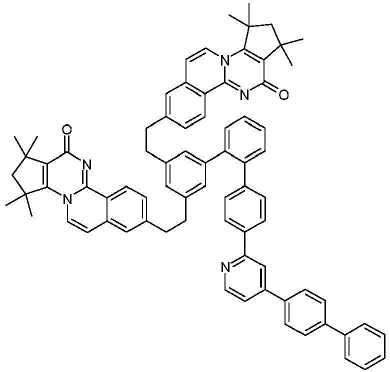 | 77% |
| | 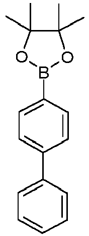 | | |
| | 144432-80-4 | | |
| L47 | S285 | 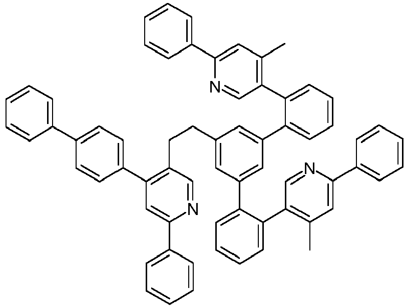 | 78% |
| | 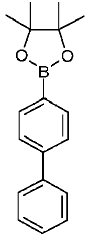 | | |
| | 144432-80-4 | | |

### Beispiel L100:

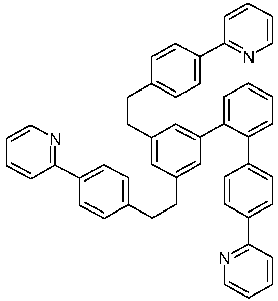

Darstellung analog zu Beispiel S150, wobei anstelle von S100 31.0 g (100 mmol) 2-(2'-Brom[1,1'-biphenyl]-4-yl)pyridin [1374202-35-3] eingesetzt werden. Ausbeute: 51.6 g (77 mmol), 77 %; Reinheit: ca. 95 %ig n. ¹H-NMR.

Analog können folgende Verbindungen dargestellt werden.

| Bsp. | Edukte | Produkt | Ausbeute |
|---|---|---|---|
| L101 | S358 | 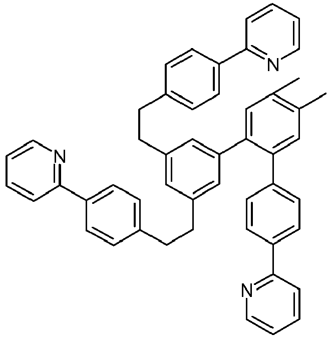 | 75% |
| | 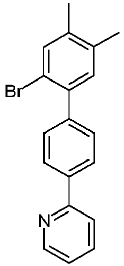 | | |
| | [1989597-43-4] | | |
| L102 | S359 | 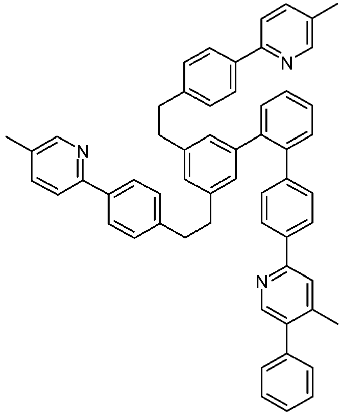 | 70% |
| | 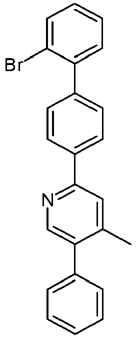 | | |
| | [1989597-34-3] | | |
| L103 | S360 | 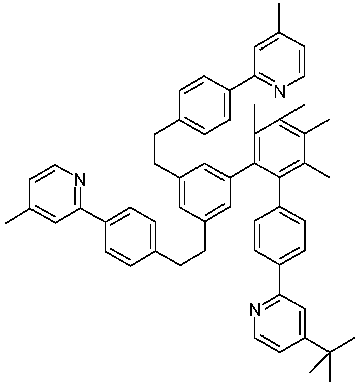 | 72% |
| | 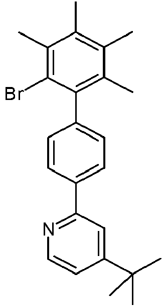 | | |
| | [1989597-44-5] | | |
| L104 | S361 | 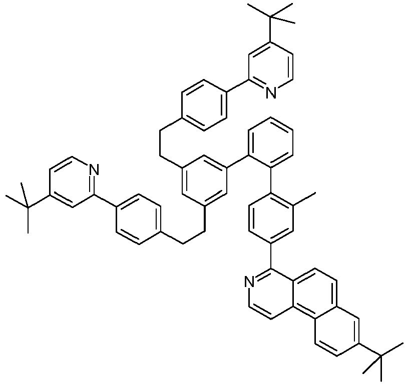 | 75% |
| | 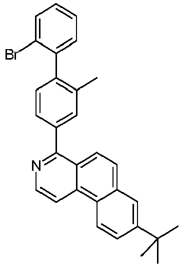 | | |
| | [1989597-56-9] | | |
| L105 | S359 | 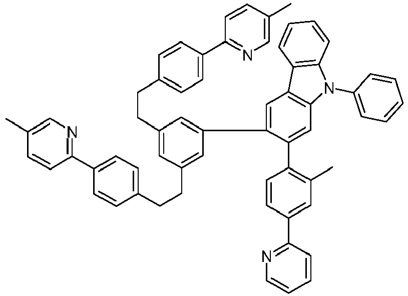 | 68% |
| | 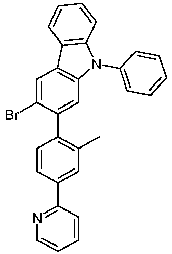 | | |
| | [1989597-54-7] | | |
| L106 | S362 | 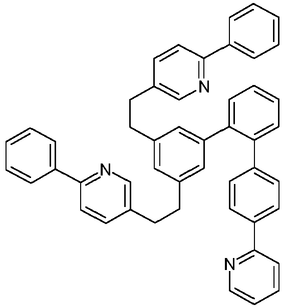 | 74% |
| | 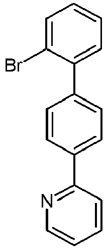 | | |
| | [1374202-35-3] | | |
| L107 | S362 | 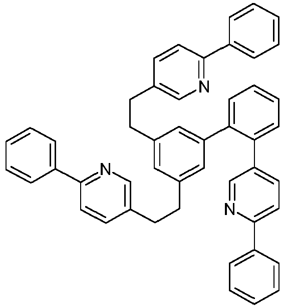 | 80% |
| | 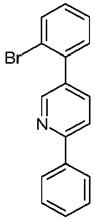 | | |
| | [1989597-29-6] | | |
| L108 | S362 | 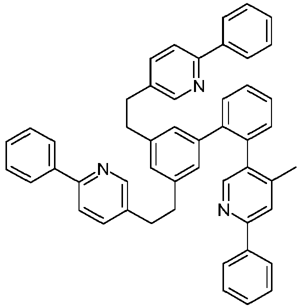 | 78% |
| | 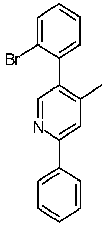 | | |
| | [1989597-30-9] | | |
| L109 | S362 | 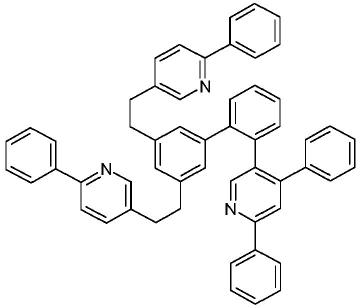 | 81% |
| | 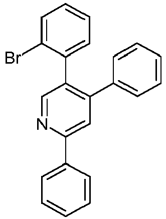 | | |
| | [1989597-32-1] | | |
| L109-D8 | S362-D8 | 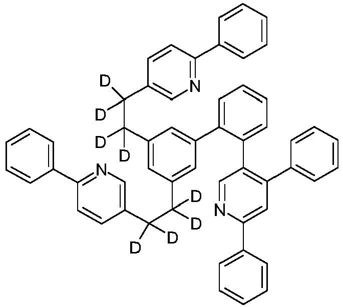 | 79% |
| | 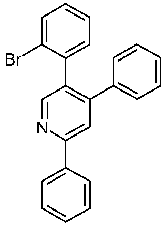 | | |
| | [1989597-32-1] | | |
| L110 | S363 | 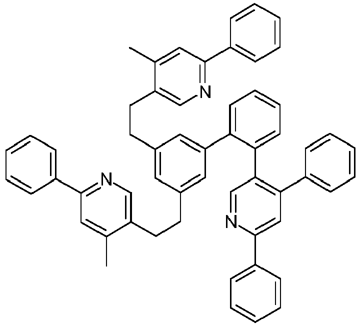 | 79% |
| | 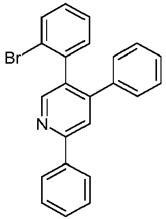 | | |
| | [1989597-32-1] | | |
| L111 | S363 | 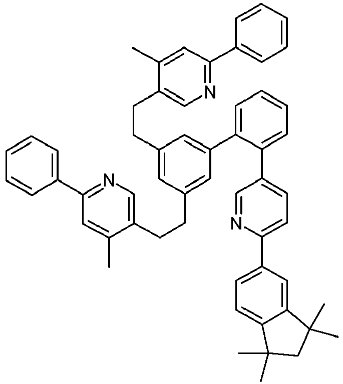 | 72% |
| | 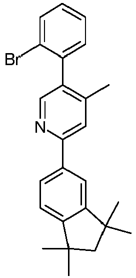 | | |
| | [1989597-32-1] | | |
| L112 | S363 | 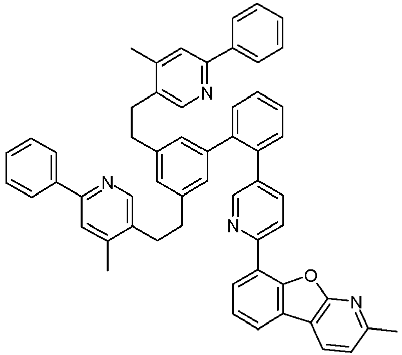 | 75% |
| | 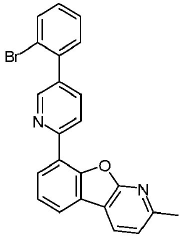 | | |
| | [1989597-42-3] | | |
| L113-D8 | S363-D8 | 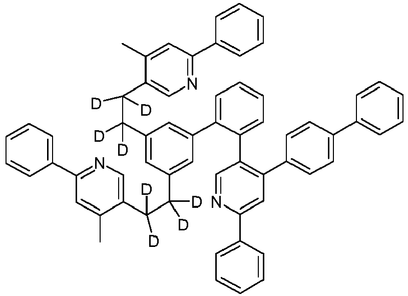 | 70% |
| | S600 | | |
| L114 | S362 | 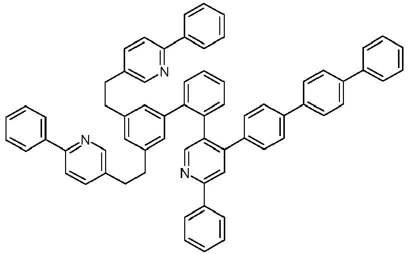 | 71% |
| | S601 | | |
| L115 | S362 | 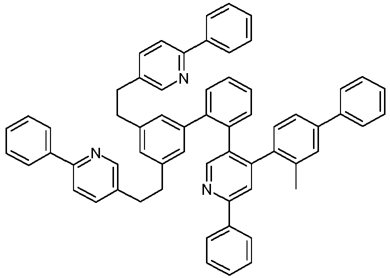 | 63% |
| | S602 | | |
| L116 | S362 | 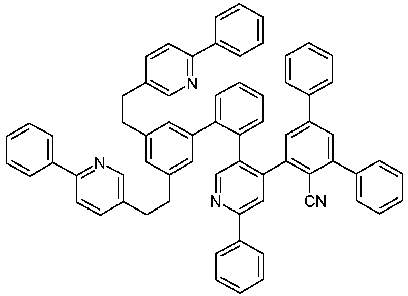 | 59% |
| | S603 | | |
| L117 | S363 | 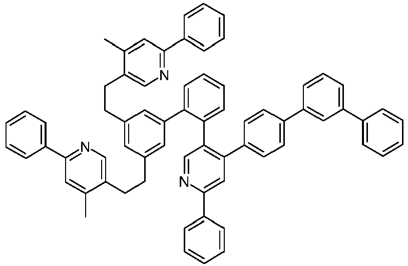 | 65% |
| | S604 | | |
| L118 | S363 | 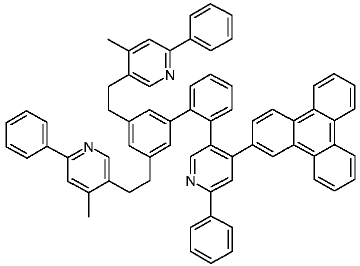 | 78% |
| | S605 | | |
| L119 | S362 | 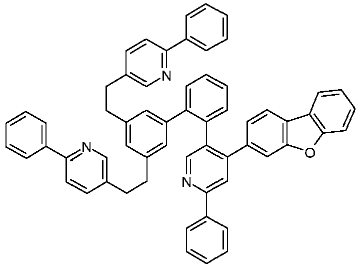 | 74% |
| | S606 | | |
| L120 | S363 | 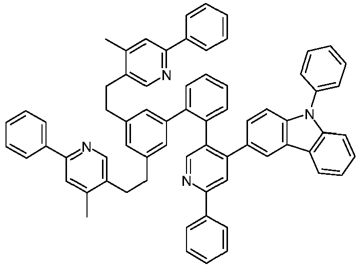 | 70% |
| | S607 | | |
| L121 | S362 | 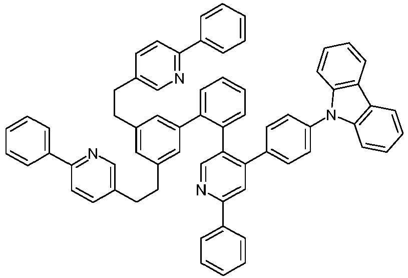 | 77% |
| | S608 | | |
| L122 | S363 | 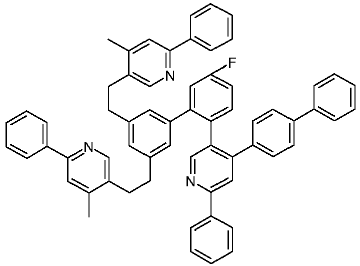 | 68% |
| | S609 | | |
| L123 | S362 | 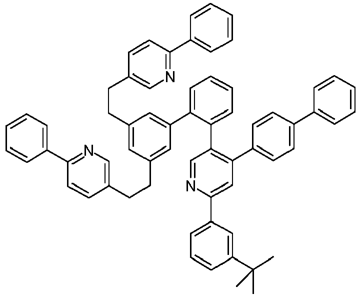 | 65% |
| | S610 | | |
| L124 | S365 | 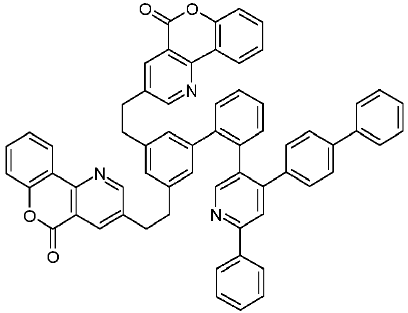 | 66% |
| | S600 | | |
| L124-D8 | S365-D8 | 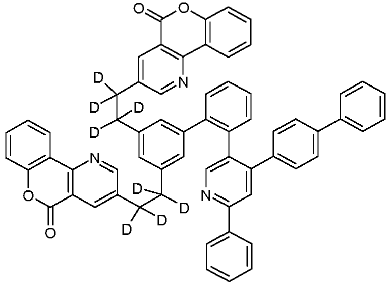 | 67% |
| | S600 | | |
| L125 | S366 | 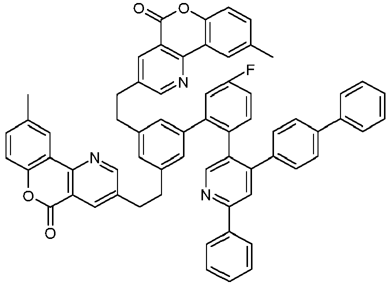 | 61% |
| | S609 | | |
| L126 | S367 | 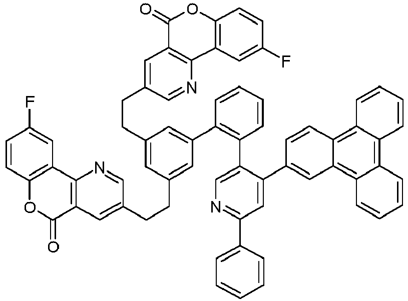 | 69% |
| | S605 | | |
| L127 | S368 | 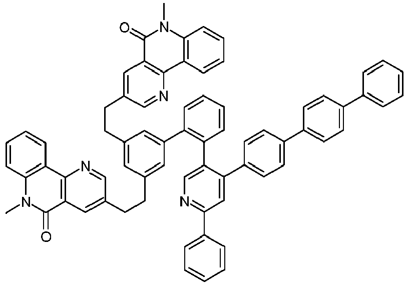 | 63% |
| | S601 | | |
| L128 | S369 | 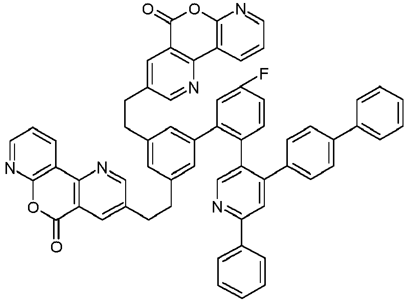 | 60% |
| | S609 | | |
| L128-D8 | S369-D8 | 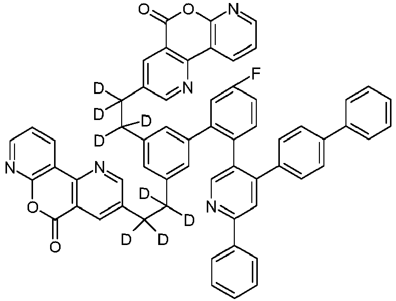 | 68% |
| | S609 | | |
| L129 | S370 | 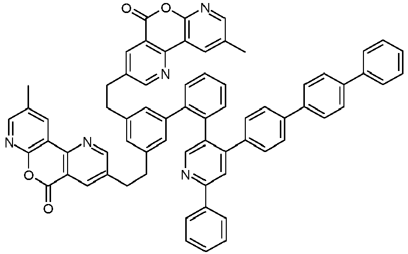 | 66% |
| | S601 | | |
| L130 | S371 | 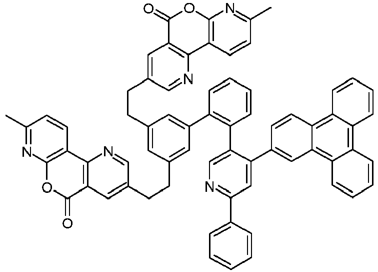 | 63% |
| | S605 | | |
| L131 | S372 | 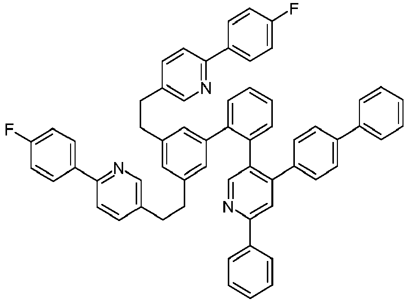 | 65% |
| | S600 | | |
| L132 | S373 | 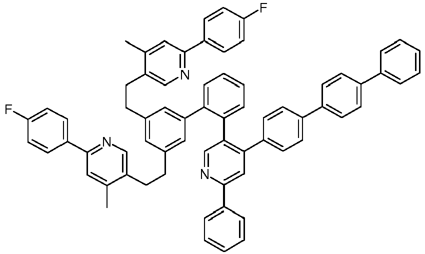 | 67% |
| | S601 | | |
| L133 | S374 | 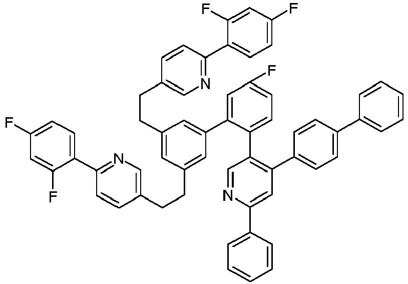 | 64% |
| | S609 | | |
| L133-D8 | S374-D8 | 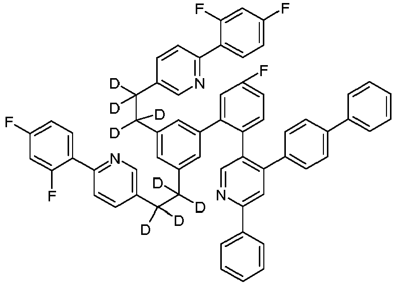 | 67% |
| | S609 | | |
| L134 | S375 | 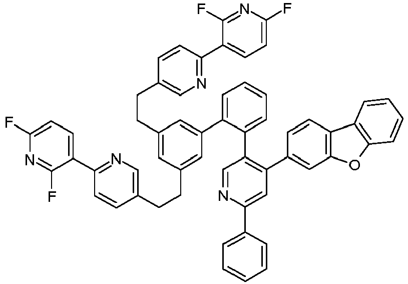 | 60% |
| | S606 | | |
| L135 | S376 | 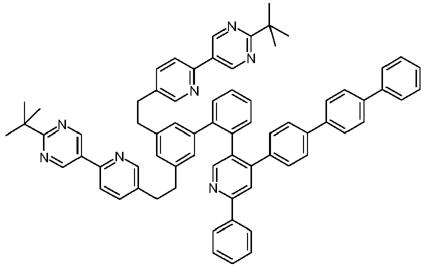 | 64% |
| | S601 | | |
| L136 | S374 | 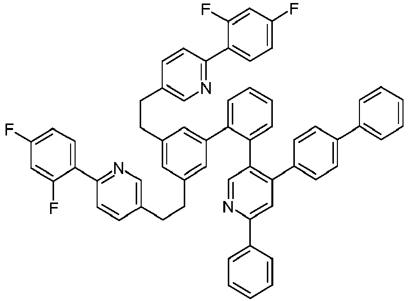 | 67% |
| | S600 | | |
| L136-D8 | S374-D8 | 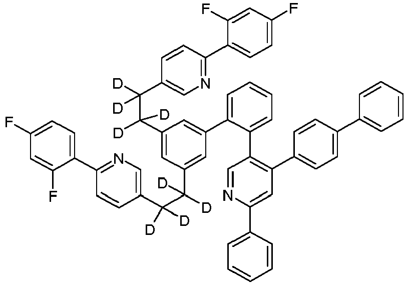 | 65% |
| | S600 | | |
| L137-D8 | S374-D8 | 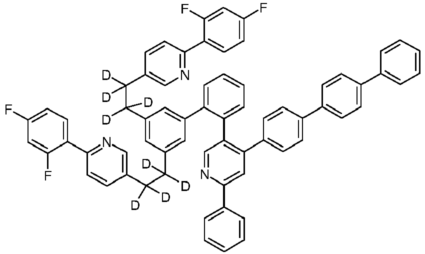 | 68% |
| | S601 | | |
| L138-D8 | S374-D8 | 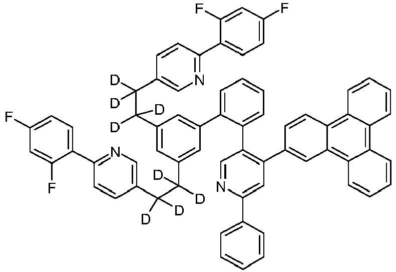 | 65% |
| | S605 | | |
| L139-D8 | S374-D8 | 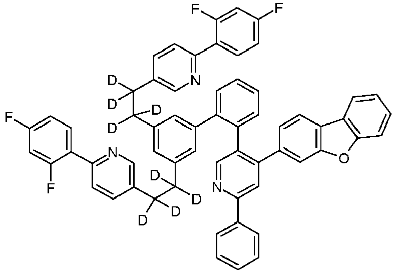 | 63% |
| | S606 | | |
| L140 | S650 | 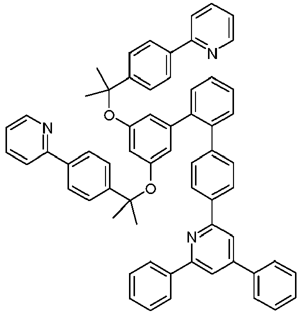 | 60% |
| | 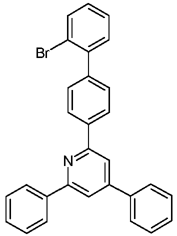 | | |
| | 1987894-82-5 | | |
| L141 | S651 | 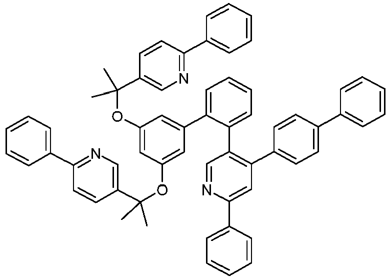 | 67% |
| | S600 | | |
| L142 | S651 | 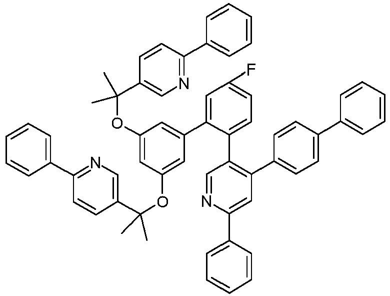 | 64% |
| | S609 | | |
| L143 | S652 | 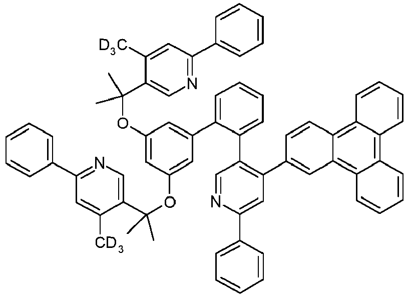 | 66% |
| | S605 | | |
| L144 | S652 | 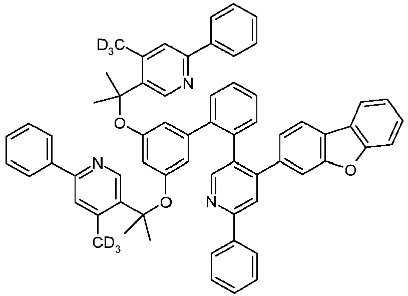 | 63% |
| | S606 | | |
| L145 | S359 | 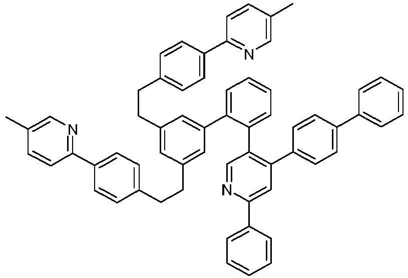 | 67% |
| | S600 | | |
| L146 | S359 | 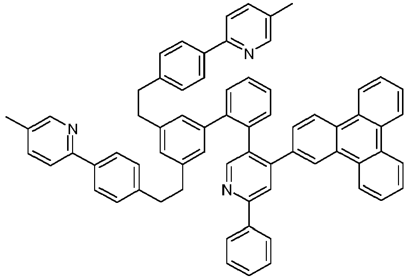 | 70% |
| | S605 | | |
| L147 | S359 | 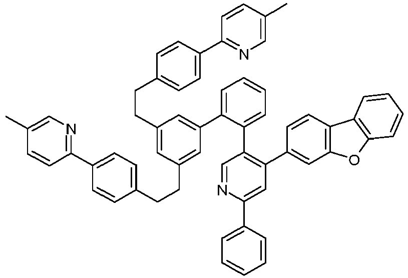 | 68% |
| | S606 | | |
| L148 | S359 | 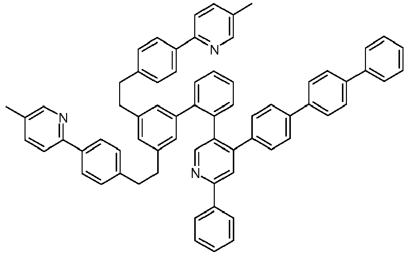 | 65% |
| | S601 | | |
| L149 | S379 | 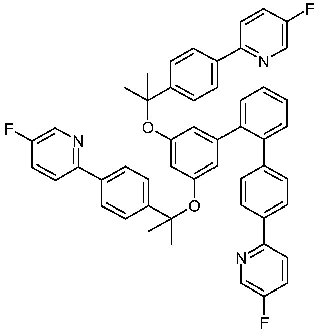 | 67% |
| | S124 | | |
| L150 | S380 | 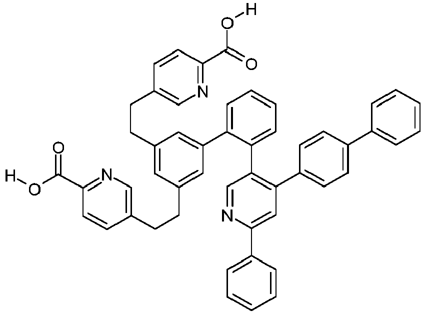 | 48% |
| | S600 | | |
| | | Zusatz von 150 ml 1N HCl zur erkalteten Reaktionsmischung vor der Phasentrennung | |
| L151 | S380 | 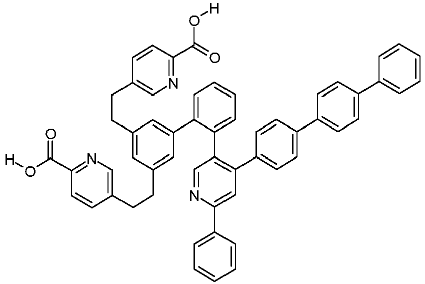 | 53% |
| | S601 | | |
| | | Zusatz von 150 ml 1N HCl zur erkalteten Reaktionsmischung vor der Phasentrennung | |
| L152 | S380 | 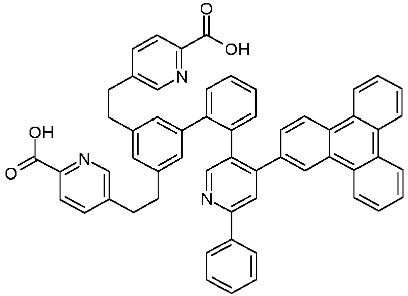 | 57% |
| | S605 | | |
| | | Zusatz von 150 ml 1N HCl zur erkalteten Reaktionsmischung vor der Phasentrennung | |
| L153 | S362 | 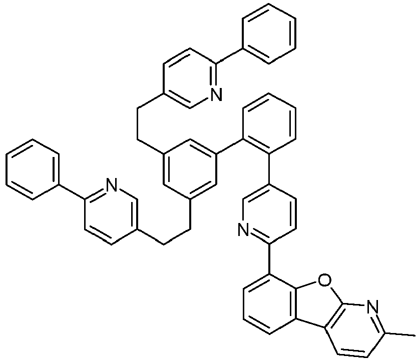 | 63% |
| | 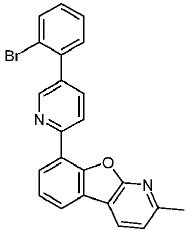 | | |
| | 1989597-42-3 | | |
| L153-D8 | S362-D8 | 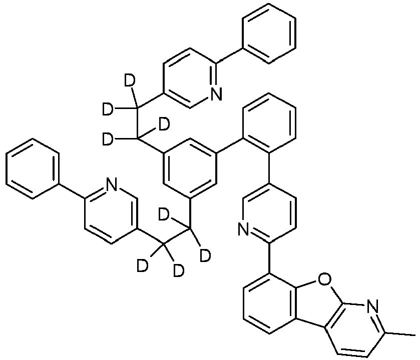 | 60% |
| | 1989597-42-3 | | |
| L154 | S363 | 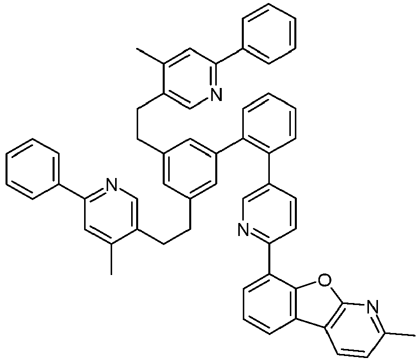 | 65% |
| | 1989597-42-3 | | |
| L154-D8 | S363-D8 | 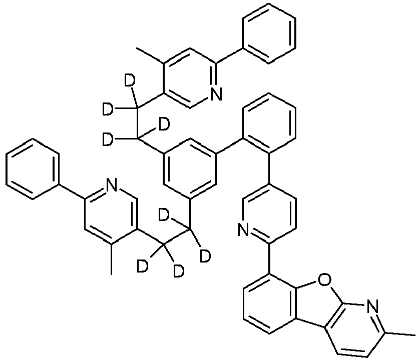 | 62% |
| | 1989597-42-3 | | |
| L155-D8 | S365-D8 | 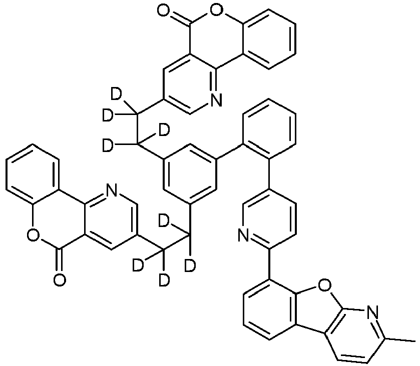 | 70% |
| | 1989597-42-3 | | |
| L156 | S371 | 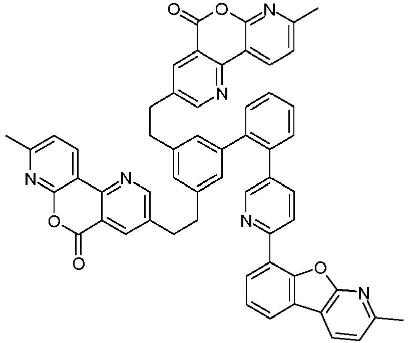 | 71% |
| | 1989597-42-3 | | |
| L157-D8 | S374-D8 | 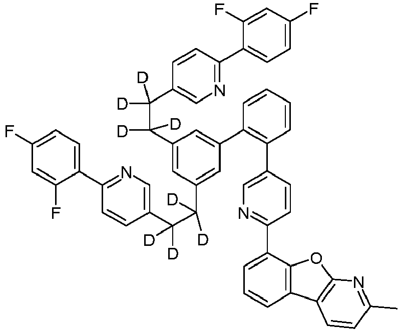 | 68% |
| | 1989597-42-3 | | |
| L158 | S380 | 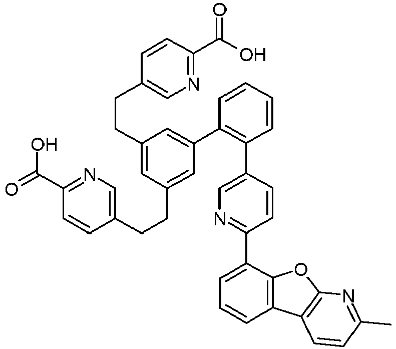 | 70% |
| | 1989597-42-3 | | |
| | | Zusatz von 150 ml 1N HCl zur erkalteten Reaktionsmischung vor der Phasentrennung | |

### Beispiel L200:

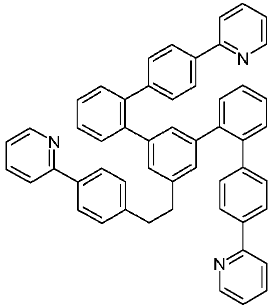

Darstellung analog zu Beispiel S150, wobei anstelle von 100 mmol S358 25.6 g (50 mmol) S500 und anstelle von 100 mmol S100 31.0 g (100 mmol) 2-(2`-Brom[1,1'-biphenyl]-4-yl)pyridin [1374202-35-3] eingesetzt werden. Ausbeute: 27.3 g (38 mmol), 76 %; Reinheit: ca. 95 %ig n. ¹H-NMR.

Analog können folgende Verbindungen dargestellt werden.

| Bsp. | Edukte | Produkt | Ausbeute |
|---|---|---|---|
| L201 | S501 | 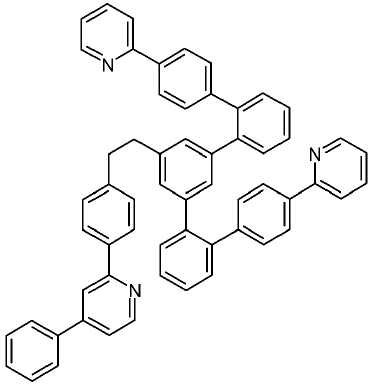 | 70% |
| | 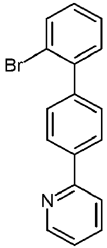 | | |
| | [1374202-35-3] | | |
| L202 | S501 | 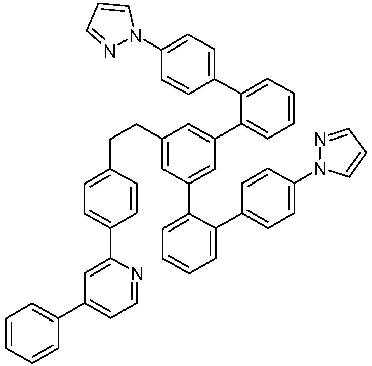 | 56% |
| | 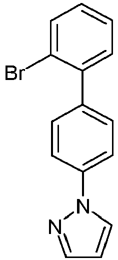 | | |
| | S121 | | |
| L203 | S502 | 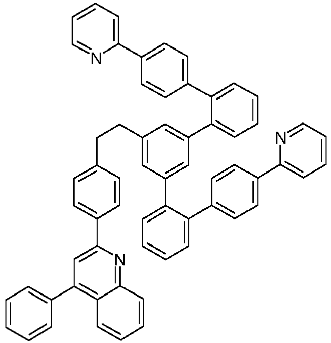 | 74% |
| | 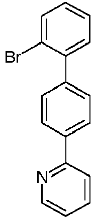 | | |
| | [1374202-35-3] | | |
| L204 | S503 | 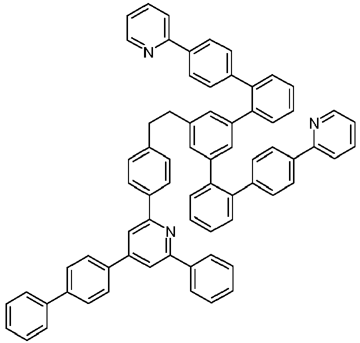 | 73% |
| | 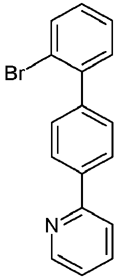 | | |
| | [1374202-35-3] | | |
| L205 | S504 | 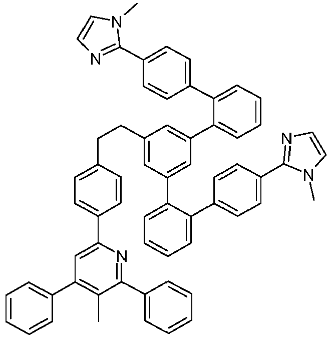 | 58% |
| | 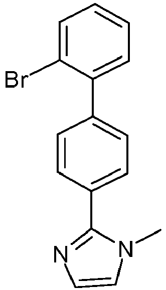 | | |
| | S117 | | |
| L206 | S505 | 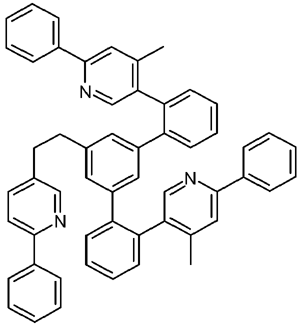 | 69% |
| | 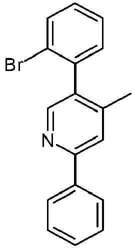 | | |
| | [1989597-30-9] | | |
| L207 | S505 | 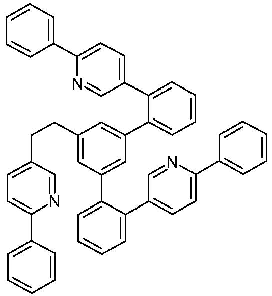 | 70% |
| | 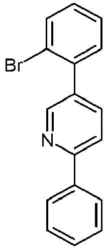 | | |
| | [1989597-29-6] | | |
| L208 | S507 | 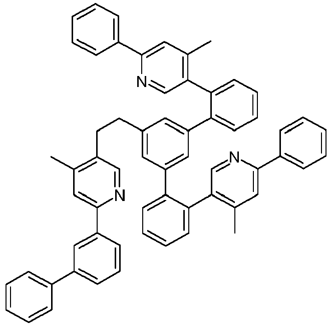 | 68% |
| | 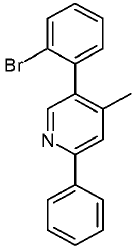 | | |
| | [1989597-30-9] | | |
| L209 | S508 | 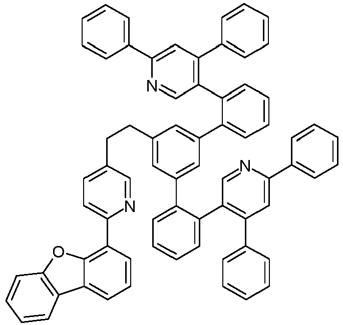 | 72% |
| | 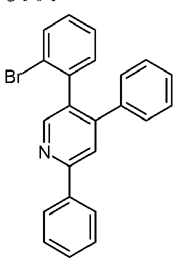 | | |
| | [1989597-32-1] | | |
| L210 | S509 | 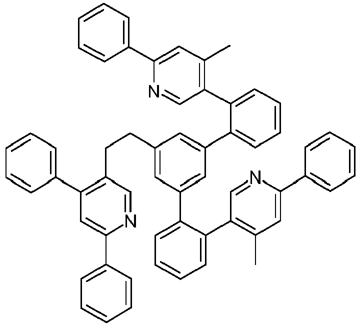 | 70% |
| | 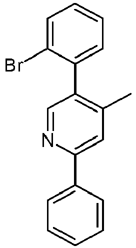 | | |
| | [1989597-30-9] | | |
| L211 | S510 | 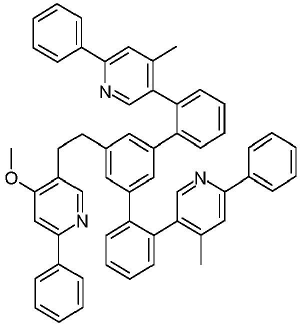 | 67% |
| | 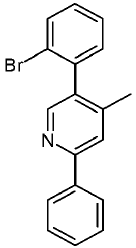 | | |
| | [1989597-30-9] | | |

### C: Darstellung der Metallkomplexe

### Beispiel Ir(L1):

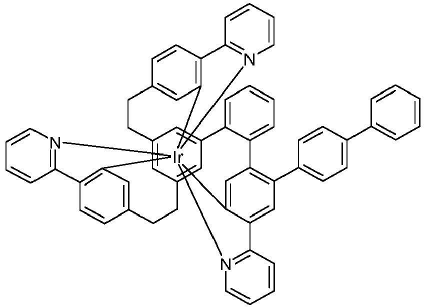

### Variante A:

Ein Gemisch aus 8.22 g (10 mmol) des Liganden L1, 4.90 g (10 mmol) Tris-acetylacetonato-iridium(III) [15635-87-7] und 120 g Hydrochinon [123-31-9] werden in einem 1000 mL Zweihalsrundkolben mit einem glasummantelten Magnetkern vorgelegt. Der Kolben wird mit einem Wasserabscheider (für Medien geringerer Dichte als Wasser) und einem Luftkühler mit Argonüberlagerung versehen. Der Kolben wird in einer Metallheizschale platziert. Die Apparatur wird über die Argonüberlagerung von oben her 15 min. mit Argon gespült, wobei man das Argon aus dem Seitenhals des Zweihalskolbens ausströmen lässt. Über den Seitenhals des Zweihalskolbens führt man ein glasummanteltes Pt-100 Thermoelement in den Kolben ein und platziert das Ende kurz oberhalb des Magnetrührkerns. Dann wird die Apparatur mit mehreren lockeren Wicklungen von Haushaltsaluminiumfolie thermisch isoliert, wobei die Isolation bis zur Mitte des Steigrohres des Wasserabscheiders geführt wird. Dann wird die Apparatur schnell mit einem Laborheizrührwerk auf 250-255 °C, gemessen am Pt-100 Thermofühler, der in die aufgeschmolzene, gerührte Reaktionsmischung eintaucht, erhitzt. Während der nächsten 2 h wird das Reaktionsgemisch bei 250-255 °C gehalten, wobei wenig Kondensat abdestilliert und sich im Wasserabscheider sammelt. Nach 2 h lässt man auf 190 °C abkühlen, entfernt die Heizschale und tropft dann 100 ml Ethylenglycol zu. Nach Erkalten auf 100 °C tropft man langsam 400 ml Methanol zu. Die so erhaltene gelbe Suspension wird über eine Umkehrfritte filtriert, der gelbe Feststoff wird dreimal mit 50 ml Methanol gewaschen und dann im Vakuum getrocknet. Rohausbeute: quantitativ. Der so erhaltene Feststoff wird in 200 ml Dichlormethan gelöst und über ca. 1 kg mit Dichlormethan vorgeschlämmtes Kieselgel (Säulendurchmesser ca. 18 cm) unter Luft- und Lichtausschluss filtriert, wobei dunkle Anteile am Start liegen bleiben. Die Kernfraktion wird herausgeschnitten und am Rotationsverdampfer eingeengt, wobei gleichzeitig kontinuierlich MeOH bis zur Kristallisation zugetropft wird. Nach Absaugen, Waschen mit wenig MeOH und Trocknen im Vakuum erfolgt die weitere Reinigung des orangefarbenen Produkts durch viermalige kontinuierliche Heißextraktion mit Dichlormethan/i-Propanol 1:1 (vv) und dann viermalige Heißextraktion mit Dichlormethan/Acetonitril (Vorlagemenge jeweils ca. 200 ml, Extraktionshülse: Standard Soxhletthülsen aus Cellulose der Fa. Whatman) unter sorgfältigem Luft- und Lichtausschluss. Über das Verhältnis Dichlormethan (Niedersieder und Gutlöser) : i-Propanol bzw. Acetonitril (Hochsieder und Schlechtlöser) kann der Verlust in die Mutterlauge eingestellt werden. Typischerweise sollte er 3-6 Gew.-% der eingesetzten Menge betragen. Es können zur Heißextration auch andere Lösungsmittel wie Toluol, Xylol, Essigester, Butylacetat, etc. verwendet werden. Abschließend wird das Produkt im Hochvakuum bei p = ca. 10⁻⁶ mbar und T = ca. 350 - 430 °C fraktioniert sublimiert. Ausbeute: 5.38 g (5.3 mmol), 53 %; Reinheit: > 99.9 %ig nach HPLC.

### Variante B:

Durchführung analog Ir(L1) Variante A, jedoch werden statt 120 g Hydrochinon 300 ml Ethylenglycol [111-46-6] verwendet, und es wird 16 h bei 190 °C gerührt. Nach Erkalten auf 70 °C wird mit 300 ml Ethanol verdünnt, der Feststoff wird abgesaugt (P3), dreimal mit je 100 ml Ethanol gewaschen und dann im Vakuum getrocknet. Die weitere Reinigung erfolgt wie unter Variante A beschrieben. Ausbeute: 4.87 g (4.8 mmol), 48 %; Reinheit: > 99.9 %ig nach HPLC.

### Variante C:

Durchführung analog Ir(L1) Variante B, jedoch werden statt 4.90 g (10 mmol) Tris-acetylacetonato-iridium(III) [15635-87-7] 3.53 g (10 mmol) Iridium(III)chlorid x n H₂O (n ca. 3) und statt 120 g Hydrochinon 300 ml 2-Ethoxyethanol/Wasser (3:1, vv) verwendet, und es wird 30 h im Rührautoklaven bei 190 °C gerührt. Nach Erkalten wird der Feststoff abgesaugt (P3), dreimal mit je 30 ml Ethanol gewaschen und dann im Vakuum getrocknet. Die weitere Reinigung erfolgt wie unter Variante B beschrieben. Ausbeute: 4.16 g (4.1 mmol), 41 %; Reinheit: > 99.9 %ig nach HPLC.

Die Metallkomplexe fallen üblicherweise als 1:1 Mischung der Λ- und Δ-Isomere/Enantiomere an. Die im Folgenden aufgeführte Abbildungen von Komplexen zeigen üblicherweise nur ein Isomer. Werden Liganden mit drei verschiedenen Teilliganden eingesetzt, bzw. werden chirale Liganden als Racemat eingesetzt, fallen die abgeleiteten Metallkomplexe als Diastereomerenmischung an. Diese können durch fraktionierte Kristallisation oder chromatographisch getrennt werden, z. B. mit einem Säulenautomaten (CombiFlash der Fa. A. Semrau). Werden chirale Liganden enantiomerenrein eingesetzt, fallen die abgeleiteten Metallkomplexe als Diastereomerenmischung an, deren Trennung durch fraktionierte Kristallisation oder Chromatographie zu reinen Enantiomeren führt. Die getrennten Diastereomeren bzw. Enantiomeren können wie oben beschrieben z. B. durch Heißextraktion weiter gereinigt werden.

Analog können folgende Verbindungen dargestellt werden:

| Bsp. | Ligand | Produkt Variante A / Extraktionsmittel* | Ausbeute |
|---|---|---|---|
| Ir(L2) | L2 | 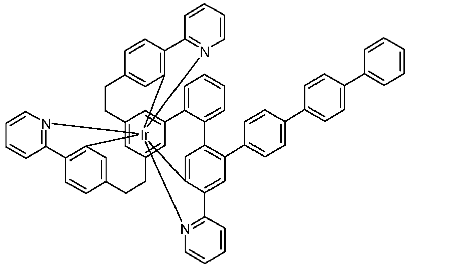 | 67% |
| Ir(L3) | L3 | 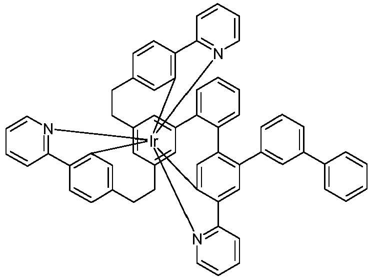 | 63% |
| Ir(L4) | L4 | 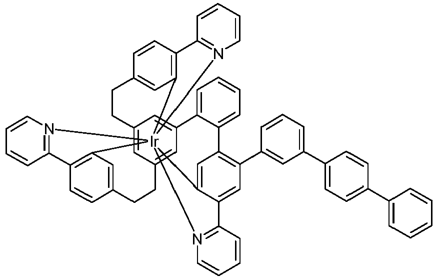 | 60% |
| | | 4 x Dichlormethan/i-Propanol 1:1 4 x Toluol | |
| Ir(L5) | L5 | 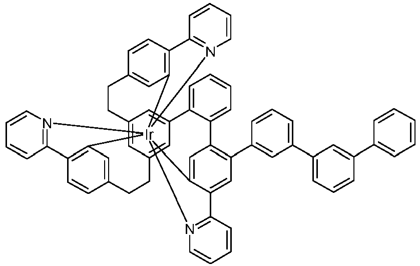 | 55% |
| Ir(L6) | L6 | 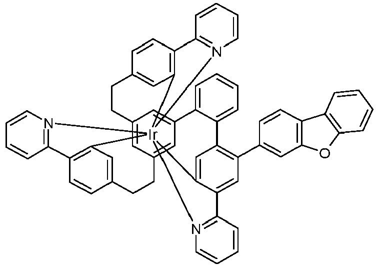 | 61% |
| Ir(L7) | L7 | 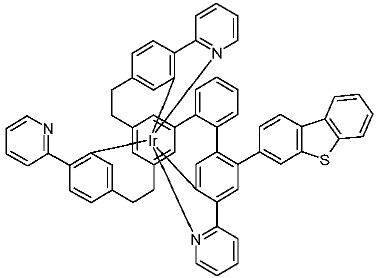 | 59% |
| Ir(L8) | L8 | 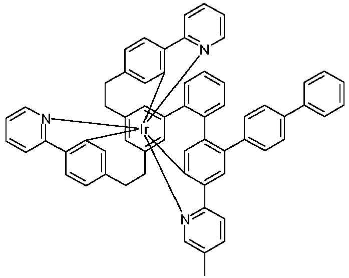 | 61% |
| Ir(L9) | L9 | 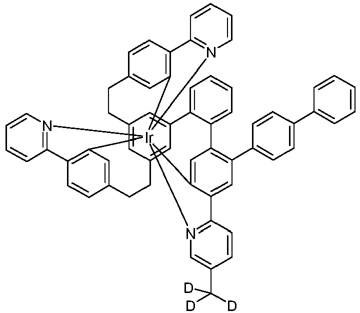 | 57% |
| Ir(L10) | L10 | 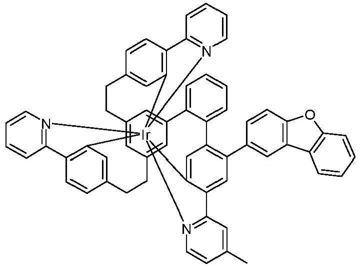 | 62% |
| Ir(L11) | L11 | 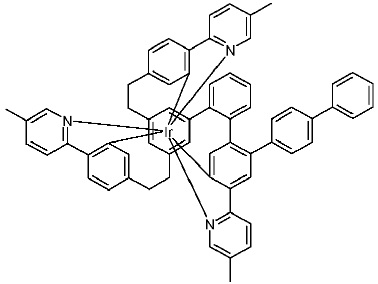 | 62% |
| Ir(L12) | L12 | 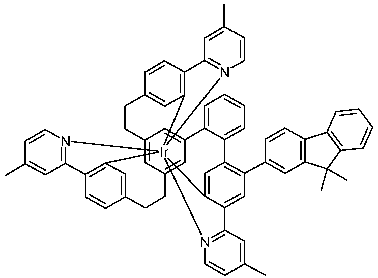 | 64% |
| Ir(L13) | L13 | 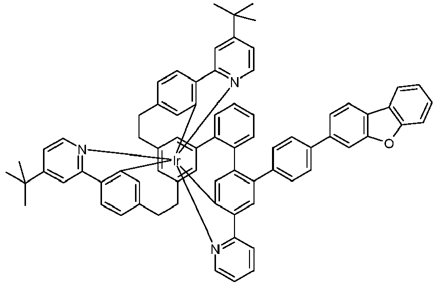 | 60% |
| Ir(L14) | L14 | 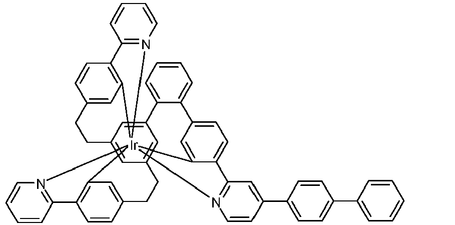 | 58% |
| Ir(L15) | L15 | 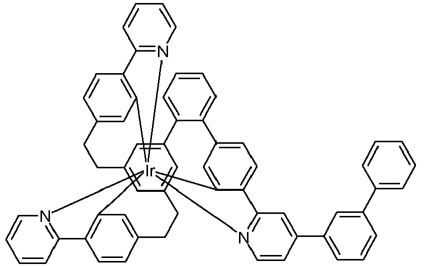 | 60% |
| Ir(L16) | L16 | 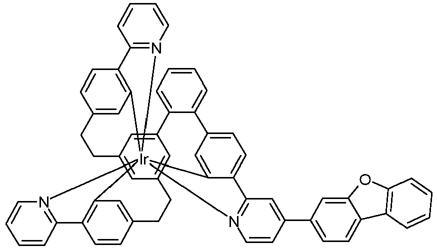 | 64% |
| Ir(L17) | L17 | 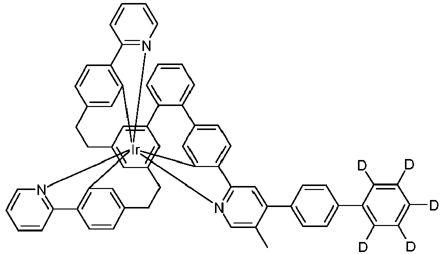 | 57% |
| Ir(L18) | L18 | 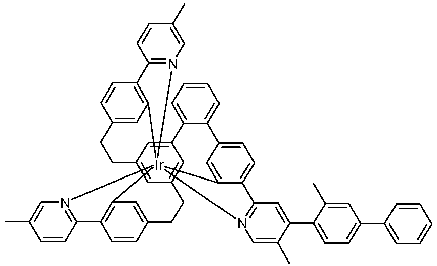 | 59% |
| Ir(L19) | L19 | 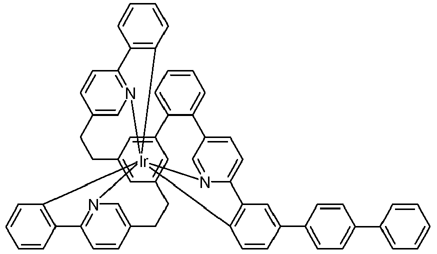 | 66% |
| Ir(L20) | L20 | 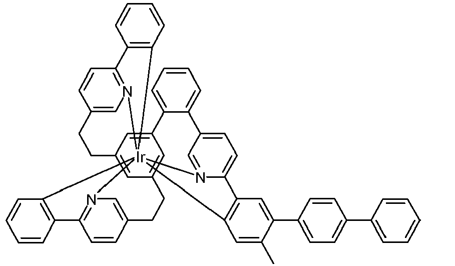 | 62% |
| Ir(L21) | L21 | 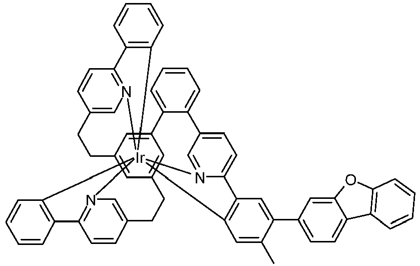 | 60% |
| Ir(L22) | L22 | 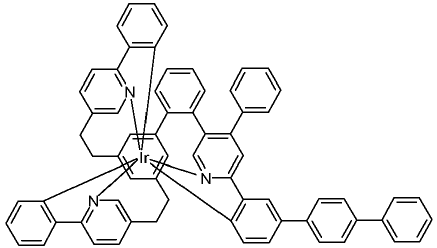 | 57% |
| Ir(L23) | L23 | 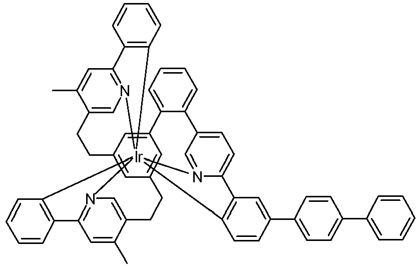 | 60% |
| Ir(L24) | L24 | 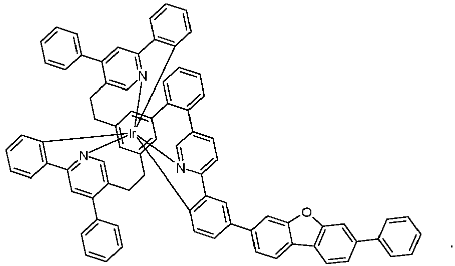 | 57% |
| Ir(L25) | L25 | 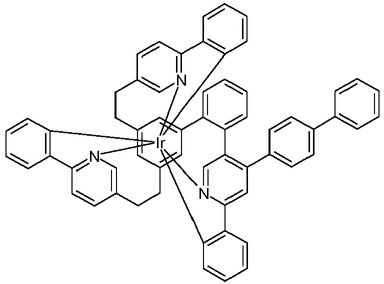 | 64% |
| Ir(L26) | L26 | 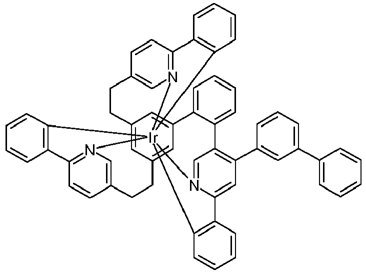 | 63% |
| Ir(L27) | L27 | 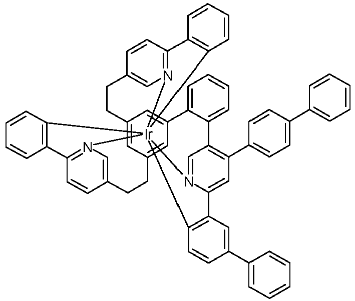 | 59% |
| Ir(L28) | L28 | 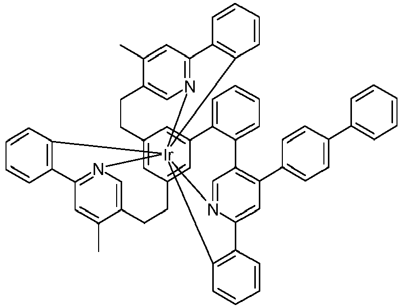 | 58% |
| Ir(L29) | L29 | 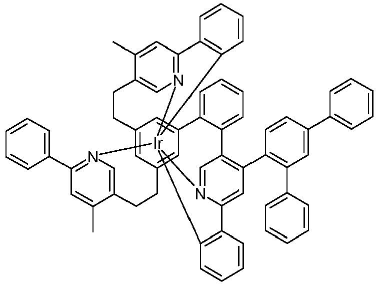 | 62% |
| Ir(L30) | L30 | 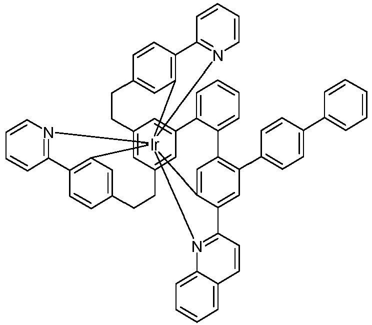 | 58% |
| Ir(L31) | L31 | 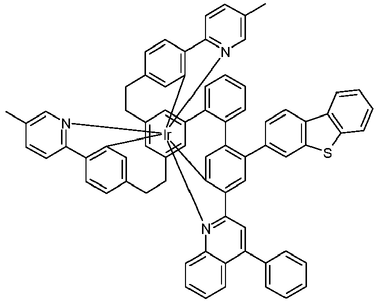 | 60% |
| | | 4 x Dichlormethan/i-Propanol 1:1 4 x o-Xylol | |
| Ir(L32) | L32 | 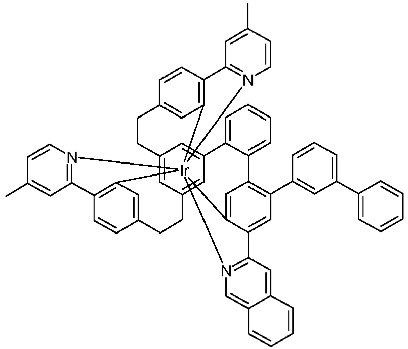 | 60% |
| Ir(L33) | L33 | 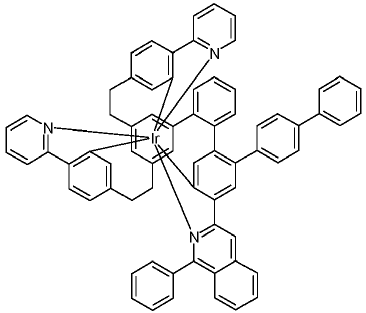 | 63% |
| Ir(L34) | L34 | 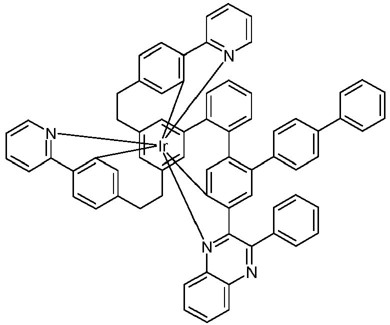 | 60% |
| Ir(L35) | L35 | 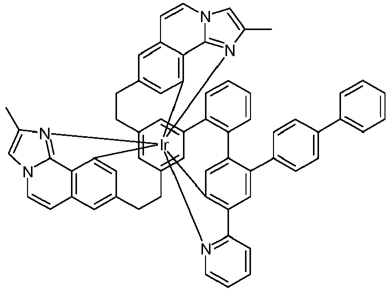 | 61% |
| Ir(L36) | L36 | 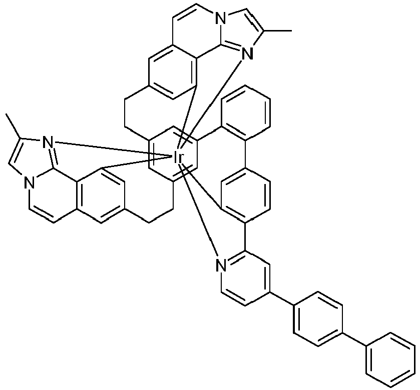 | 57% |
| Ir(L37) | L37 | 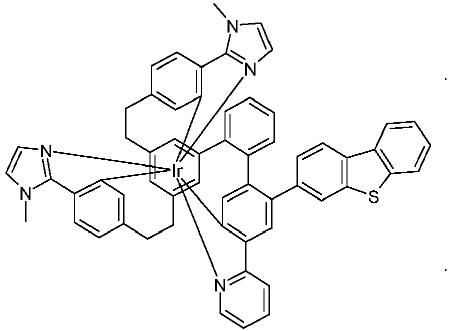 | 55% |
| Ir(L38) | L38 | 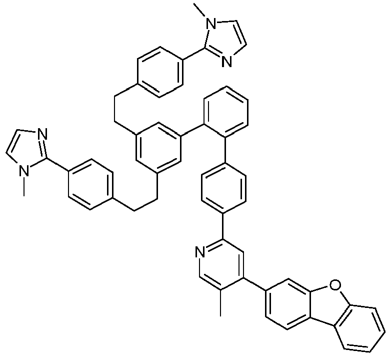 | 58% |
| Ir(L39) | L39 | 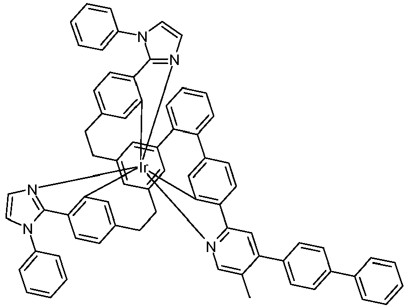 | 56% |
| Ir(L40) | L40 | 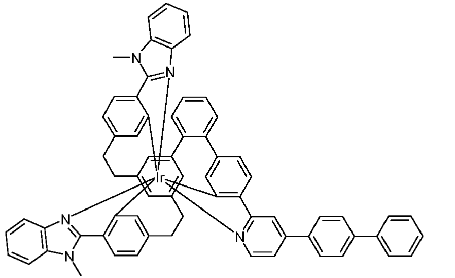 | 60% |
| Ir(L41) | L41 | 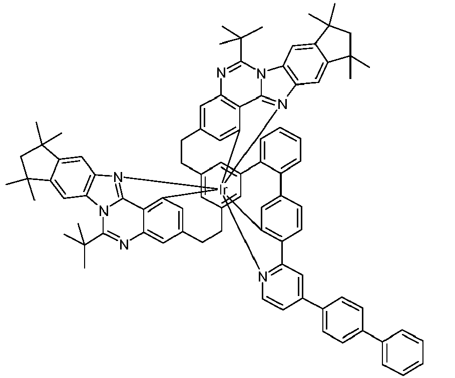 | 53% |
| Ir(L42) | L42 | 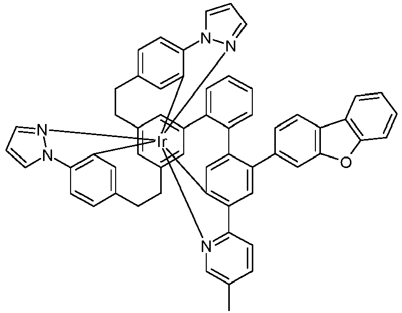 | 60% |
| Ir(L43) | L43 | 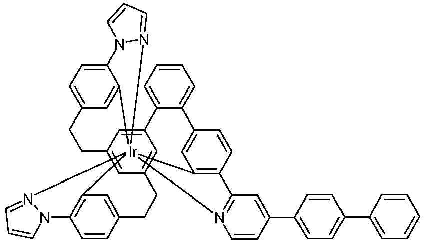 | 63% |
| Ir(L44) | L44 | 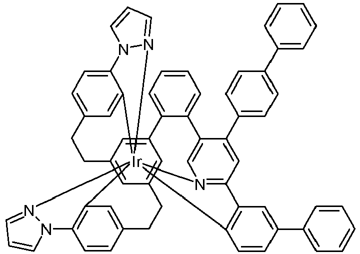 | 62% |
| Ir(L45) | L45 | 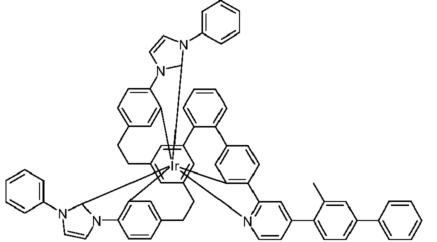 | 40% |
| | | Zugabe von 25 mmol NaOtBu zur Reaktionsmischung | |
| Ir(L46) | L46 | 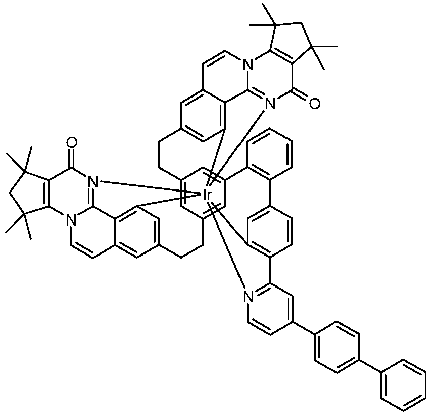 | 55% |
| | | 4 x Dichlormethan/i-Propanol 1:1 4 x n-BuAc | |
| Ir(L47) | L47 | 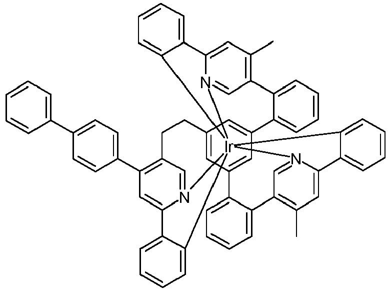 | 61% |
| Ir(L100) | L100 | 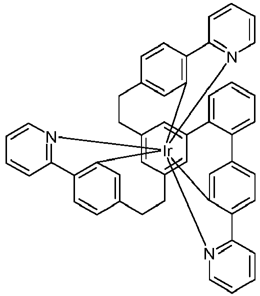 | 65% |
| Ir(L 101) | L101 | 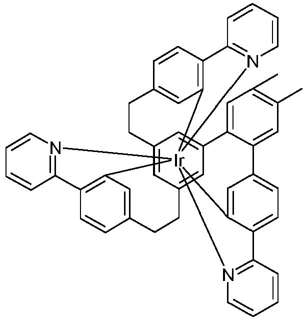 | 67% |
| Ir(L102) | L102 | 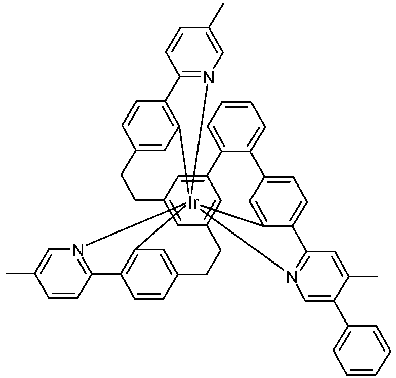 | 63% |
| Ir(L103) | L103 | 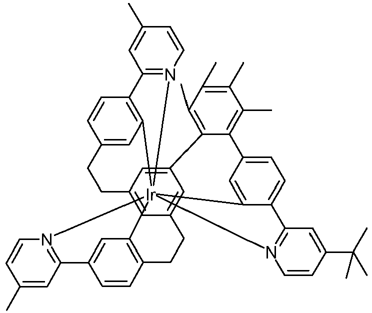 | 65% |
| Ir(L104) | L104 | 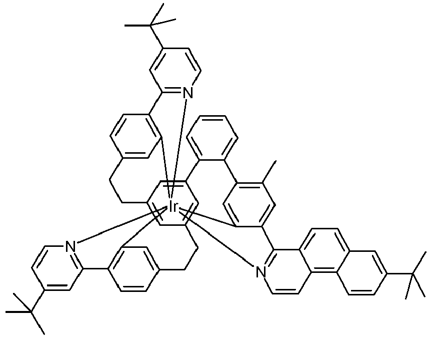 | 58% |
| Ir(L105) | L105 | 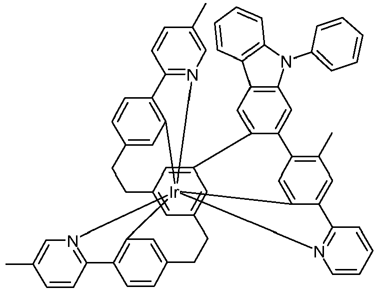 | 61% |
| Ir(L106) | L106 | 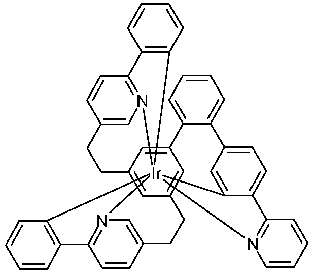 | 64% |
| Ir(L107) | L107 | 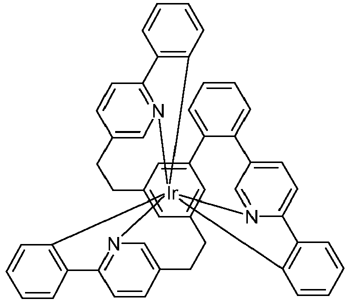 | 67% |
| Ir(L108) | L108 | 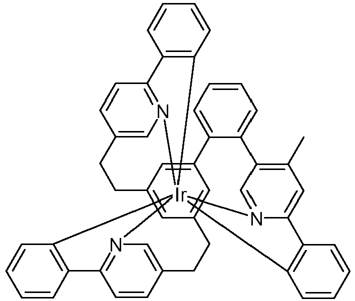 | 65% |
| Ir(L109) | L109 | 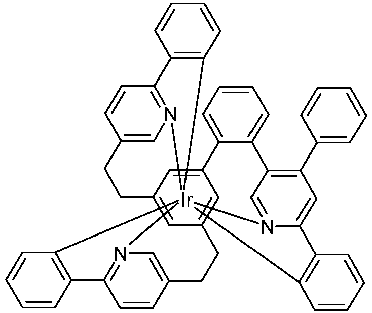 | 67% |
| Ir(L109-D8) | L109-D8 | 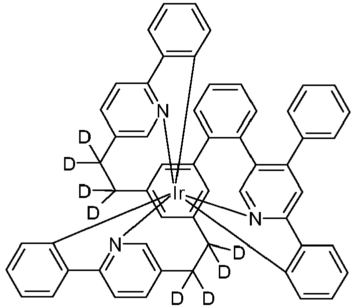 | 65% |
| Ir(L110) | L110 | 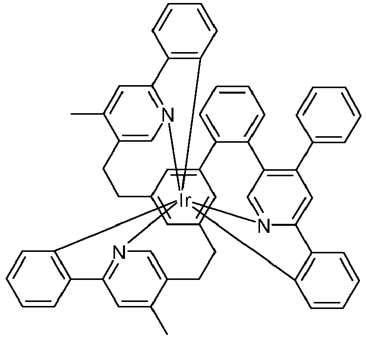 | 63% |
| Ir(L111) | L111 | 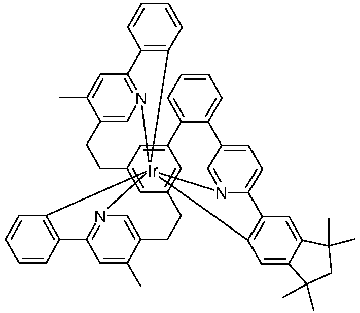 | 61% |
| Ir(L1 12) | L112 | 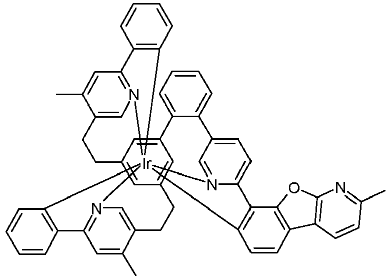 | 64% |
| Ir(L113-D8) | L1 13-D8 | 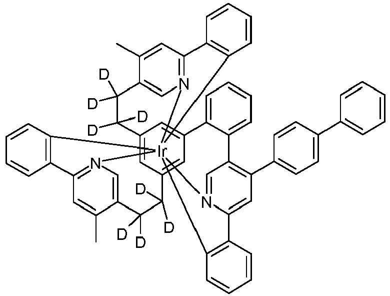 | 66% |
| Ir(L114) | L114 | 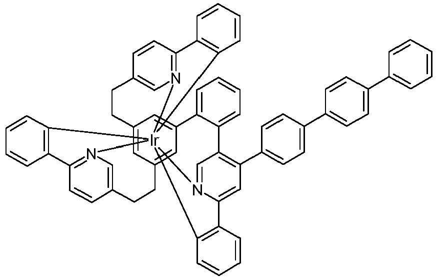 | 63% |
| Ir(L115) | L115 | 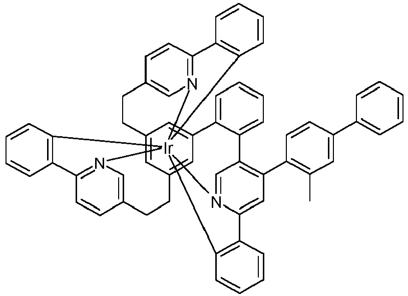 | 60% |
| Ir(L1 16) | L116 | 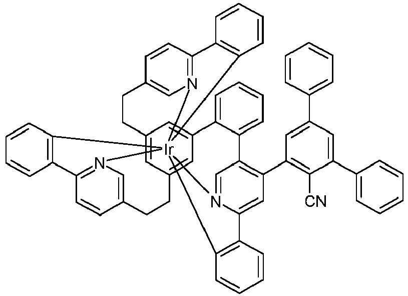 | 51% |
| Ir(L117) | L117 | 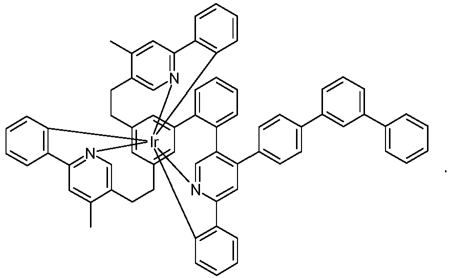 | 59% |
| Ir(L118) | L118 | 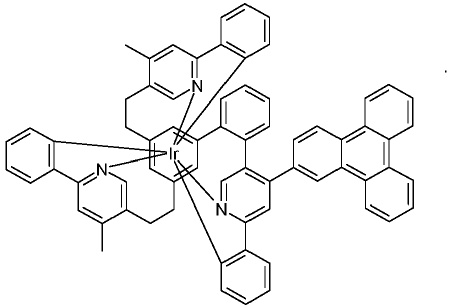 | 67% |
| Ir(L119) | L119 | 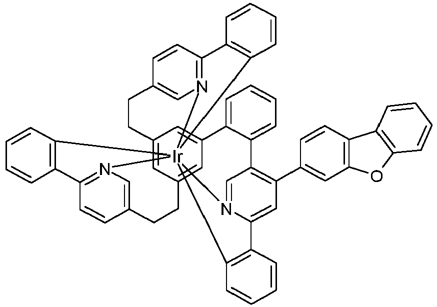 | 65% |
| Ir(L120) | L120 | 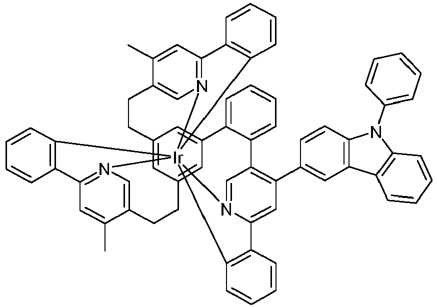 | 63% |
| Ir(L121) | L121 | 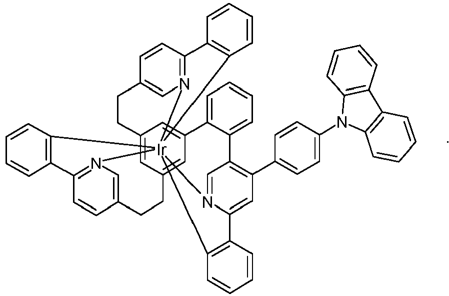 | 69% |
| Ir(L122) | L122 | 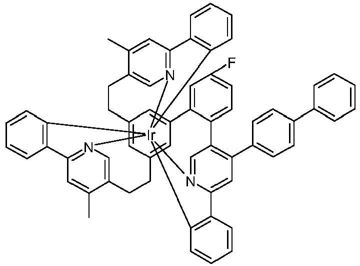 | 65% |
| Ir(L123) | L123 | 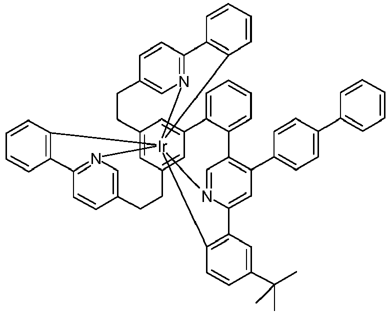 | 67% |
| Ir(L124) | L124 | 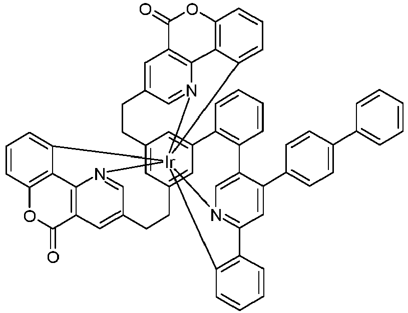 | 55% |
| Ir(L124-D8) | L124-D8 | 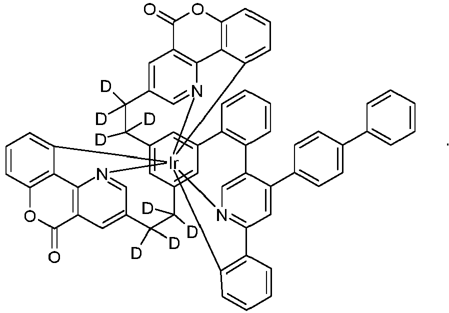 | 52% |
| Ir(L125) | L125 | 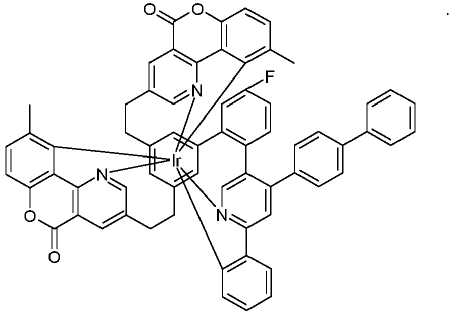 | 43% |
| Ir(L126) | L126 | 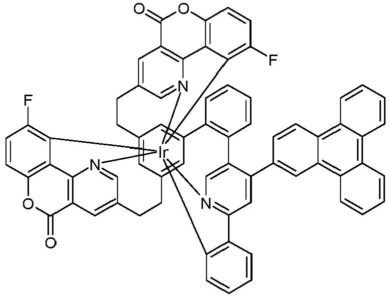 | 47% |
| Ir(L127) | L127 | 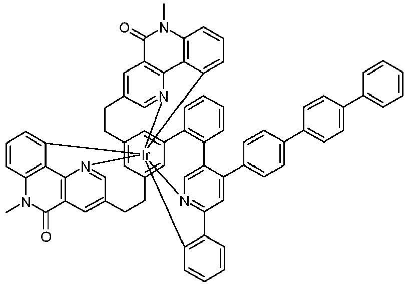 | 50% |
| Ir(L128) | L128 | 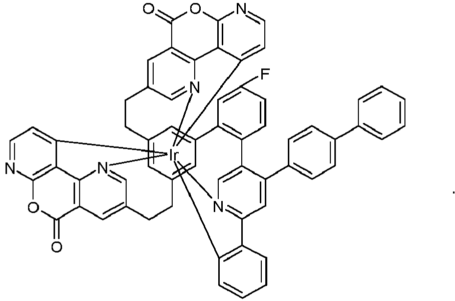 | 48% |
| Ir(L128-D8) | L128-D8 | 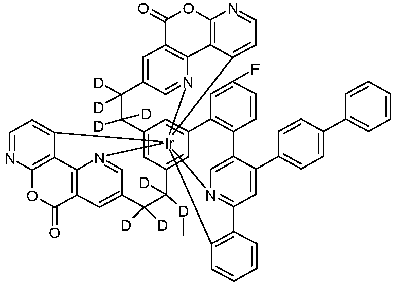 | 52% |
| Ir(L129) | L129 | 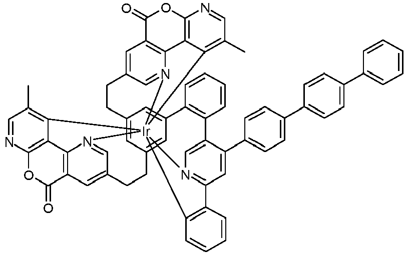 | 37% |
| Ir(L130) | L130 | 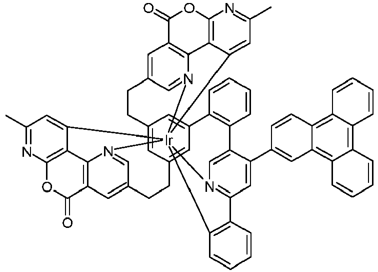 | 39% |
| Ir(L131) | L131 | 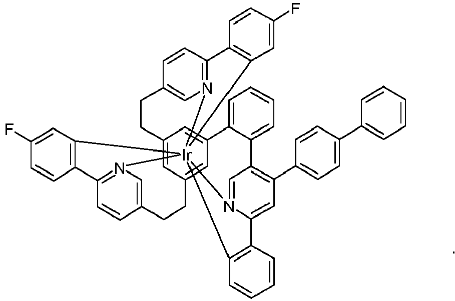 | 70% |
| Ir(L132) | L132 | 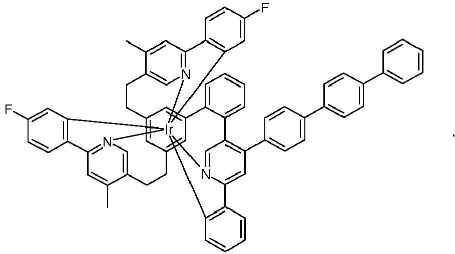 | 68% |
| Ir(L133) | L133 | 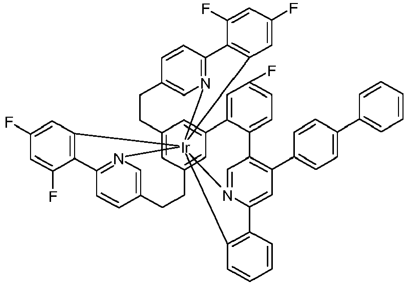 | 67% |
| Ir(L133-D8) | L133-D8 | 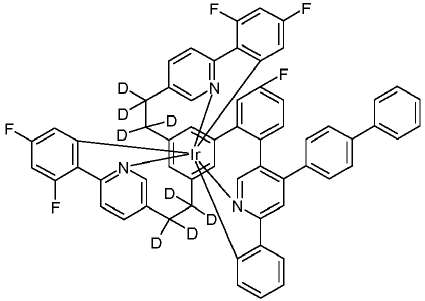 | 69% |
| Ir(L134) | L134 | 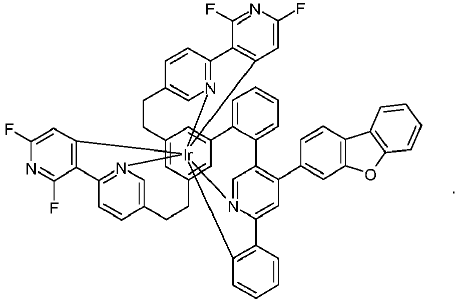 | 56% |
| Ir(L135) | L135 | 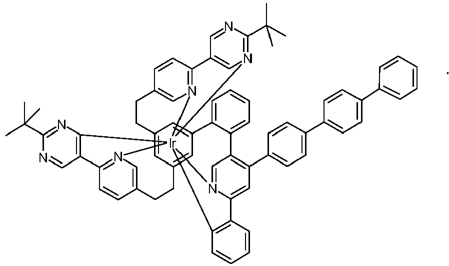 | 61% |
| Ir(L136) | L136 | 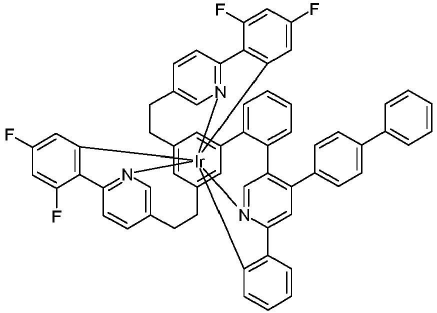 | 63% |
| Ir(L136-D8) | L136-D8 | 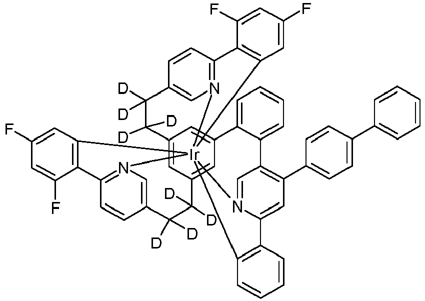 | 66% |
| Ir(L137-D8) | L137-D8 | 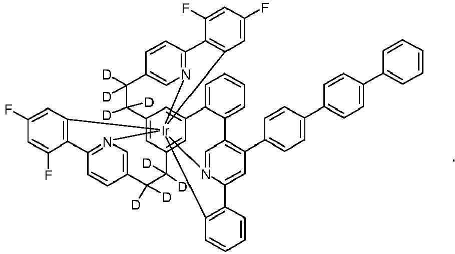 | 72% |
| Ir(L138-D8) | L138-D8 | 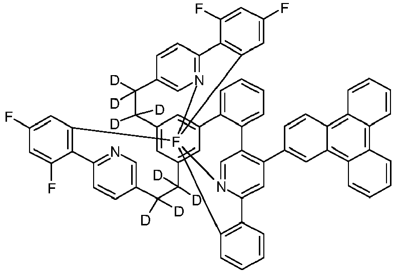 | 69% |
| Ir(L139-D8) | L139-D8 | 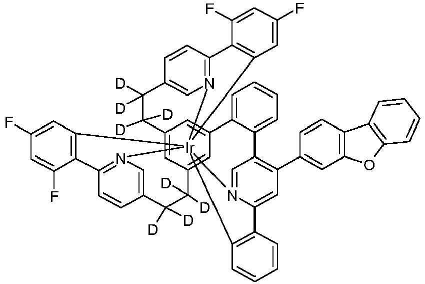 | 65% |
| Ir(L140) | L140 | 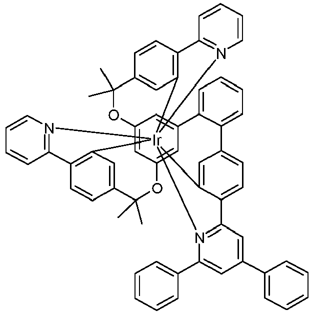 | 43% |
| Ir(L141) | L141 | 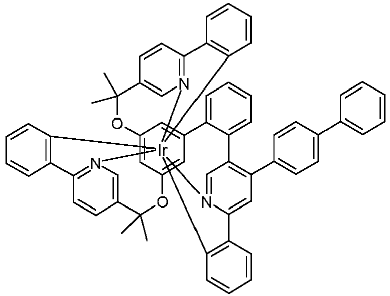 | 67% |
| Ir(L142) | L142 | 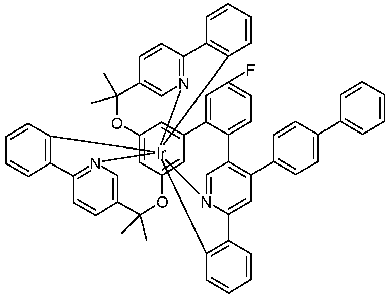 | 64% |
| Ir(L143) | L143 | 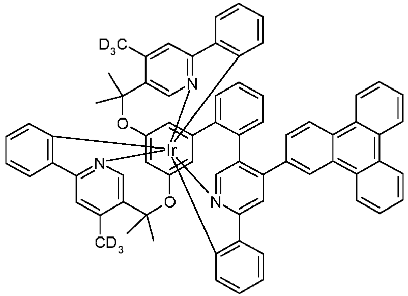 | 54% |
| Ir(L144) | L144 | 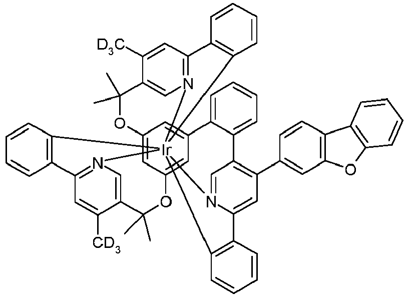 | 57% |
| Ir(L145) | L145 | 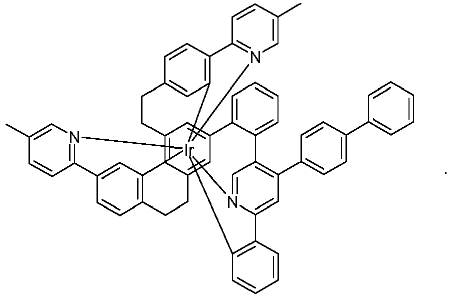 | 62% |
| Ir(L146) | L146 | 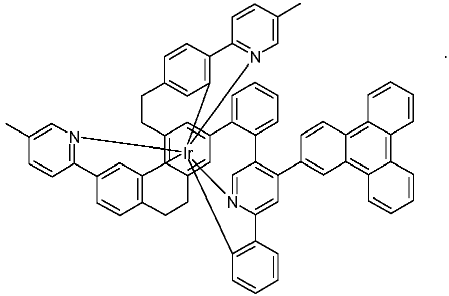 | 65% |
| Ir(L147) | L147 | 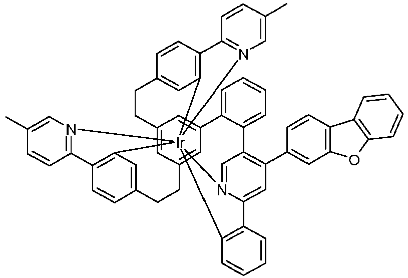 | 60% |
| Ir(L148) | L148 | 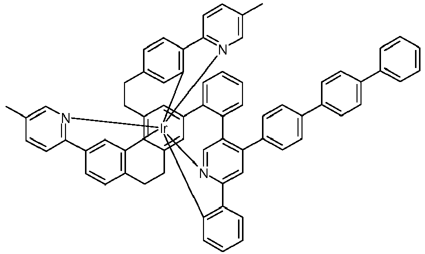 | 63% |
| Ir(L149) | L149 | 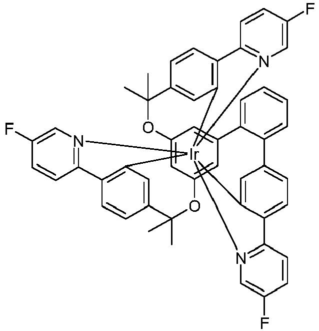 | 56% |
| Ir(L150) | L150 | 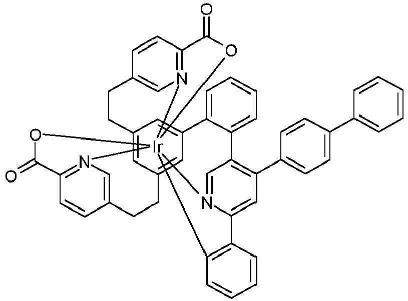 | 45% |
| Ir(L151) | L151 | 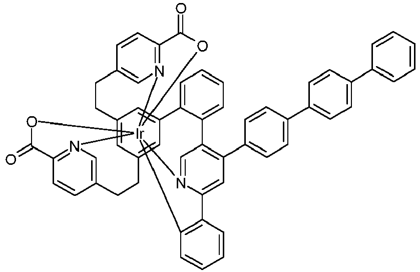 | 47% |
| Ir(L152) | L152 | 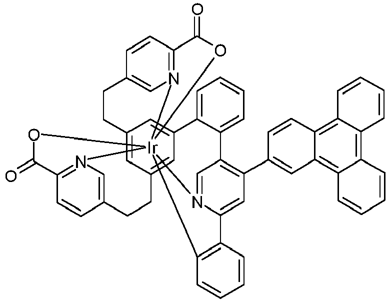 | 51% |
| Ir(L153) | L153 | 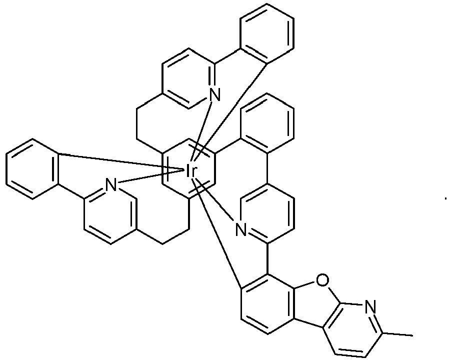 | 60% |
| Ir(L153-D8) | L153-D8 | 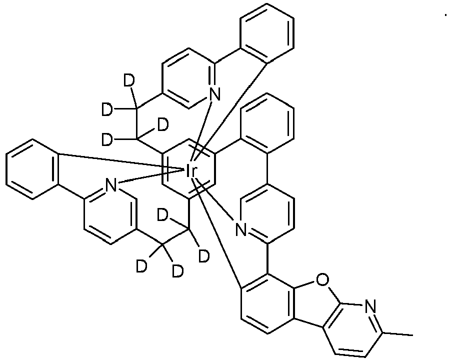 | 58% |
| Ir(L154) | L154 | 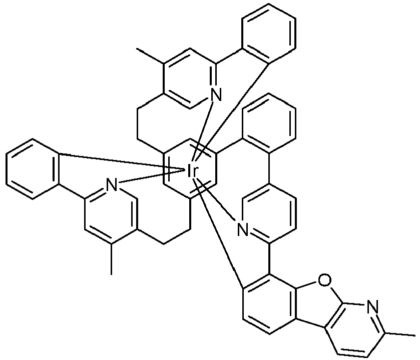 | 61% |
| Ir(L154-D8) | L154-D8 | 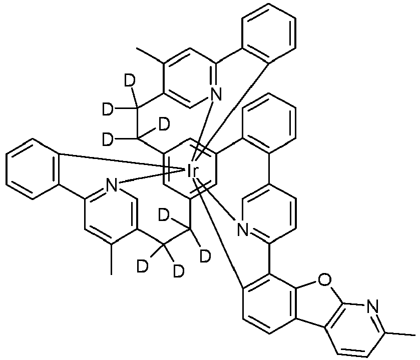 | 63% |
| Ir(L155-D8) | L155-D8 | 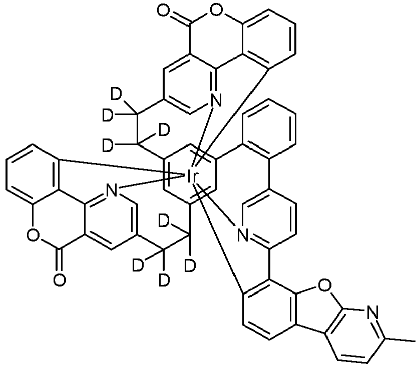 | 57% |
| Ir(L156) | L156 | 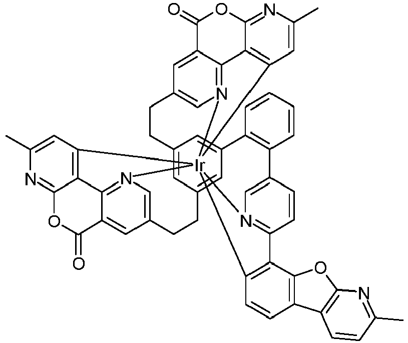 | 60% |
| Ir(L157-D8) | L157-D8 | 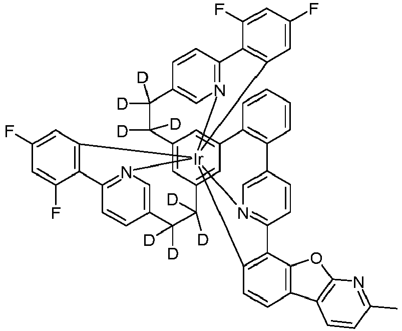 | 64% |
| Ir(L158) | L158 | 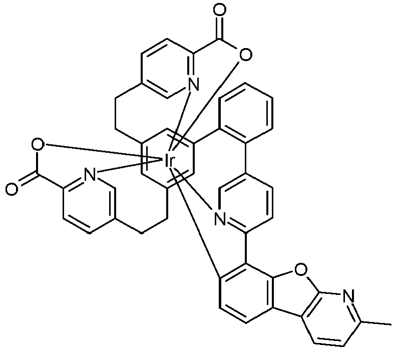 | 48% |
| Ir(L200) | L200 | 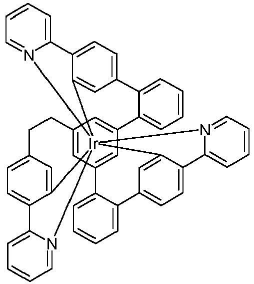 | 66% |
| Ir(L201) | L201 | 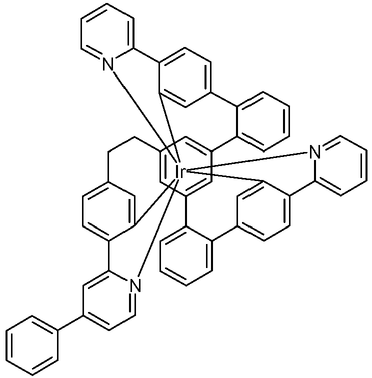 | 63% |
| Ir(L202) | L202 | 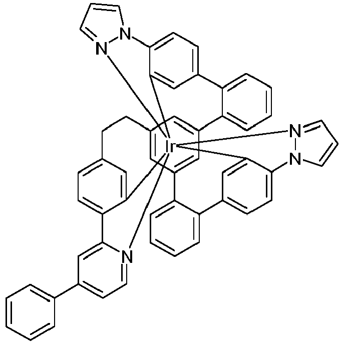 | 58% |
| Ir(L203) | L203 | 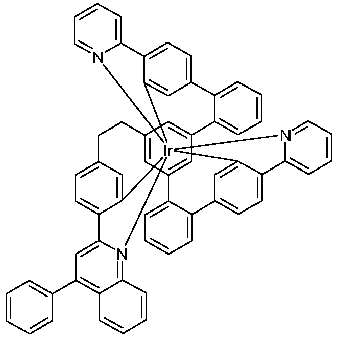 | 63% |
| Ir(L204) | L204 | 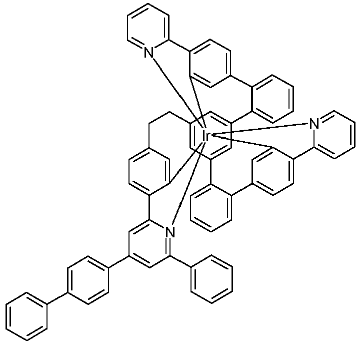 | 54% |
| Ir(L205) | L205 | 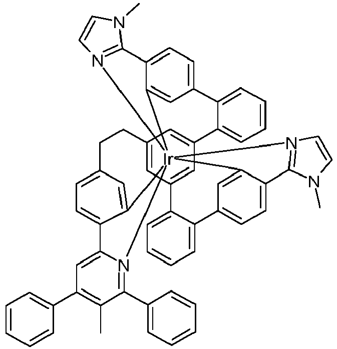 | 56% |
| Ir(L206) | L206 | 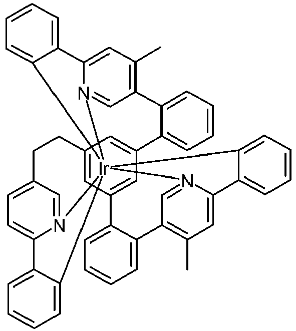 | 68% |
| Ir(L207) | L207 | 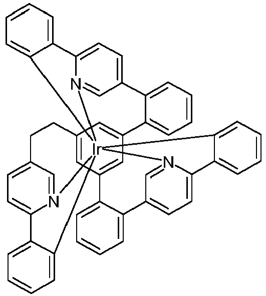 | 65% |
| Ir(L208) | L208 | 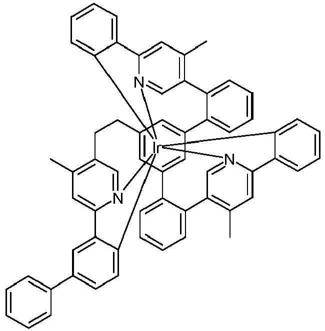 | 67% |
| Ir(L209) | L209 | 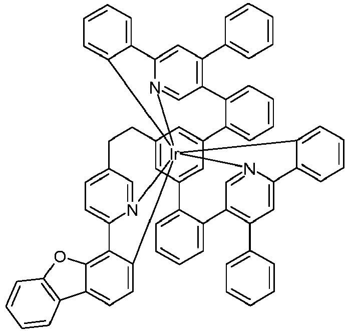 | 61% |
| Ir(L210) | L210 | 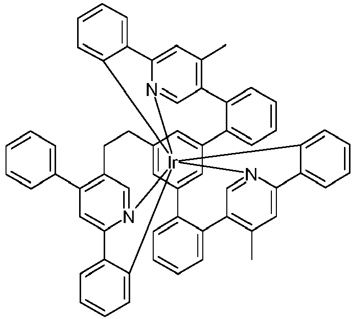 | 65% |

| | | | |
|---|---|---|---|
| * sofern abweichend | | | |

### D: Funktionalisierung der Metallkomplexe

### 1) Deuterierung von Metallkomplexen

### A) Deuterierung der Methylgruppen

1 mmol des sauberen Komplexes (Reinheit > 99.9%) mit × Methyl-/ Methylengruppen mit x = 1 - 6 wird durch Erhitzen auf ca. 180 °C in 50 ml DMSO-d6 (Deuterierungsgrad > 99.8 %) gelöst. Die Lösung wird 5 min. bei 180 °C gerühert. Man lässt die Lösung auf 80 °C erkalten und versetzt sie zügig unter gutem Rühren mit einer Mischung von 5 ml Methanol-d1 (Deuterierungsgrad > 99.8 %) und 10 ml DMSO-d6 (Deuterierungsgrad > 99.8 %), in welchem 0.3 mmol Natriumhydrid gelöst wurden. Man rührt die klare gelb-orange Lösung bei 80 °C weitere 30 min. für Komplexe mit Methyl-/Methylengruppen para zum Pyridin-Stickstoff bzw. weitere 6 h für Komplexe mit Methyl-/Methylengruppen meta zum Pyridin-Stickstoff nach, kühlt dann mit Hilfe eines Kaltwasserbades ab, versetzt tropfenweise ab ca. 60 °C mit 20 ml 1N DCI in D₂O, lässt auf Raumtemperatur erkalten, rührt 5 h nach, saugt vom Feststoff ab und wäscht diesen dreimal mit je 10 ml H₂O/MeOH (1:1, vv) und dann dreimal mit je 10 ml MeOH und trocknet im Vakuum. Der Feststoff wird in DCM gelöst, die Lösung über Kieselgel filtriert, das Filtrat im Vakuum eingeengt und gleichzeitig tropfenweise mit MeOH versetzt und dadurch zur Kristallisation gebracht. Abschließend wird fraktioniert sublimiert, wie unter "C: Darstellung der Metallkomplexe, Variante A" beschrieben. Ausbeute: typischerweise 80-90%, Deuterierungsgrad > 95%.

In DMSO schwer lösliche Komplexe können auch nach einem Heißextraktionsverfahren deuteriert werden. Dazu wird der Komplex einer kontinuierlichen Heißextraktion mit THF-H8 unterzogen, wobei in der Vorlage ein Gemisch aus THF-H8 (ca. 100-300 ml/mmol), 10-100 mol eq Methanol-D1 (H₃COD) und 0.3 -3 mol eq Natriummethanolat (NaOCHs) pro auszutauschender azider CH-Einheit vorgelegt wird. Ausbeute: typischerweise 80-90%, Deuterierungsgrad > 95%.

Um höhere Deuterierungsgrade zu erlangen, kann die Deuterierung eines Komplexes mit jeweils frischen Deuterierungsagentien auch mehrfach hintereinander durchgeführt werden.

Analog können folgende deuterierte Komplexe dargestellt werden:

| Bsp. | Edukt | Produkt | Ausbeute |
|---|---|---|---|
| Ir(L10-D3) | Ir(L10) | 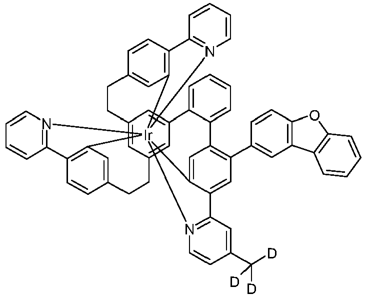 | 90% |
| Ir(L11-D9) | Ir(L1 1) | 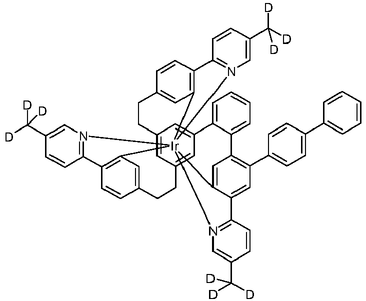 | 89% |
| Ir(L23-D10) | Ir(L23) | 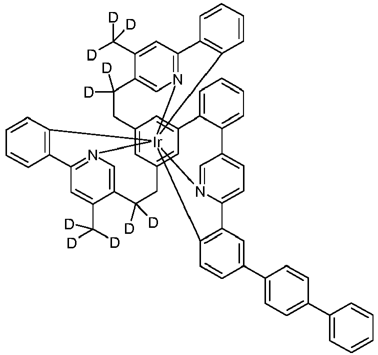 | 88% |
| Ir(L28-D10) | Ir(L28) | 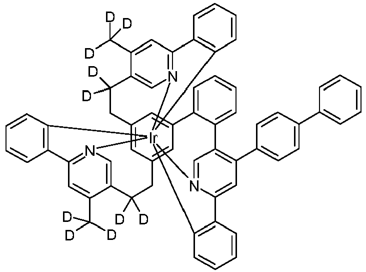 | 91% |
| Ir(L153-D11) | Ir(L153-D8) | 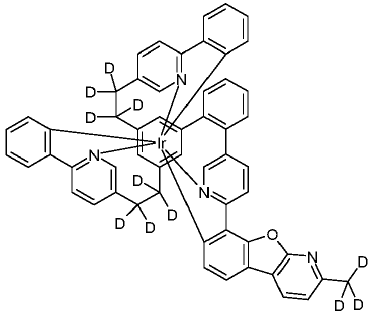 | 93% |
| Ir(L154-D17) | Ir(L154-D8) | 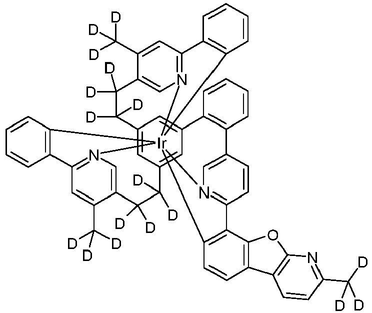 | 89% |

### B) Deuterierung der Alkylgruppen und Kern-Deuterierung am Pyridin

Durchführung wie unter A) beschrieben, wobei 3 mmol NaH eingesetzt werden und die Reaktion statt bei 80 °C bei 120°C für 16 h geführt wird. Ausbeute typischerweise 80-90%.

Auf die oben beschriebene Weise können folgende deuterierte Komplexe dargestellt werden:

| Bsp. | Edukt | Produkt | Ausbeute |
|---|---|---|---|
| Ir(L1-D17) | Ir(L1) | 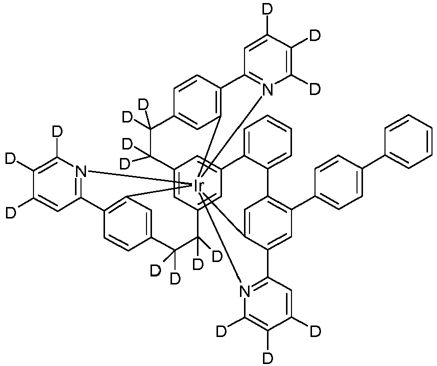 | 90% |

### 2) Bromierung der Metallkomplexe

Eine Lösung bzw. Suspension von 10 mmol eines Komplexes, der in para-Position zum Iridium A x C-H-Gruppen (mit A = 1, 2, 3) trägt, in 500 ml bis 2000 ml Dichlormethan, je nach Löslichkeit der Metallkomplexe, wird unter Licht- und Luftausschluss bei -30 bis +30 °C mit A x 10.5 mmol N-Halogen-succinimid (Halogen: Cl, Br, I) versetzt und 20 h gerührt. In DCM schlecht lösliche Komplexe können auch in anderen Lösungsmitteln (TCE, THF, DMF, Chlorbenzol, etc.) und bei erhöhter Temperatur umgesetzt werden. Anschließend wird das Lösungsmittel im Vakuum weitgehend entfernt. Der Rückstand wird mit 100 ml Methanol ausgekocht, der Feststoff wird abgesaugt, dreimal mit 30 ml Methanol gewaschen und dann im Vakuum getrocknet. Man erhält so die in para-Position zum Iridium bromierten Iridiumkomplexe. Komplexe mit einem HOMO (CV) von ca. -5.1 bis -5.0 eV und betragsmäßig kleiner neigen zur Oxidation (Ir(III) → Ir(IV)), wobei das Oxidationsmittel Brom, freigesetzt aus NBS, ist. Diese Oxidationsreaktion ist durch eine deutliche Grünfärbung der ansonsten gelben bis roten Lösungen bzw. Suspensionen der Emitter zu erkennen. In solchen Fällen wird ein weiteres Äquivalent NBS zugesetzt. Zur Aufarbeitung setzt man 300-500 ml Methanol und 2 ml Hydrazin Hydrat als Reduktionsmittel zu, wodurch sich die grünen Lösungen bzw. Suspensionen gelb verfärben (Reduktion Ir(IV) → Ir(III). Dann zieht man im Vakuum das Lösungsmittel weitgehend ab, versetzt mit 300 ml Methanol, saugt den Feststoff ab, wäscht dreimal mit je 100 ml Methanol und trocknet im Vakuum.

Unterstöchiometrische Bromierungen, z. B. Mono- und Dibromierungen von Komplexen mit 3 C-H-Gruppen para-Position zum Iridium, verlaufen meist weniger selektiv als die stöchiometrischen Bromierungen. Die Rohprodukte dieser Bromierungen können chromatographisch (CombiFlash Torrent der Fa. A. Semrau) getrennt werden.

### Synthese von Ir(L1-2Br):

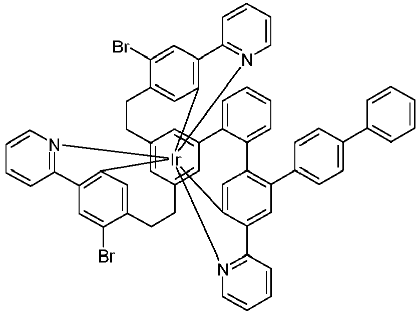

Eine bei 0 °C gerührte Suspension von 10.1 g (10 mmol) Ir(L1) in 500 ml DCM wird auf einmal mit 3.7 g (21.0 mmol) N-Bromsuccinimid versetzt und dann weitere 20 h gerührt. Nach Entfernen von ca. 450 ml des DCMs im Vakuum wird die gelbe Suspension mit 100 ml Methanol versetzt, der Feststoff wird abgesaugt, dreimal mit ca. 50 ml Methanol gewaschen und dann im Vakuum getrocknet. Ausbeute: 11.3 g (9.6 mmol), 96 %; Reinheit: > 99.0 %ig nach NMR.

Analog können folgende Verbindungen dargestellt werden:

| Bsp. | Edukt Brom ierungsprodukt | Ausbeute |
|---|---|---|
| Ir(L6-2Br) | Ir(L6) | 94% |
| | 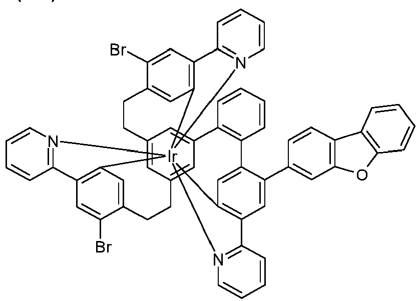 | |
| Ir(L8-2Br) | Ir(L8) | 93% |
| | 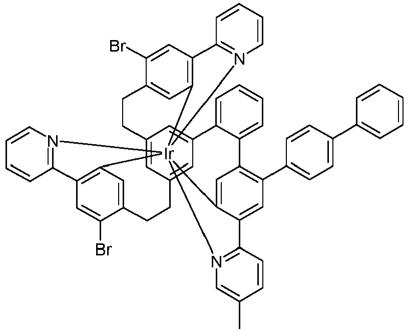 | |
| Ir(L14-3Br) | Ir(L14) | 94% |
| | 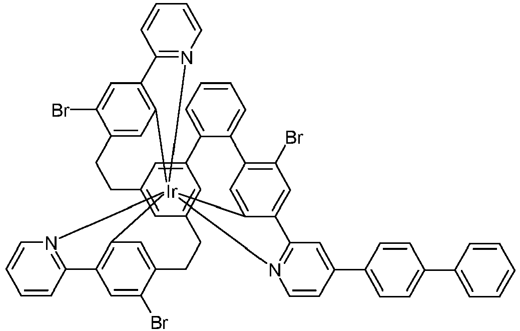 | |
| Ir(L19-2Br) | Ir(L19) | 90% |
| | 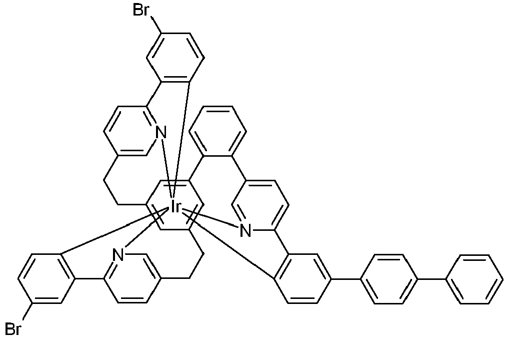 | |
| Ir(L28-3Br) | Ir(L28) | 90% |
| | 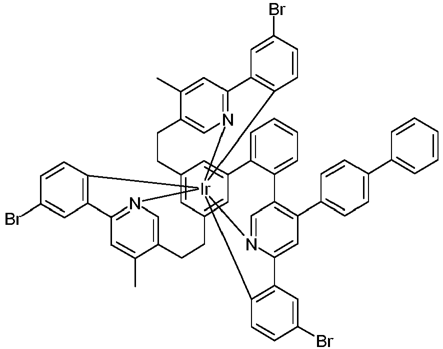 | |
| Ir(L100-3Br) | Ir(L100) | 93% |
| | 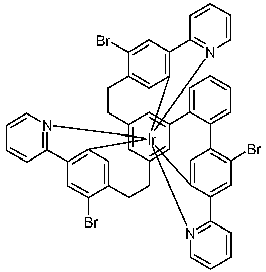 | |
| Ir(L200-3Br) | Ir(L200) | 90% |
| | 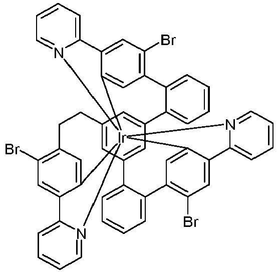 | |
| Ir(L123-2Br) | Ir(L123) | 93% |
| | 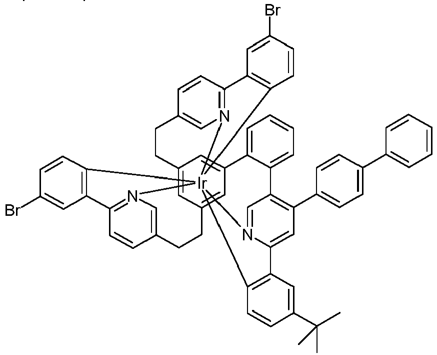 | |
| Ir(L124-3Br) | Ir(L124) | 90% |
| | 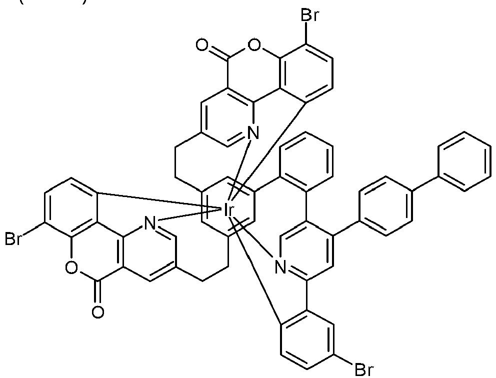 | |
| Ir(L136-D8-Br) | Ir(L136-D8) | 75% |
| | 1 eq NBS | |
| | 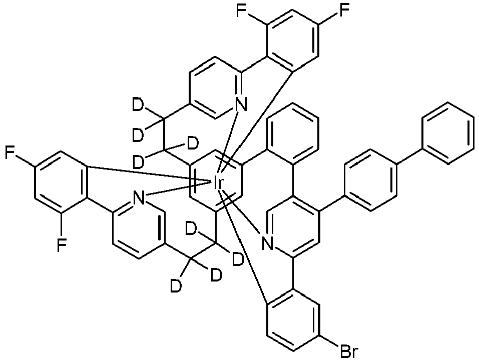 | |

### 3) Cyanierung der Metallkomplexe

Ein Gemisch aus 10 mmol des bromierten Komplexes, 20 mmol Kupfer(I)-cyanid pro Brom-Funktion und 300 ml NMP wird 40 h bei 180 °C gerührt. Nach Erkalten entfernt man das Lösungsmittel im Vakuum, nimmt den Rückstand in 500 ml Dichlormethan auf, filtriert über Celite von den Kupfersalzen ab, engt das Dichlormethan im Vakuum fast bis zur Trockene ein, gibt 100 ml Ethanol zu, saugt vom ausgefallenen Feststoff ab, wäscht diesen zweimal mit je 50 ml Ethanol und trocknet im Vakuum. Das Rohprodukt wird durch Chromatographie und/oder Heißextraktion gereinigt. Das Tempern erfolgt im Hochvakuum (p ca. 10⁻⁶ mbar) im Temperaturbereich von ca. 200-300 °C. Die Sublimation erfolgt im Hochvakuum (p ca. 10⁻⁶ mbar) im Temperaturbereich von ca. 350-450 °C, wobei die Sublimation bevorzugt in Form einer fraktionierten Sublimation durchgeführt wird.

### Synthese von Ir(L1-2CN):

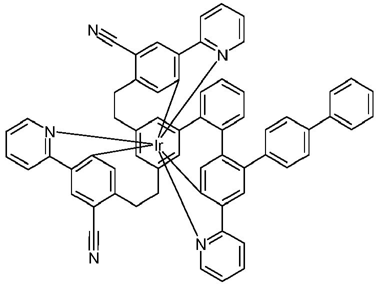

Einsatz von 11.7 g (10 mmol) Ir(L1-2Br) und 3.6 g (40 mmol) Kupfer(I)-cyanid. Chromatographie an Kieselgel mit Dichlormethan, sechsmalige Heißextraktion mit Dichlormethan/Acetonitril (2:1 vv), Sublimation. Ausbeute: 6.4 g (6.0 mmol), 60 %; Reinheit: ca. 99.9 %ig nach HPLC.

Analog können folgende Verbindungen dargestellt werden:

| Bsp. | Edukt Cyanierungsprodukt | Ausbeute |
|---|---|---|
| Ir(L6-2CN) | Ir(L6-2Br) | 57% |
| | 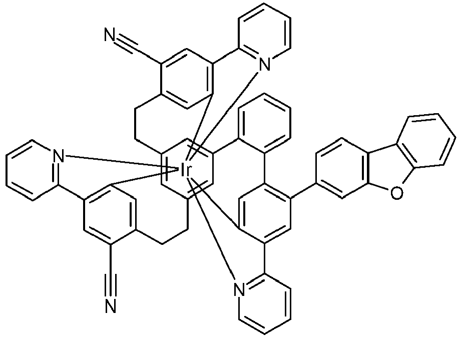 | |
| Ir(L200-3CN) | Ir(L200-3Br) | 58% |
| | 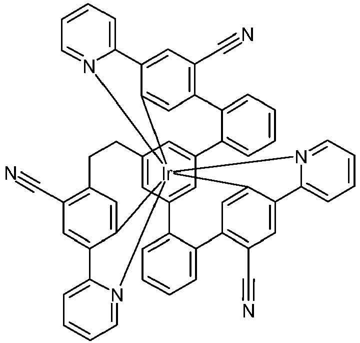 | |
| Ir(L123-2CN) | 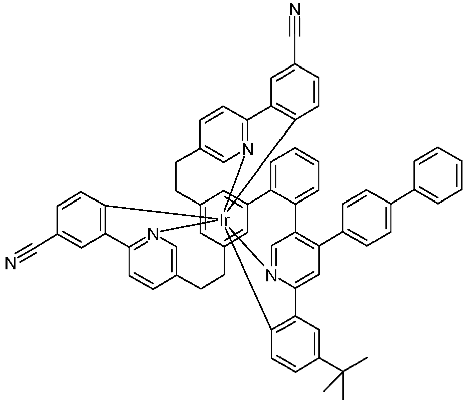 | 53% |
| Ir(L124-3CN) | 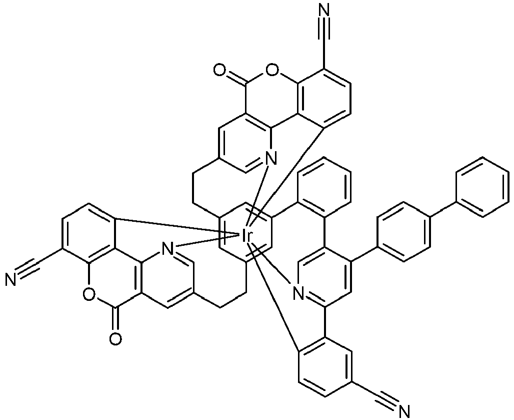 | 41% |
| Ir(L136-D8-CN) | 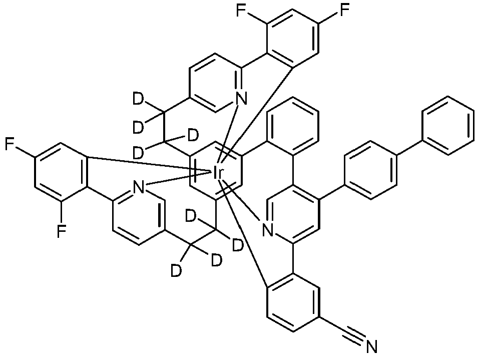 | 61% |

### 4) Suzuki-Kupplung an den bromierten Iridium-Komplexen

### Variante A, zweiphasige Reaktionsmischung

Eine Suspension von 10 mmol eines bromierten Komplexes, 12-20 mmol Boronsäure bzw. Boronsäureester pro Br-Funktion und 40-80 mmol Trikaliumphosphat in einem Gemisch aus 300 ml Toluol, 100 ml Dioxan und 300 ml Wasser wird mit 0.6 mmol Tri-o-tolylphosphin und dann mit 0.1 mmol Palladium(II)acetat versetzt und 16 h unter Rückfluss erhitzt. Nach Erkalten gibt man 500 ml Wasser und 200 ml Toluol zu, trennt die wässrige Phase ab, wäscht die organische Phase dreimal mit 200 ml Wasser und einmal mit 200 ml gesättigter Kochsalzlösung und trocknet über Magnesiumsulfat. Man filtriert über ein Celite-Bett ab, wäscht dieses mit Toluol nach, entfernt das Toluol fast vollständig im Vakuum, gibt 300 ml Methanol zu, saugt vom ausgefallenen Rohprodukt ab, wäscht dieses dreimal mit je 50 ml Methanol und trocknet im Vakuum. Das Rohprodukt wird an Kieselgel gesäult. Der Metallkomplex wird abschließend getempert oder sublimiert. Das Tempern erfolgt im Hochvakuum (p ca. 10⁻⁶ mbar) im Temperaturbereich von ca. 200-300 °C. Die Sublimation erfolgt im Hochvakuum (p ca. 10⁻⁶ mbar) im Temperaturbereich von ca. 300-400 °C, wobei die Sublimation bevorzugt in Form einer fraktionierten Sublimation durchgeführt wird.

### Variante B, einphasige Reaktionsmischung:

Eine Suspension von 10 mmol eines bromierten Komplexes, 12-20 mmol Boronsäure bzw. Boronsäureester pro Br-Funktion und 60-100 mmol der Base (Kaliumfluorid, Trikaliumphosphat (wasserfrei oder Monohydrat oder Trihydrat), Kaliumcarbonat, Cäsiumcarbonat etc.) und 100 g Glaskugeln (3 mm Durchmesser) in 100-500 ml eines aprotischen Lösungsmittels (THF, Dioxan, Xylol, Mesitylen, Dimethylacetamid, NMP, DMSO, etc.) wird mit 0.6 mmol Tri-o-tolylphosphin und dann mit 0.1 mmol Palladium(II)-acetat versetzt und 1-24 h unter Rückfluss erhitzt. Alternativ können andere Phosphine wie Triphenylphosphin, Tri-tert-butylphosphin, Sphos, Xphos, RuPhos, XanthPhos, etc. eingesetzt werden, wobei bei diesen Phosphinen das bevorzugte Phosphin:Palladium Verhältnis 3:1 bis 1.2:1 beträgt. Man entfernt das Lösungsmittel im Vakuum, nimmt das Produkt in einem geeigneten Lösungsmittel (Toluol, Dichlormethan, Ethylacetat, etc.) auf und reinigt wie unter Variante A beschrieben.

### Synthese von Ir1:

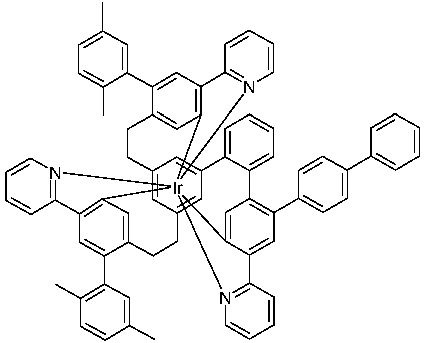

### Variante A:

Einsatz von 11.7 g (10.0 mmol) Ir(L1-2Br), 6.0 g (40.0 mmol) 2,5-Dimethylphenylboronsäure [85199-06-0], 17.7 g (60 mmol) Trikaliumphosphat (wasserfrei), 183 mg (0.6 mmol) Tri-o-tolylphosphin [6163-58-2], 23 mg (0.1 mmol) Palladium(II)acetat , 300 ml Toluol, 100 ml Dioxan und 300 ml Wasser, Rückfluss, 16 h. Zweimalige chromatographische Trennung an Kieselgel mit Toluol/Ethylacetat (9:1, vv), anschließend fünfmalige Heißextraktion mit Ethylacetat/Dichlormethan (1:1, vv). Ausbeute: 8.1 g (6.6 mmol), 66 %; Reinheit: ca. 99.9 %ig nach HPLC.

Analog können folgende Verbindungen dargestellt werden:

| Bsp. | Bromid / Boronsäure / Variante Produkt | Ausbeute |
|---|---|---|
| Ir2 | Ir(L8-2Br) / [5122-95-2] / A | 70% |
| | 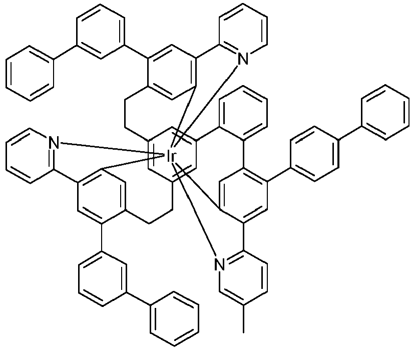 | |
| Ir3 | Ir(L14-3Br) / 1313018-07-3 / B, DMSO, K₃PO₄ x H₂0, Pd(ac)₂: Triphenyphosphin 1:3 | 62% |
| | 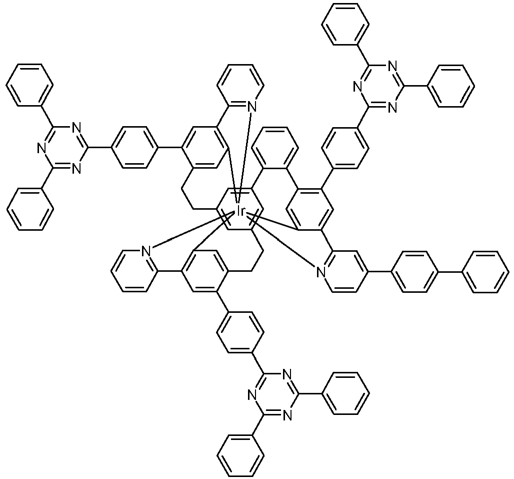 | |
| Ir4 | Ir(L19-2Br) / [854952-58-2] / A | 74% |
| | 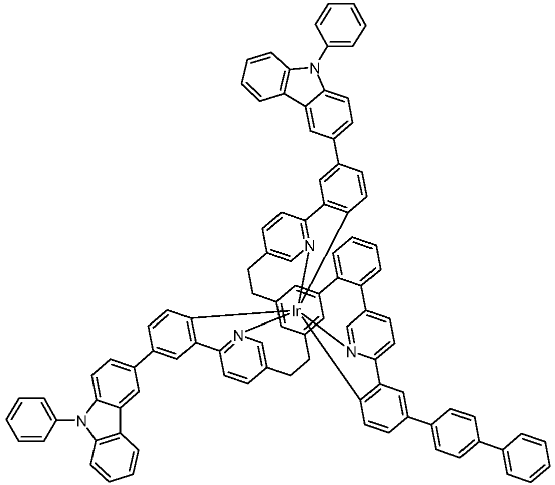 | |
| Ir5 | Ir(L28-3Br) / [100124-06-9] / A | 56% |
| | 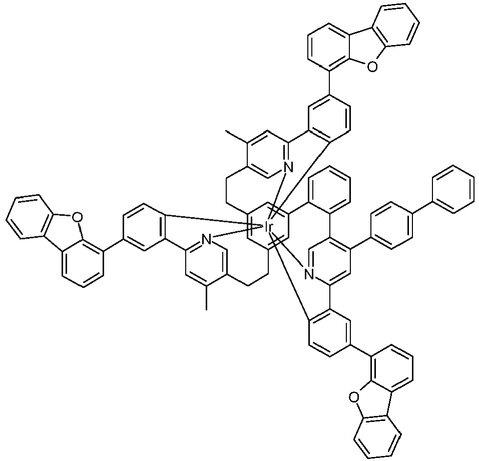 | |
| Ir6 | Ir(L100-3Br) / [5122-95-2] / A | 68% |
| | 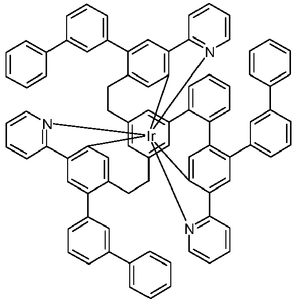 | |
| Ir7 | Ir(L200-3Br) / [1703019-86-6] / A | 60% |
| | 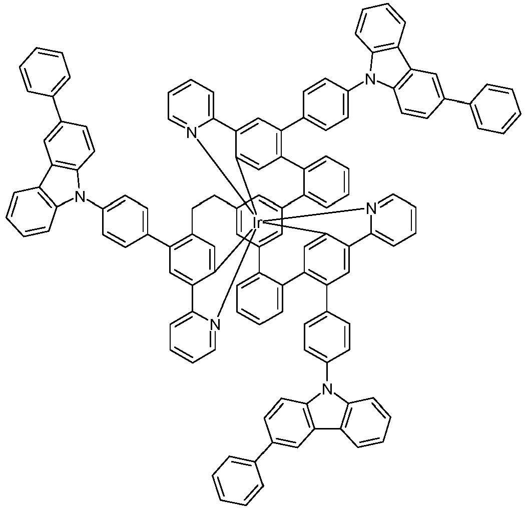 | |

Analog können di-, tri-, oligo-Phenylen-, Fluoren-, Carbazol-, Dibenzofuran-, Dibenzothiophen, Dibenzothiophen-11-dioxid-, Indenocarbazol- bzw. Indolocarbazol-Boronsäuren bzw. Boronester umgesetzt werden. Die Reinigung der Kupplungsprodukte erfolgt durch Umfällen des Rohproduktes aus DCM in Methanol oder durch Chromatographie, FlashChromatographie oder Gel-Permeations-Chromatographie. Einige Beispiele für geeignete Boronsäuren bzw. Boronsäureester sind in nachfolgender Tabelle in Form der CAS-Nummern aufgeführt:

| Beispiel | CAS | Beispiel | CAS |
|---|---|---|---|
| 1 | 1448677-51-7 | 11 | 1308841-85-1 |
| 2 | 1899022-50-4 | 12 | 2182638-63-5 |
| 3 | 1448677-51-7 | 13 | 2159145-70-5 |
| 4 | 881913-00-4 | 14 | 2101985-67-3 |
| 5 | 2247552-50-5 | 15 | 400607-34-3 |
| 6 | 491880-61-6 | 16 | 2007912-79-8 |
| 7 | 1643142-51-1 | 17 | 1356465-28-5 |
| 8 | 1443276-75-2 | 18 | 1788946-55-3 |
| 9 | 1056044-55-3 | 19 | 2226968-34-7 |
| 10 | 1622168-79-9 | 20 | 1646636-93-2 |

### 5) Ullmann-Kupplung an den bromierten Iridium-Komplexen

Eine gut gerührte Suspension von 10 mmol eines bromierten Komplexes, 30 mmol des Carbazols pro Br-Funktion, 30 mmol Kaliumcarbonat pro Br-Funktion, 30 mmol Natriumsulfat pro Br-Funktion, 10 mmol Kupferpulver pro Br-Funktion, 150 ml Nitrobenzol und 100 g Glaskugeln (3 mml Durchmesser) wird 18 h auf 210 °C erhitzt. Nach Erkalten gibt man 500 ml MeOH zu, saugt vom Feststoff und den Salzen ab, wäscht dreimal mit je 50 ml MeOH nach und trocknet im Vakuum. Man suspendiert den Feststoff in 500 ml DCM, rührt 1 h bei Raumtemperatur und flitriert dann über ein mit DCM vorgeschlämmtes Kieselgel-Bett. Man fügt 100 ml MeOH zum Filtrat zu, engt dann am Rotationsverdampfer zu einem Brei ein, saugt das Rohprodukt ab und wäscht dieses dreimal mit je 50 ml MeOH. Man zieht das Rohprodukt mit DCM auf 300 g Kieselgel auf, packt das beladene Kieselgel auf ein mit Ethylacetat vorgeschlämtes Kieselgel-Bett, eluiert mit Ethylacetat überschüssiges Carbazol, stellt dann auf DCM um und eluiert das Produkt. Das so erhaltene Rohprodukt wird erneut an Kieselgel mit DCM gesäult. Die weitere Reinigung erfolgt durch Heißextraktion, z. B. mit DCM / Acetonitril. Der Metallkomplex wird abschließend getempert oder sublimiert. Das Tempern erfolgt im Hochvakuum (p ca. 10⁻⁶ mbar) im Temperaturbereich von ca. 200-350 °C. Die Sublimation erfolgt im Hochvakuum (p ca. 10⁻⁶ mbar) im Temperaturbereich von ca. 350-450 °C, wobei die Sublimation bevorzugt in Form einer fraktionierten Sublimation durchgeführt wird.

### Synthese von Ir50:

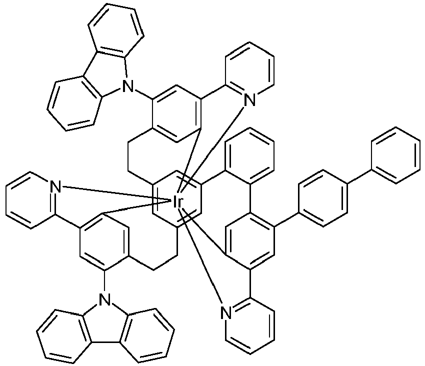

Einsatz von 11.7 g (10 mmol) Ir(L1-2Br), 10.0 g (60 mmol) Carbazol, 8.3 g (60 mmol) Kaliumcarbonat, 8.5 g (60 mmol) Natriumsulfat, 1.3 g (20 mmol) Kupferpulver. Aufarbeitung wie oben beschrieben. Fünfmalige Heißextraktion mit Dichlormethan/Acetonitril (1:1, vv). Ausbeute: 8.4 g (6.2 mmol), 62 %; Reinheit: ca. 99.9 %ig nach HPLC.

Analog können folgende Verbindungen dargestellt werden:

| Bsp. | Edukte Produkt | Ausbeute |
|---|---|---|
| Ir51 | Ir(L8-2Br) / [103012-26-6] | 67% |
| | 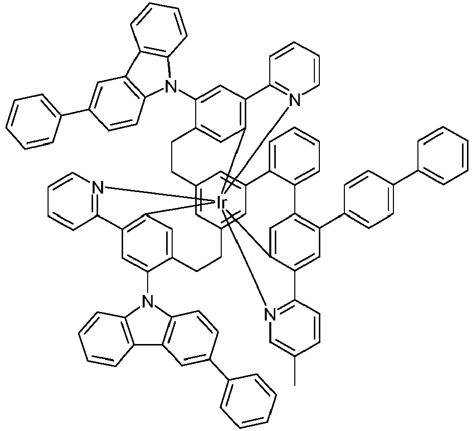 | |
| Ir52 | Ir(L14-3Br) / [1257220-47-5] | 61% |
| | 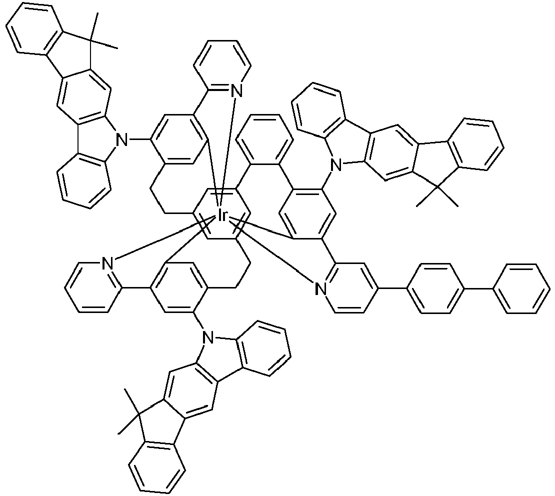 | |
| Ir53 | Ir(L28-3Br) / [88590-005] | 66% |
| | 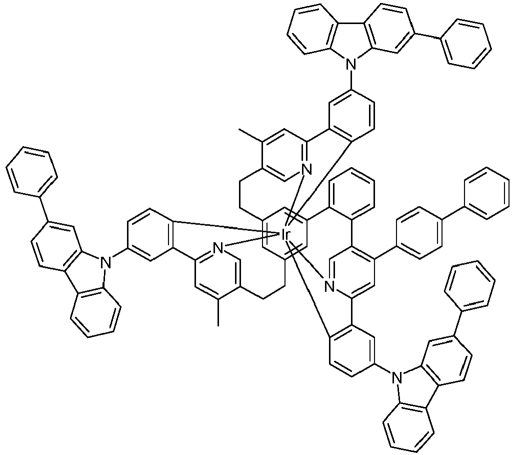 | |
| Ir54 | Ir(L200-3Br) / [244-69-9] | 60% |
| | 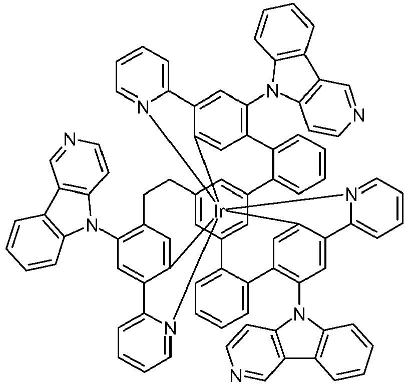 | |

### Synthese von Ir60:

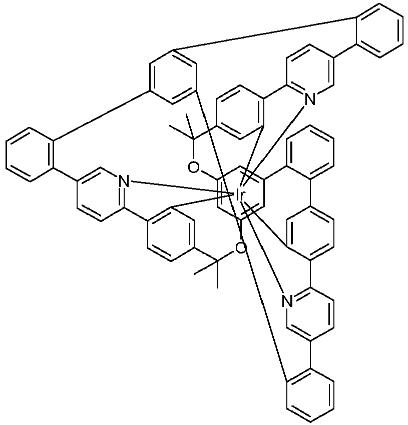

Eine auf -78 °C gekühlte Lösung von 5.43 g (10 mmol) 2,2"-Dibromo-5'-(2-bromophenyl)-1,1':3',1"-terphenyl [380626-56-2] in 200 ml THF wird tropfenweise mit 18.8 ml (30 mmol) n-Butyllithium, 1.6 N in n-Hexan, versetzt und 1 h bei -78 °C nachgerührt. Dann gibt man unter gutem Rühren eine auf -78 °C vorgekühlte Lösung von 9.22 g (10 mmol) Ir(L149) in 200 ml THF zügig zu, rührt 2 h bei -78 °C nach und lässt dann langsam auf Raumtemperatur erwärmen. Man entfernt das Lösungsmittel im Vakuum und chromatographiert den Rückstand zweimal mit Toluol/DCM (8:2 vv) an Kieselgel. Der Metallkomplex wird abschließend im Hochvakuum (p ca. 10⁻⁶ mbar) im Temperaturbereich von ca. 300-350 °C getempert. Ausbeute 2.9 g (2.4 mmol), 24%. Reinheit: ca. 99.7 %ig n. 1H-NMR.

### Synthese von Komplexen mit Spirobrücke:

### A) Einführung am Iridiumkomplex

Die Einführung von Spiro-Ringen in die verbrückenden Einheiten der Komplexe kann am Komplex selbst, durch eine Lithiierung - Alkylierung - Lithierung - intramolekulare Alkylierung-Sequenz mit α-ω-Dihalogenalkanen als Elektrophil, erfolgen (siehe nachfolgendes Schema).

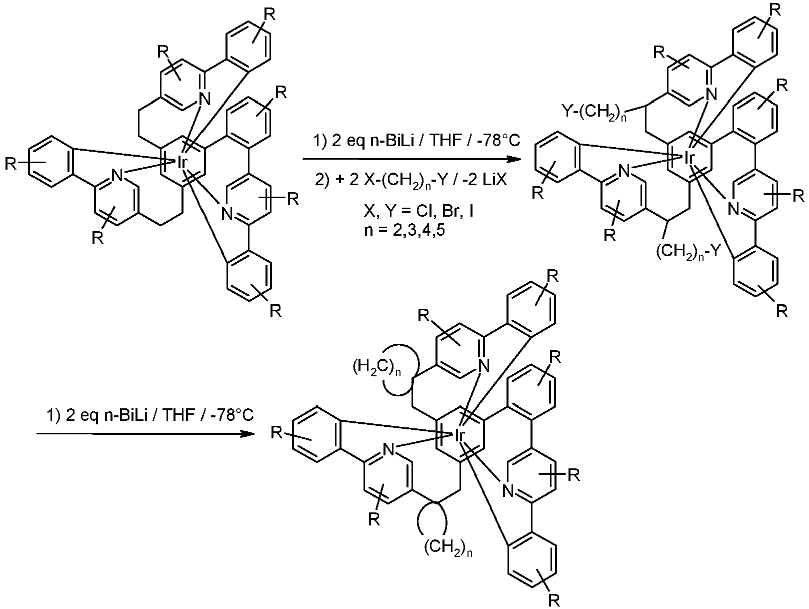

### B) Einführung während der Ligandensynthese

Die Einführung von Spiro-Ringen in die verbrückenden Einheiten der Komplexe kann alternativ auch durch Synthese geeigneter Liganden, die Spiro-Ringe aufweisen, und anschließende o-Metallierung dieser erfolgen. Dabei werden die Spiro-Ringe via Suzki-Kupplung (s. van den Hoogenband, Adri et al. Tetrahedron Lett., 49, 4122, 2008) mit den entsprechenden bidentaten Teilliganden verknüpft (s. Schritt 1 des nachfolgenden Schemas). Die übrige Synthese erfolgt nach literaturbekannten und oben schon detailliert ausgeführten Techniken.

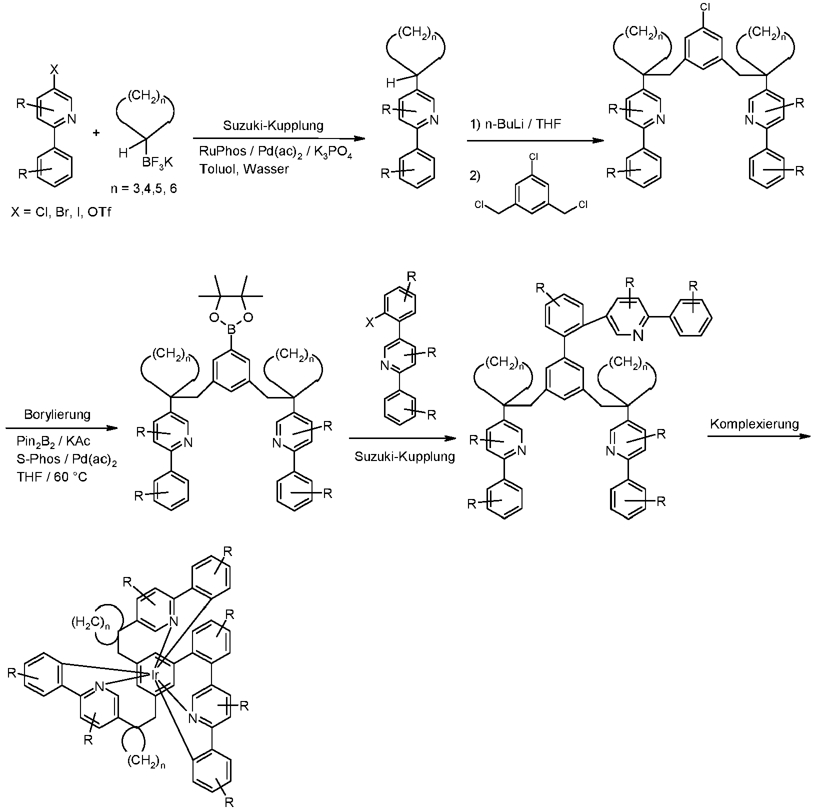

### Beispiel: Herstellung der OLEDs

### 1) Vakuum-prozessierte Devices:

Die Herstellung von erfindungsgemäßen OLEDs sowie OLEDs nach dem Stand der Technik erfolgt nach einem allgemeinen Verfahren gemäß WO 2004/058911, das auf die hier beschriebenen Gegebenheiten (Schichtdickenvariation, verwendete Materialien) angepasst wird.

In den folgenden Beispielen werden die Ergebnisse verschiedener OLEDs vorgestellt. Gereinigte Glasplättchen (Reinigung in Miele Laborspülmaschine, Reiniger Merck Extran), die mit strukturiertem ITO (Indium Zinn Oxid) der Dicke 50 nm beschichtet sind, werden 25 Minuten mit UV-Ozon vorbehandelt (UV-Ozon Generator PR-100, Firma UVP) und innerhalb 30 min. zur verbesserten Prozessierung mit 20 nm PEDOT:PSS beschichtet (Poly(3,4-ethylendioxythiophen)poly(styrolsulfonat), bezogen als CLEVIOS^{™} P VP AI 4083 von Heraeus Precious Metals GmbH Deutschland, aus wässriger Lösung aufgeschleudert) und anschließend bei 180 °C 10 min. lang ausgeheizt. Diese beschichteten Glasplättchen bilden die Substrate, auf welche die OLEDs aufgebracht werden.

Die OLEDs haben prinzipiell folgenden Schichtaufbau: Substrat / Lochinjektionsschicht 1 (HIL1 ) bestehend aus HTM1 dotiert mit 5 % NDP-9 (kommerziell erhältlich von der Fa. Novaled), 20 nm / Lochtransportschicht 1 (HTL1) bestehend aus HTM1, 220 nm für grüne/gelbe Devices, 110 nm für rote Devices / Lochtransportschicht 2 (HTL2) / Emissionsschicht (EML) / Lochblockierschicht (HBL) / Elektronentransportschicht (ETL) / optionale Elektroneninjektionsschicht (EIL) und abschließend eine Kathode. Die Kathode wird durch eine 100 nm dicke Aluminiumschicht gebildet.

Zunächst werden vakuum-prozessierte OLEDs beschrieben. Hierfür werden alle Materialien in einer Vakuumkammer thermisch aufgedampft. Dabei besteht die Emissionsschicht immer aus mindestens einem Matrixmaterial (Hostmaterial, Wirtsmaterial) und einem emittierenden Dotierstoff (Dotand, Emitter), der dem Matrixmaterial bzw. den Matrixmaterialien durch Co-Verdampfung in einem bestimmten Volumenanteil beigemischt wird. Eine Angabe wie M1:M2:Ir(L1) (55%:35%:10%) bedeutet hierbei, dass das Material M1 in einem Volumenanteil von 55%, M2 in einem Volumenanteil von 35% und Ir(L1) in einem Volumenanteil von 10% in der Schicht vorliegt. Analog kann auch die Elektronentransportschicht aus einer Mischung zweier Materialien bestehen. Der genaue Aufbau der OLEDs ist Tabelle 1 zu entnehmen. Die zur Herstellung der OLEDs verwendeten Materialien sind in Tabelle 4 gezeigt.

Die OLEDs werden standardmäßig charakterisiert. Hierfür werden die Elektrolumineszenzspektren, die Stromeffizienz (gemessen in cd/A), die Leistungseffizienz (gemessen in Im/W) und die externe Quanteneffizienz (EQE, gemessen in Prozent) in Abhängigkeit der Leuchtdichte, berechnet aus Strom-Spannungs-Leuchtdichte-Kennlinien (IUL-Kennlinien) unter Annahme einer lambertschen Abstrahlcharakteristik sowie die Lebensdauer bestimmt. Die Elektrolumineszenzspektren werden bei einer Leuchtdichte von 1000 cd/m² bestimmt und daraus die CIE 1931 x und y Farbkoordinaten berechnet. Als Lebensdauer LD90 wird die Zeit definiert, nach der die Leuchtdichte bei Betrieb mit einer Starthelligkeit von 10000 cd/m² auf 90% der Startleuchtdichte abgesunken ist.

Die OLEDs können initital auch bei anderen Startleuchtdichten betrieben werden. Die Werte für die Lebensdauer können dann mit Hilfe dem Fachmann bekannten Umrechnungsformeln auf eine Angabe für andere Startleuchtdichten umgerechnet werden.

### Verwendung von erfindungsgemäßen Verbindungen als Emittermaterialien in phosphoreszierenden OLEDs

Die erfindungsgemäßen Verbindungen lassen sich unter anderem als phosphoreszierende Emittermaterialien in der Emissionsschicht in OLEDs einsetzen. Als Vergleich gemäß dem Stand der Technik werden die Iridium-Verbindungen gemäß Tabelle 4 verwendet. Die Ergebnisse der OLEDs sind in Tabelle 2 zusammengefasst.

**Tabelle 1: Aufbau der OLEDs**

| **Bsp.** | **HTL2** | **EML** | **HBL** | **ETL** |
|---|---|---|---|---|
| | **Dicke** | **Dicke** | **Dicke** | **Dicke** |
| Ref.D1 | HTM2 | M1:M2:Ir-Ref.1 | ETM1 | ETM1:ETM2 |
| | | (55%:30%:15%) | | (50%:50%) |
| | 10 nm | 30 nm | 10nm | 30 nm |
| Ref. D2 | HTM2 | M1:M2:Ir-Ref.2 | ETM1 | ETM1:ETM2 |
| | | (55%:30%:15%) | | (50%:50%) |
| | 10 nm | 30 nm | 10nm | 30 nm |
| Ref.D3 | HTM2 | M1:M2:Ir-Ref.3 | ETM1 | ETM1:ETM2 |
| | | (55%:30%:15%) | | (50%:50%) |
| | 10 nm | 30 nm | 10nm | 30 nm |
| Ref. D4 | HTM2 | M1:M2:Ir-Ref.4 | ETM1 | ETM1:ETM2 |
| | 10 nm | (55%:30%:15%) | 10nm | (50%:50%) |
| | | 30 nm | | 30 nm |
| D1 | HTM2 | M1:M2:Ir(L100) | ETM1 | ETM1:ETM2 |
| | | (55%:30%:15%) | | (50%:50%) |
| | 10 nm | 30 nm | 10nm | 30 nm |
| D2 | HTM2 | M1:M2:lr(L107) | ETM1 | ETM1:ETM2 |
| | 10 nm | (55%:30%:15%) | | (50%:50%) |
| | | 30 nm | 10nm | 30 nm |
| D3 | HTM2 | M1:M2:Ir(L200) | ETM1 | ETM1:ETM2 |
| | | (55%:30%:15%) | | (50%:50%) |
| | 10 nm | 30 nm | 10nm | 30 nm |
| D4 | HTM2 | M1:M2:Ir(L207) | ETM1 | ETM1:ETM2 |
| | | (55%:30%:15%) | | (50%:50%) |
| | 10 nm | 30 nm | 10nm | 30 nm |
| D5A | HTM2 | M1:M2:Ir(L1) | ETM1 | ETM1:ETM2 |
| | | (55%:30%:15%) | | (50%:50%) |
| | 10 nm | 30 nm | 10nm | 30 nm |
| D5B | HTM2 | M1:M7:Ir(L1) | ETM1 | ETM1:ETM2 |
| | | (49%:29%:22%) | | (50%:50%) |
| | 10 nm | 30 nm | 10nm | 30 nm |
| D5C | HTM2 | M1:M8:Ir(L1) | ETM1 | ETM1:ETM2 |
| | | (68%:25%:7%) | | (50%:50%) |
| | 10 nm | 30 nm | 10 nm | 30 nm |
| D5D | HTM2 | M1:M9:Ir(L1) | ETM1 | ETM1:ETM2 |
| | | (58%:35%:7%) | | (50%:50%) |
| | 10 nm | 30 nm | 10 nm | 30 nm |
| D5E | HTM2 | M1:M9:Ir(L1) | ETM1 | ETM1:ETM2 |
| | | (46%:50%:4%) | | (50%:50%) |
| | 10 nm | 30 nm | 10 nm | 30 nm |
| D6A | HTM2 | M1:M2:Ir(L14) | ETM1 | ETM1:ETM2 |
| | | (62%:31%:7%) | | (50%:50%) |
| | 10 nm | 30 nm | 10nm | 30 nm |
| D6B | HTM2 | M1:M2:Ir(L14) | ETM1 | ETM1:ETM2 |
| | | (59%:29%:12%) | | (50%:50%) |
| | 10 nm | 30 nm | 10nm | 30 nm |
| D6C | HTM2 | M1:M2:Ir(L14) | ETM1 | ETM1:ETM2 |
| | | (56%:27%:17%) | | (50%:50%) |
| | 10 nm | 30 nm | 10nm | 30 nm |
| D6D | HTM2 | M1:M2:Ir(L14) | ETM1 | ETM1:ETM2 |
| | | (41.5%:41.5%:17%) | | (50%:50%) |
| | 10 nm | 30 nm | 10nm | 30 nm |
| D6E | HTM2 | M1:M7:Ir(L14) | ETM1 | ETM1:ETM2 |
| | | (26%:52%:22%) | | (50%:50%) |
| | 10 nm | 30 nm | 10nm | 30 nm |
| D6F | HTM2 | M1:M11:Ir(L14) | ETM1 | ETM1:ETM2 |
| | | (26%:52%:22%) | | (50%:50%) |
| | | 30 nm | 10nm | 30 nm |
| D7 | HTM2 | M6:Ir(L30) | ETM1 | ETM1:ETM2 |
| | | (88%:12%) | | (50%:50%) |
| | 10 nm | 40 nm | 10 nm | 30 nm |
| D8A | HTM3 | M1 :M11 :lr(L43) | ETM1 | ETM1:ETM2 |
| | | (26%:52%:22%) | | (50%:50%) |
| | 10 nm | 30 nm | 10 nm | 30 nm |
| D8B | HTM3 | M1:M2:Ir(L43) | ETM1 | ETM1:ETM2 |
| | | (47%:47%:6%) | | (50%:50%) |
| | 10 nm | 30 nm | 10 nm | 30 nm |
| D9 | HTM3 | M1:M11:Ir(L25) | ETM1 | ETM1:ETM2 |
| | | (55%:27%:18%) | | (50%:50%) |
| | 10 nm | 30 nm | 10 nm | 30 nm |
| D10 | HTM3 | M1:Ir(L136) | ETM1 | ETM1:ETM2 |
| | | (80%:20%) | | (50%:50%) |
| | 10 nm | 30 nm | 10 nm | 30 nm |
| D11 | HTM3 | M1:M2:Ir(L136) | ETM1 | ETM1:ETM2 |
| | | (68%:20%:12%) | | (50%:50%) |
| | 10 nm | 30 nm | 10 nm | 30 nm |
| D12 | HTM3 | M1:Ir(L136-D8) | ETM1 | ETM1:ETM2 |
| | | (80%:20%) | | (50%:50%) |
| | 10 nm | 30 nm | 10 nm | 30 nm |
| D13 | HTM3 10 | M1:M7:Ir(L2) | ETM1 10 | ETM1:ETM2 |
| | | (57%:28%:15%) | | (50%:50%) |
| | nm | 30 nm | nm | 30 nm |
| D14 | HTM3 10 | M1:M7:Ir(L3) | ETM1 10 | ETM1:ETM2 |
| | | (57%:28%:15%) | | (50%:50%) |
| | nm | 30 nm | nm | 30 nm |
| D15 | HTM3 | M1:M7:Ir(L6) | ETM1 | ETM1:ETM2 |
| | | (57%:28%:15%) | | (50%:50%) |
| | 10 nm | 30 nm | 10 nm | 30 nm |
| D16 | HTM3 10 | M1:M7:Ir(L7) | ETM1 10 | ETM1:ETM2 |
| | | (57%:28%:15%) | | (50%:50%) |
| | nm | 30 nm | nm | 30 nm |
| D17 | HTM3 | M1:M7:Ir(L8) | ETM1 | ETM1:ETM2 |
| | | (57%:28%:15%) | | (50%:50%) |
| | 10 nm | 30 nm | 10 nm | 30 nm |
| D18 | HTM3 | M1:M7:Ir(L9) | ETM1 | ETM1:ETM2 |
| | | (57%:28%:15%) | | (50%:50%) |
| | 10 nm | 30 nm | 10 nm | 30 nm |
| D19 | HTM3 | M1:M7:Ir(L11) | ETM1 | ETM1:ETM2 |
| | | (57%:28%:15%) | | (50%:50%) |
| | 10 nm | 30 nm | 10 nm | 30 nm |
| D20 | HTM3 | M1:M11:Ir(L15) | ETM1 | ETM1:ETM2 |
| | | (26%:52%:22%) | | (50%:50%) |
| | 10 nm | 30 nm | 10 nm | 30 nm |
| D21 | HTM3 | M1:M11:Ir(L16) | ETM1 | ETM1:ETM2 |
| | | (26%:52%:22%) | | (50%:50%) |
| | 10 nm | 30 nm | 10 nm | 30 nm |
| D22 | HTM3 | M1:M11:Ir(L17) | ETM1 | ETM1:ETM2 |
| | | (26%:52%:22%) | | (50%:50%) |
| | 10 nm | 30 nm | 10 nm | 30 nm |
| D23 | HTM3 | M1:M2:Ir(L23) | ETM1 | ETM1:ETM2 |
| | | (62%:31%:7%) | | (50%:50%) |
| | 10 nm | 30 nm | 10 nm | 30 nm |
| D24 | HTM3 | M1:M11:Ir(L26) | ETM1 | ETM1:ETM2 |
| | | (55%:27%:18%) | | (50%:50%) |
| | 10 nm | 30 nm | 10 nm | 30 nm |
| D25 | HTM3 | M1:M11:lr(L27) | ETM1 | ETM1:ETM2 |
| | | (55%:27%:18%) | | (50%:50%) |
| | 10 nm | 30 nm | 10 nm | 30 nm |
| D26 | HTM3 | M1:M11:Ir(L28) | ETM1 | ETM1:ETM2 |
| | | (55%:27%:18%) | | (50%:50%) |
| | 10 nm | 30 nm | 10 nm | 30 nm |
| D27 | HTM3 | M1:M11:Ir(L29) | ETM1 | ETM1:ETM2 |
| | | (55%:27%:18%) | | (50%:50%) |
| | 10 nm | 30 nm | 10 nm | 30 nm |
| D28 | HTM2 | M6:Ir(L31) | ETM1 | ETM1:ETM2 |
| | | (95%:5%) | | (50%:50%) |
| | 10 nm | 40 nm | 10 nm | 30 nm |
| D29 | HTM3 | M1:M2:Ir(L44) | ETM1 | ETM1:ETM2 |
| | | (47%:47%:6%) | | (50%:50%) |
| | 10 nm | 30 nm | 10 nm | 30 nm |
| D30 | HTM3 | M1:M2:Ir(L42) | ETM1 | ETM1:ETM2 |
| | | (47%:47%:6%) | | (50%:50%) |
| | 10 nm | 30 nm | 10 nm | 30 nm |
| D31 | HTM3 10 | M1:M11:Ir(L113) | ETM1 10 | ETM1:ETM2 |
| | | (55%:27%:18%) | | (50%:50%) |
| | nm | 30 nm | nm | 30 nm |
| D32 | HTM3 10 | M1:M11:Ir(L114) | ETM1 10 | ETM1:ETM2 |
| | | (55%:27%:18%) | | (50%:50%) |
| | nm | 30 nm | nm | 30 nm |
| D33 | HTM3 | M1:M11:Ir(L115) | ETM1 | ETM1:ETM2 |
| | | (55%:27%:18%) | | (50%:50%) |
| | 10 nm | 30 nm | 10 nm | 30 nm |
| D34 | HTM3 | M1:M11:Ir(L118) | ETM1 | ETM1:ETM2 |
| | | (55%:27%:18%) | | (50%:50%) |
| | 10 nm | 30 nm | 10 nm | 30 nm |
| D35 | HTM3 | M1:M11:Ir(L119) | ETM1 | ETM1:ETM2 |
| | | (50%:30%:20%) | | (50%:50%) |
| | 10 nm | 30 nm | 10 nm | 30 nm |
| D36 | HTM3 10 | M1:M11:Ir(L120) | ETM1 10 | ETM1:ETM2 |
| | | (50%:30%:20%) | | (50%:50%) |
| | nm | 30 nm | nm | 30 nm |
| D37 | HTM3 | M1:M11:Ir(L122) | ETM1 | ETM1:ETM2 |
| | | (55%:27%:18%) | | (50%:50%) |
| | 10 nm | 30 nm | 10 nm | 30 nm |
| D38 | HTM3 10 nm | M1:M11:Ir(L123) | ETM1 10 nm | ETM1:ETM2 |
| | | (55%:27%:18%) | | (50%:50%) |
| | | 30 nm | | 30 nm |
| D39 | HTM3 | M1:M2:Ir(L124) | ETM1 | ETM1:ETM2 |
| | | (68%:20%:12%) | | (50%:50%) |
| | 10 nm | 30 nm | 10 nm | 30 nm |
| D40 | HTM3 | M1:M2:Ir(L124-D8) | ETM1 | ETM1:ETM2 |
| | | (68%:20%:12%) | | (50%:50%) |
| | 10 nm | 30 nm | 10 nm | 30 nm |
| D41 | HTM3 | M1:M9:Ir(L128) | ETM1 | ETM1:ETM2 |
| | | (68%:20%:12%) | | (50%:50%) |
| | 10 nm | 30 nm | 10 nm | 30 nm |
| D42 | HTM3 | M1:M2:Ir(L131) | ETM1 | ETM1:ETM2 |
| | | (62%:31%:7%) | | (50%:50%) |
| | 10 nm | 30 nm | 10 nm | 30 nm |
| D43 | HTM3 | M1:M2:Ir(L132) | ETM1 | ETM1:ETM2 |
| | | (62%:31%:7%) | | (50%:50%) |
| | 10 nm | 30 nm | 10 nm | 30 nm |
| D44 | HTM3 | M1:M2:Ir(L133) | ETM1 | ETM1:ETM2 |
| | | (62%:31%:7%) | | (50%:50%) |
| | 10 nm | 30 nm | 10 nm | 30 nm |
| D45 | HTM3 | M1:M2:Ir(L133-D8) | ETM1 | ETM1:ETM2 |
| | | (62%:31%:7%) | | (50%:50%) |
| | 10 nm | 30 nm | 10 nm | 30 nm |
| D46 | HTM3 10 | M1:M2:Ir(L137) | ETM1 | ETM1:ETM2 |
| | | (62%:31%:7%) | | (50%:50%) |
| | nm | 30 nm | 10 nm | 30 nm |
| D47 | HTM3 10 | M1:M2:Ir(L138) | ETM1 | ETM1:ETM2 |
| | | (62%:31%:7%) | | (50%:50%) |
| | nm | 30 nm | 10 nm | 30 nm |
| D48 | HTM3 | M1:M2:Ir(L139) | ETM1 | ETM1:ETM2 |
| | | (62%:31%:7%) | | (50%:50%) |
| | 10 nm | 30 nm | 10 nm | 30 nm |
| D49 | HTM3 | M1:M11:Ir(L28-D10) | ETM1 | ETM1:ETM2 |
| | | (55%:27%:18%) | | (50%:50%) |
| | 10 nm | 30 nm | 10 nm | 30 nm |
| D50 | HTM3 | M1:M2:lr(L123-2CN) | ETM1 | ETM1:ETM2 |
| | | (60%:30%:10%) | | (50%:50%) |
| | 10 nm | 30 nm | 10 nm | 30 nm |
| D51 | HTM3 | M1:M2:Ir(L145) | ETM1 | ETM1:ETM2 |
| | | (60%:30%:10%) | | (50%:50%) |
| | 10 nm | 30 nm | 10 nm | 30 nm |
| D52 | HTM3 10 | M1:M2:Ir(L153-D11) | ETM1 | ETM1:ETM2 |
| | | (60%:30%:10%) | | (50%:50%) |
| | nm | 30 nm | 10 nm | 30 nm |
| D53 | HTM3 | M1:M2:Ir(L154-D17) | ETM1 | ETM1:ETM2 |
| | | (60%:30%:10%) | | (50%:50%) |
| | 10 nm | 30 nm | 10 nm | 30 nm |

**Tabelle 2: Ergebnisse der Vakuum-prozessierten OLEDs**

| **Bsp.** | **EQE (%) 1000 cd/m²** | **Spannung (V) 1000 cd/m²** | **CIE x/y 1000 cd/m²** | **LD90 (h) 10000 cd/m²** |
|---|---|---|---|---|
| Ref.DI | 20.0 | 3.1 | 0.32/0.64 | 260 |
| Ref.D2 | 19.7 | 3.1 | 0.40/0.59 | 190 |
| Ref.D3 | 18.8 | 3.2 | 0.32/0.62 | 170 |
| Ref.D4 | 18.6 | 3.2 | 0.30/0.63 | 120 |
| D1 | 21.6 | 3.0 | 0.31/0.63 | 310 |
| D2 | 20.9 | 3.1 | 0.39/0.59 | 230 |
| D3 | 21.3 | 3.1 | 0.32/0.63 | 290 |
| D4 | 20.5 | 3.1 | 0.40/0.59 | 220 |
| D5A | 22.7 | 3.1 | 0.32/0.63 | 800 |
| D5B | 22.9 | 3.3 | 0.33/0.64 | 1000 |
| D5C | 20.3 | 2.9 | 0.33/0.64 | 700 |
| D5D | 22.5 | 3.0 | 0.32/0.63 | 1100 |
| D5E | 22.7 | 3.0 | 0.33/0.64 | 800 |
| D6A | 29.5 | 3.0 | 0.53/0.45 | 750 |
| D6B | 29.0 | 3.0 | 0.52/0.47 | 1000 |
| D6C | 27.6 | 3.1 | 0.51/0.48 | 1500 |
| D6D | 27.5 | 3.0 | 0.51/0.48 | 1400 |
| D6E | 25.8 | 3.0 | 0.50/0.48 | 4600 |
| D6F | 24.2 | 3.1 | 0.53/0.46 | 8000 |
| D7 | 23.0 | 2.9 | 0.65/0.35 | 1700 |
| D8A | 26.8 | 2.9 | 0.49/0.51 | 200 |
| D8B | 31.0 | 3.0 | 0.44/0.55 | 240 |
| D9 | 23.8 | 2.9 | 0.51/0.49 | 1500 |
| D10 | 31.9 | 2.9 | 0.35/0.62 | 450 |
| D11 | 31.0 | 2.9 | 0.34/0.63 | 350 |
| D12 | 32.1 | 2.9 | 0.36/0.61 | 550 |
| D13 | 23.6 | 3.2 | 0.33/0.64 | 700 |
| D14 | 21.4 | 3.2 | 0.32/0.64 | 500 |
| D15 | 22.3 | 3.1 | 0.35/0.63 | 450 |
| D16 | 22.9 | 3.1 | 0.35/0.62 | 500 |
| D17 | 21.4 | 3.1 | 0.34/0.62 | 500 |
| D18 | 22.2 | 3.1 | 0.34/0.63 | 550 |
| D19 | 21.9 | 3.2 | 0.35/0.62 | 600 |
| D20 | 22.9 | 3.1 | 0.50/0.48 | 6500 |
| D21 | 24.6 | 3.1 | 0.55/0.43 | 9000 |
| D22 | 22.0 | 3.1 | 0.45/0.54 | 3500 |
| D23 | 21.7 | 2.9 | 0.37/0.62 | 800 |
| D24 | 23.0 | 2.9 | 0.49/0.51 | 1300 |
| D25 | 24.0 | 2.9 | 0.52/0.48 | 1600 |
| D26 | 23.6 | 2.9 | 0.51/0.49 | 1900 |
| D27 | 21.7 | 2.9 | 0.44/0.55 | 900 |
| D28 | 26.1 | 2.9 | 0.66/0.34 | 6500 |
| D29 | 28.7 | 3.0 | 0.46/0.53 | 270 |
| D30 | 23.1 | 3.1 | 0.30/0.62 | 200 |
| D31 | 23.4 | 2.9 | 0.52/0.48 | 1800 |
| D32 | 24.3 | 2.9 | 0.53/0.46 | 2000 |
| D33 | 21.4 | 2.9 | 0.38/0.60 | 800 |
| D34 | 23.9 | 2.9 | 0.53/0.46 | 2200 |
| D35 | 23.6 | 2.9 | 0.53/0.46 | 2000 |
| D36 | 23.5 | 2.8 | 0.51/0.49 | 2000 |
| D37 | 23.9 | 2.9 | 0.56/0.44 | 3100 |
| D38 | 22.7 | 3.0 | 0.53/0.47 | 1500 |
| D39 | 30.0 | 2.9 | 0.35/0.62 | 800 |
| D40 | 30.3 | 2.9 | 0.35/0.62 | 1000 |
| D41 | 27.5 | 2.9 | 0.35/0.63 | 500 |
| D42 | 29.7 | 2.8 | 0.36/0.61 | 450 |
| D43 | 30.4 | 2.9 | 0.37/0.61 | 500 |
| D44 | 30.7 | 2.9 | 0.37/0.62 | 700 |
| D45 | 30.9 | 2.9 | 0.37/0.62 | 800 |
| D46 | 32.4 | 2.9 | 0.36/0.62 | 500 |
| D47 | 31.4 | 2.9 | 0.36/0.62 | 550 |
| D48 | 30.0 | 2.9 | 0.37/0.61 | 500 |
| D49 | 24.4 | 2.9 | 0.53/0.47 | 1600 |
| D50 | 30.5 | 2.9 | 0.34/0.63 | 550 |
| D51 | 20.4 | 2.9 | 0.57/0.41 | 1100 |
| D52 | 24.5 | 3.0 | 0.35/0.62 | 1200 |
| D53 | 24.2 | 3.0 | 0.37/0.61 | 1350 |

### Lösungs-prozessierte Devices:

### A: Aus niedermolekularen löslichen Funktionsmaterialien

Die erfindungsgemäßen Iridium-Komplexe können auch aus Lösung verarbeitet werden und führen dort zu prozesstechnisch wesentlich einfacheren OLEDs, im Vergleich zu den vakuumprozessierten OLEDs, mit dennoch guten Eigenschaften. Die Herstellung solcher Bauteile lehnt sich an die Herstellung polymerer Leuchtdioden (PLEDs) an, die in der Literatur bereits vielfach beschrieben ist (z. B. in der WO 2004/037887). Der Aufbau setzt sich aus Substrat / ITO / Lochinjektionsschicht (60 nm) / Interlayer (20 nm) / Emissionsschicht (60 nm) / Lochblockierschicht (10 nm) / Elektronentransportschicht (40 nm) / Kathode zusammen. Dazu werden Substrate der Firma Technoprint (Sodalimeglas) verwendet, auf welche die ITO-Struktur (Indium-Zinn-Oxid, eine transparente, leitfähige Anode) aufgebracht wird. Die Substrate werden im Reinraum mit DI Wasser und einem Detergens (Deconex 15 PF) gereinigt und dann durch eine UV/Ozon-Plasmabehandlung aktiviert. Danach wird ebenfalls im Reinraum eine 20 nm Lochinjektionsschicht (PEDOT:PSS von Clevios^{™}) durch Spin-Coating aufgebracht. Die benötigte Spinrate hängt vom Verdünnungsgrad und der spezifischen Spin-Coater-Geometrie ab. Um Restwasser aus der Schicht zu entfernen, werden die Substrate für 30 Minuten bei 200 °C auf einer Heizplatte ausgeheizt. Die verwendete Interlayer dient dem Lochtransport, wobei in diesem Fall wird HL-X von Merck verwendet wird. Die Interlayer kann alternativ auch durch eine oder mehrere Schichten ersetzt werden, die lediglich die Bedingung erfüllen müssen, durch den nachgelagerten Prozessierungsschritt der EML-Abscheidung aus Lösung nicht wieder abgelöst zu werden. Zur Herstellung der Emissionsschicht werden die erfindungsgemäßen Triplettemitter zusammen mit den Matrixmaterialien in Toluol oder Chlorbenzol gelöst. Der typische Feststoffgehalt solcher Lösungen liegt zwischen 16 und 25 g/L, wenn, wie hier, die für eine Device typische Schichtdicke von 60 nm mittels Spincoating erzielt werden soll. Die lösungsprozessierten Devices vom Typ1 enthalten eine Emissionsschicht aus M4:M5:IrL (20%:58%:22%), die vom Typ2 enthalten eine Emissionsschicht aus M4:M5:IrLa:IrLb (30%:34%:29%:7%), d.h. sie enthalten zwei verschiedene Ir-Komplexe. Die Emissionsschicht wird in einer Inertgasatmosphäre, im vorliegenden Fall Argon, aufgeschleudert und 10 min bei 160 °C ausgeheizt. Darüber wird die Lochblockierschicht (10 nm ETM1) und die Elektronentransportschicht (40 nm ETM1 (50%) / ETM2 (50%)) aufgedampft (Aufdampfanlagen von Lesker o.a., typischer Aufdampfdruck 5 x 10⁻⁶ mbar). Zuletzt wird eine Kathode aus Aluminium (100 nm) (hochreines Metall von Aldrich) aufgedampft. Um das Device vor Luft und Luftfeuchtigkeit zu schützen, wird die Vorrichtung abschließend verkapselt und dann charakterisiert. Die genannten OLED-Beispiele sind noch nicht optimiert. Tabelle 3 fasst die erhaltenen Daten zusammen. Als Lebensdauer LD50 wird die Zeit definiert, nach der die Leuchtdichte bei Betrieb mit einer Starthelligkeit von 1000 cd/m² auf 50% der Startleuchtdichte absinkt.

**Tabelle 3: Ergebnisse mit aus Lösung prozessierten Materialien**

| **Bsp.** | **Emitter Device** | **EQE (%) 1000 cd/m²** | **Spannung (V) 1000 cd/m²** | **CIE x/y** | **LD50 (h) 1000 cd/m²** |
|---|---|---|---|---|---|
| Sol-Ref.GreenD1 | Ir-Sol-Ref.1 | 21.7 | 4.4 | 0.34/0.62 | 350000 |
| | Typ1 | | | | |
| Sol-GreenD1 | Ir(L2) | 22.4 | 4.3 | 0.34/0.63 | 380000 |
| | Typ1 | | | | |
| Sol-GreenD2 | Ir(L13) | 22.5 | 4.2 | 0.33/0.62 | 410000 |
| | Typ1 | | | | |
| Sol-GreenD3 | Ir(L18) | 21.9 | 4.4 | 0.32/0.62 | 370000 |
| | Typ1 | | | | |
| Sol-GreenD4 | Ir(L23) | 22.0 | 4.3 | 0.39/0.59 | 420000 |
| | Typ1 | | | | |
| Sol-GreenD5 | lr(L23-D8) | 22.4 | 4.3 | 0.39/0.59 | 460000 |
| | Typ1 | | | | |
| Sol-GreenD6 | Ir6 | 21.9 | 4.4 | 0.33/0.63 | 390000 |
| | Typ1 | | | | |
| Sol-GreenD7 | Ir51 | 21.6 | 4.3 | 0.31/0.64 | 320000 |
| | Typ1 | | | | |
| Sol-GreenD8 | Ir(L12) | 22.2 | 4.2 | 0.33/0.62 | 350000 |
| | Typ1 | | | | |
| Sol-GreenD9 | Ir(L19) | 22.1 | 4.2 | 0.36/0.62 | 300000 |
| | Typ1 | | | | |
| Sol-GreenD10 | Ir(L21) | 21.8 | 4.2 | 0.35/0.61 | 440000 |
| | Typ1 | | | | |
| Sol-GreenD11 | Ir(L40) | 22.7 | 4.2 | 0.37/0.59 | 280000 |
| | Typ1 | | | | |
| Sol-GreenD12 | Ir(L41) | 22.7 | 4.2 | 0.36/0.62 | 340000 |
| | Typ1 | | | | |
| Sol-GreenD13 | Ir(L45) | 22.0 | 4.4 | 0.30/0.62 | 350000 |
| | Typ1 | | | | |
| Sol-GreenD14 | Ir(L46) | 22.7 | 4.3 | 0.38/0.61 | 350000 |
| | Typ1 | | | | |
| Sol-GreenD15 | Ir(L202) | 21.9 | 4.2 | 0.39/0.59 | 330000 |
| | Typ1 | | | | |
| Sol-GreenD16 | Ir(L36) | 22.7 | 4.3 | 0.38/0.59 | 290000 |
| | Typ1 | | | | |
| Sol-GreenD17 | Ir(L40) | 23.0 | 4.2 | 0.40/0.59 | 370000 |
| | Typ1 | | | | |
| Sol-GreenD18 | Ir(L46) | 23.2 | 4.3 | 0.38/0.61 | 370000 |
| | Typ1 | | | | |
| Sol-GreenD19 | Ir(L112) | 23.0 | 4.3 | 0.37/0.62 | 380000 |
| | Typ1 | | | | |
| Sol-GreenD20 | Ir(L129) | 22.7 | 4.3 | 0.34/0.63 | 370000 |
| | Typ1 | | | | |
| Sol-GreenD21 | Ir(L23-D10) | 22.7 | 4.3 | 0.37/0.61 | 390000 |
| | Typ1 | | | | |
| Sol-GreenD22 | Ir(L136-D8-CN) | 22.9 | 4.4 | 0.30/0.63 | 300000 |
| | Typ1 | | | | |
| Sol-GreenD23 | Ir1 | 22.0 | 4.4 | 0.33/0.63 | 390000 |
| | Typ1 | | | | |
| Sol-GreenD24 | Ir4 | 23.2 | 4.0 | 0.35/0.61 | 430000 |
| | Typ1 | | | | |
| Sol-GreenD25 | Ir7 | 23.6 | 4.0 | 0.34/0.62 | 420000 |
| | Typ1 | | | | |
| Sol-GreenD26 | Ir53 | 23.4 | 4.0 | 0.33/0.62 | 450000 |
| | Typ1 | | | | |
| Sol-GreenD27 | Ir(L151) | 22.8 | 4.2 | 0.38/0.61 | 290000 |
| | Typ1 | | | | |
| Sol-GreenD28 | Ir(L156) | 22.9 | 4.3 | 0.33/0.62 | 300000 |
| | Typ1 | | | | |
| Sol-GreenD29 | lr(L157-D8) | 22.4 | 4.0 | 0.29/0.62 | 290000 |
| | Typ1 | | | | |
| Sol-YellowD1 | Ir(L15) | 23.1 | 4.2 | 0.44/0.55 | 560000 |
| | Typ1 | | | | |
| Sol-YellowD2 | Ir(L28-D10) | 22.4 | 4.2 | 0.43/0.54 | 400000 |
| | Typ1 | | | | |
| Sol-YellowD3 | Ir(L141) | 22.8 | 4.2 | 0.45/0.54 | 300000 |
| | Typ1 | | | | |
| Sol-YellowD4 | Ir(L146) | 21.2 | 4.1 | 0.57/0.41 | 380000 |
| | Typ1 | | | | |
| Sol-YellowD5 | Ir(L204) | 23.3 | 4.2 | 0.45/0.54 | 540000 |
| | Typ1 | | | | |
| Sol-YellowD6 | Ir(L201) | 23.0 | 4.2 | 0.44/0.55 | 500000 |
| | Typ1 | | | | |
| Sol-YellowD7 | Ir(L209) | 22.5 | 4.2 | 0.47/0.52 | 430000 |
| | Typ1 | | | | |
| Sol-YellowD8 | Ir(L210) | 22.7 | 4.2 | 0.49/0.51 | 430000 |
| | Typ1 | | | | |
| Sol-YellowD9 | Ir(L141) | 22.5 | 4.2 | 0.49/0.50 | 320000 |
| | Typ1 | | | | |
| Sol-YellowD10 | Ir(L127) | 21.4 | 4.2 | 0.48/0.50 | 280000 |
| | Typ1 | | | | |
| Sol-YellowD11 | Ir(L135) | 21.4 | 4.2 | 0.51/0.48 | 300000 |
| | Typ1 | | | | |
| Sol-Ref.RedD1 | Ir(15) | 18.6 | 4.4 | 0.66/0.34 | 130000 |
| | Ir-Sol-Ref.2 | | | | |
| | Typ2 | | | | |
| Sol-RedD1 | Ir(L15) | 21.3 | 4.3 | 0.66/0.34 | 330000 |
| | Ir(L33) | | | | |
| | Typ2 | | | | |
| Sol-RedD2 | lr(L15) | 21.0 | 4.3 | 0.65/0.35 | 300000 |
| | Ir(L32) | | | | |
| | Typ2 | | | | |
| Sol-RedD3 | lr(L15) | 18.1 | 4.3 | 0.69/0.31 | 170000 |
| | Ir(L34) | | | | |
| | Typ2 | | | | |
| Sol-RedD4 | Ir(L147) | 18.5 | 4.2 | 0.67/0.33 | 220000 |
| | Ir(L34) | | | | |
| | Typ2 | | | | |
| Sol-RedD5 | Ir(L15) | 21.0 | 4.3 | 0.65/0.35 | 300000 |
| | lr(L203) | | | | |
| | Typ2 | | | | |

**Tabelle 4: Strukturformeln der verwendeten Materialien**

| | |
|---|---|
| 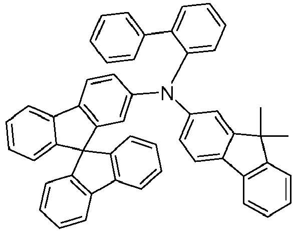 | 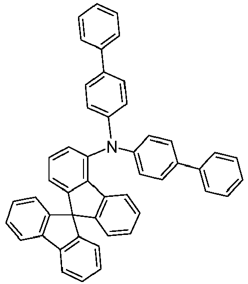 |
| HTM1 [136463-07-5] | |
| | HTM2 [1450933-43-3] |
| 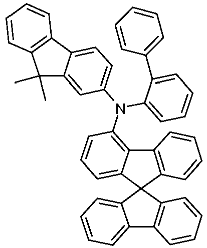 | |
| HTM3 [1450933-44-4] | |
| 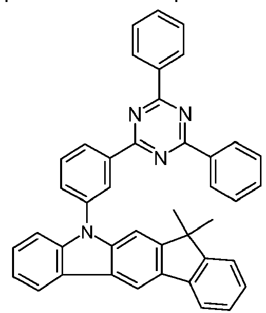 | 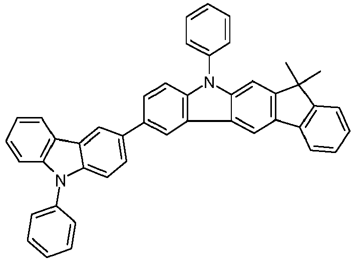 |
| | M2 [1357150-54-9] |
| M1 [1257248-13-7] | |
| 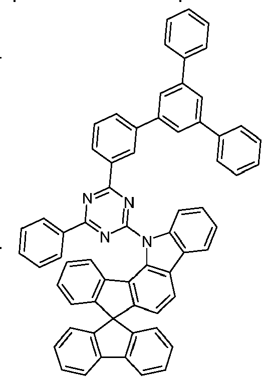 | 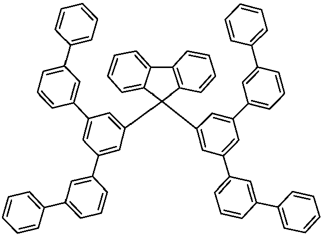 |
| | M5 [1246496-85-4] |
| M4 [1616231-60-7] | |
| 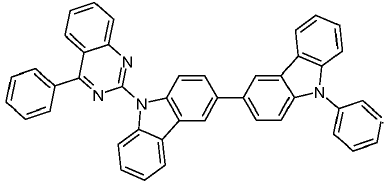 | 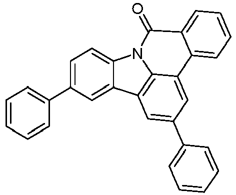 |
| M6 [1398395-92-0] | M7 [1915695-76-5] |
| 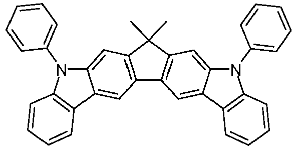 | 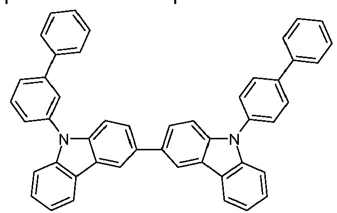 |
| M8 [1257248-72-8] | |
| | M9 [1643479-47-3] |
| 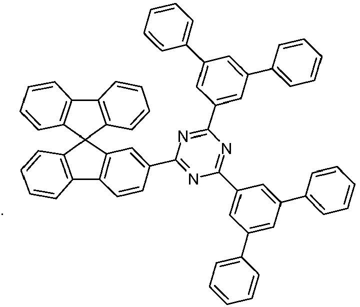 | 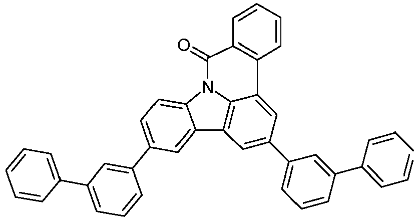 |
| | M11 [1615703-24-6] |
| ETM1 = M10 [1233200-52-6] | |
| 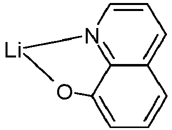 | |
| ETM2 [25387-93-3] | |
| 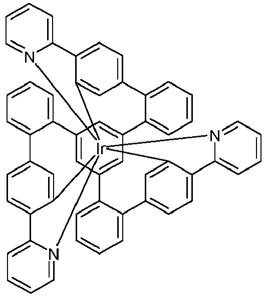 | 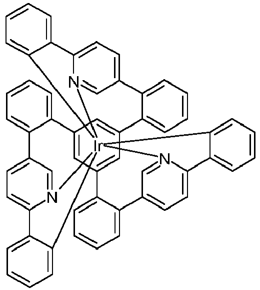 |
| Ir-Ref.1 [1989600-78-3] | Ir-Ref.2 [1989600-75-0] |
| 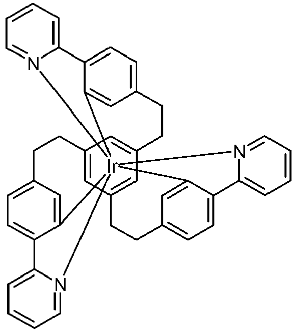 | 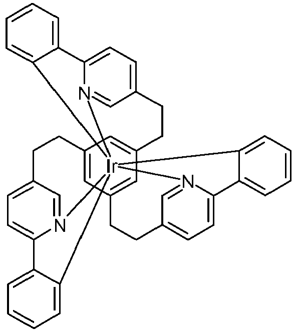 |
| Ir-Ref.3 [861806-74-8] | Ir-Ref.4 [861806-70-4] |
| 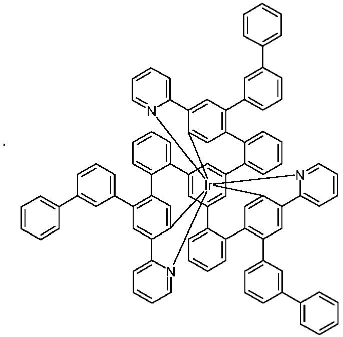 | 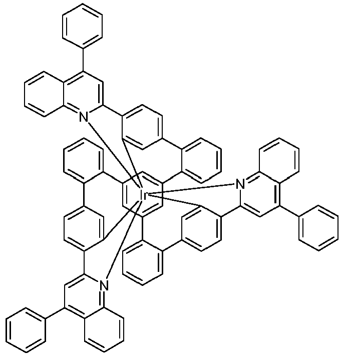 |
| Ir-Sol-Ref.1 [1989601-89-9] | Ir-Sol-Ref.2 [1989605-98-2] |

## Patentansprüche

1. Verbindung der Formel (1), 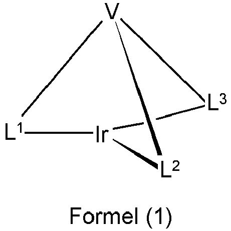 wobei für die verwendeten Symbole gilt:
L¹, L², L³ sind gleich oder verschieden bei jedem Auftreten jeweils ein bidentater, monoanionischer Teilligand, der über ein Kohlenstoffatom und ein Stickstoffatom, über zwei Kohlenstoffatome, über zwei Stickstoffatome, über zwei Sauerstoffatome oder über ein Stickstoffatom und ein Sauerstoffatom an das Iridium koordiniert;
V ist eine Gruppe der Formel (2), wobei die gestrichelten Bindungen jeweils die Position der Verknüpfung der Teilliganden L¹, L² und L³ darstellen, 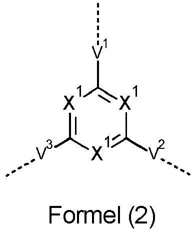
V¹ ist eine Gruppe der folgenden Formel (3), 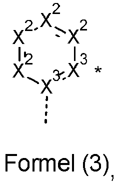 wobei die gestrichelte Bindung die Bindung an L¹ darstellt und * die Bindung an den zentralen Cyclus in Formel (2) darstellt;
V² ist ausgewählt aus der Gruppe bestehend aus -CR₂-CR₂- oder -CR₂-O-, wobei diese Gruppen jeweils an L² und an den zentralen Cyclus in Formel (2) gebunden sind;
V³ ist gleich oder verschieden V¹ oder V², wobei diese Gruppe an L³ und an den zentralen Cyclus in Formel (2) gebunden ist;
X¹ ist bei jedem Auftreten gleich oder verschieden CR oder N;
X² ist bei jedem Auftreten gleich oder verschieden CR oder N, oder zwei benachbarte Gruppen X² stehen zusammen für NR, O oder S, so dass ein Fünfring entsteht; oder zwei benachbarte Gruppen X² stehen zusammen für CR oder N, wenn in dem Cyclus eine der Gruppen X³ für N steht, so dass ein Fünfring entsteht; mit der Maßgabe, dass maximal zwei benachbarte Gruppen X² in jedem Ring für N stehen;
X³ ist bei jedem Auftreten in demselben Cyclus C oder eine Gruppe X³ steht für N und die andere Gruppe X³ in demselben Cyclus steht für C, wobei die Gruppen X³ unabhängig voneinander gewählt werden können, wenn V mehr als eine Gruppe der Formel (3) enthält; mit der Maßgabe, dass zwei benachbarte Gruppen X² zusammen für CR oder N stehen, wenn in dem Cyclus eine der Gruppen X³ für N steht;
R ist bei jedem Auftreten gleich oder verschieden H, D, F, Cl, Br, I, N(R¹)₂, CN, Si(R¹)₃, B(OR¹)₂, C(=O)R¹, eine geradkettige Alkylgruppe mit 1 bis 10 C-Atomen oder eine Alkenylgruppe mit 2 bis 10 C-Atomen oder eine verzweigte oder cyclische Alkylgruppe mit 3 bis 10 C-Atomen, wobei die Alkyl- oder Alkenylgruppe jeweils mit einem oder mehreren Resten R¹ substituiert sein kann, oder ein aromatisches oder heteroaromatisches Ringsystem mit 5 bis 30 aromatischen Ringatomen, das jeweils durch einen oder mehrere Reste R¹ substituiert sein kann; dabei können zwei Reste R auch miteinander ein Ringsystem bilden;
R¹ ist bei jedem Auftreten gleich oder verschieden H, D, F, N(R²)₂, CN, eine geradkettige Alkylgruppe mit 1 bis 10 C-Atomen oder eine Alkenylgruppe mit 2 bis 10 C-Atomen oder eine verzweigte oder cyclische Alkylgruppe mit 3 bis 10 C-Atomen, wobei die Alkyl- oder Alkenylgruppe jeweils mit einem oder mehreren Resten R² substituiert sein kann, oder ein aromatisches oder heteroaromatisches Ringsystem mit 5 bis 24 aromatischen Ringatomen, das jeweils durch einen oder mehrere Reste R² substituiert sein kann; dabei können zwei oder mehrere Reste R¹ miteinander ein Ringsystem bilden;
R² ist bei jedem Auftreten gleich oder verschieden H, D, F oder ein aliphatischer, aromatischer und/oder heteroaromatischer organischer Rest mit 1 bis 20 C-Atomen, in dem auch ein oder mehrere H-Atome durch F ersetzt sein können;
dabei können die drei bidentaten Liganden L¹, L² und L³ außer durch die Brücke V auch noch durch eine weitere Brücke zu einem Kryptat geschlossen sein.

2. Verbindung nach Anspruch 1, **dadurch gekennzeichnet, dass** die Gruppe der Formel (3) ausgewählt ist aus den Gruppen der Formeln (6) bis (30), 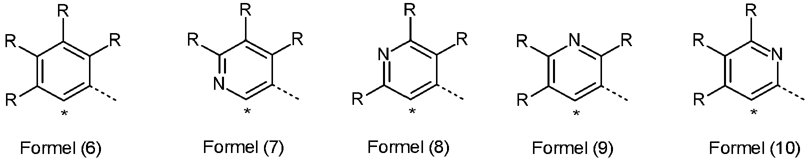 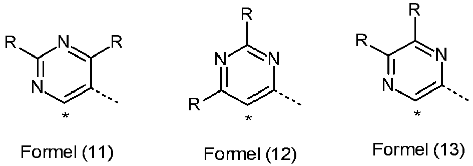 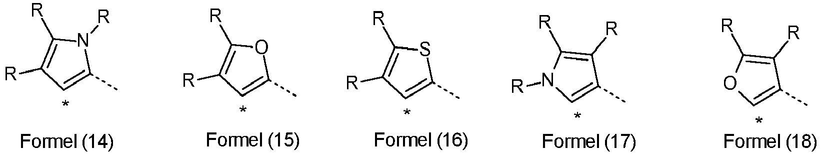 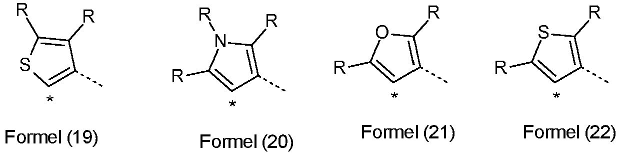 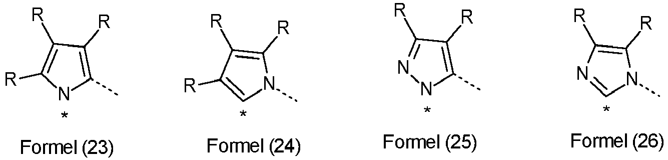 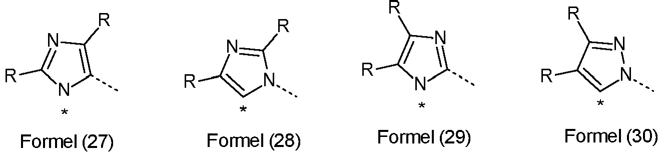 wobei die verwendeten Symbole die in Anspruch 1 genannten Bedeutungen aufweisen.

3. Verbindung nach Anspruch 1 oder 2, **dadurch gekennzeichnet, dass** V² für -CR₂-CR₂- steht, wobei R gleich oder verschieden bei jedem Auftreten ausgewählt ist aus der Gruppe bestehend aus H, D, F und einer Alkylgruppe mit 1 bis 5 C-Atomen, wobei auch H-Atome durch D oder F ersetzt sein können und wobei benachbarte R miteinander ein Ringsystem bilden können.

4. Verbindung nach einem oder mehreren der Ansprüche 1 bis 3, **dadurch gekennzeichnet, dass** V ausgewählt ist aus den Strukturen der Formeln (4a), (4b), (5a) und (5b), 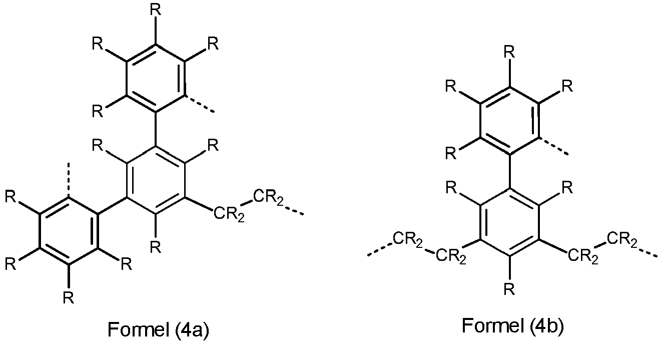 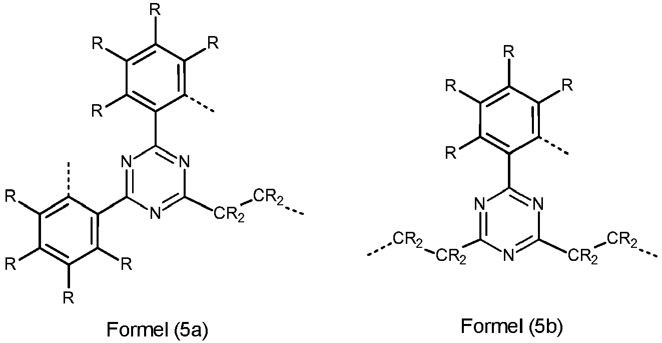 wobei die verwendeten Symbole die in Anspruch 1 genannten Bedeutungen aufweisen.

5. Verbindung nach einem oder mehreren der Ansprüche 1 bis 4, **dadurch gekennzeichnet, dass** V ausgewählt ist aus den Strukturen der Formeln (4c), (4d), (4e), (4f), (5c), (5d), (5e) und (5f), 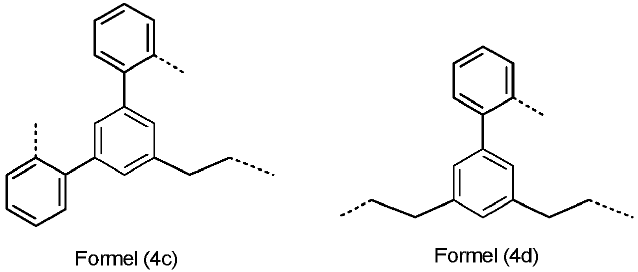 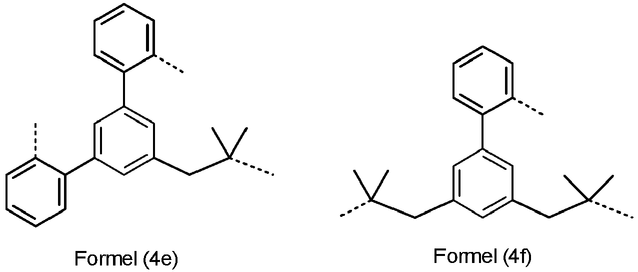 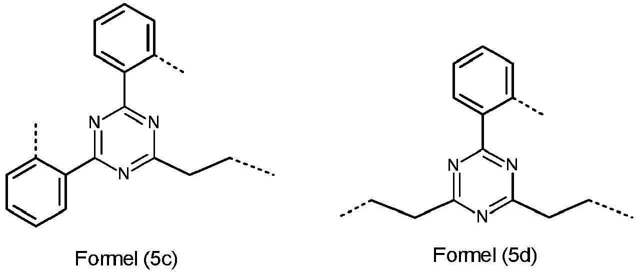 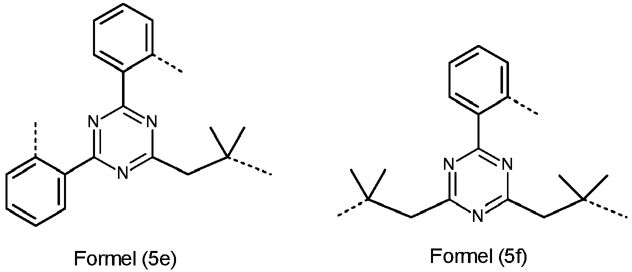 wobei die verwendeten Symbole die in Anspruch 1 genannten Bedeutungen aufweisen.

6. Verbindung nach einem oder mehreren der Ansprüche 1 bis 5, **dadurch gekennzeichnet, dass** mindestens einer der Teilliganden L¹, L² und L³, bevorzugt mindestens zwei der Teilliganden L¹, L² und L³ an das Iridium über ein Kohlenstoffatom und ein Stickstoffatom oder über zwei Kohlenstoffatome koordinieren.

7. Verbindung nach einem oder mehreren der Ansprüche 1 bis 6, **dadurch gekennzeichnet, dass** mindestens einer der Teilliganden L¹, L² bzw. L³, bevorzugt mindestens zwei Teilliganden L¹, L² und L³ eine Struktur gemäß einer der Formeln (L-1) oder (L-2) aufweisen, 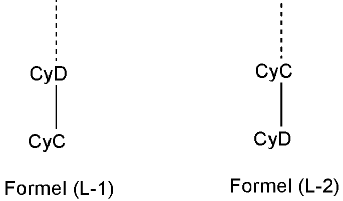 wobei die gestrichelte Bindung die Bindung des Teilliganden an V darstellt und für die weiteren verwendeten Symbole gilt:
CyC ist gleich oder verschieden bei jedem Auftreten eine substituierte oder unsubstituierte Aryl- oder Heteroarylgruppe mit 5 bis 14 aromatischen Ringatomen, welche jeweils über ein Kohlenstoffatom an das Metall koordiniert und welche über eine kovalente Bindung mit CyD verbunden ist;
CyD ist gleich oder verschieden bei jedem Auftreten eine substituierte oder unsubstituierte Heteroarylgruppe mit 5 bis 14 aromatischen Ringatomen, welche über ein Stickstoffatom oder über ein Carben-Kohlenstoffatom an das Metall koordiniert und welche über eine kovalente Bindung mit CyC verbunden ist;
dabei können mehrere der optionalen Substituenten miteinander ein Ringsystem bilden.

8. Verbindung nach Anspruch 7, **dadurch gekennzeichnet, dass** (L-1) ausgewählt ist aus den Strukturen der Formeln (L-1-1) und (L-1-2) und (L-2) ausgewählt ist aus den Strukturen der Formeln (L-2-1) bis (L-2-4), 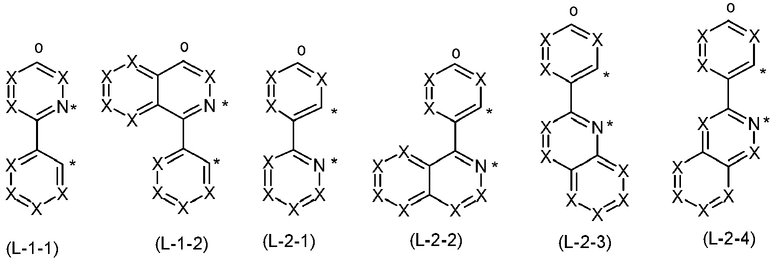 wobei X gleich oder verschieden bei jedem Auftreten für CR oder N steht, wobei maximal zwei X pro Cyclus für N stehen, * die Position der Koordination an das Iridium darstellt und "o" die Position der Bindung an V darstellt.

9. Verbindung nach einem oder mehreren der Ansprüche 1 bis 8, **dadurch gekennzeichnet, dass** einer der Teilliganden L¹, L² bzw. L³ einen Substituenten gemäß einer der Formeln (49) und (50) aufweist, 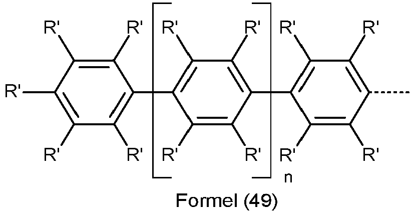 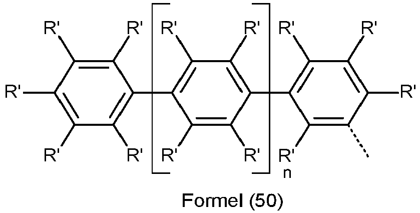 wobei die gestrichelte Bindung die Verknüpfung der Gruppe andeutet und weiterhin gilt:
R` ist gleich oder verschieden bei jedem Auftreten H, D, F, CN, eine geradkettige Alkylgruppe mit 1 bis 10 C-Atomen, in der auch ein oder mehrere H-Atome durch D oder F ersetzt sein können, oder eine verzweigte oder cyclische Alkylgruppe mit 3 bis 10 C-Atomen, in der auch ein oder mehrere H-Atome durch D oder F ersetzt sein können, oder eine Alkenylgruppe mit 2 bis 10 C-Atomen, in der auch ein oder mehrere H-Atome durch D oder F ersetzt sein können; dabei können auch zwei benachbarte Reste R' bzw. zwei Reste R' an benachbarten Phenylgruppen miteinander ein Ringsystem bilden; oder zwei R' an benachbarten Phenylgruppen stehen zusammen für eine Gruppe ausgewählt aus O oder S, so dass die beiden Phenylringe zusammen mit der verbrückenden Gruppe für ein Dibenzofuran oder Dibenzothiophen stehen, und die weiteren R' sind wie vorstehend definiert;
n ist 0, 1, 2, 3, 4 oder 5.

10. Verbindung nach Anspruch 9, **dadurch gekennzeichnet, dass** die Struktur der Formel (49) ausgewählt ist aus den Strukturen der Formeln (49a) bis (49h) und die Struktur der Formel (50) ausgewählt ist aus den Strukturen der Formeln (50a) bis (50h), 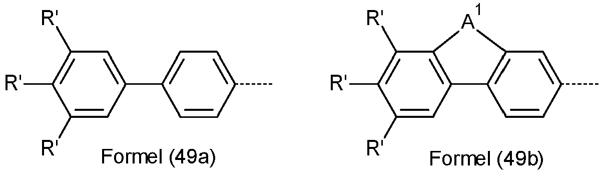 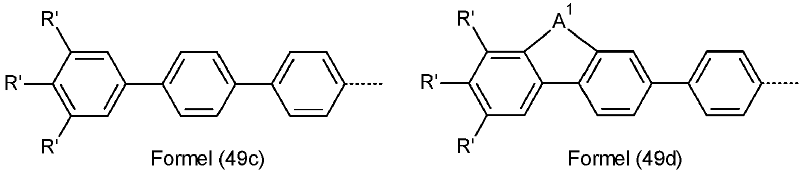 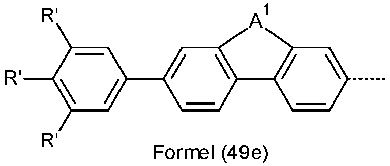 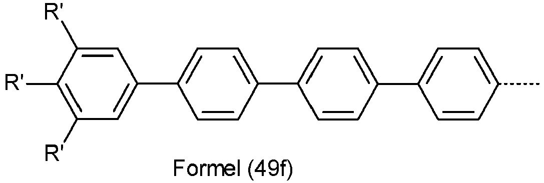 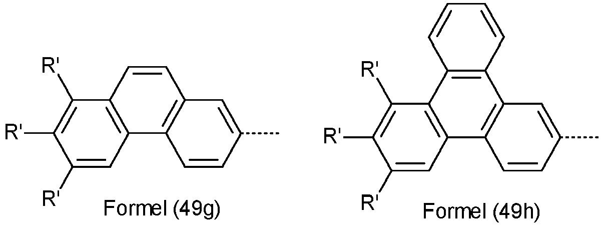 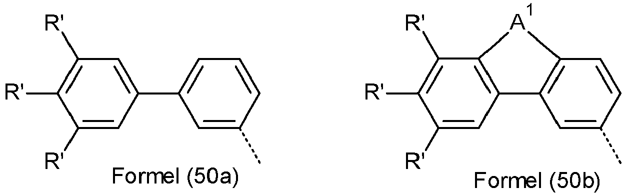 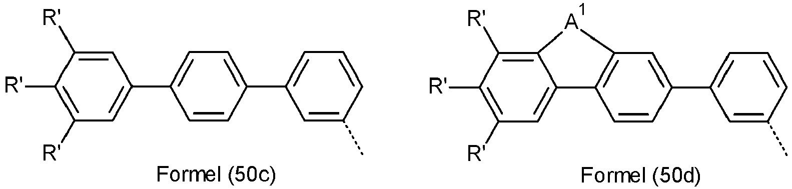 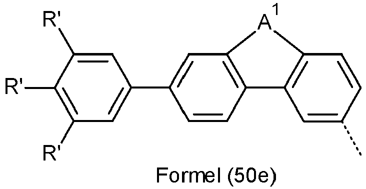 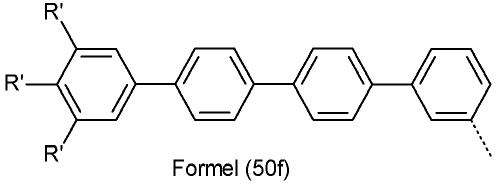 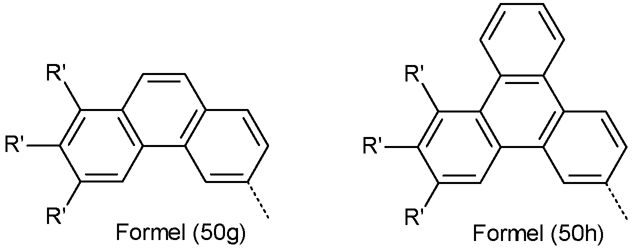 wobei A¹ für O, S, C(R¹)₂ oder NR¹ steht und die weiteren verwendeten Symbole die in Anspruch 1 und 9 genannten Bedeutungen aufweisen.

11. Verfahren zur Herstellung einer Verbindung nach einem oder mehreren der Ansprüche 1 bis 10 durch Umsetzung des Liganden mit Iridiumalkoholaten der Formel (51), mit Iridiumketoketonaten der Formel (52), mit Iridiumhalogeniden der Formel (53) oder mit Iridiumcarboxylaten der Formel (54),
Ir(OR)₃ Formel (51) 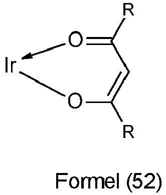
IrHal₃ Formel (53)
Ir(OOCR)₃ Formel (54)
wobei R die in Anspruch 1 angegebenen Bedeutungen hat, Hal = F, Cl, Br oder I ist und die Iridiumedukte auch als die entsprechenden Hydrate vorliegen können.

12. Formulierung, enthaltend mindestens eine Verbindung nach einem oder mehreren der Ansprüche 1 bis 10 und mindestens ein Lösemittel und/oder mindestens eine weitere organische oder anorganische Verbindung.

13. Verwendung einer Verbindung nach einem oder mehreren der Ansprüche 1 bis 10 in einer elektronischen Vorrichtung oder als Sauerstoff-Sensibilisator oder als Photoinitiator oder Photokatalysator.

14. Elektronische Vorrichtung enthaltend mindestens eine Verbindung nach einem oder mehreren der Ansprüche 1 bis 10.

15. Elektronische Vorrichtung nach Anspruch 14, wobei es sich um eine organische Elektrolumineszenzvorrichtung handelt, **dadurch gekennzeichnet, dass** die Verbindung nach einem oder mehreren der Ansprüche 1 bis 10 in einer emittierenden Schicht eingesetzt wird.

## Claims

1. Compound of the formula (1) 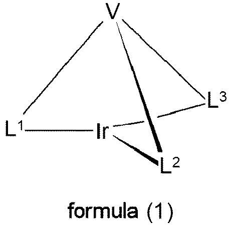 where the symbols used are as follows:
L¹, L², L³ are the same or different at each instance and are each a bidentate monoanionic sub-ligand that coordinates to the iridium via one carbon atom and one nitrogen atom, via two carbon atoms, via two nitrogen atoms, via two oxygen atoms or via one nitrogen atom and one oxygen atom;
V is a group of the formula (2), where the dotted bonds each represent the position of linkage of the sub-ligands L¹, L² and L³, 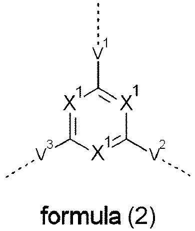
V¹ is a group of the following formula (3) 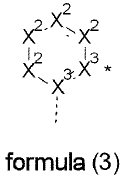
where the dotted bond represents the bond to L¹ and * represents the bond to the central cycle in formula (2);
V² is selected from the group consisting of -CR₂-CR₂- and -CR₂-O-, where these groups are each bonded to L² and to the central cycle in formula (2);
V³ is the same or different and is V¹ or V², where this group is bonded to L³ and to the central cycle in formula (2);
X¹ is the same or different at each instance and is CR or N;
X² is the same or different at each instance and is CR or N, or two adjacent X² groups together are NR, O or S, thus forming a five-membered ring; or two adjacent X² groups together are CR or N when one of the X³ groups in the cycle is N, thus forming a five-membered ring;
with the proviso that not more than two adjacent X² groups in each ring are N;
X³ is C at each instance in the same cycle or one X³ group is N and the other X³ group in the same cycle is C, where the X³ groups may be selected independently when V contains more than one group of the formula (3);
with the proviso that two adjacent X² groups together are CR or N when one of the X³ groups in the cycle is N;
R is the same or different at each instance and is H, D, F, Cl, Br, I, N(R²)₂, CN, Si(R¹)₃, B(OR¹)₂, C(=O)R¹, a straight-chain alkyl group having 1 to 10 carbon atoms or an alkenyl group having 2 to 10 carbon atoms or a branched or cyclic alkyl group having 3 to 10 carbon atoms, where the alkyl or alkenyl group may in each case be substituted by one or more R¹ radicals, or an aromatic or heteroaromatic ring system which has 5 to 30 aromatic ring atoms and may be substituted in each case by one or more R¹ radicals; at the same time, two R radicals together may also form a ring system;
R¹ is the same or different at each instance and is H, D, F, N(R²)₂, CN, a straight-chain alkyl group having 1 to 10 carbon atoms or an alkenyl group having 2 to 10 carbon atoms or a branched or cyclic alkyl group having 3 to 10 carbon atoms, where the alkyl or alkenyl group may in each case be substituted by one or more R² radicals, or an aromatic or heteroaromatic ring system which has 5 to 24 aromatic ring atoms and may be substituted in each case by one or more R² radicals; at the same time, two or more R¹ radicals together may form a ring system;
R² is the same or different at each instance and is H, D, F or an aliphatic, aromatic and/or heteroaromatic organic radical having 1 to 20 carbon atoms, in which one or more hydrogen atoms may also be replaced by F;
at the same time, the three bidentate ligands L¹, L² and L³, apart from by the bridge V, may also be closed by a further bridge to form a cryptate.

2. Compound according to Claim 1, **characterized in that** the group of the formula (3) is selected from the groups of the formulae (6) to (30) 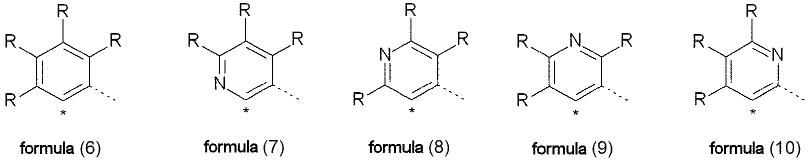 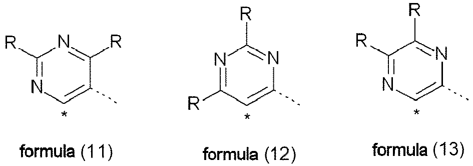 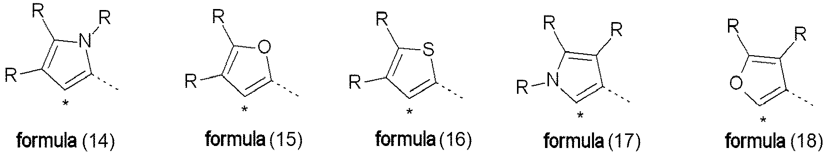 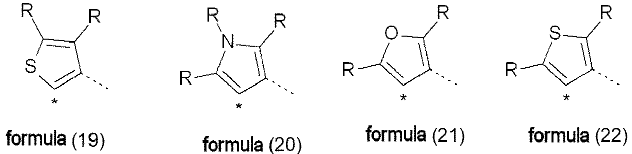 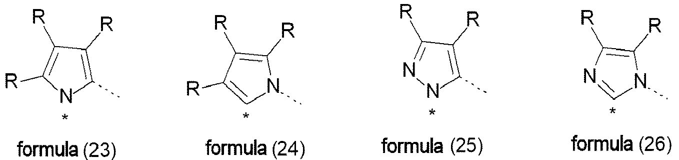 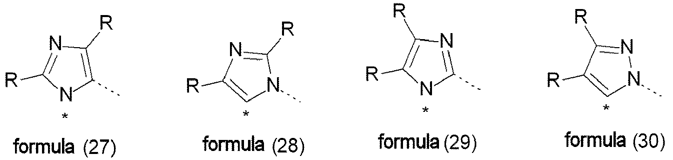 where the symbols used have the definitions given in Claim 1.

3. Compound according to Claim 1 or 2, **characterized in that** V² is -CR₂-CR₂- where R is the same or different at each instance and is selected from the group consisting of H, D, F and an alkyl group having 1 to 5 carbon atoms, where hydrogen atoms may also be replaced by D or F and where adjacent R together may form a ring system.

4. Compound according to one or more of Claims 1 to 3, **characterized in that** V is selected from the structures of the formulae (4a), (4b), (5a) and (5b) 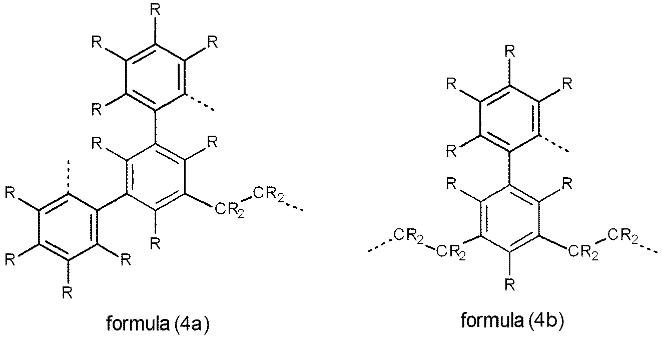 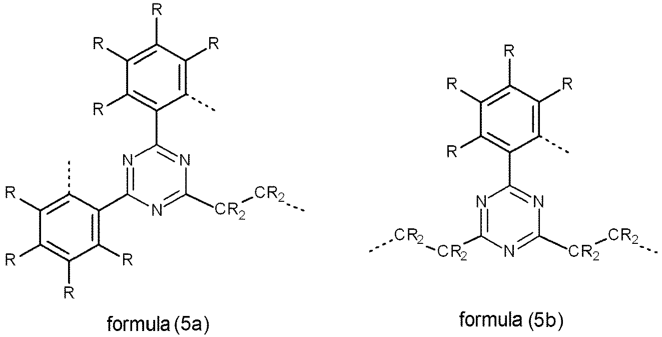 where the symbols used have the definitions given in Claim 1.

5. Compound according to one or more of Claims 1 to 4, **characterized in that** V is selected from the structures of the formulae (4c), (4d), (4e), (4f), (5c), (5d), (5e) and (5f) 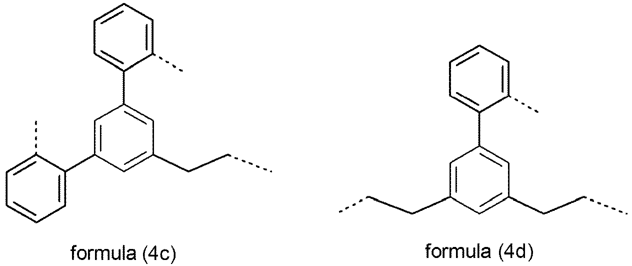 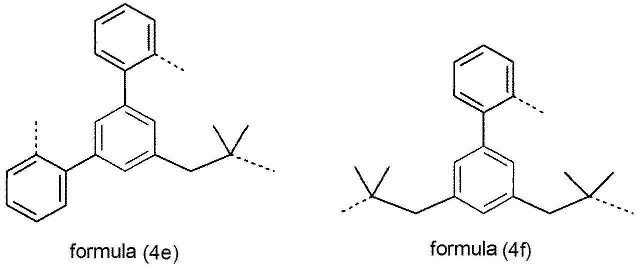 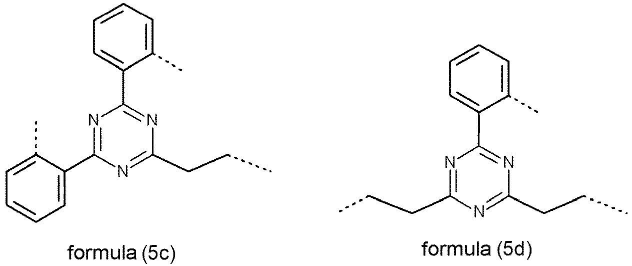 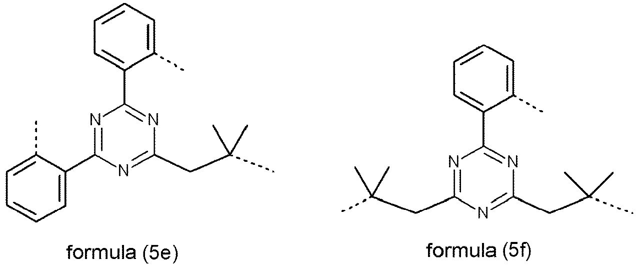 where the symbols used have the definitions given in Claim 1.

6. Compound according to one or more of Claims 1 to 5, **characterized in that** at least one of the sub-ligands L¹, L² and L³, preferably at least two of the sub-ligands L¹, L² and L³, coordinate(s) to the iridium via one carbon atom and one nitrogen atom or via two carbon atoms.

7. Compound according to one or more of Claims 1 to 6, **characterized in that** at least one of the sub-ligands L¹, L² and L³, preferably at least two sub-ligands L¹, L² and L³, has/have a structure of one of the formulae (L-1) and (L-2) 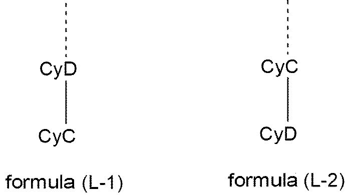 where the dotted bond represents the bond of the sub-ligand to V and the other symbols used are as follows:
CyC is the same or different at each instance and is a substituted or unsubstituted aryl or heteroaryl group which has 5 to 14 aromatic ring atoms and coordinates in each case to the metal via a carbon atom and which is bonded to CyD via a covalent bond;
CyD is the same or different at each instance and is a substituted or unsubstituted heteroaryl group which has 5 to 14 aromatic ring atoms and coordinates to the metal via a nitrogen atom or via a carbene carbon atom and which is bonded to CyC via a covalent bond;
at the same time, two or more of the optional substituents together may form a ring system.

8. Compound according to Claim 7, **characterized in that** (L-1) is selected from the structures of the formulae (L-1-1) and (L-1-2), and (L-2) is selected from the structures of the formulae (L-2-1) to (L-2-4) 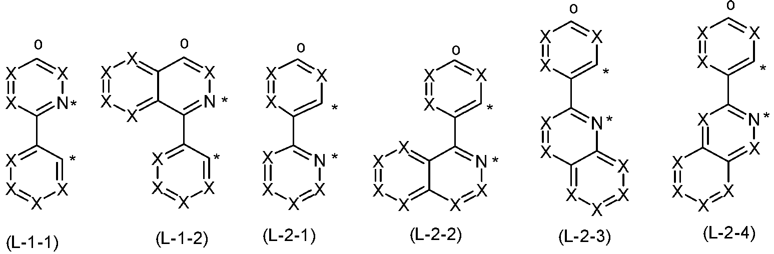 where X is the same or different at each instance and is CR or N, where not more than two X per cycle are N, * represents the position of coordination to the iridium and "o" represents the position of the bond to V.

9. Compound according to one or more of Claims 1 to 8, **characterized in that** one of the sub-ligands L¹, L² and L³ has a substituent of one of the formulae (49) and (50) 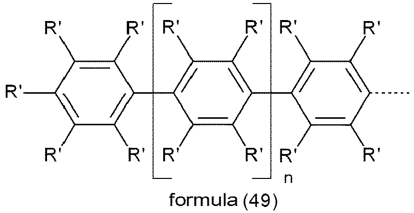 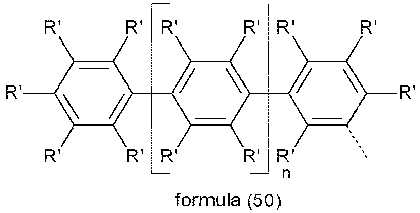 where the dotted bond indicates the linkage of the group and, in addition:
R' is the same or different at each instance and is H, D, F, CN, a straight chain alkyl group having 1 to 10 carbon atoms in which one or more hydrogen atoms may also be replaced by D or F, or a branched or cyclic alkyl group having 3 to 10 carbon atoms in which one or more hydrogen atoms may also be replaced by D or F, or an alkenyl group having 2 to 10 carbon atoms in which one or more hydrogen atoms may also be replaced by D or F;
at the same time, two adjacent R' radicals or two R' radicals on adjacent phenyl groups together may also form a ring system; or two R' on adjacent phenyl groups together are a group selected from O and S, such that the two phenyl rings together with the bridging group are a dibenzofuran or dibenzothiophene, and the further R' are as defined above;
n is 0, 1, 2, 3, 4 or 5.

10. Compound according to Claim 9, **characterized in that** the structure of the formula (49) is selected from the structures of the formulae (49a) to (49h) and the structure of the formula (50) is selected from the structures of the formulae (50a) to (50h) 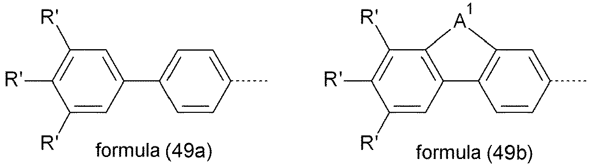 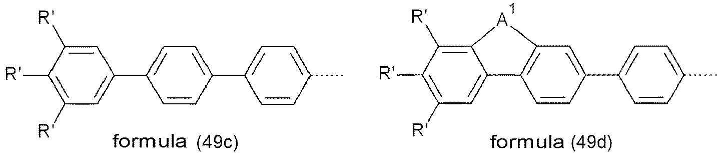 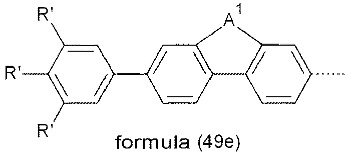 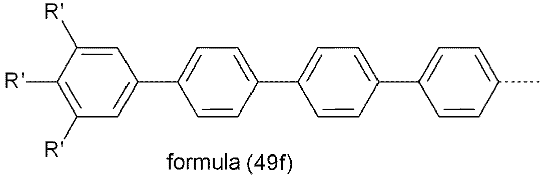 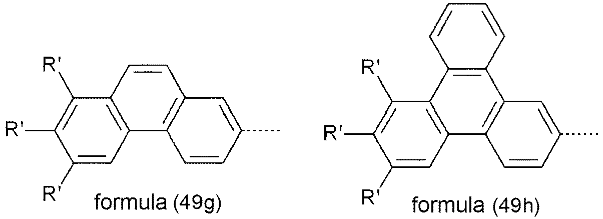 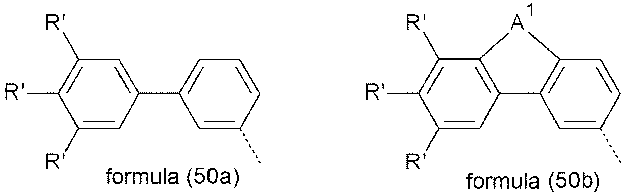 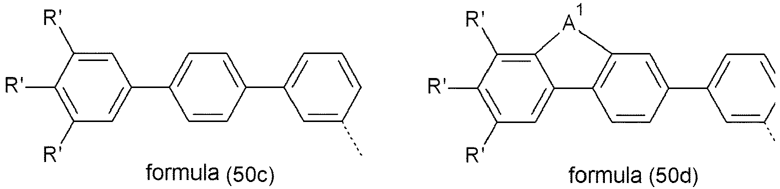 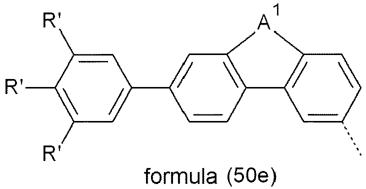 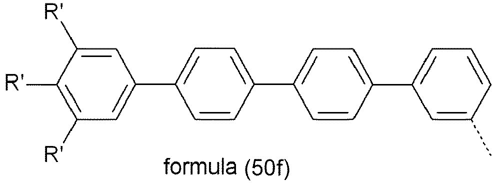 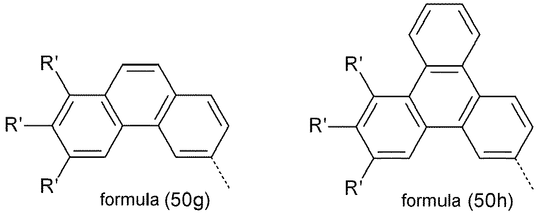 where A¹ is O, S, C(R¹)₂ or NR¹ and the further symbols used have the definitions given in Claims 1 and 9.

11. Process for preparing a compound according to one or more of Claims 1 to 10 by reacting the ligand with iridium alkoxides of the formula (51), with iridium ketoketonates of the formula (52), with iridium halides of the formula (53) or with iridium carboxylates of the formula (54)
Ir(OR)₃ formula (51) 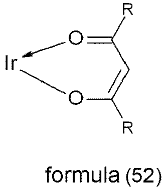
IrHal₃ formula (53)
Ir(OOCR)₃ formula (54)
where R has the definitions given in Claim 1, Hal = F, Cl, Br or I and the iridium reactants may also take the form of the corresponding hydrates.

12. Formulation comprising at least one compound according to one or more of Claims 1 to 10 and at least one solvent and/or at least one further organic or inorganic compound.

13. Use of a compound according to one or more of Claims 1 to 10 in an electronic device or as oxygen sensitizer or as photoinitiator or photocatalyst.

14. Electronic device comprising at least one compound according to one or more of Claims 1 to 10.

15. Electronic device according to Claim 14 which is an organic electroluminescent device, **characterized in that** the compound according to one or more of Claims 1 to 10 is used in an emitting layer.

## Revendications

1. Composé de formule (1), 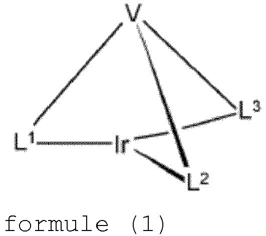 pour les symboles utilisés :
L¹, L², L³, identiques ou différents en chaque occurrence, étant à chaque fois un ligand partiel bidentate monoanionique qui coordine à l'iridium par le biais d'un atome de carbone et d'un atome d'azote, par le biais de deux atomes de carbone, par le biais de deux atomes d'azote, par le biais de deux atomes d'oxygène ou par le biais d'un atome d'azote et d'un atome d'oxygène ;
V étant un groupe de formule (2), les liaisons en pointillés représentant à chaque fois la position du lien des ligands partiels L¹, L² et L³, 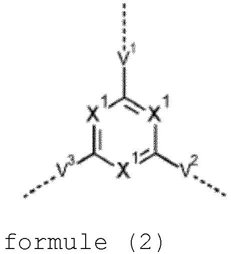
V¹ étant un groupe de la formule suivante (3), 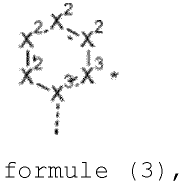
la liaison en pointillés représentant la liaison à L¹ et * représentant la liaison au cycle central dans la formule (2) ;
V² étant choisi dans le groupe constitué par -CR₂-CR₂- et -CR₂-O-, ces groupes étant liés à chaque fois à L² et au cycle central dans la formule (2) ;
V³ étant égal ou différent de V¹ ou V², ce groupe étant lié à L³ et au cycle central dans la formule (2) ;
X¹, identique ou différent en chaque occurrence, étant CR ou N ;
X², identique ou différent en chaque occurrence, étant CR ou N, ou deux groupes X² adjacents représentant ensemble NR, O ou S, de sorte qu'un cycle à cinq chaînons est généré ; ou deux groupes X² adjacents représentant ensemble CR ou N, lorsque dans le cycle l'un des groupes X³ représente N, de sorte qu'un cycle à cinq chaînons est généré ; à la condition que maximum deux groupes X² adjacents dans chaque cycle représentent N ;
X³ étant en chaque occurrence dans le même cycle C ou un groupe X³ représentant N et l'autre groupe X³ représentant dans le même cycle C, les groupes X³ pouvant être choisis indépendamment les uns des autres, lorsque V contient plus d'un groupe de formule (3) ; à la condition que deux groupes X² adjacents représentent ensemble CR ou N, lorsque dans le cycle l'un des groupes X³ représente N ;
R, identique ou différent en chaque occurrence, étant H, D, F, Cl, Br, I, N(R²)₂, CN, Si(R¹)₃, B(OR¹)₂, C(=O)R¹, un groupe alkyle linéaire comportant 1 à 10 atomes de C ou un groupe alcényle comportant 2 à 10 atomes de C ou un groupe alkyle ramifié ou cyclique comportant 3 à 10 atomes de C, le groupe alkyle ou alcényle pouvant à chaque fois être substitué par un ou plusieurs radicaux R¹, un système cyclique aromatique ou hétéroaromatique comportant 5 à 30 atomes de cycle aromatique qui peut à chaque fois être substitué par un ou plusieurs radicaux R¹ ; à cet égard, deux radicaux R pouvant également former ensemble un système cyclique ;
R¹, identique ou différent en chaque occurrence, étant H, D, F, N(R²)₂, CN, un groupe alkyle linéaire comportant 1 à 10 atomes de C ou un groupe alcényle comportant 2 à 10 atomes de C ou un groupe alkyle ramifié ou cyclique comportant 3 à 10 atomes de C, le groupe alkyle ou alcényle pouvant à chaque fois être substitué par un ou plusieurs radicaux R², ou un système cyclique aromatique ou hétéroaromatique comportant 5 à 24 atomes de cycle aromatique qui peut à chaque fois être substitué par un ou plusieurs radicaux R² ; à cet égard, deux radicaux R¹ ou plus pouvant également former ensemble un système cyclique ;
R², identique ou différent en chaque occurrence, étant H, D, F, ou un radical organique aliphatique, aromatique et/ou hétéroaromatique comportant 1 à 20 atomes de C dans lequel également un ou plusieurs atomes de H peuvent être remplacés par F ;
à cet égard, les trois ligands bidentates L¹, L² et L³ pouvant, outre que par le pont V, être également encore refermés par un pont supplémentaire pour donner un cryptate.

2. Composé selon la revendication 1, **caractérisé en ce que** le groupe de formule (3) est choisi parmi les groupes des formules (6) à (30), 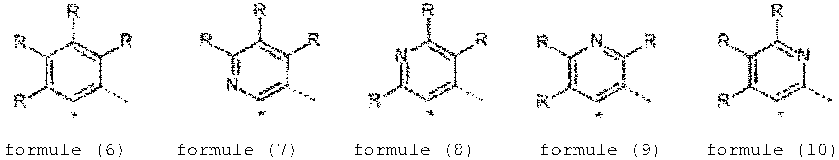 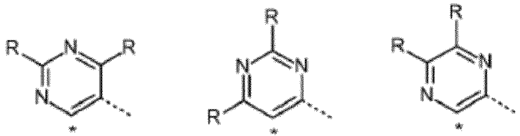 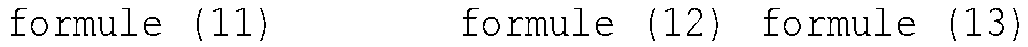 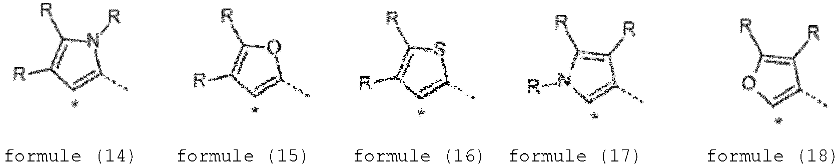 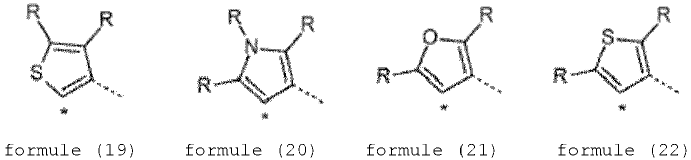 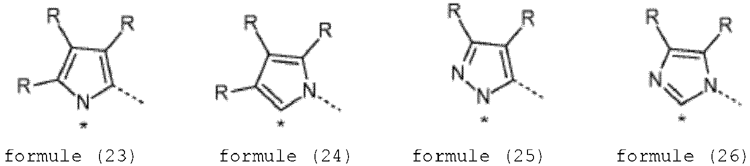 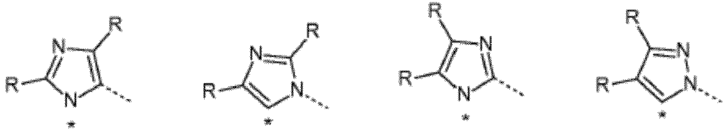 formule (27) formule (28) formule (29) formule (30) les symboles utilisés présentant les significations mentionnées dans la revendication 1.

3. Composé selon la revendication 1 ou 2, **caractérisé en ce que** V² représente -CR₂-CR₂-, R, identique ou différent en chaque occurrence, étant choisi dans le groupe constitué par H, D, F et un groupe alkyle comportant 1 à 5 atomes de C, des atomes de H pouvant également être remplacés par D ou F et deux R adjacents pouvant former ensemble un système cyclique.

4. Composé selon l'une quelconque ou plusieurs des revendications 1 à 3, **caractérisé en ce que** V est choisi parmi les structures des formules (4a), (4b), (5a) et (5b), 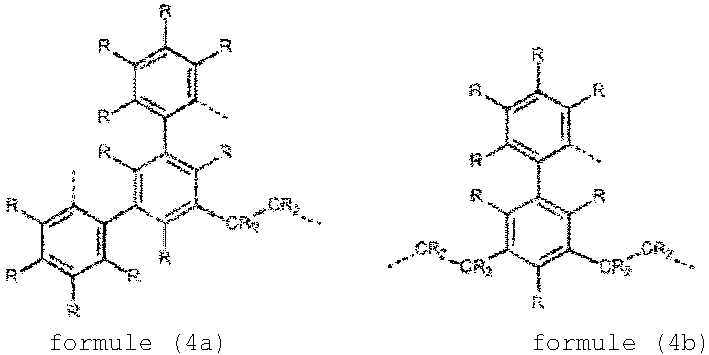 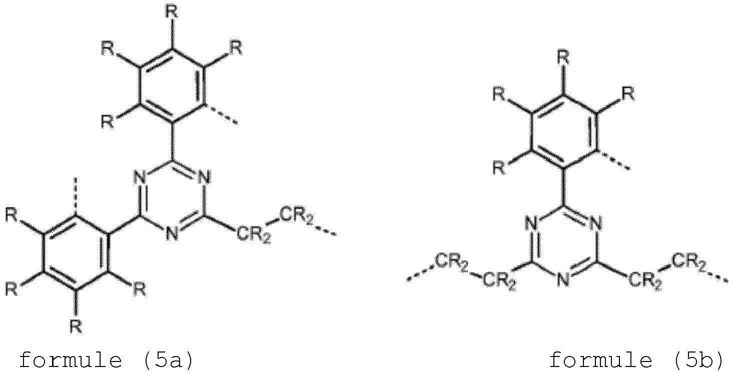 les symboles utilisés présentant les significations mentionnées dans la revendication 1.

5. Composé selon l'une quelconque ou plusieurs des revendications 1 à 4, **caractérisé en ce que** V est choisi parmi les structures des formules (4c), (4d), (4e), (4f), (5c), (5d), (5e) et (5f), 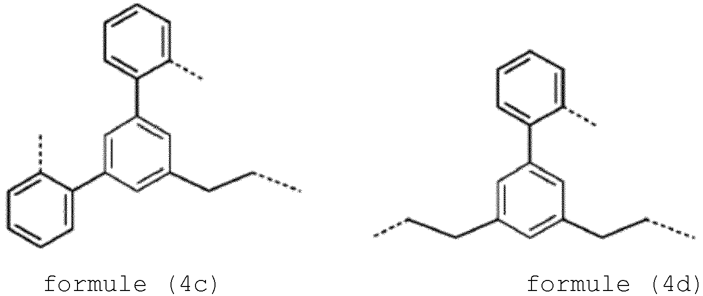 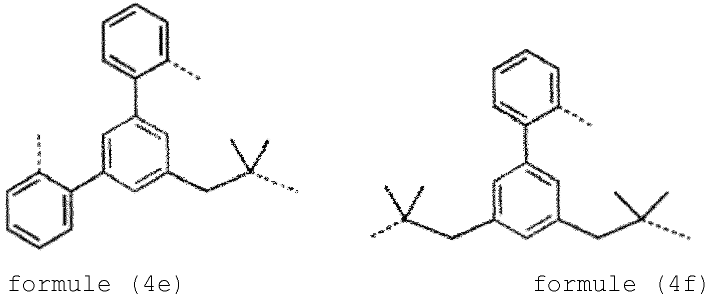 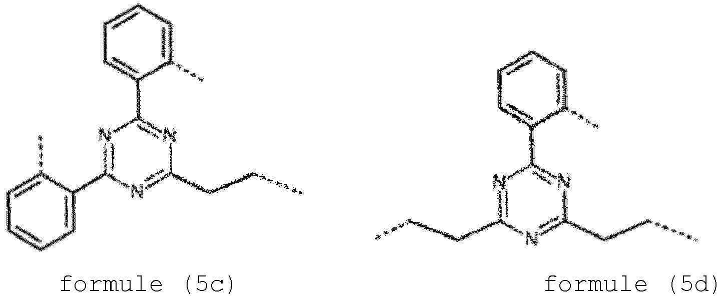 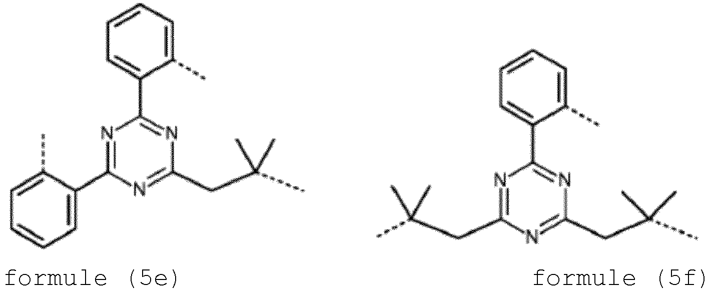 les symboles utilisés présentant les significations mentionnées dans la revendication 1.

6. Composé selon l'une quelconque ou plusieurs des revendications 1 à 5, **caractérisé en ce qu'**au moins l'un des ligands partiels L¹, L² ou L³, préférablement au moins deux des ligands partiels L¹, L² ou L³ coordine(nt) à l'iridium par le biais d'un atome de carbone et d'un atome d'azote ou par le biais de deux atomes de carbone.

7. Composé selon l'une quelconque ou plusieurs des revendications 1 à 6, **caractérisé en ce qu'**au moins l'un des ligands partiels L¹, L² ou L³, préférablement au moins deux des ligands partiels L¹, L² ou L³ présente (nt) une structure selon l'une des formules (L-1) ou (L-2), 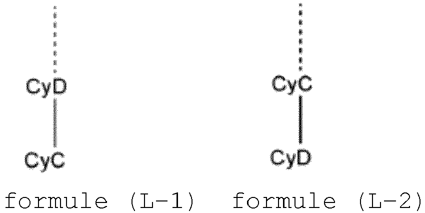 la liaison en pointillés représentant la liaison du ligand partiel à V et pour les autres symboles utilisés
CyC, identique ou différent en chaque occurrence, étant un groupe aryle ou hétéroaryle substitué ou non substitué comportant 5 à 14 atomes de cycle aromatique, qui coordine au métal à chaque fois par le biais d'un atome de carbone et qui est relié à CyD par le biais d'une liaison covalente ;
CyD, identique ou différent en chaque occurrence, étant un groupe hétéroaryle substitué ou non substitué comportant 5 à 14 atomes de cycle aromatique, qui coordine au métal à chaque fois par le biais d'un atome d'azote ou par le biais d'un atome de carbone de carbène et qui est relié à CyC par le biais d'une liaison covalente ;
à cet égard, plusieurs des substituants éventuels pouvant former ensemble un système cyclique.

8. Composé selon la revendication 7, **caractérisé en ce que** (L-1) est choisi parmi les structures des formules (L-1-1) et (L-1-2) et (L-2) est choisi parmi les structures des formules (L-2-1) à (L-2- 4), 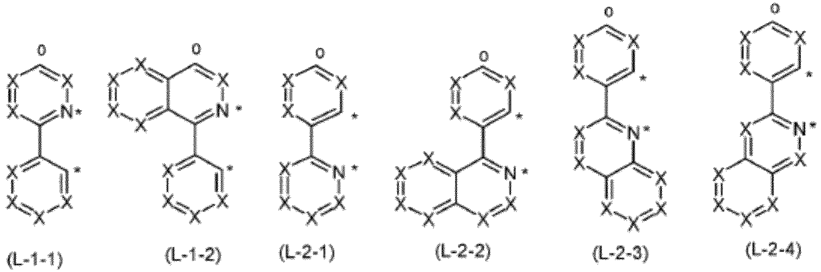 X, identique ou différent en chaque occurrence, représentant CR ou N, au maximum deux X par cycle représentant N, * représentant la position de la coordination à l'iridium et « o » représentant la position de la liaison à V.

9. Composé selon l'une quelconque ou plusieurs des revendications 1 à 8, **caractérisé en ce que** l'un des ligands partiels L¹, L² ou L³ présente un substituant selon l'une des formules (49) et (50), 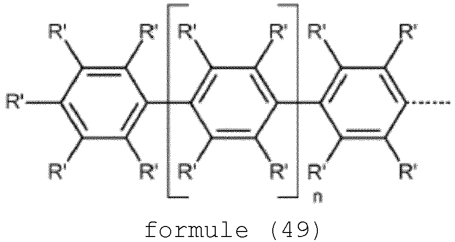 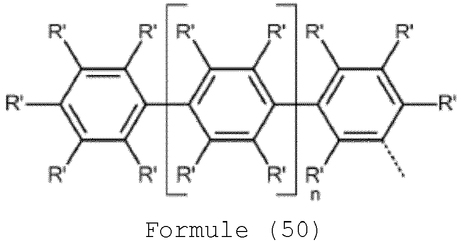 la liaison en pointillés indiquant le lien du groupe et en outre :
R', identique ou différent en chaque occurrence, étant H, D, F, CN, un groupe alkyle linéaire comportant 1 à 10 atomes de C, dans lequel également un ou plusieurs atomes de H peuvent être remplacés par D ou F, ou un groupe alkyle ramifié ou cyclique comportant 3 à 10 atomes de C, dans lequel également un ou plusieurs atomes de H peuvent être remplacés par D ou F, ou un groupe alcényle comportant 2 à 10 atomes de C, dans lequel également un ou plusieurs atomes de H peuvent être remplacés par D ou F ; à cet égard deux radicaux R' adjacents ou deux radicaux R' au niveau de groupes phényle adjacents pouvant former ensemble un système cyclique ; ou deux radicaux R' au niveau de groupes phényle adjacents représentant ensemble un groupe choisi parmi O et S, de sorte que les deux cycles phényle ensemble avec le groupe pontant représentent un dibenzofuranne ou un dibenzothiophène, et les autres R' étant comme définis précédemment ;
n étant 0, 1, 2, 3, 4 ou 5.

10. Composé selon la revendication 9, **caractérisé en ce que** la structure de formule (49) est choisie parmi les structures des formules (49a) à (49h) et la structure de formule (50) est choisie parmi les structures des formules (50a) à (50h), 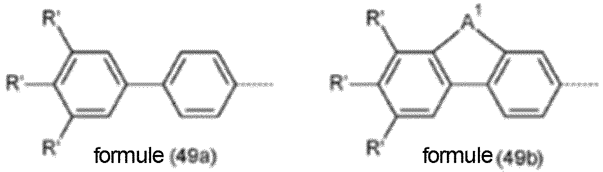 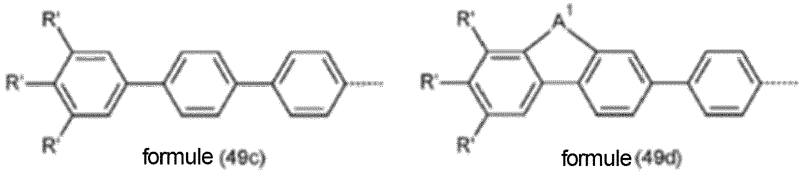 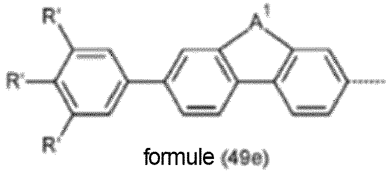 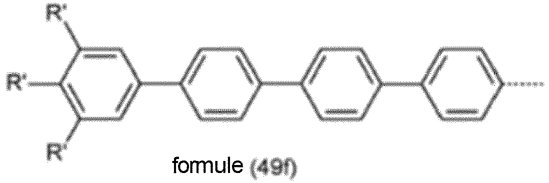 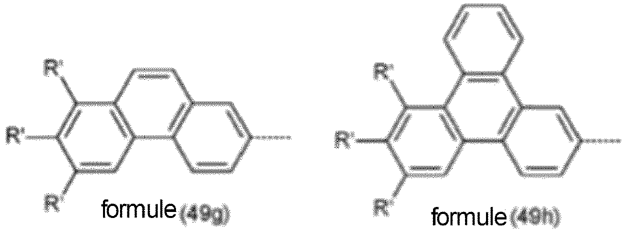 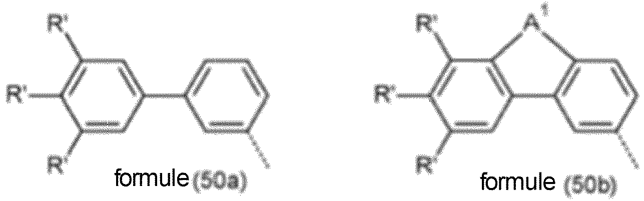 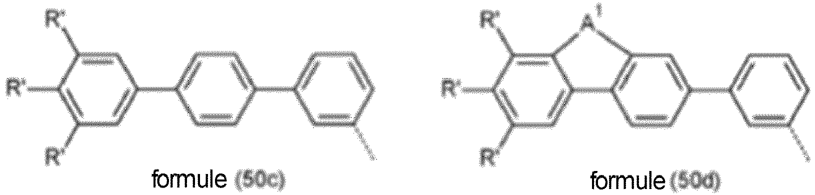 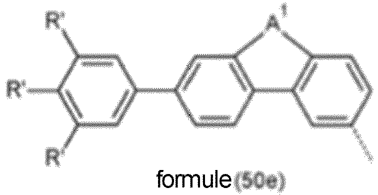 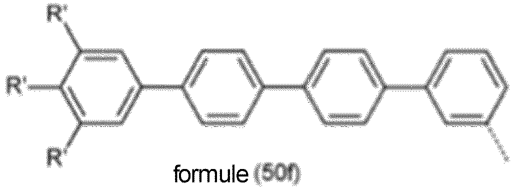 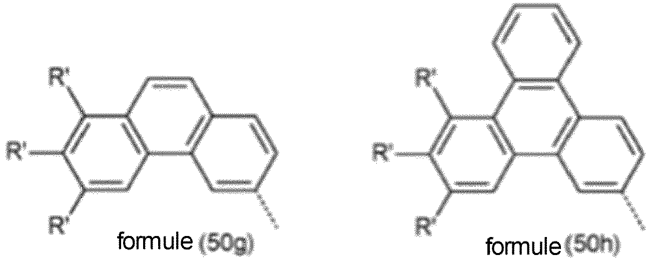 A¹ représentant O, S, C(R¹)₂ ou NR¹ et les autres symboles utilisés présentant les significations mentionnées dans les revendications 1 et 9.

11. Procédé de préparation d'un composé selon l'une quelconque ou plusieurs des revendications 1 à 10 par transformation du ligand avec des alcoolates d'iridium de formule (51), avec des cétocétonates d'iridium de formule (52), avec des halogénures d'iridium de formule (53) ou avec des carboxylates d'iridium de formule (54),
Ir(ORh formule (51) 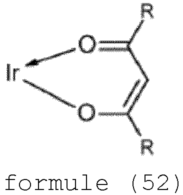
IrHal₃ formule (53)
Ir(OOCR)₃ formule (54)
R possédant les significations mentionnées dans la revendication 1, Hal = F, Cl, Br ou I et les éduits d'iridium pouvant également être présents en tant qu'hydrates correspondants.

12. Formulation, contenant au moins un composé selon l'une quelconque ou plusieurs des revendications 1 à 10 et au moins un solvant et/ou au moins un composé organique ou inorganique supplémentaire.

13. Utilisation d'un composé selon l'une ou plusieurs des revendications 1 à 10 dans un dispositif électronique ou en tant que sensibilisateur à l'oxygène ou en tant que photoinitiateur ou photocatalyseur.

14. Dispositif électronique contenant au moins un composé selon l'une quelconque ou plusieurs des revendications 1 à 10.

15. Dispositif électronique selon la revendication 14, qui est un dispositif électroluminescent organique, **caractérisé en ce que** le composé selon l'une quelconque ou plusieurs des revendications 1 à 10 est utilisé dans une couche émettrice.
